# EUROPEAN PATENT SPECIFICATION

(11) **EP 3 739 645 B1**
(45) Date of publication and mention of the grant of the patent: **31.08.2022**
(21) Application number: 20166748.2
(22) Date of filing: 30.03.2020
(51) Int. Cl.: H01L 51/50

(54) **ORGANIC LIGHT-EMITTING DEVICE**
ORGANISCHE LICHTEMITTIERENDE VORRICHTUNG
DISPOSITIF ÉLECTROLUMINESCENT ORGANIQUE

(30) Priority: 29.03.2019 KR 20190037245; 05.03.2020 KR 20200027986
(43) Date of publication of application: 18.11.2020
(73) Proprietor: Samsung Electronics Co., Ltd., Gyeonggi-do 16677 (KR)
(72) Inventor: JEON, Soonok, 16678 Gyeonggi-do (KR); KIM, Jongsoo, 16678 Gyeonggi-do (KR); CHOI, Hyeonho, 16678 Gyeonggi-do (KR); KWON, Eunsuk, 16678 Gyeonggi-do (KR); MIN, Minsik, 16678 Gyeonggi-do (KR); BAE, Hyejin, 16678 Gyeonggi-do (KR)
(74) Representative: Elkington and Fife LLP

(56) References cited:
- EP-A1- 2 980 876
- EP-A1- 3 142 162
- US-A1- 2015 155 511
- US-A1- 2017 062 752
- YOUN LEE SAE ET AL: "High-efficiency organic light-emitting diodes utilizing thermally activated delayed fluorescence from triazine-based donor-acceptor hybrid molecules", APPLIED PHYSICS LETTERS, A I P PUBLISHING LLC, US, vol. 101, no. 9, 27 August 2012 (2012-08-27), pages 93306-93306, XP012164964, ISSN: 0003-6951, DOI: 10.1063/1.4749285 [retrieved on 2012-08-30]
- HYUN-GU KIM ET AL: "Triplet Harvesting by a Fluorescent Emitter Using a Phosphorescent Sensitizer for Blue Organic-Light-Emitting Diodes", ACS APPLIED MATERIALS & INTERFACES, vol. 11, no. 1, 9 January 2019 (2019-01-09), pages 26-30, XP055767952, US ISSN: 1944-8244, DOI: 10.1021/acsami.8b17957
- THANH-TUÂN BUI ET AL: "Recent advances on organic blue thermally activated delayed fluorescence (TADF) emitters for organic light-emitting diodes (OLEDs)", BEILSTEIN JOURNAL OF ORGANIC CHEMISTRY, vol. 14, 19 January 2018 (2018-01-19), pages 282-308, XP055687894, DOI: 10.3762/bjoc.14.18

## Description

### FIELD OF THE INVENTION

The present disclosure relates to an organic light-emitting device including an emission layer which includes a host, a cooling dopant, and a sensitizer.

### BACKGROUND OF THE INVENTION

Organic light-emitting devices are self-emission devices that produce full-color images, and also have wide viewing angles, high contrast ratios, short response times, and excellent characteristics in terms of brightness, driving voltage, and response speed, compared to devices in the art.

In an example, an organic light-emitting device includes an anode, a cathode, and an organic layer between the anode and the cathode, wherein the organic layer includes an emission layer. A hole transport region may be between the anode and the emission layer, and an electron transport region may be between the emission layer and the cathode. Holes provided from the anode may move toward the emission layer through the hole transport region, and electrons provided from the cathode may move toward the emission layer through the electron transport region. The holes and the electrons recombine in the emission layer to produce excitons. These excitons transit from an excited state to a ground state, thereby generating light.

EP 2980876 A1 relates to an organic electroluminescent element which exhibits an enhanced light emitting efficiency.

US 2015/0155511 A1 relates to a multicolour light-emitting element that utilizes fluorescence and phosphorescence.

EP 3 142 162 A1 relates to compositions that specific exciplexes and organic light emitting devices comprising such compositions.

### SUMMARY OF THE INVENTION

Provided is an organic light-emitting device including an emission layer which includes a host, a cooling dopant, and a sensitizer.

Additional aspects will be set forth in part in the description which follows and, in part, will be apparent from the description, or may be learned by practice of the presented embodiments of the disclosure.

According to the invention, an organic light-emitting device includes: a first electrode; a second electrode; and an organic layer between the first electrode and the second electrode, wherein
the organic layer includes an emission layer;
the emission layer includes a host, a cooling dopant, and a sensitizer, wherein
the cooling dopant and the sensitizer satisfy Conditions 1, 2 and 3, and
the sensitizer includes platinum (Pt): ${T}_{decay} \left(CD\right) < {T}_{decay} \left(S\right)$ ${T}_{decay} \left(CD\right) < 1.5 μ s$ ${T}_{decay} \left(CD\right) / {T}_{decay} \left(S\right) < 0.5$
wherein, in Conditions 1, 2 and 3,
T_{decay}(CD) is a decay time of the cooling dopant, and
T_{decay}(S) is a decay time of the sensitizer

The invention further provides an organic light-emitting device including: a first electrode; a second electrode; and an organic layer between the first electrode and the second electrode, wherein
the organic layer includes an emission layer;
the emission layer includes a host, a cooling dopant, and a sensitizer, wherein
the cooling dopant and the sensitizer satisfy Conditions 1, 2 and 3, and
the sensitizer includes a thermally activated delayed fluorescence emitter, and
thermally activated delayed fluorescence emitter does not include metal: ${T}_{decay} \left(CD\right) < {T}_{decay} \left(S\right)$ ${T}_{decay} \left(CD\right) < 1.5 μ s$ ${T}_{decay} \left(CD\right) / {T}_{decay} \left(S\right) < 0.5$
wherein, in Conditions 1, 2 and 3,
T_{decay}(CD) is a decay time of the cooling dopant, and
T_{decay}(S) is a decay time of the sensitizer.

The invention further provides an organic light-emitting device includes: a first electrode; a second electrode; m emission units between the first electrode and the second electrode and including at least one emission layer; and
m-1 charge generating layers between neighboring two emission units of the m emission units and including an n-type charge generating layer and a p-type charge generating layer,
m may be an integer of 2 or more,
the maximum emission wavelength of light emitted from at least one emission unit of the m emission units may be different from the maximum emission wavelength of light emitted from at least one emission unit of the remaining emission units,
the emission layer may include a host, a cooling dopant, and a sensitizer, wherein
the cooling dopant and the sensitizer satisfy Conditions 1, 2 and 3, and
the sensitizer may include Pt.

The invention further provides an organic light-emitting device includes: a first electrode; a second electrode; m emission units between the first electrode and the second electrode and including at least one emission layer; and
m-1 charge generating layers between neighboring two emission units of the m emission units and including an n-type charge generating layer and a p-type charge generating layer,
m may be an integer of 2 or more,
the maximum emission wavelength of light emitted from at least one emission unit of the m emission units may be different from the maximum emission wavelength of light emitted from at least one emission unit of the remaining emission units,
the emission layer may include a host, a cooling dopant, and a sensitizer, wherein
the cooling dopant and the sensitizer satisfy Conditions 1, 2 and 3, and
the sensitizer may include a thermally activated delayed fluorescence emitter, and
thermally activated delayed fluorescence emitter does not include metal.

The invention further provides an organic light-emitting device includes: a first electrode; a second electrode; and m emission layers between the first electrode and the second electrode, wherein
m may be an integer of 2 or more,
the maximum emission wavelength of light emitted from at least one emission layer of the m emission layers may be different from the maximum emission wavelength of light emitted from at least one emission layer of the remaining emission layers,
the emission layer may include a host, a cooling dopant, and a sensitizer, wherein
the cooling dopant and the sensitizer satisfy Conditions 1, 2 and 3, and
the sensitizer may include Pt.

The invention further provides an organic light-emitting device includes: a first electrode; a second electrode; and m emission layers between the first electrode and the second electrode, wherein
m may be an integer of 2 or more,
the maximum emission wavelength of light emitted from at least one emission layer of the m emission layers may be different from the maximum emission wavelength of light emitted from at least one emission layer of the remaining emission layers,
the emission layer may include a host, a cooling dopant, and a sensitizer, wherein
the cooling dopant and the sensitizer satisfy Conditions 1, 2 and 3, and the sensitizer may include a thermally activated delayed fluorescence emitter, and
thermally activated delayed fluorescence emitter does not include metal.

### BRIEF DESCRIPTION OF THE DRAWINGS

The above and other aspects, features, and advantages of certain embodiments of the disclosure will be more apparent from the following description taken in conjunction with the accompanying drawings, in which:
FIG. 1 shows a schematic cross-sectional view of an organic light-emitting device according to an embodiment;
FIGS. 2A to 2C each show a diagram schematically illustrating energy transfer in an emission layer of an organic light-emitting device according to an embodiment;
FIG. 3 is a schematic cross-sectional view of an organic light-emitting device according to another embodiment; and
FIG. 4 is a schematic cross-sectional view of an organic light-emitting device according to another embodiment;
FIG. 5 is a graph of luminance versus external quantum efficiency of the organic light-emitting devices manufactured according to Example 3 and Comparative Example 3P; and
FIG. 6 is a graph of relative luminance versus relative lifespan of the organic light-emitting devices manufactured according to Example 3 and Comparative Example 3P.

### DETAILED DESCRIPTION OF THE EMBODIMENTS

Reference will now be made in detail to embodiments, examples of which are illustrated in the accompanying drawings, wherein like reference numerals refer to like elements throughout. In this regard, the present embodiments may have different forms and should not be construed as being limited to the descriptions set forth herein. Accordingly, the embodiments are merely described below, by referring to the figures, to explain aspects. As used herein, the term "and/or" includes any and all combinations of one or more of the associated listed items. Expressions such as "at least one of," when preceding a list of elements, modify the entire list of elements and do not modify the individual elements of the list.

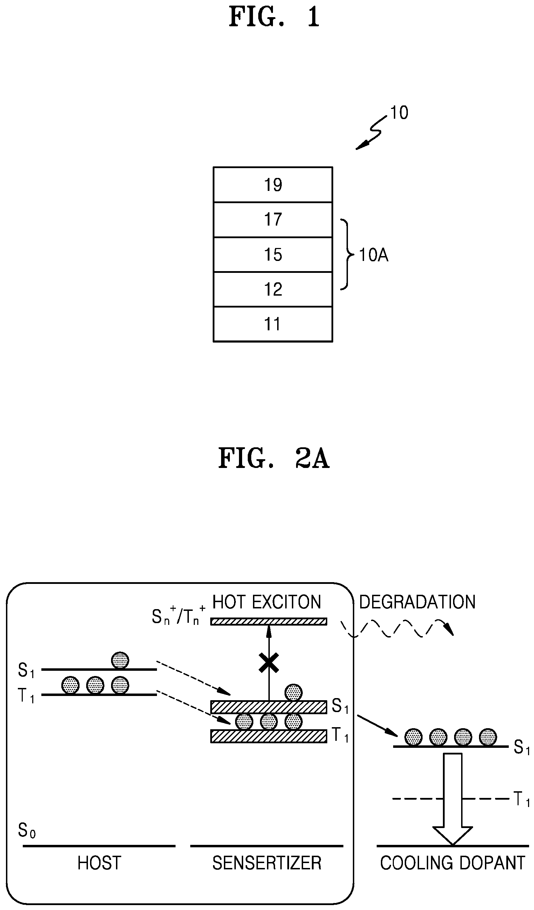

### Description of FIGS. 1 and 2A to 2C

FIG. 1 is a schematic view of an organic light-emitting device 10 according to an embodiment. Hereinafter, a structure and a manufacturing method of an organic light-emitting device according to an example of the present disclosure will be described with reference to FIG. 1.

The organic light-emitting device 10 of FIG. 1 includes a first electrode 11, a second electrode 19 facing the first electrode 11, and an organic layer 10A between the first electrode 11 and the second electrode 19.

The organic layer 10A includes an emission layer 15, a hole transport region 12 may be located between the first electrode 11 and the emission layer 15, and an electron transport region 17 may be located between the emission layer 15 and the second electrodes 19.

A substrate may be additionally located under the first electrode 11 or above the second electrode 19. For use as the substrate, any substrate that is used in organic light-emitting devices available in the art may be used, and the substrate may be a glass substrate or a transparent plastic substrate, each having excellent mechanical strength, thermal stability, transparency, surface smoothness, ease of handling, and water resistance.

### [First electrode 11]

In one or more embodiments, the first electrode 11 may be formed by depositing or sputtering a material for forming the first electrode11 on the substrate. The first electrode 11 may be an anode. The material for forming the first electrode 11 may be selected from materials with a high work function to facilitate hole injection.

The first electrode 11 may be a reflective electrode, a semi-transmissive electrode, or a transmissive electrode. When the first electrode 11 is a transmissive electrode, a material for forming a first electrode may be selected from indium tin oxide (ITO), indium zinc oxide (IZO), tin oxide (SnO₂), zinc oxide (ZnO), and any combinations thereof, but embodiments of the present disclosure are not limited thereto. In one or more embodiments, when the first electrode 110 is a semi-transmissive electrode or a reflectable electrode, a material for forming a first electrode may be selected from magnesium (Mg), silver (Ag), aluminum (Al), aluminum-lithium (Al-Li), calcium (Ca), magnesium-indium (Mg-In), magnesium-silver (Mg-Ag), and any combinations thereof, but embodiments of the present disclosure are not limited thereto.

The first electrode 11 may have a single-layered structure or a multi-layered structure including two or more layers.

### [Emission layer 15]

The emission layer 15 includes a host, a cooling dopant, and a sensitizer.

The emission layer emits fluorescent light. That is, the cooling dopant is a material that emits fluorescent light. The emission layer 15, which emits the fluorescent light, is clearly distinguished from an emission layer of the related art that emits phosphorescent light.

In an embodiment, the emission layer includes a host, a cooling dopant, and a sensitizer,
the cooling dopant and the sensitizer satisfy Conditions 1, 2 and 3, and
the sensitizer includes Pt: ${T}_{decay} \left(CD\right) < {T}_{decay} \left(S\right)$ ${T}_{decay} \left(CD\right) < 1.5 μ s$ ${T}_{decay} \left(CD\right) / {T}_{decay} \left(S\right) < 0.5$ wherein, in Conditions 1, 2 and 3,
T_{decay}(CD) is a decay time of the cooling dopant, and
T_{decay}(S) is a decay time of the sensitizer.

The decay time of the cooling dopant is calculated from a time-resolved photoluminescence spectrum (TRPL) at room temperature with respect to a 40 nm-thickness film (hereinafter referred to as "Film (CD)") obtained by vacuum-codepositing the host and the dopant comprised in the emission layer at the weight ratio of 90:10 on a quartz substrate at the vacuum degree of 10⁻⁷ torr.

The decay time of the sensitizer is calculated from TRPL at room temperature with respect to a 40 nm-thickness film (hereinafter referred to as "Film (S)") obtained by vacuum-codepositing the host and the sensitizer comprised in the emission layer at the weight ratio of 90:10 on a quartz substrate at the vacuum degree of 10⁻⁷ torr.

The detailed evaluation method of the decay time of each of the cooling dopant and the sensitizer may be understood by referring to the following examples.

In general, it is known that since triplet excitons remain long in an excited state, they influence the decrease in the lifespan of organic light-emitting devices. However, according to the present disclosure, the cooling dopant is used to reduce the time during which the triplet excitons of the sensitizer remains in the excited state. Accordingly, an organic light-emitting device including the cooling dopant may have a prolonged lifespan.

In one embodiment, the more triplet excitons the sensitizer has, the more excess energy is accumulated in the sensitizer, resulting in more hot excitons. That is, the amount of triplet excitons of the sensitizer is proportional to the amount of hot excitons. The hot excitons break down various chemical bonds of a compound included in an emission layer and/or a compound existing at the interface of the emission layer and other layers to degrade the compound. Accordingly, the lifespan of organic light-emitting devices may be reduced. However, according to the present disclosure, by using cooling dopants, the triplet excitons of the sensitizer can be quickly converted to singlet excitons of the cooling dopant, ultimately reducing the amount of hot excitons and increasing the lifespan of an organic light-emitting device.

In this regard, "hot excitons" may be generated or increased by exciton-exciton annihilation due to an increase in the density of excitons in an emission layer, exciton-charge annihilation due to the charge imbalance in an emission layer, and/or radical ion pairs due to the delivery of electrons between a host and dopant.

In order to quickly convert triplet excitons of the sensitizer to singlet excitons of the cooling dopant, Condition 1 should be satisfied.

In addition, since the cooling dopant emits fluorescent light, a high color purity organic light-emitting device can be provided, and in particular, since Condition 2 is satisfied, so that the singlet excitons of the cooling dopant excited state at room temperature can be rapidly transferred, and thus, the single state of the cooling dopant in the excited state may not be accumulated, and the lifespan of an organic light-emitting device may be increased.

As Condition 3 is further satisfied, the transition from the triplet excitons of the sensitizer to the singlet excitons of the cooling dopant may occur more smoothly.

Accordingly, the lifespan of an organic light-emitting device is further prolonged: ${T}_{decay} \left(CD\right) / {T}_{decay} \left(S\right) < 0.5$ wherein, in Condition 3,
T_{decay}(CD) is a decay time of the cooling dopant, and
T_{decay}(S) is a decay time of the sensitizer.

In one or more embodiments, the organic light-emitting device may further satisfy Condition 4: $BDE \left(S\right) - {T}_{1} \left(S\right) < 3.0 eV$ wherein, in Condition 4,
BDE (S) is the bond dissociation energy level of the sensitizer, and
T₁ (S) is the lowest excitation triplet energy level of the sensitizer.

Ultimately, the organic light-emitting device may have the target level of lifespan by satisfying Condition 5 below: $R \left(Hex\right) / {e}^{10} < 15$ wherein, in Condition 5,
R (Hex) is the production rate of hot excitons.

In this regard, R (Hex) was subjected to the photochemical stability of the organic light-emitting device (photochemical stability), and then calculated through the Gaussian 09 program according to Equation C below. $R \left(Hex\right) = a \times {T}_{decay} \left(S\right) \times {e}^{- \left(BDE\left(S\right)-{T}_{1}\left(S\right)\right)}$ wherein, in Equation C,
a is an arbitrarily constant,
T_{decay}(S) is a decay time of the sensitizer,
BDE (S) is the bond dissociation energy level of the sensitizer, and
T₁ (S) is the lowest excitation triplet energy level of the sensitizer.

The hot-exciton production rate is estimated to be proportional to (decay time) □ e- ^{(BDE-T1)}, and in order to obtain the target level of the lifespan of the organic light-emitting device, (hot-exciton production rate)/e¹⁰ should be less than 15.

In this regard, the degradation analysis (PCS) of organic light-emitting devices was calculated according to the following Equation P: $PCS \left(%\right) = {I}_{2} / {I}_{1} \times 100$ wherein, in Equation P,
I₁, with respect to a film formed by depositing a compound of which PCS is to be measured, is a maximum light intensity obtained from the PL spectrum which is evaluated at room temperature under Ar atmosphere where outside air is blocked immediately after the formation of the film by using a He-Cd laser (excitation wavelength = 325 nanometers, laser power density = 100 mW/cm²) of KIMMON-KOHA Inc., and
I₂, with respect to a film formed by depositing a compound of which PCS is to be measured, is a maximum light intensity obtained from the PL spectrum which is evaluated at room temperature under Ar atmosphere where outside air is blocked, by exposing the film to light of the He-Cd laser (excitation wavelength = 325 nanometers and laser power density = 100 mW/cm²) of KIMMON-KOHA Inc., which is a pumping laser which has been used to evaluate I₁, for 3 hours, and then, using He-Cd laser of KIMMON-KOHA Inc. (excitation wavelength = 325 nanometers). In the case of the sensitizer, reverse intersystem crossing (RISC) and/or intersystem crossing (ISC) actively occur, which allows excitons generated at the host to be delivered to the cooling dopant.

Specifically, the general energy transfer of an organic light-emitting device according to an embodiment will be described with reference to FIG. 2A.

Singlet and triplet excitons are formed at the host in the emission layer, and the singlet and triplet excitons formed at the host are transferred to the sensitizer and then to the cooling dopant through Forster energy transfer (FRET). At this time, in order to embody the high efficiency and long lifespan of the organic light-emitting device, it is necessary to control the hot excitons generated in the emission layer, which requires optimization of energy transfer.

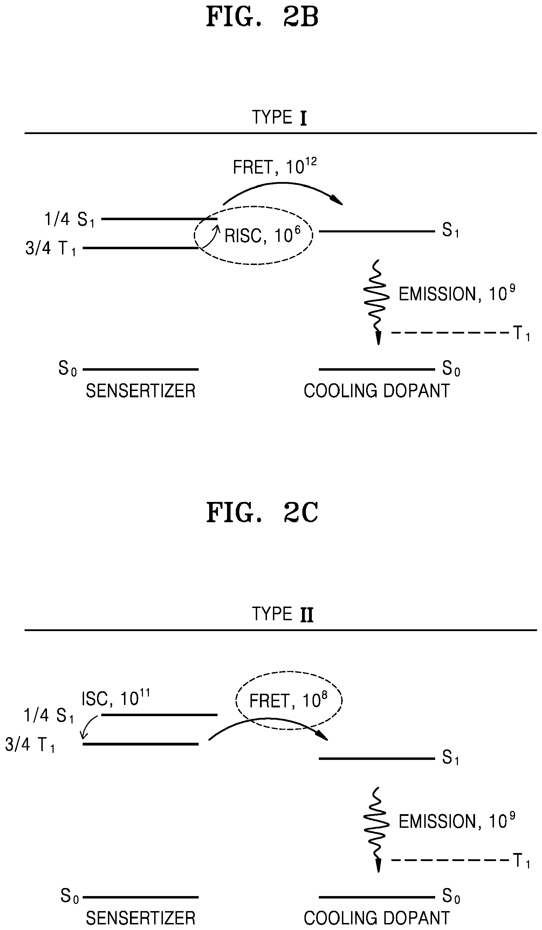

Specifically, the general energy transfer of an organic light-emitting device (type I) according to an embodiment will be described with reference to FIG. 2B. This is the case when the sensitizer is a thermally activated delayed fluorescence (TADF) emitter satisfying the condition of ΔE_{ST} ≤ 0.3 eV.

The singlet excitons formed at the host, which is 25% of the total excitons, are transferred to the sensitizer through FRET, and the energy of triplet excitons formed at the host, which is 75% of the total excitons, is transferred to the singlet and triplet of the sensitizer, among which the energy delivered to triplet is subjected to RISC into singlet, and then, the singlet energy of the sensitizer is transferred to the cooling dopant through FRET.

Specifically, the general energy transfer of an organic light-emitting device (type II) according to an embodiment will be described with reference to FIG. 2C. In this case, the sensitizer is an organic metallic compound including Pt.

The triplet excitons formed at the host, which is 75% of the total excitons, are transferred to the sensitizer through Dexter energy transfer, and the energy of singlet excitons formed at the host, which is 25% of the total excitons, is transferred to the singlet and triplet of the sensitizer, among which the energy delivered to singlet is subjected to ISC into triplet, and then, the triplet energy of the sensitizer is transferred to the cooling dopant through FRET.

Accordingly, by transferring all the singlet excitons and triplet excitons generated in the emission layer to the dopant, an organic light-emitting device having improved efficiency can be obtained. In addition, since an organic light-emitting device can be obtained with significantly reduced energy loss, the lifespan characteristics of the organic light-emitting device can be improved.

The amount of the sensitizer in the emission layer may be from about 5 wt% to about 50 wt%. Within these ranges, it is possible to achieve effective energy transfer in the emission layer, and accordingly, an organic light-emitting device having high efficiency and long lifespan can be obtained.

In one embodiment, the host, the cooling dopant, and the sensitizer may further satisfy Condition 6: ${T}_{1} \left(H\right) \geq {T}_{1} \left(S\right) \geq {S}_{1} \left(CD\right)$ wherein, in Condition 6,
T₁(H) is the lowest excitation triplet energy level of the host,
S₁(CD) is the lowest excitation singlet energy level of the cooling dopant, and
T₁(S) is the lowest excitation triplet energy level of the sensitizer.

When the host, the cooling dopant, and the sensitizer each satisfy Condition 6, triplet excitons may be effectively transferred from the emission layer to the cooling dopant, and thus, an organic light-emitting device having improved efficiency may be obtained.

The emission layer may consist of the host, the cooling dopant, and the sensitizer. That is, the emission layer may not further include materials other than the host, the cooling dopant, and the sensitizer.

A thickness of the emission layer may be in a range of about 100 Å to about 1,000 Å, for example, about 200 Å to about 600 Å. When the thickness of the emission layer is within this range, excellent light-emission characteristics may be obtained without a substantial increase in driving voltage.

### [Host in emission layer 15]

The host may include no metal atoms.

In one or more embodiments, the host may include one kind of host. When the host includes one host, the one host may be selected from an amphiprotic host, an electron transport host, and a hole transport host, which will be described later.

In one or more embodiments, the host may include a mixture of two or more different hosts. For example, the host may be a mixture of an electron transport host and a hole transport host, a mixture of two types of electron transport hosts different from each other, or a mixture of two types of hole transport hosts different from each other. The electron transport host and the hole transport host may be understood by referring to the related description to be presented later.

In one or more embodiments, the host may include an electron transport host including at least one electron transport moiety and a hole transport host that is free of an electron transport moiety.

The electron transport moiety used herein may be selected from a cyano group, a π electron-deficient nitrogen-containing cyclic group, and a group represented by one of the following Formulae:

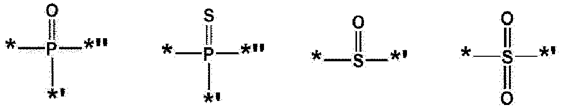

In the formulae, *, *', and *" are each binding sites to neighboring atoms.

In one or more embodiments, the electron transport host of the emission layer 15 may include at least one of a cyano group and a π electron-deficient nitrogen-containing cyclic group.

In one or more embodiments, the electron transport host in the emission layer 15 may include at least one cyano group.

In one or more embodiments, the electron transport host in the emission layer 15 may include at least one cyano group and at least one π electron deficient nitrogen-containing cyclic group.

In one or more embodiments, the host may include an electron transport host and a hole transport host, wherein the electron transport host may include at least one π electron-deficient nitrogen-free cyclic group and at least one electron transport moiety, and the hole transport host may include at least one π electron-deficient nitrogen-free cyclic group and may not include an electron transport moiety.

The term "π electron-deficient nitrogen-containing cyclic group" used herein refers to a cyclic group having at least one *-N=*' moiety, and for example, may be selected from an imidazole group, a pyrazole group, a thiazole group, an isothiazole group, an oxazole group, an isoxazole group, a pyridine group, a pyrazine group, a pyridazine group, a pyrimidine group, an indazole group, a purine group, a quinoline group, an isoquinoline group, a benzoquinoline group, a phthalazine group, a naphthyridine group, a quinoxaline group, a quinazoline group, a cinnoline group, a phenanthridine group, an acridine group, a phenanthroline group, a phenazine group, a benzimidazole group, an isobenzothiazole group, a benzoxazole group, an isobenzoxazole group, a triazole group, a tetrazole group, an oxadiazole group, a triazine group, a thiadiazole group, an imidazopyridine group, an imidazopyrimidine group, and an azacarbazole group; and a condensed cyclic group in which two or more π electron-deficient nitrogen-containing cyclic groups.

Meanwhile, the π electron-deficient nitrogen-free cyclic group may be selected from a benzene group, a heptalene group, an indene group, a naphthalene group, an azulene group, an indacene group, acenaphthylene group, a fluorene group, a spiro-bifluorene group, a benzofluorene group, a dibenzofluorene group, a phenalene group, a phenanthrene group, an anthracene group, a fluoranthene group, a triphenylene group, a pyrene group, a chrysene group, a naphthacene group, a picene group, a perylene group, a pentacene group, a hexacene group, a pentaphene group, a rubicene group, a coronene group, an ovalene group, a pyrrole group, an isoindole group, an indole group, a furan group, a thiophene group, a benzofuran group, a benzothiophene group, a benzocarbazole group, a dibenzocarbazole group, a dibenzofuran group, a dibenzothiophene group, a dibenzothiophene sulfone group, a carbazole group, a dibenzosilole group, an indenocarbazole group, an indolocarbazole group, a benzofurocarbazole group, a benzothienocarbazole group, a triindolobenzene group; and a condensed cyclic group of two or more π electron-deficient nitrogen-free cyclic groups, but embodiments of the present disclosure are not limited thereto.

In one or more embodiments, the electron transport host may be selected from compounds represented by Formula E-1, and
the hole transport host may be selected from compounds represented by Formula H-1, but embodiments of the present disclosure are not limited thereto:

   <Formula E-1> [Ar₃₀₁]_{xb11}-[(L₃₀₁)_{xb1}-R₃₀₁]_{xb21}

   wherein, in Formula E-1,
Ar₃₀₁ may be selected from a substituted or unsubstituted C₅-C₆₀ carbocyclic group and a substituted or unsubstituted C₁-C₆₀ heterocyclic group,
xb11 may be 1, 2, or 3,
L₃₀₁ may each independently be selected from a single bond, a group represented by the following formula , a substituted or unsubstituted C₅-C₆₀ carbocyclic group, and a substituted or unsubstituted C₁-C₆₀ heterocyclic group, and *, *' and *" in the following formulae are each a binding site to a neighboring atom, 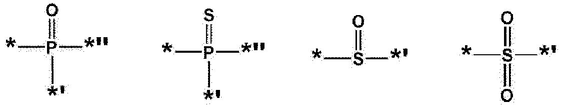 xb1 may be an integer from 1 to 5,
R₃₀₁ may be selected from hydrogen, deuterium, -F, -CI, -Br, -I, a hydroxyl group, a cyano group, a nitro group, an amidino group, a hydrazine group, a hydrazone group, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀heterocycloalkenyl group, a substituted or unsubstituted C₆-C₆₀ aryl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted monovalent non-aromatic condensed polycyclic group, a substituted or unsubstituted monovalent non-aromatic condensed heteropolycyclic group, -Si(Q₃₀₁)(Q₃₀₂)(Q₃₀₃), -N(Q₃₀₁)(Q₃₀₂), -B(Q₃₀₁)(Q₃₀₂), -C(=O)(Q₃₀₁), -S(=O)₂(Q₃₀₁), -S(=O)(Q₃₀₁), -P(=O)(Q₃₀₁)(Q₃₀₂), and -P(=S)(Q₃₀₁)(Q₃₀₂),
xb21 may be an integer from 1 to 5,
Q₃₀₁ to Q₃₀₃ are each independently be selected from a C₁-C₁₀ alkyl group, a C₁-C₁₀ alkoxy group, a phenyl group, a biphenyl group, a terphenyl group, and a naphthyl group, and
at least one of <Condition A> to <Condition C> is satisfied:
   <Condition A>
      Ar₃₀₁, L₃₀₁, and R₃₀₁ in Formula E-1 may each independently include a π electron-deficient nitrogen-containing cyclic group.
   <Condition B>
      L₃₀₁ in Formula E-1 is a group represented by the following groups: 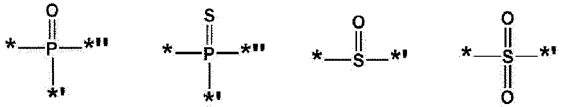
   <Condition C>
      R₃₀₁ in Formula E-1 may be selected from a cyano group, -S(=O)₂(Q₃₀₁), -S(=O)(Q₃₀₁), -P(=O)(Q₃₀₁)(Q₃₀₂), and -P(=S)(Q₃₀₁)(Q₃₀₂).

      <Formula H-1 > Ar₄₀₁-(L₄₀₁)_{xd1}-(Ar₄₀₂)_{xd11}

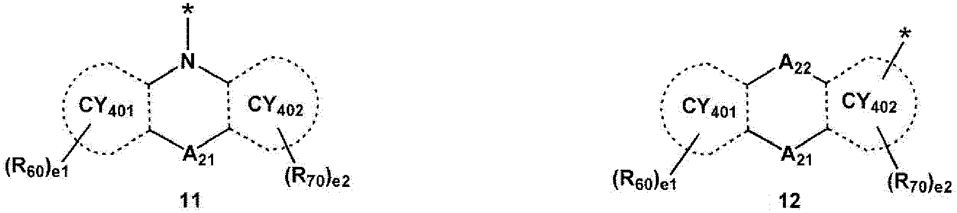

      wherein, in Formulae H-1, 11, and 12,
   L₄₀₁ may be selected from:
      a single bond; and
      a benzene group, a heptalene group, an indene group, a naphthalene group, an azulene group, an indacene group, acenaphthylene group, a fluorene group, a spiro-bifluorene group, a benzofluorene group, a dibenzofluorene group, a phenalene group, a phenanthrene group, an anthracene group, a fluoranthene group, a triphenylene group, a pyrene group, a chrysene group, a naphthacene group, a picene group, a perylene group, a pentacene group, a hexacene group, a pentaphene group, a rubicene group, a coronene group, an ovalene group, a pyrrole group, an isoindole group, an indole group, a furan group, a thiophene group, a benzofuran group, a benzothiophene group, a benzocarbazole group, a dibenzocarbazole group, a dibenzofuran group, a dibenzothiophene group, a dibenzothiophene sulfone group, a carbazole group, a dibenzosilole group, an indenocarbazole group, an indolocarbazole group, a benzofurocarbazole group, a benzothienocarbazole group, and a triindolobenzene group, each unsubstituted or substituted with at least one selected from deuterium, a C₁-C₁₀ alkyl group, a C₁-C₁₀ alkoxy group, a phenyl group, a naphthyl group, a fluorenyl group, a carbazolyl group, a dibenzofuranyl group, a dibenzothiophenyl group, a triphenylenyl group, a biphenyl group, a terphenyl group, a tetraphenyl group, and -Si(Q₄₀₁)(Q₄₀₂)(Q₄₀₃);
      xd1 may be an integer from 1 to 10, wherein when xd1 is 2 or more, two or more of L₄₀₁(s) may be identical to or different from each other,
      Ar₄₀₁ may be selected from groups represented by Formulae 11 and 12,
   Ar₄₀₂ may be selected from:
      groups represented by Formula 11 and 12, a phenyl group, a naphthyl group, a fluorenyl group, a carbazolyl group, a dibenzofuranyl group, a dibenzothiophenyl group, a biphenyl group, a terphenyl group, and a triphenylenyl group; and
      a phenyl group, a naphthyl group, a fluorenyl group, a carbazolyl group, a dibenzofuranyl group, a dibenzothiophenyl group, a biphenyl group, a terphenyl group, and a triphenylenyl group, each substituted with at least one selected from deuterium, a hydroxyl group, an amino group, an amidino group, a hydrazine group, a hydrazone group, a carboxylic acid or a salt thereof, a sulfonic acid or a salt thereof, a phosphoric acid or a salt thereof, a C₁-C₂₀ alkyl group, a C₁-C₂₀ alkoxy group, a phenyl group, a naphthyl group, a fluorenyl group, a carbazolyl group, a dibenzofuranyl group, a dibenzothiophenyl group, a biphenyl group, a terphenyl group, and a triphenylenyl group;
      xd11 may be an integer from 1 to 10, wherein when xd11 is 2 or more, two or more of Ar₄₀₂ (s) may be identical to or different from each other;
      CY₄₀₁ and CY₄₀₂ may each independently be selected from a benzene group, a naphthalene group, a fluorene group, a carbazole group, a benzocarbazole group, an indolocarbazole group, a dibenzofuran group, a dibenzothiophene group, a dibenzosilole group, a benzonaphthofuran group, a benzonaphthothiophene group, and a benzonaphthosilole group,
      A21 is selected from a single bond, O, S, N(R₅₁), C(R₅₁)(R₅₂), and Si(R₅₁)(R₅₂),
      A22 is selected from a single bond, O, S, N(R₅₃), C(R₅₃)(R₅₄), and Si(R₅₃)(R₅₄),
      at least one selected from A₂₁ and A₂₂ in Formula 12 is not a single bond,
   R₅₁ to R₅₄, R₆₀, and R₇₀ are each independently selected from:
      hydrogen, deuterium, a hydroxyl group, an amino group, an amidino group, a hydrazine group, a hydrazone group, a carboxylic acid group or a salt thereof, a sulfonic acid group or a salt thereof, a phosphoric acid group or a salt thereof, a C₁-C₂₀ alkyl group, and a C₁-C₂₀ alkoxy group;
      a C₁-C₂₀ alkyl group and a C₁-C₂₀ alkoxy group, each substituted with at least one selected from deuterium, a hydroxyl group, an amino group, an amidino group, a hydrazine group, a hydrazone group, a carboxylic acid group or a salt thereof, a sulfonic acid group or a salt thereof, a phosphoric acid group or a salt thereof, a phenyl group, a naphthyl group, a fluorenyl group, a carbazolyl group, a dibenzofuranyl group, and a dibenzothiophenyl group;
      a π electron-deficient nitrogen-free cyclic group (for example, a phenyl group, a naphthyl group, a fluorenyl group, a carbazolyl group, a dibenzofuranyl group, a dibenzothiophenyl group, a biphenyl group, a terphenyl group, and a triphenylenyl group);
      a π electron-deficient nitrogen-free cyclic group (for example, a phenyl group, a naphthyl group, a fluorenyl group, a carbazolyl group, a dibenzofuranyl group, a dibenzothiophenyl group, a biphenyl group, a terphenyl group, and a triphenylenyl group), each substituted with at least one selected from deuterium, a hydroxyl group, an amino group, an amidino group, a hydrazine group, a hydrazone group, a carboxylic acid or a salt thereof, a sulfonic acid or a salt thereof, a phosphoric acid or a salt thereof, a C₁-C₂₀ alkyl group, a C₁-C₂₀ alkoxy group, a phenyl group, a naphthyl group, a fluorenyl group, a carbazolyl group, a dibenzofuranyl group, a dibenzothiophenyl group, and a biphenyl group; and
      -Si(Q₄₀₄)(Q₄₀₅)(Q₄₀₆),
      e1 and e2 may each independently be an integer from 0 to 10,
      Q₄₀₁ to Q₄₀₆ may each independently be selected from hydrogen, deuterium, a hydroxyl group, an amino group, an amidino group, a hydrazine group, a hydrazone group, a carboxylic acid or a salt thereof, a sulfonic acid or a salt thereof, a phosphoric acid or a salt thereof, a phenyl group, a naphthyl group, a fluorenyl group, a carbazolyl group, a dibenzofuranyl group, a dibenzothiophenyl group, a biphenyl group, a terphenyl group, and a triphenylenyl group, and
      * indicates a binding site to a neighboring atom.

In one or more embodiments, Ar₃₀₁ and L₃₀₁ in Formula E-1 may each independently be selected from a benzene group, a naphthalene group, a fluorene group, a spiro-bifluorene group, a benzofluorene group, a dibenzofluorene group, a phenalene group, a phenanthrene group, an anthracene group, a fluoranthene group, a triphenylene group, a pyrene group, a chrysene group, a naphthacene group, a picene group, a perylene group, a pentaphene group, an indenoanthracene group, a dibenzofuran group, a dibenzothiophene group, an imidazole group, a pyrazole group, a thiazole group, an isothiazole group, an oxazole group, an isoxazole group, a pyridine group, a pyrazine group, a pyridazine group, a pyrimidine group, an indazole group, a purine group, a quinoline group, an isoquinoline group, a benzoquinoline group, a phthalazine group, a naphthyridine group, a quinoxaline group, a quinazoline group, a cinnoline group, a phenanthridine group, an acridine group, a phenanthroline group, a phenazine group, a benzimidazole group, an isobenzothiazole group, a benzoxazole group, an isobenzoxazole group, a triazole group, a tetrazole group, an oxadiazole group, a triazine group, a thiadiazole group, an imidazopyridine group, an imidazopyrimidine group, and an azacarbazole group, each unsubstituted or substituted with at least one selected from deuterium, -F, -CI, -Br, -I, a hydroxyl group, a cyano group, a nitro group, an amidino group, a hydrazine group, a hydrazone group, a C₁-C₂₀ alkyl group, a C₁-C₂₀ alkoxy group, a phenyl group, a biphenyl group, a terphenyl group, a naphthyl group, a cyano-containing phenyl group, a cyano-containing biphenyl group, a cyano-containing terphenyl group, a cyano-containing naphthyl group, a pyridinyl group, a phenylpyridinyl group, a diphenylpyridinyl group, a biphenylpyridinyl group, a di(biphenyl)pyridinyl group, a pyrazinyl group, a phenylpyrazinyl group, a diphenylpyrazinyl group, a biphenylpyrazinyl group, a di(biphenyl)pyrazinyl group, a pyridazinyl group, a phenylpyridazinyl group, a diphenylpyridazinyl group, a biphenylpyridazinyl group, a di(biphenyl)pyridazinyl group, a pyrimidinyl group, a phenylpyrimidinyl group, a diphenylpyrimidinyl group, a biphenylpyrimidinyl group, a di(biphenyl)pyrimidinyl group, a triazinyl group, a phenyltriazinyl group, a diphenyltriazinyl group, a biphenyltriazinyl group, a di(biphenyl)triazinyl group, -Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁), and -P(=O)(Q₃₁)(Q₃₂),
at least one of L₃₀₁(s) in the number of xb1 may each independently be selected from an imidazole group, a pyrazole group, a thiazole group, an isothiazole group, an oxazole group, an isoxazole group, a pyridine group, a pyrazine group, a pyridazine group, a pyrimidine group, an indazole group, a purine group, a quinoline group, an isoquinoline group, a benzoquinoline group, a phthalazine group, a naphthyridine group, a quinoxaline group, a quinazoline group, a cinnoline group, a phenanthridine group, an acridine group, a phenanthroline group, a phenazine group, a benzimidazole group, an isobenzothiazole group, a benzoxazole group, an isobenzoxazole group, a triazole group, a tetrazole group, an oxadiazole group, a triazine group, a thiadiazole group, an imidazopyridine group, an imidazopyrimidine group, and an azacarbazole group, each unsubstituted or substituted with at least one selected from deuterium, -F, -CI, -Br, -I, a hydroxyl group, a cyano group, a nitro group, an amidino group, a hydrazine group, a hydrazone group, a C₁-C₂₀ alkyl group, a C₁-C₂₀ alkoxy group, a phenyl group, a biphenyl group, a terphenyl group, a naphthyl group, a cyano-containing phenyl group, a cyano-containing biphenyl group, a cyano-containing terphenyl group, a cyano-containing naphthyl group, a pyridinyl group, a phenylpyridinyl group, a diphenylpyridinyl group, a biphenylpyridinyl group, a di(biphenyl)pyridinyl group, a pyrazinyl group, a phenylpyrazinyl group, a diphenylpyrazinyl group, a biphenylpyrazinyl group, a di(biphenyl)pyrazinyl group, a pyridazinyl group, a phenylpyridazinyl group, a diphenylpyridazinyl group, a biphenylpyridazinyl group, a di(biphenyl)pyridazinyl group, a pyrimidinyl group, a phenylpyrimidinyl group, a diphenylpyrimidinyl group, a biphenylpyrimidinyl group, a di(biphenyl)pyrimidinyl group, a triazinyl group, a phenyltriazinyl group, a diphenyltriazinyl group, a biphenyltriazinyl group, a di(biphenyl)triazinyl group, -Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁), and -P(=O)(Q₃₁)(Q₃₂), and
R₃₀₁ may be selected from hydrogen, deuterium, -F, -CI, -Br, -I, a hydroxyl group, a cyano group, a nitro group, an amidino group, a hydrazine group, a hydrazone group, a C₁-C₂₀ alkyl group, a C₁-C₂₀ alkoxy group, a phenyl group, a biphenyl group, a terphenyl group, a tetraphenyl group, a naphthyl group, a cyano-containing phenyl group, a cyano-containing biphenyl group, a cyano-containing terphenyl group, a cyano-containing tetraphenyl group, a cyano-containing naphthyl group, a pyridinyl group, a phenylpyridinyl group, a diphenylpyridinyl group, a biphenylpyridinyl group, a di(biphenyl)pyridinyl group, a pyrazinyl group, a phenylpyrazinyl group, a diphenylpyrazinyl group, a biphenylpyrazinyl group, a di(biphenyl)pyrazinyl group, a pyridazinyl group, a phenylpyridazinyl group, a diphenylpyridazinyl group, a biphenylpyridazinyl group, a di(biphenyl)pyridazinyl group, a pyrimidinyl group, a phenylpyrimidinyl group, a diphenylpyrimidinyl group, a biphenylpyrimidinyl group, a di(biphenyl)pyrimidinyl group, a triazinyl group, a phenyltriazinyl group, a diphenyltriazinyl group, a biphenyltriazinyl group, a di(biphenyl)triazinyl group, -Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁), and -P(=O)(Q₃₁)(Q₃₂),
wherein Q₃₁ to Q₃₃ may each independently be selected from a C₁-C₁₀ alkyl group, a C₁-C₁₀ alkoxy group, a phenyl group, a biphenyl group, a terphenyl group, and a naphthyl group, but embodiments of the present disclosure are not limited thereto.

In one or more embodiments,
Ar₃₀₁ may be selected from a benzene group, a naphthalene group, a fluorene group, a spiro-bifluorene group, a benzofluorene group, a dibenzofluorene group, a phenalene group, a phenanthrene group, an anthracene group, a fluoranthene group, a triphenylene group, a pyrene group, a chrysene group, a naphthacene group, a picene group, a perylene group, a pentaphene group, an indenoanthracene group, a dibenzofuran group, and a dibenzothiophene group, each unsubstituted or substituted with at least one selected from deuterium, -F, -CI, -Br, -I, a hydroxyl group, a cyano group, a nitro group, an amidino group, a hydrazine group, a hydrazone group, a C₁-C₂₀ alkyl group, a C₁-C₂₀ alkoxy group, a phenyl group, a biphenyl group, a terphenyl group, a naphthyl group, a cyano-containing phenyl group, a cyano-containing biphenyl group, a cyano-containing terphenyl group, a cyano-containing naphthyl group, a pyridinyl group, a phenylpyridinyl group, a diphenylpyridinyl group, a biphenylpyridinyl group, a di(biphenyl)pyridinyl group, a pyrazinyl group, a phenylpyrazinyl group, a diphenylpyrazinyl group, a biphenylpyrazinyl group, a di(biphenyl)pyrazinyl group, a pyridazinyl group, a phenylpyridazinyl group, a diphenylpyridazinyl group, a biphenylpyridazinyl group, a di(biphenyl)pyridazinyl group, a pyrimidinyl group, a phenylpyrimidinyl group, a diphenylpyrimidinyl group, a biphenylpyrimidinyl group, a di(biphenyl)pyrimidinyl group, a triazinyl group, a phenyltriazinyl group, a diphenyltriazinyl group, a biphenyltriazinyl group, a di(biphenyl)triazinyl group, -Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁), and -P(=O)(Q₃₁)(Q₃₂); and
groups represented by Formulae 5-1 to 5-3 and Formulae 6-1 to 6-33, and
L₃₀₁ may be selected from groups represented by Formulae 5-1 to 5-3 and Formulae 6-1 to 6-33: 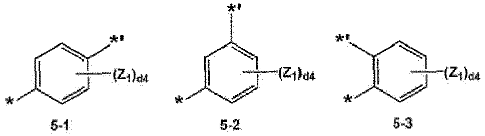 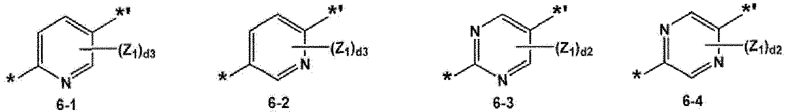 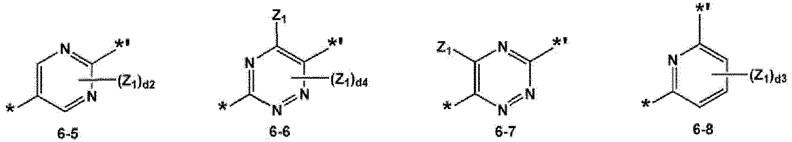 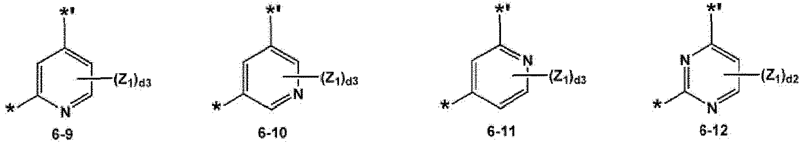 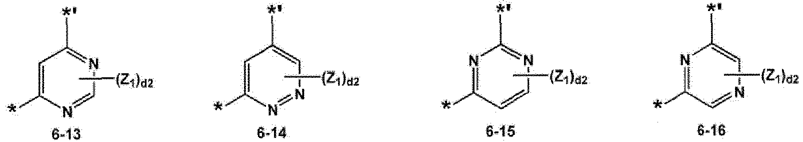 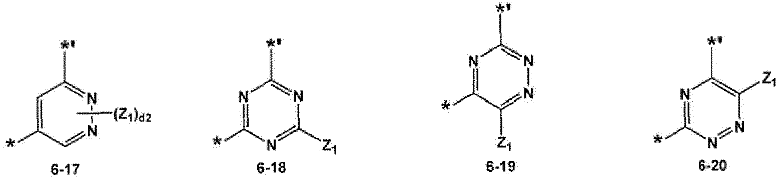 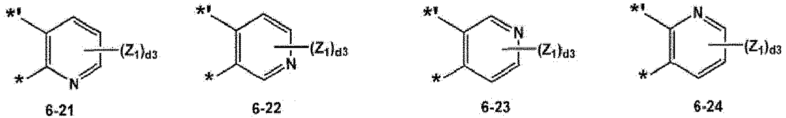 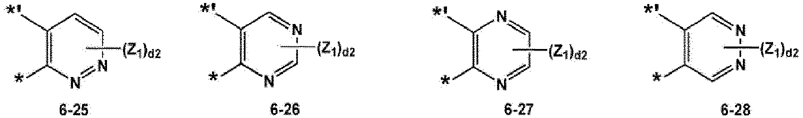 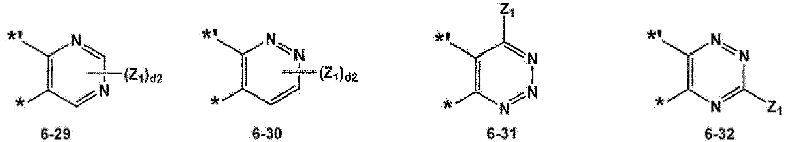 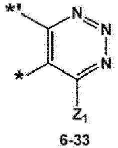 wherein, in Formulae 5-1 to 5-3 and 6-1 to 6-33,
Z₁ may be selected from hydrogen, deuterium, -F, -CI, -Br, -I, a hydroxyl group, a cyano group, a nitro group, an amidino group, a hydrazine group, a hydrazone group, a C₁-C₂₀ alkyl group, a C₁-C₂₀ alkoxy group, a phenyl group, a biphenyl group, a terphenyl group, a naphthyl group, a cyano-containing phenyl group, a cyano-containing biphenyl group, a cyano-containing terphenyl group, a cyano-containing naphthyl group, a pyridinyl group, a phenylpyridinyl group, a diphenylpyridinyl group, a biphenylpyridinyl group, a di(biphenyl)pyridinyl group, a pyrazinyl group, a phenylpyrazinyl group, a diphenylpyrazinyl group, a biphenylpyrazinyl group, a di(biphenyl)pyrazinyl group, a pyridazinyl group, a phenylpyridazinyl group, a diphenylpyridazinyl group, a biphenylpyridazinyl group, a di(biphenyl)pyridazinyl group, a pyrimidinyl group, a phenylpyrimidinyl group, a diphenylpyrimidinyl group, a biphenylpyrimidinyl group, a di(biphenyl)pyrimidinyl group, a triazinyl group, a phenyltriazinyl group, a diphenyltriazinyl group, a biphenyltriazinyl group, a di(biphenyl)triazinyl group, -Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁), and -P(=O)(Q₃₁)(Q₃₂),
d4 may be 0, 1, 2, 3, or 4,
d3 may be 0, 1, 2, or 3,
d2 may be 0, 1, or 2, and
* and *' each indicate a binding site to a neighboring atom.
Q₃₁ to Q₃₃ are the same as described in the present specification.

In one or more embodiments, L₃₀₁ may be selected from groups represented by Formulae 5-2, 5-3 and 6-8 to 6-33.

In one or more embodiments, R₃₀₁ may be selected from a cyano group and groups represented by Formula 7-1 to 7-18, and at least one of Ar₄₀₂(s) in the number of xd11 may be selected from groups represented by Formulae 7-1 to 7-18, but embodiments of the present disclosure are not limited thereto: 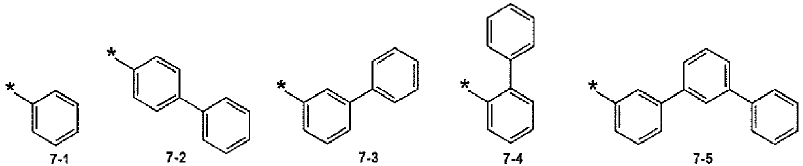 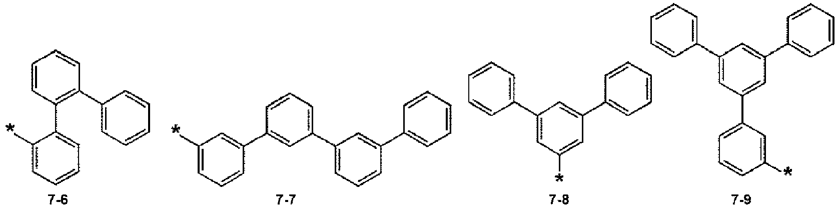 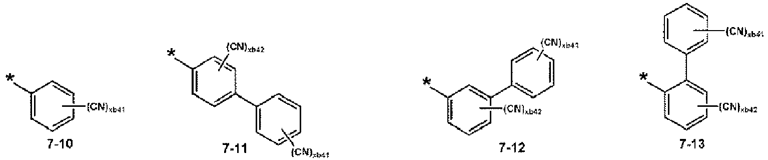 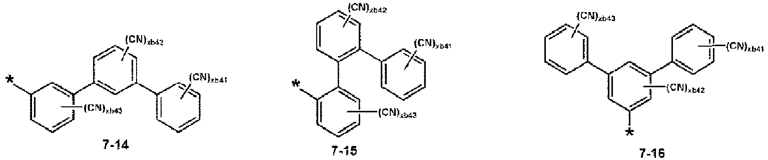 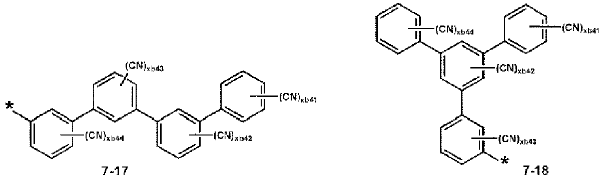 wherein, in Formulae 7-1 to 7-18,
xb41 to xb44 may each be 0, 1, or 2, wherein xb41 in Formula 7-10 is not 0, the sum of xb41 and xb42 in Formulae 7-11 to 7-13 is not 0, the sum of xb41, xb42, and xb43 in Formulae 7-14 to 7-16 is not 0, the sum of xb41, xb42, xb43, and xb44 in Formulae 7-17 and 7-18 is not 0, and * indicates a binding site to a neighboring atom.

Two or more Ar₃₀₁(s) in Formula E-1 may be identical to or different from each other, two or more L₃₀₁(s) may be identical to or different from each other, two or more L₄₀₁(s) in Formula H-1 may be identical to or different from each other, and two or more Ar₄₀₂(s) in Formula H-1 may be identical to or different from each other.

In one embodiment, the electron transport host includes i) at least one of a cyano group, a pyrimidine group, a pyrazine group, and a triazine group and ii) a triphenylene group, and the hole transport host may include a carbazole group.

In one or more embodiments, the electron transport host may include at least one cyano group.

The electron transport host may be, for example, selected from groups HE1 to HE7, but embodiments of the present disclosure are not limited thereto:

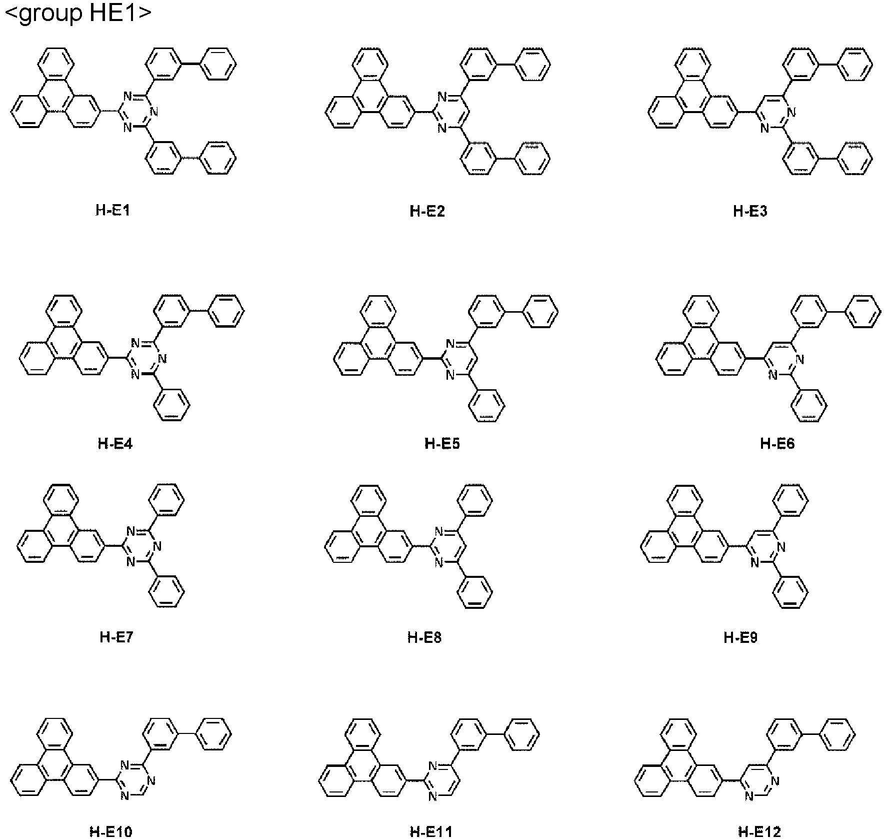

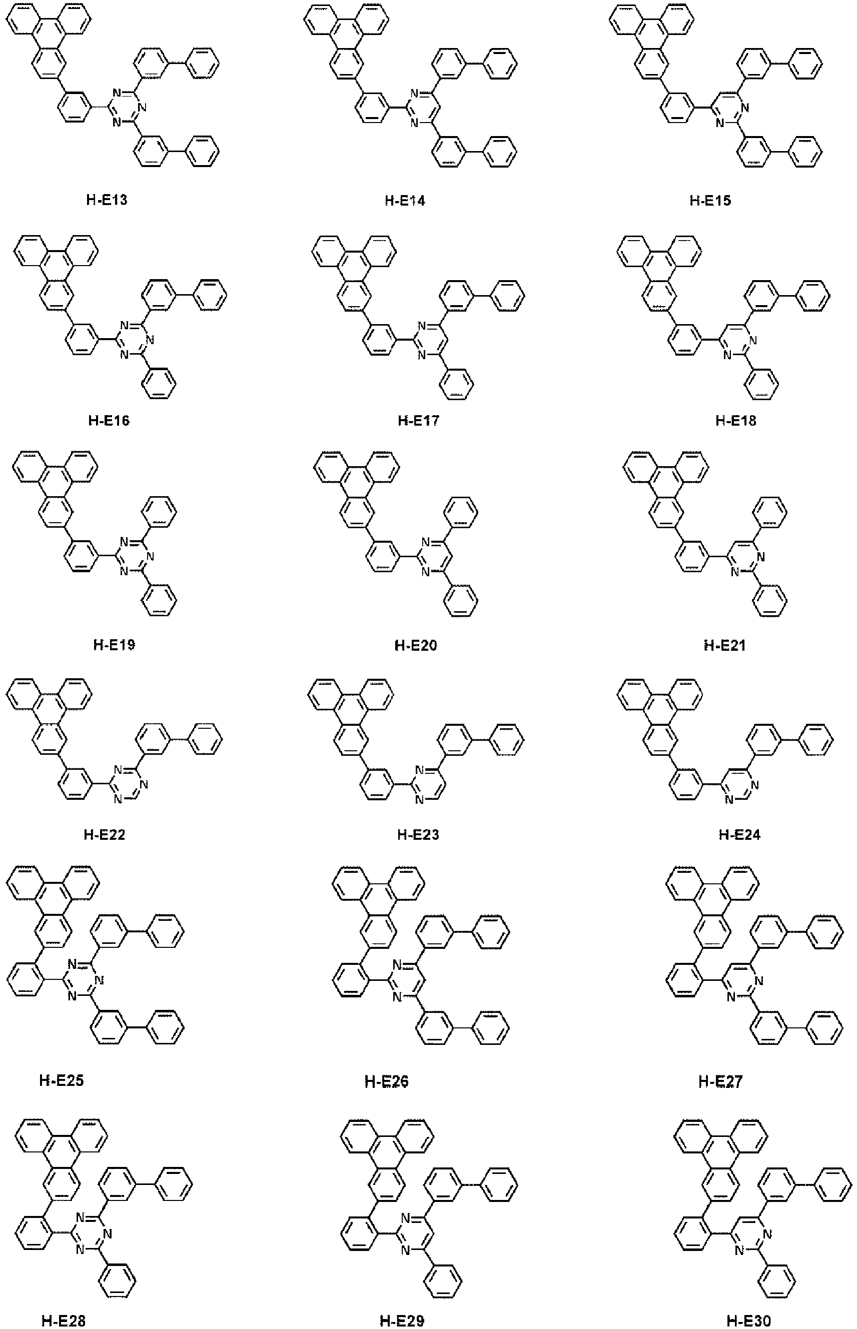

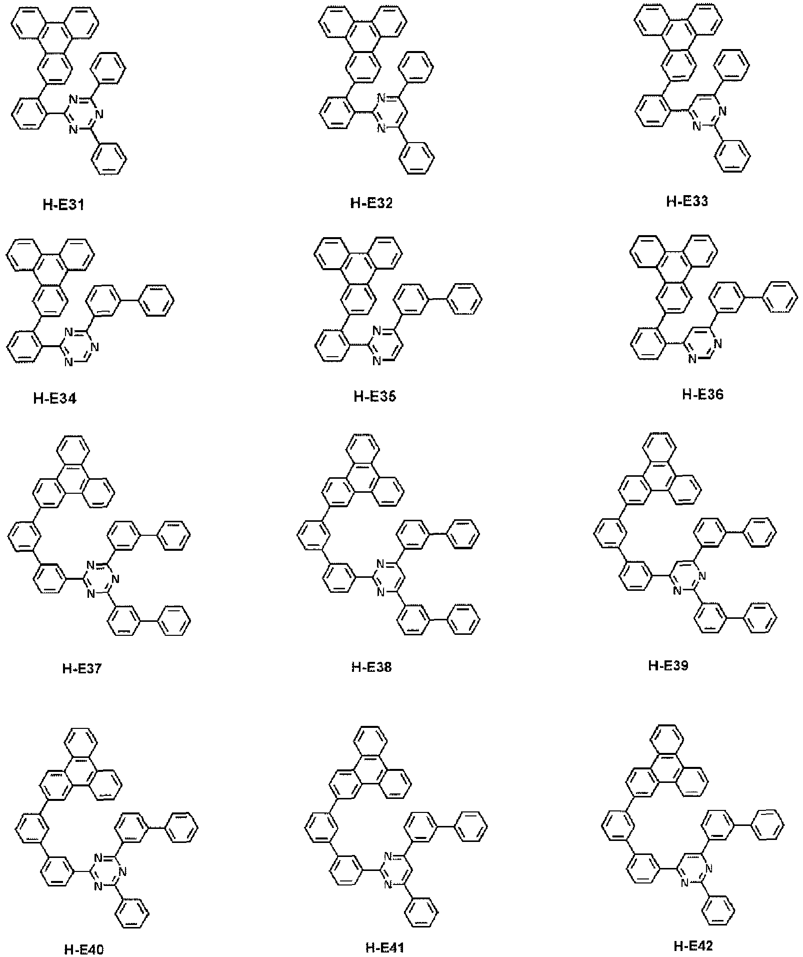

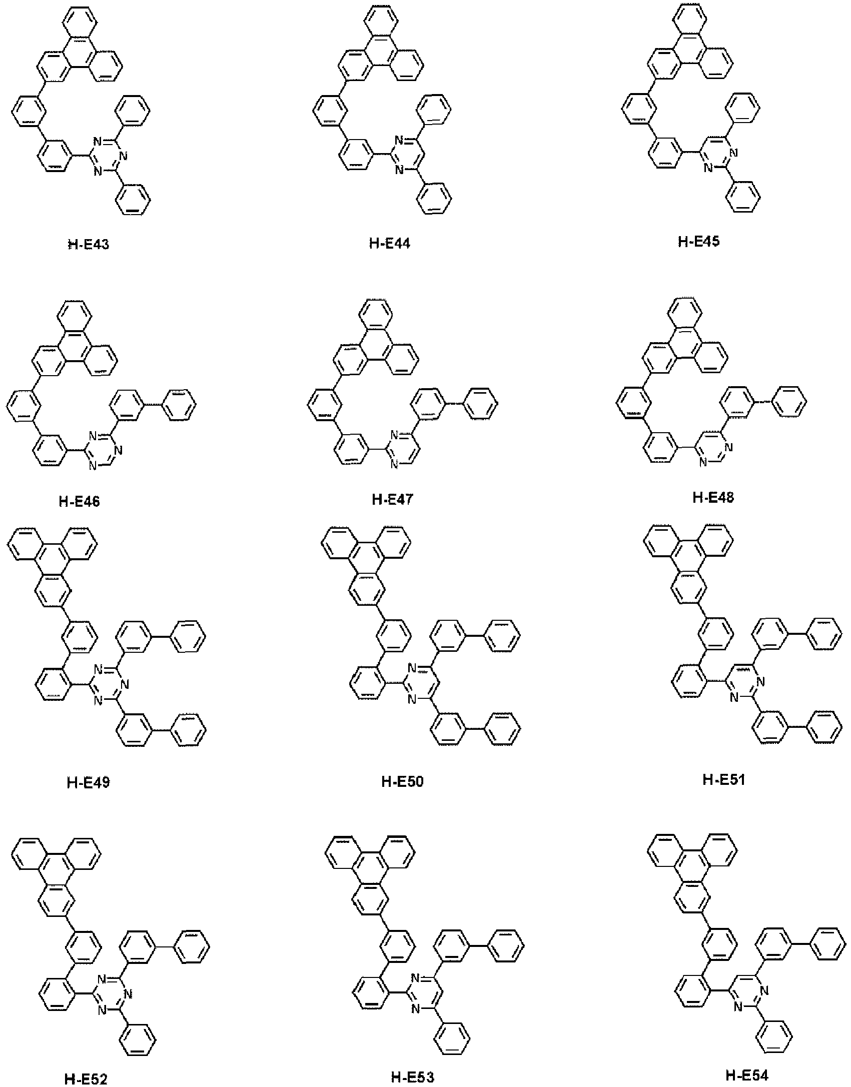

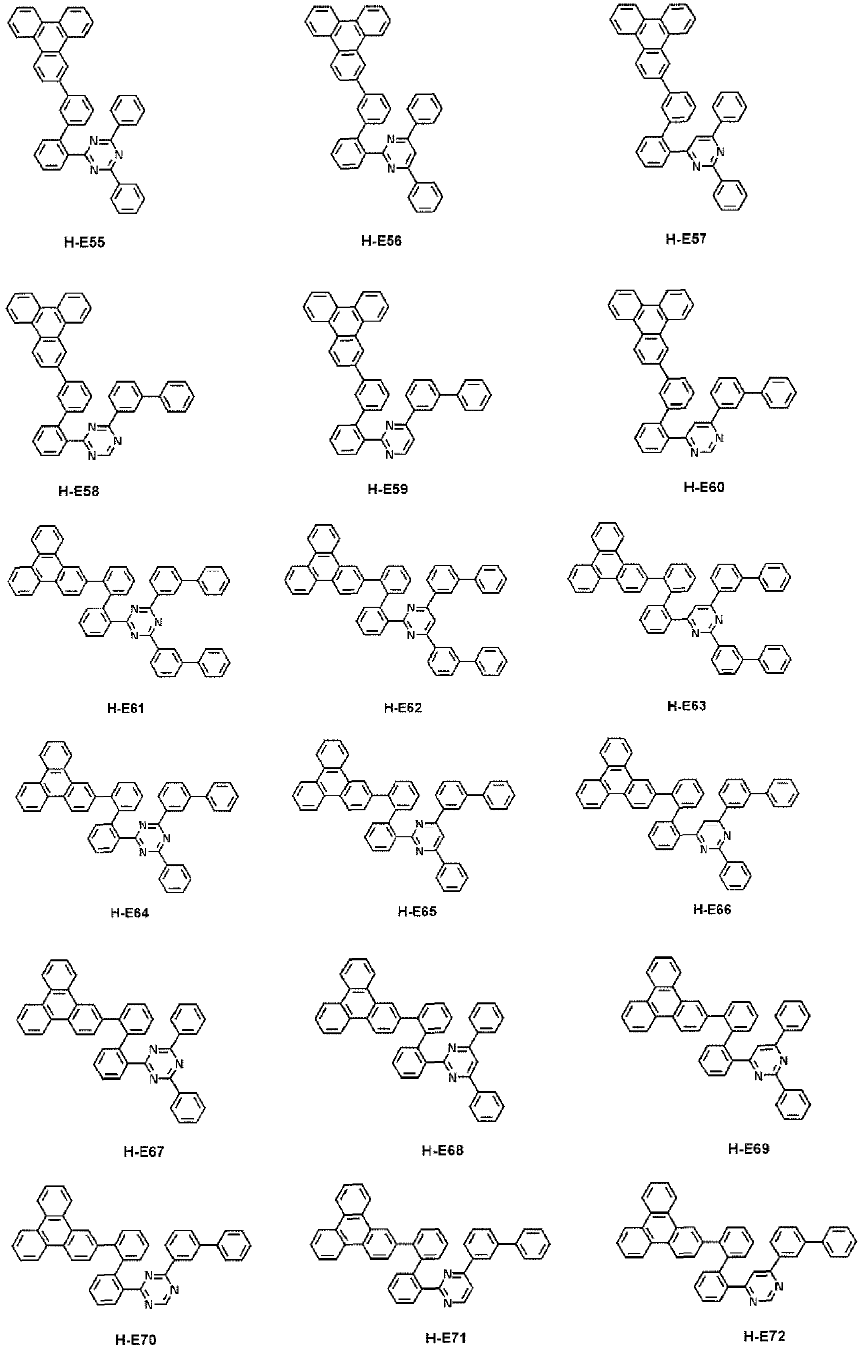

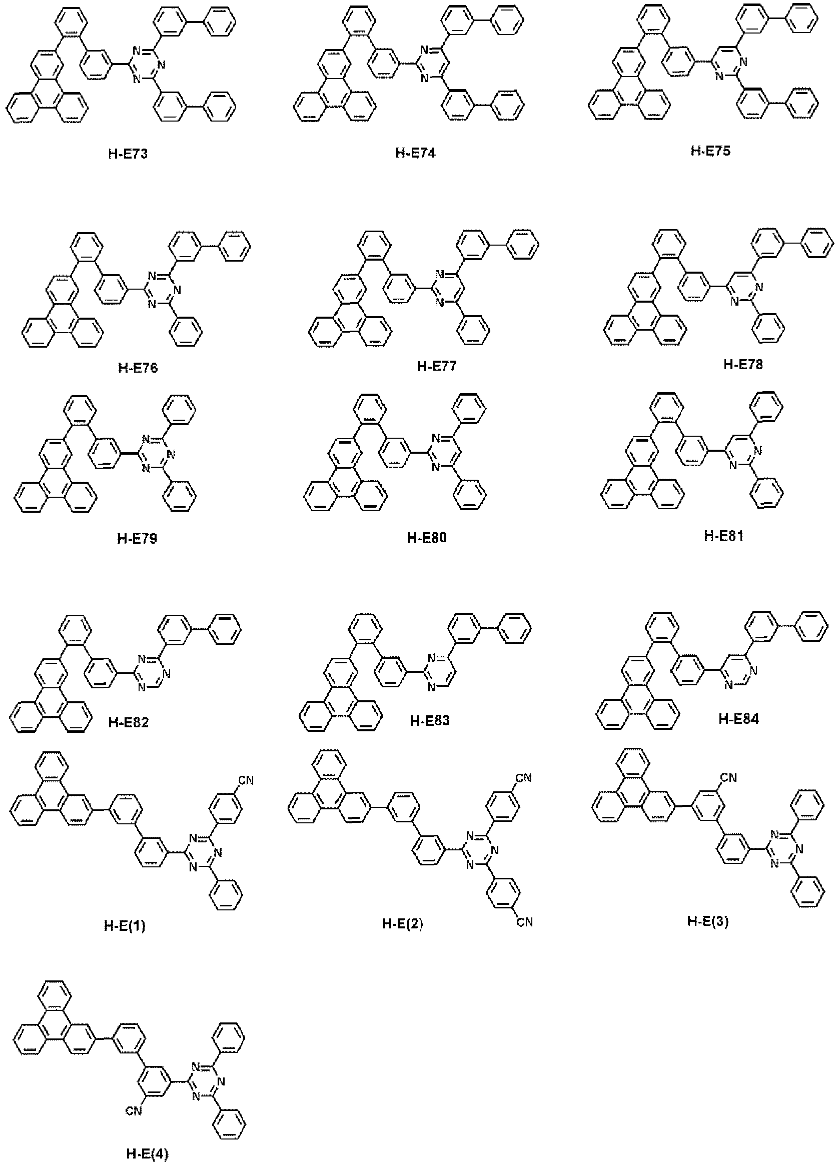

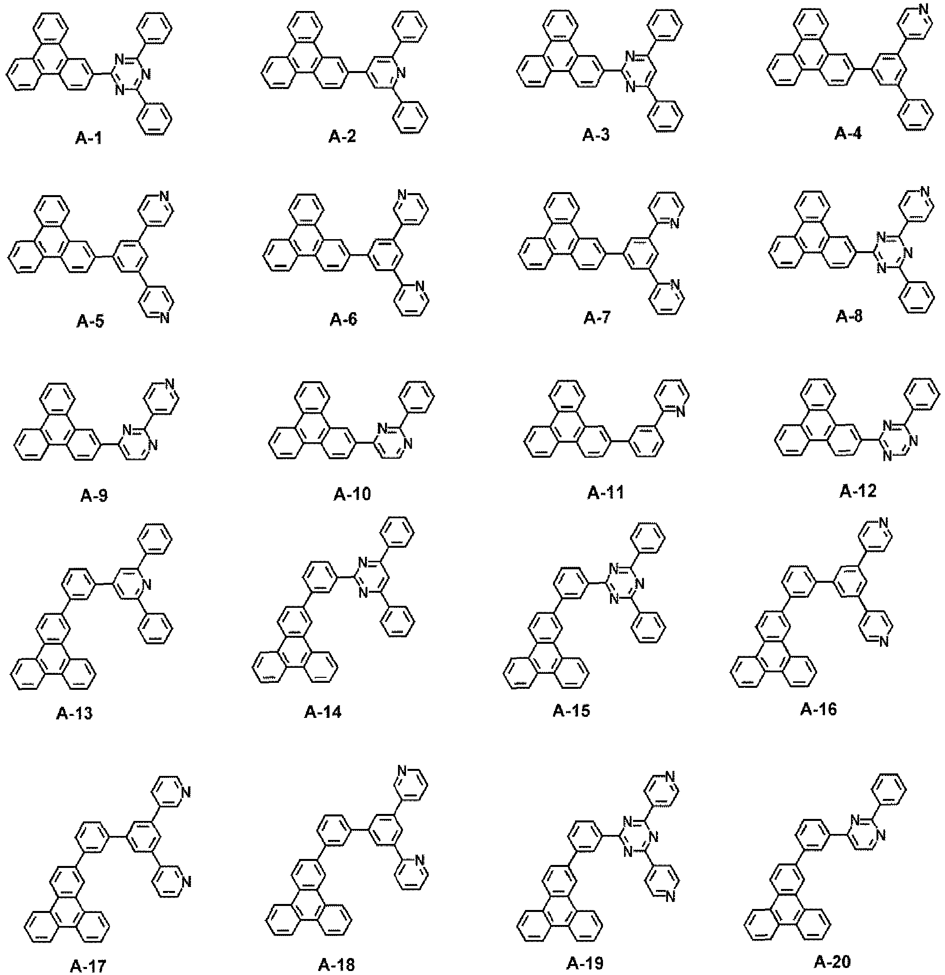

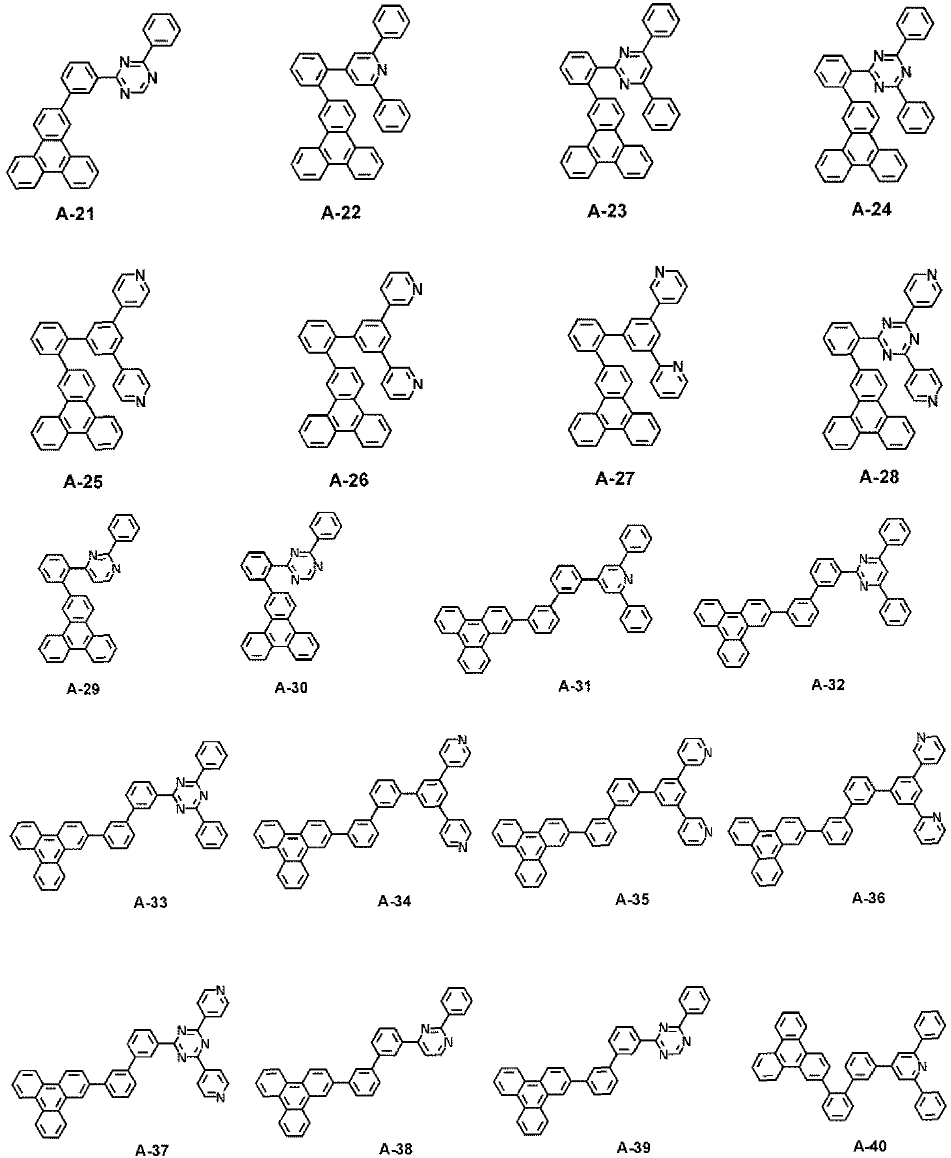

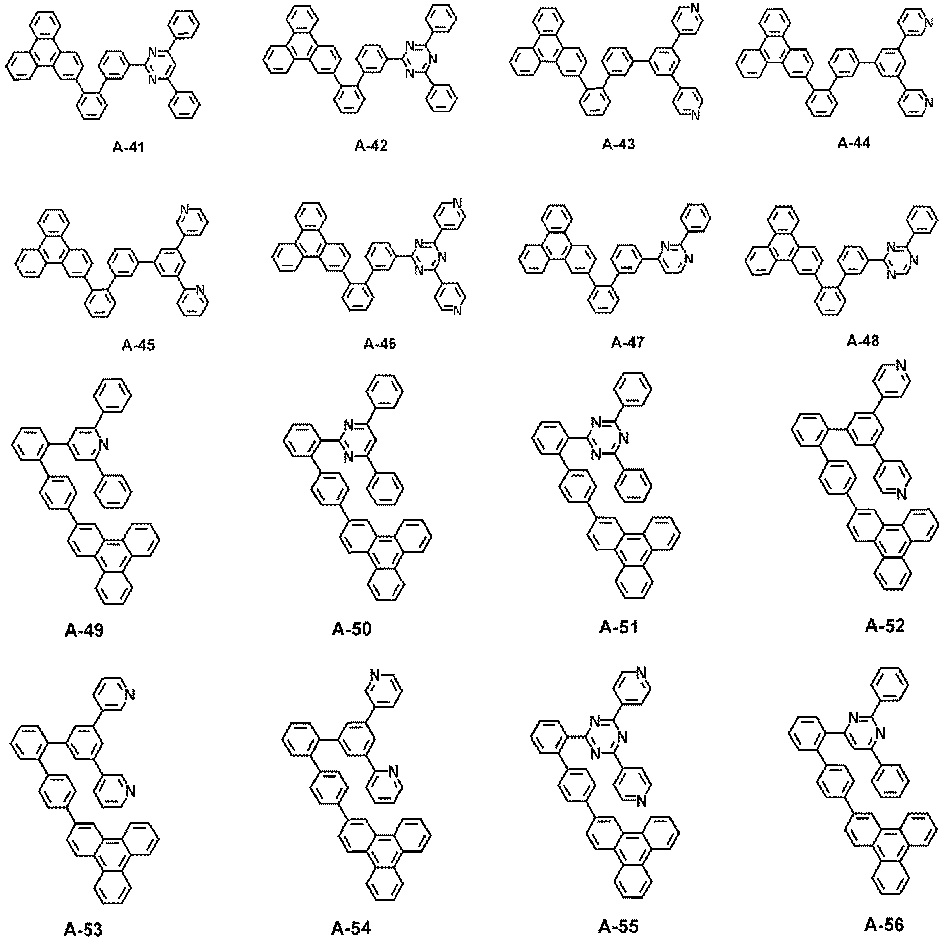

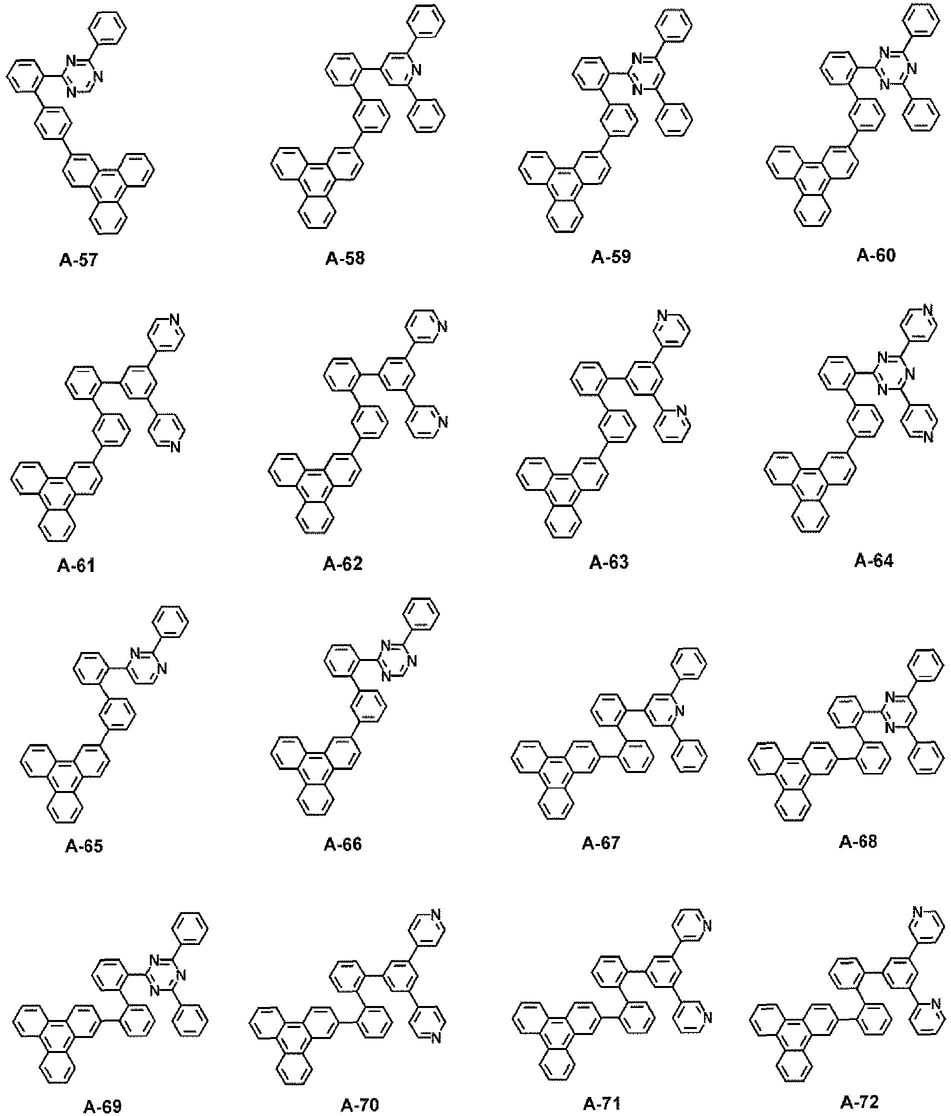

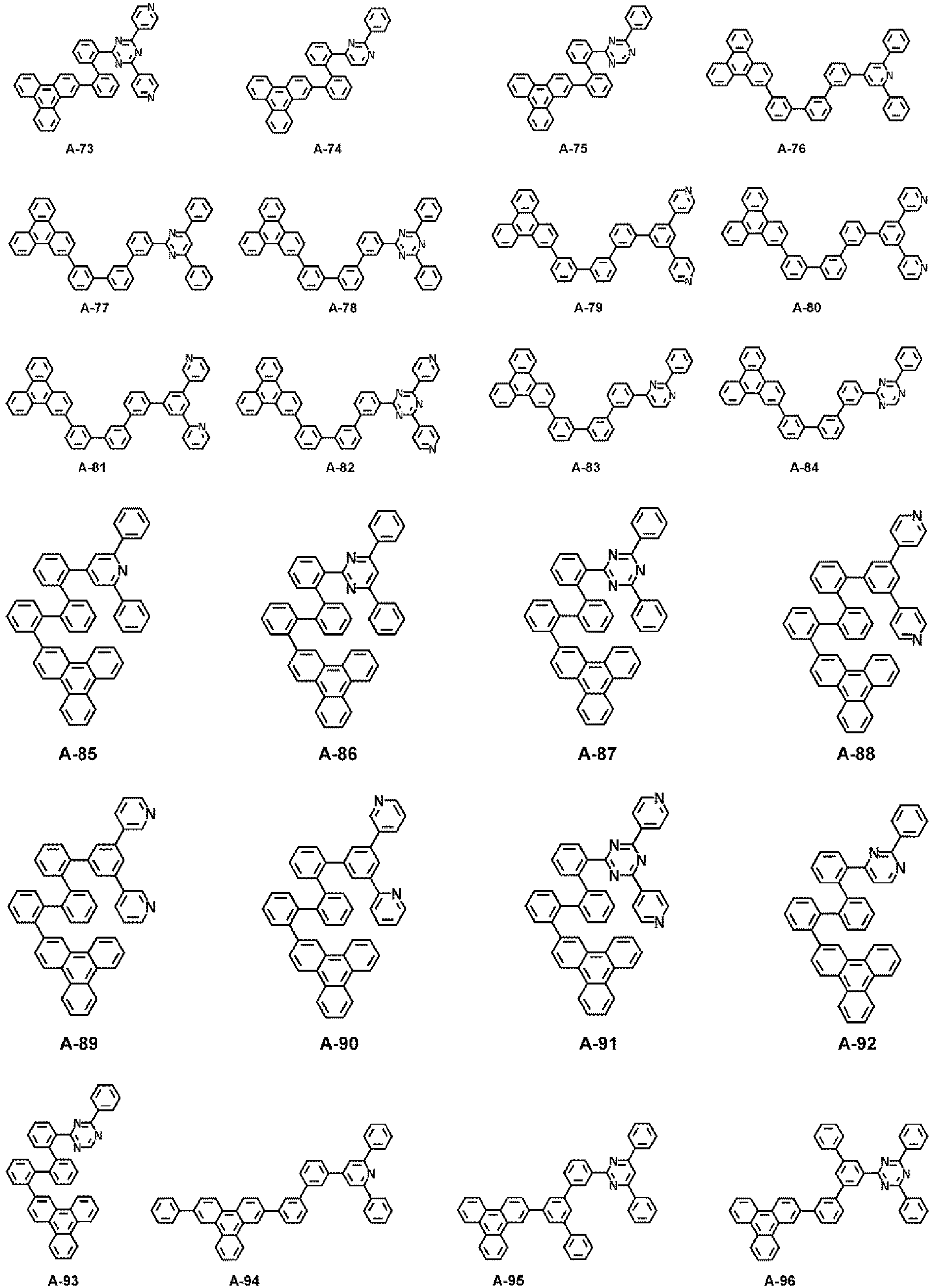

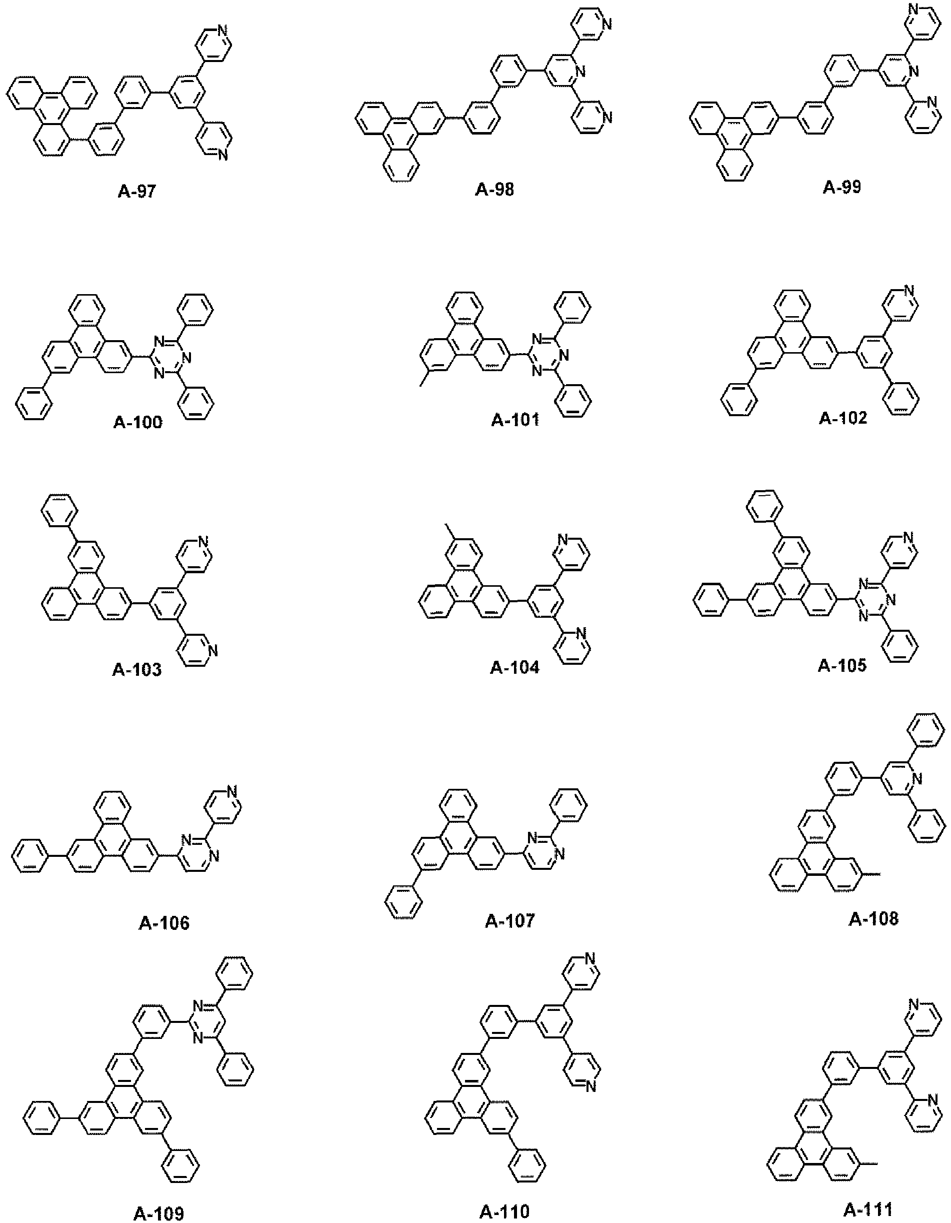

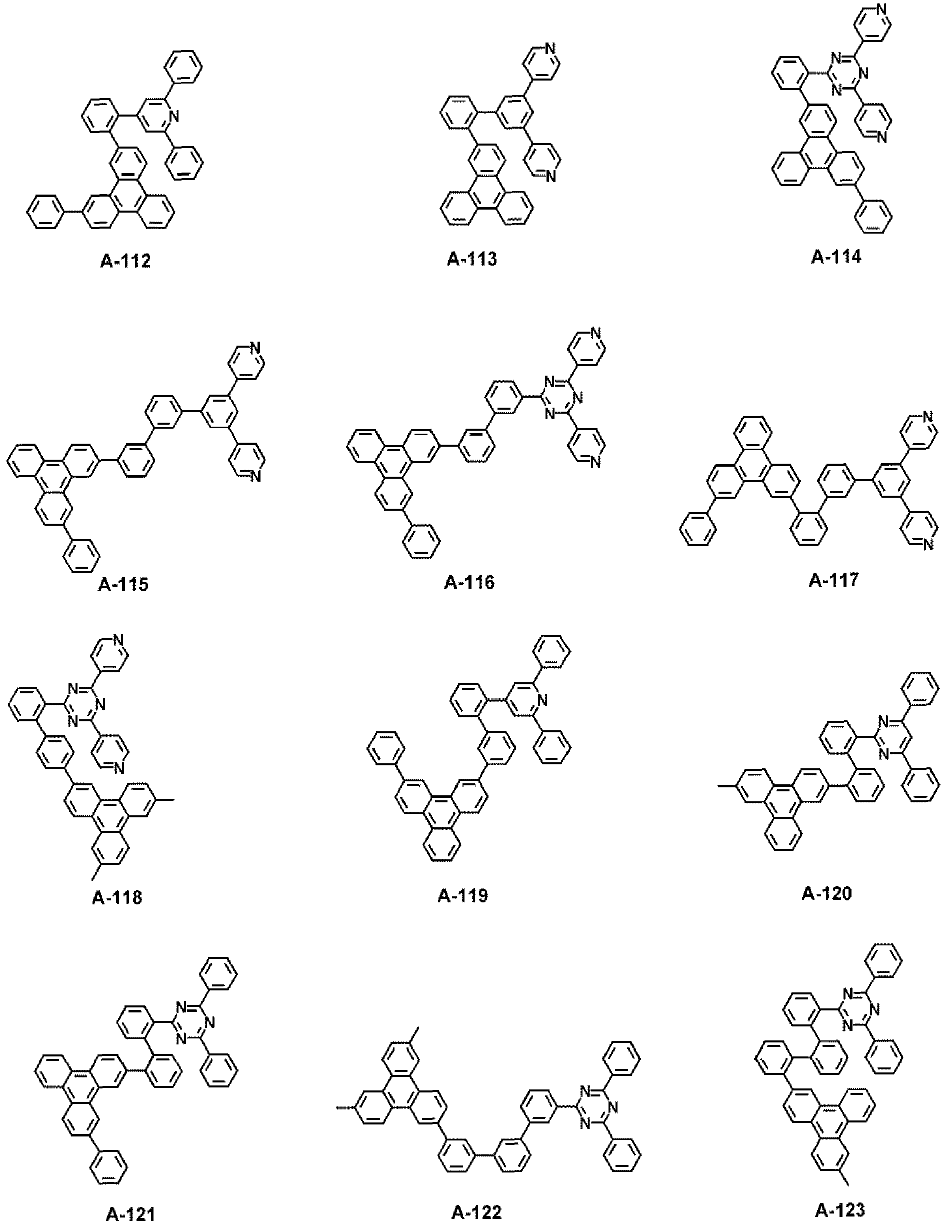

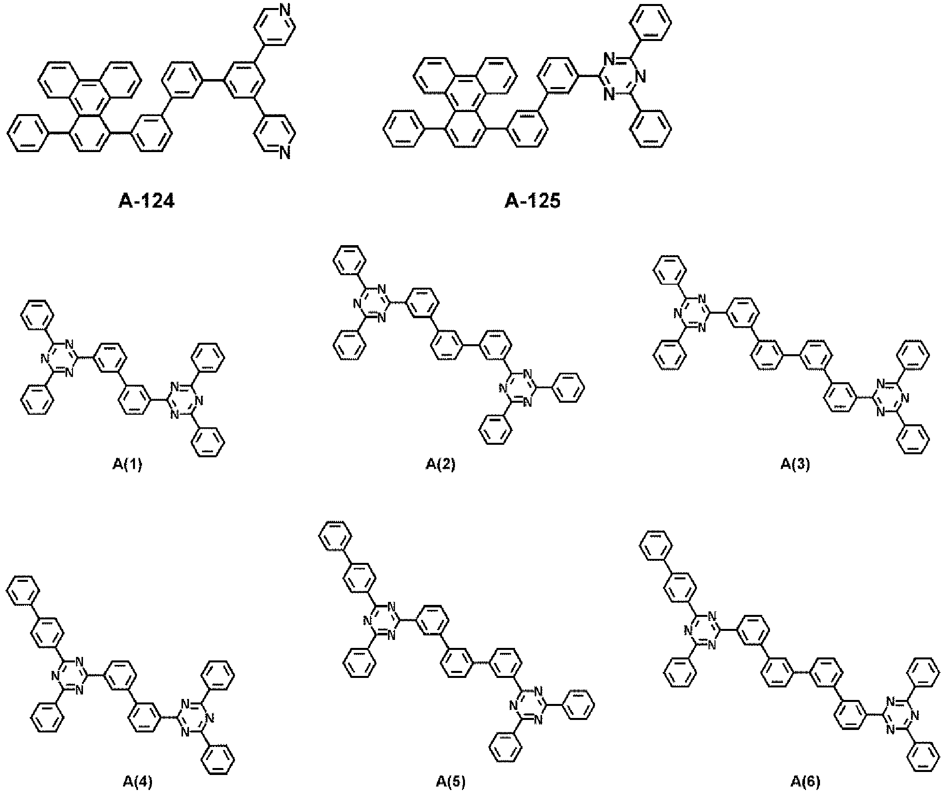

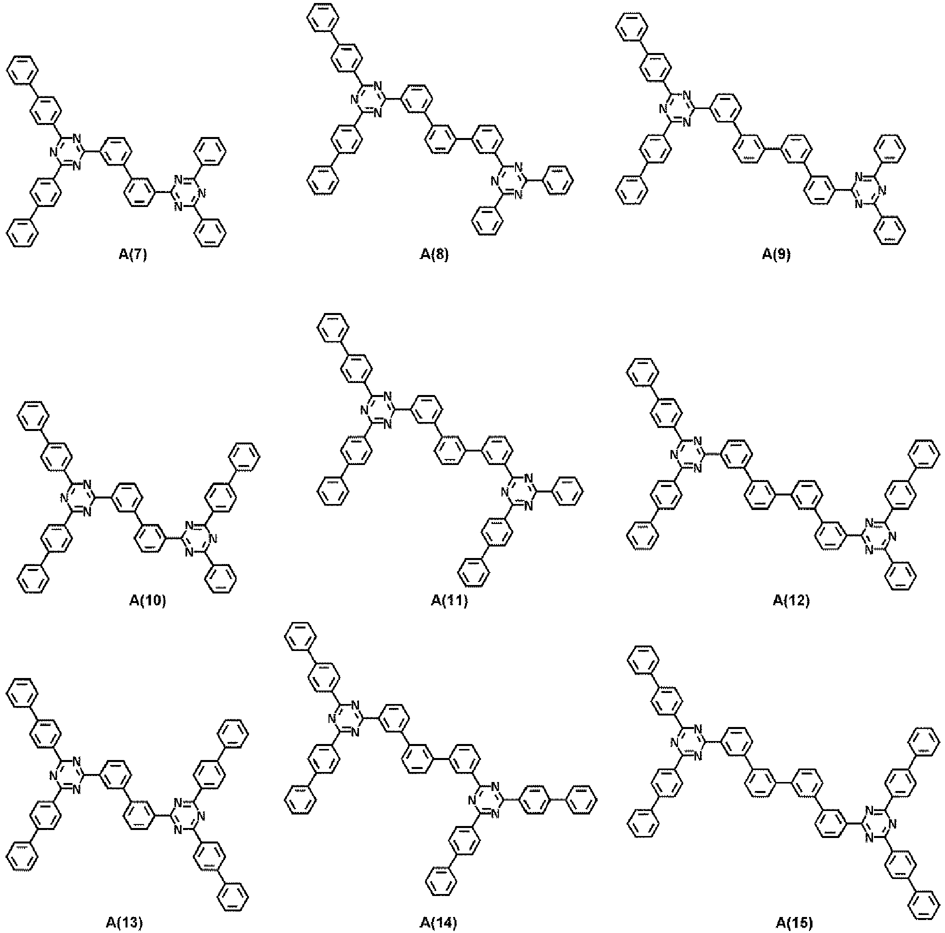

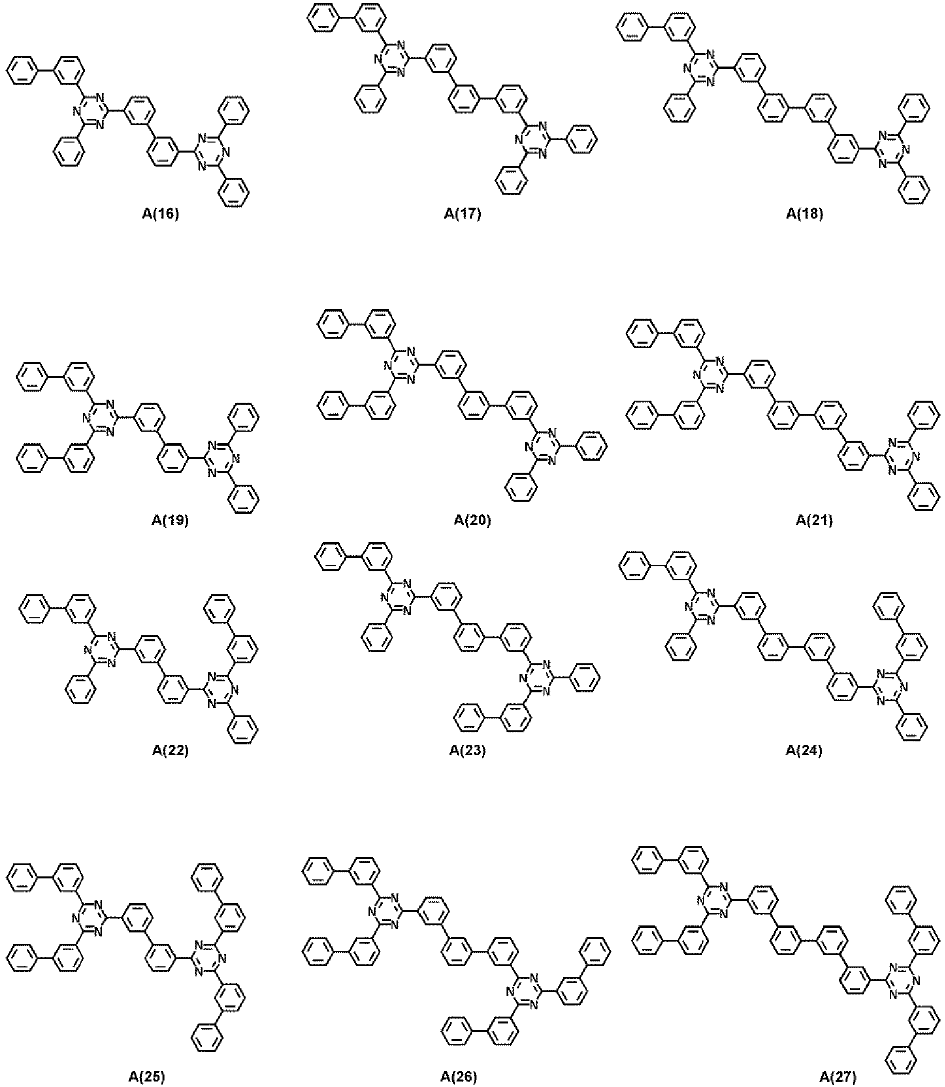

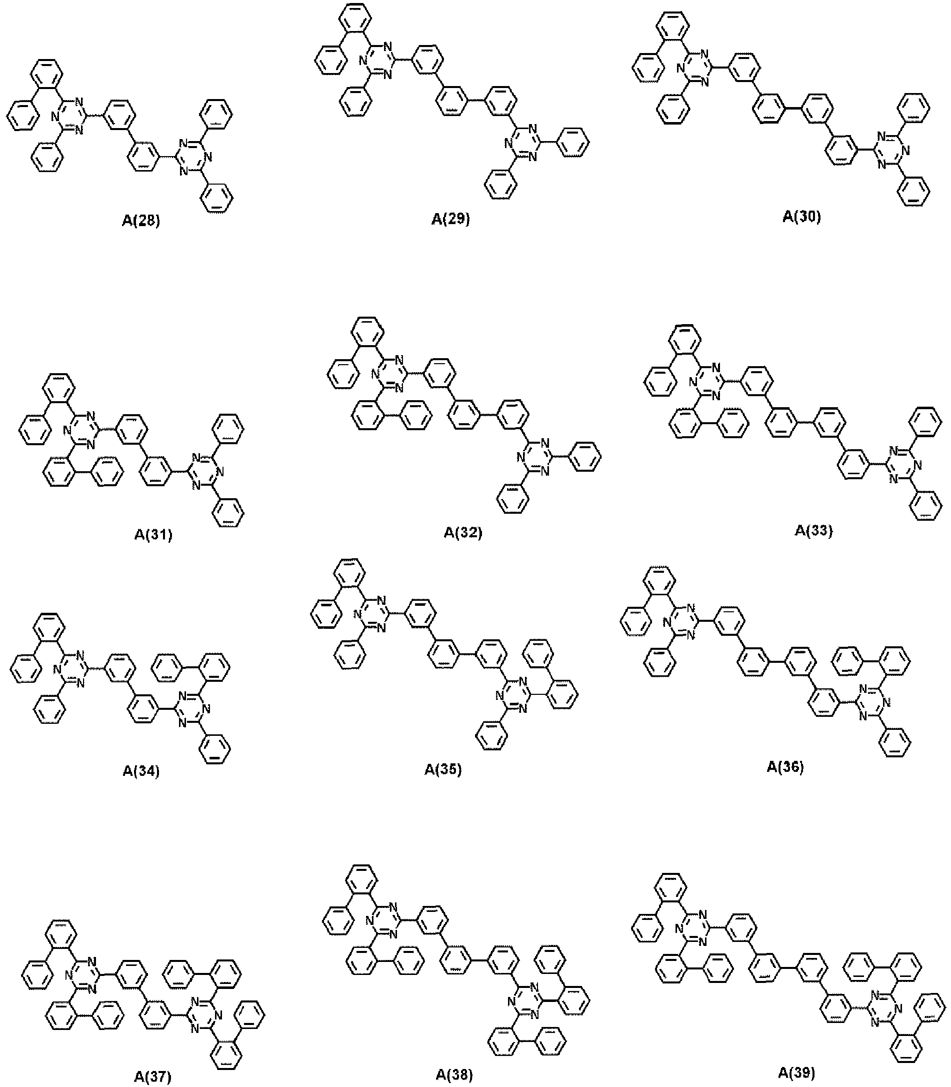

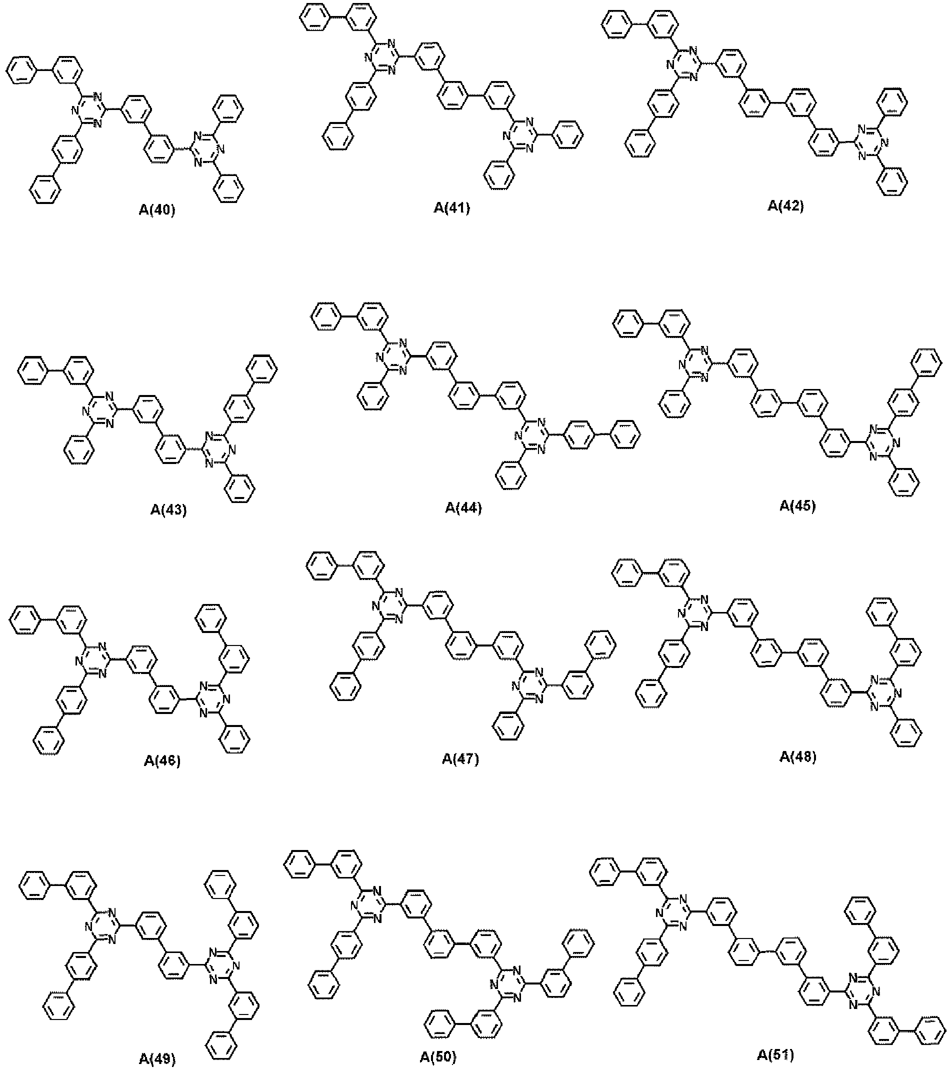

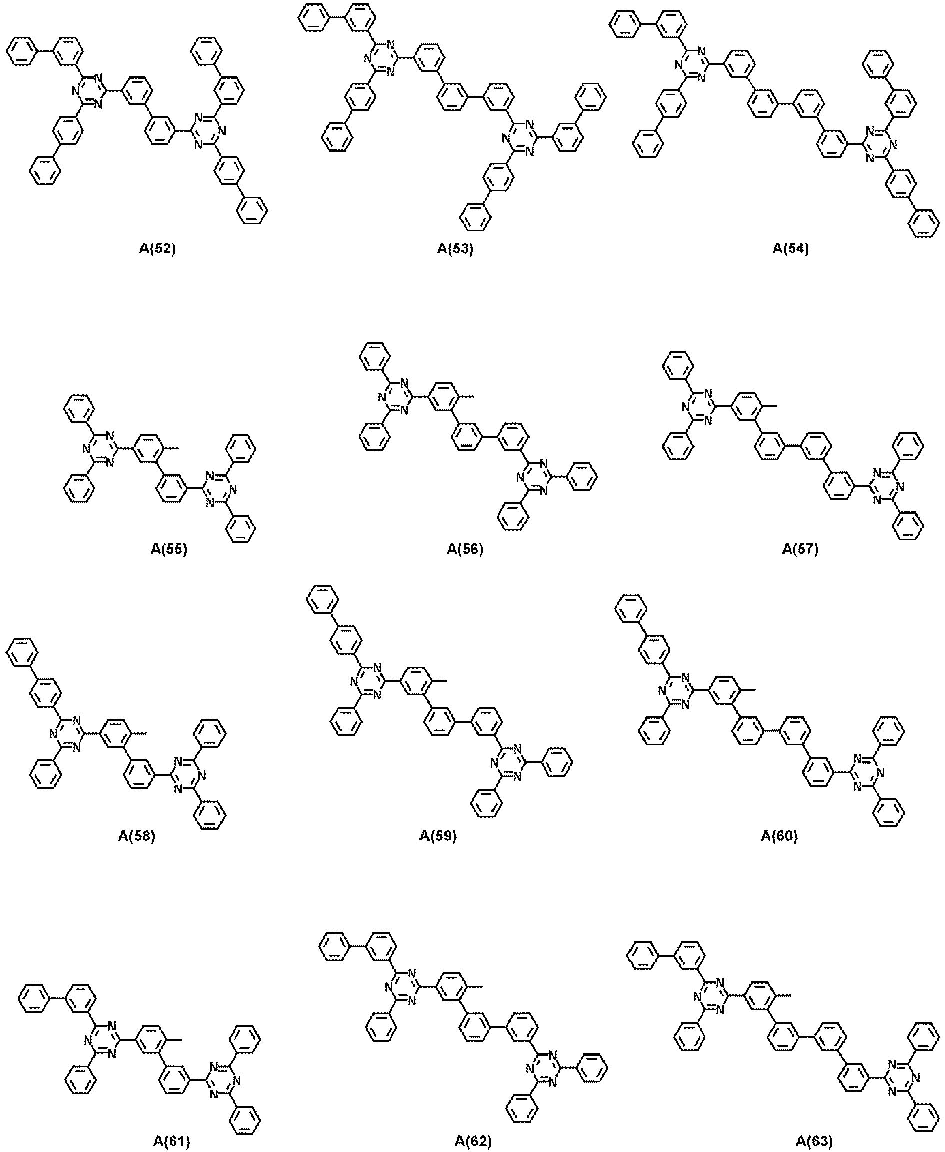

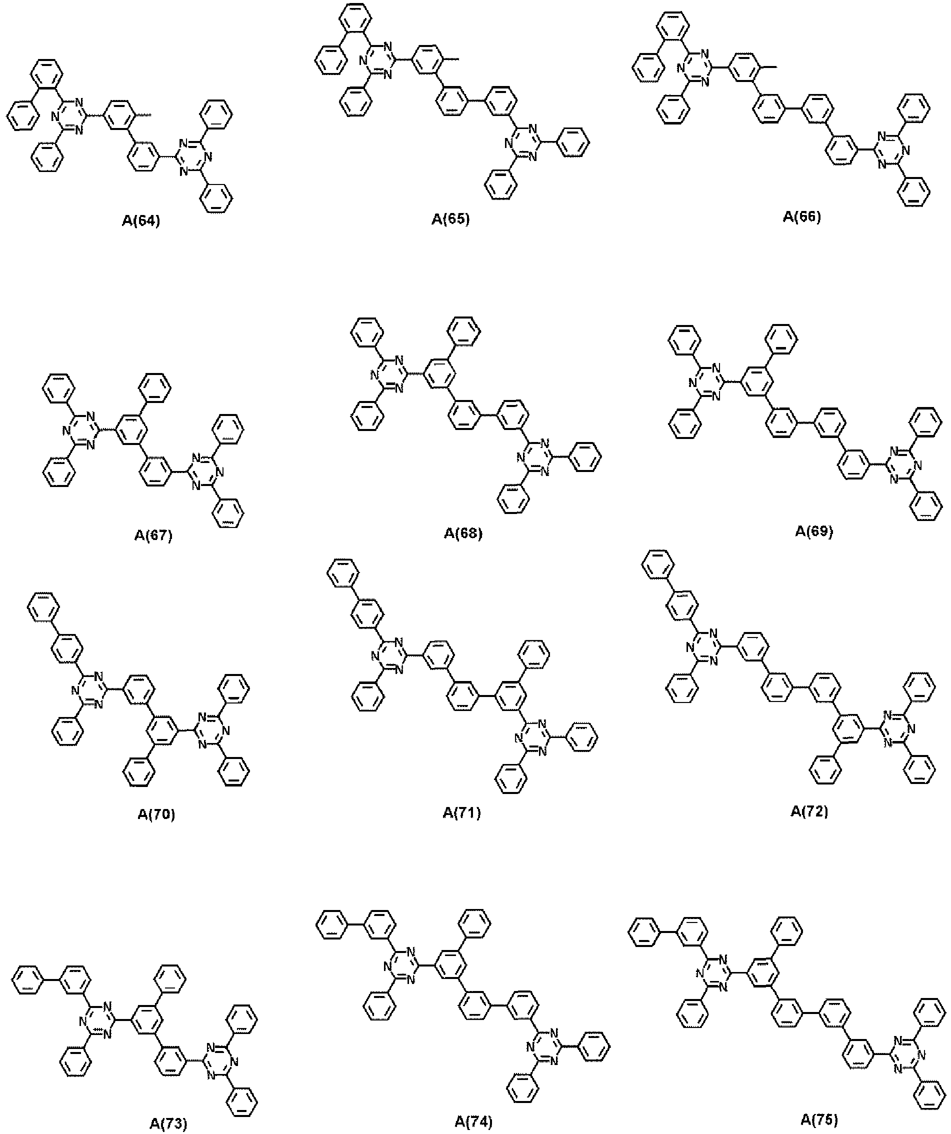

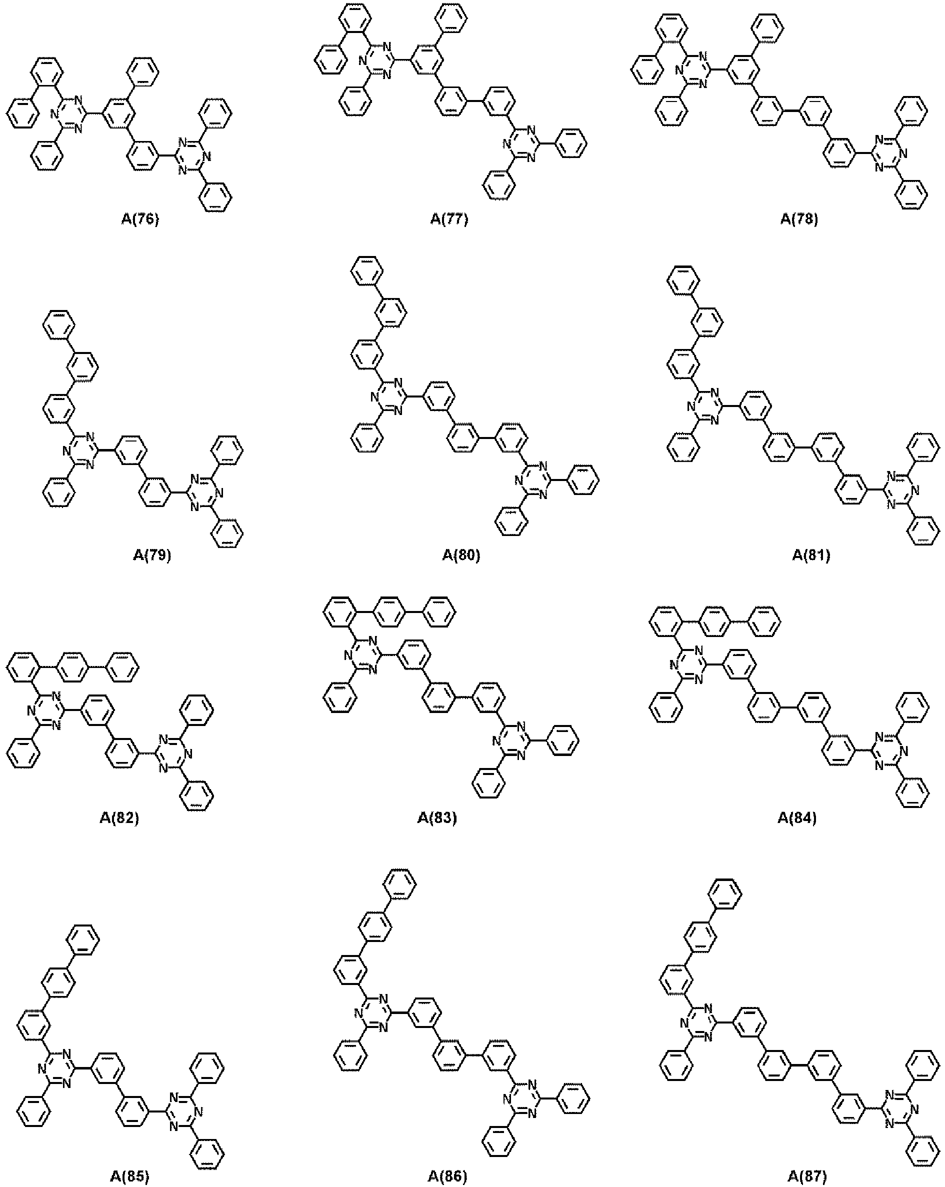

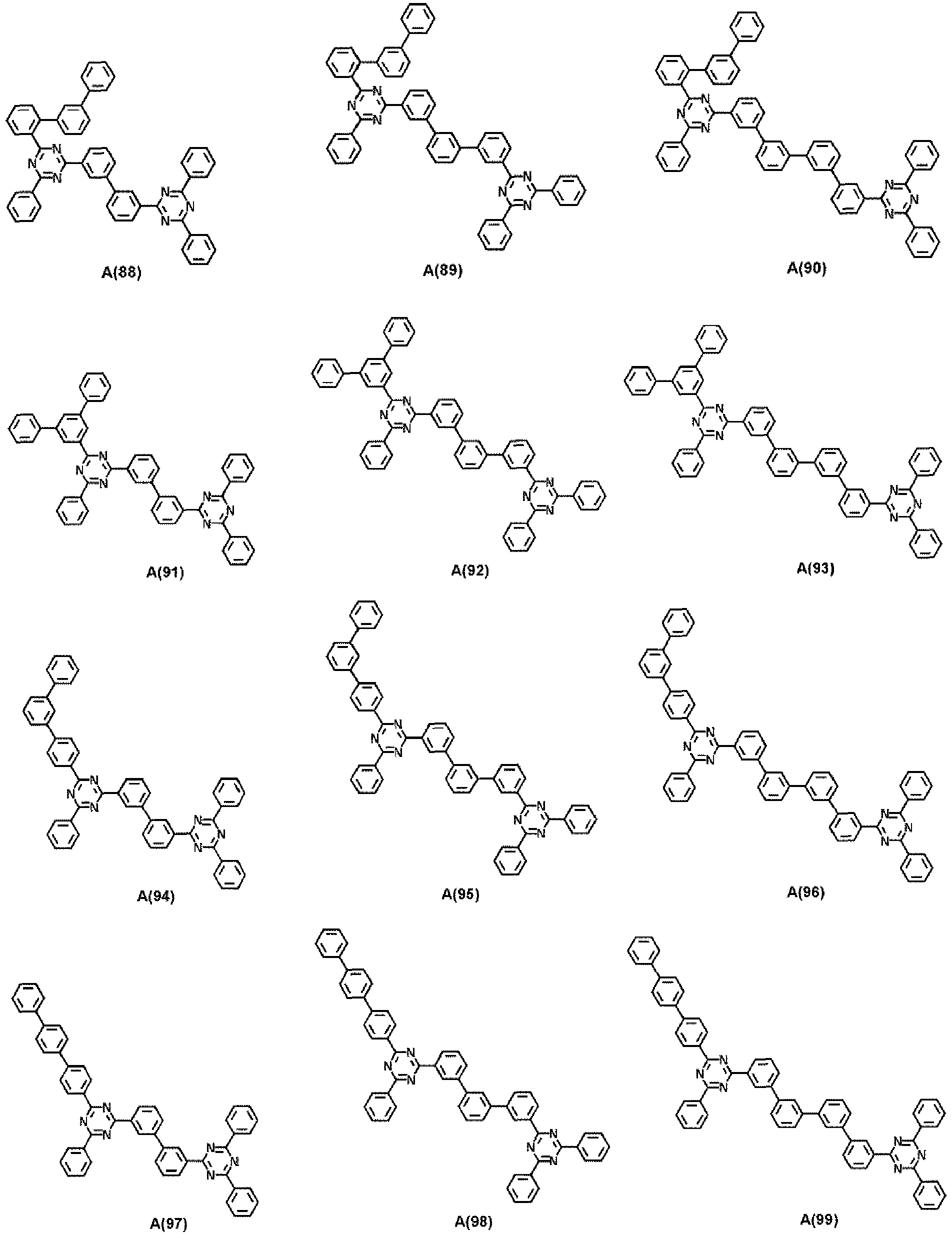

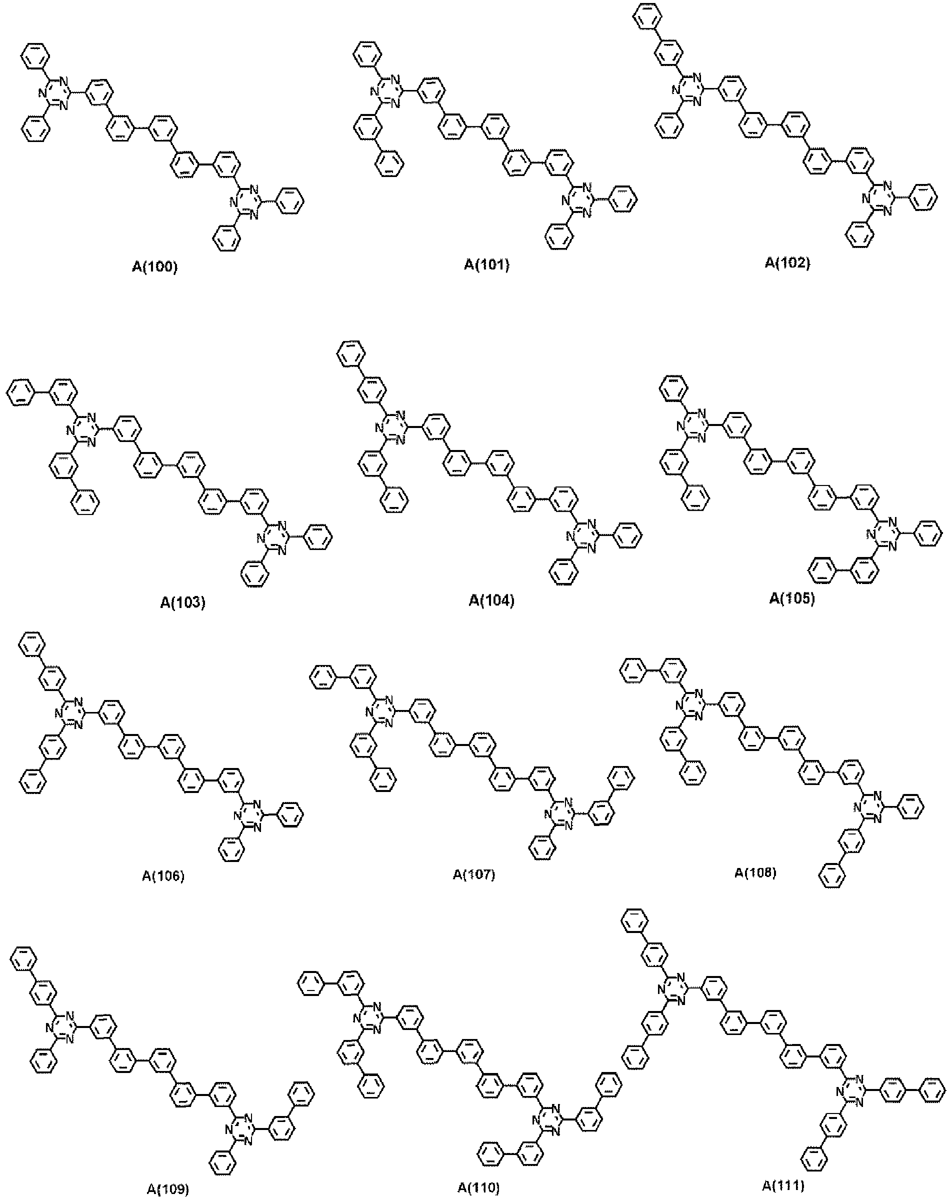

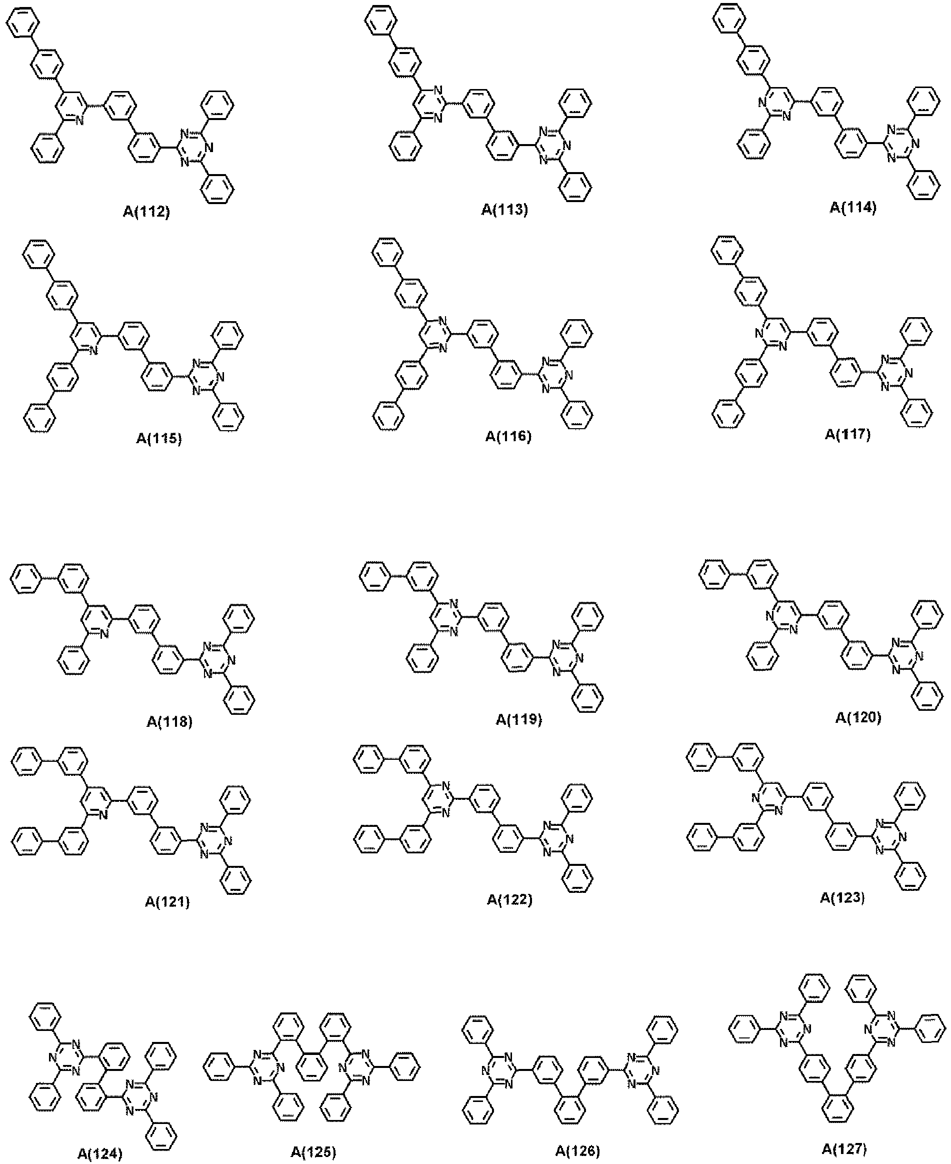

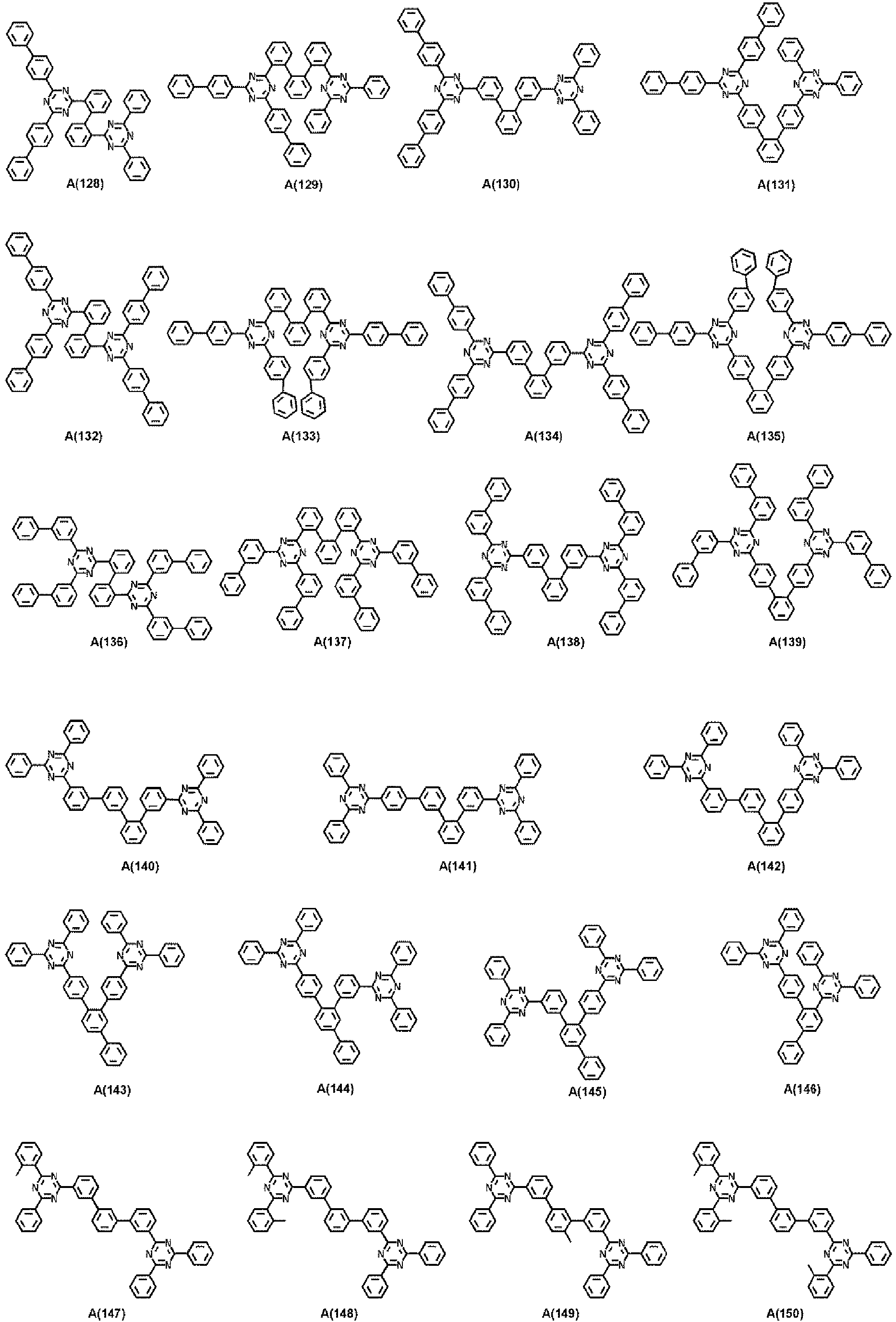

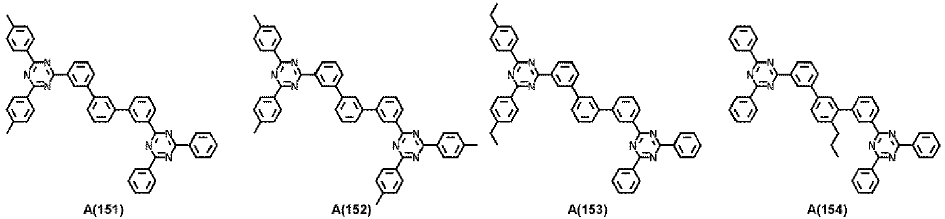

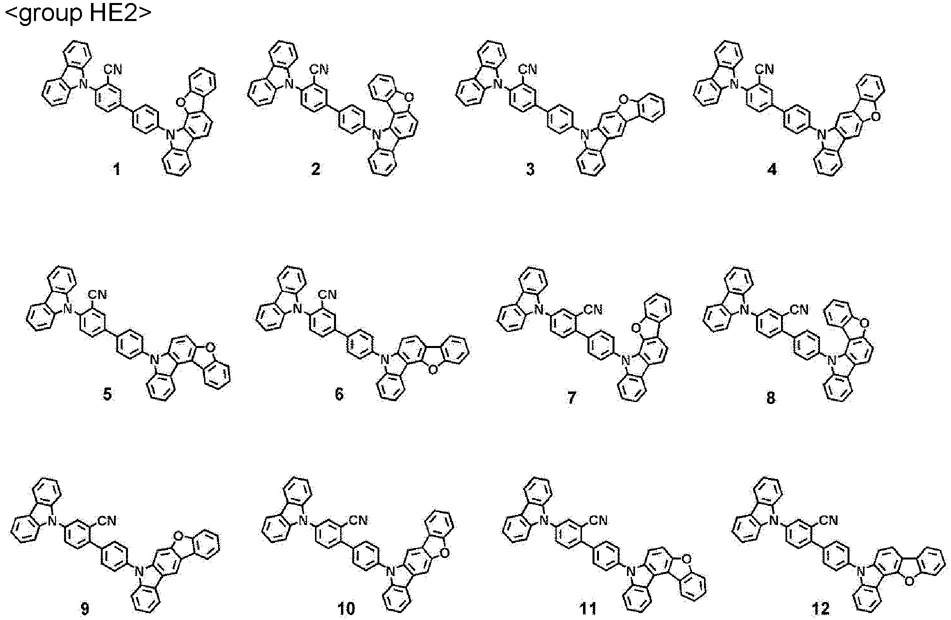

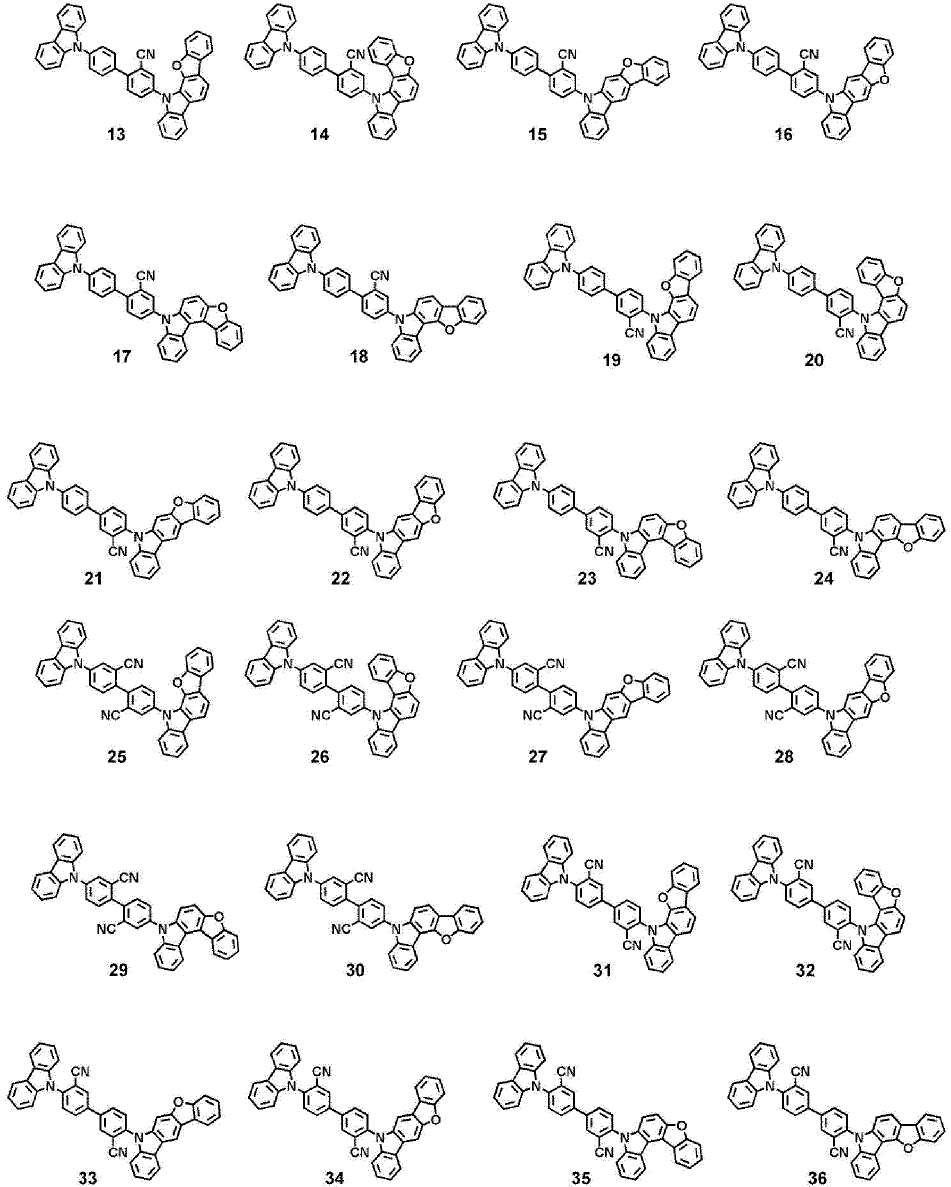

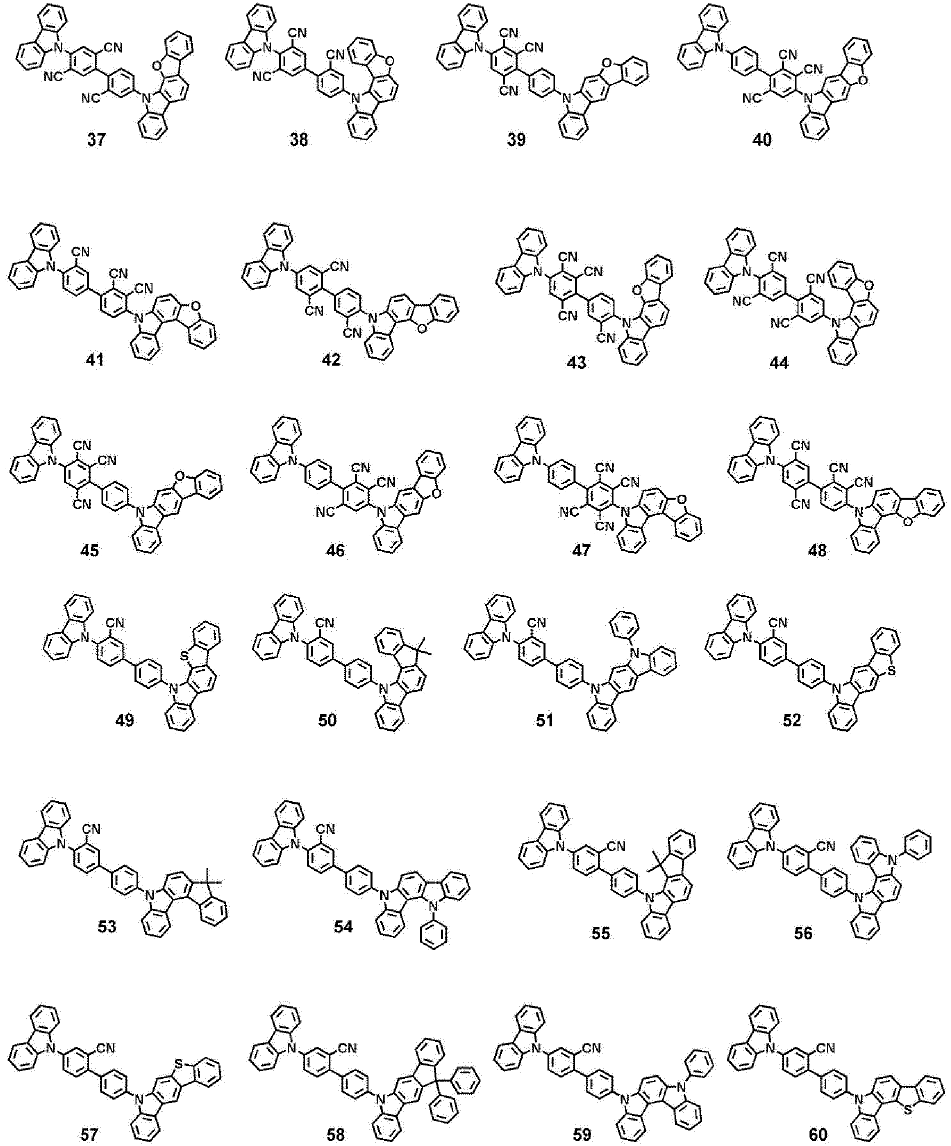

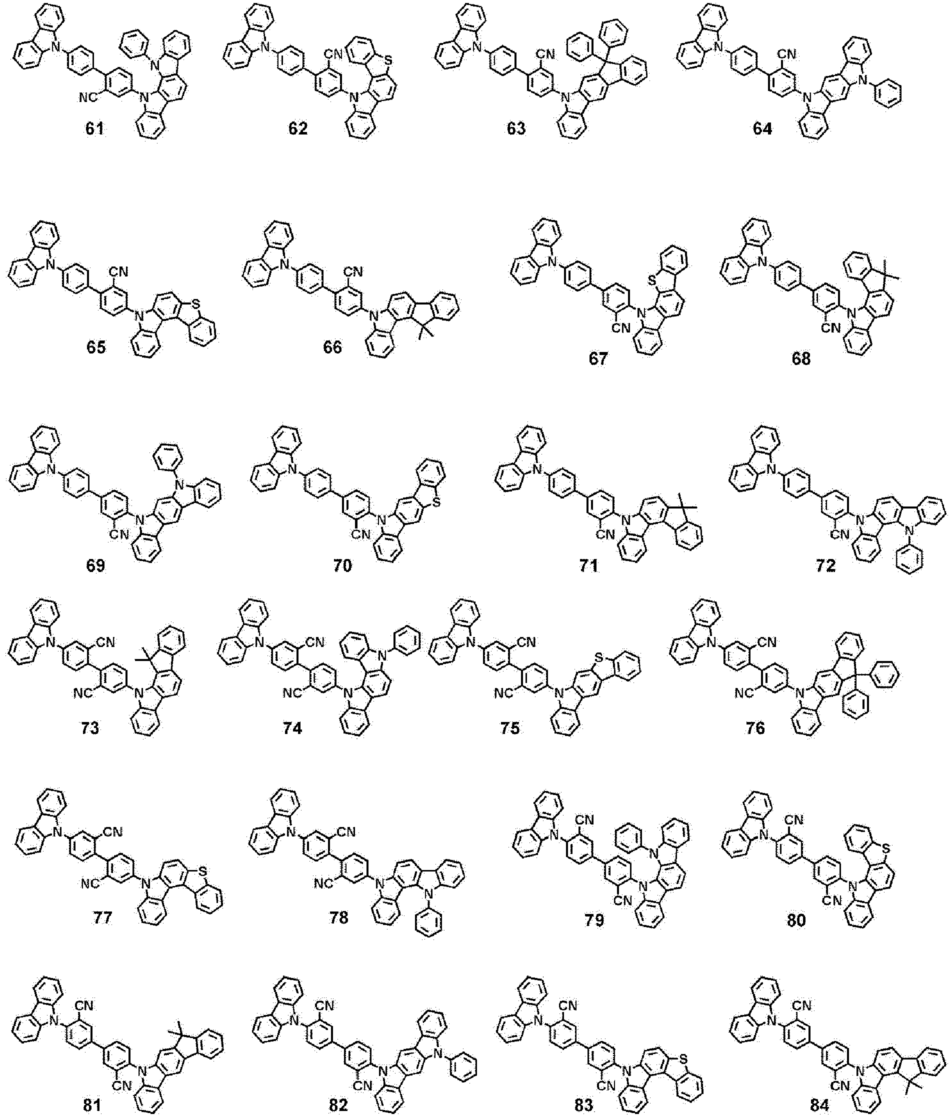

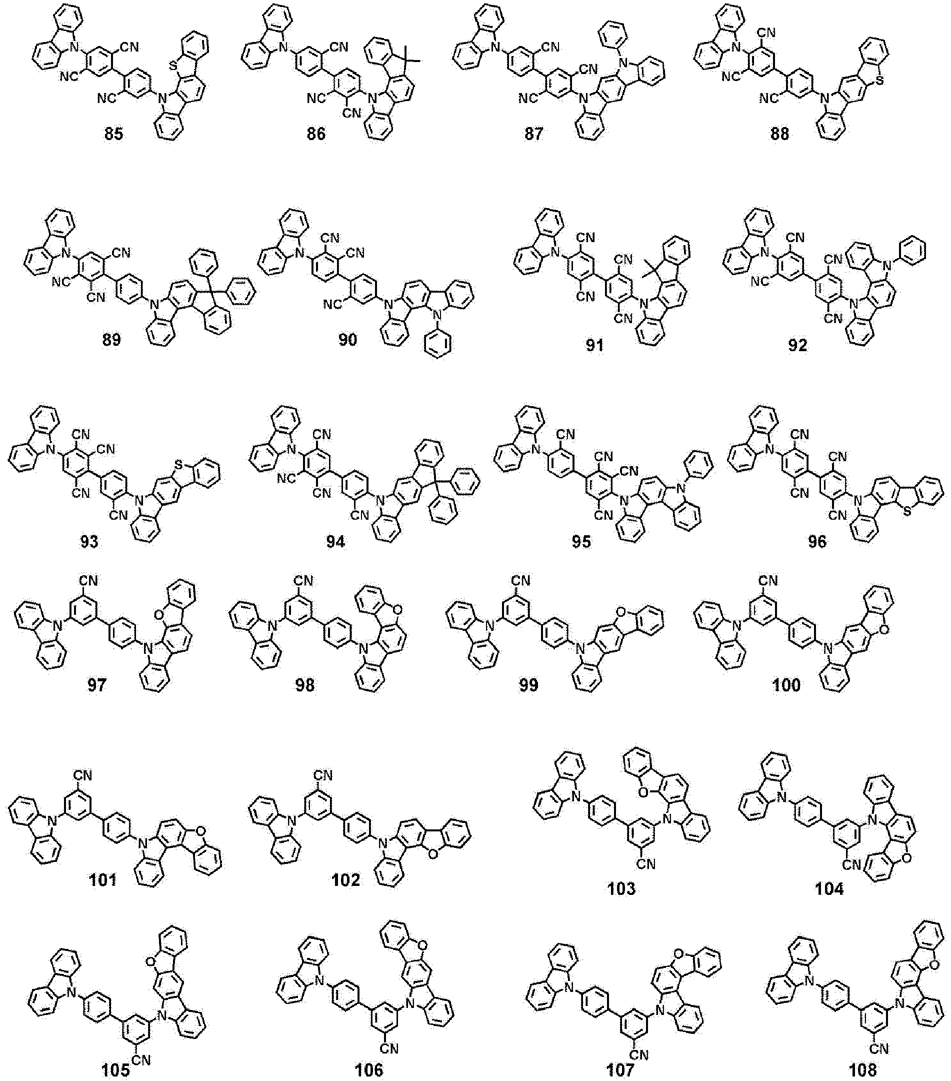

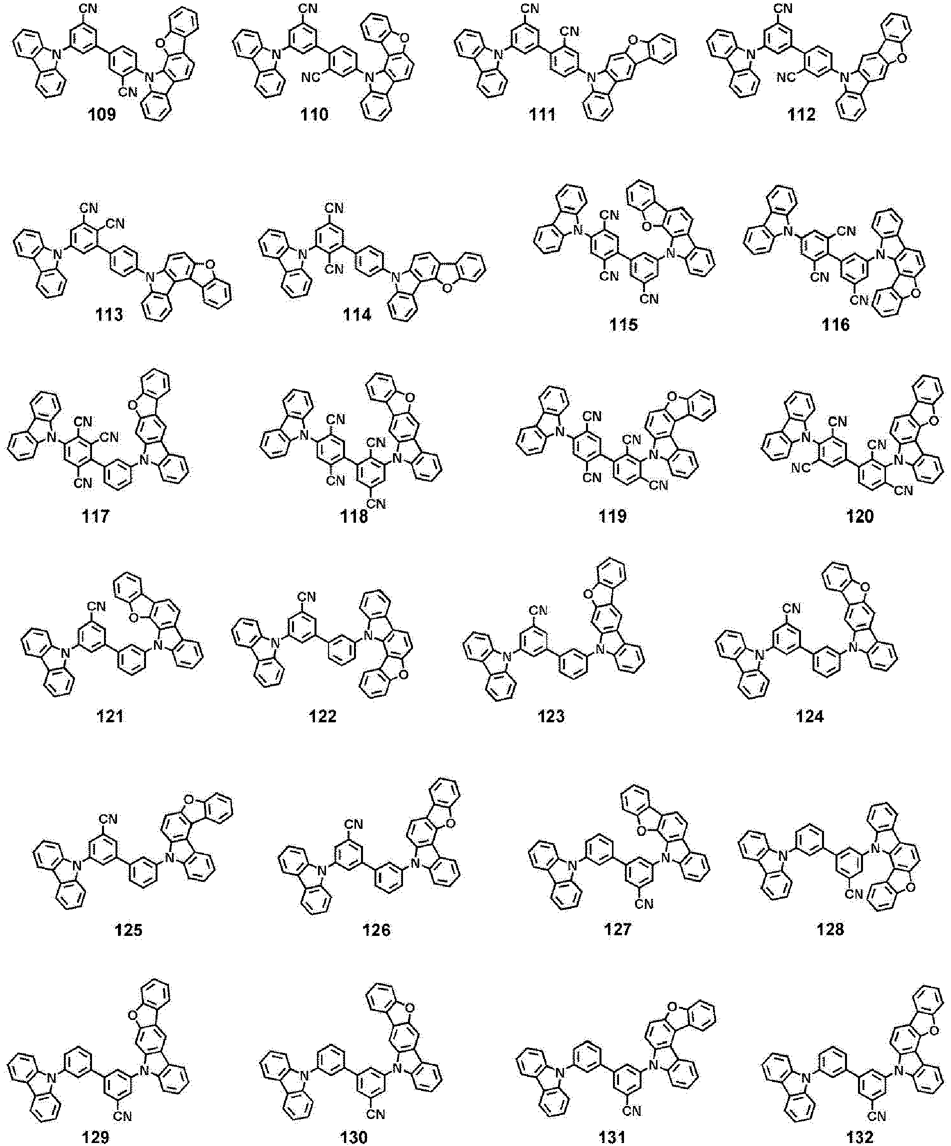

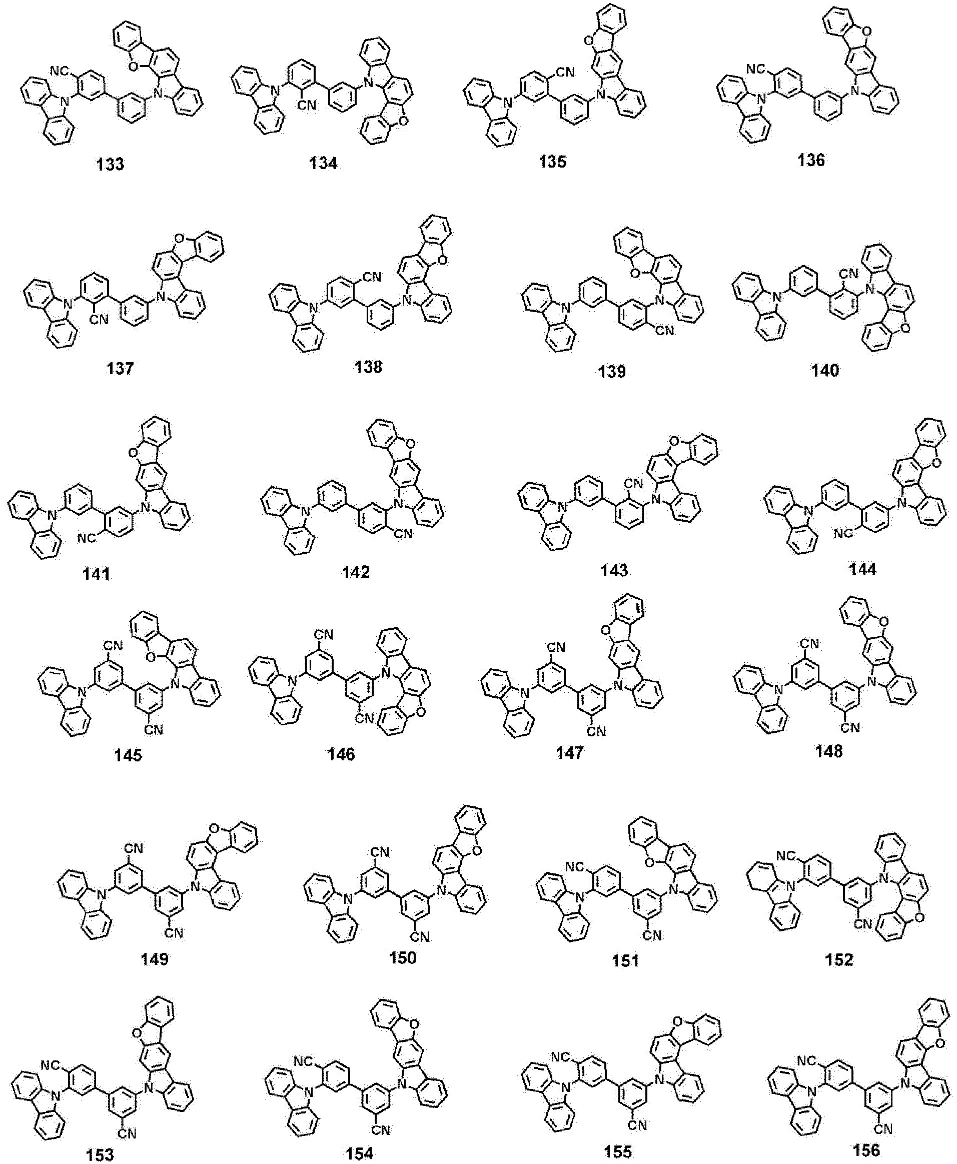

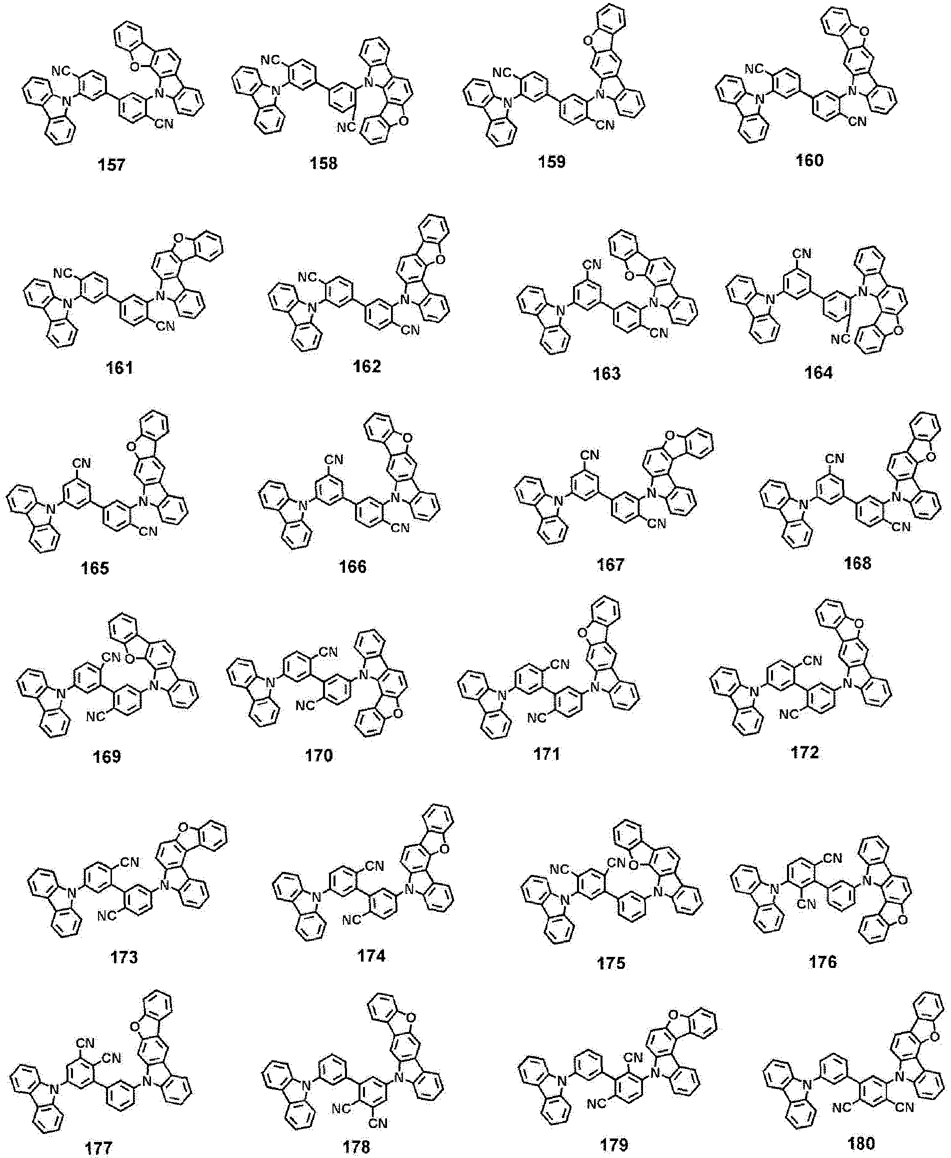

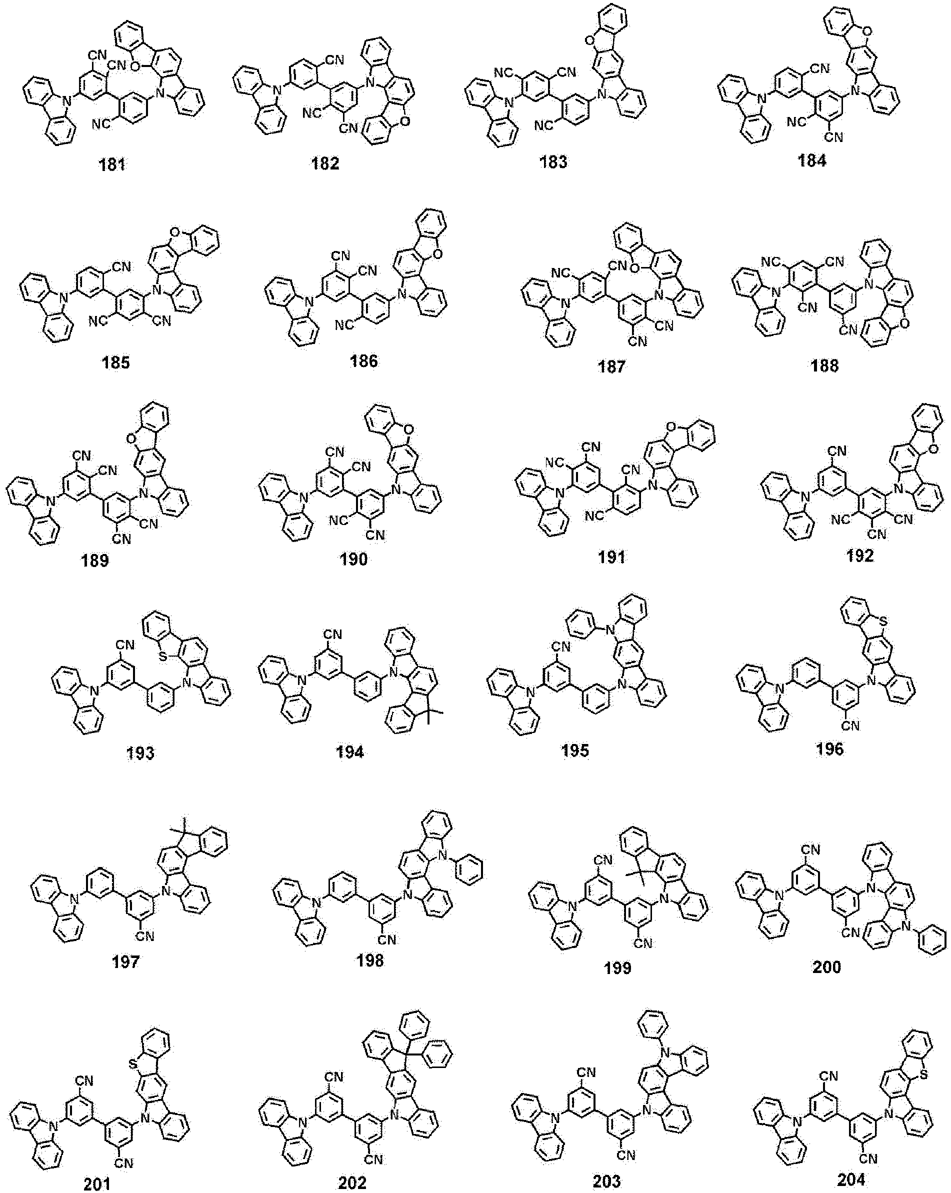

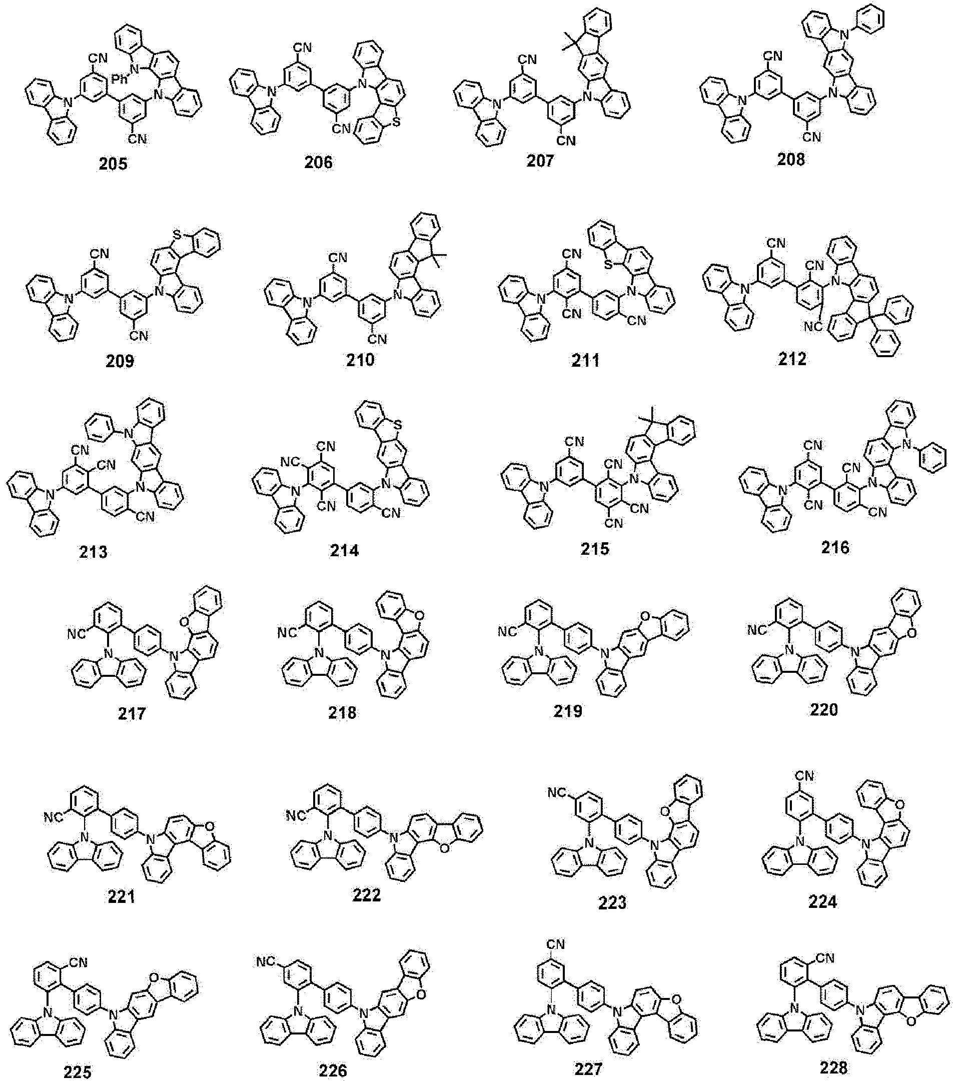

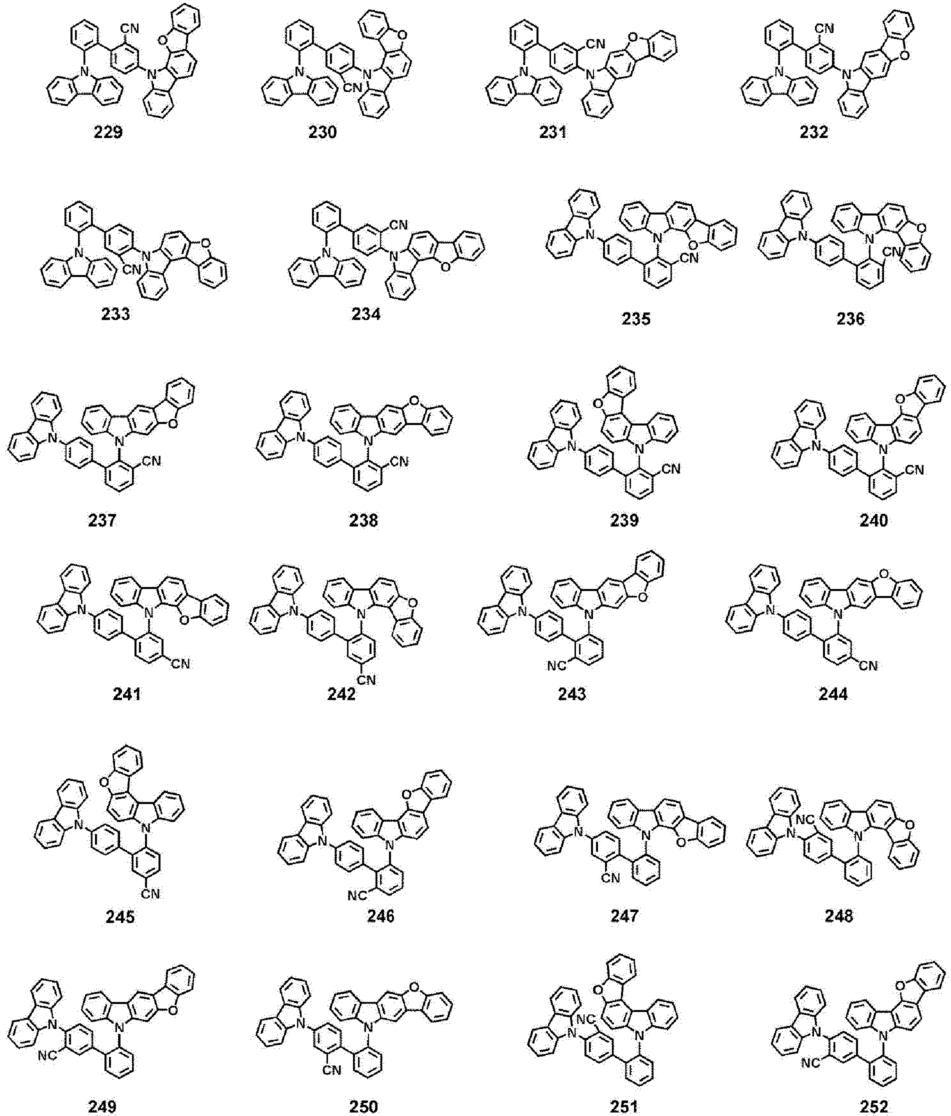

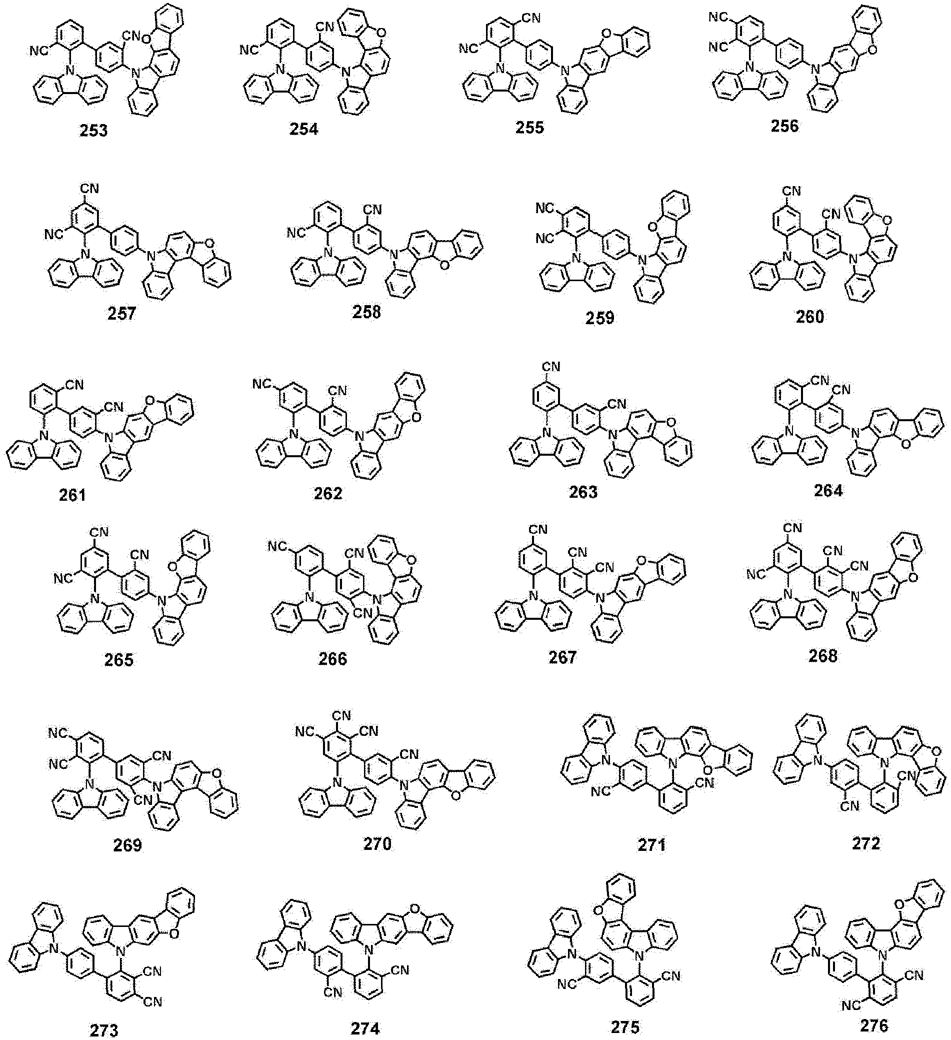

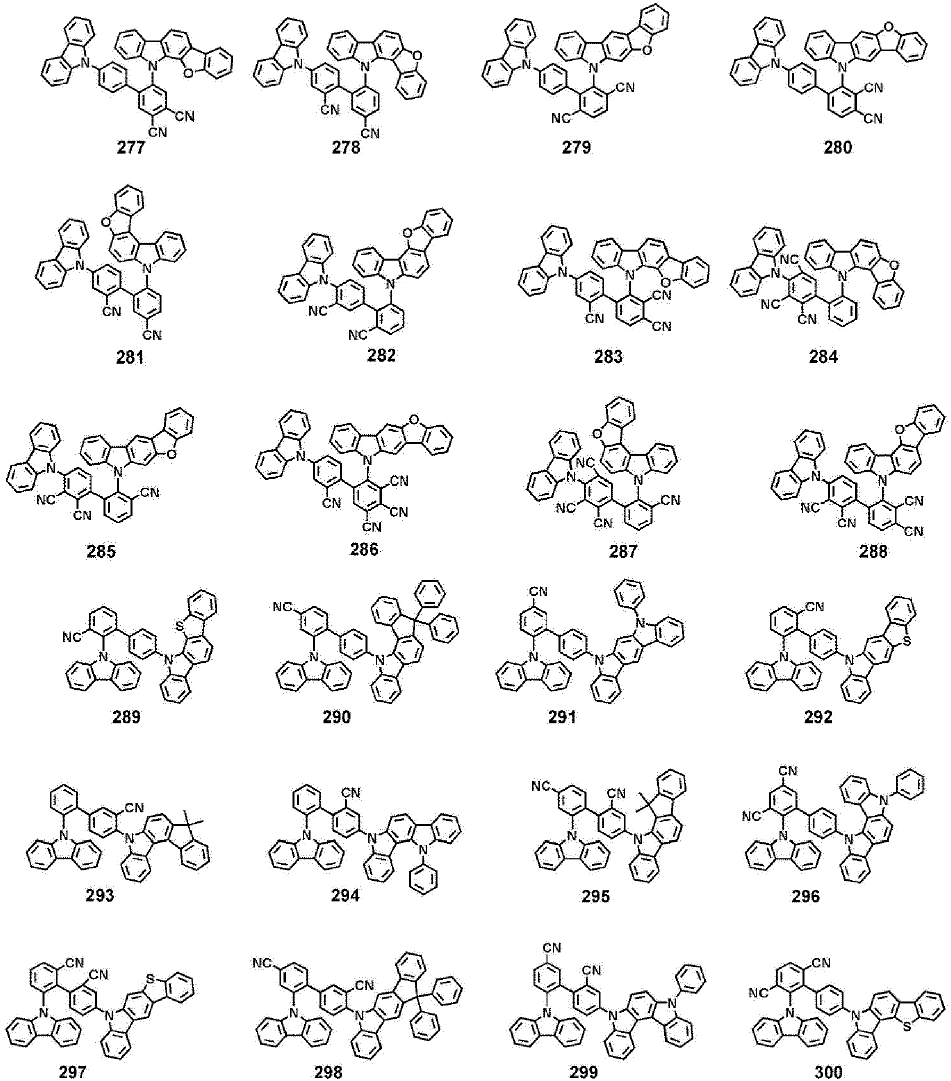

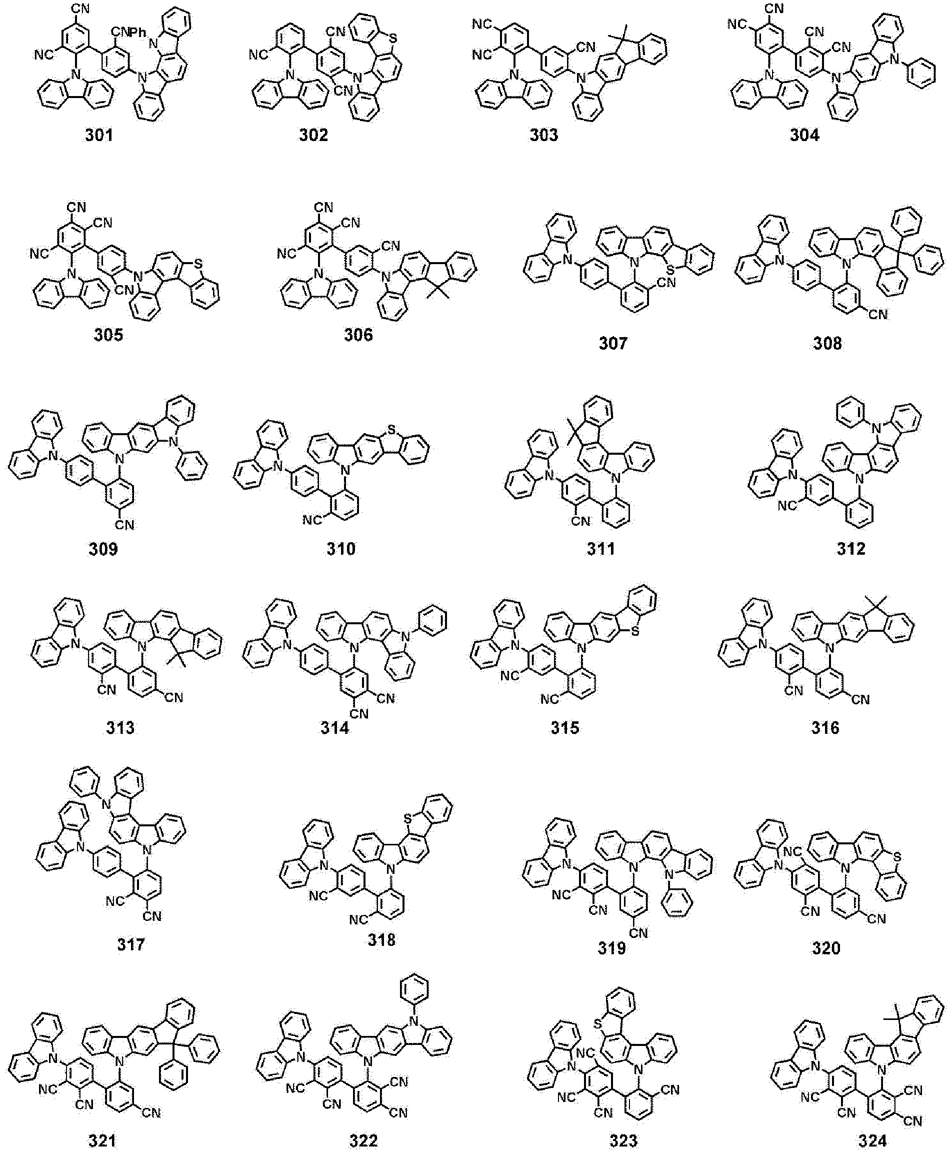

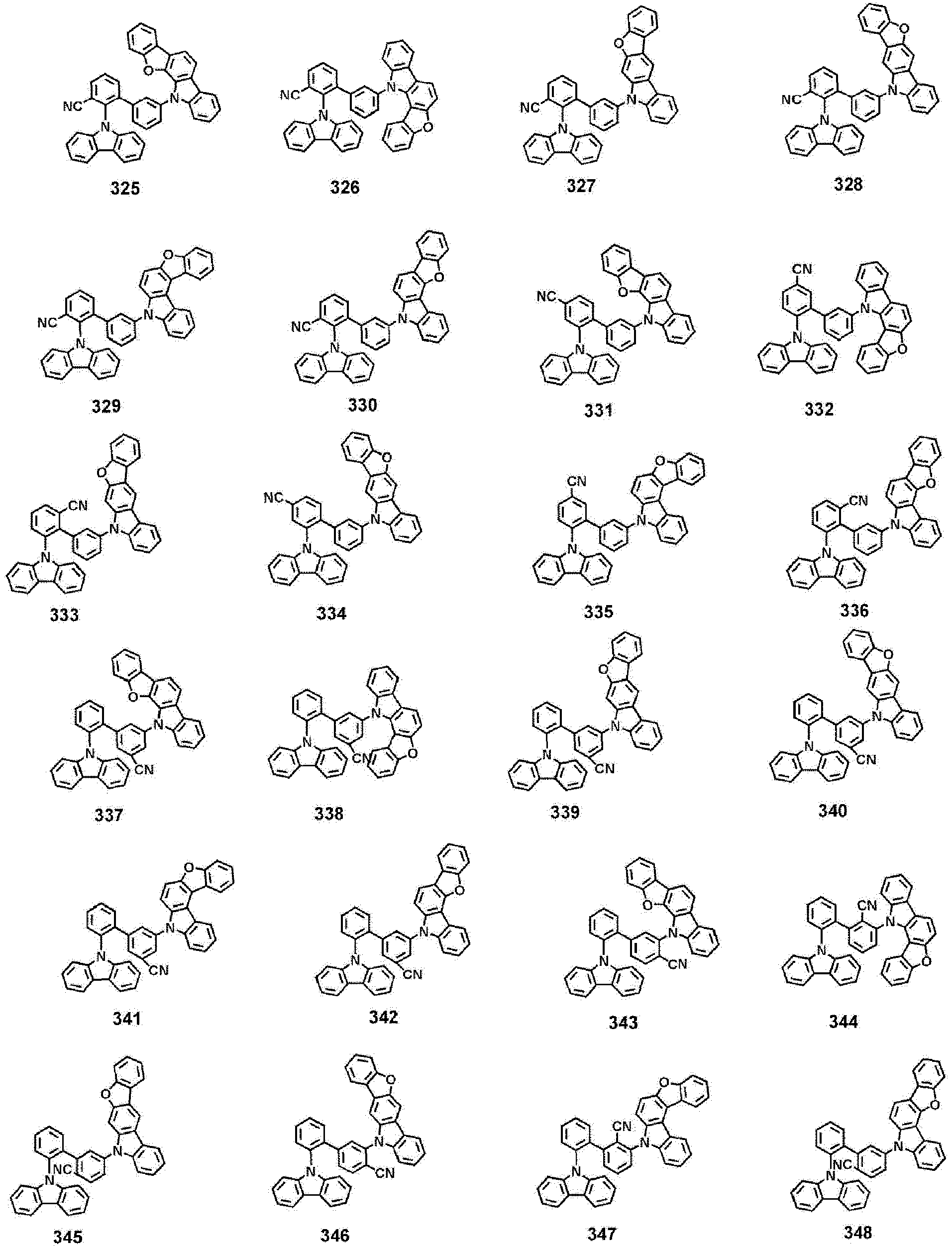

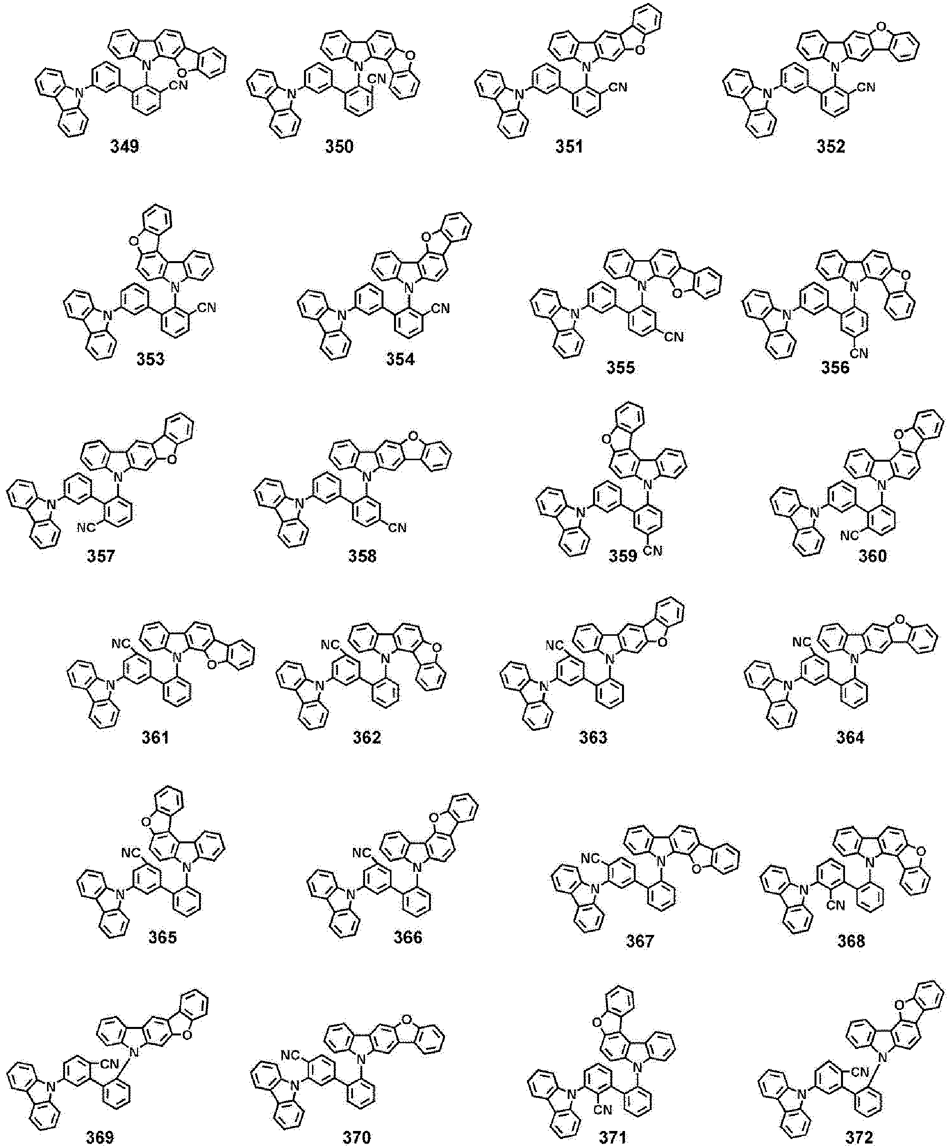

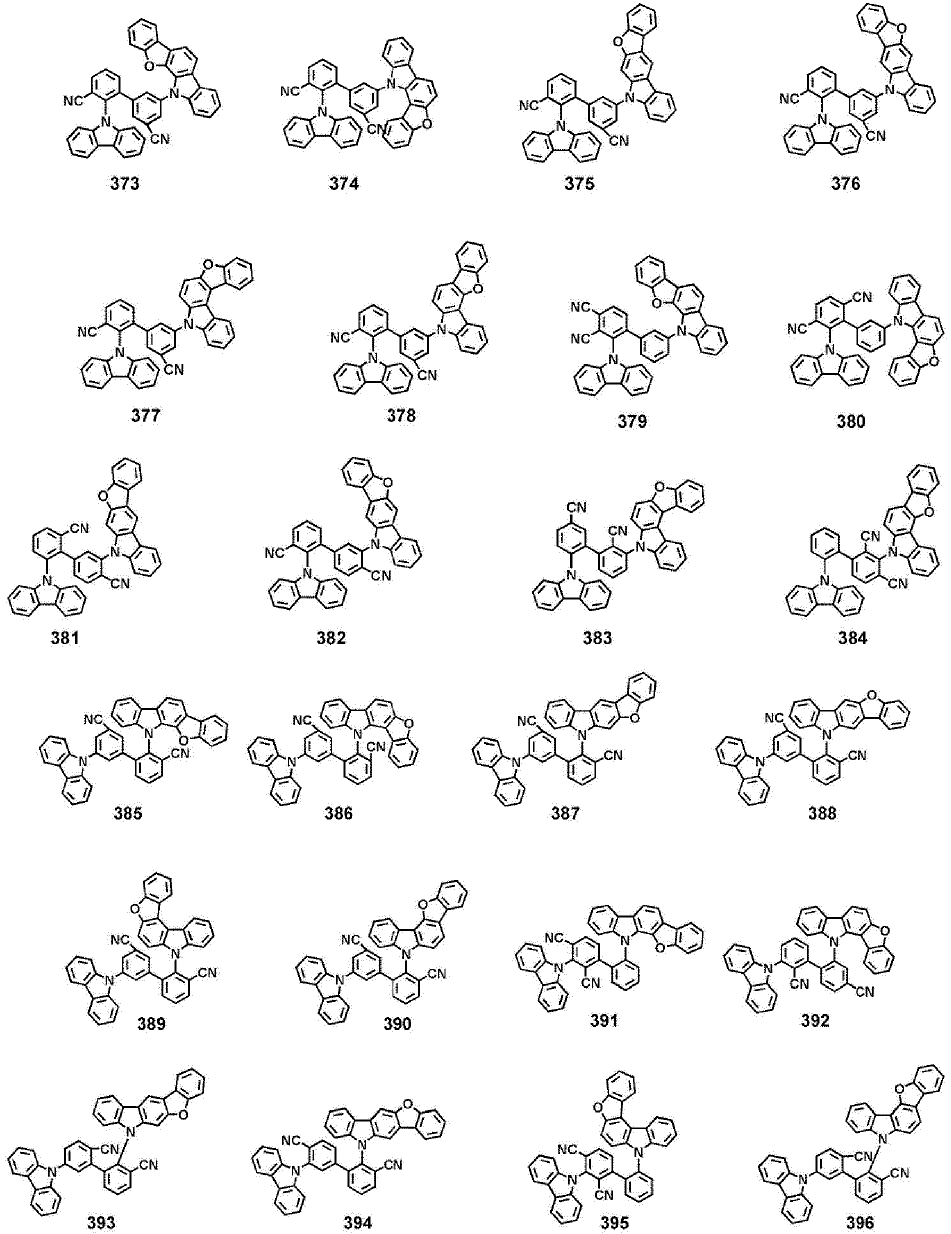

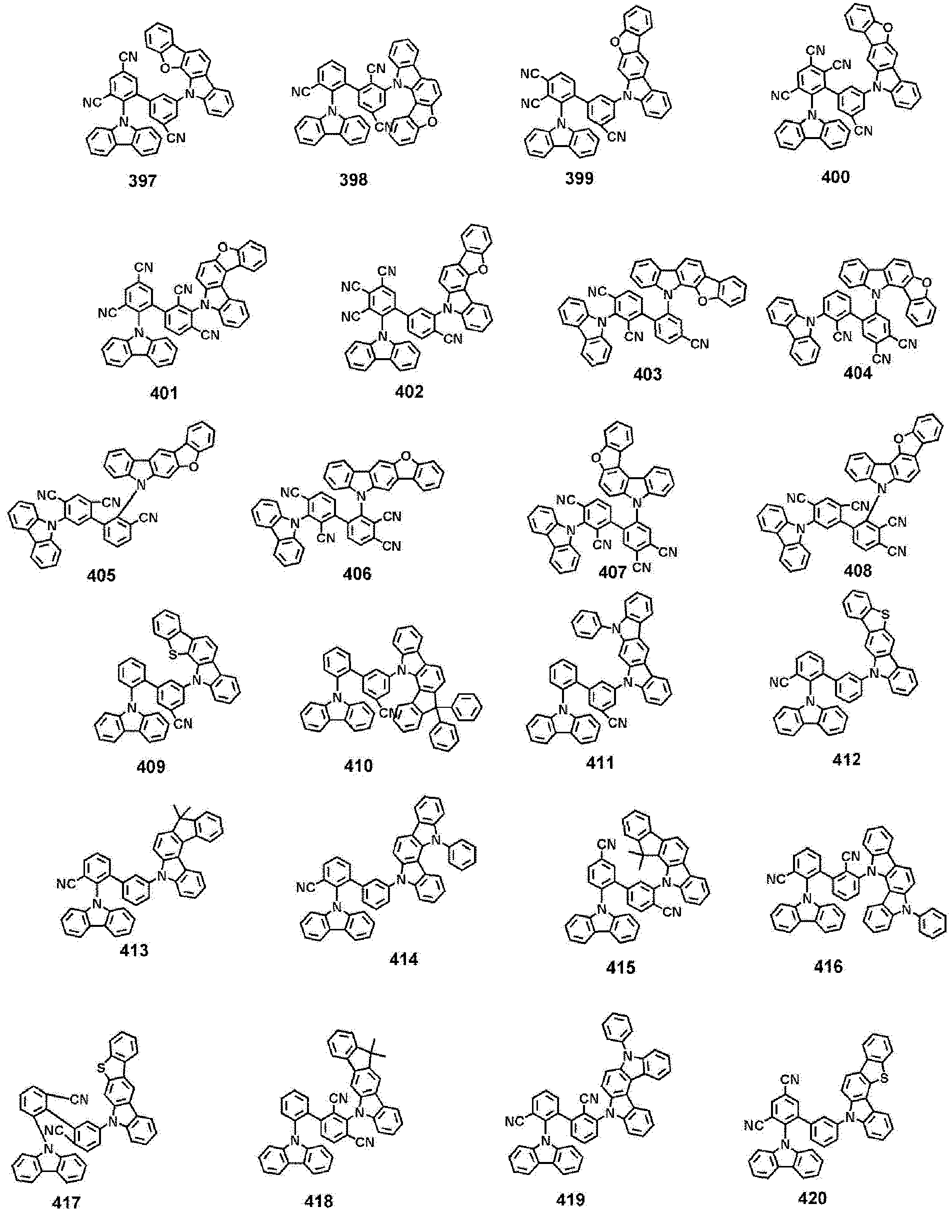

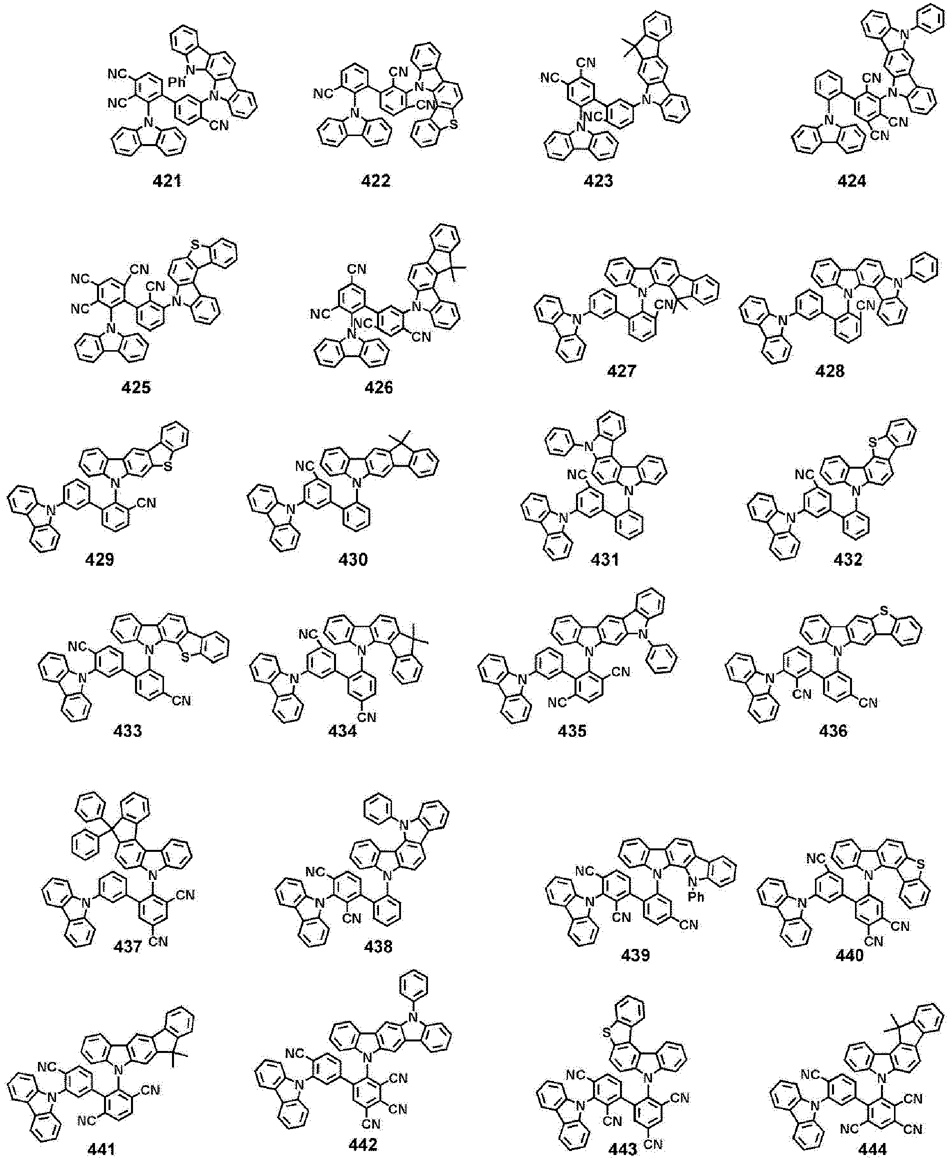

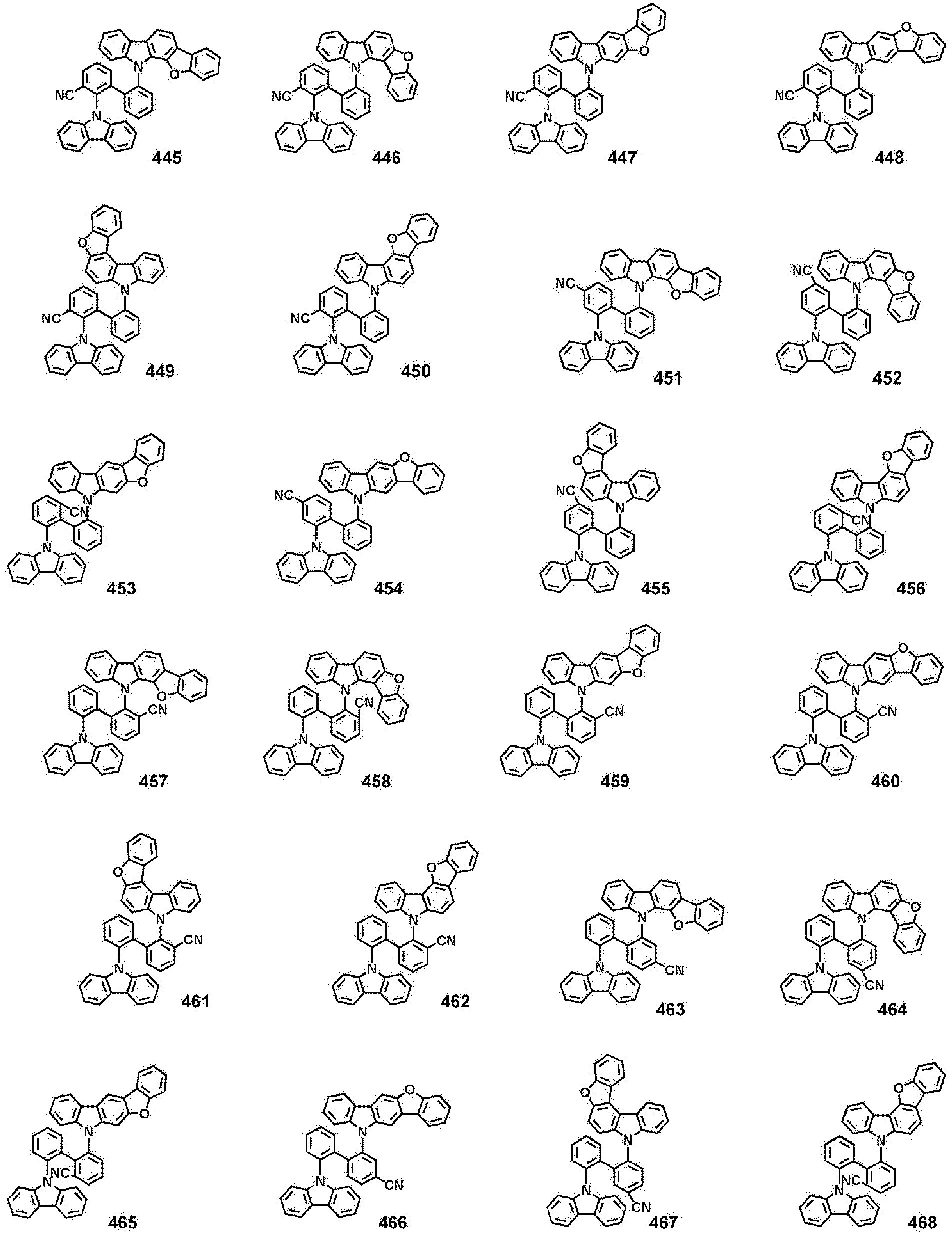

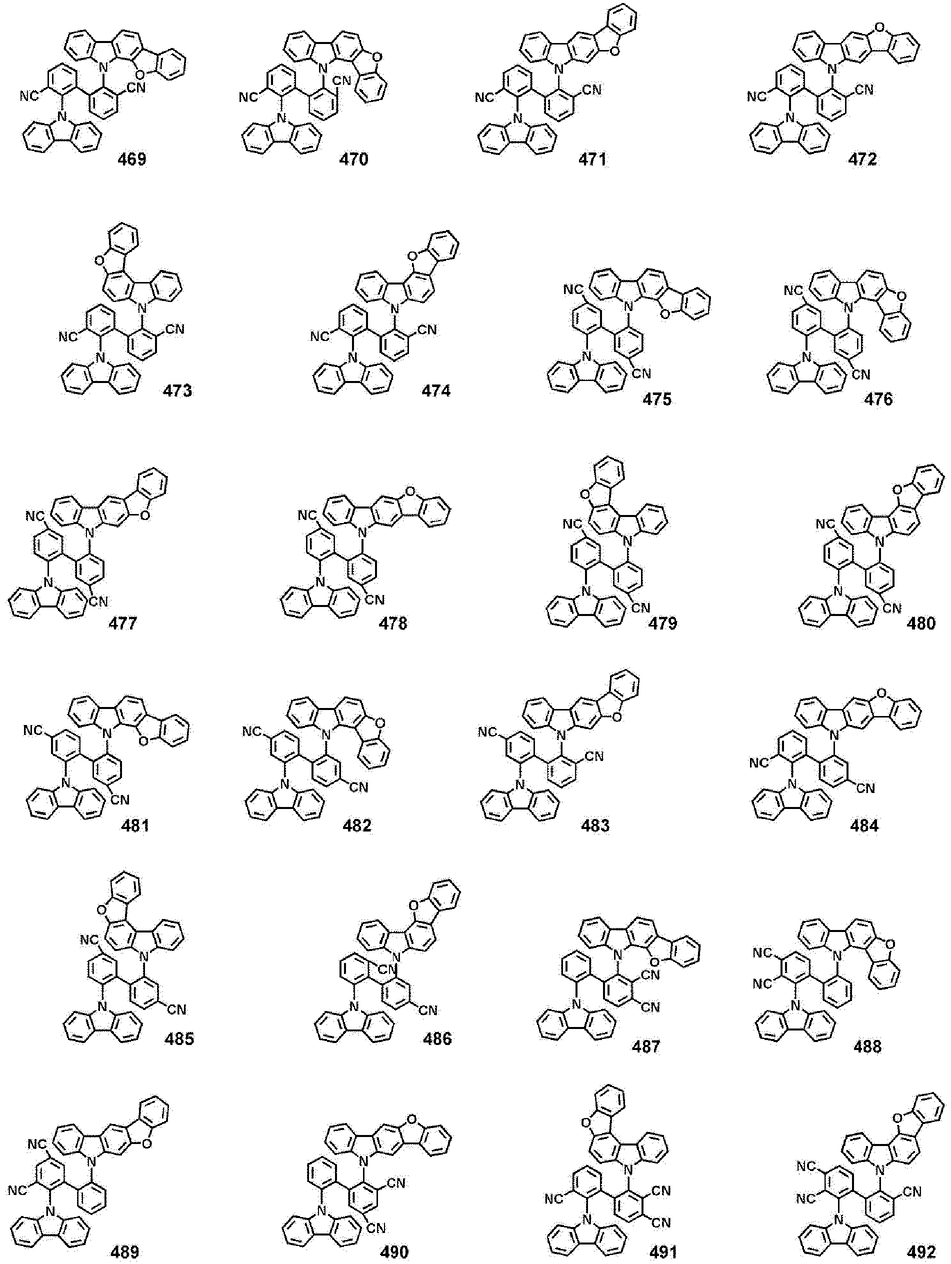

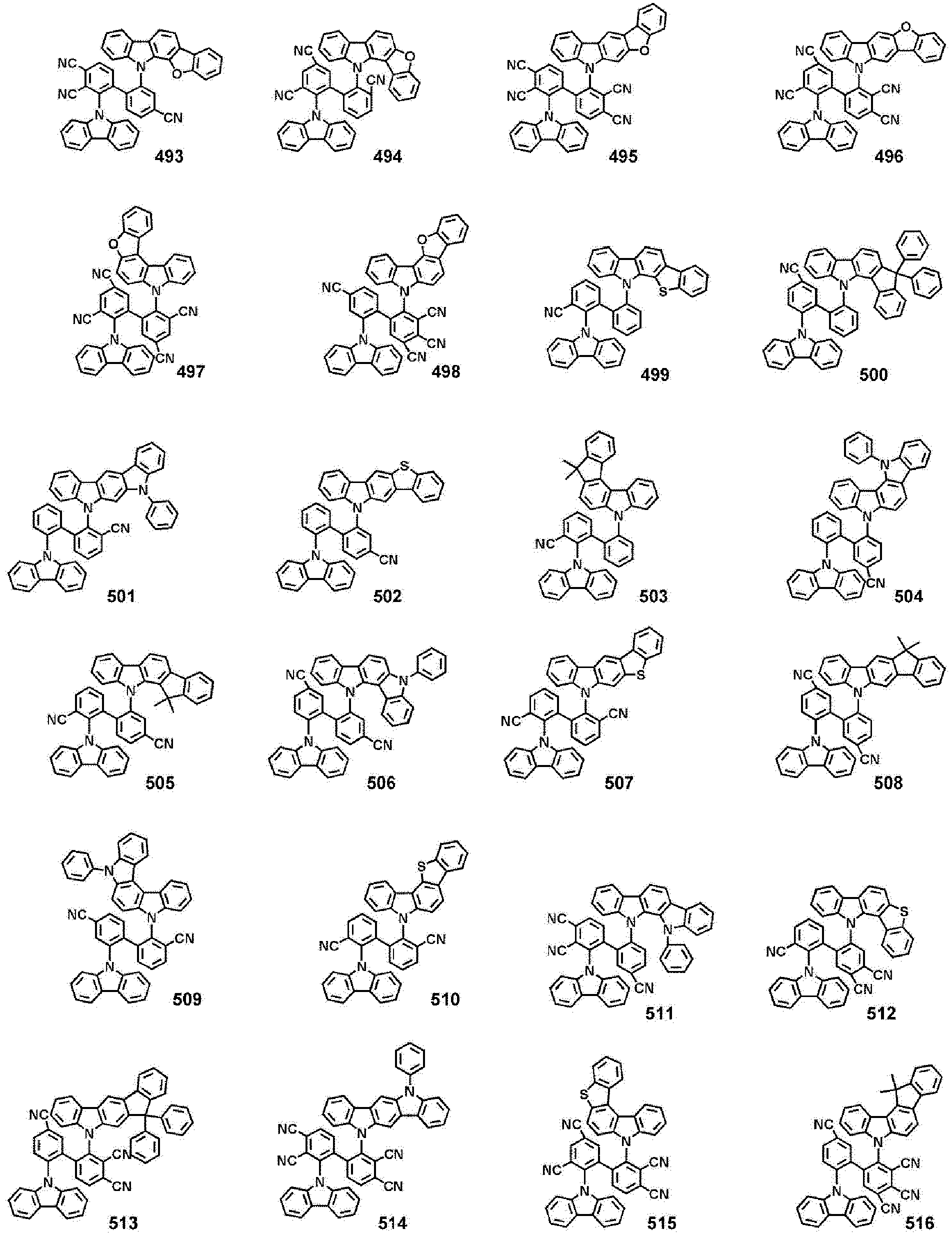

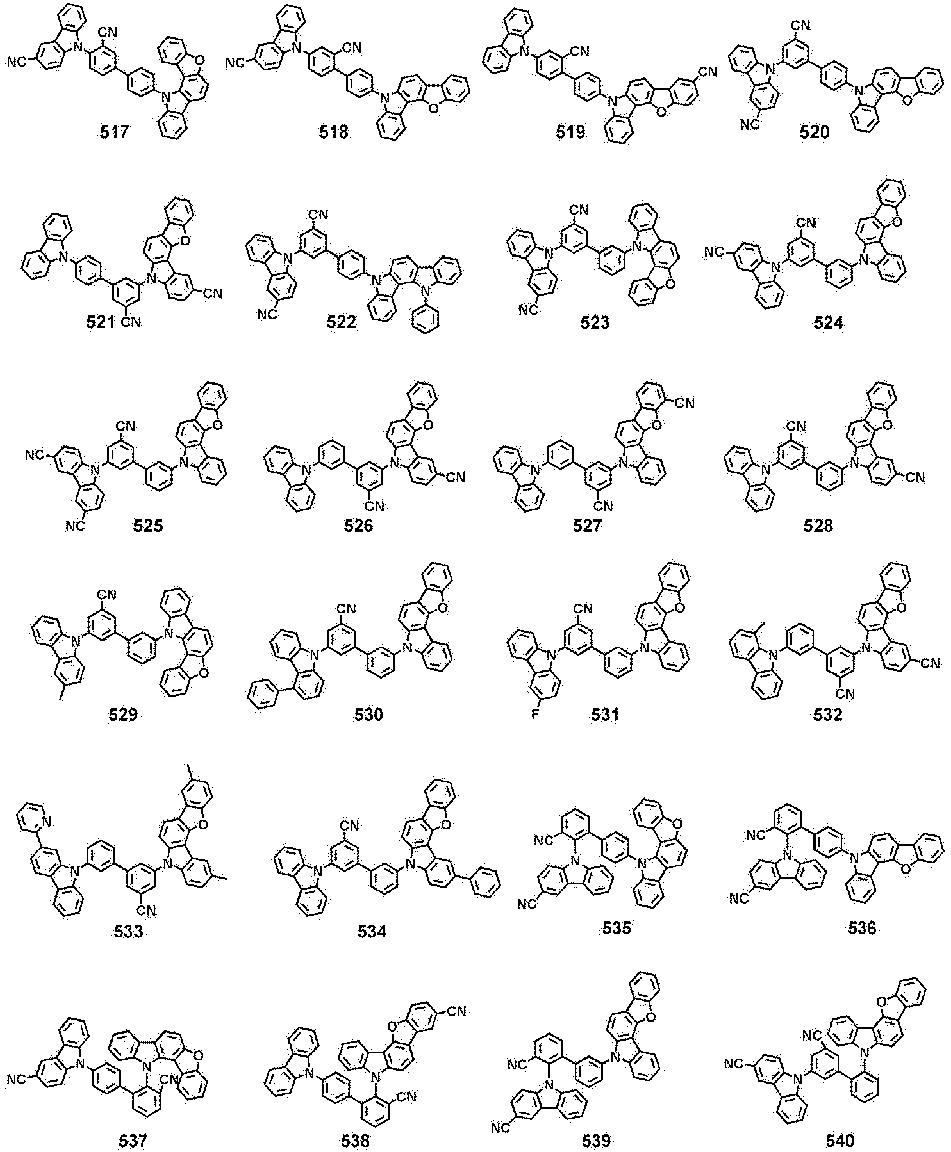

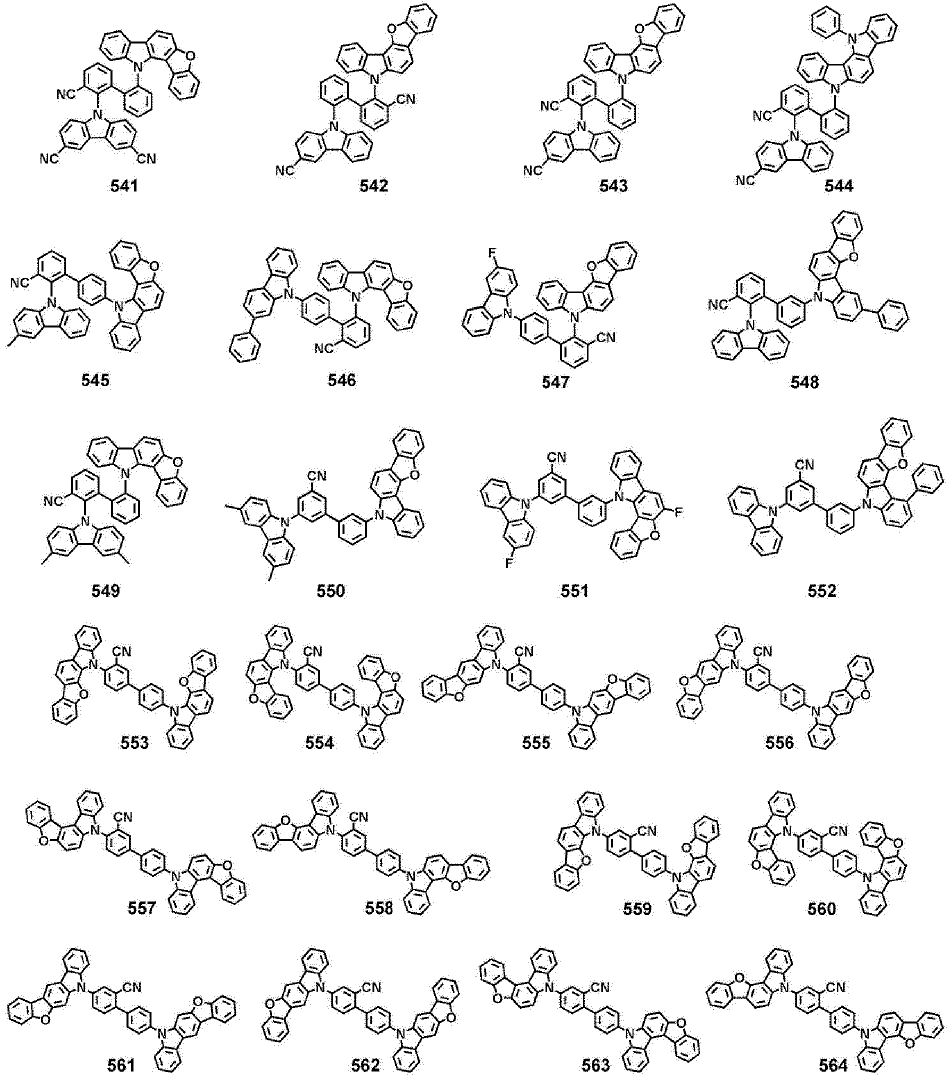

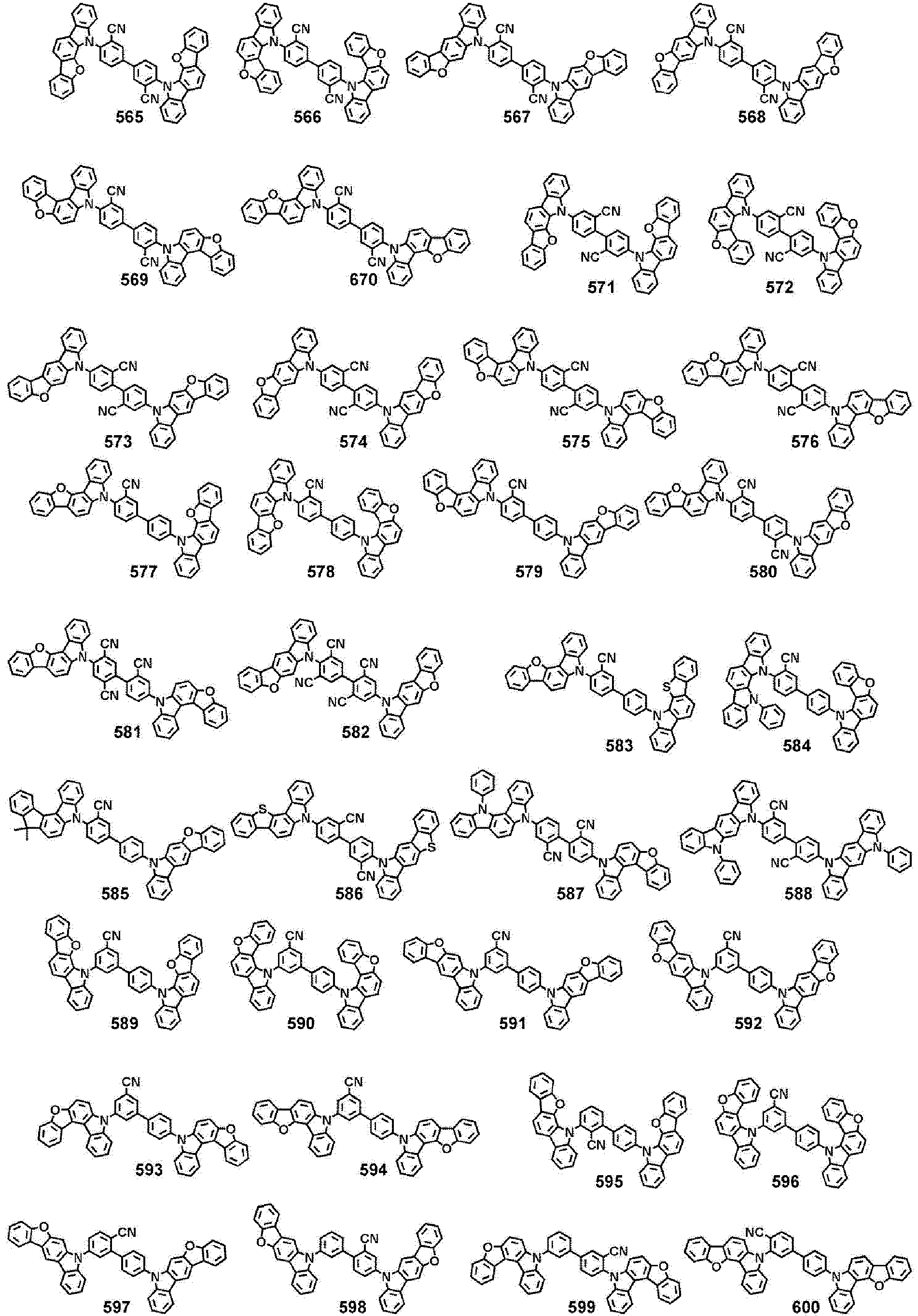

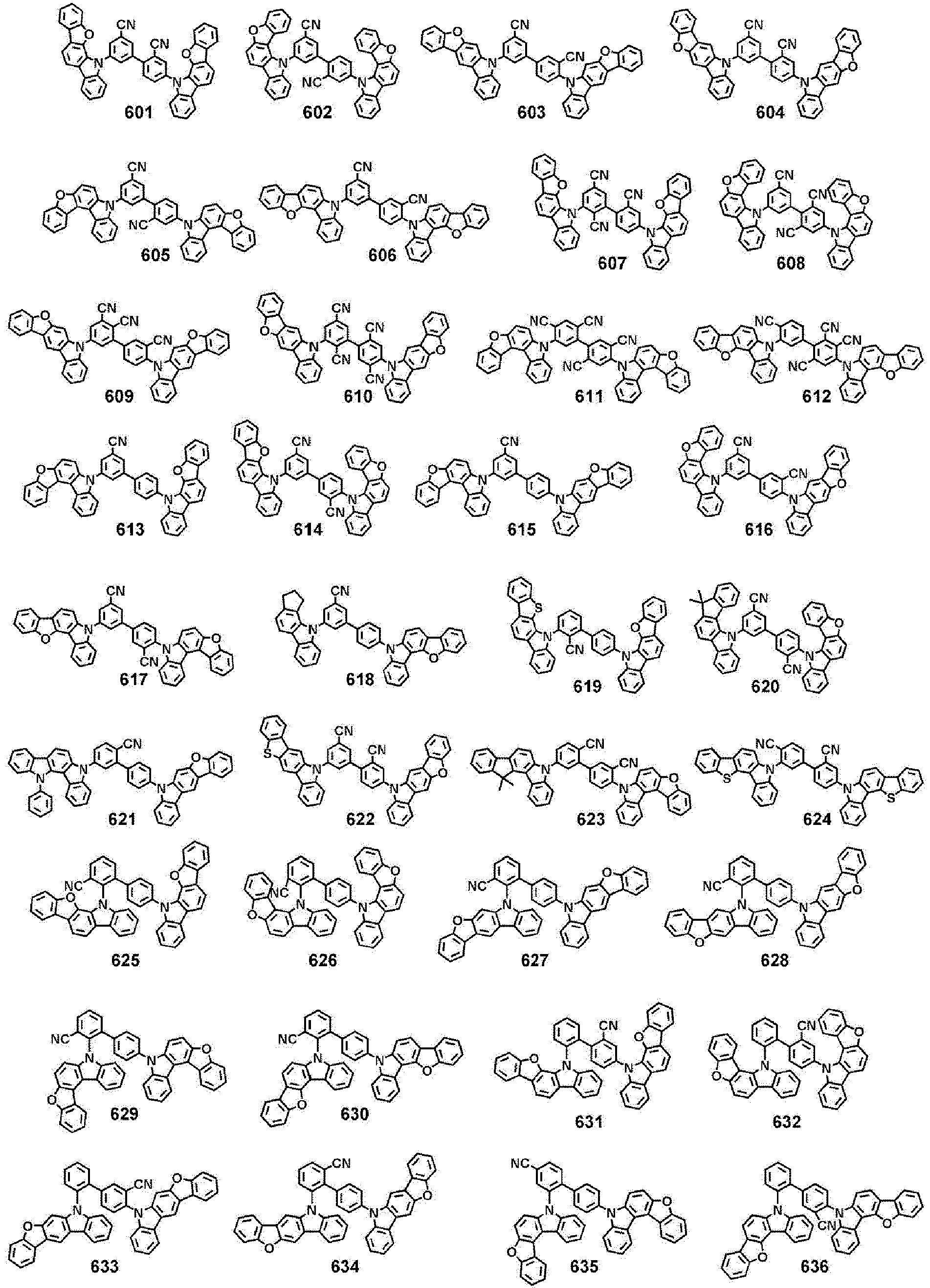

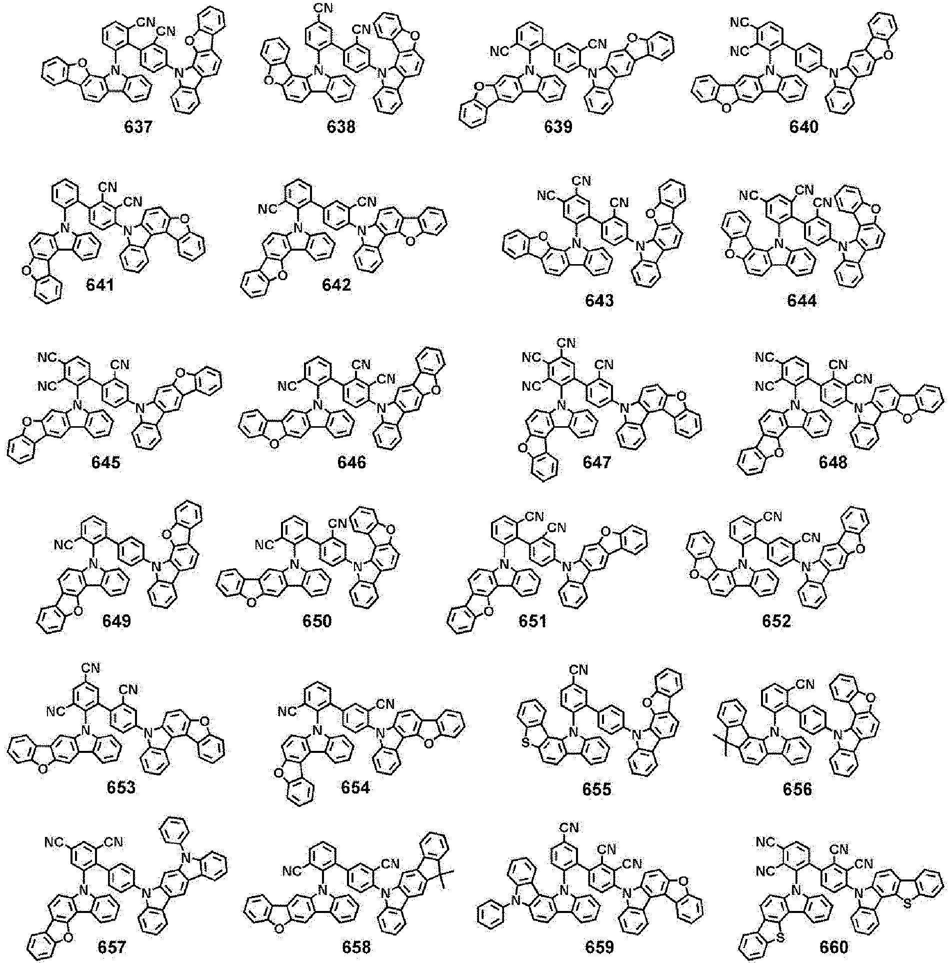

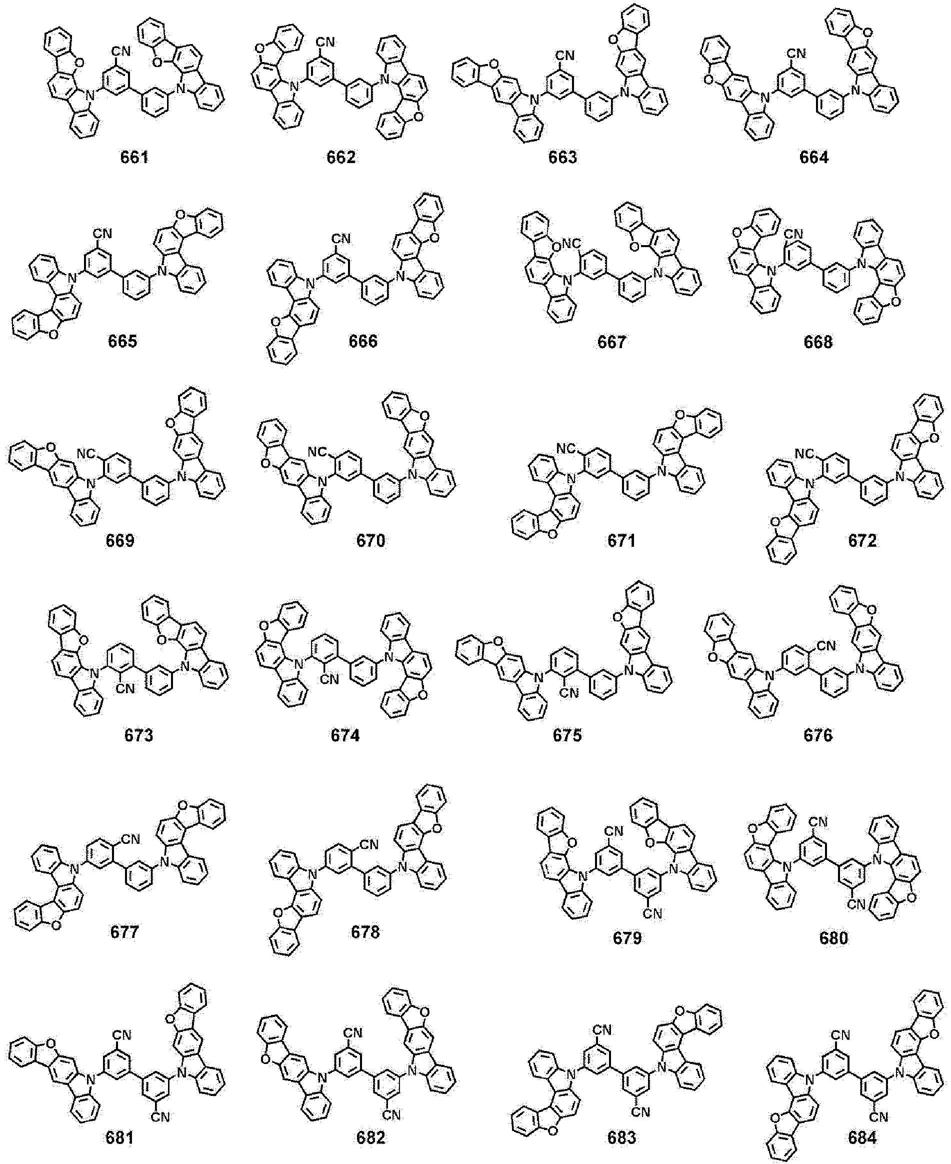

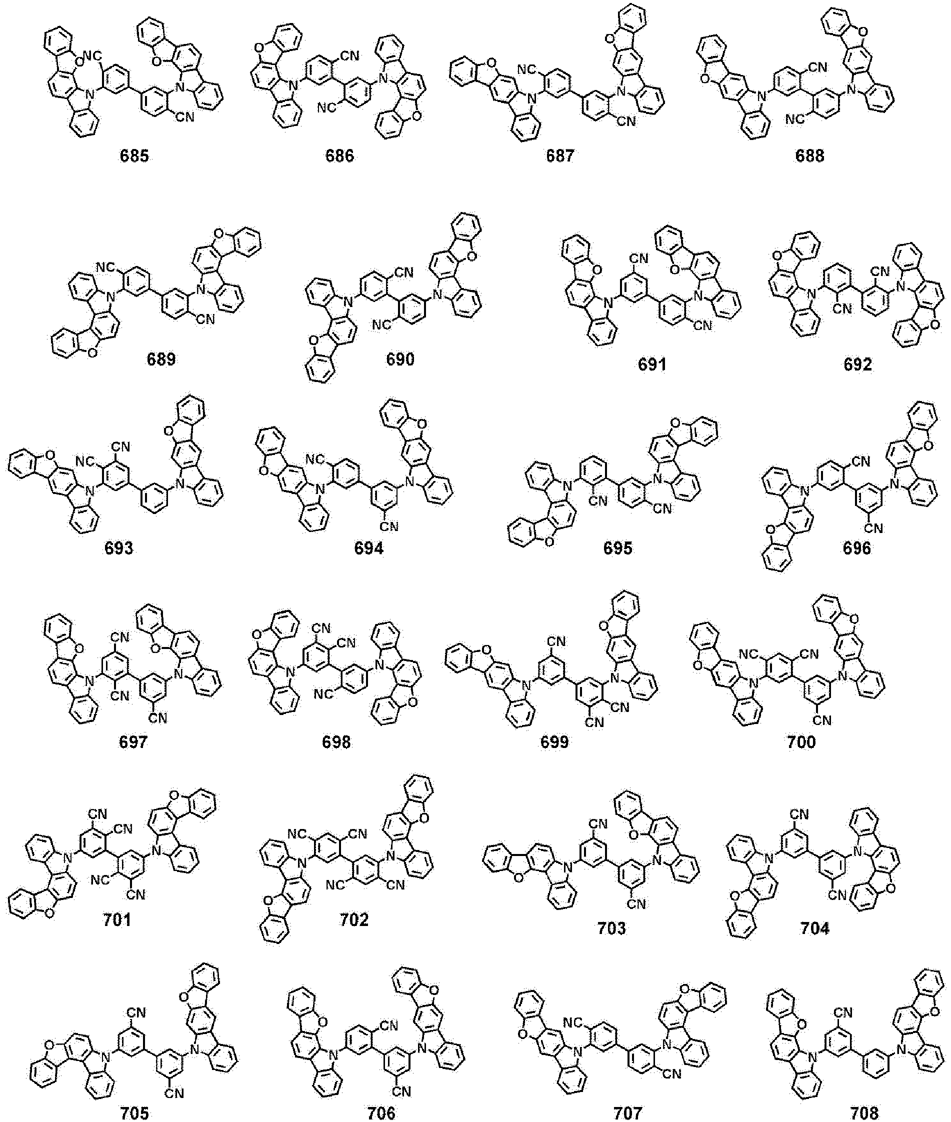

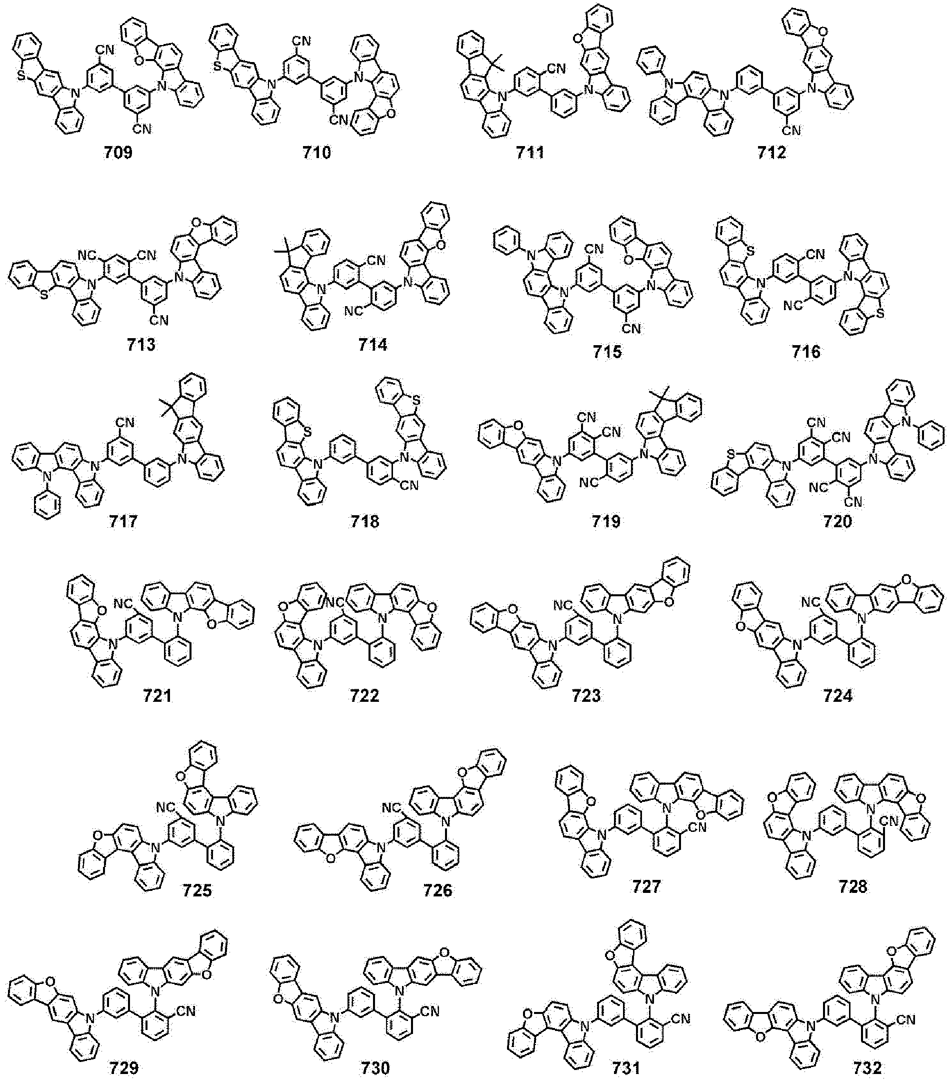

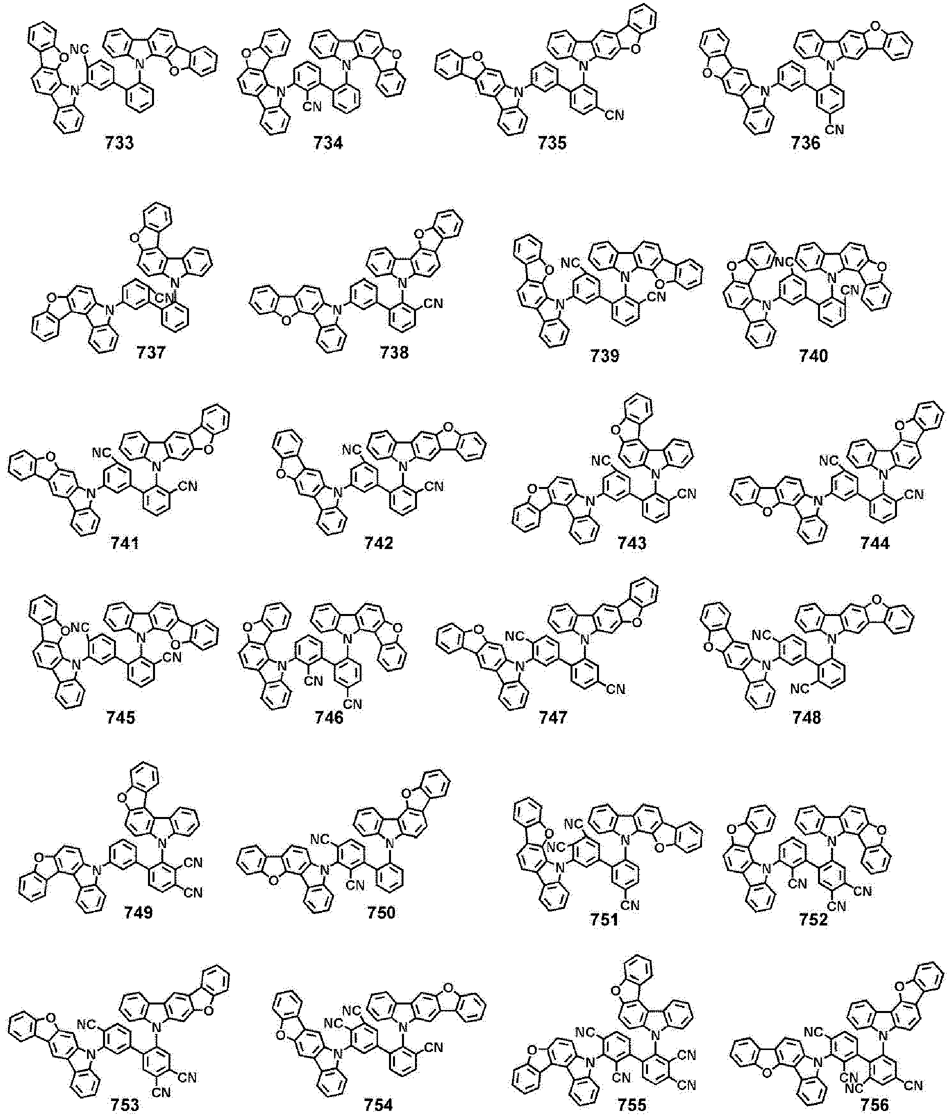

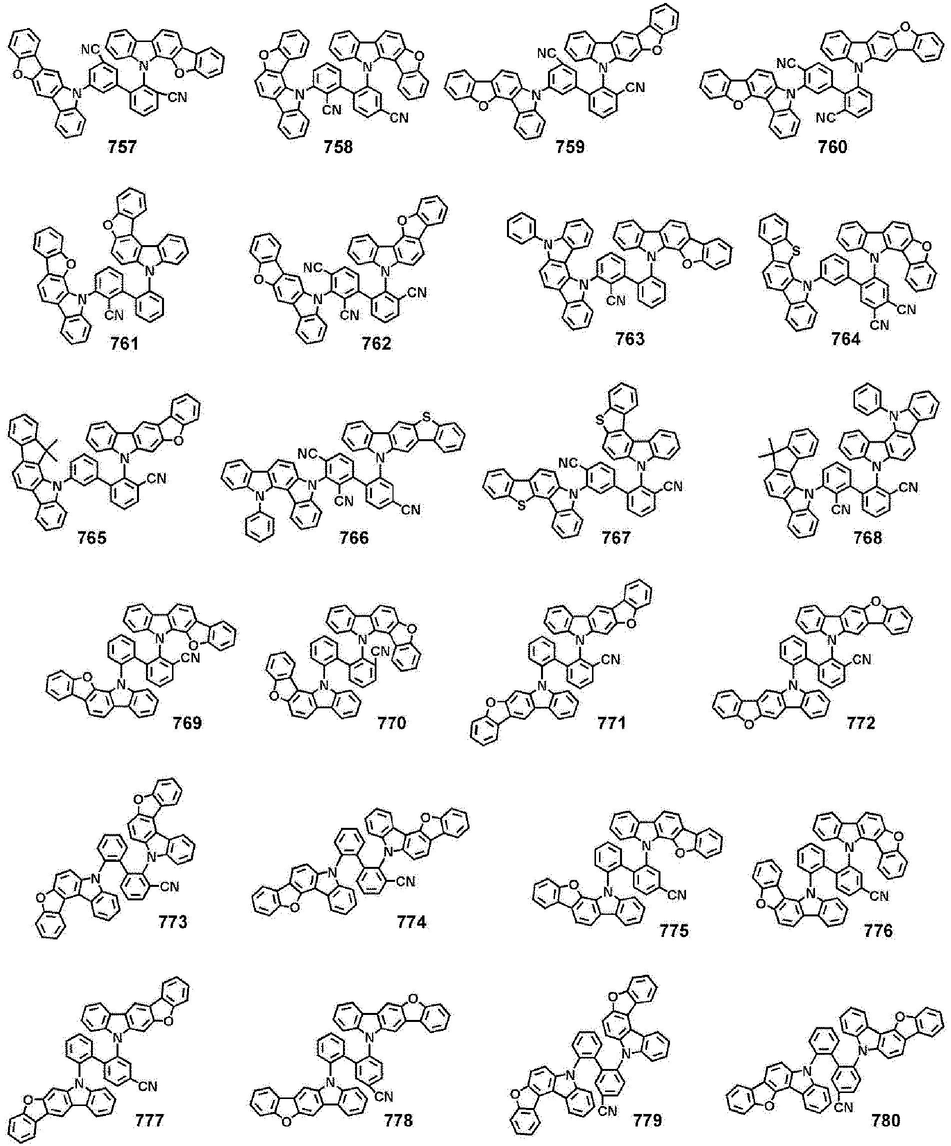

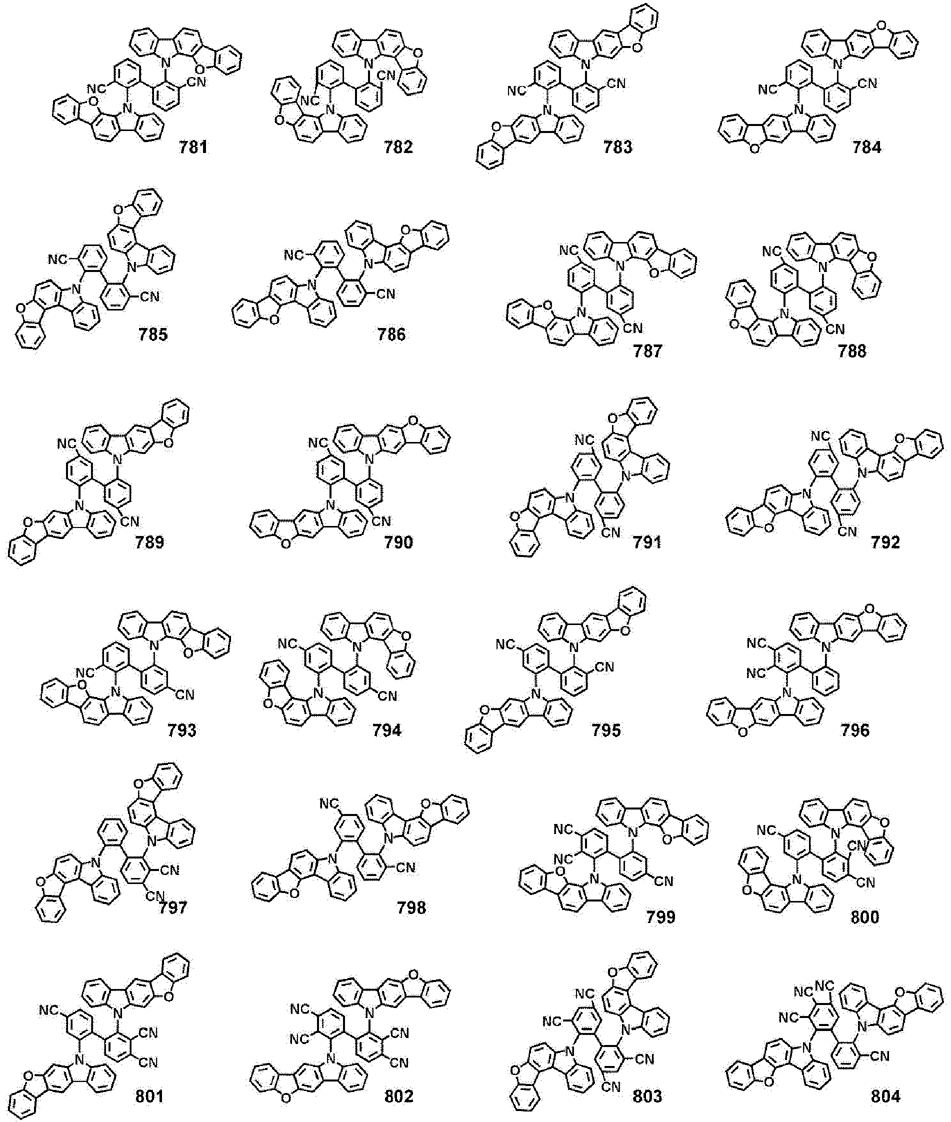

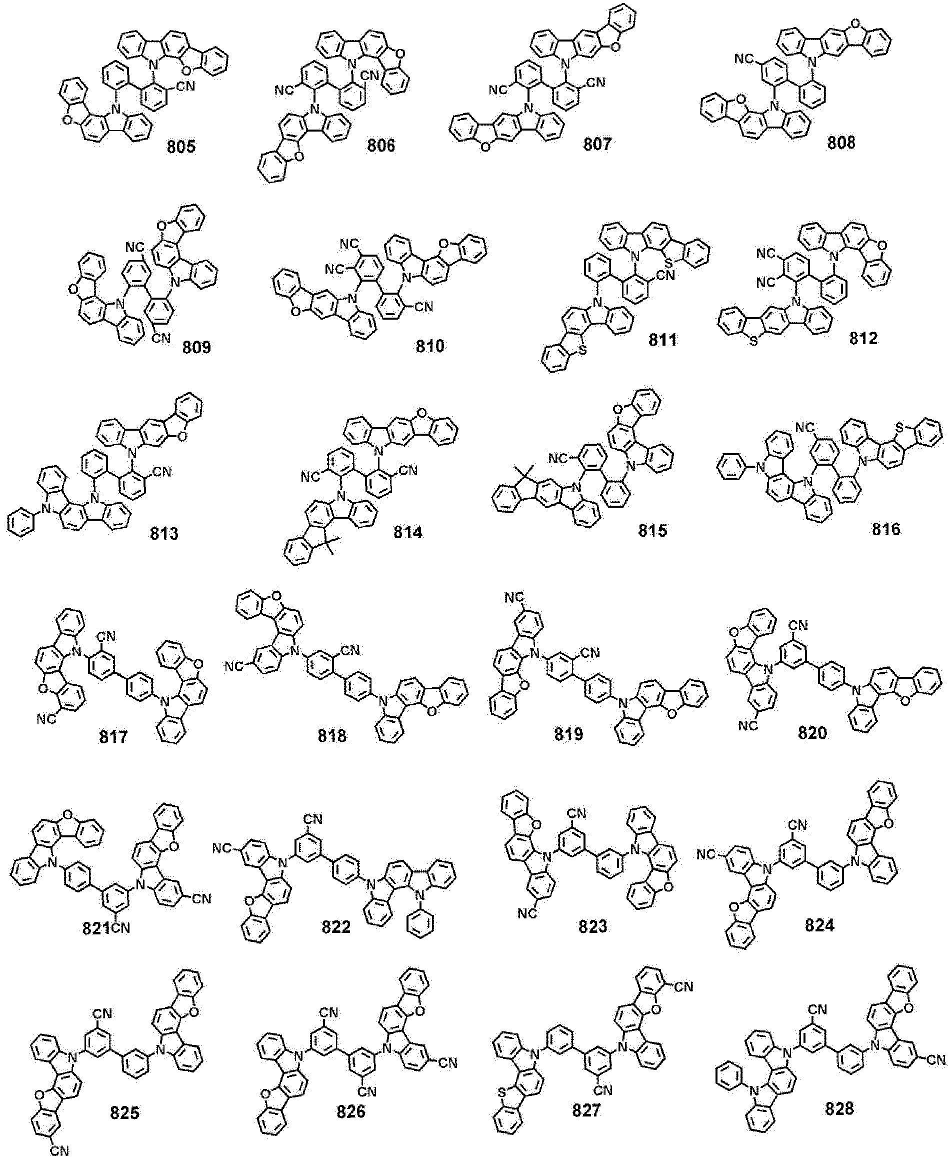

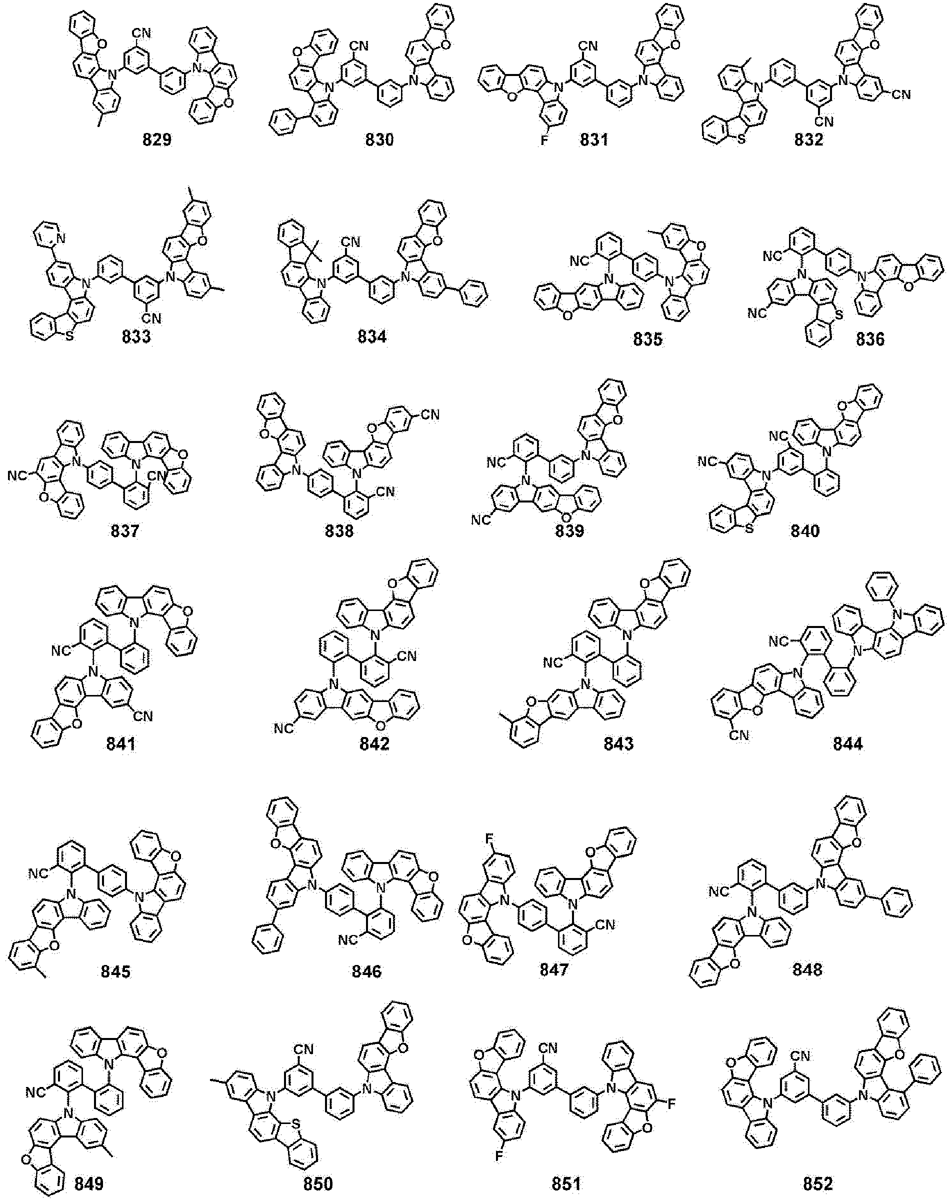

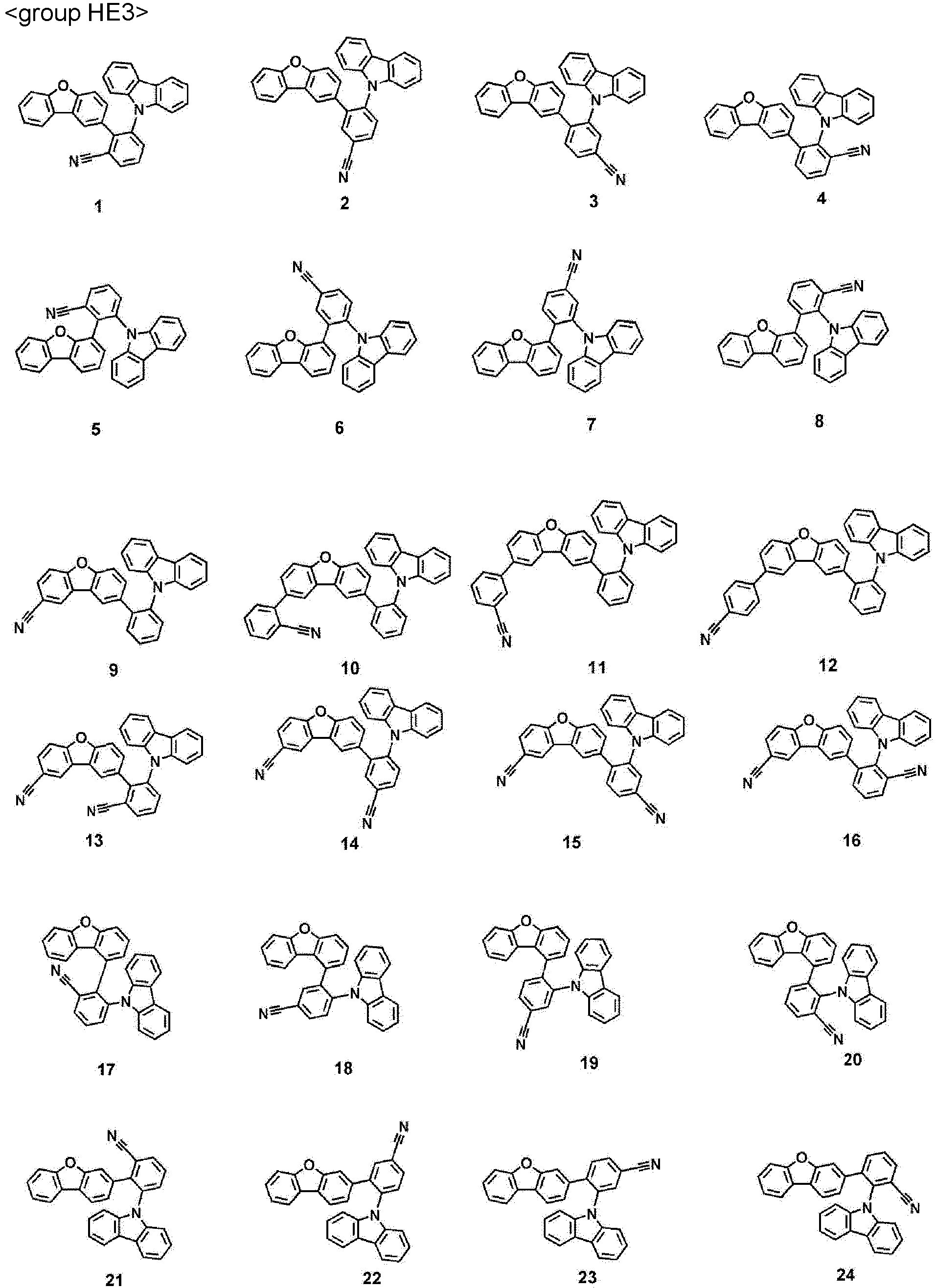

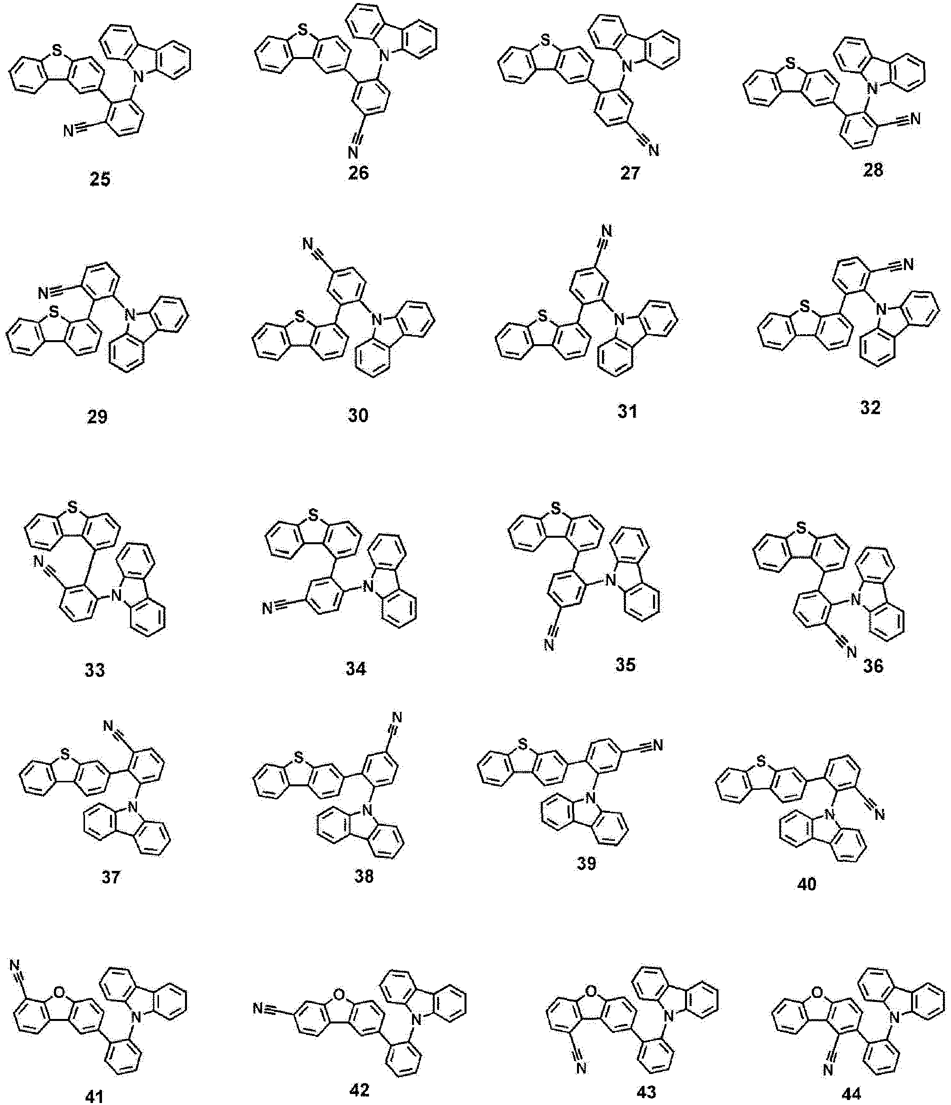

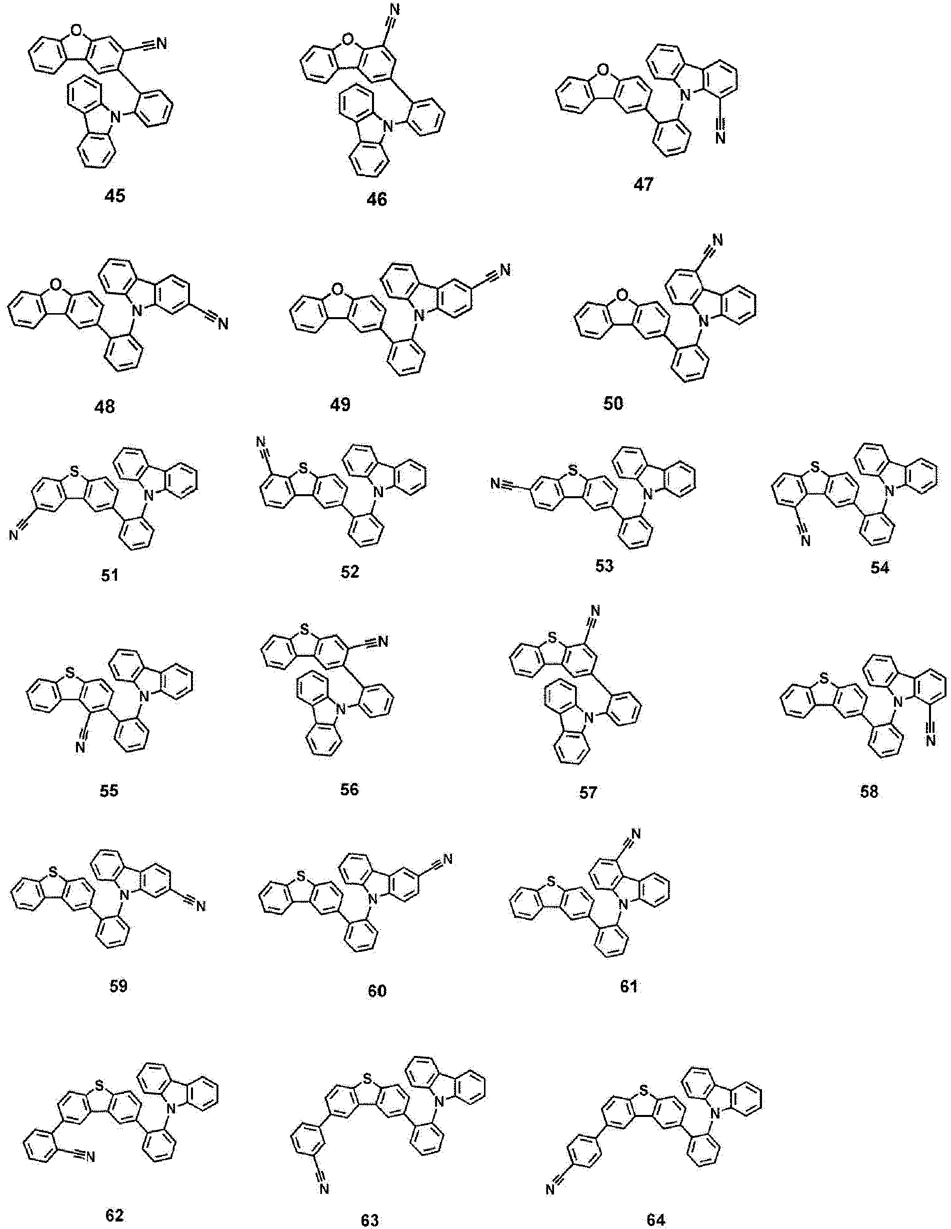

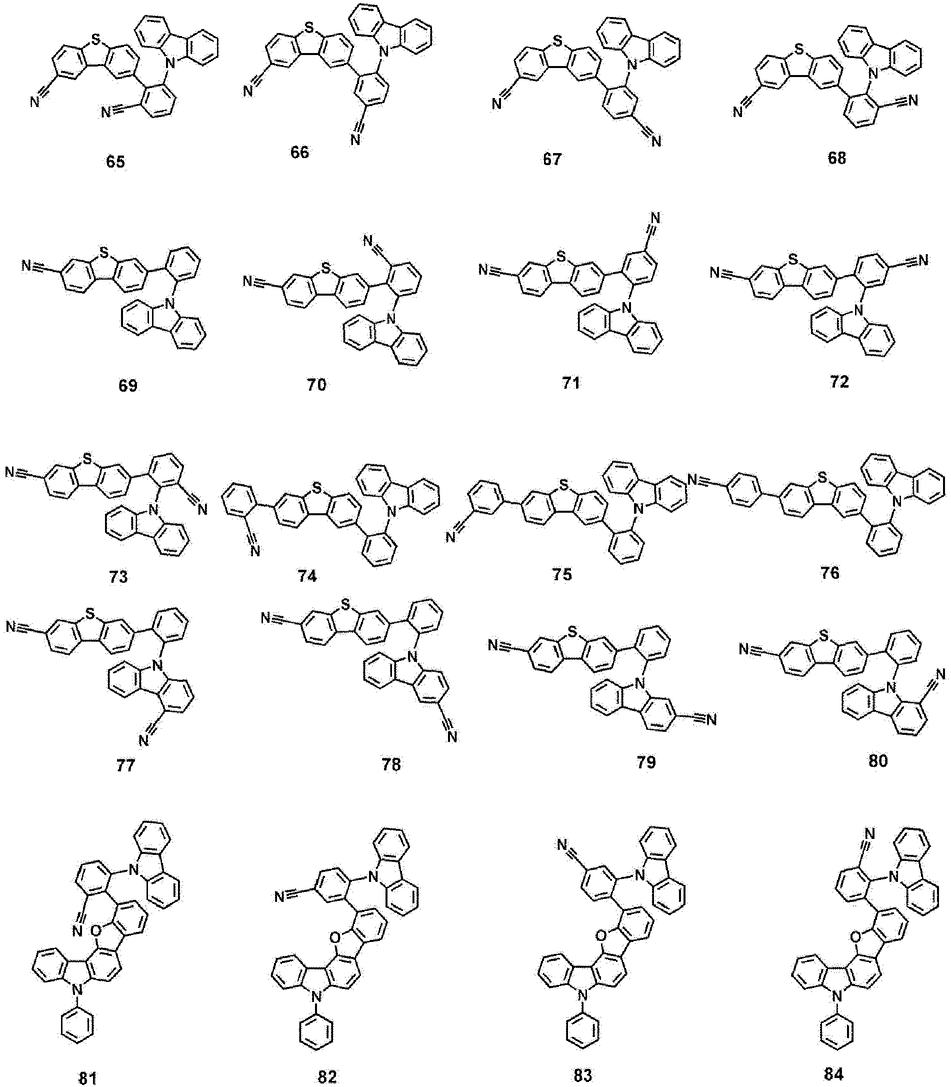

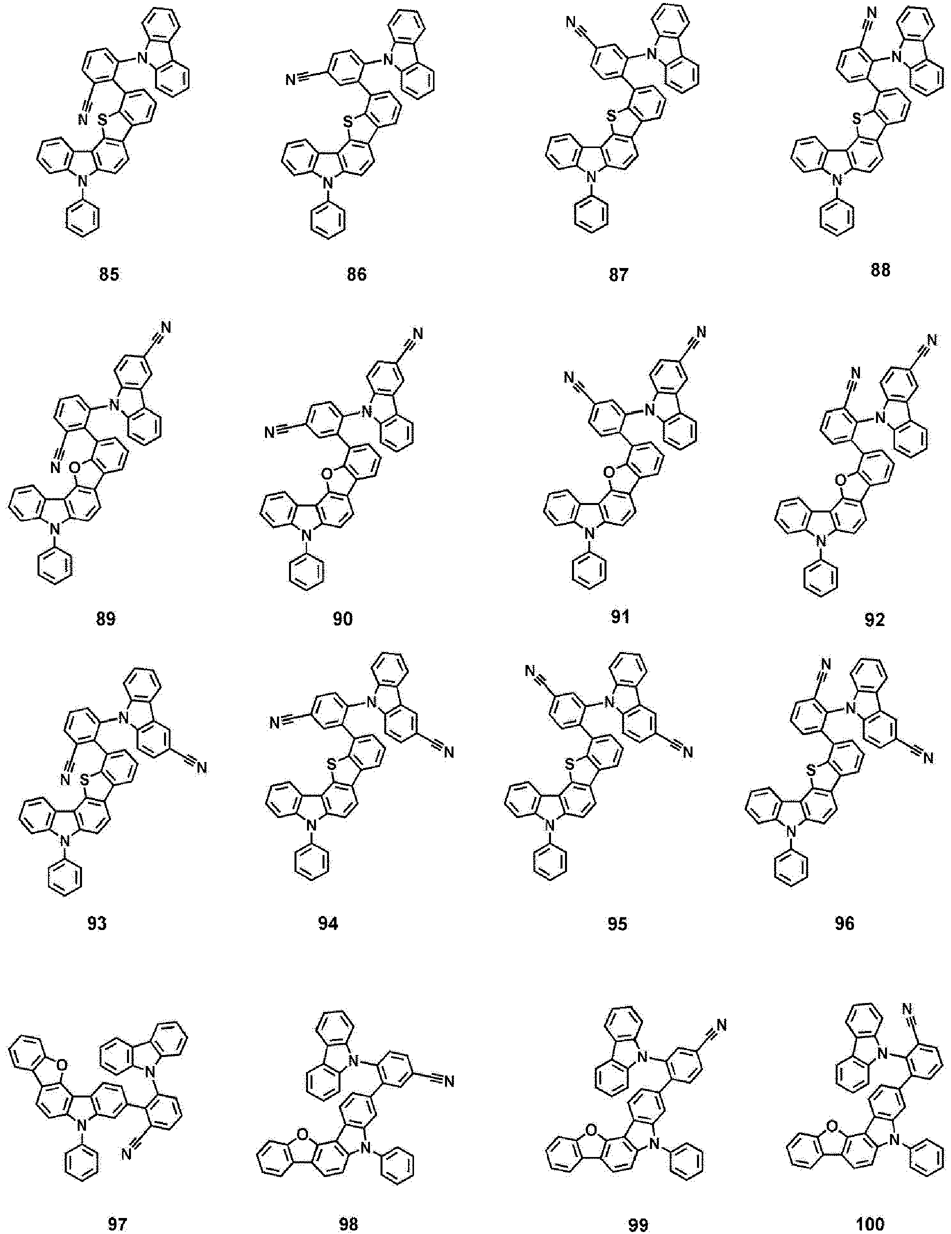

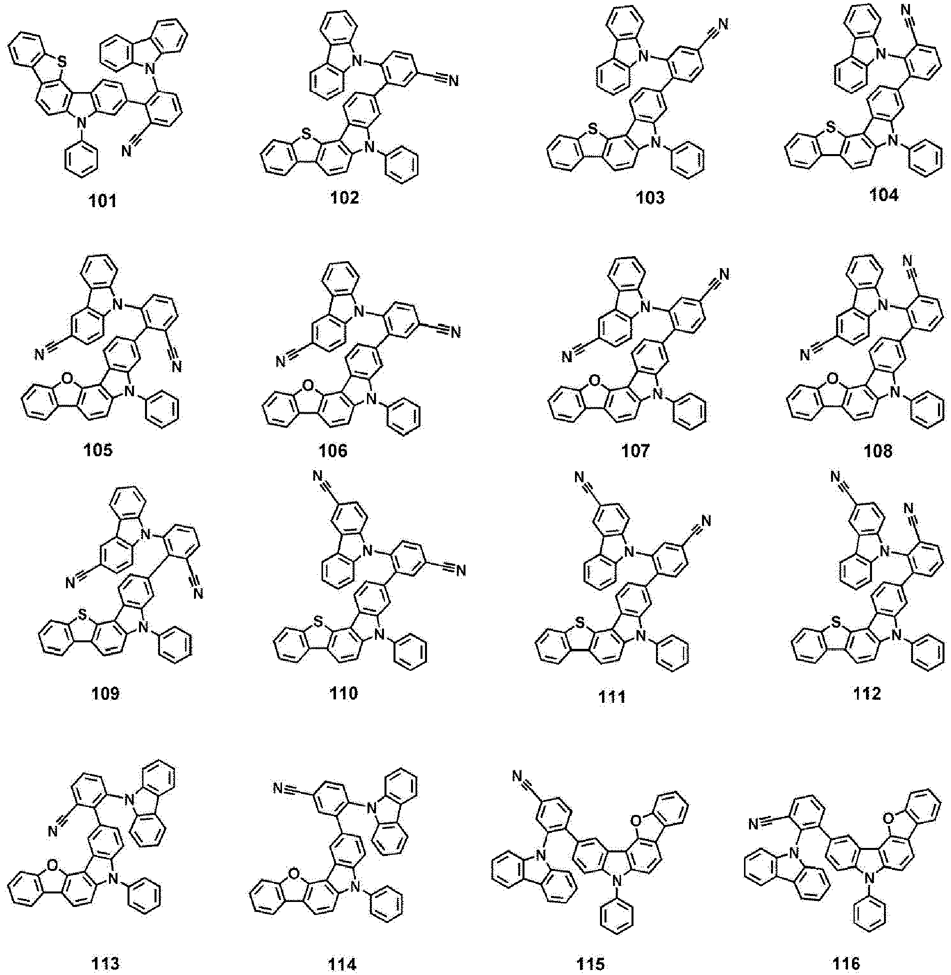

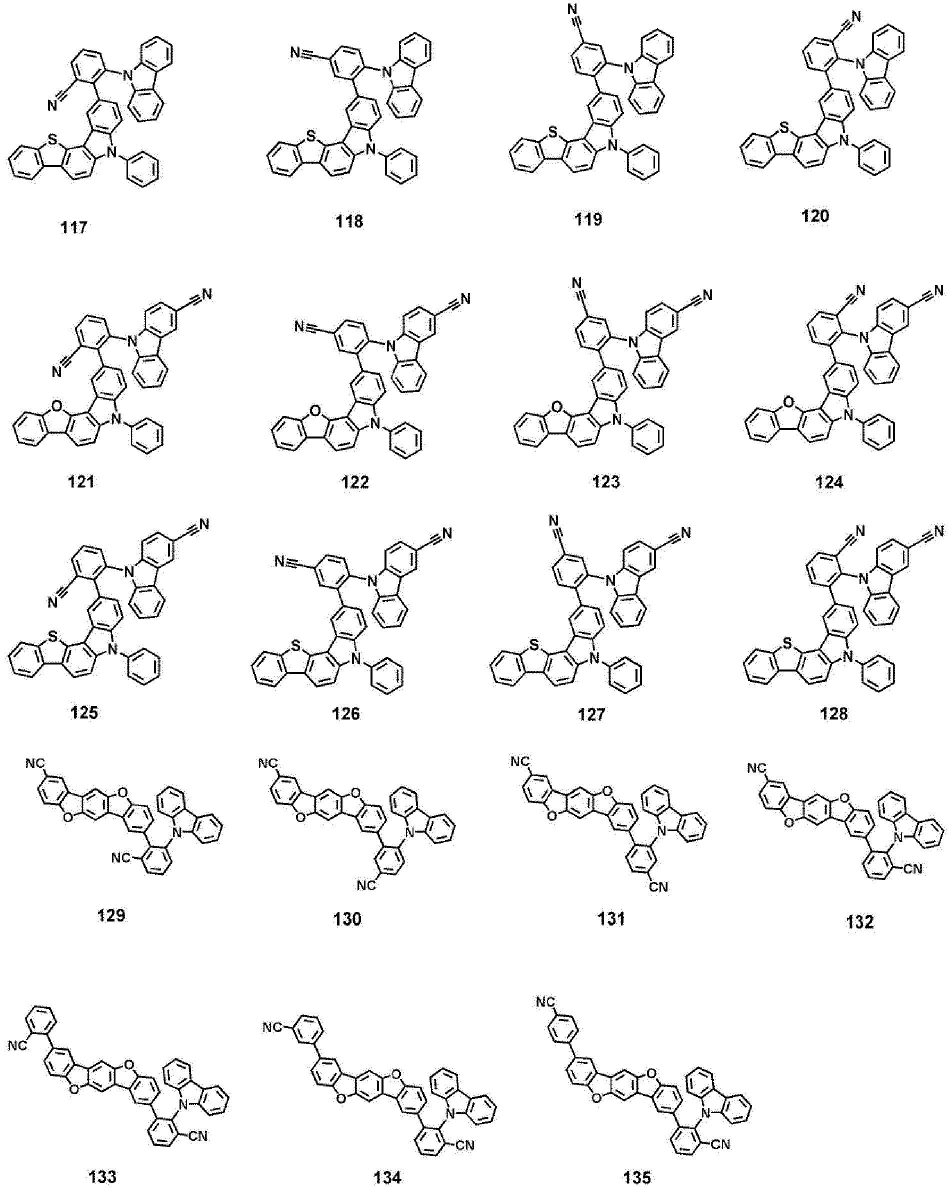

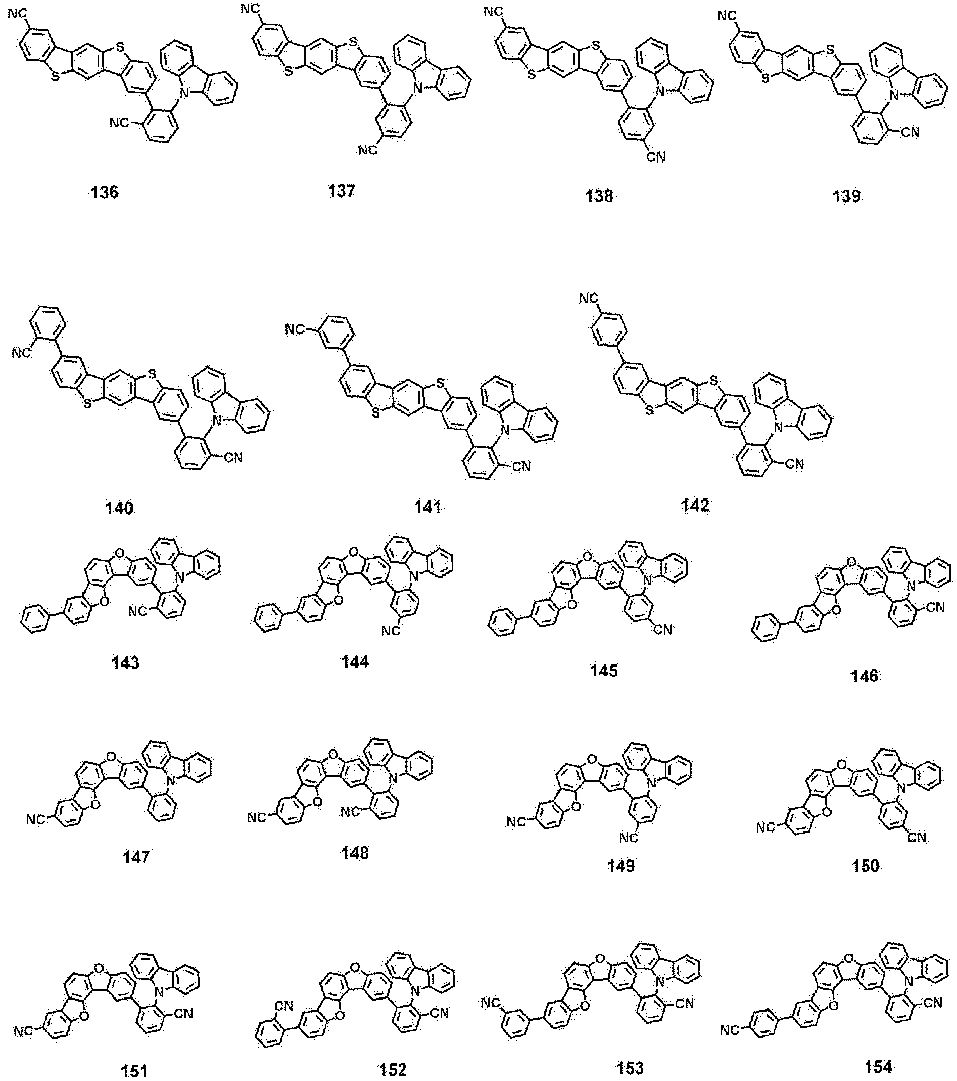

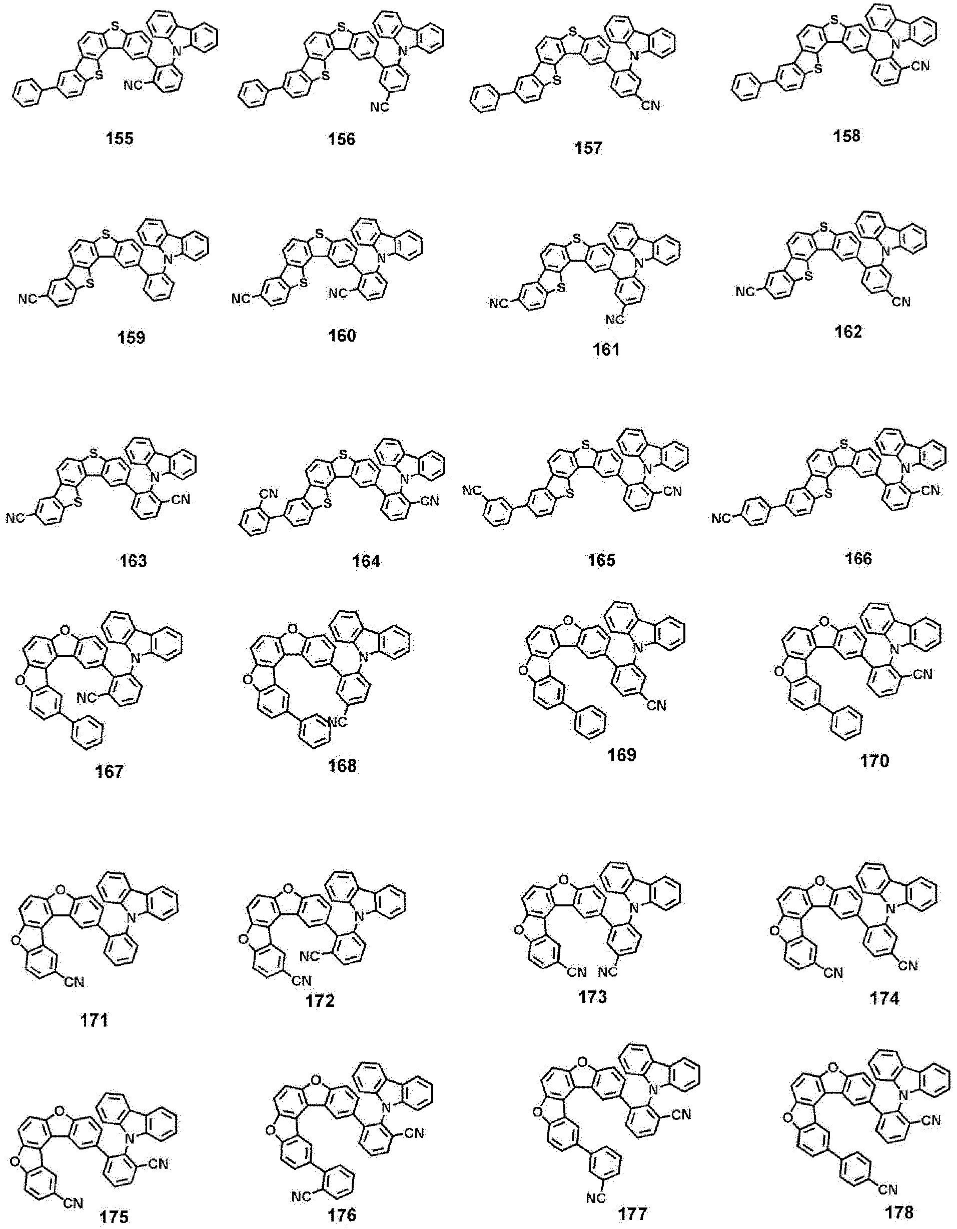

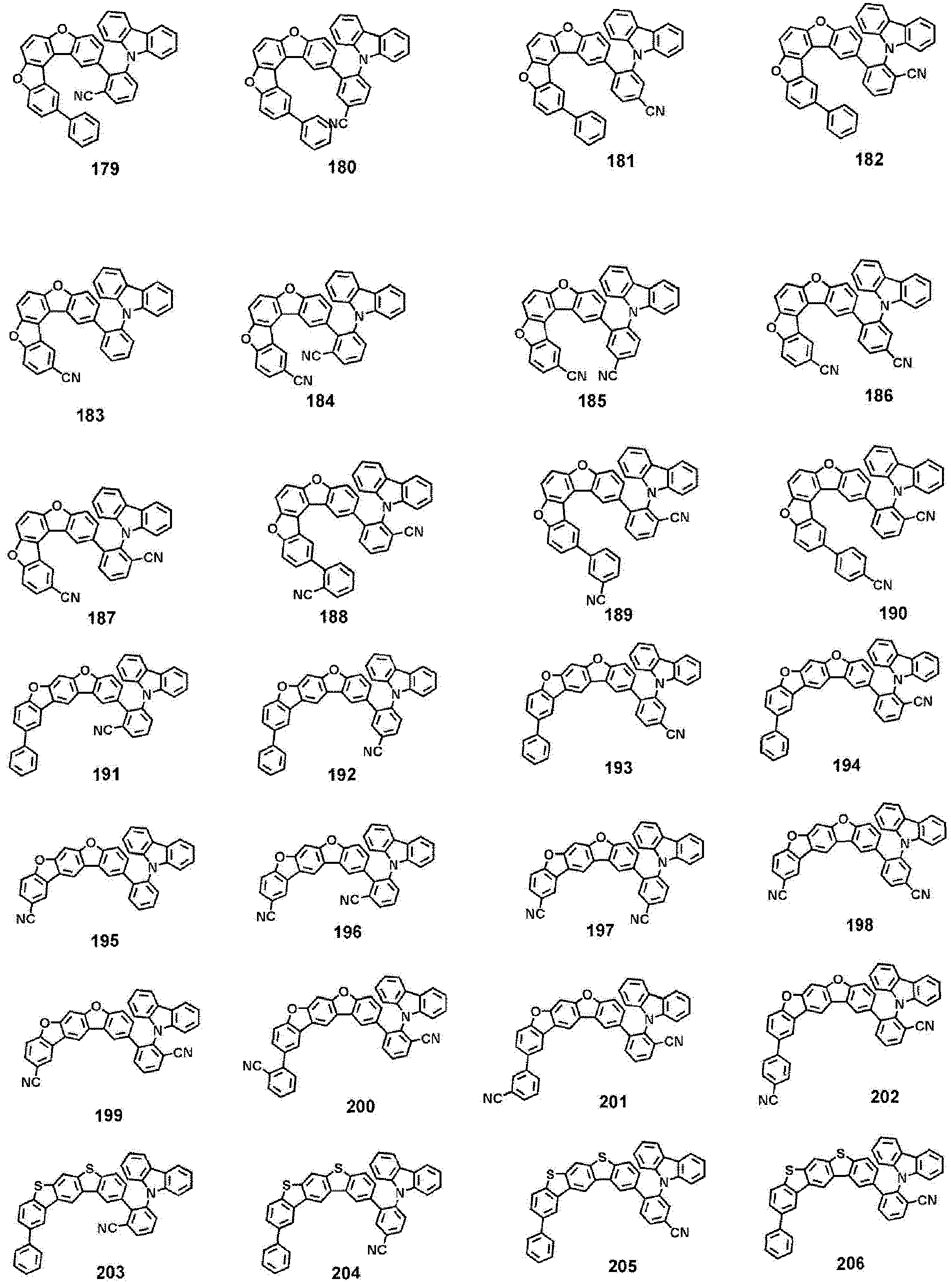

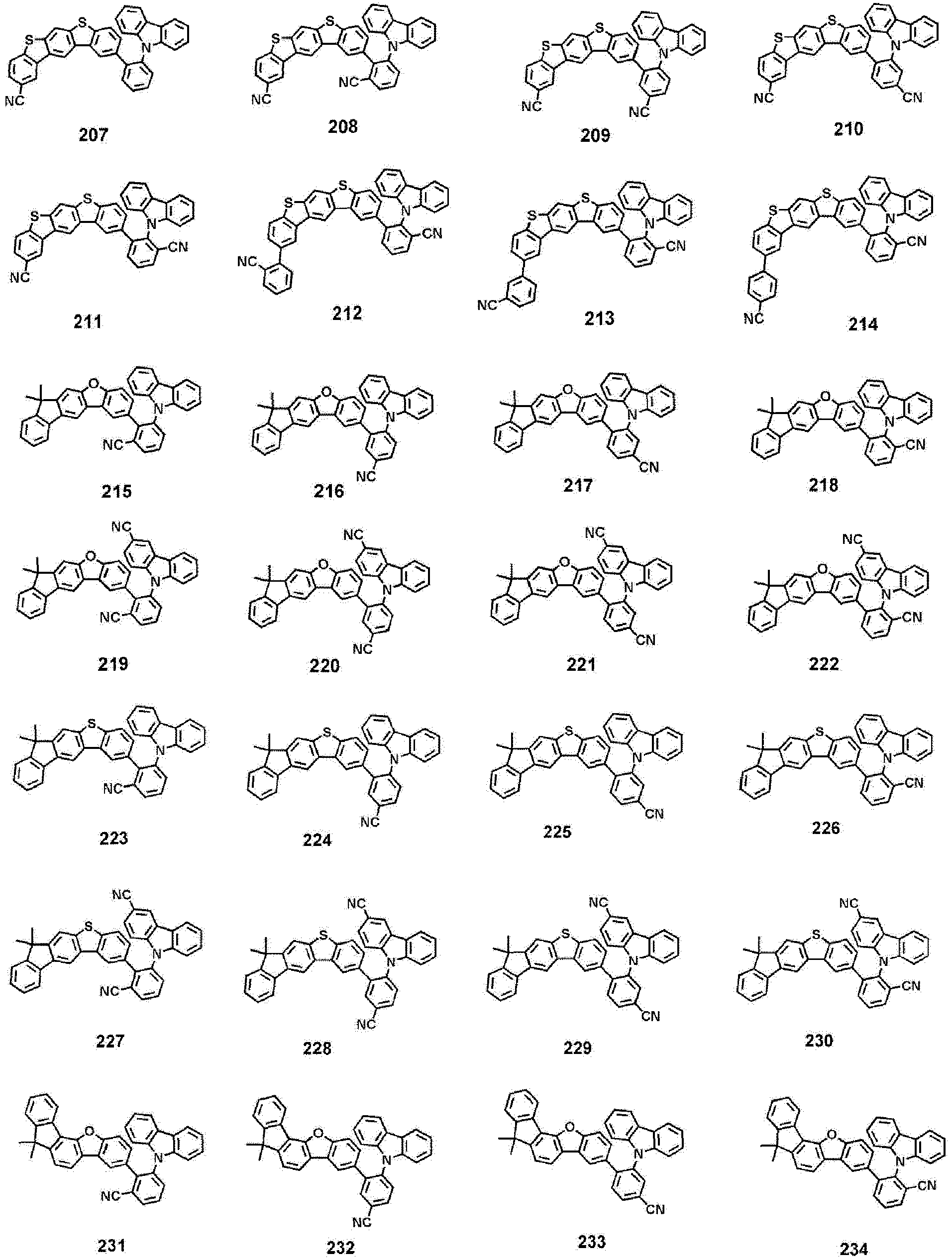

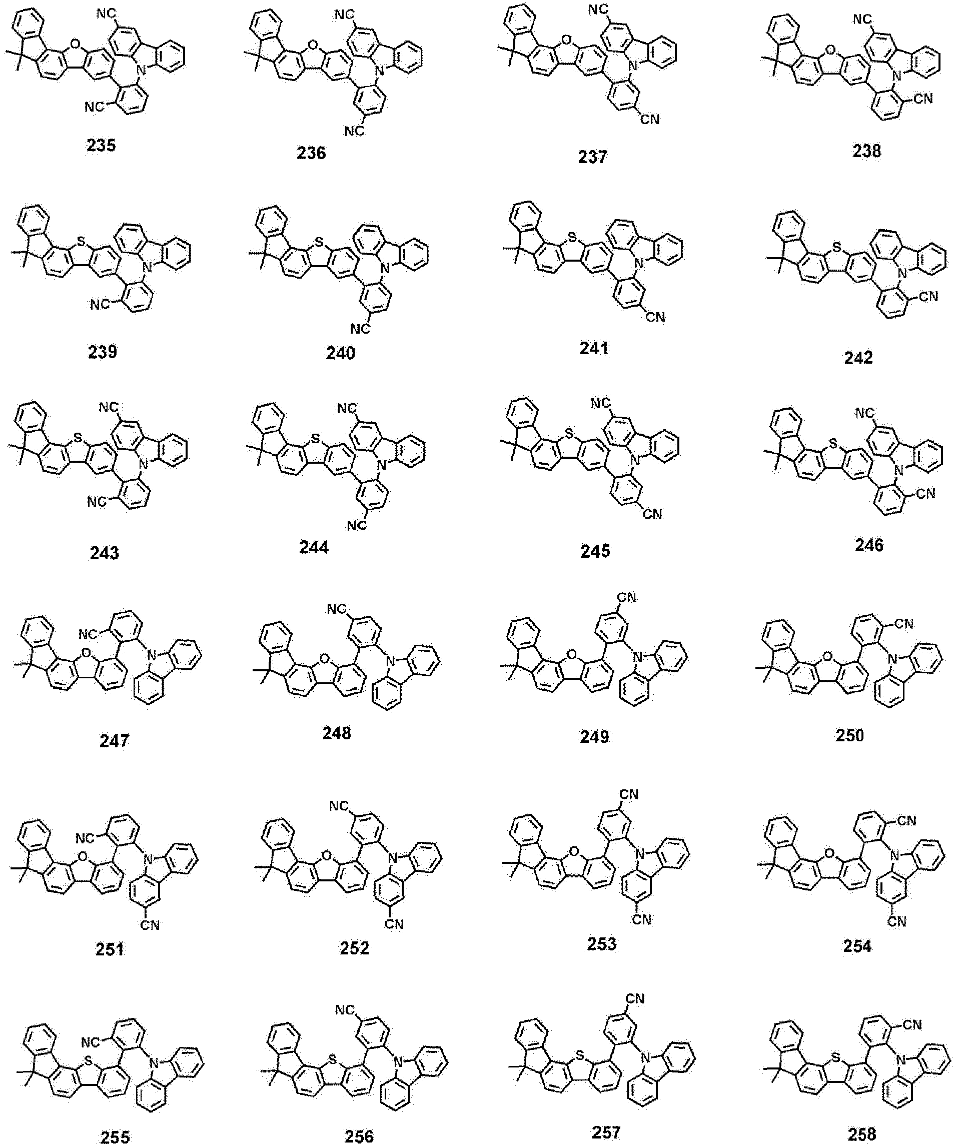

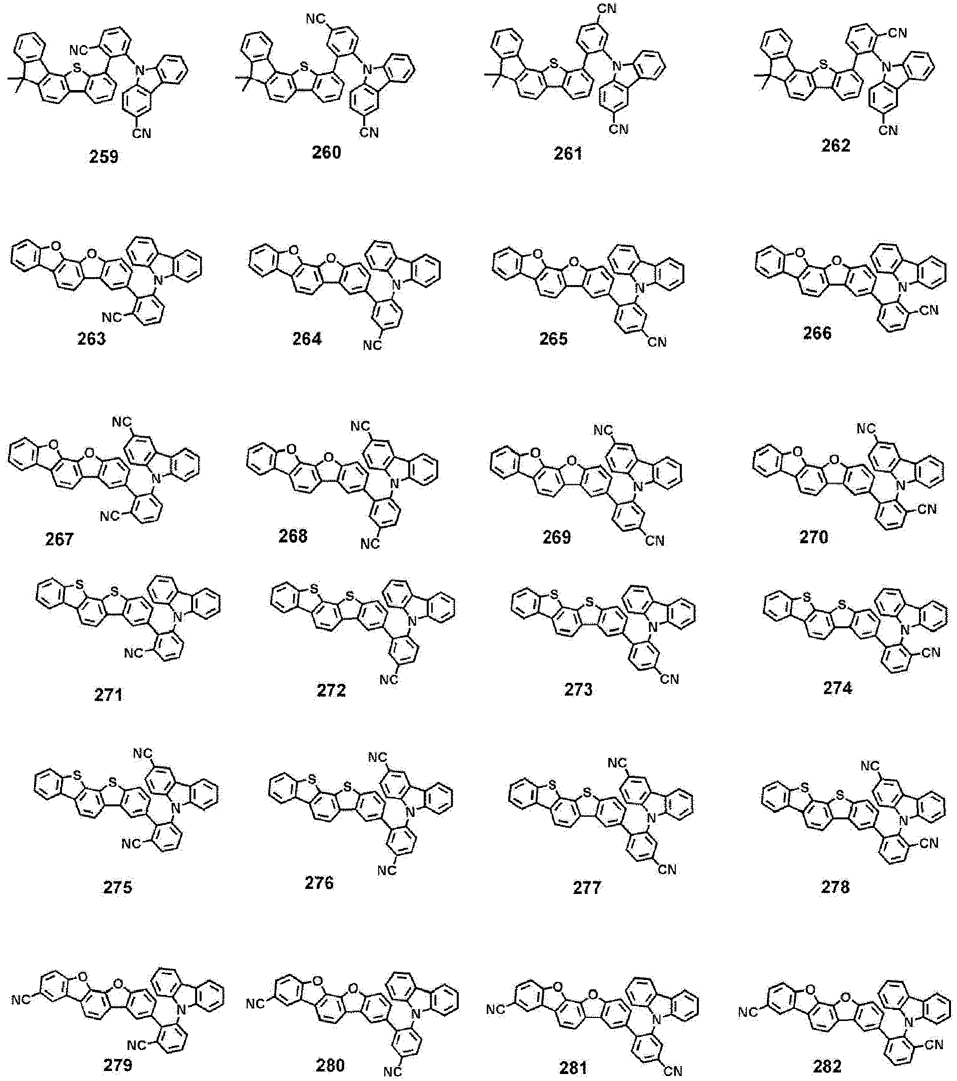

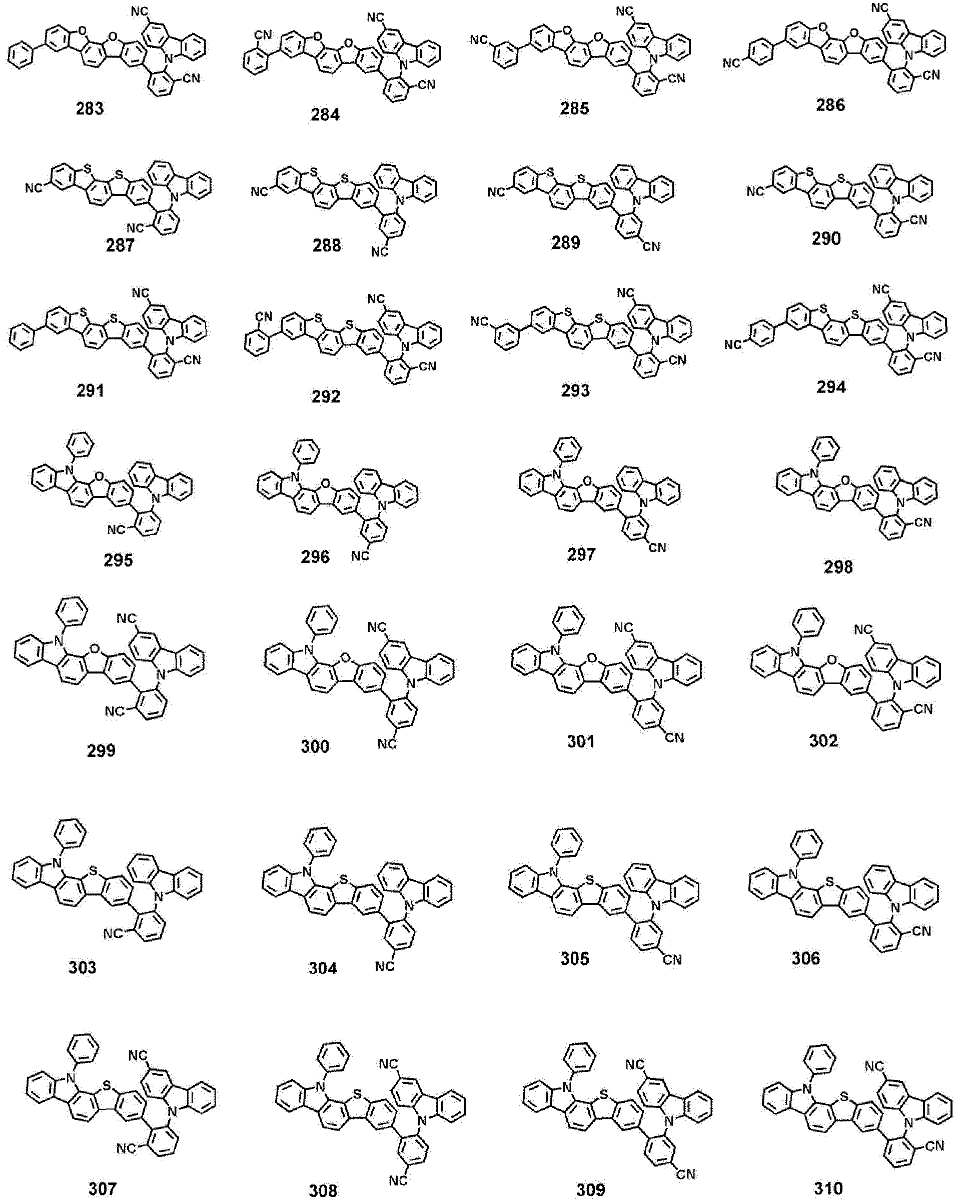

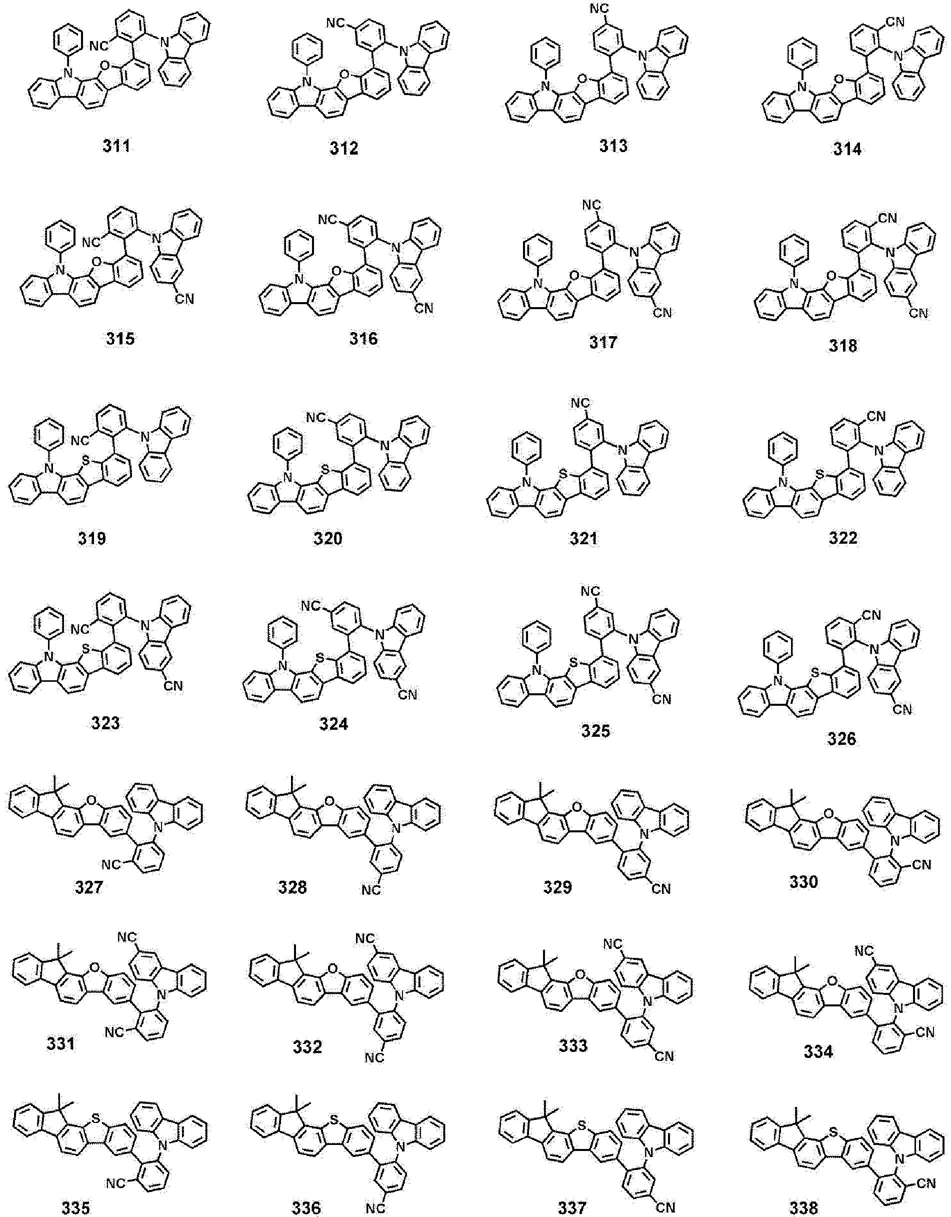

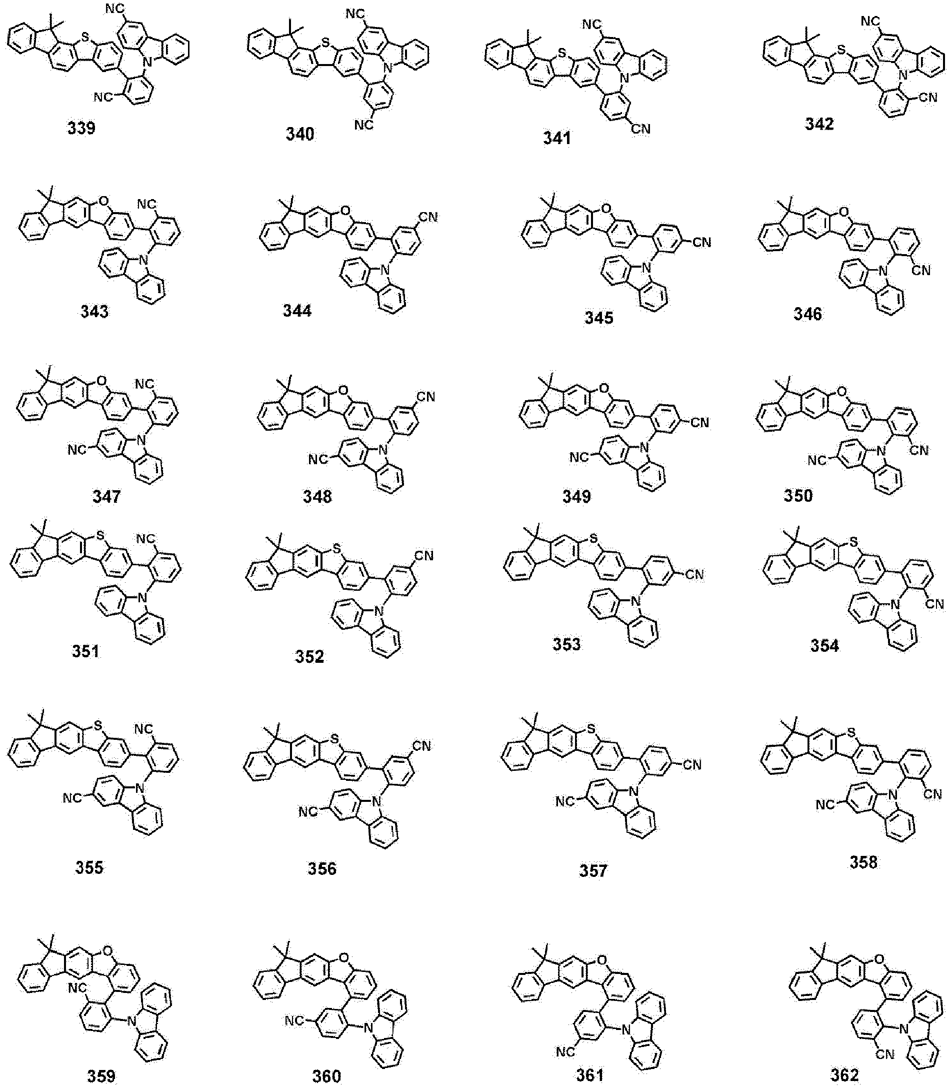

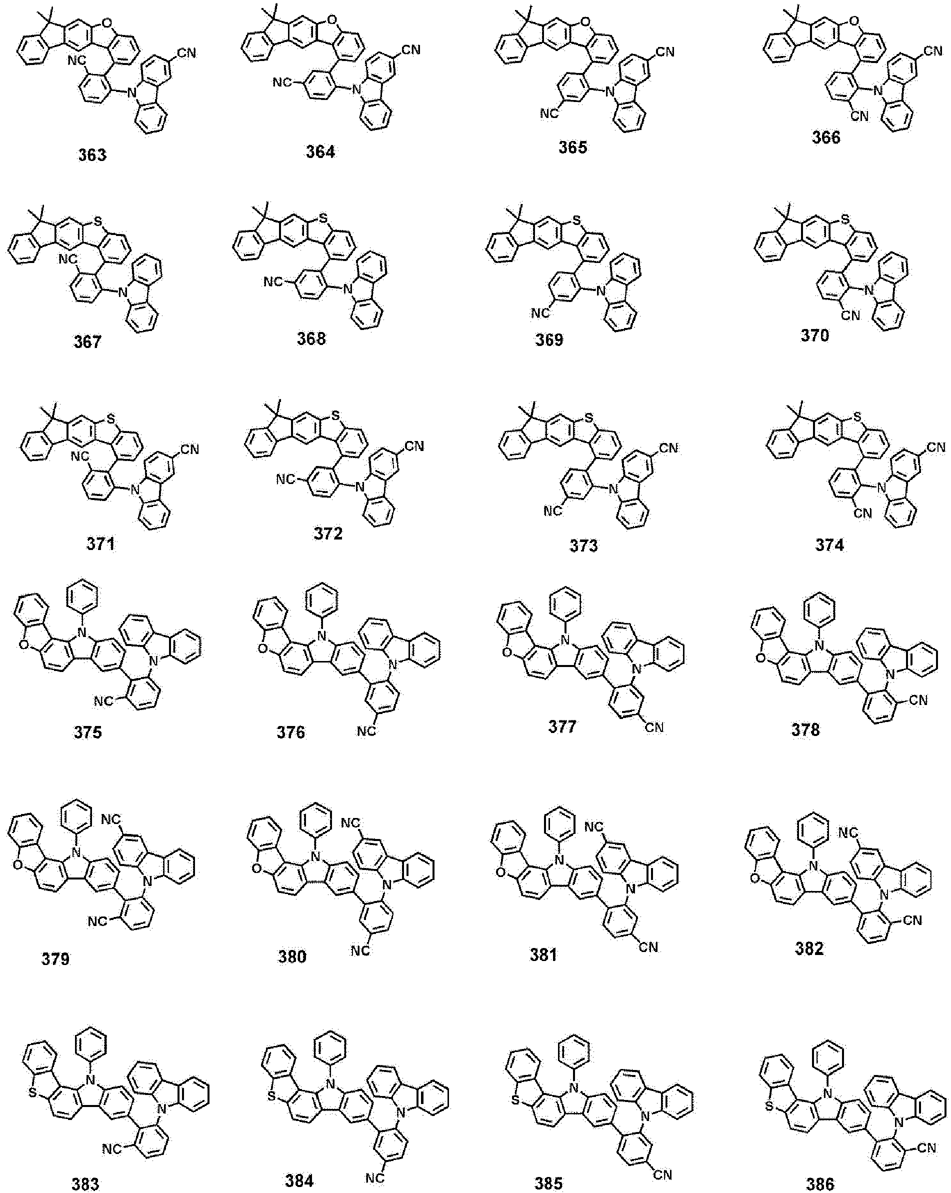

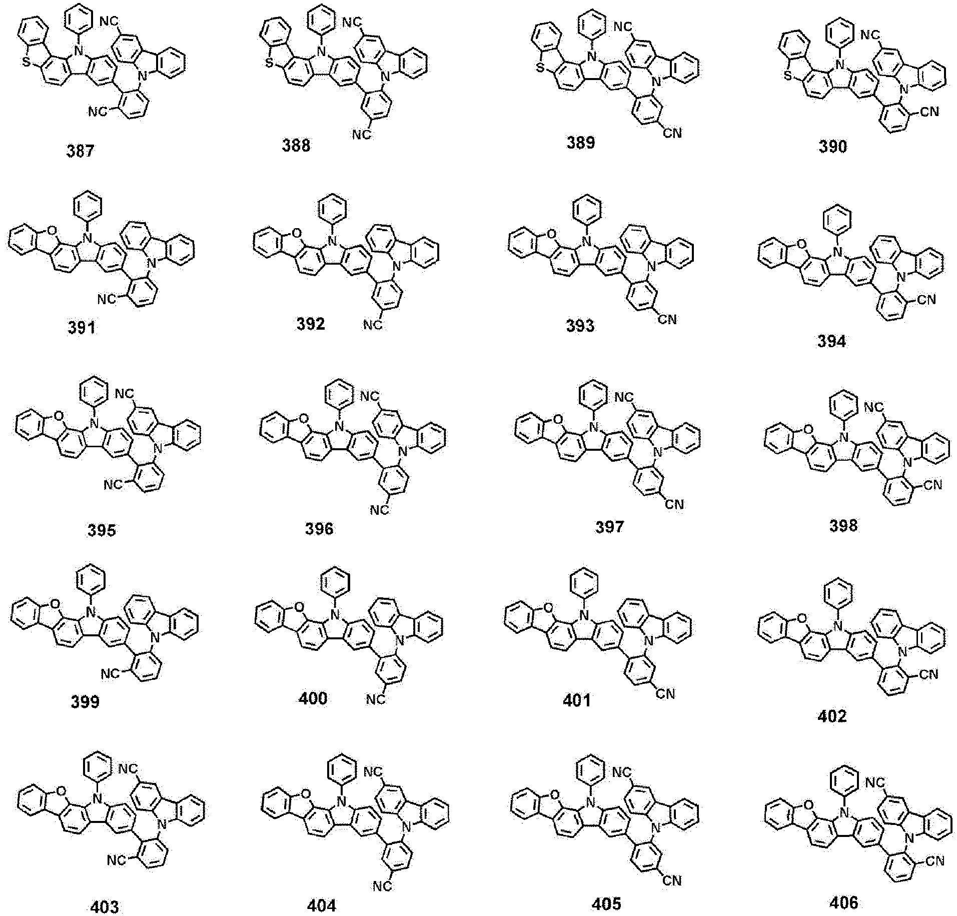

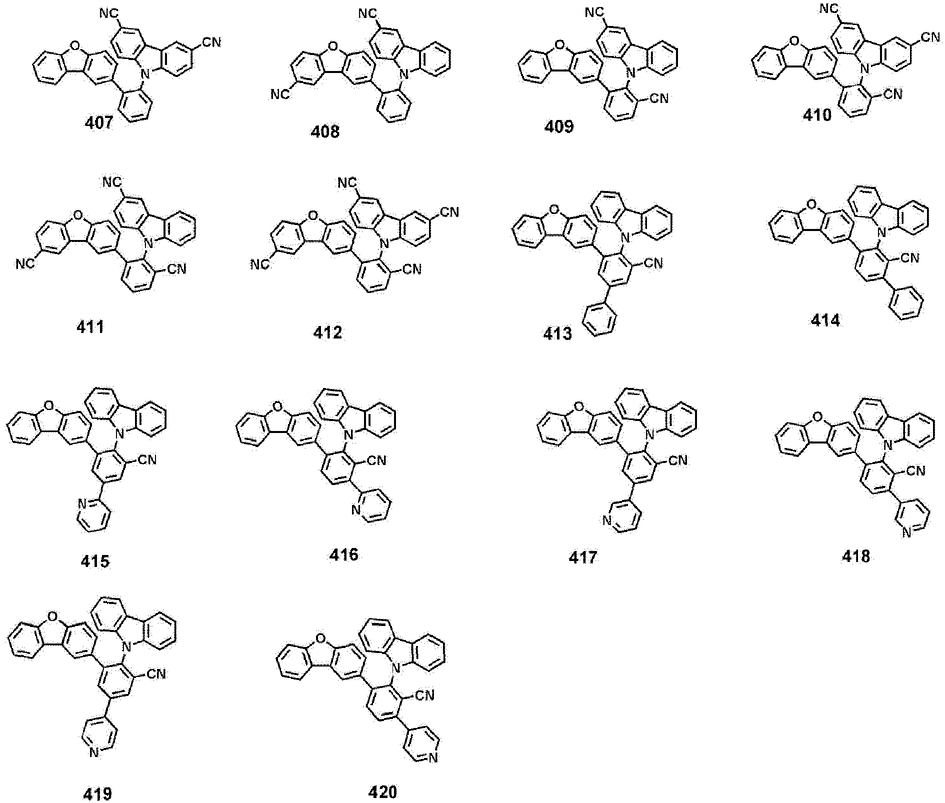

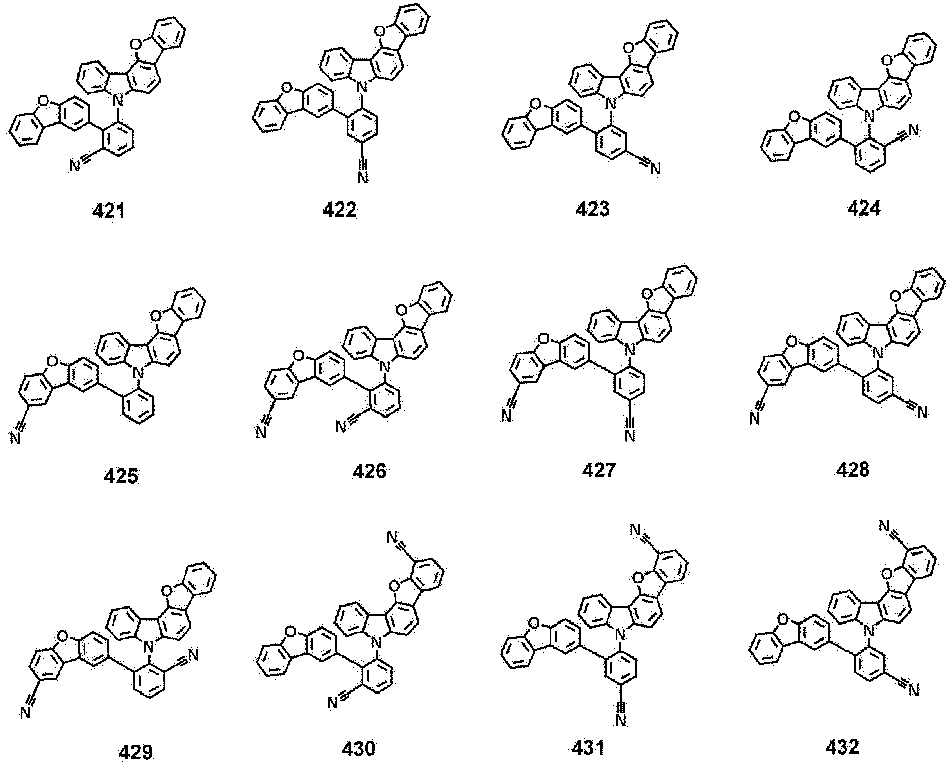

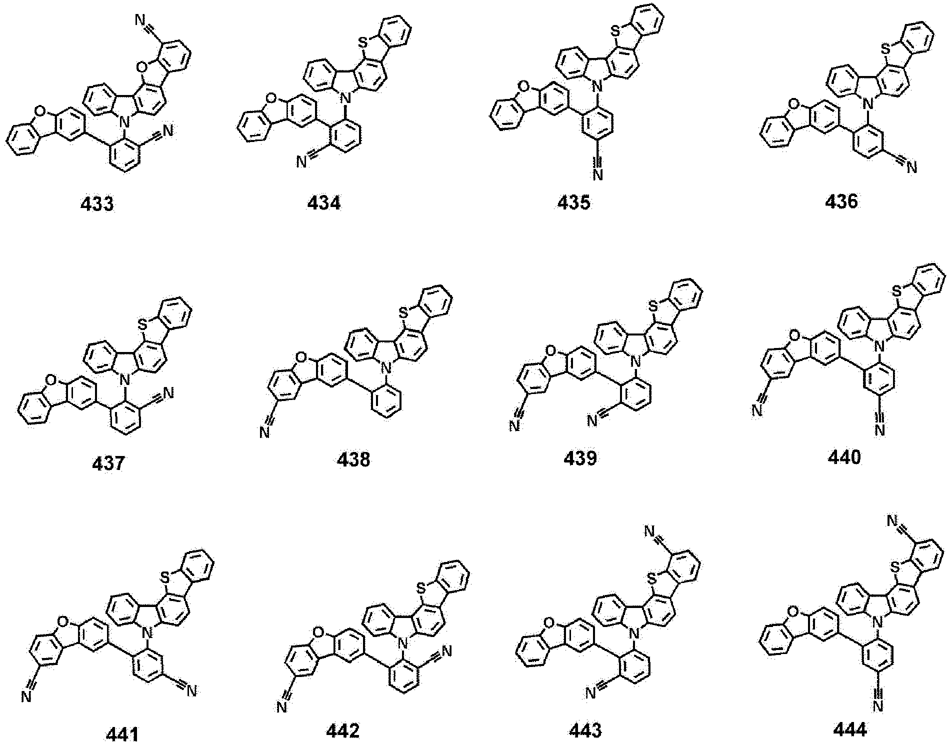

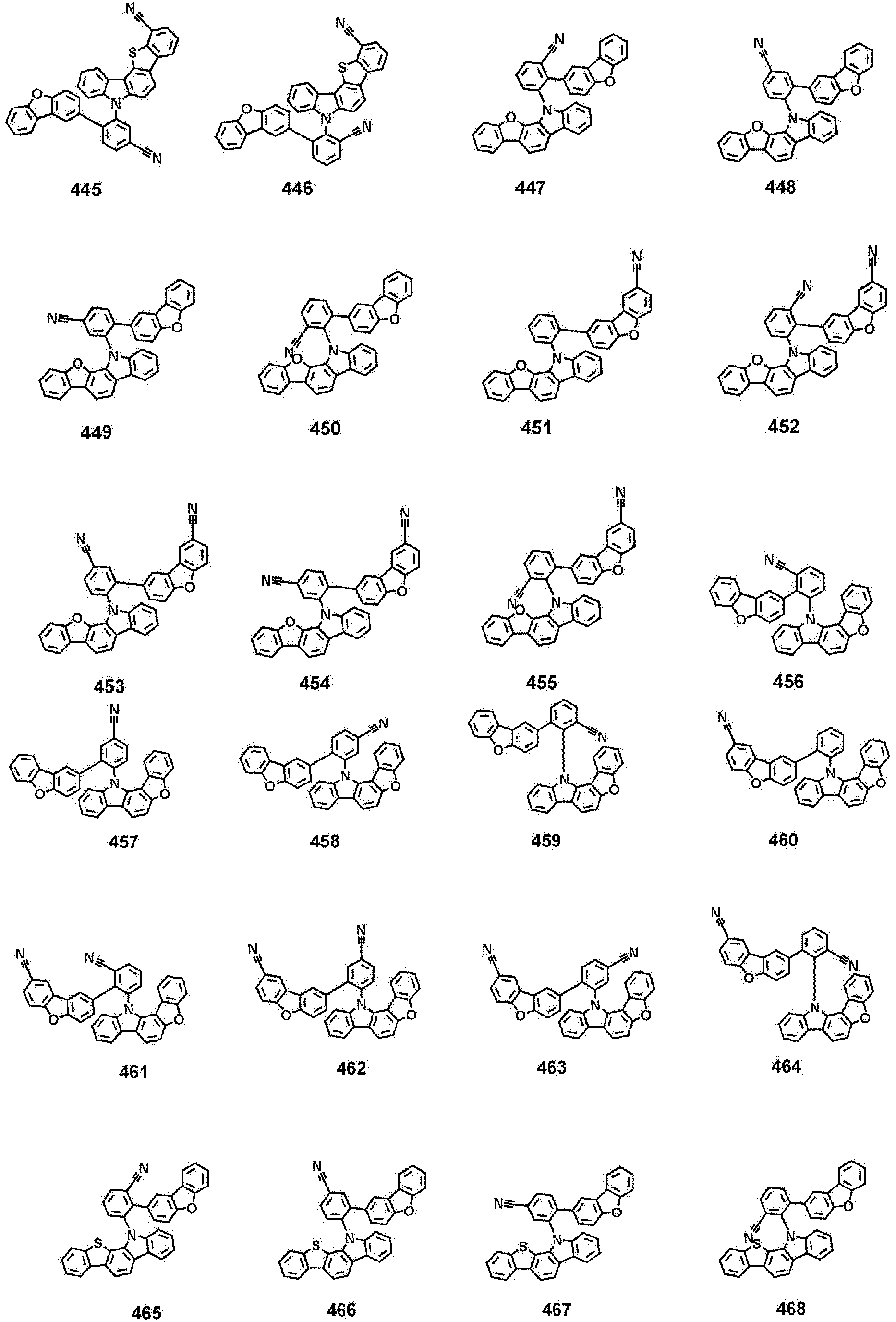

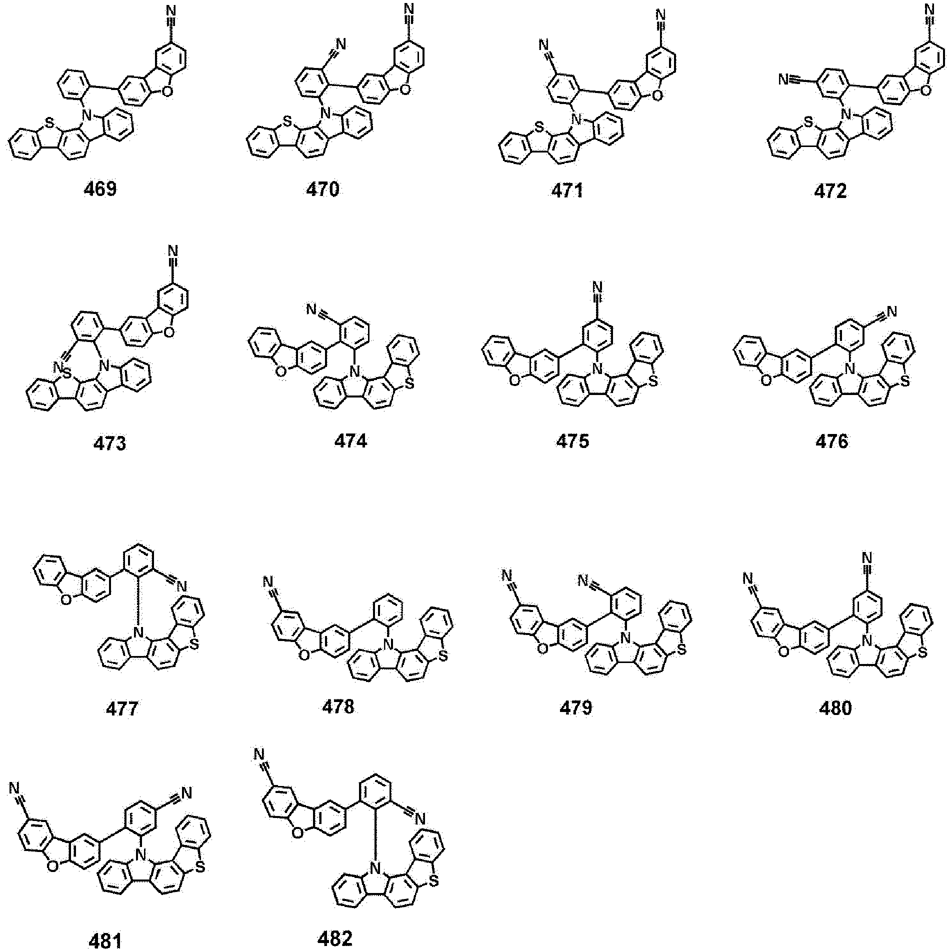

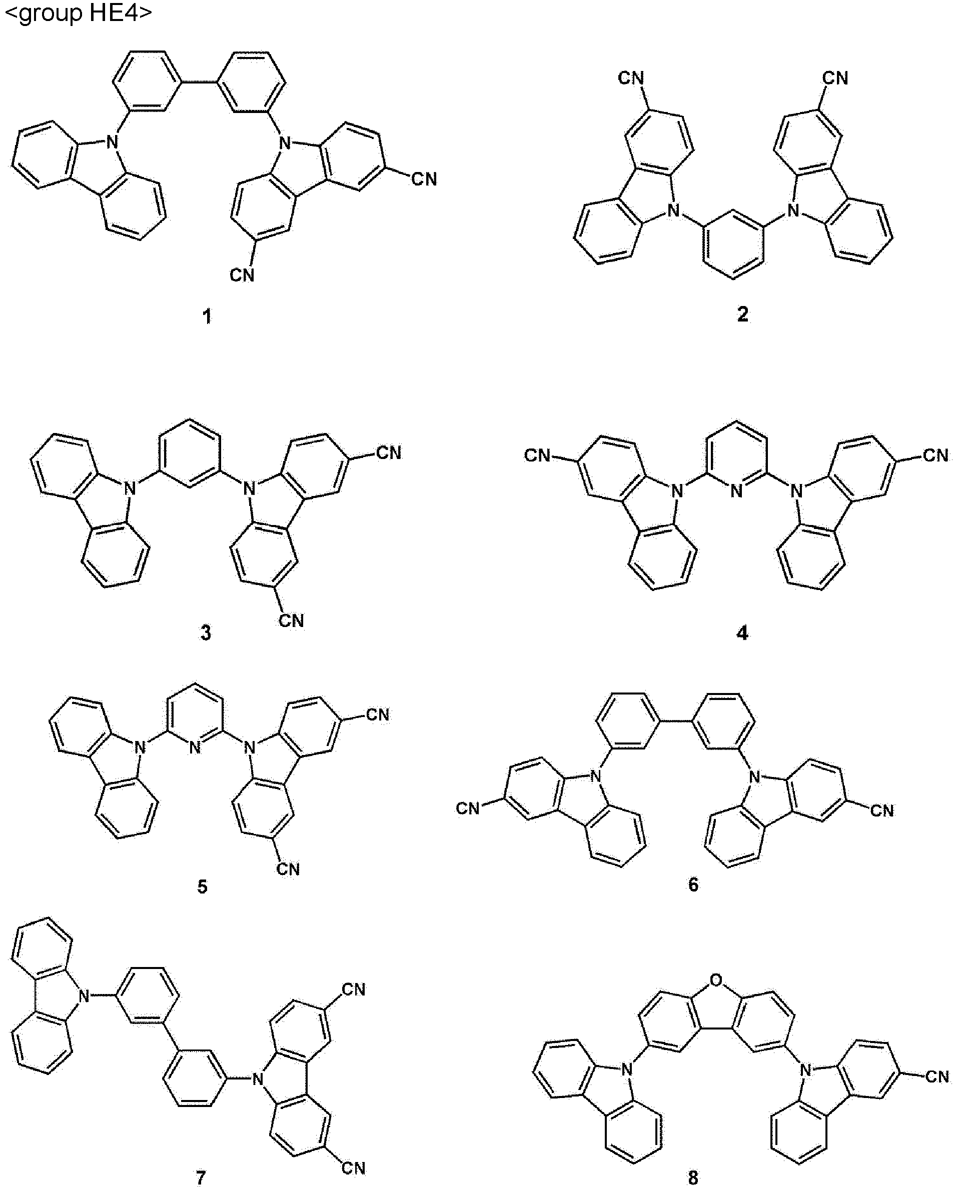

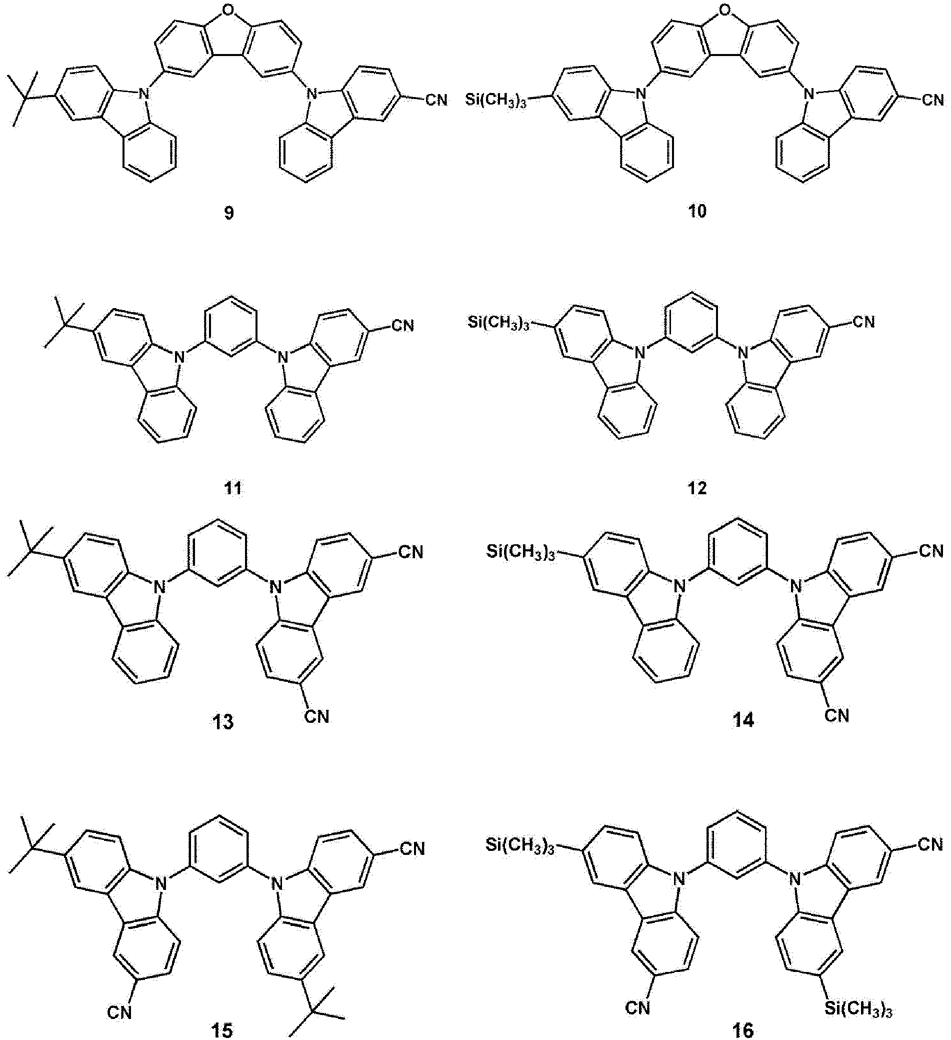

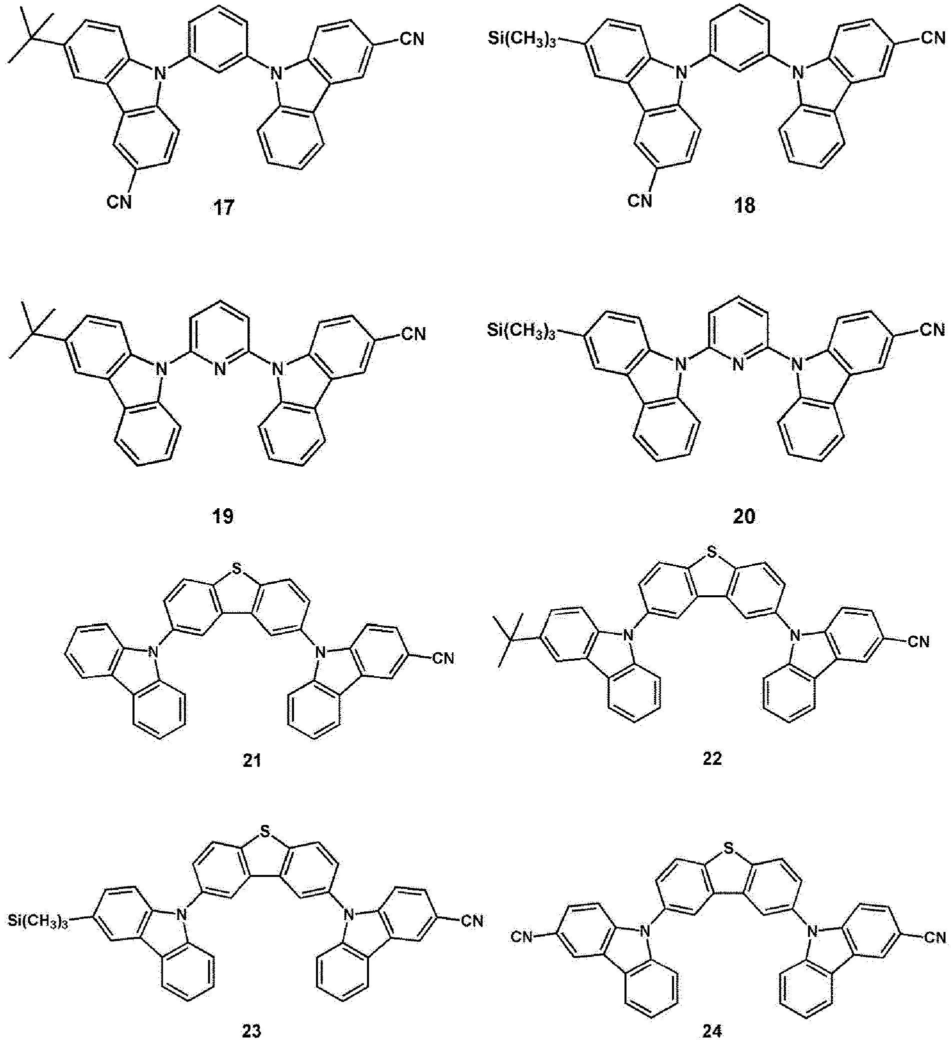

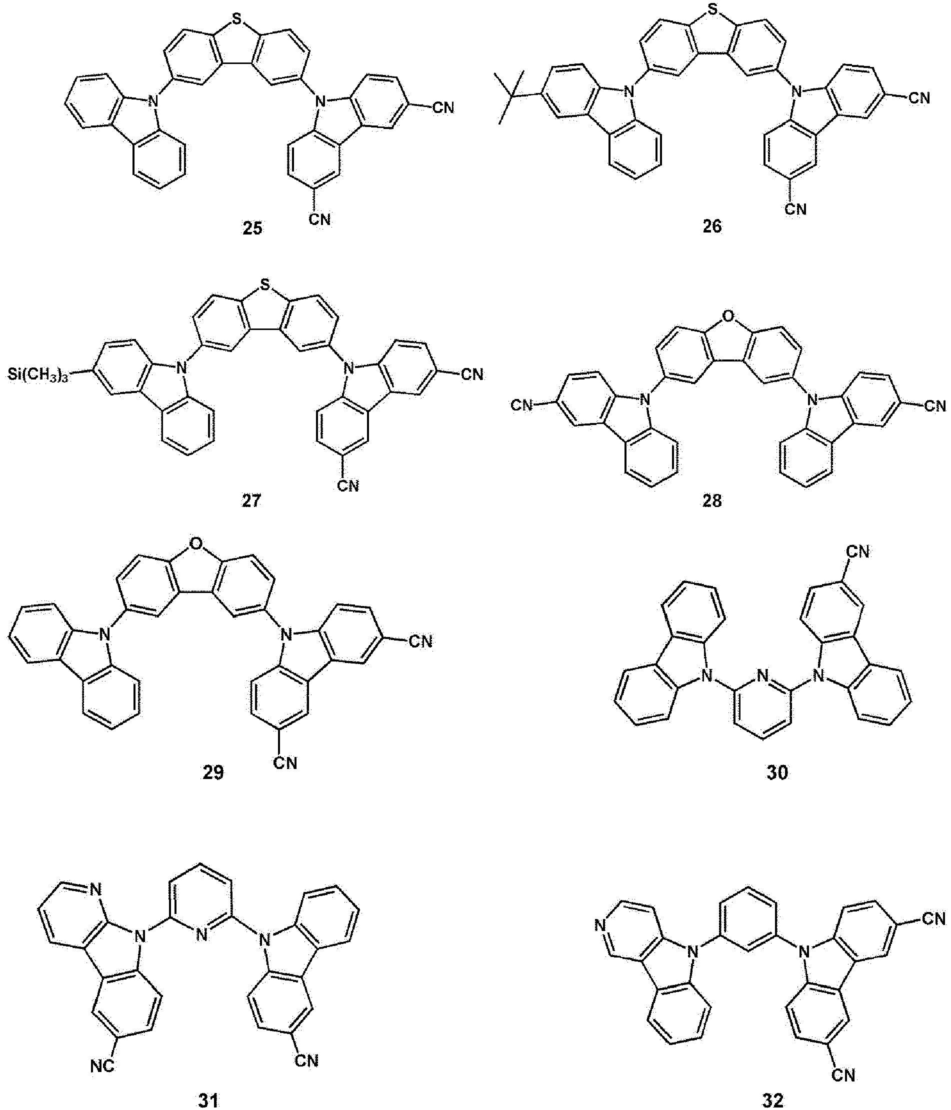

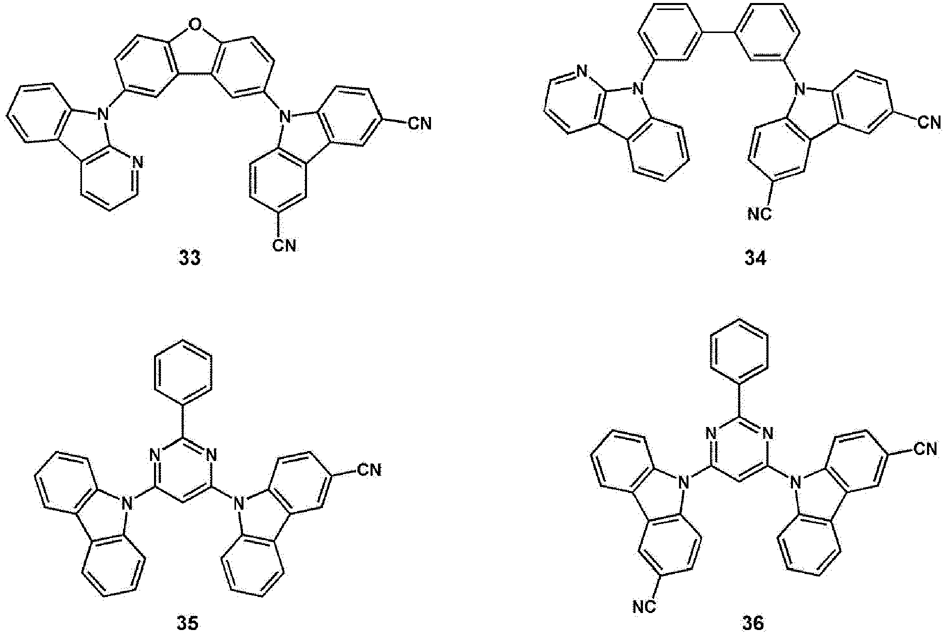

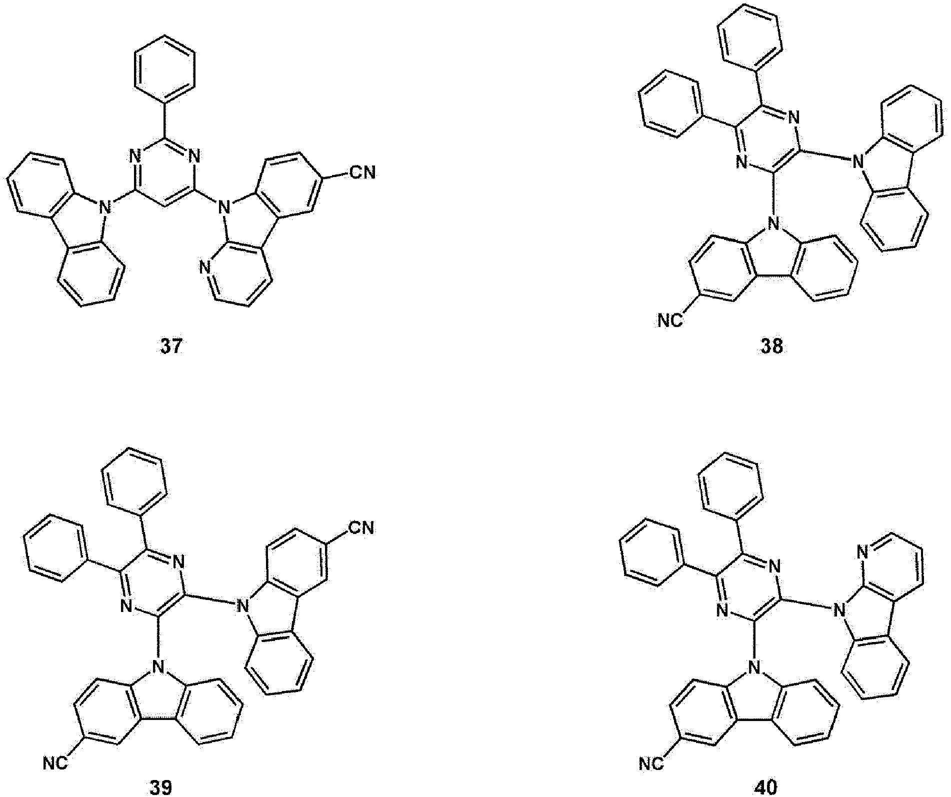

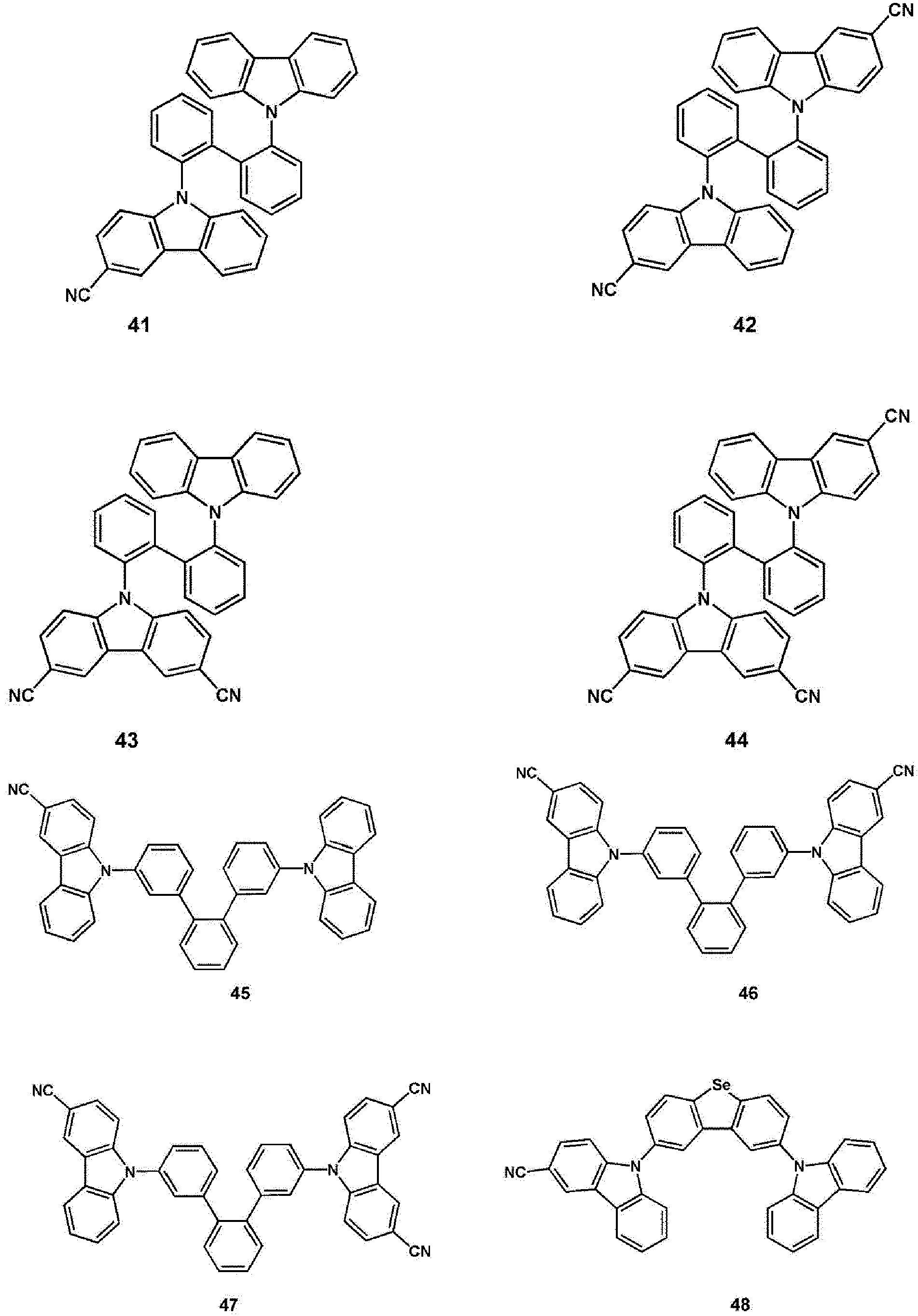

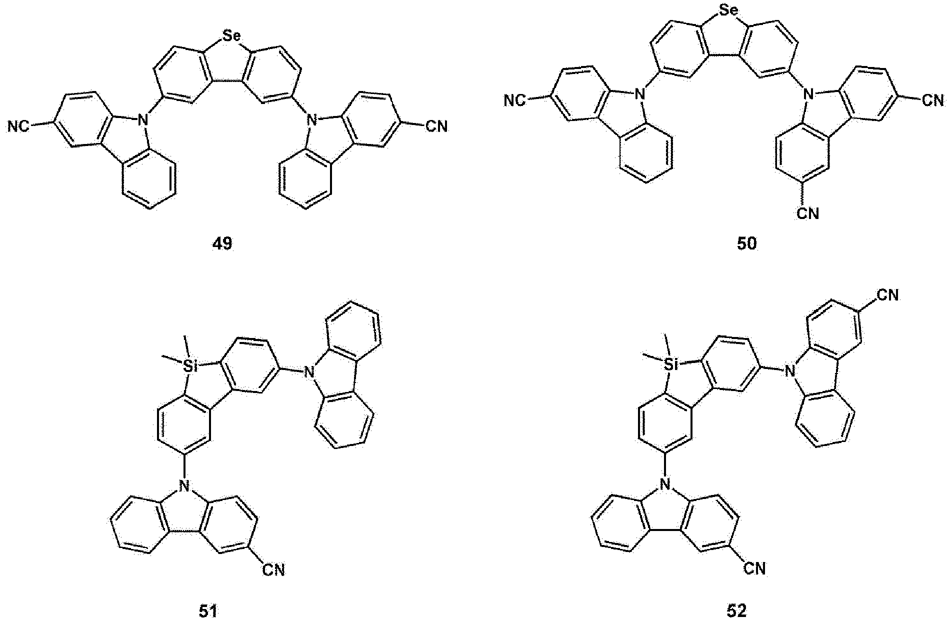

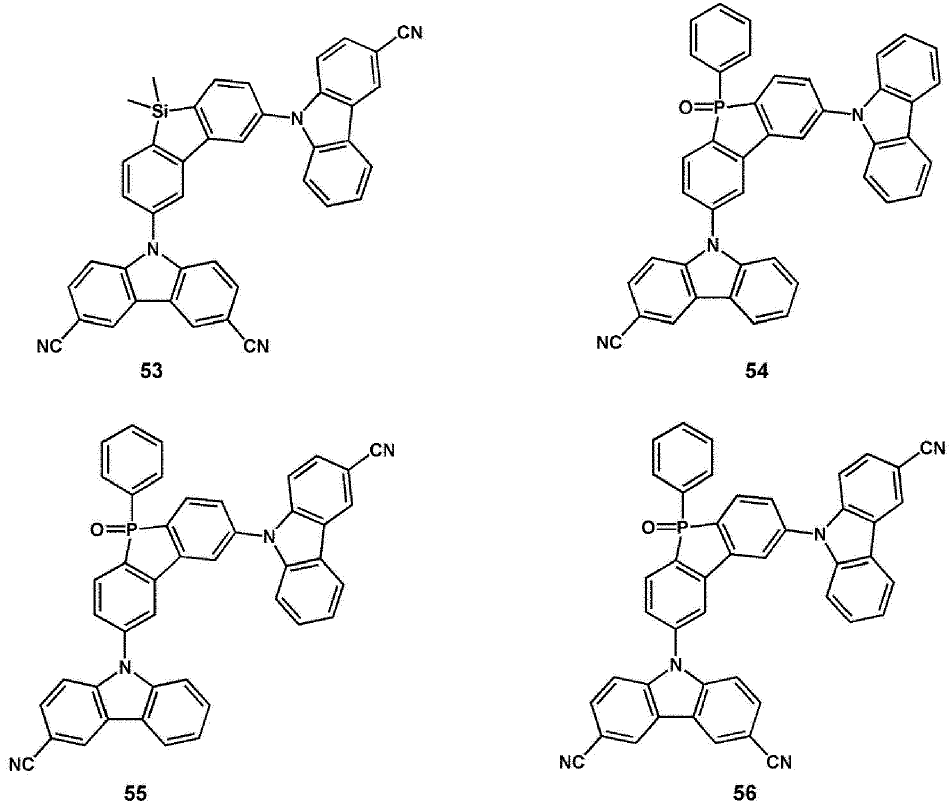

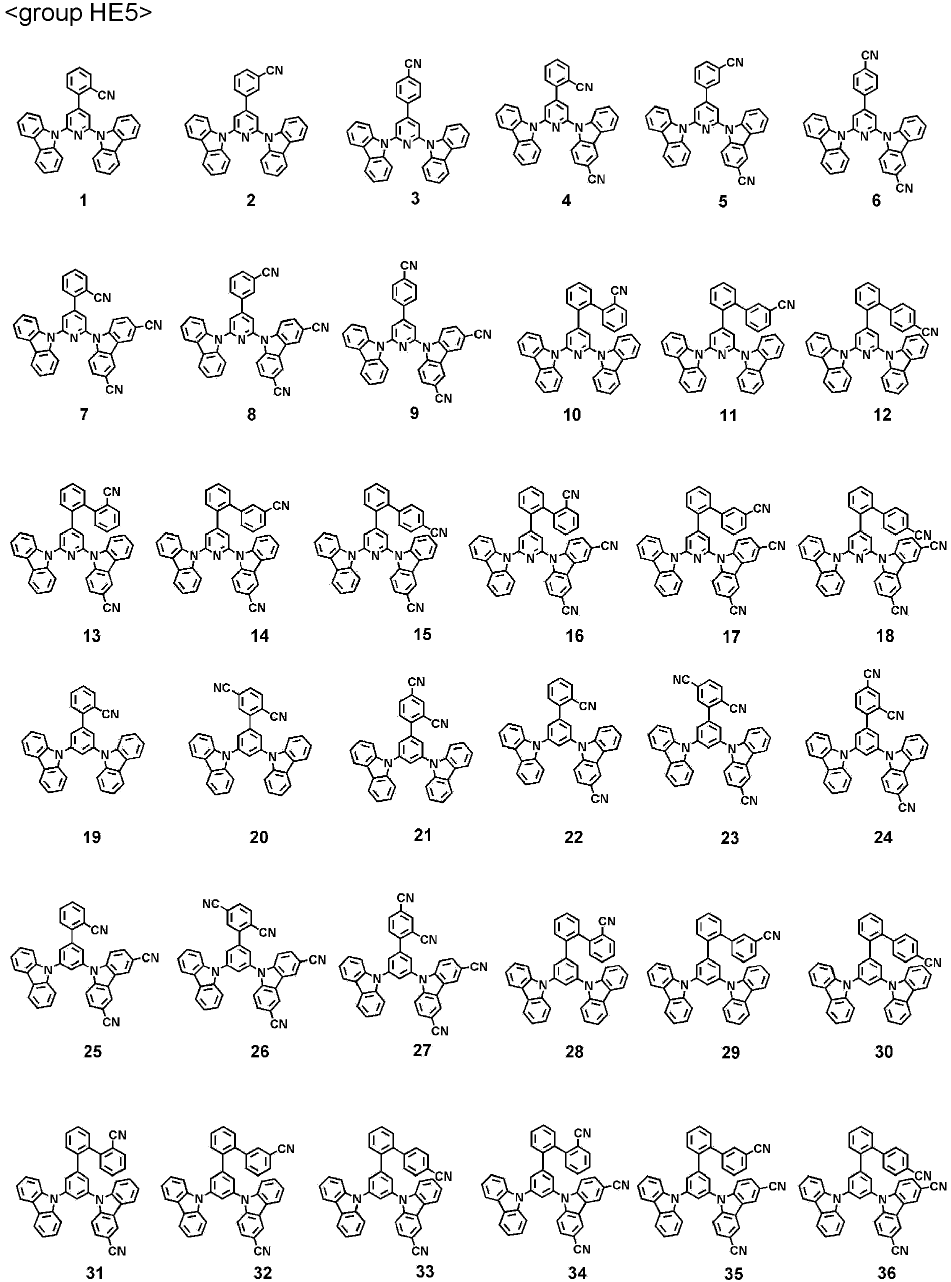

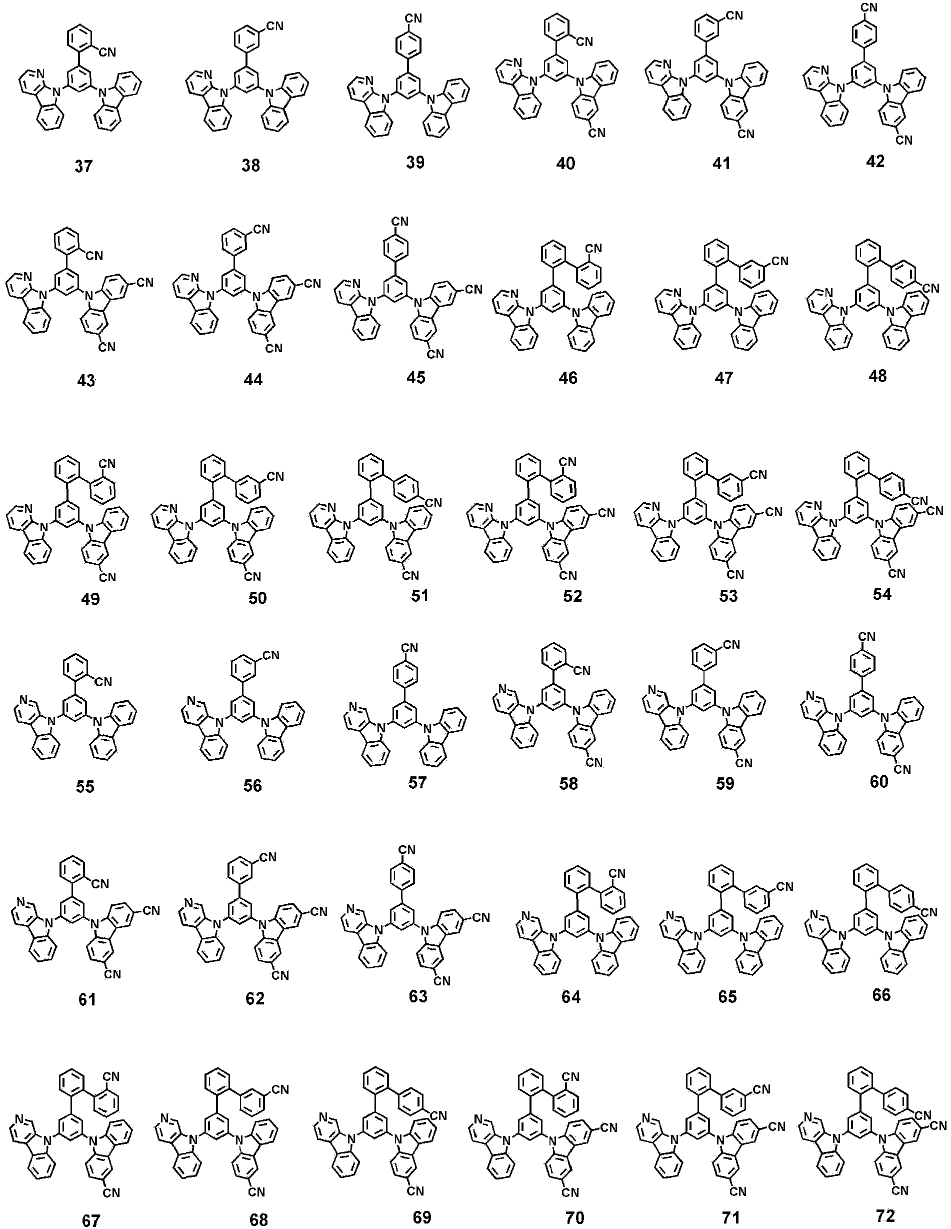

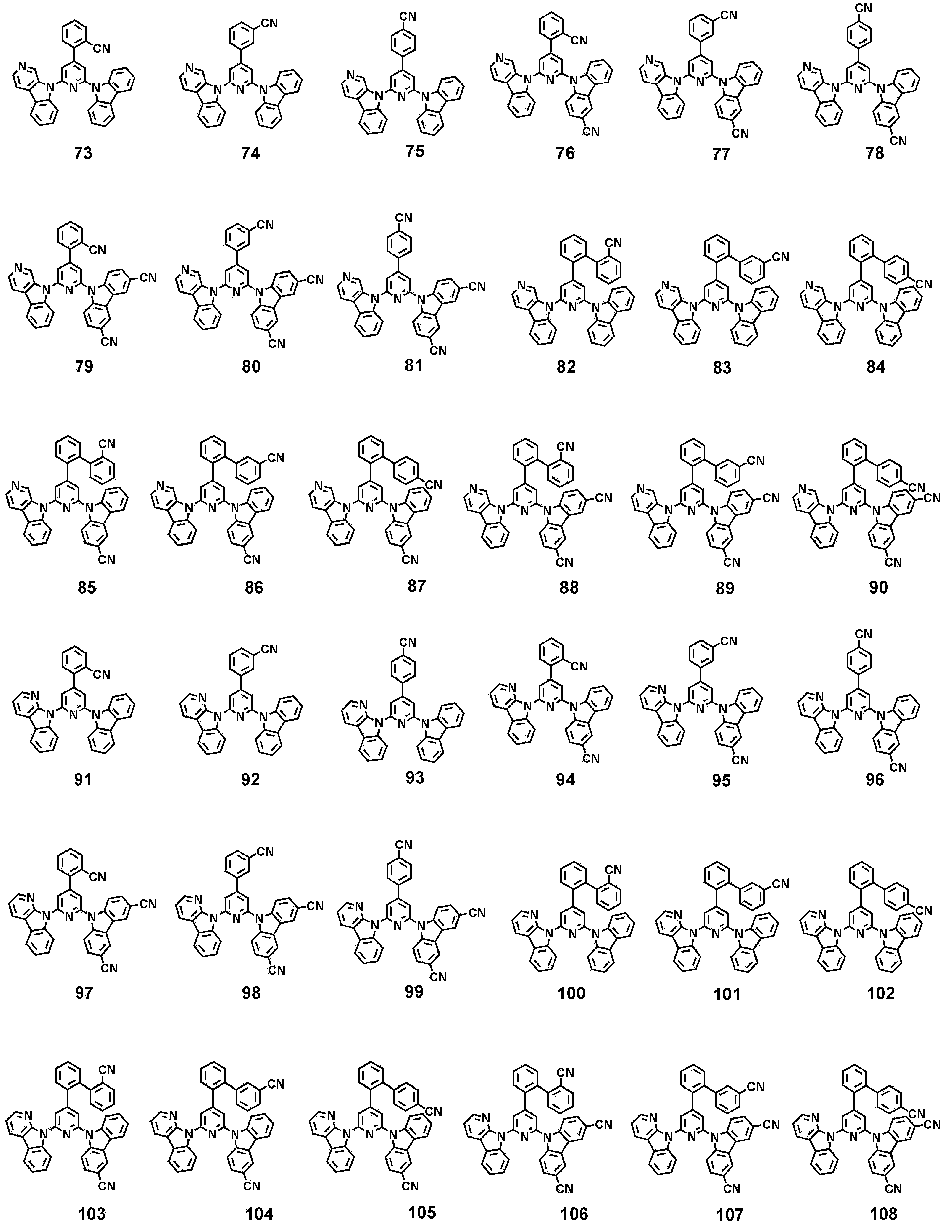

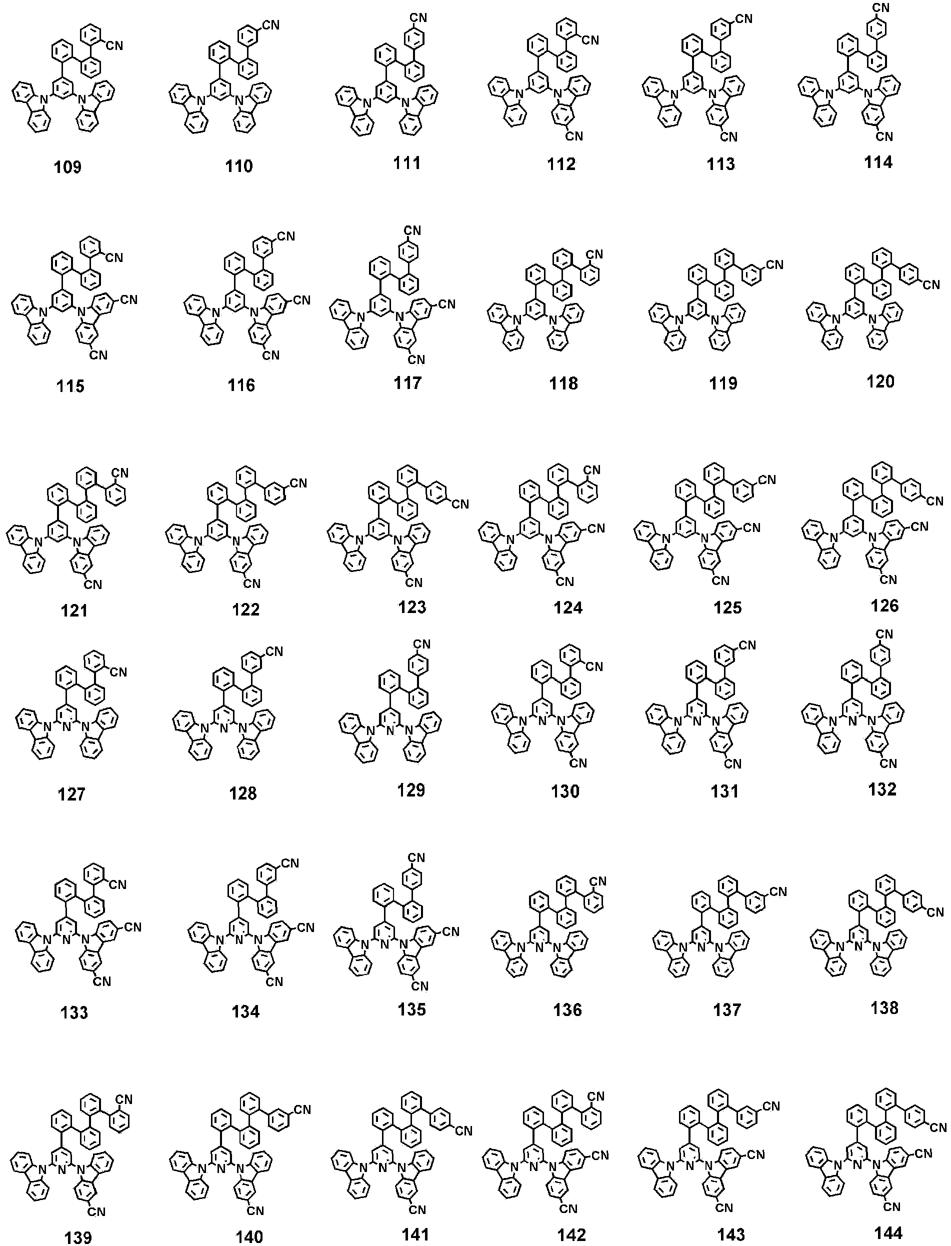

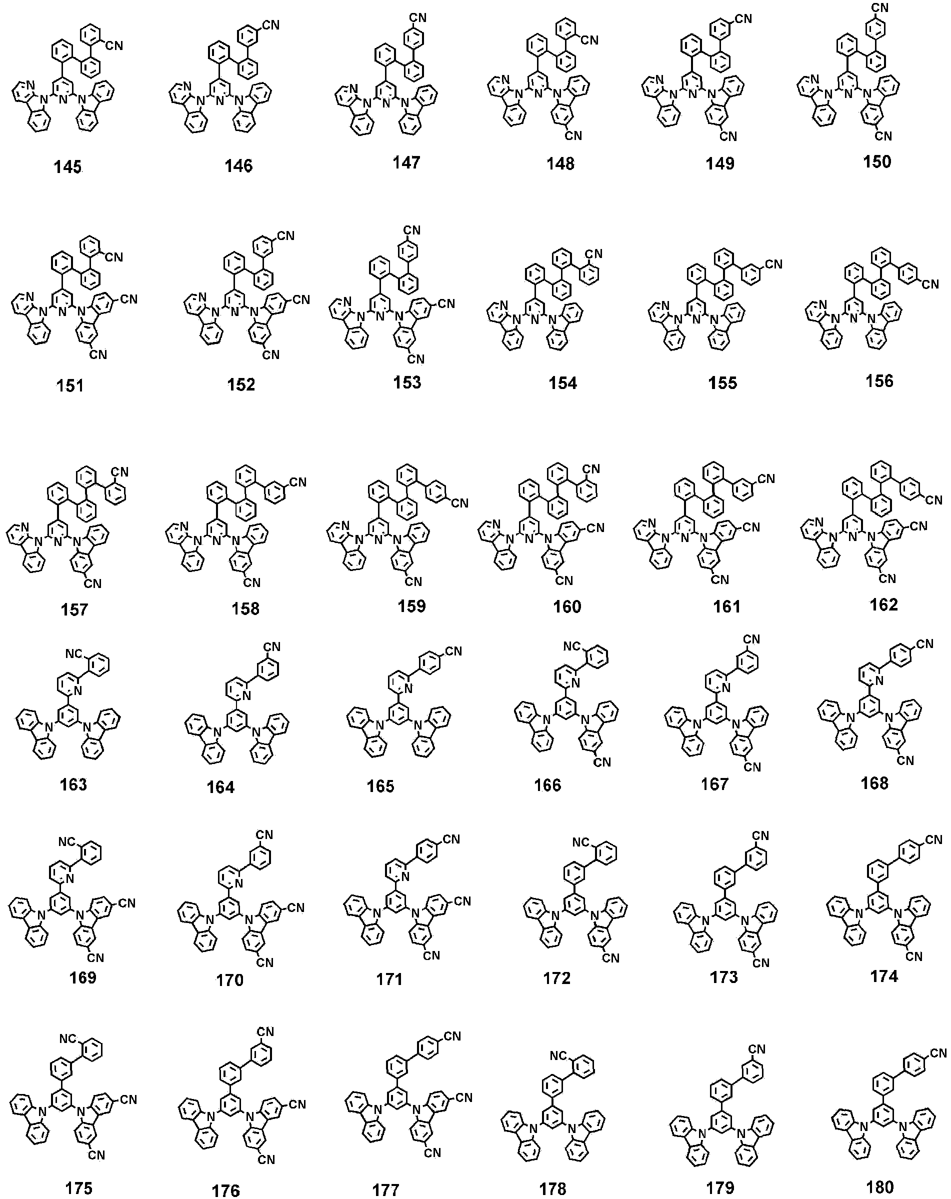

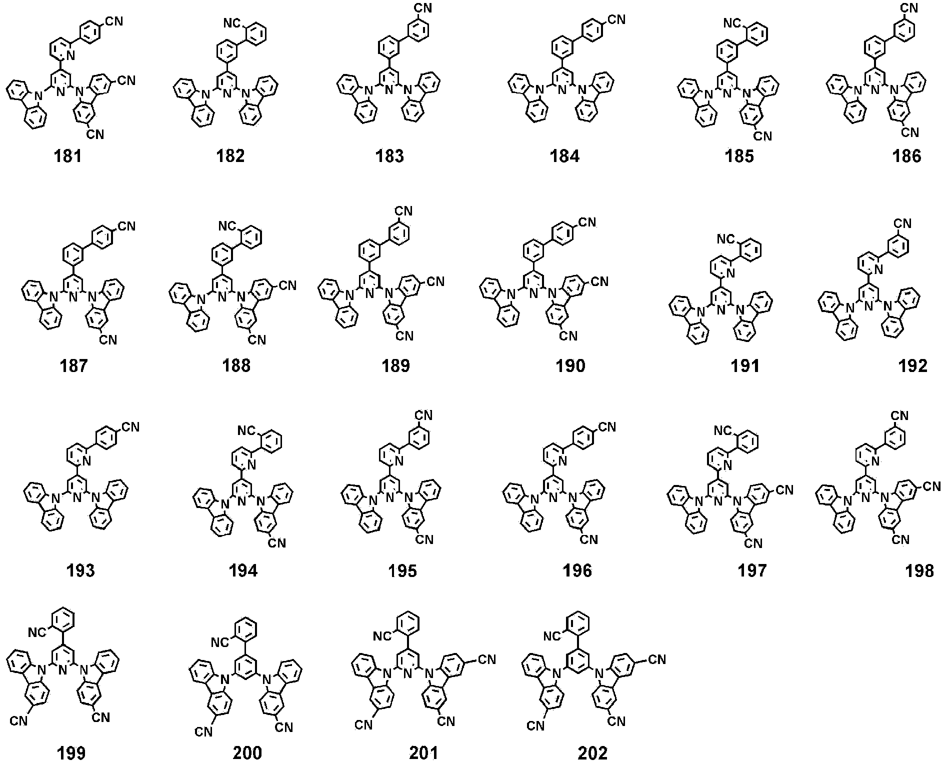

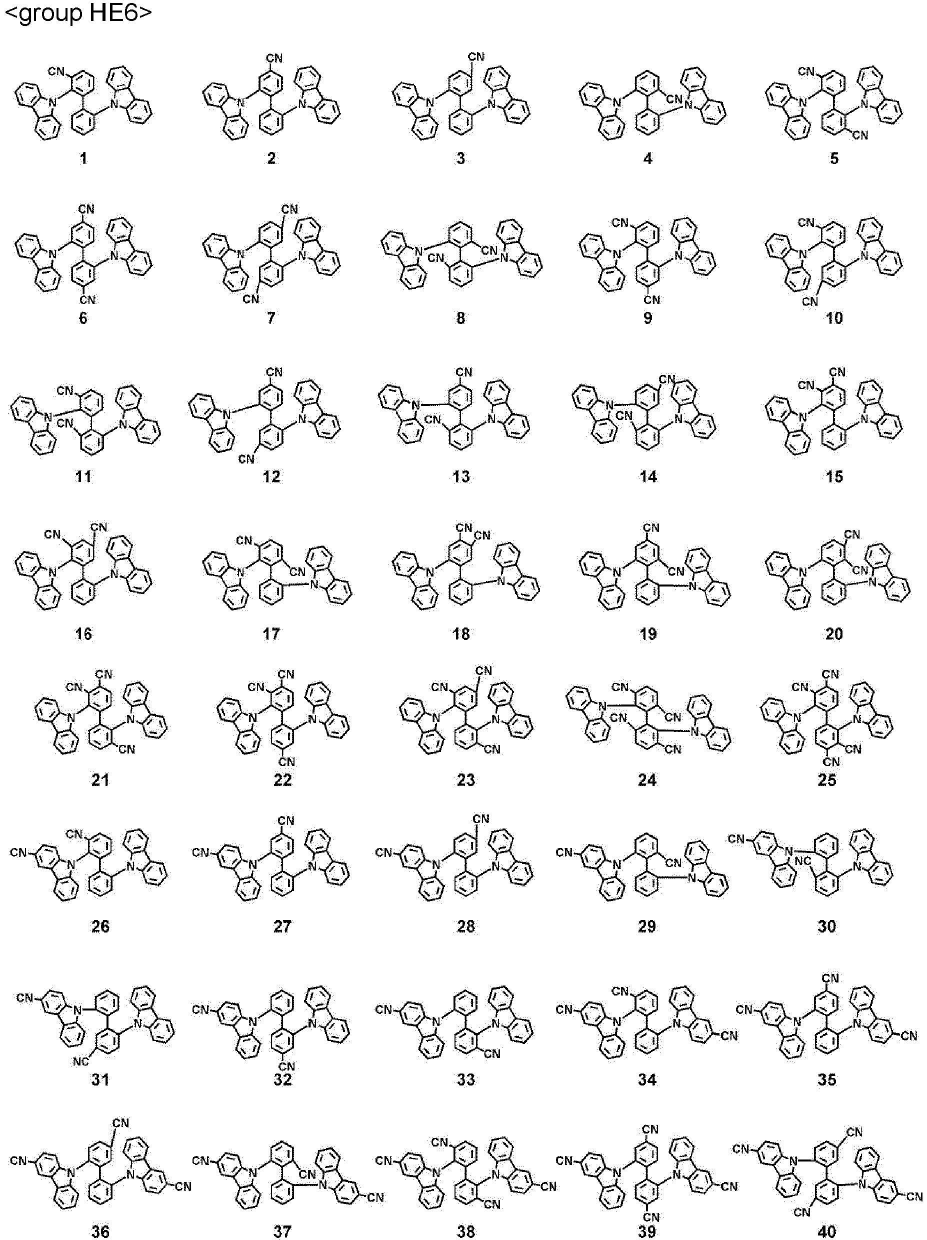

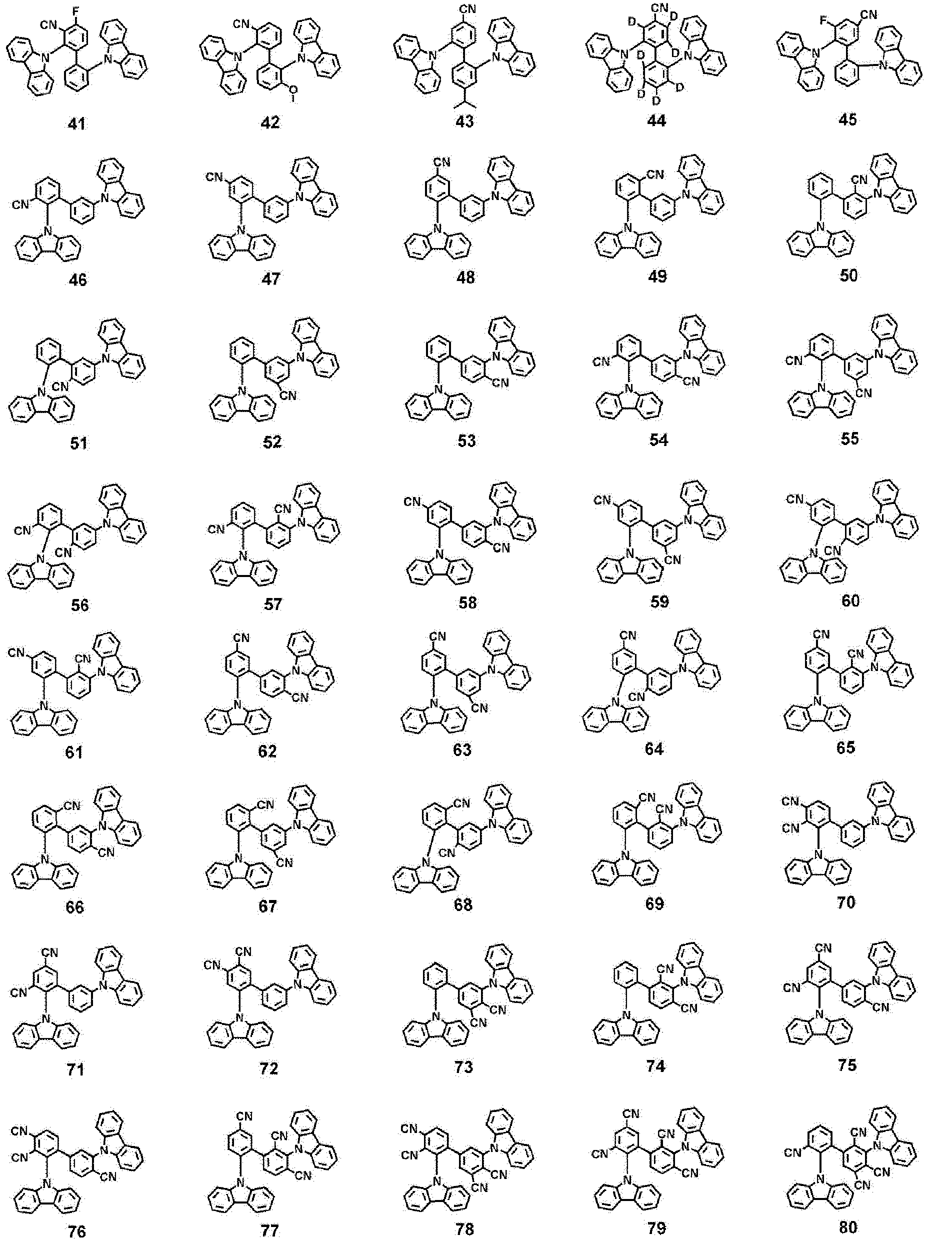

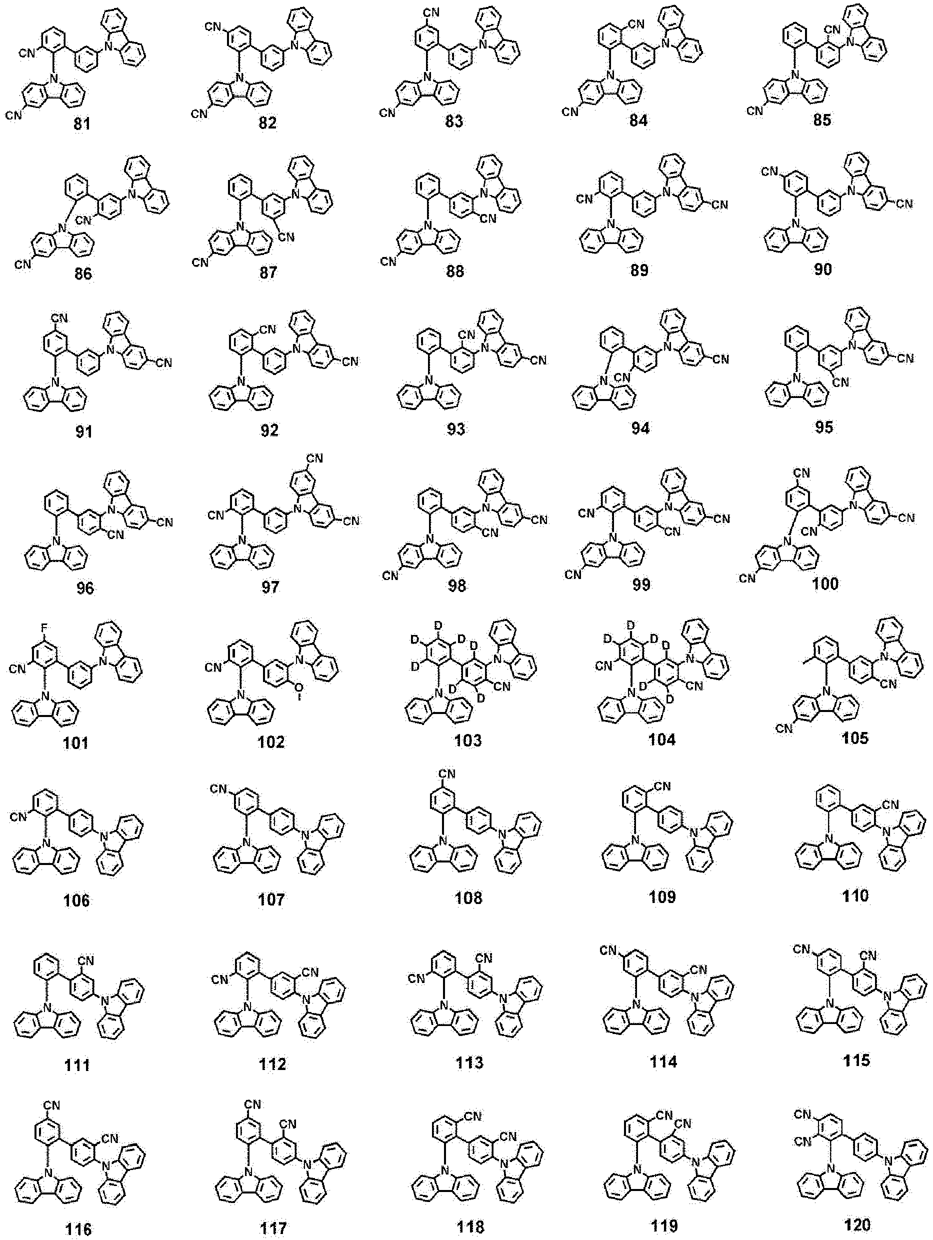

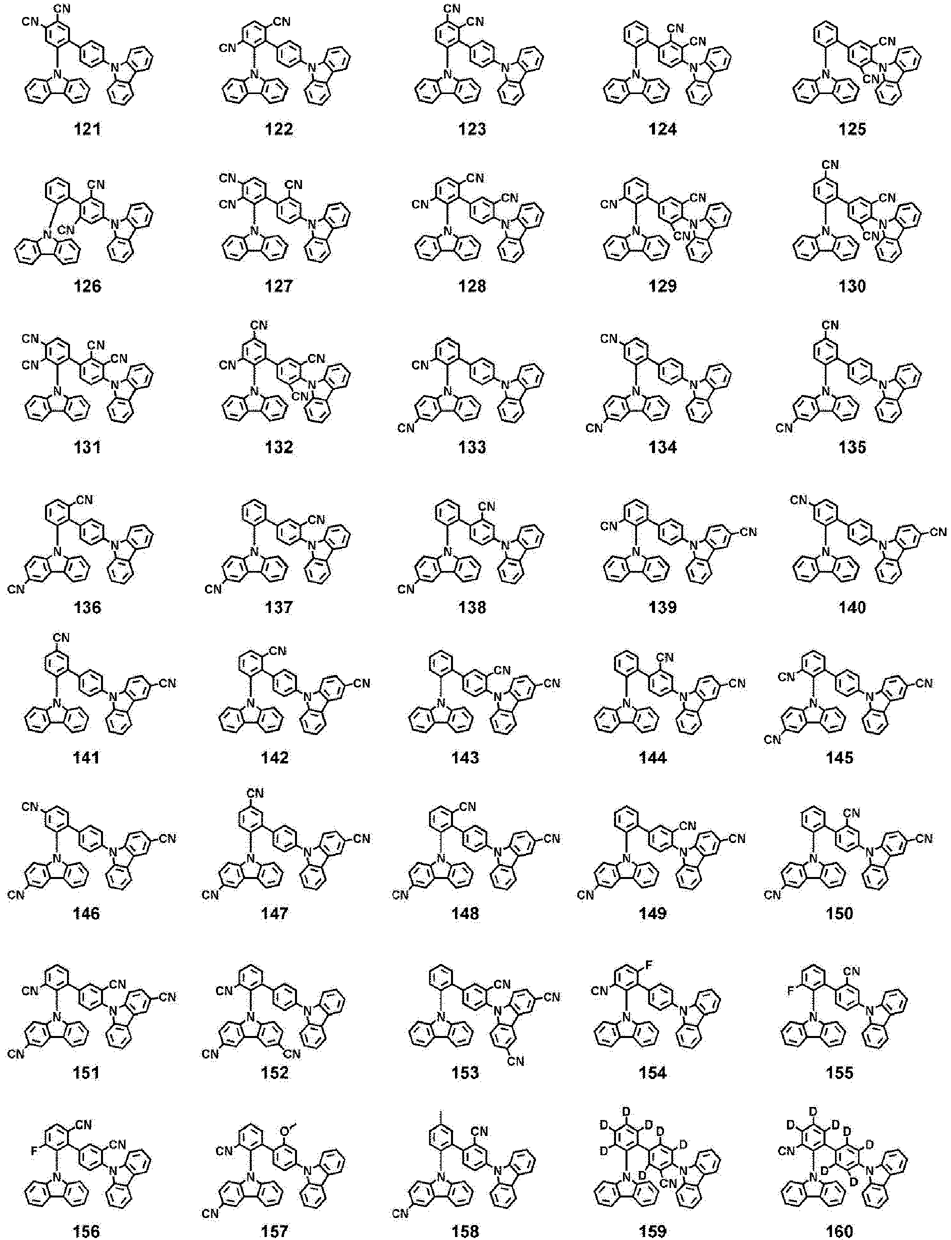

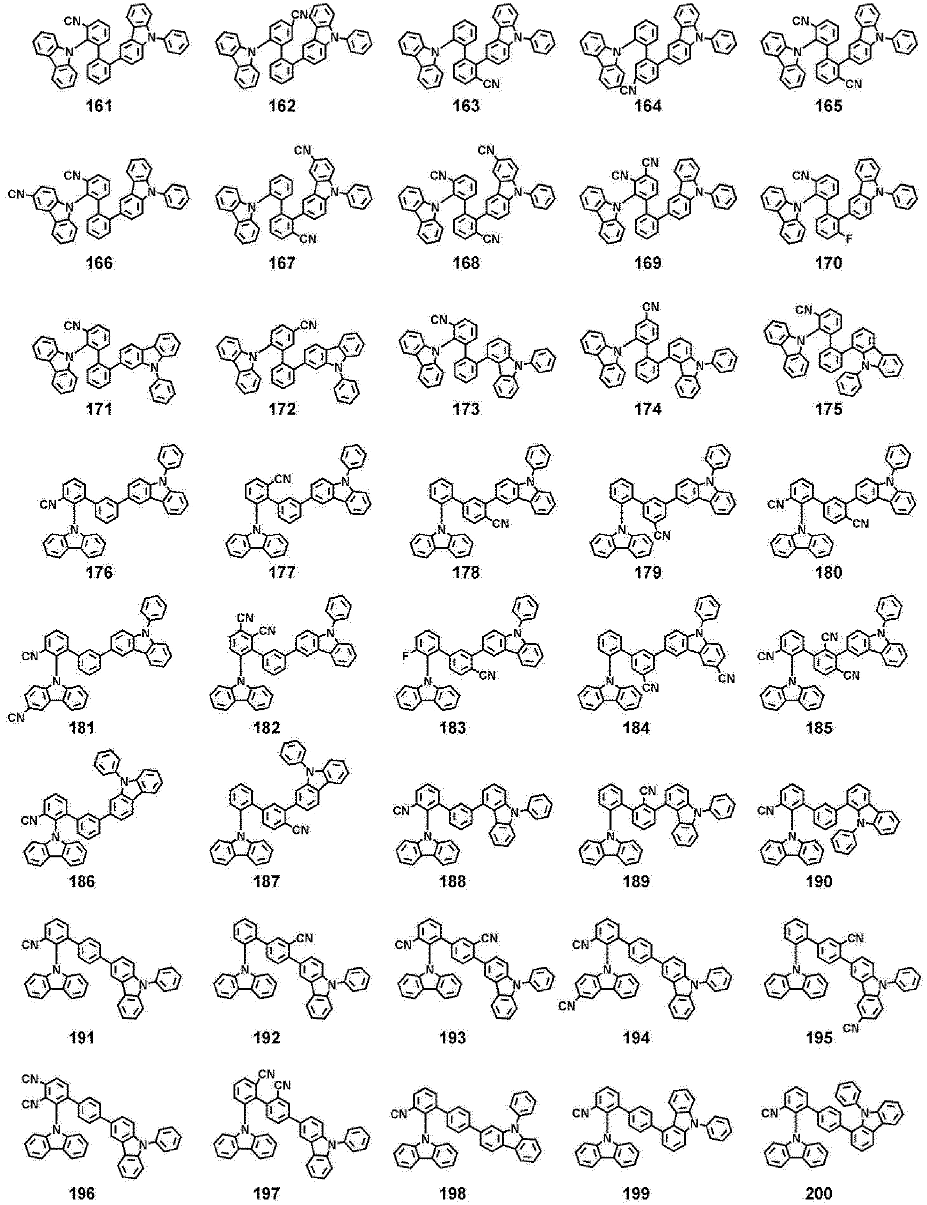

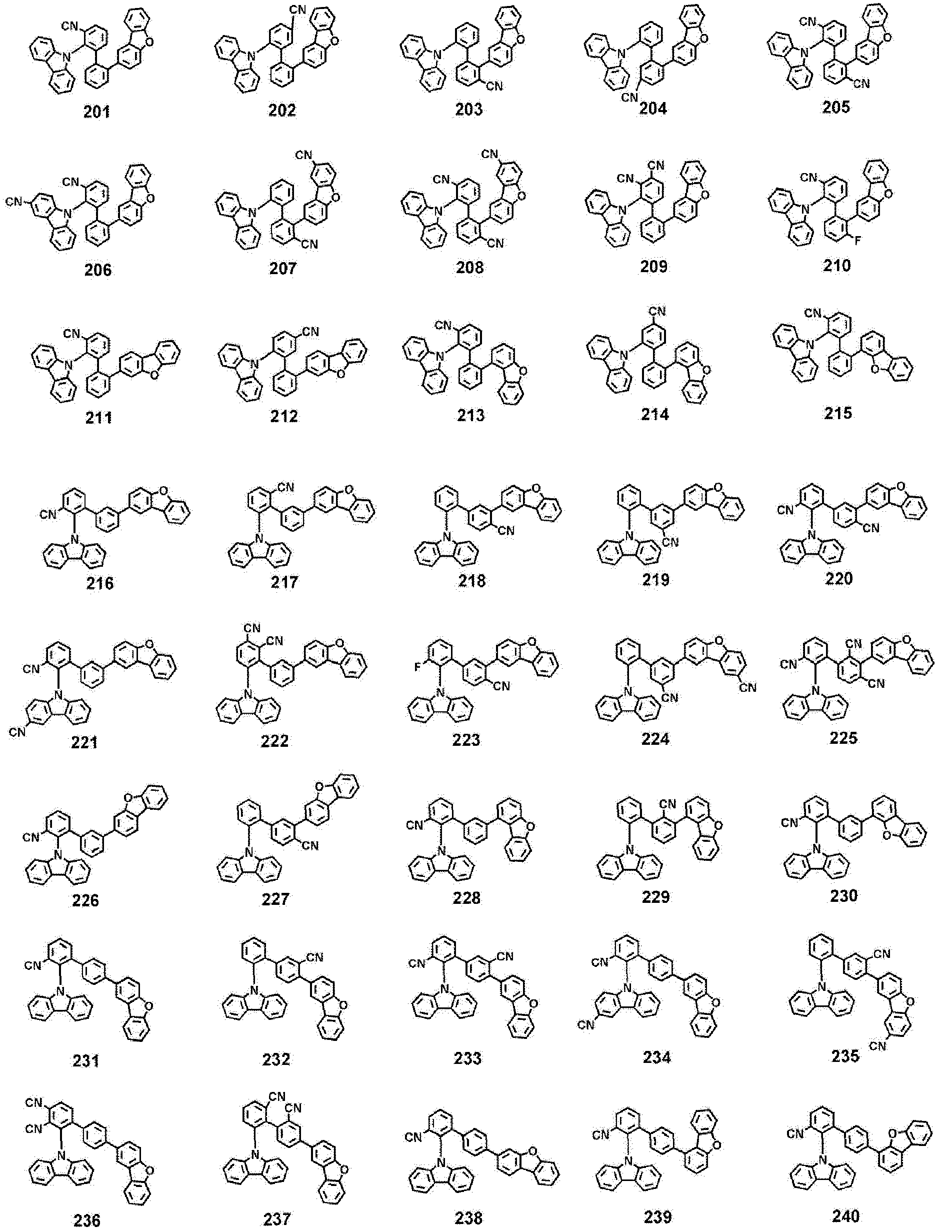

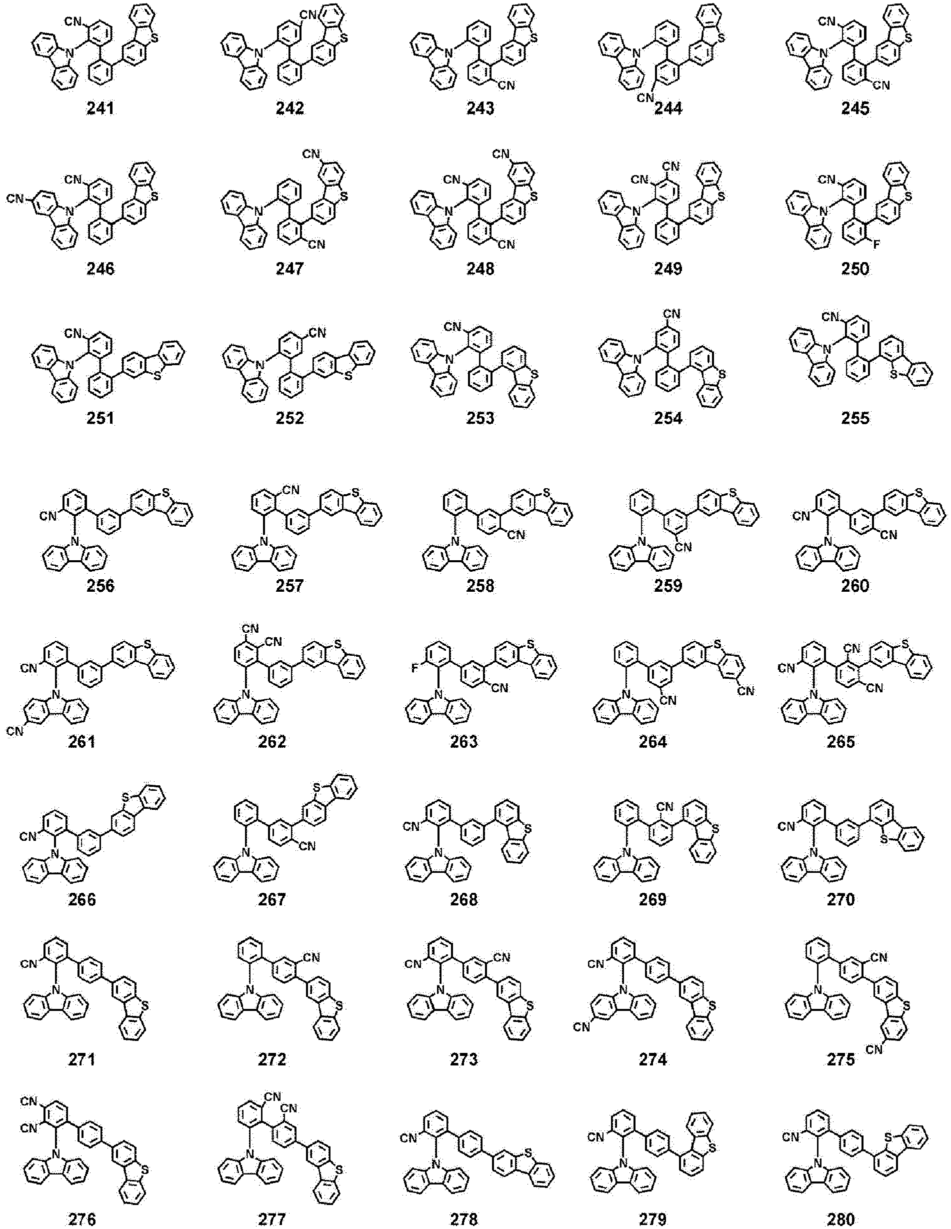

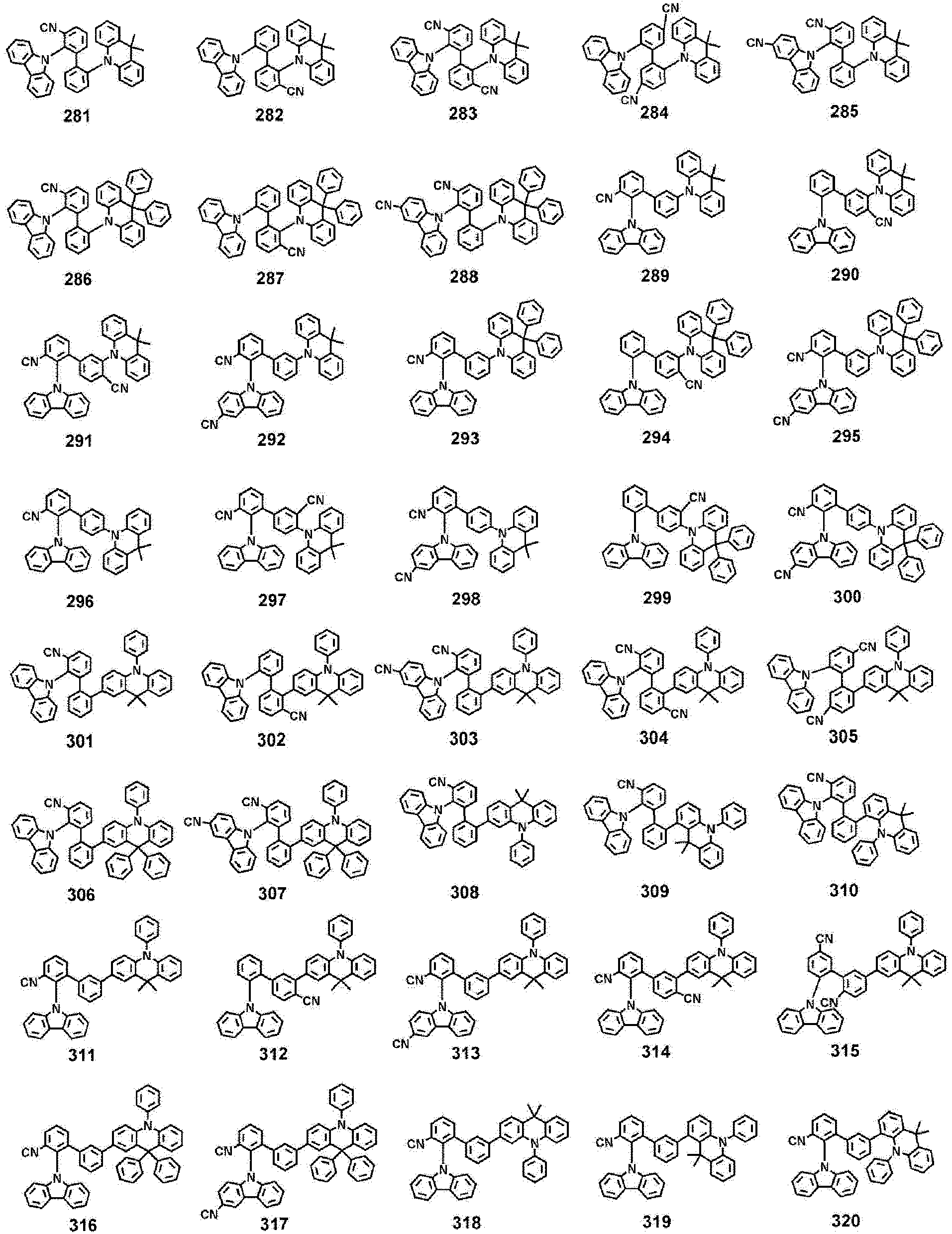

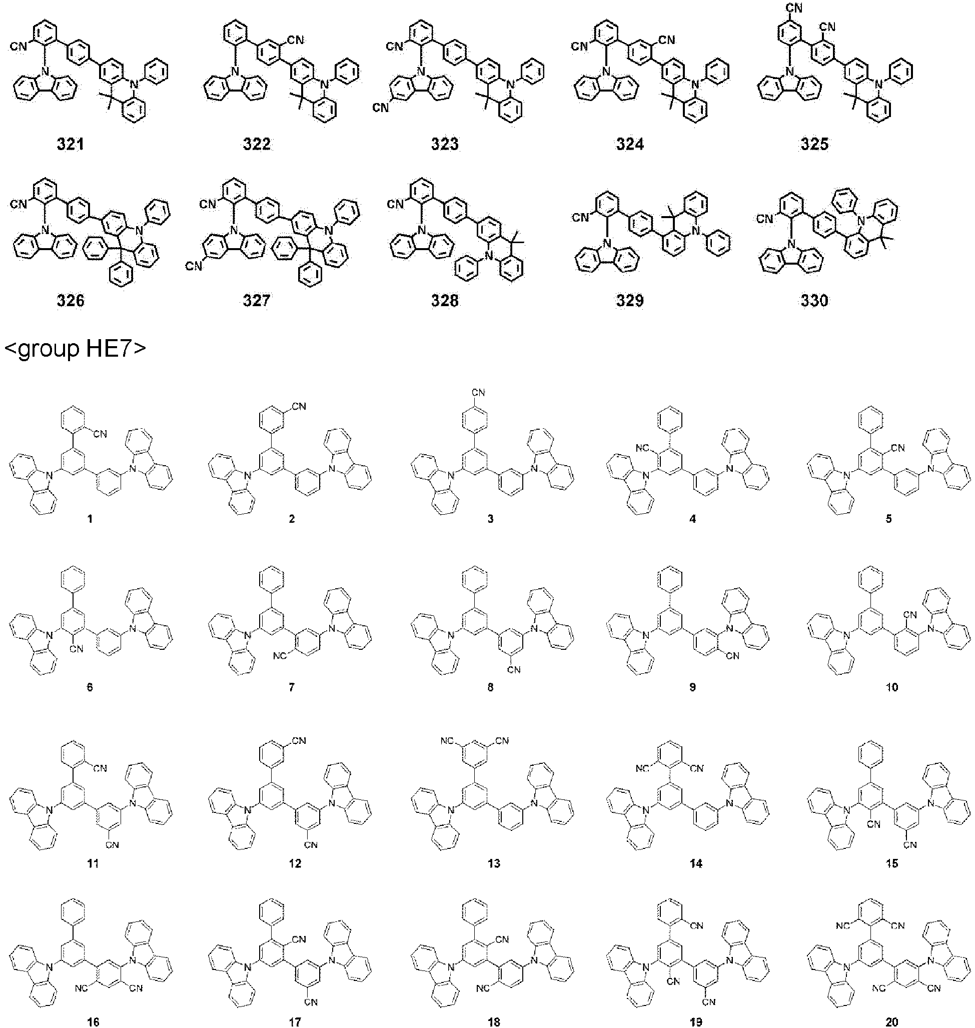

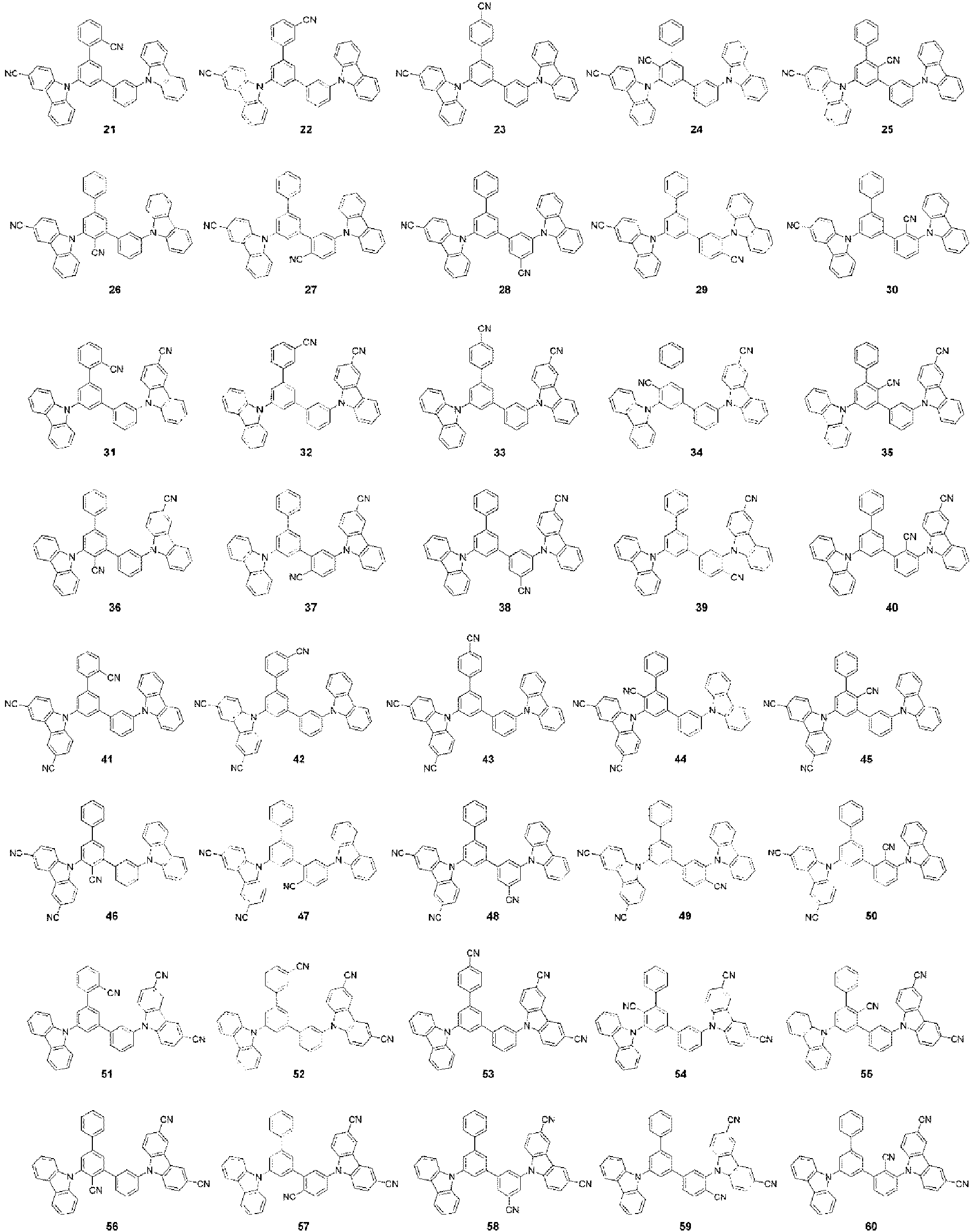

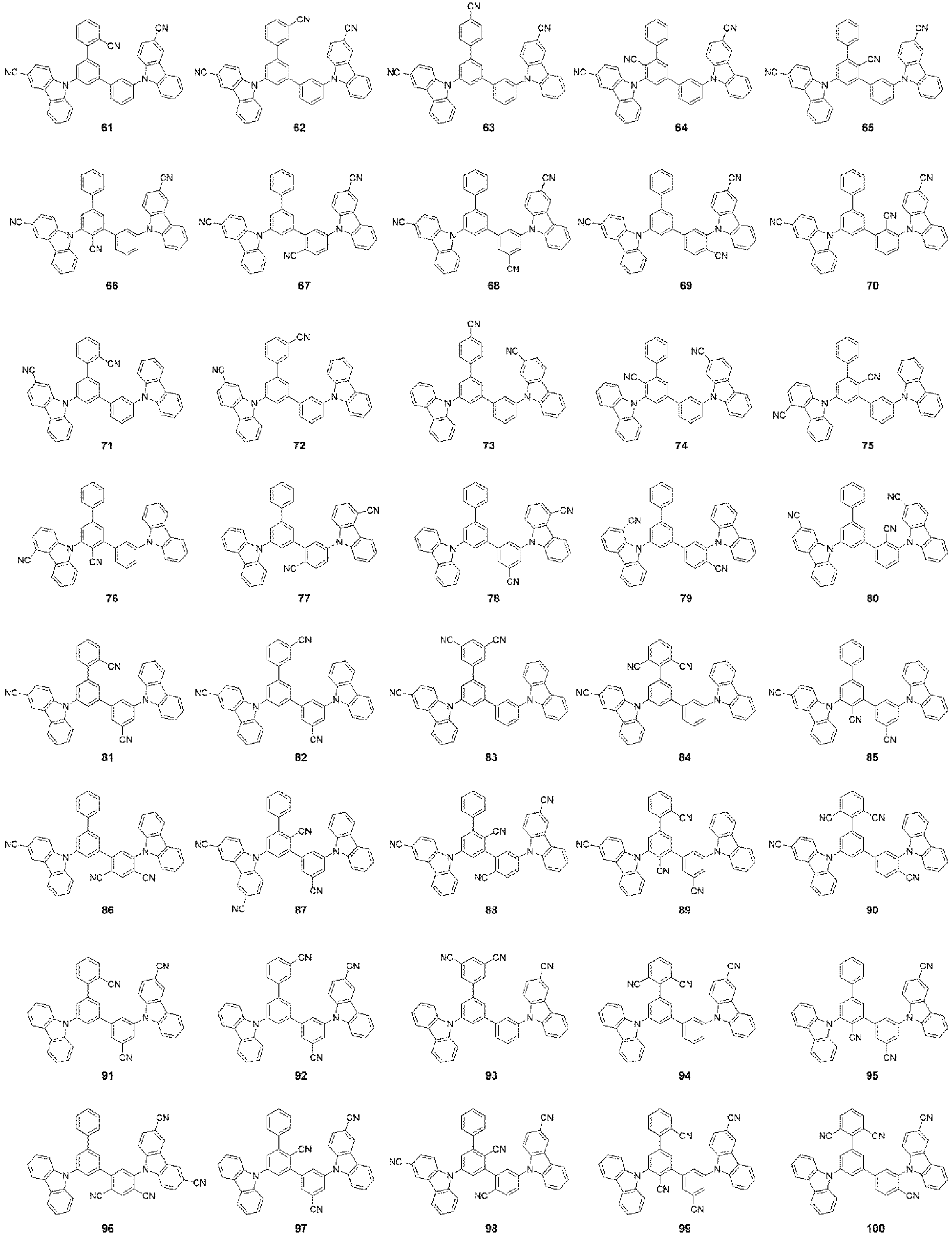

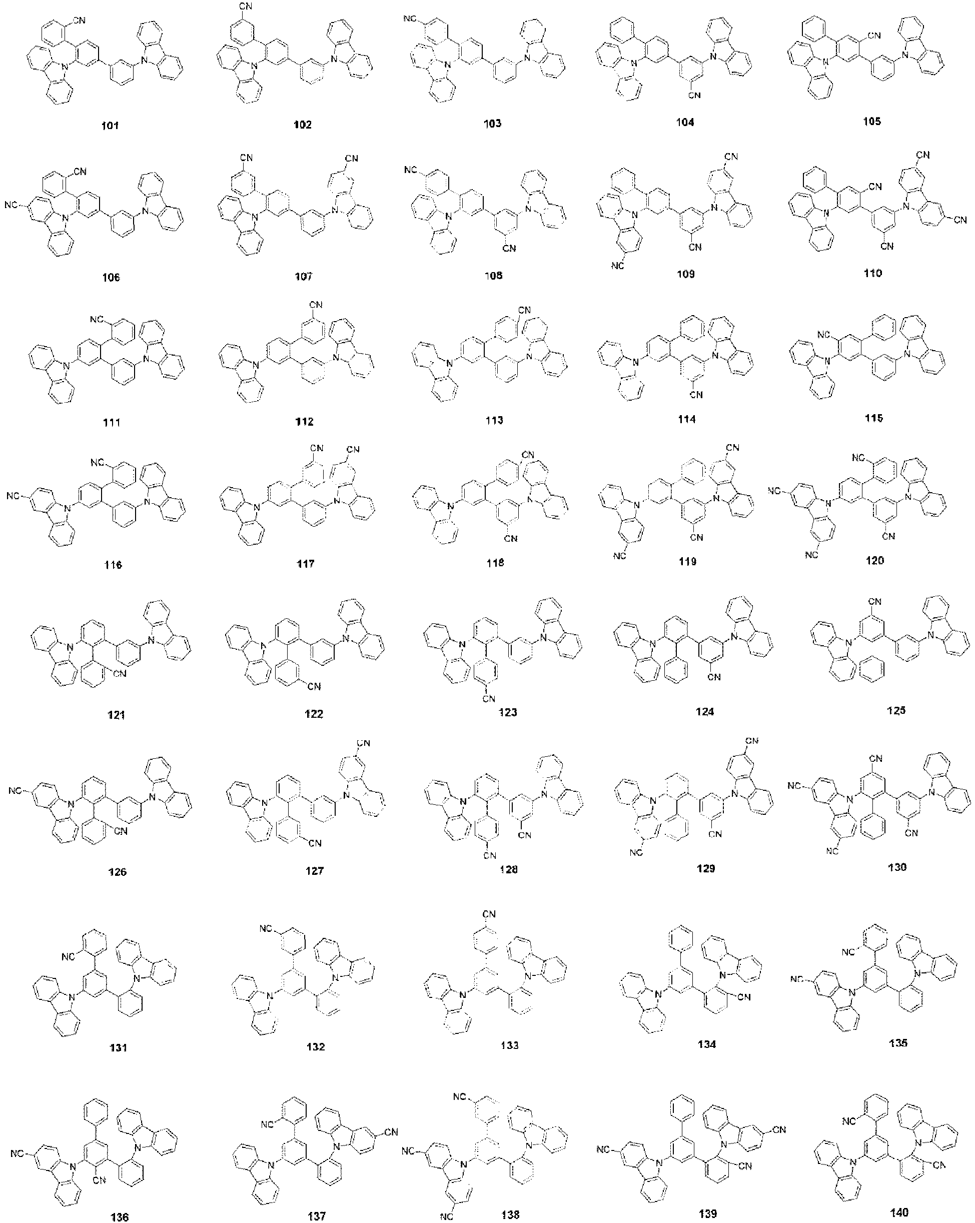

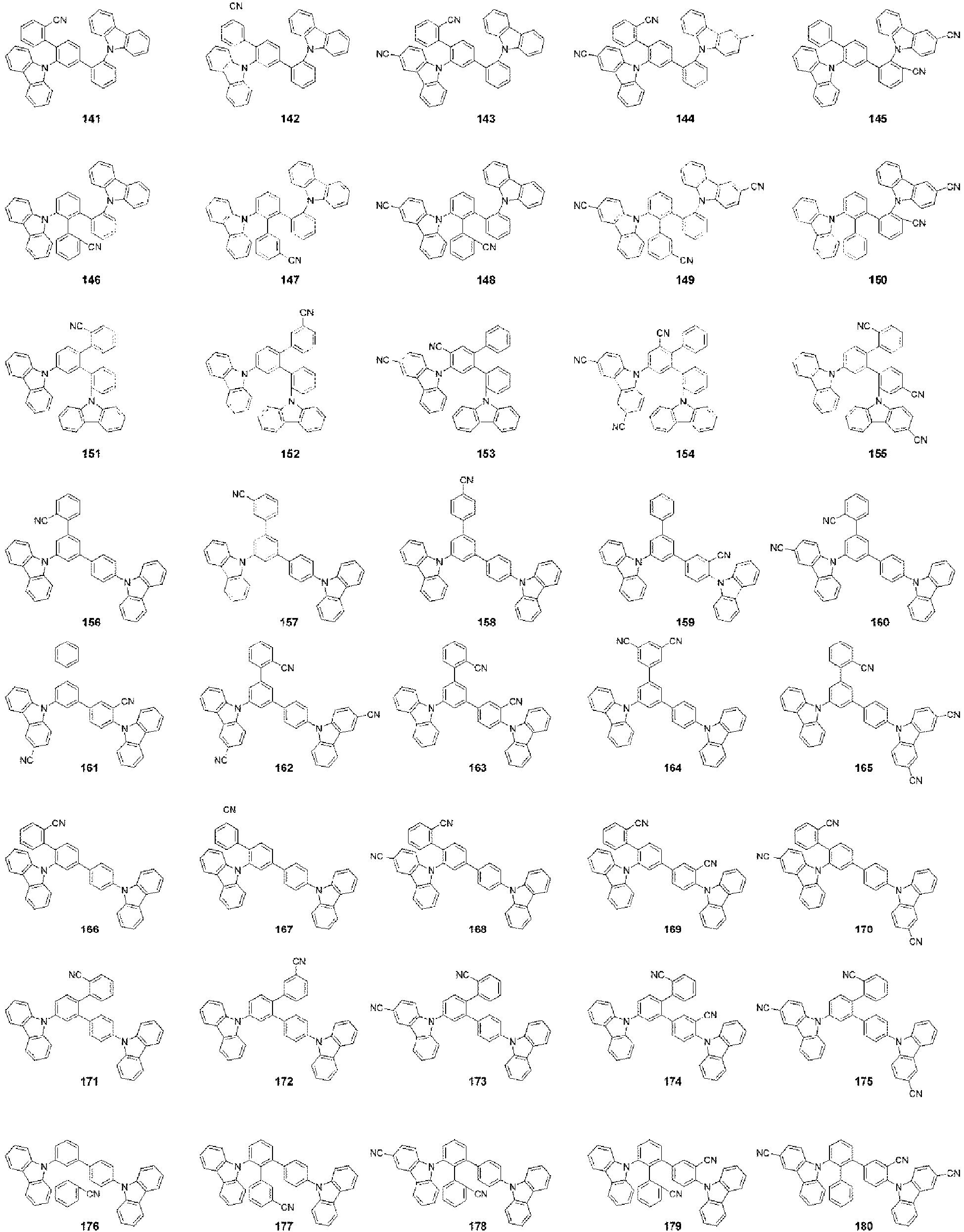

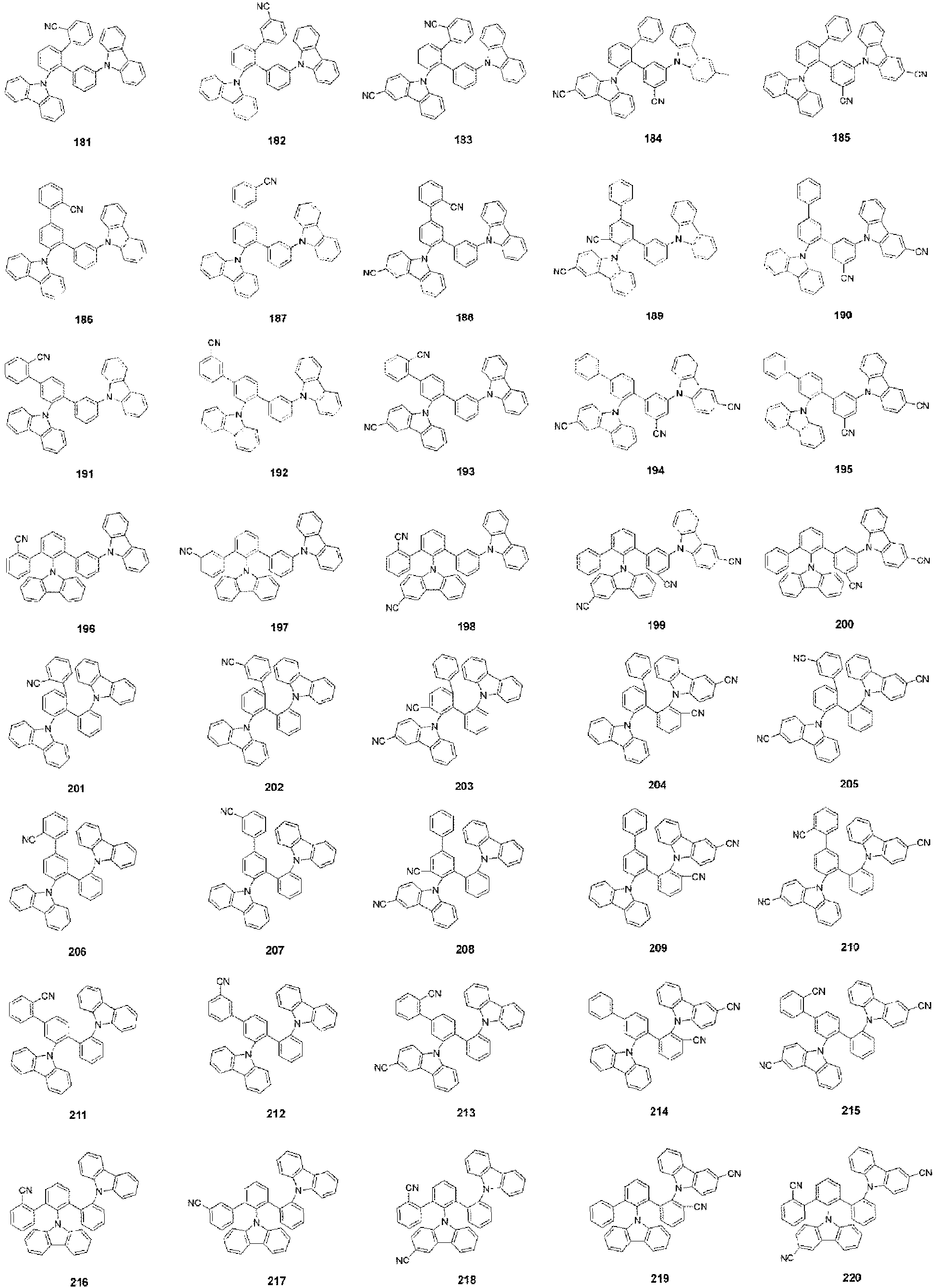

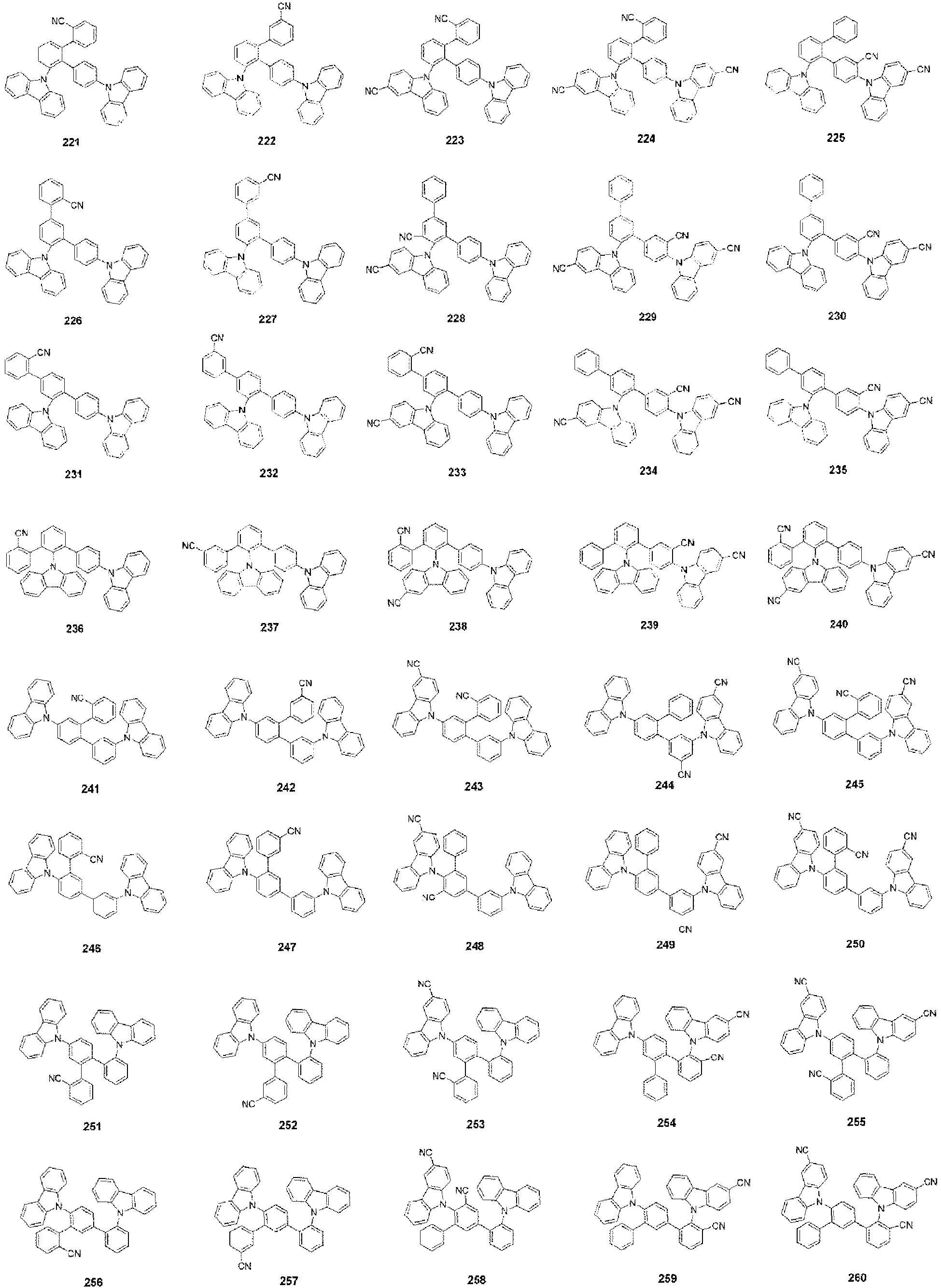

In one embodiment, the hole transport host may be selected from Compounds H-H1 to H-H103, but embodiments of the present disclosure are not limited thereto:

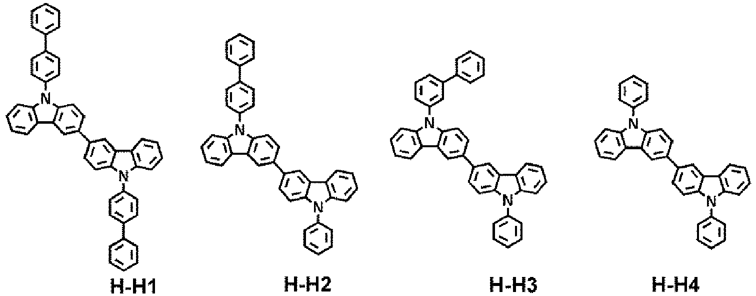

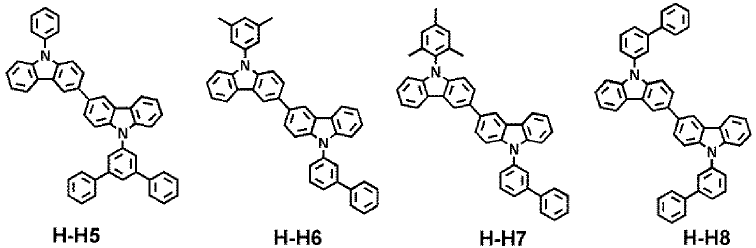

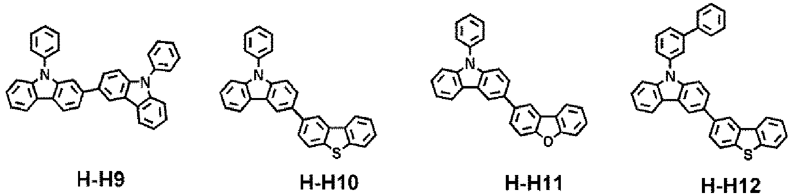

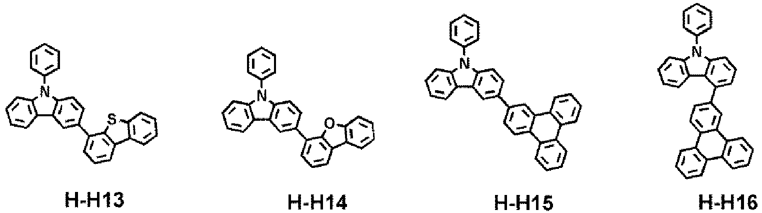

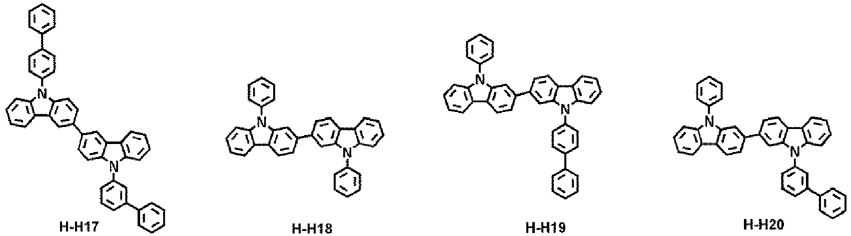

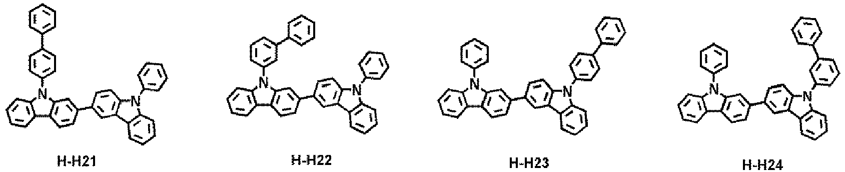

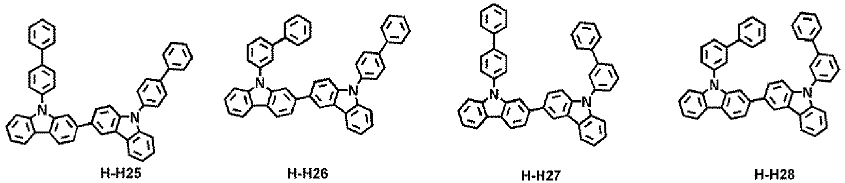

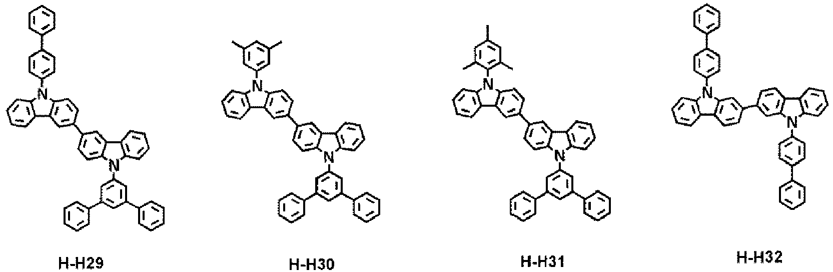

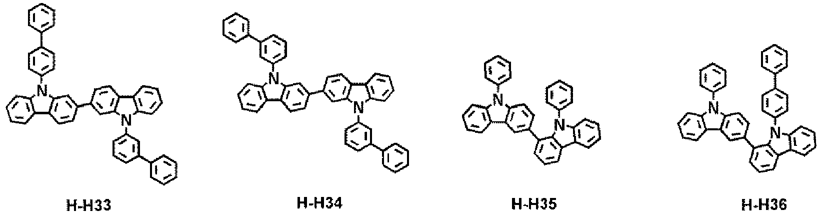

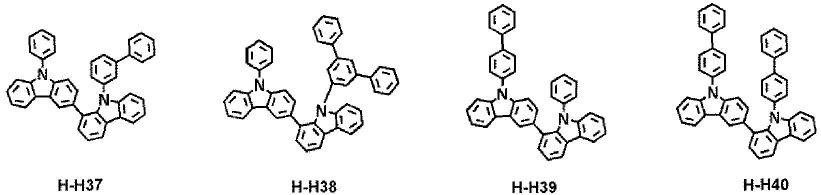

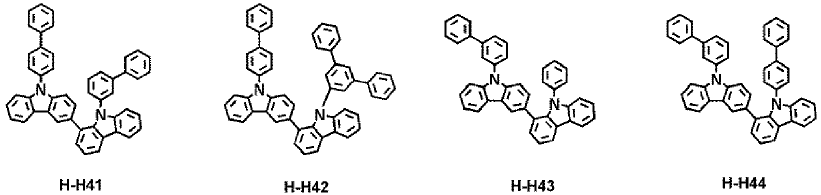

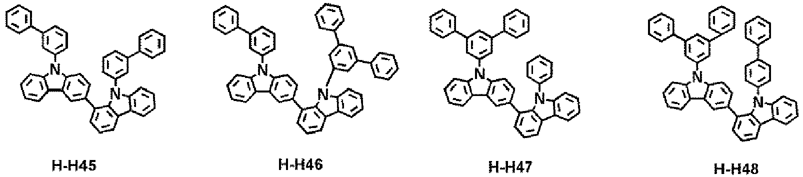

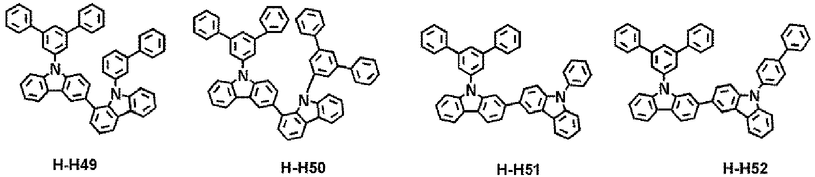

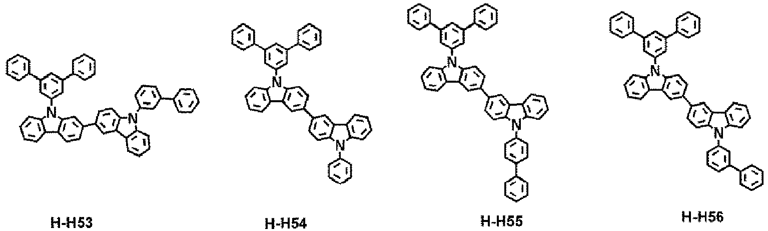

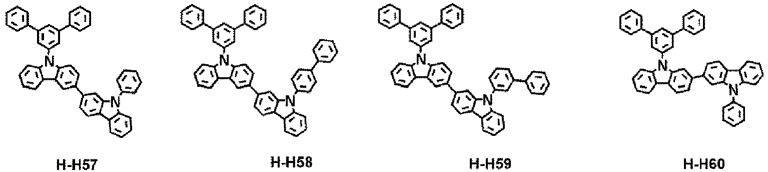

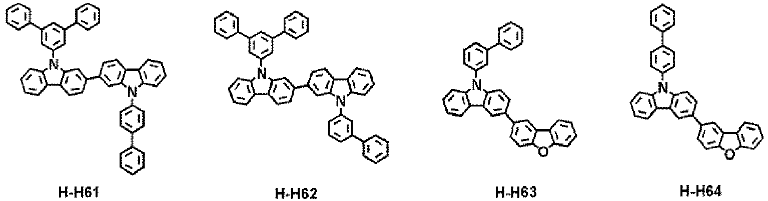

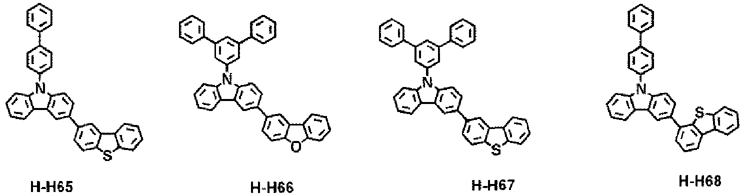

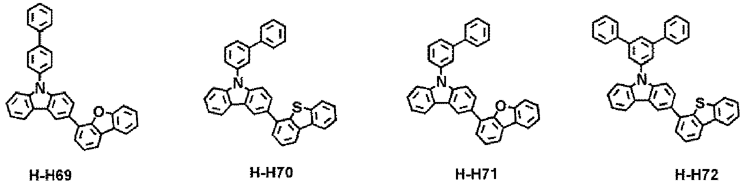

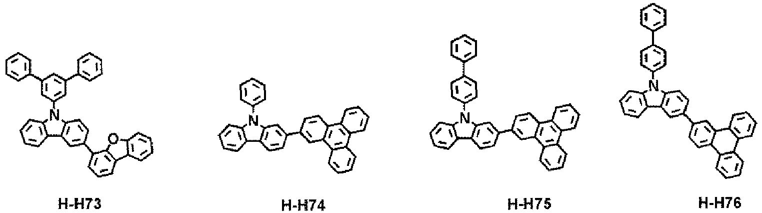

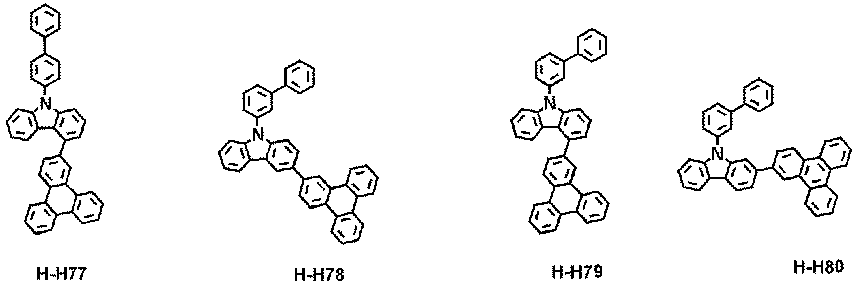

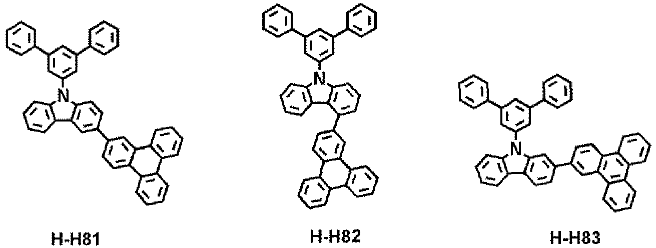

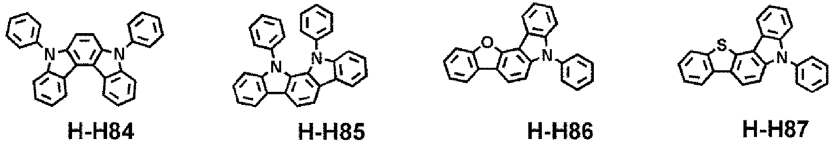

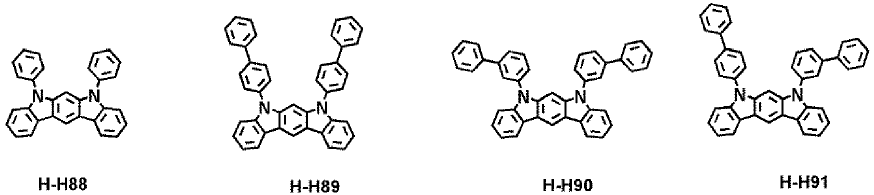

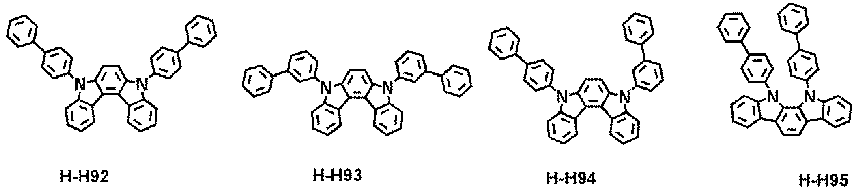

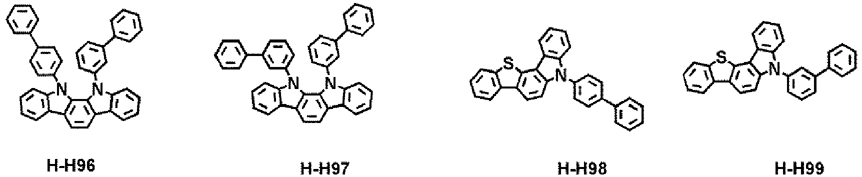

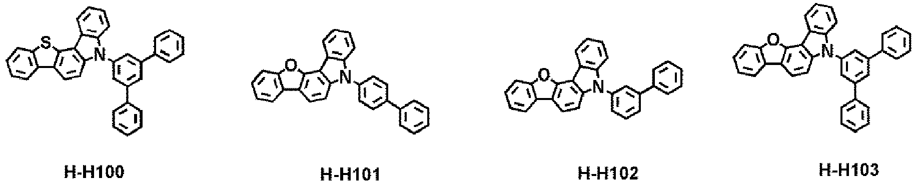

In one embodiment, the amphiprotic host may be selected from group HEH1, but embodiments of the present disclosure are not limited thereto: 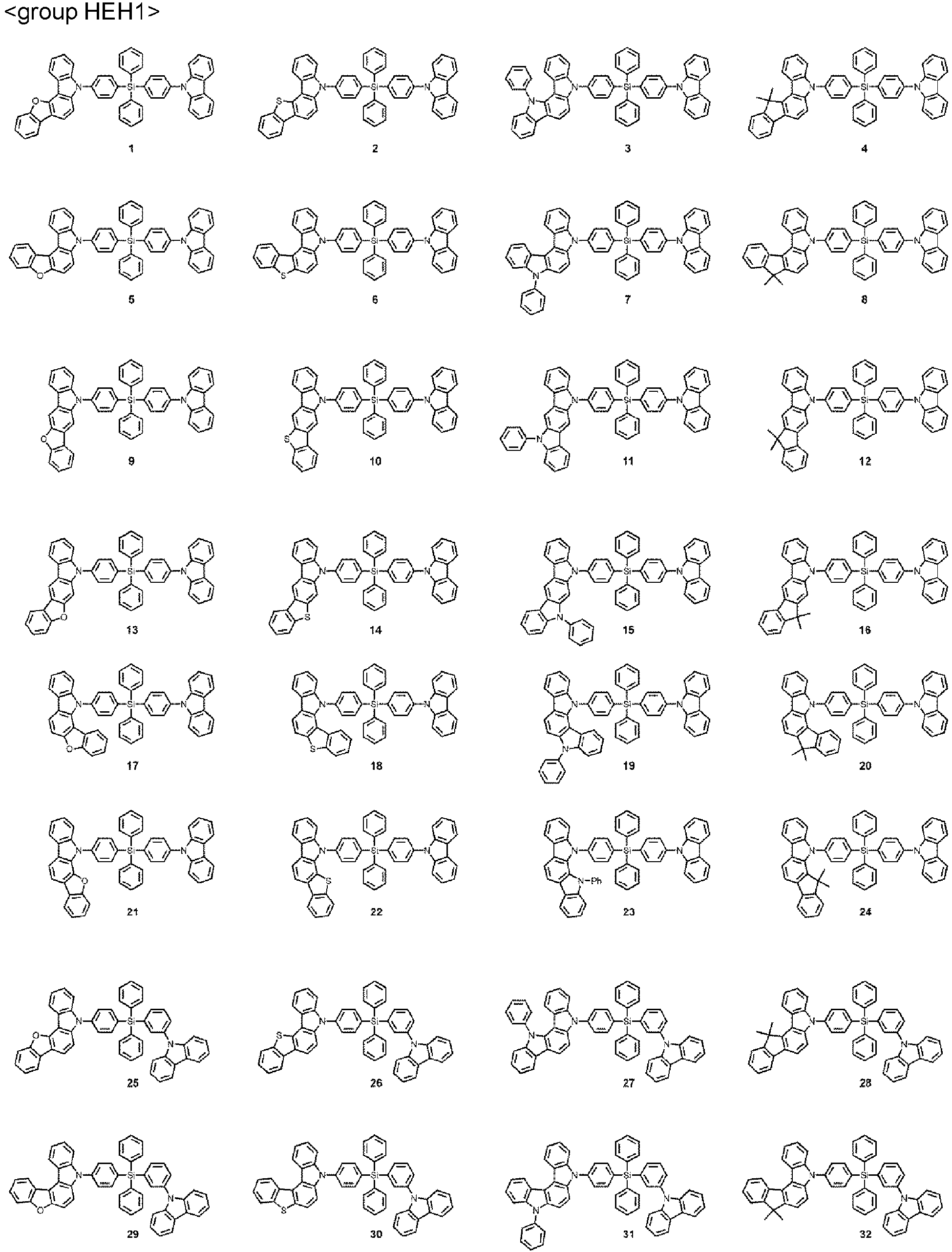 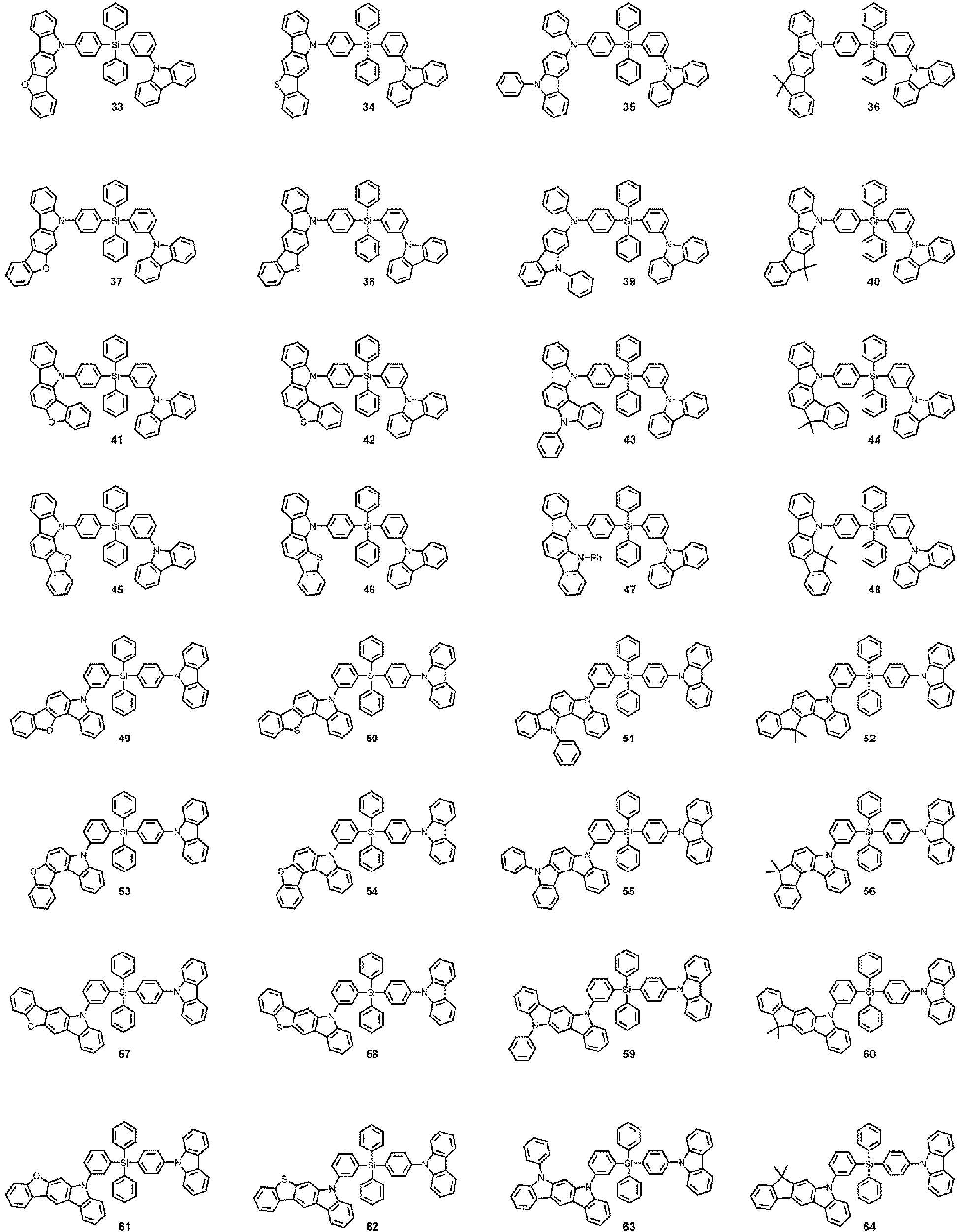 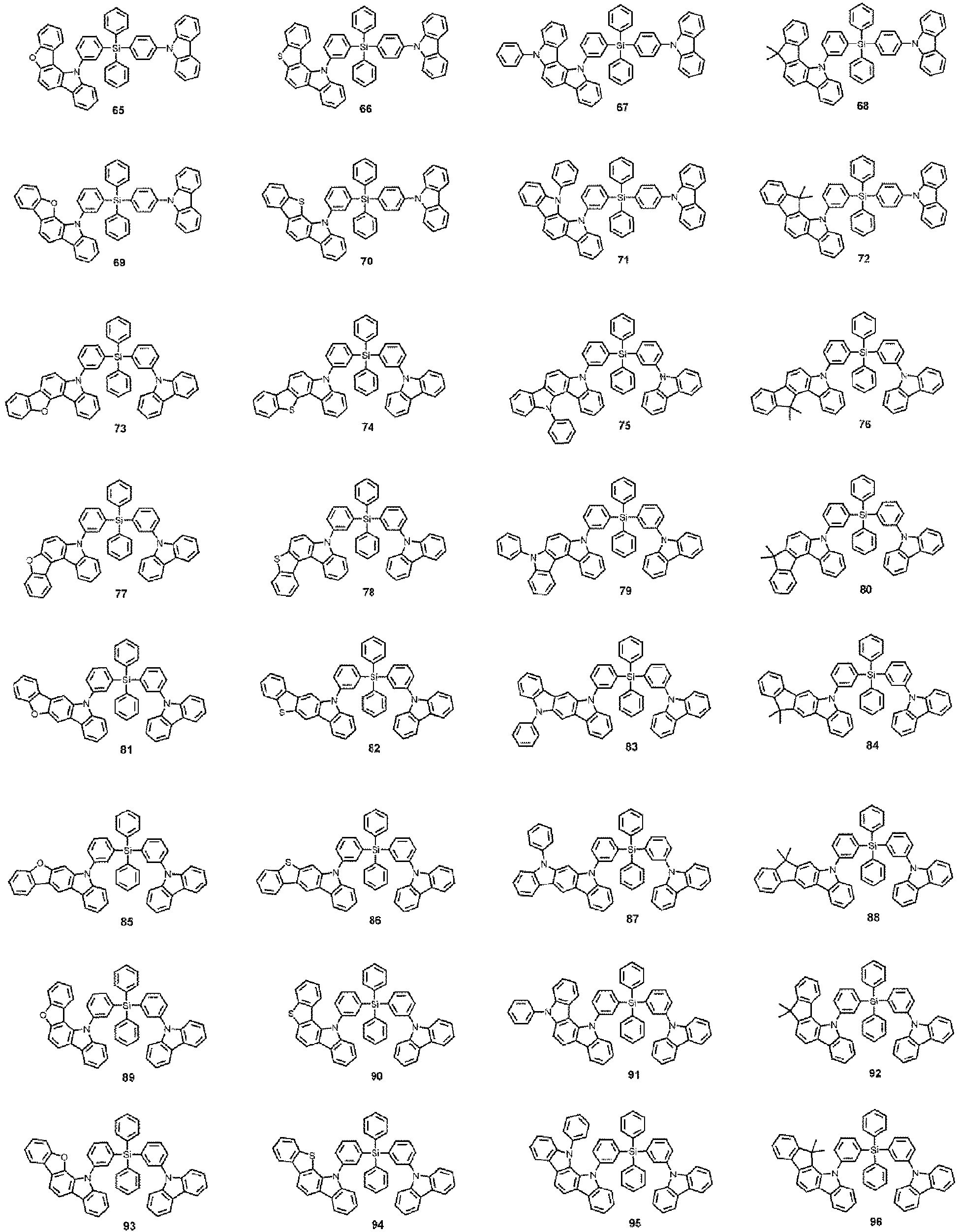 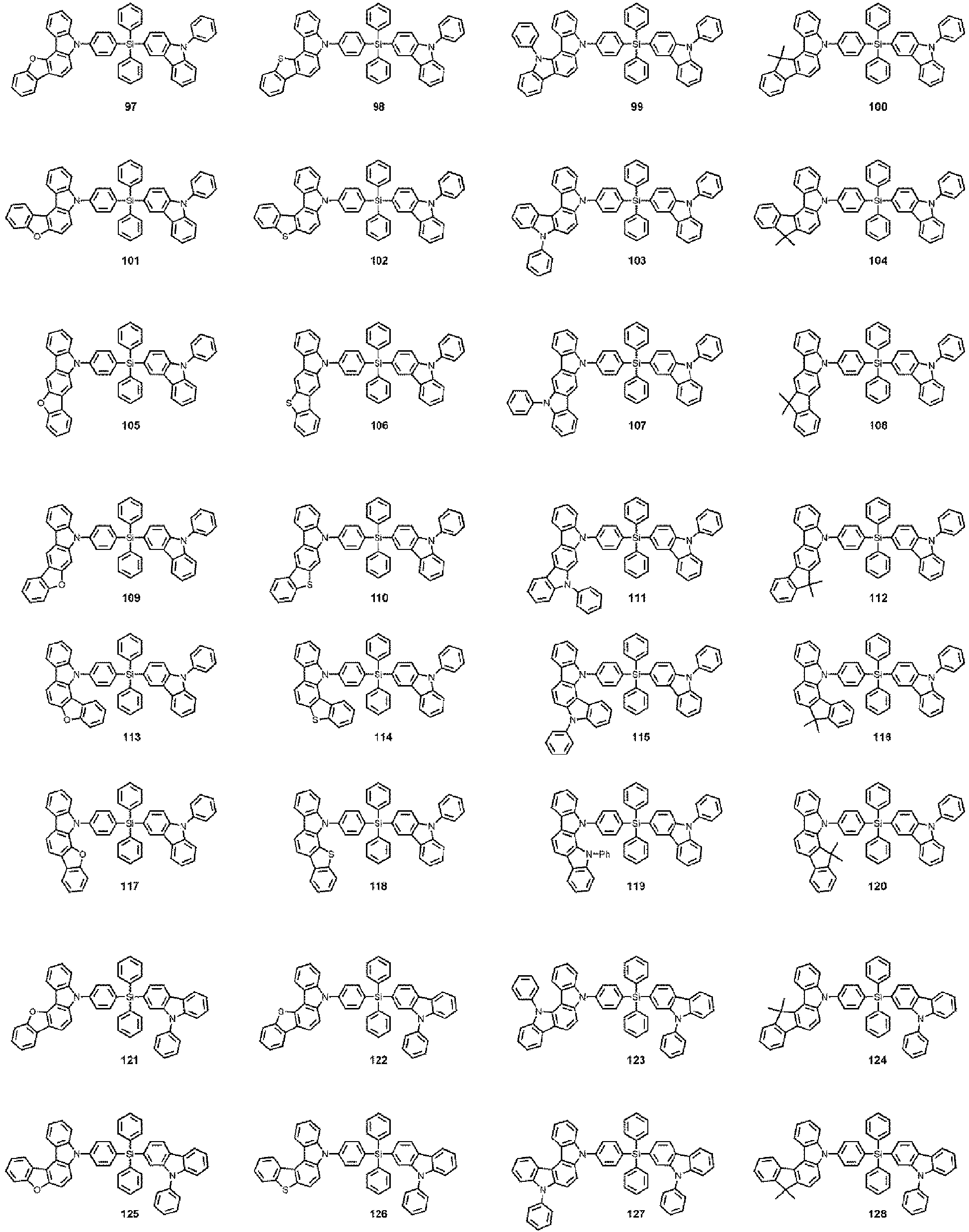 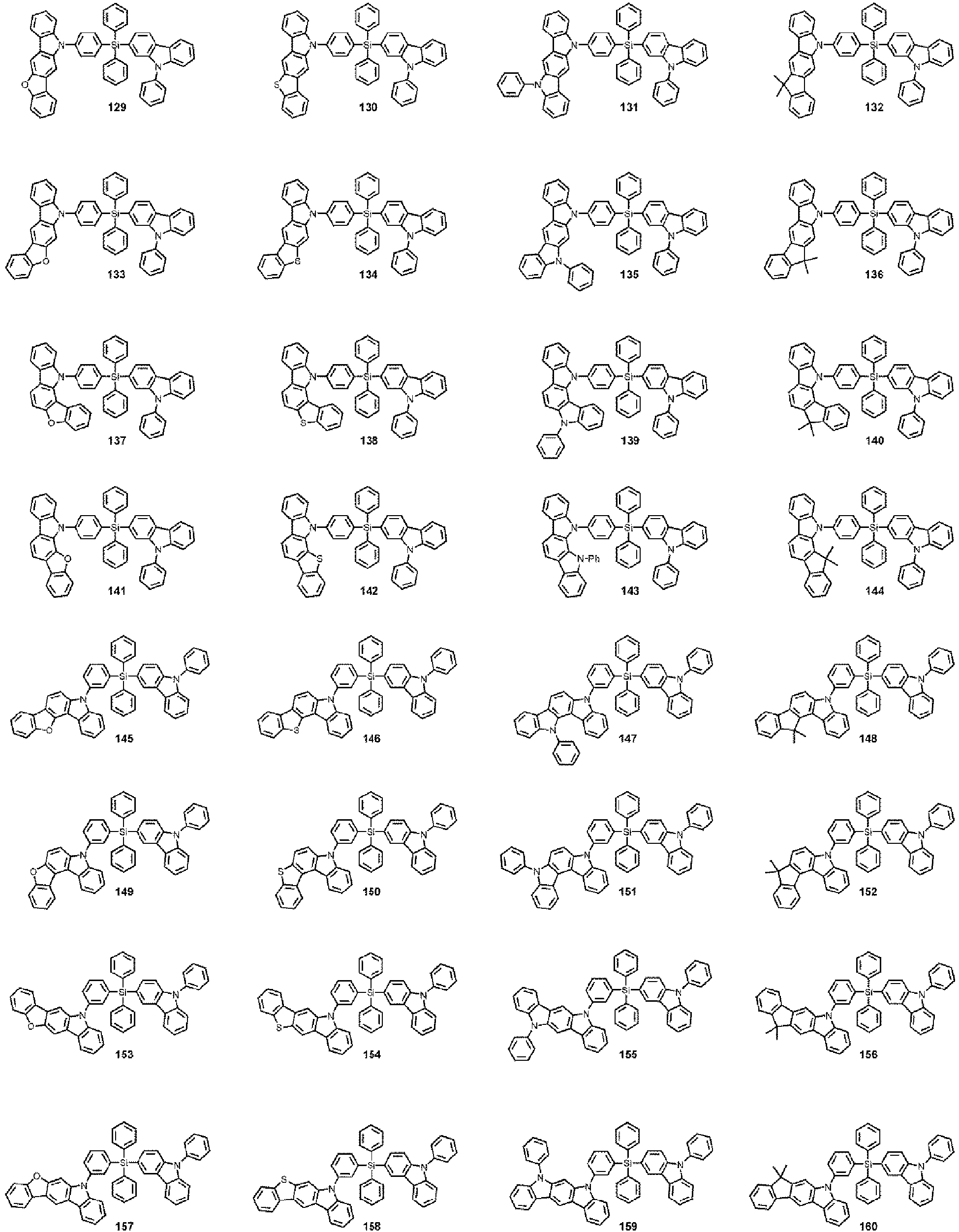 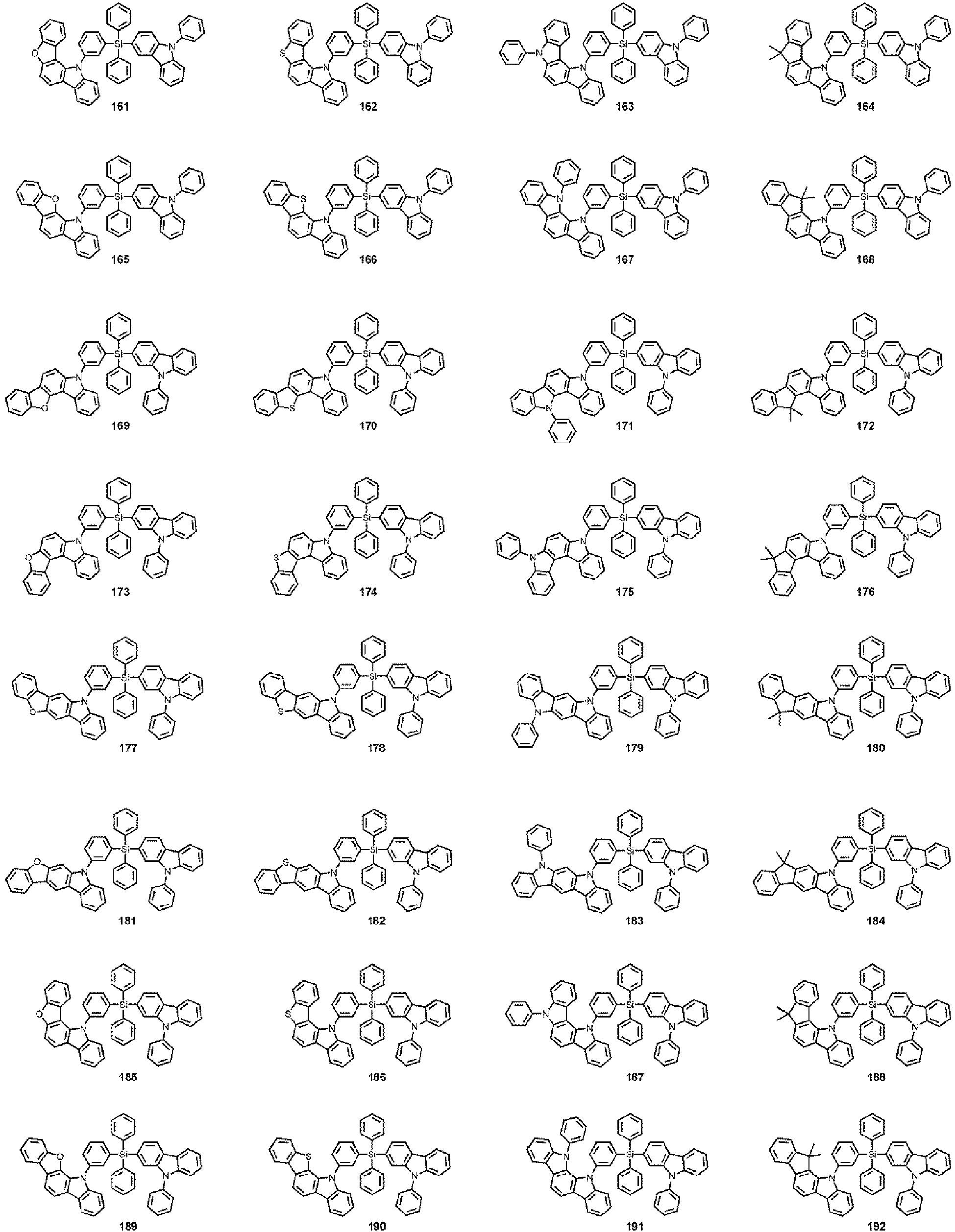 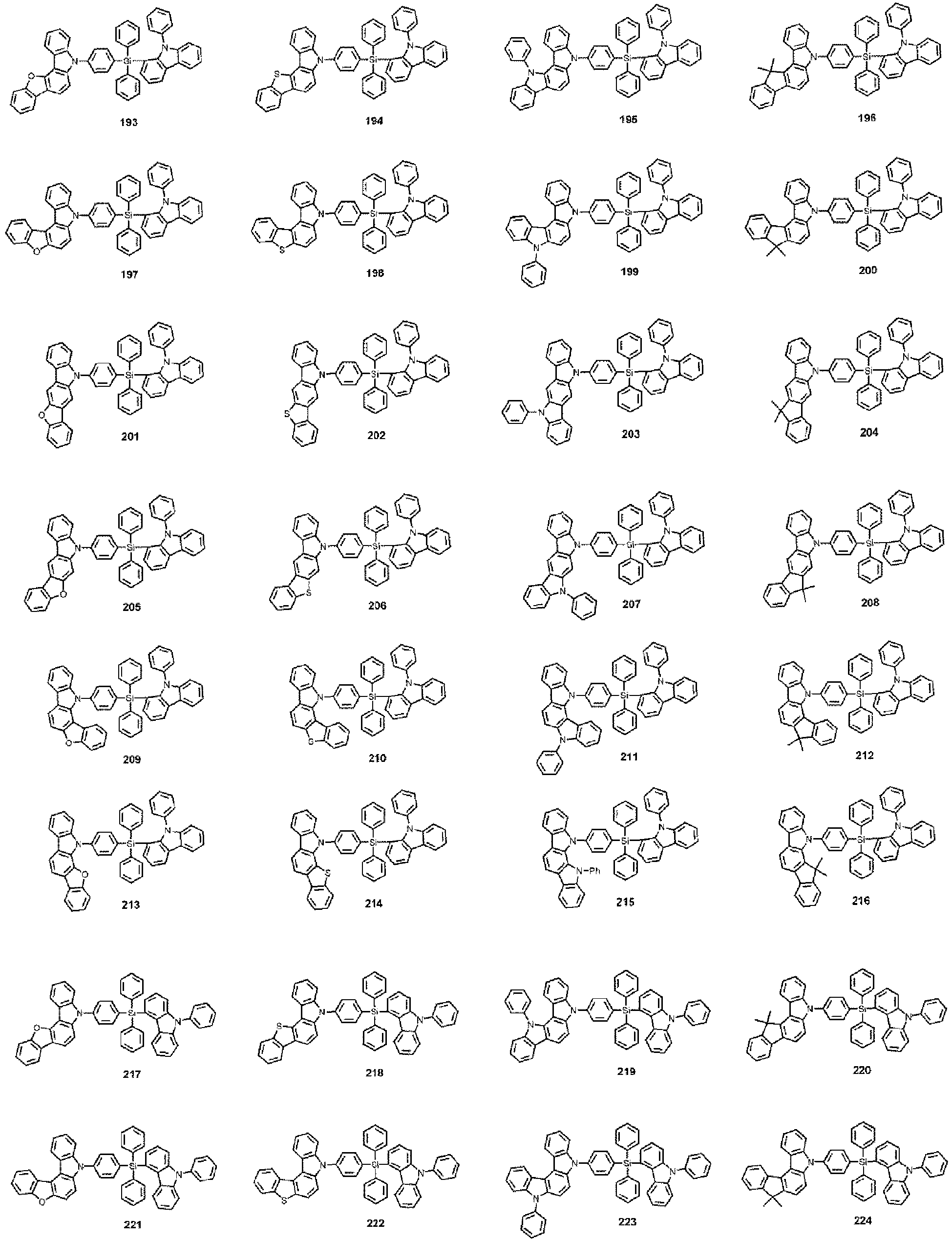 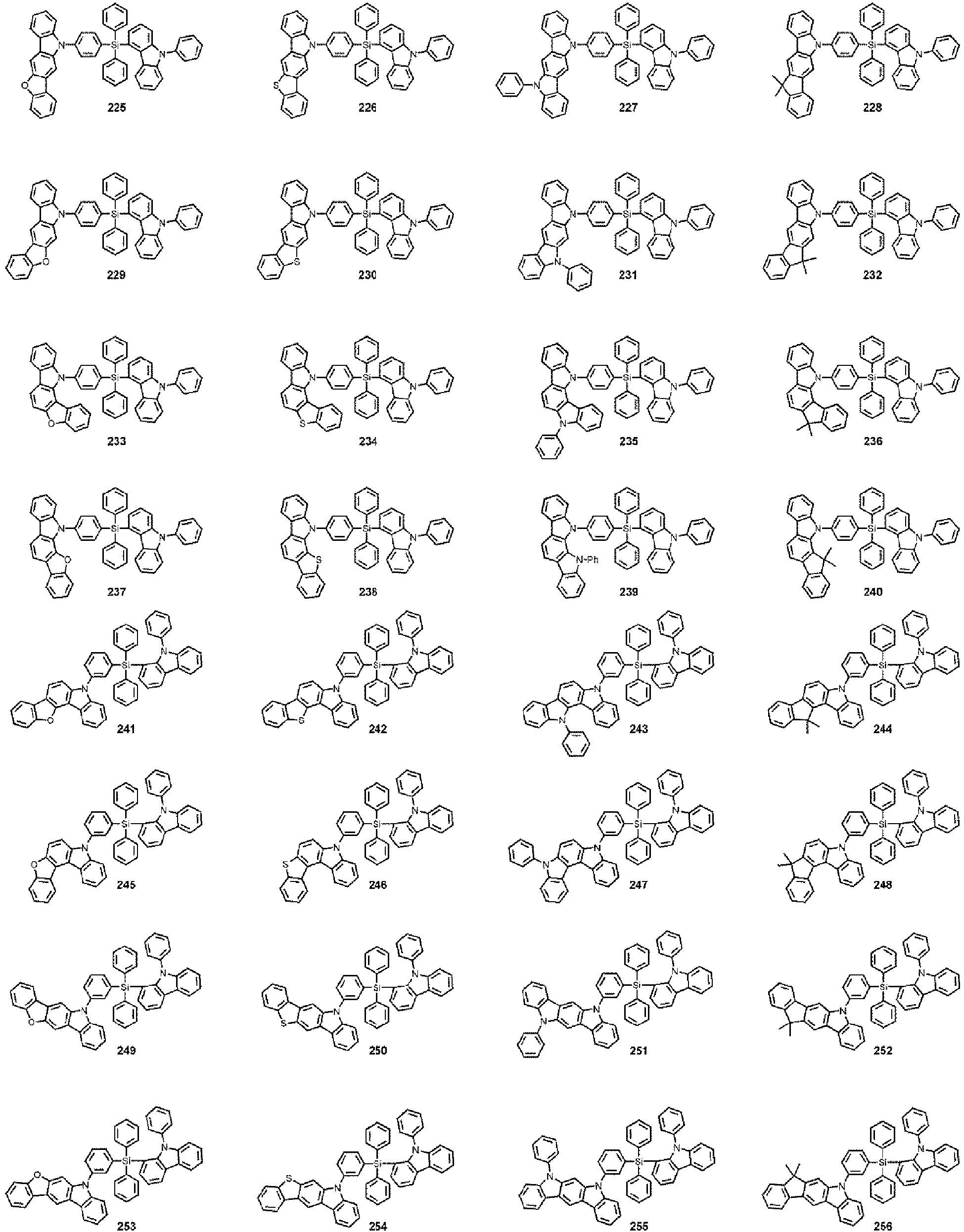 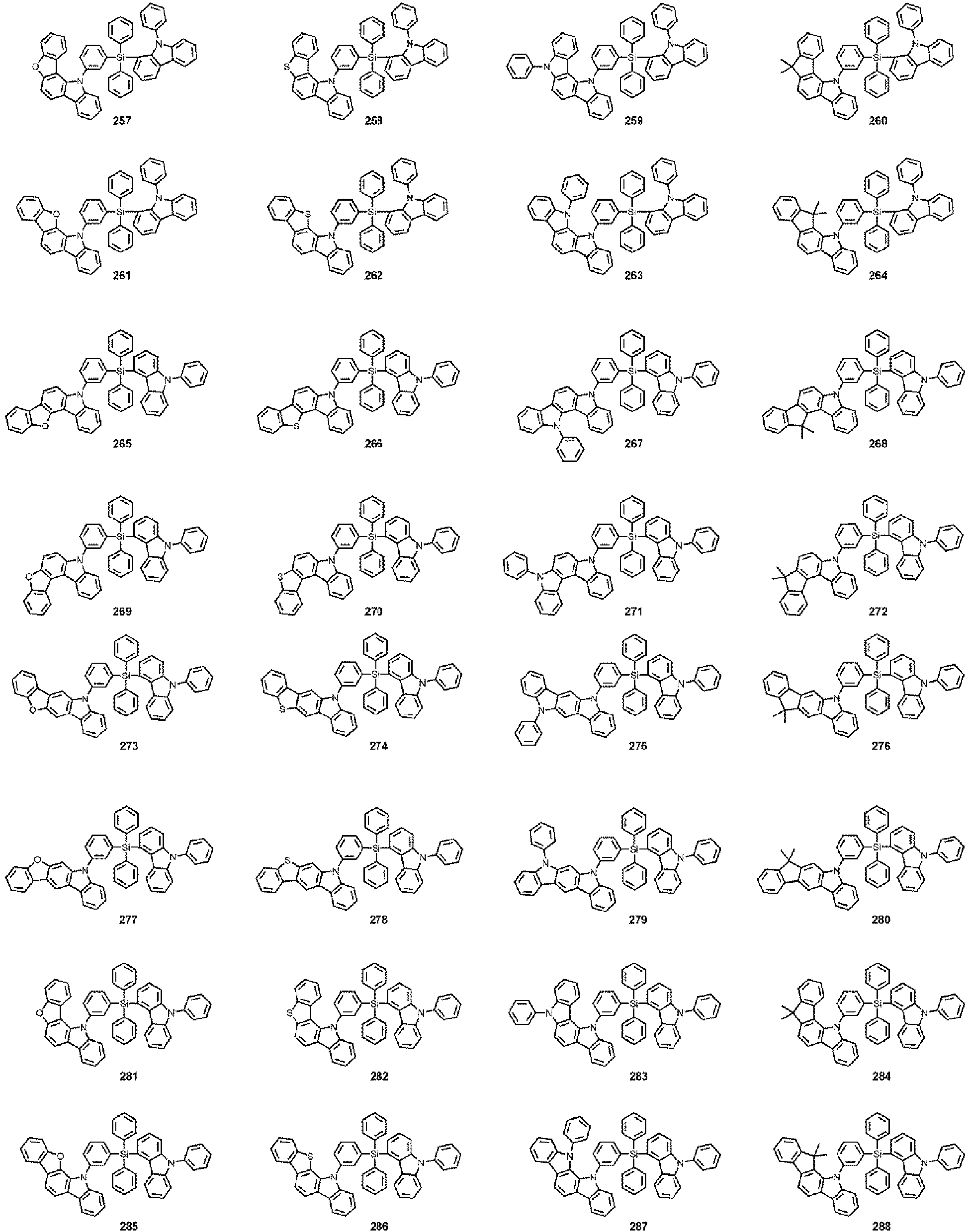 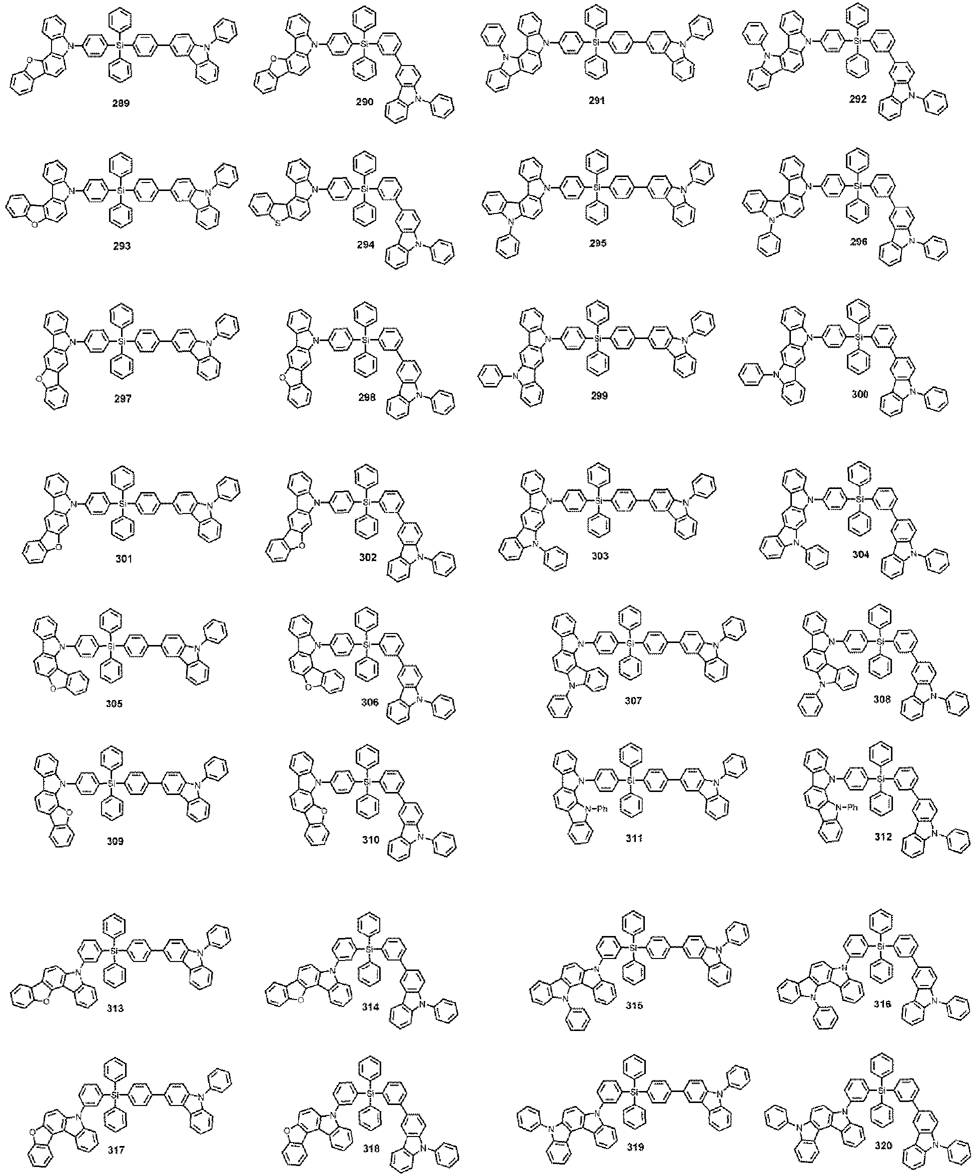 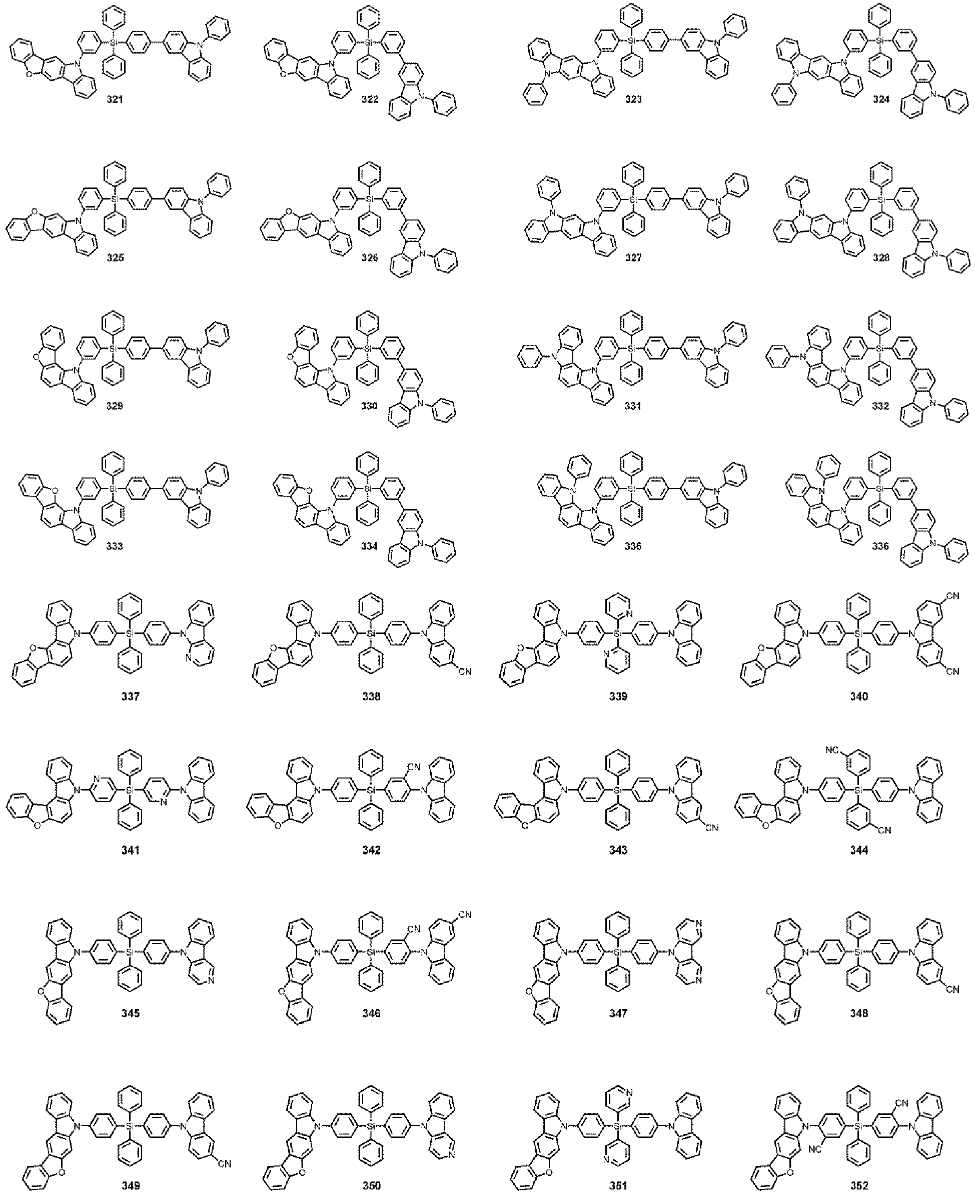 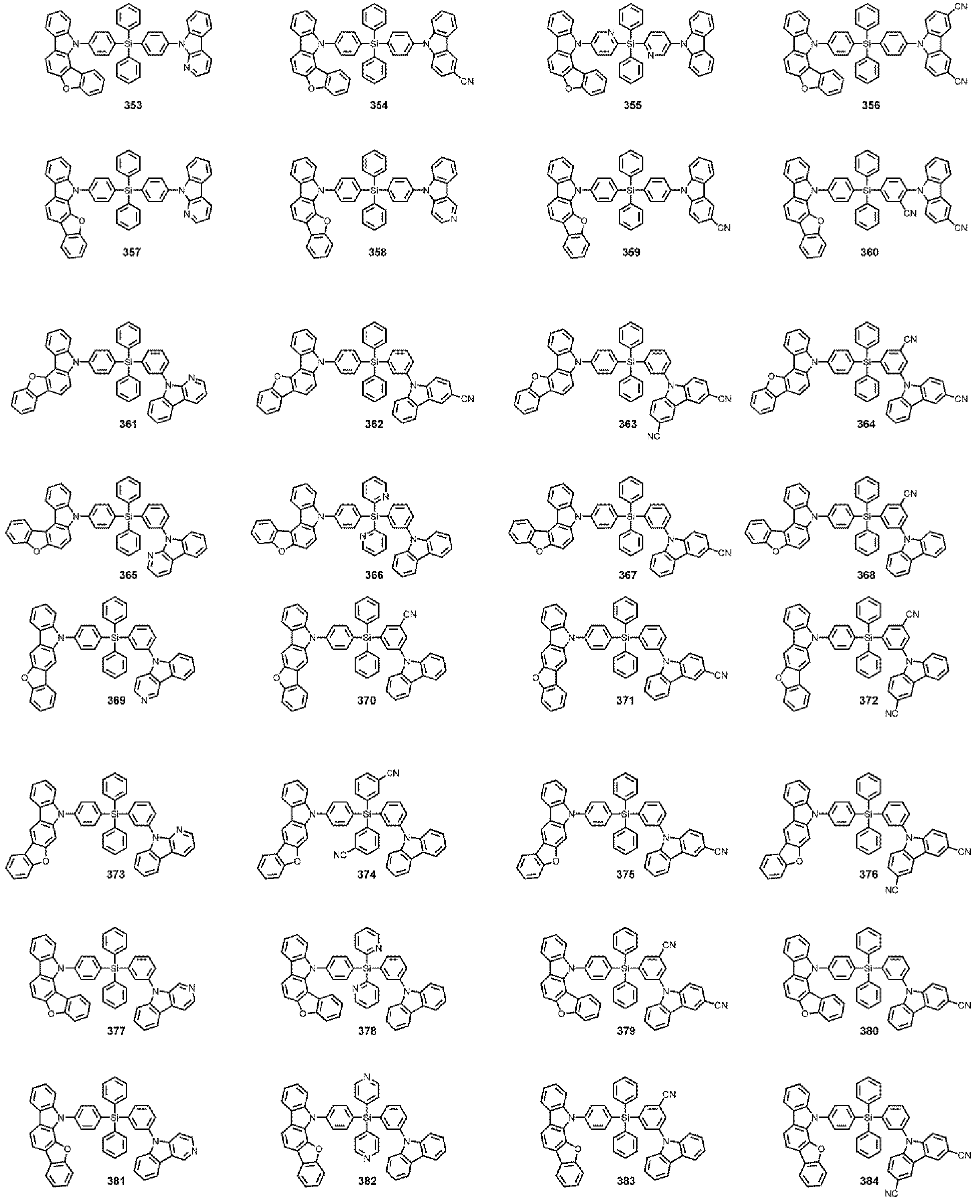 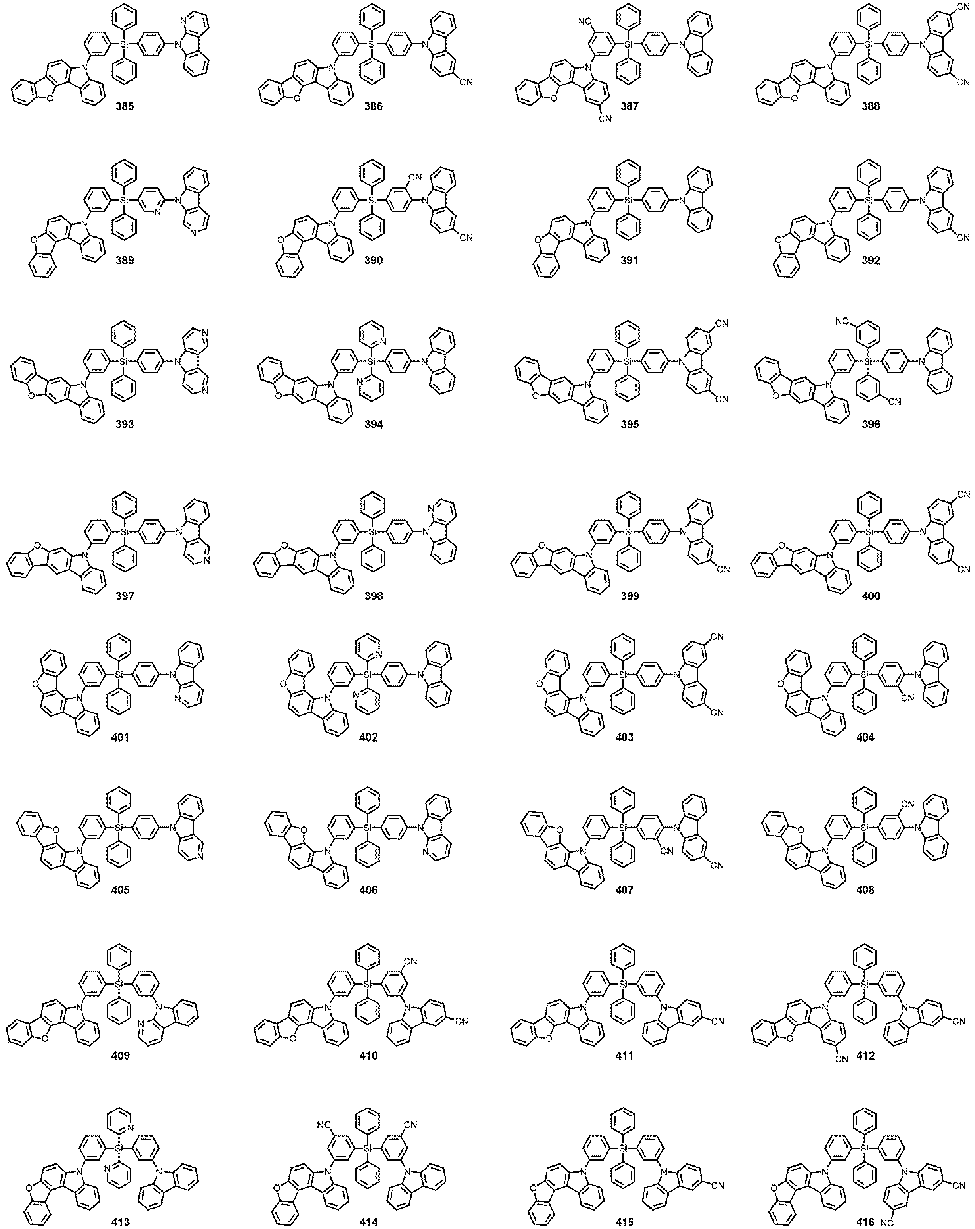 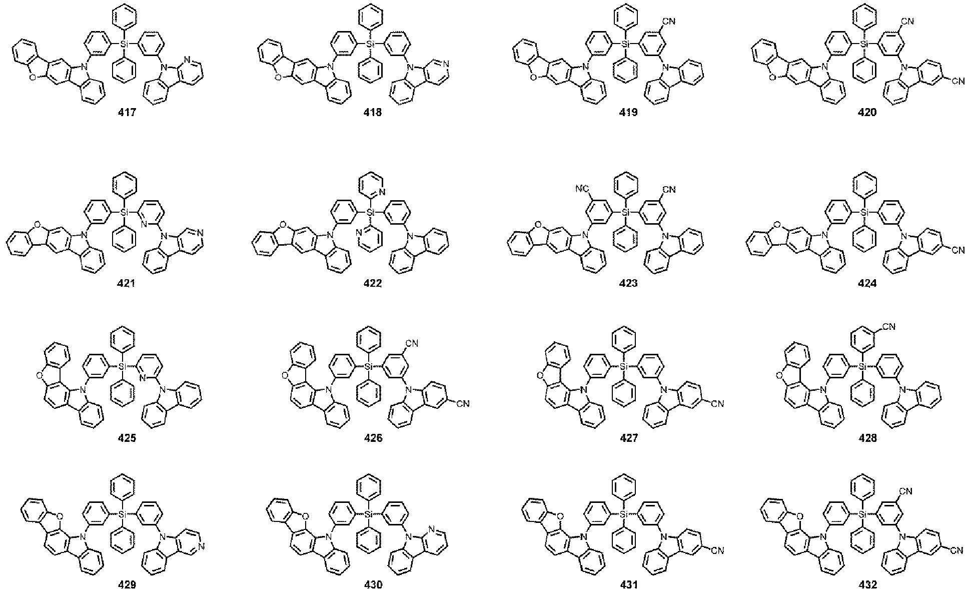 wherein, in Compounds 1 to 432,

Ph may be a phenyl group.

When the host is a mixture of an electron transport host and a hole transport host, the weight ratio of the electron transport host and hole transport host may be 1: 9 to 9: 1, for example, 2: 8 to 8: 2, for example, 4: 6 to 6: 4, for example, 5: 5. When the weight ratio of the electron transport host and the hole transport host satisfies the above-described ranges, the hole-and-electron transport balance in the emission layer 15 may be made.

### [Cooling dopant in emission layer 15]

Since the cooling dopant emits fluorescent light, organic light-emitting devices according to an embodiment of the present disclosure are clearly distinguished from organic light-emitting devices containing compounds that emit phosphorescent light.

The cooling dopant satisfies Condition 2, as described above.

The maximum emission wavelength of the emission spectrum of the cooling dopant may be 400 nm or more and 550 nm or less. For example, the maximum emission wavelength of the emission spectrum of the cooling dopant may be 400 nm or more and 495 nm or less, or 450 nm or more and 495 nm or less, but embodiments of the present disclosure are not limited thereto. In other words, the cooling dopant may emit blue light. The "maximum emission wavelength" refers to a wavelength at which the emission intensity is the greatest, and may also be referred to as "a peak emission wavelength".

In an embodiment, the cooling dopant may not include metal atoms.

In an embodiment, the cooling dopant may be selected from a condensed polycyclic compound and a styryl-based compound.

For example, the cooling dopant may include one of a naphthalene-containing core, a fluorene-containing core, a spiro-bifluorene-containing core, a benzofluorene-containing core, a dibenzofluorene-containing core, a phenanthrene-containing core, an anthracene-containing core, a fluoranthene-containing core, a triphenylene-containing core, a pyrene-containing core, a chrysene-containing core, a naphthacene-containing core, a picene-containing core, a perylene-containing core, a pentaphene-containing core, an indenoanthracene-containing core, a bisanthracene-containing core, and cores represented by Formulae 501-1 to 501-18, but embodiments of the present disclosure are not limited thereto:

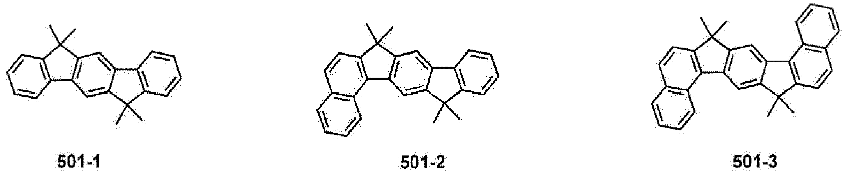

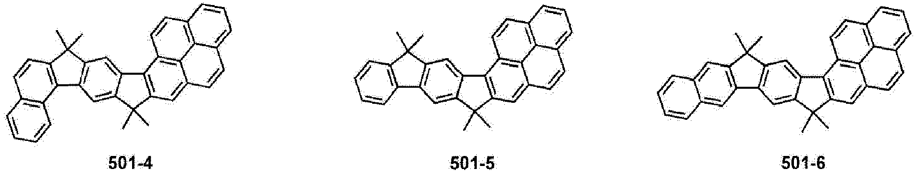

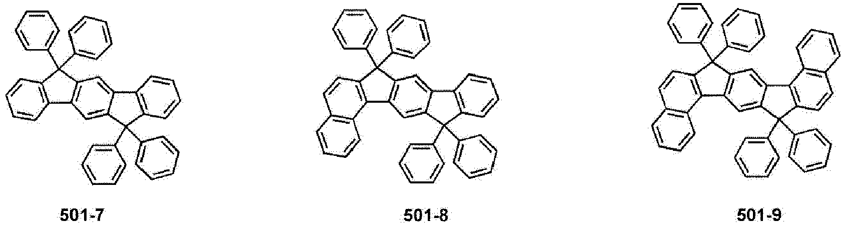

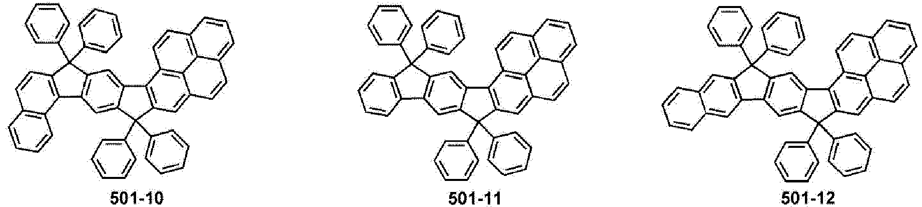

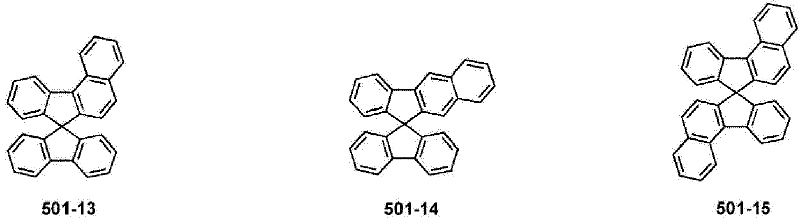

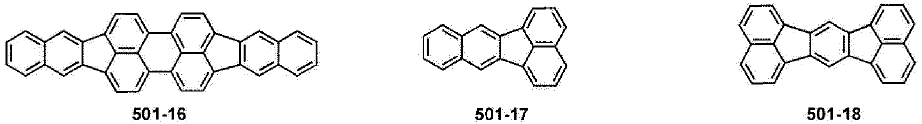

In one or more embodiments, the cooling dopant may be selected from a styryl-amine-based compound and a styryl-carbazole-based compound, but embodiments of the present disclosure are not limited thereto.

In one embodiment, the cooling dopant may be selected from compounds represented by Formula 501:
<Formula 501>

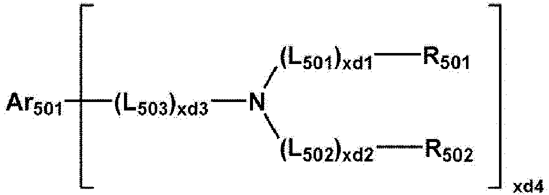

In Formula 501,
Ar₅₀₁ may be selected from:
a naphthalene group, a fluorene group, a spiro-bifluorene group, a benzofluorene group, a dibenzofluorene group, a phenanthrene group, an anthracene group, a fluoranthene group, a triphenylene group, a pyrene group, a chrysene group, a naphthacene group, a picene group, a perylene group, a pentaphene group, an indenoanthracene group, a bisanthracene group, and groups represented by Formulae 501-1 to 501-18; and
a naphthalene group, a fluorene group, a spiro-bifluorene group, a benzofluorene group, a dibenzofluorene group, a phenanthrene group, an anthracene group, a fluoranthene group, a triphenylene group, a pyrene group, a chrysene group, a naphthacene group, a picene group, a perylene group, a pentaphene group, an indenoanthracene group, a bisanthracene group, and groups represented by Formulae 501-1 to 501-18, each substituted with at least one selected from deuterium, -F, -CI, -Br, -I, a hydroxyl group, a cyano group, a nitro group, an amino group, an amidino group, a hydrazine group, a hydrazone group, a carboxylic acid or a salt thereof, a sulfonic acid or a salt thereof, a phosphoric acid or a salt thereof, a C₁-C₆₀ alkyl group, a C₂-C₆₀ alkenyl group, a C₂-C₆₀ alkynyl group, a C₁-C₆₀ alkoxy group, a C₃-C₁₀ cycloalkyl group, a C₁-C₁₀ heterocycloalkyl group, a C₃-C₁₀ cycloalkenyl group, a C₁-C₁₀heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, a monovalent non-aromatic condensed heteropolycyclic group and -Si(Q₅₀₁)(Q₅₀₂)(Q₅₀₃) (wherein Q₅₀₁ to Q₅₀₃ may each independently be selected from hydrogen, C₁-C₆₀ alkyl group, a C₁-C₆₀ alkoxy group, a C₆-C₆₀ aryl group, a C₁-C₆₀ heteroaryl group, a monovalent non-aromatic condensed polycyclic group, and a monovalent non-aromatic condensed heteropolycyclic group);
L₅₀₁ to L₆₀₃ may each independently be selected from a substituted or unsubstituted C₃-C₁₀ cycloalkylene group, a substituted or unsubstituted C₁-C₁₀ heterocycloalkylene group, a substituted or unsubstituted C₃-C₁₀ cycloalkenylene group, a substituted or unsubstituted C₁-C₁₀ heterocycloalkenylene group, a substituted or unsubstituted C₆-C₆₀ arylene group, a substituted or unsubstituted C₁-C₆₀ heteroarylene group, a substituted or unsubstituted divalent non-aromatic condensed polycyclic group, and a substituted or unsubstituted divalent non-aromatic condensed heteropolycyclic group,
R₅₀₁ to R₅₀₈ may each independently be selected from:
   a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a pyrenyl group, a chrysenyl group, a pyridinyl group, a pyrazinyl group, a pyrimidinyl group, a pyridazinyl group, a quinolinyl group, an isoquinolinyl group, a quinoxalinyl group, a quinazolinyl group, a carbazole group, a triazinyl group, a dibenzofuranyl group, and a dibenzothiophenyl group; and
   a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a pyrenyl group, a chrysenyl group, a pyridinyl group, a pyrazinyl group, a pyrimidinyl group, a pyridazinyl group, a quinolinyl group, an isoquinolinyl group, a quinoxalinyl group, a quinazolinyl group, a carbazolyl group, a triazinyl group, a dibenzofuranyl group, and a dibenzothiophenyl group, each substituted with at least one selected from deuterium, -F, -CI, -Br, -I, a hydroxyl group, a cyano group, a nitro group, an amino group, an amidino group, a hydrazine group, a hydrazone group, a carboxylic acid or a salt thereof, a sulfonic acid or a salt thereof, a phosphoric acid or a salt thereof, a C₁-C₂₀ alkyl group, a C₁-C₂₀ alkoxy group, a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a pyrenyl group, a chrysenyl group, a pyridinyl group, a pyrazinyl group, a pyrimidinyl group, a pyridazinyl group, a quinolinyl group, an isoquinolinyl group, a quinoxalinyl group, a quinazolinyl group, a carbazolyl group, a triazinyl group, a dibenzofuranyl group, and a dibenzothiophenyl group,
   xd1 to xd3 may each independently be selected from 0, 1, 2, and 3, and
   xd4 may be selected from 0, 1, 2, 3, 4, 5, and 6.

For example, in Formula 501,
Ar₅₀₁ may be selected from:
a naphthalene group, a fluorene group, a spiro-bifluorene group, a benzofluorene group, a dibenzofluorene group, a phenanthrene group, an anthracene group, a fluoranthene group, a triphenylene group, a pyrene group, a chrysene group, a naphthacene group, a picene group, a perylene group, a pentaphene group, an indenoanthracene group, a bisanthracene group, and groups represented by Formulae 501-1 to 501-18; and
a naphthalene group, a fluorene group, a spiro-bifluorene group, a benzofluorene group, a dibenzofluorene group, a phenanthrene group, an anthracene group, a fluoranthene group, a triphenylene group, a pyrene group, a chrysene group, a naphthacene group, a picene group, a perylene group, a pentaphene group, an indenoanthracene group, a bisanthracene group, and groups represented by Formula 501-1 to 501-18, each substituted with at least one selected from deuterium, -F, -CI, -Br, -I, a hydroxyl group, a cyano group, a nitro group, an amino group, an amidino group, a hydrazine group, a hydrazone group, a carboxylic acid or a salt thereof, a sulfonic acid or a salt thereof, a phosphoric acid or a salt thereof, a C₁-C₂₀ alkyl group, a C₁-C₂₀ alkoxy group, a phenyl group, a biphenyl group, a terphenyl group, a naphthyl group, a fluorenyl group, a dibenzofuranyl group, a dibenzothiophenyl group, a carbazolyl group, a pyridinyl group, a pyrimidinyl group, a triazinyl group, a quinolinyl group, an isoquinolinyl group and -Si(Q₅₀₁)(Q₅₀₂)(Q₅₀₃) (Q₅₀₁ to Q₅₀₃ may each independently be selected from hydrogen, C₁-C₂₀ alkyl group, a C₁-C₂₀ alkoxy group, a phenyl group, a biphenyl group, a terphenyl group, and a naphthyl group),
xd1 to xd3 may each independently be selected from 0, 1, and 2, and
xd4 may be selected from 0, 1, 2, and 3, but embodiments of the present disclosure are not limited thereto.

In one or more embodiments, the cooling dopant may include a compound represented by one of Formulae 502-1 to 502-5: 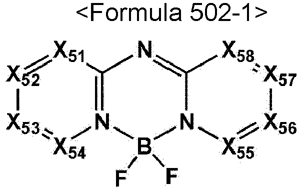 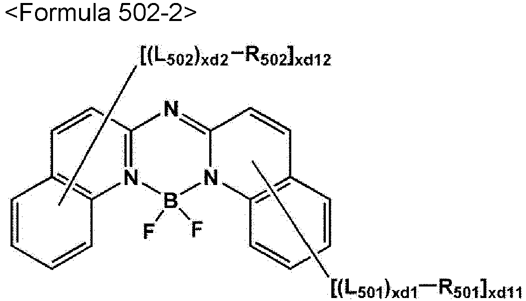 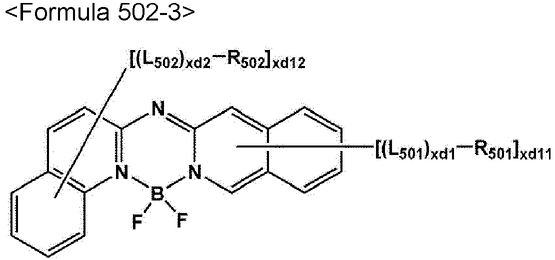 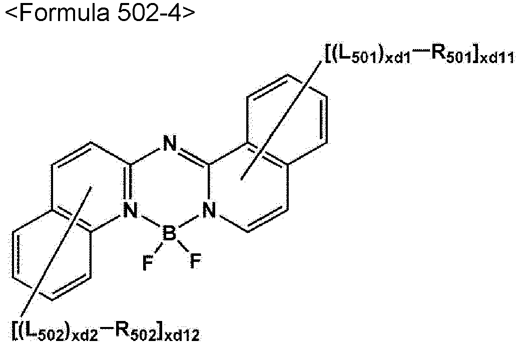 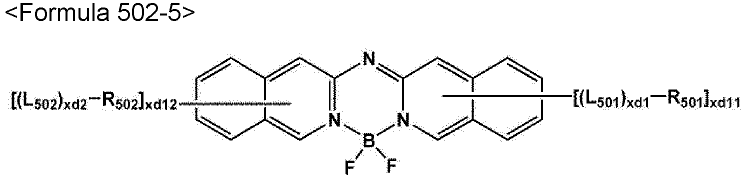 wherein, in Formulae 502-1 to 502-5,
X₅₁ may be N or C-[(L₅₀₁)_{xd1}-R₅₀₁], X₅₂ may be N or C-[(L₅₀₂)_{xd2}-R₅₀₂], X₅₃ may be N or C-[(L₅₀₃)_{xd3}-R₅₀₃], X₅₄ may be N or C-[(L₅₀₄)_{xd4}-R₅₀₄], X₅₅ may be N or C-[(L₅₀₅)_{xd5}-R₅₀₅], X₅₆ may be N or C-[(L₅₀₆)_{xd6}-R₅₀₆], X₅₇ may be N or C-[(L₅₀₇)_{xd7}-R₅₀₇], and X₅₈ may be N or C-[(L₅₀₈)_{xd8}-R₅₀₈],
L₅₀₁ to L₅₀₈ are each the same as described in connection with L₅₀₁ in Formula 501,
xd1 to xd8 are each the same as described in connection with xd1 in Formula 501,
R₅₀₁ to R₅₀₈ may each independently be selected from:
   hydrogen, deuterium, -F, -CI, -Br, -I, a hydroxyl group, a cyano group, a nitro group, an amino group, an amidino group, a hydrazine group, a hydrazone group, a carboxylic acid or a salt thereof, a sulfonic acid or a salt thereof, a phosphoric acid or a salt thereof, a C₁-C₂₀ alkyl group, a C₁-C₂₀ alkoxy group,
   a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a pyrenyl group, a chrysenyl group, a pyridinyl group, a pyrazinyl group, a pyrimidinyl group, a pyridazinyl group, a quinolinyl group, an isoquinolinyl group, a quinoxalinyl group, a quinazolinyl group, a carbazole group, a triazinyl group, a dibenzofuranyl group, and a dibenzothiophenyl group; and
   a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a pyrenyl group, a chrysenyl group, a pyridinyl group, a pyrazinyl group, a pyrimidinyl group, a pyridazinyl group, a quinolinyl group, an isoquinolinyl group, a quinoxalinyl group, a quinazolinyl group, a carbazolyl group, a triazinyl group, a dibenzofuranyl group, and a dibenzothiophenyl group, each substituted with at least one selected from deuterium, -F, -CI, -Br, -I, a hydroxyl group, a cyano group, a nitro group, an amino group, an amidino group, a hydrazine group, a hydrazone group, a carboxylic acid or a salt thereof, a sulfonic acid or a salt thereof, a phosphoric acid or a salt thereof, a C₁-C₂₀ alkyl group, a C₁-C₂₀ alkoxy group, a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a pyrenyl group, a chrysenyl group, a pyridinyl group, a pyrazinyl group, a pyrimidinyl group, a pyridazinyl group, a quinolinyl group, an isoquinolinyl group, a quinoxalinyl group, a quinazolinyl group, a carbazolyl group, a triazinyl group, a dibenzofuranyl group, and a dibenzothiophenyl group,
   xd11 and xd12 may each independently be an integer from 0 to 5, and
   two of R₅₀₁ to R₅₀₄ may optionally be linked together to form a saturated or unsaturated ring, and
   two of R₅₀₅ to R₅₀₈ may optionally be linked together to form a saturated or unsaturated ring.

The cooling dopant may include at least one compound selected from, for example, the following compounds FD(1) to FD(16) and FD1 to FD18:

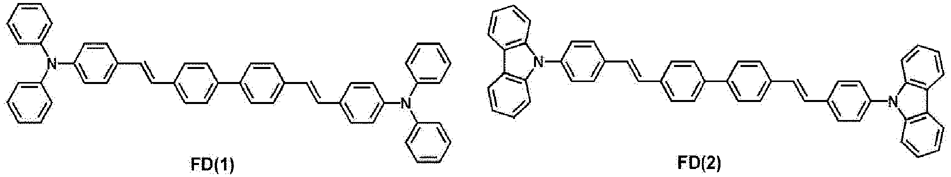

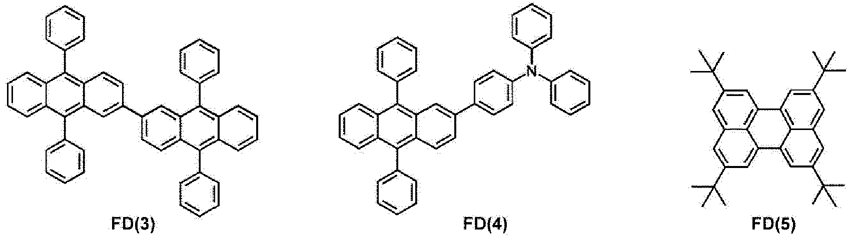

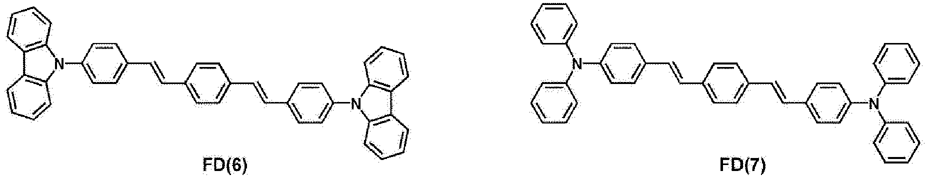

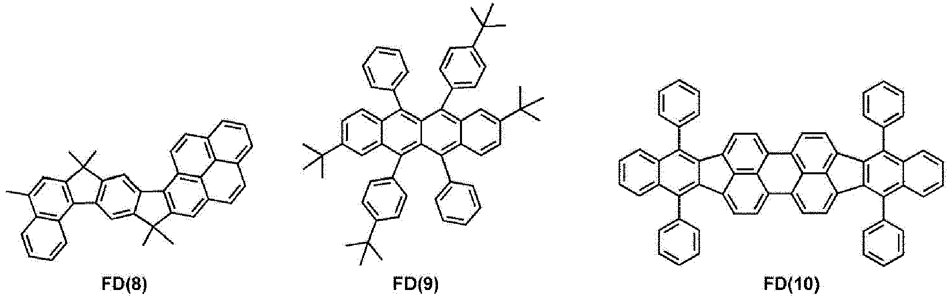

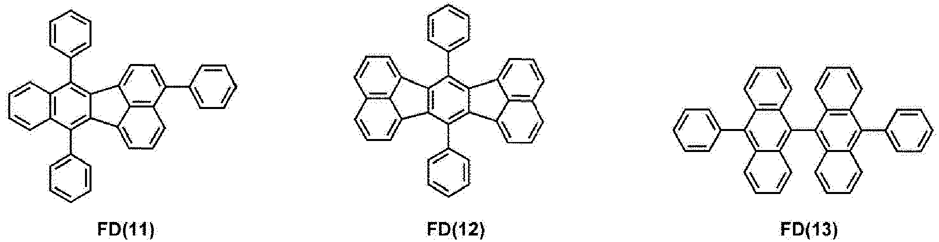

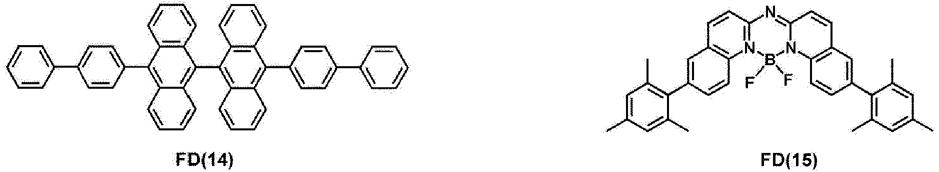

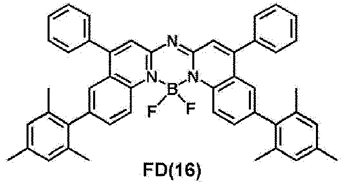

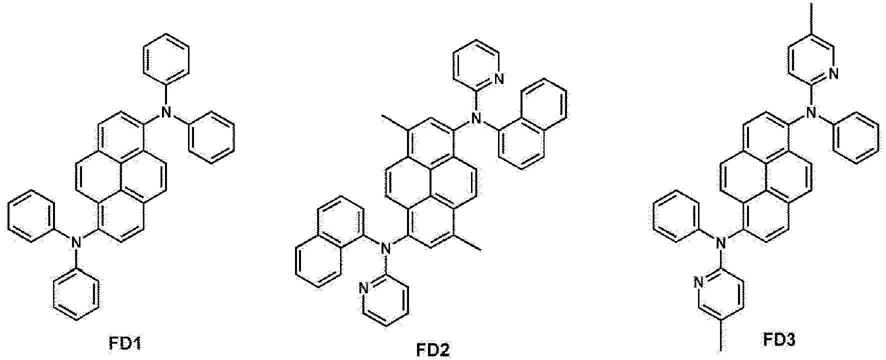

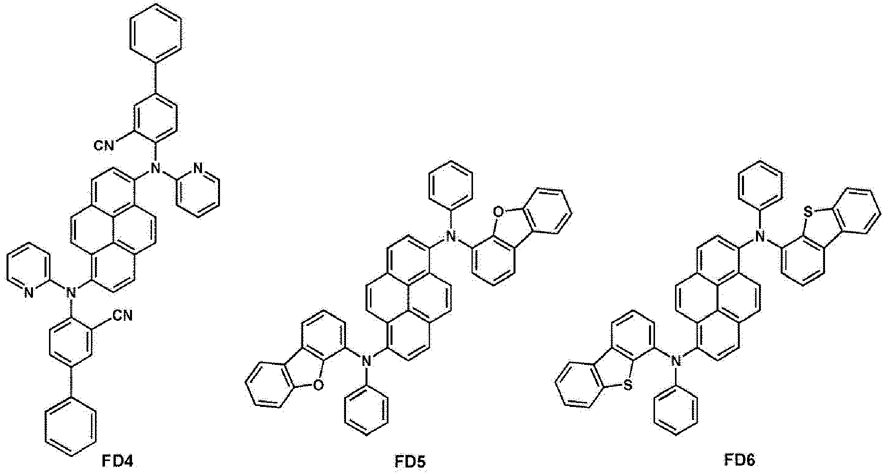

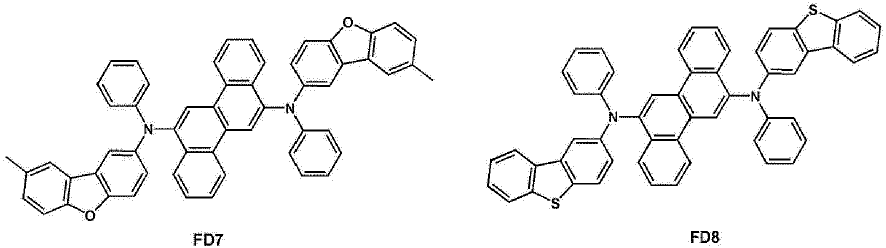

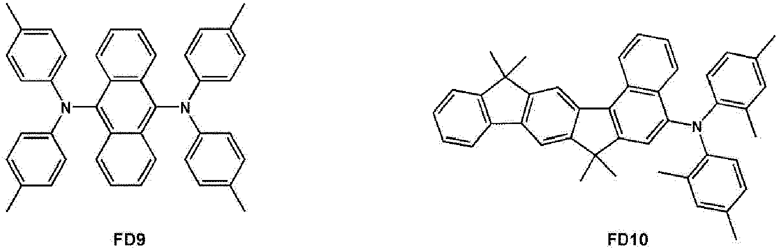

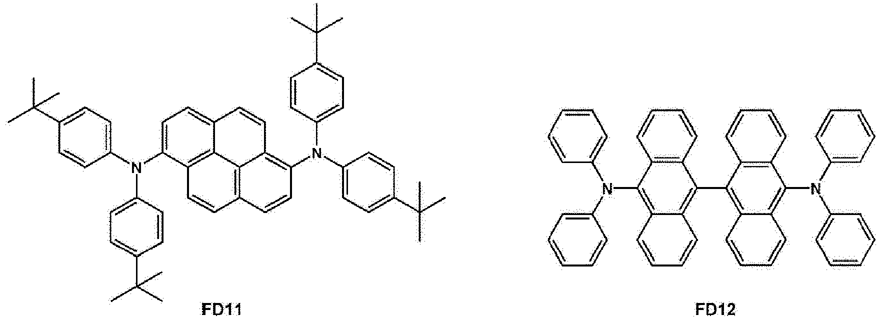

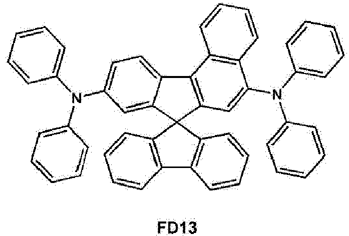

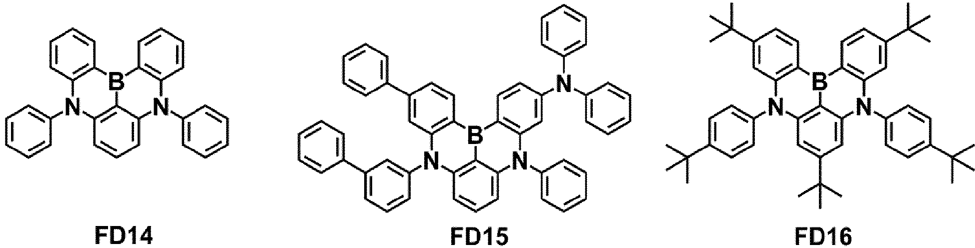

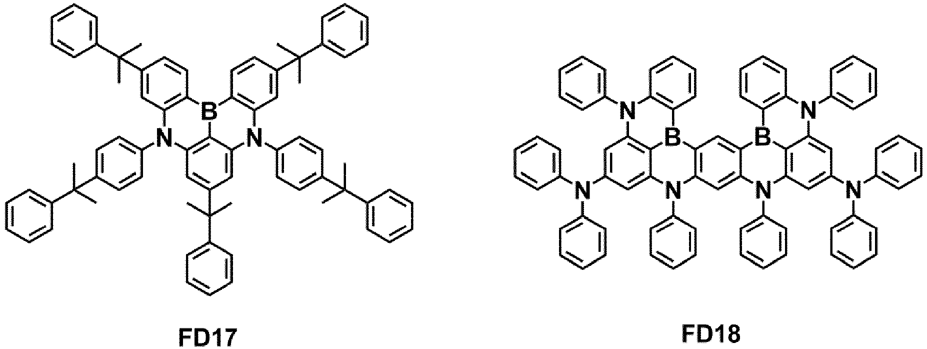

The amount of the cooling dopant in the emission layer may be from about 0.01 wt% to about 15 wt%, but embodiments of the present disclosure are not limited thereto.

### [Sensitizer in emission layer 15]

The sensitizer may include Pt. In one embodiment, the sensitizer may be an organic metallic compound containing Pt.

In one embodiment, the sensitizer may include Pt and an organic ligand (L₁₁), and L₁₁ and Pt may form 1, 2, 3, or 4 cyclometalated rings.

In an embodiment, the sensitizer may include an organometallic compound represented by Formula 101:

<Formula 101> Pt(L₁₁)ₙ₁₁(L₁₂)ₙ₁₂

wherein, in Formula 101,
L₁₁ is a ligand represented by one of Formulae 1-1 to 1-4;
L₁₂ may be selected from a monodentate ligand and a bidentate ligand;
n11 may be 1,
n12 may be selected from 0, 1, and 2; 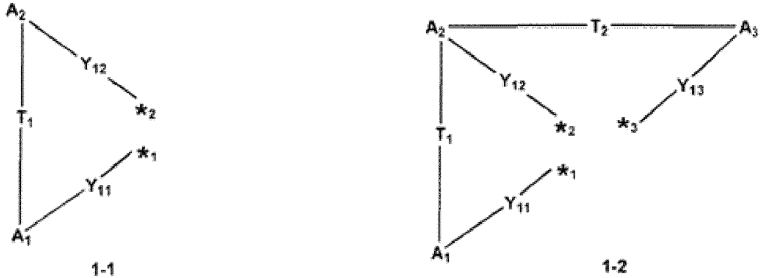 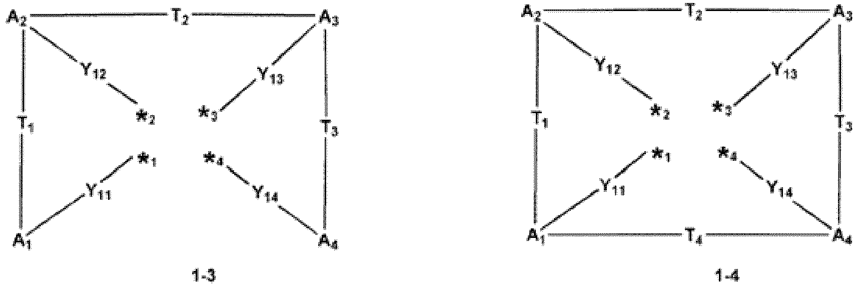 wherein, in Formulae 1-1 to 1-4,
A₁ to A₄ may each independently be selected from a substituted or unsubstituted C₅-C₃₀ carbocyclic group, a substituted or unsubstituted C₁-C₃₀ heterocyclic group, and a non-cyclic group,
Y₁₁ to Y₁₄ may each independently be a chemical bond, O, S, N(R₉₁), B(R₉₁), P(R₉₁), or C(R₉₁)(R₉₂),
T₁ to T₄ may each independently be selected from a single bond, a double bond, *-N(R₉₃)-*', *-B(R₉₃)-*_{',} *-P(R₉₃)-*', *-C(R₉₃)(R₉₄)-*', *-Si(R₉₃)(R₉₄)-*', *-Ge(R₉₃)(R₉₄)-*', *-S-*', *-Se-*', *-O-*', *-C(=O)-*', *-S(=O)-*', *-S(=O)₂-*', *-C(R₉₃)=*', *=C(R₉₃)-*', *-C(R₉₃)=C(R₉₄)-*', *-C(=S)-*', and *-C≡C-*',
a substituent of the substituted C₅-C₃₀ carbocyclic group, a substituent of substituted C₁-C₃₀ heterocyclic group, and R₉₁ to R₉₄ may each independently be selected from hydrogen, deuterium, -F, -CI, -Br, -I, -SF₅, a hydroxyl group, a cyano group, a nitro group, an amidino group, a hydrazine group, a hydrazone group, a carboxylic acid or a salt thereof, a sulfonic acid or a salt thereof, a phosphoric acid or a salt thereof, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀heterocycloalkenyl group, a substituted or unsubstituted C₆-C₆₀ aryl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted monovalent non-aromatic condensed polycyclic group, a substituted or unsubstituted monovalent non-aromatic condensed heteropolycyclic group, -Si(Q₁)(Q₂)(Q₃), -B(Q₁)(Q₂), -N(Q₁)(Q₂), -P(Q₁)(Q₂), -C(=O)(Q₁), -S(=O)(Q₁), -S(=O)₂(Q₁), -P(=O)(Q₁)(Q₂), and -P(=S)(Q₁)(Q₂), wherein each of a substituent of the substituted C₅-C₃₀ carbocyclic group and a substituent of substituted C₁-C₃₀ heterocyclic group is not hydrogen,
*₁, *₂, *₃, and *₄ each indicate a binding site to Pt, and
Q₁ to Q₃ may each independently selected from hydrogen, deuterium, -F, -CI, -Br, -I, a hydroxyl group, a cyano group, a nitro group, an amidino group, a hydrazine group, a hydrazone group, a C₁-C₆₀ alkyl group, a C₂-C₆₀ alkenyl group, a C₂-C₆₀ alkynyl group, a C₁-C₆₀ alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇-C₆₀ alkyl aryl group, a C₆-C₆₀ aryloxy group, a C₆-C₆₀ arylthio group, a C₁-C₆₀ heteroaryl group, a C₂-C₆₀ alkyl heteroaryl group, a C₁-C₆₀ heteroaryloxy group, a C₁-C₆₀ heteroarylthio group, a monovalent non-aromatic condensed polycyclic group, a monovalent non-aromatic condensed heteropolycyclic group, a C₁-C₆₀ alkyl group that is substituted with at least one selected from deuterium, -F, a cyano group, a C₁-C₆₀ alkyl group, and a C₆-C₆₀ aryl group, and a C₆-C₆₀ aryl group that is substituted with at least one selected from deuterium, -F, a cyano group, a C₁-C₆₀ alkyl group, and a C₆-C₆₀ aryl group.

In one or more embodiments, the sensitizer may be selected from Groups I, II, III, V and VI, but embodiments of the present disclosure are not limited thereto: 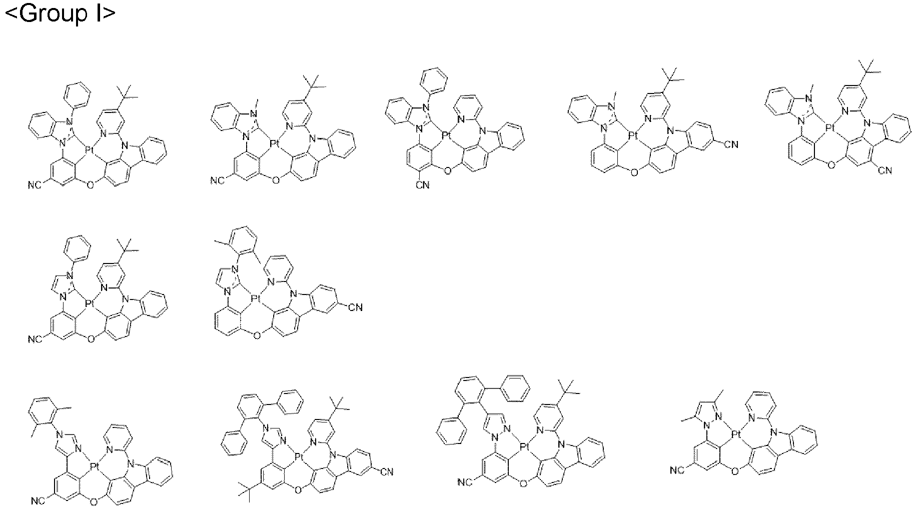 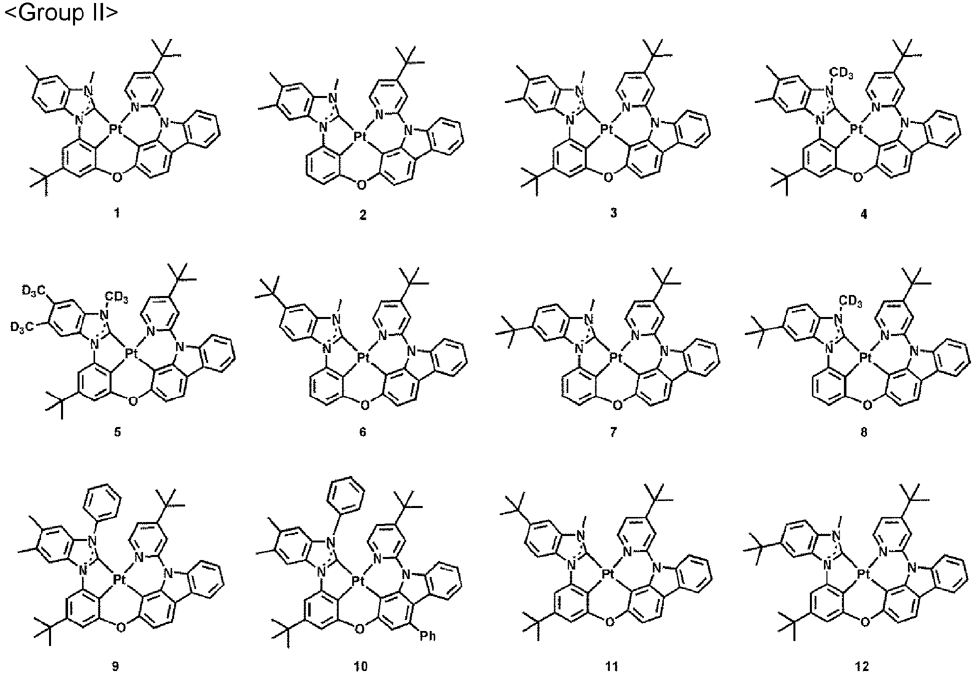 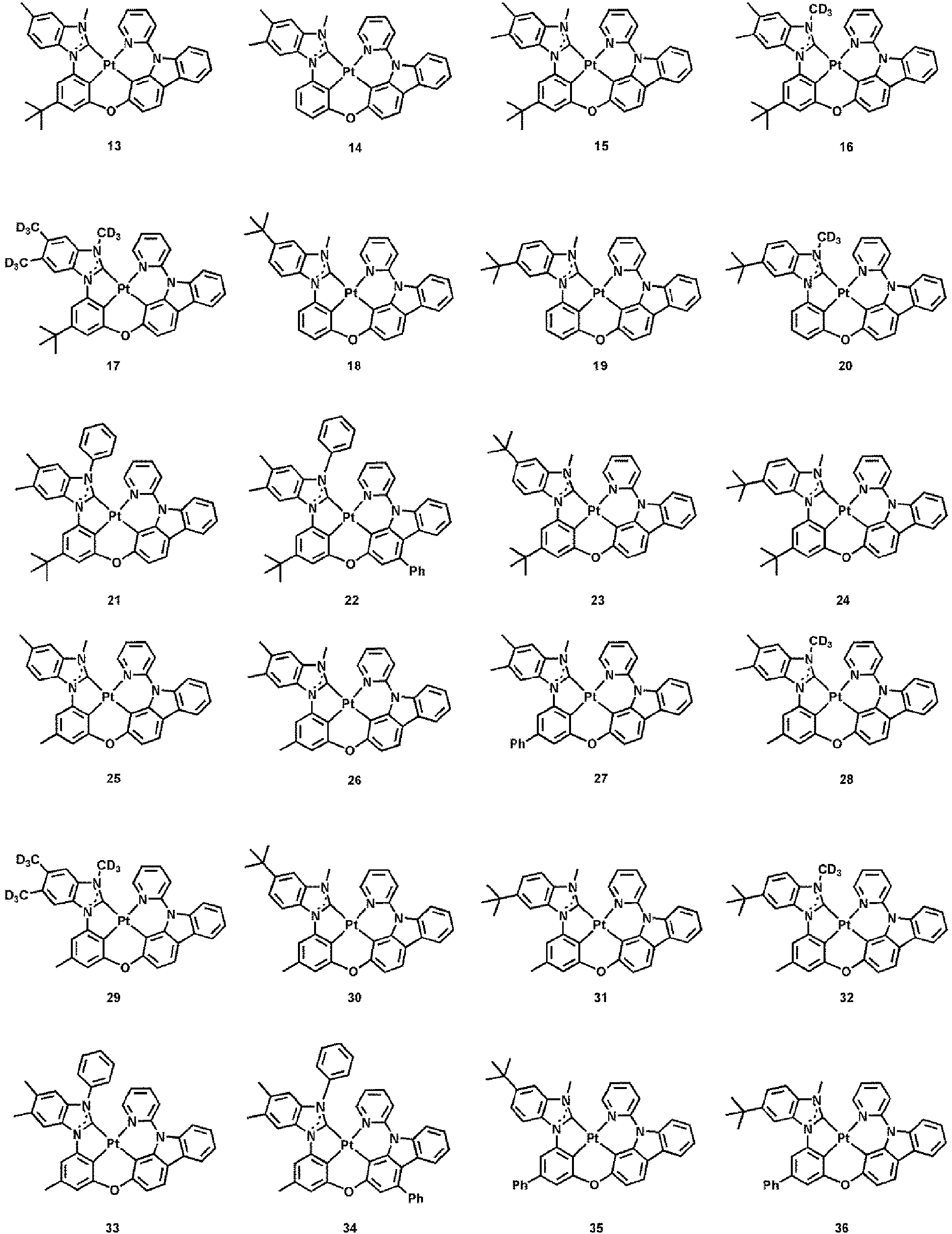 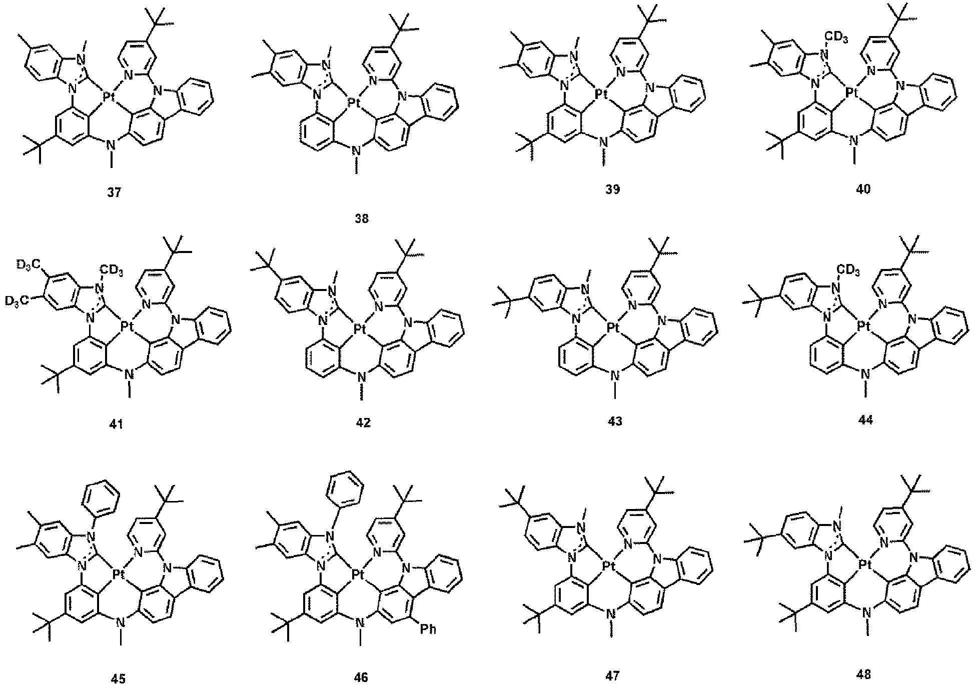 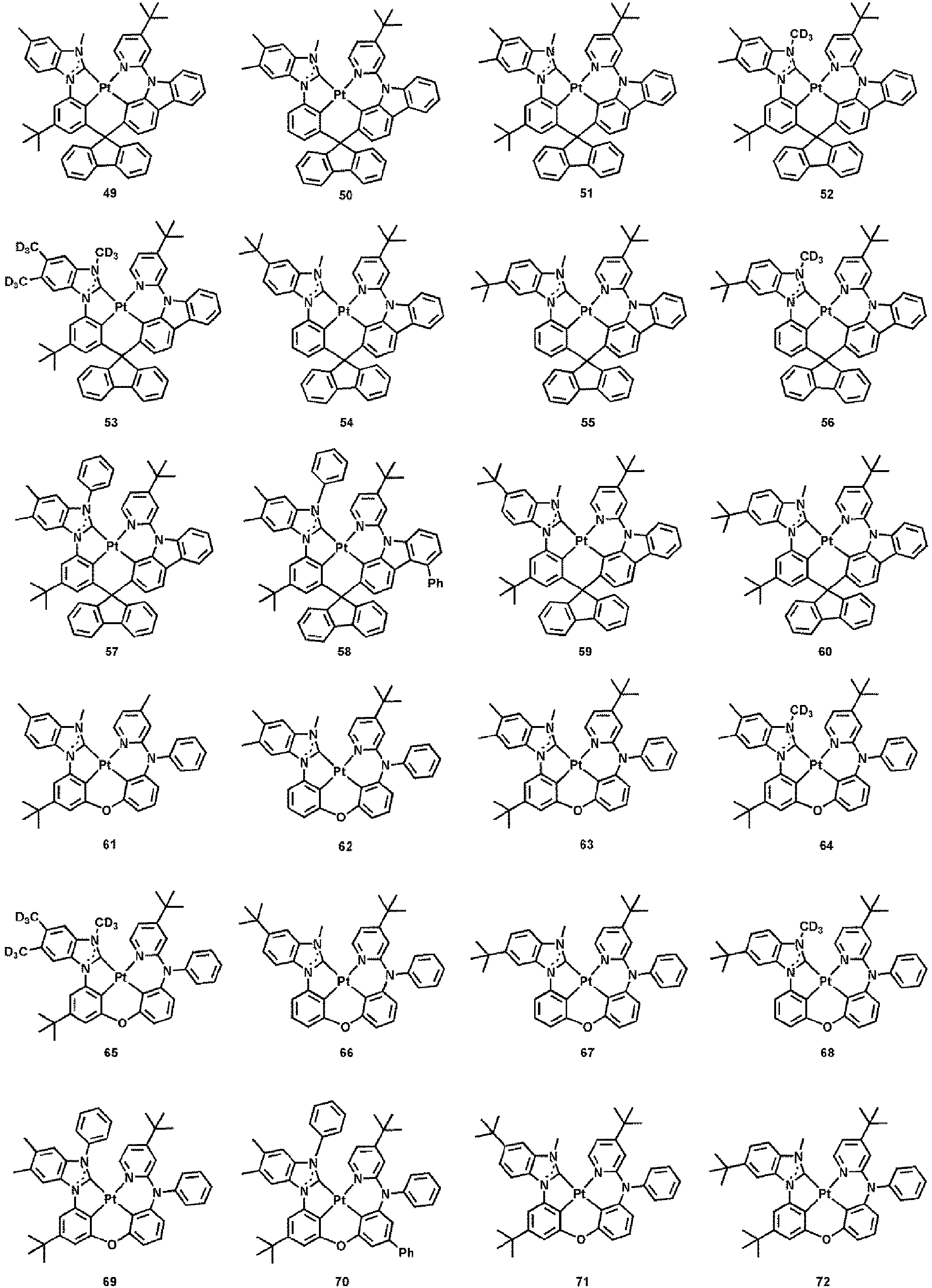 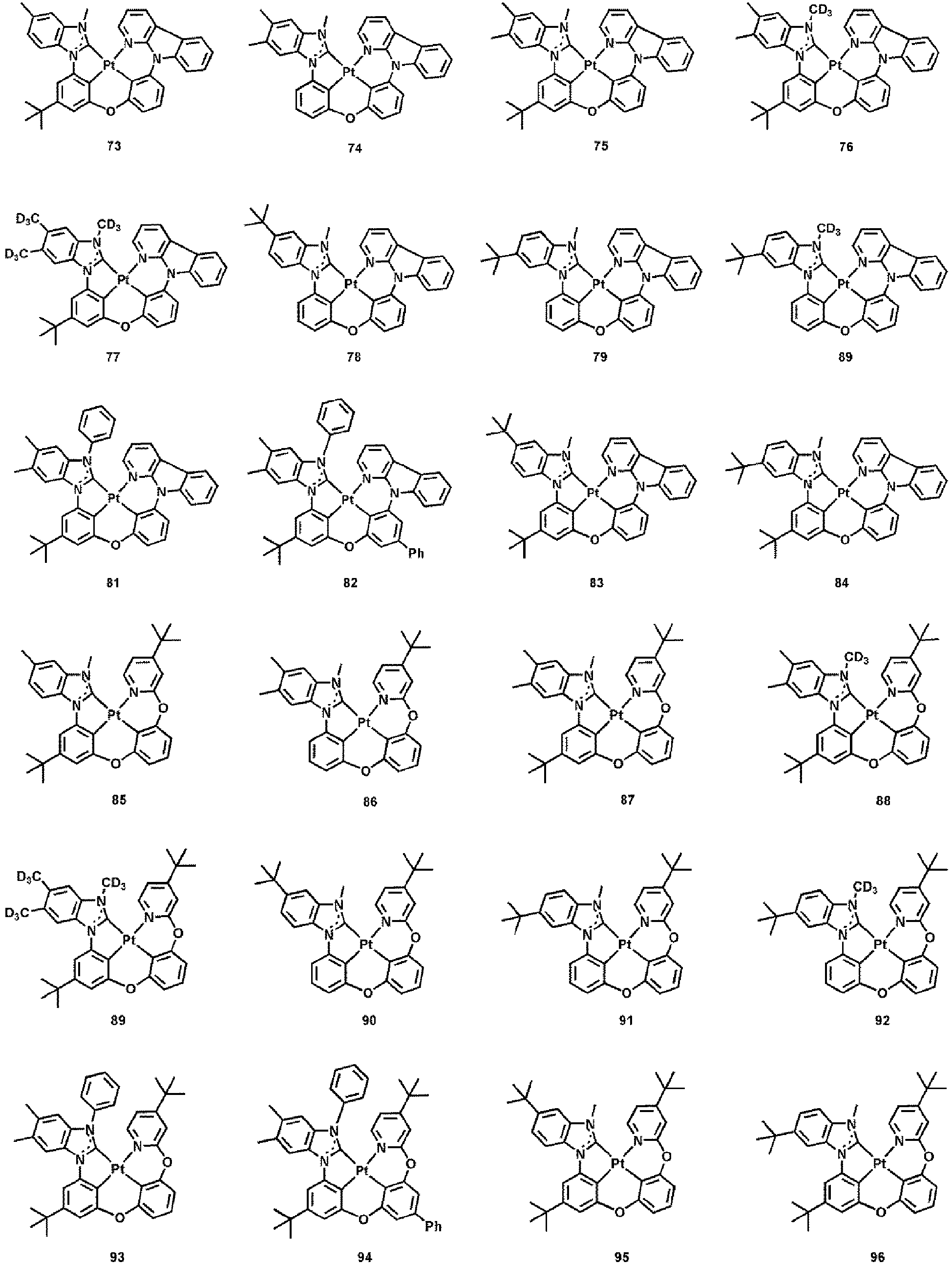 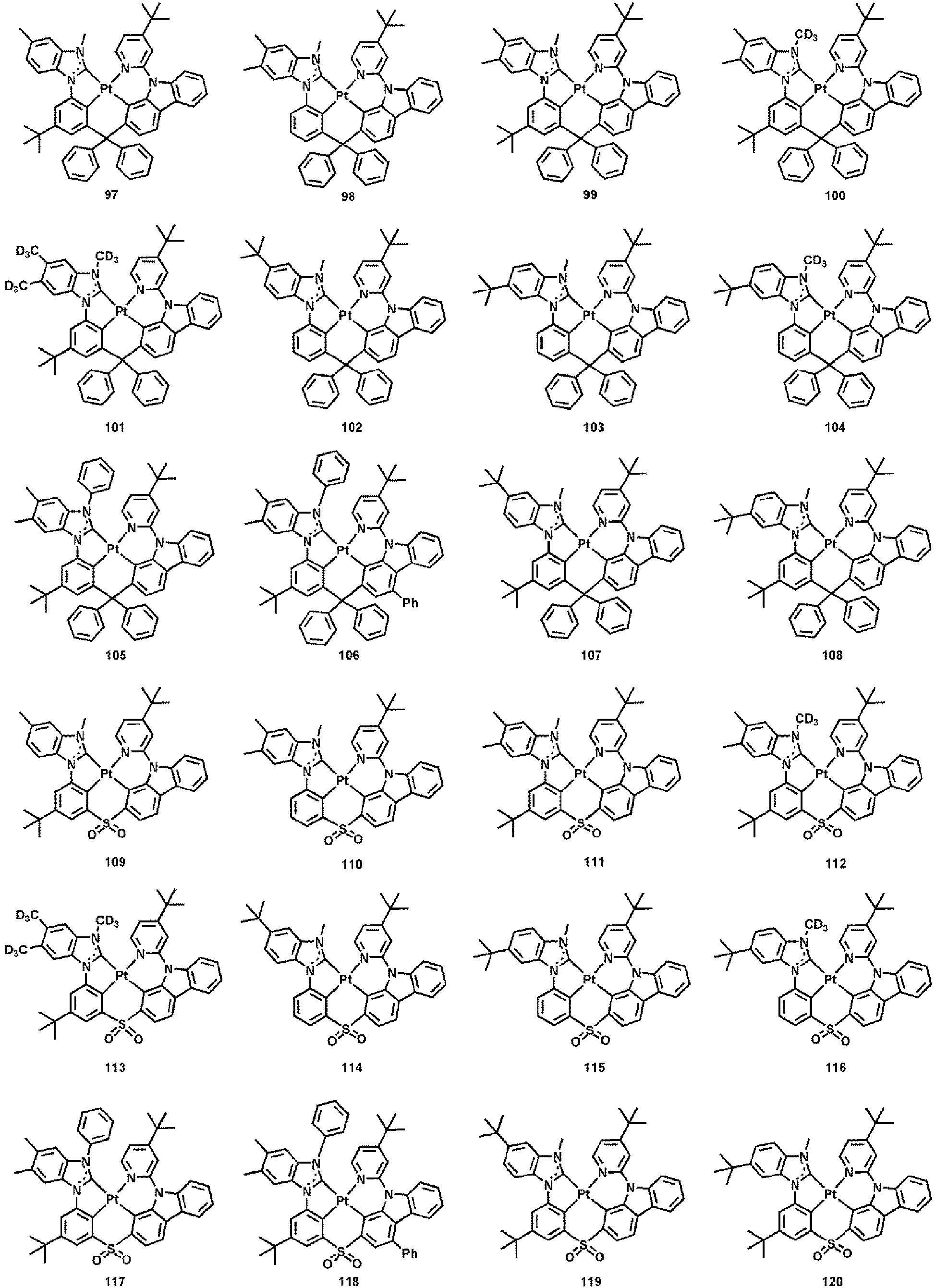 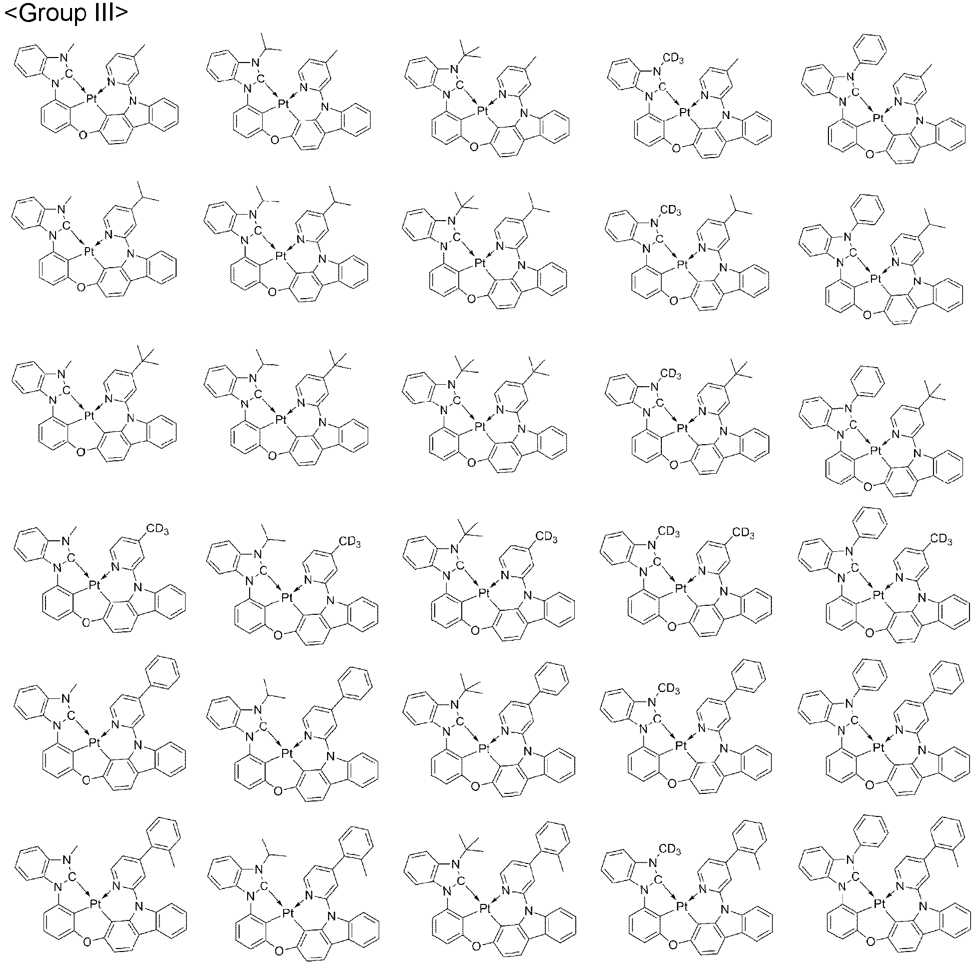 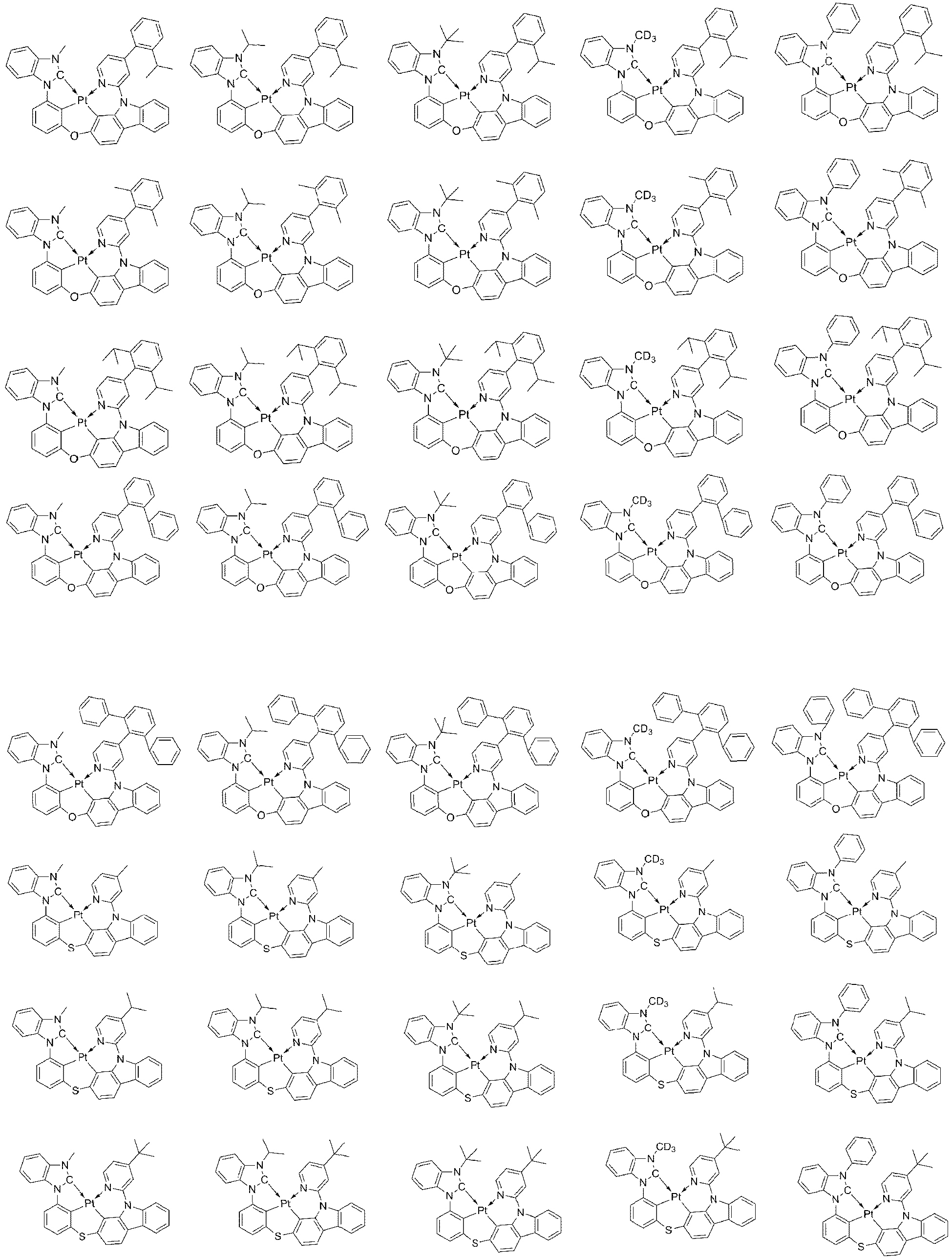 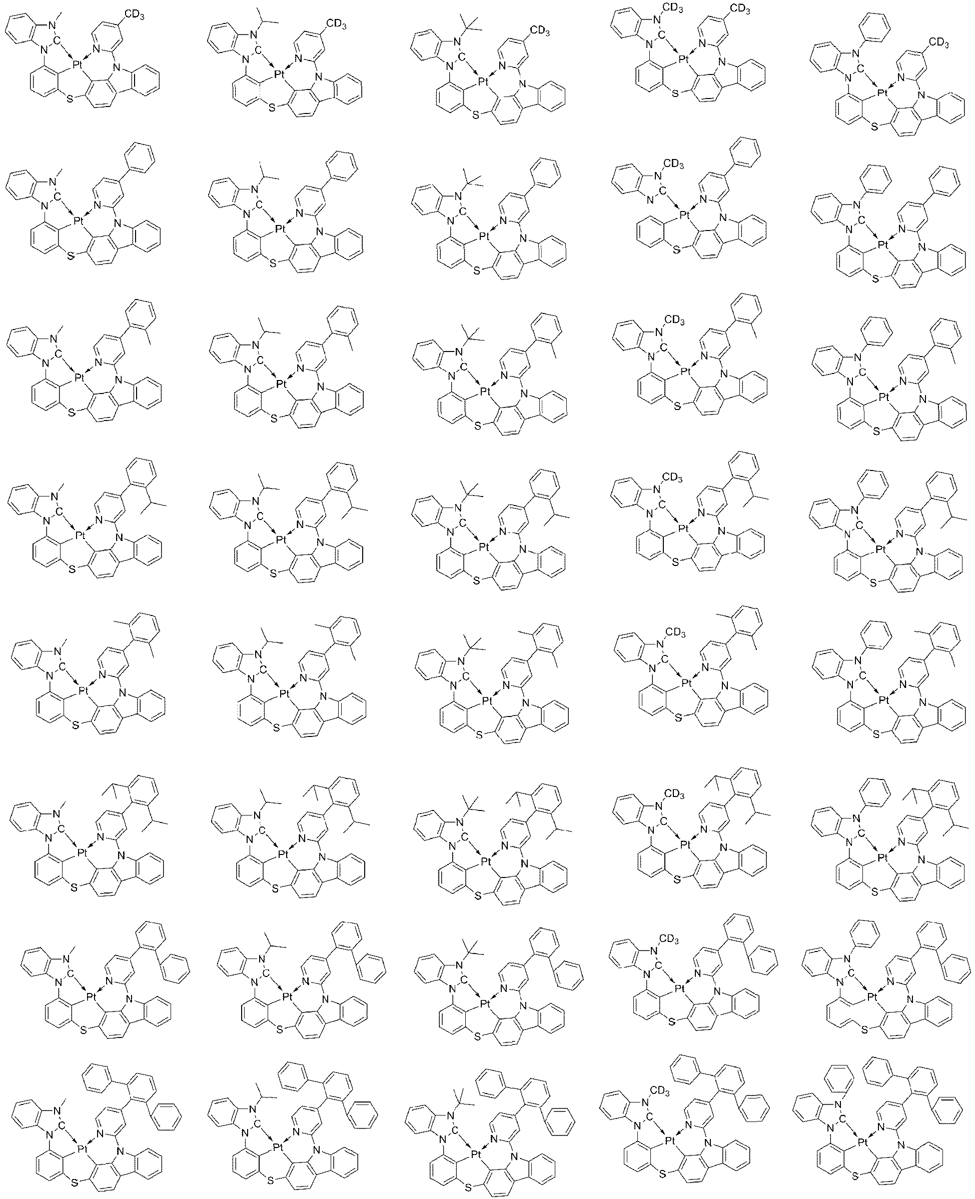 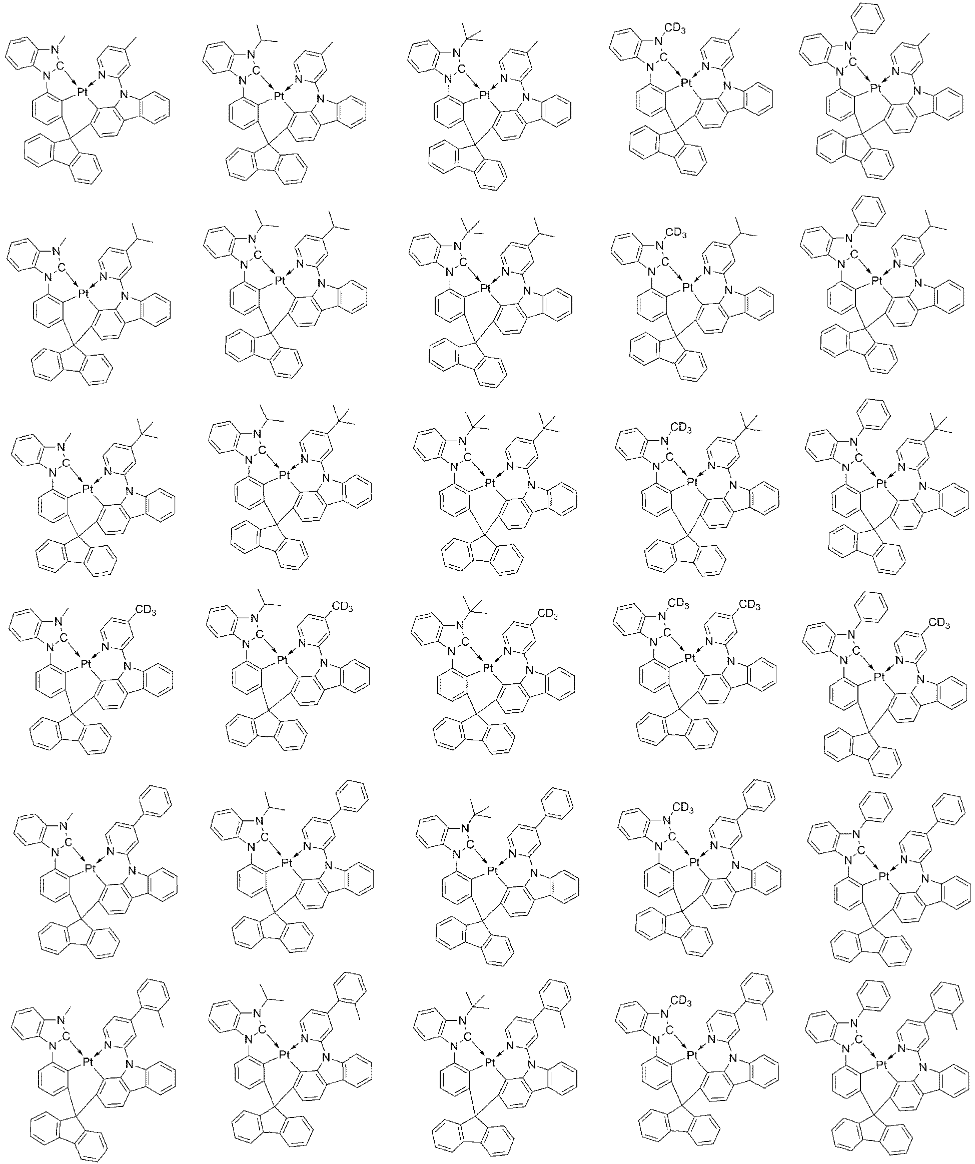 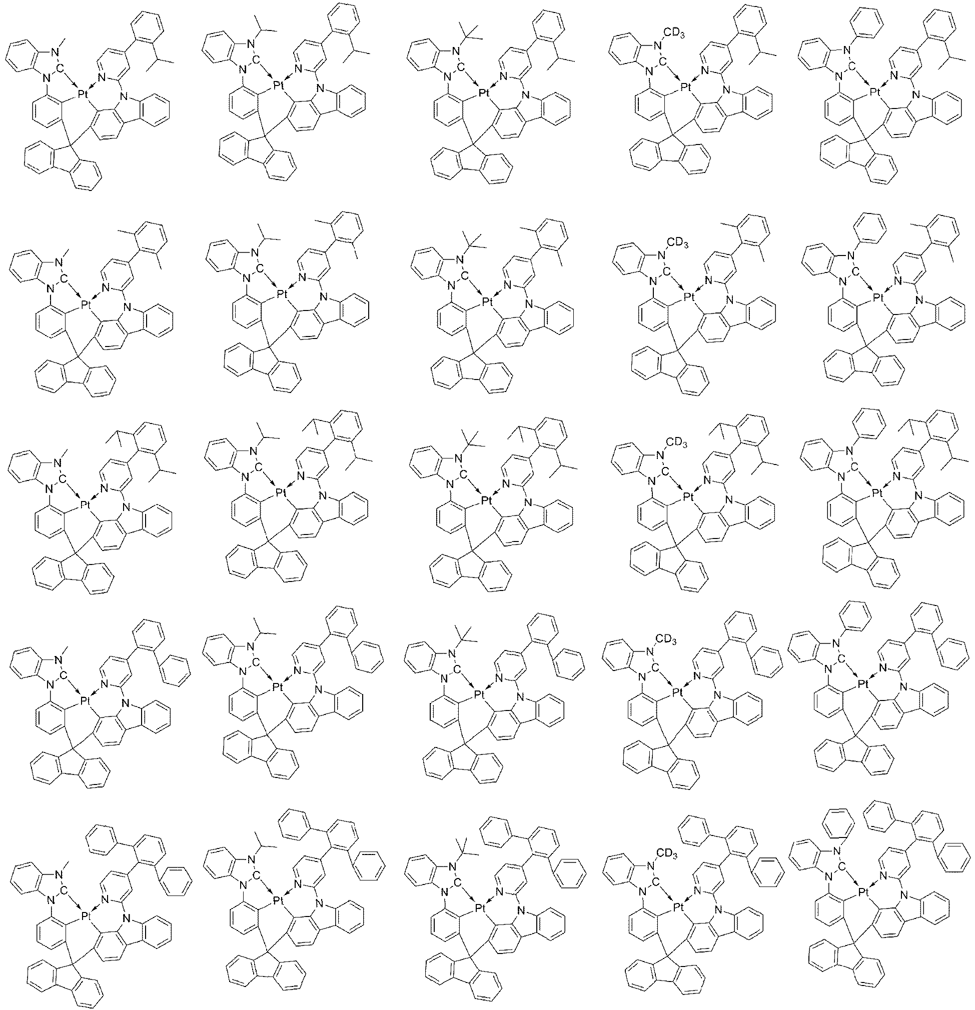 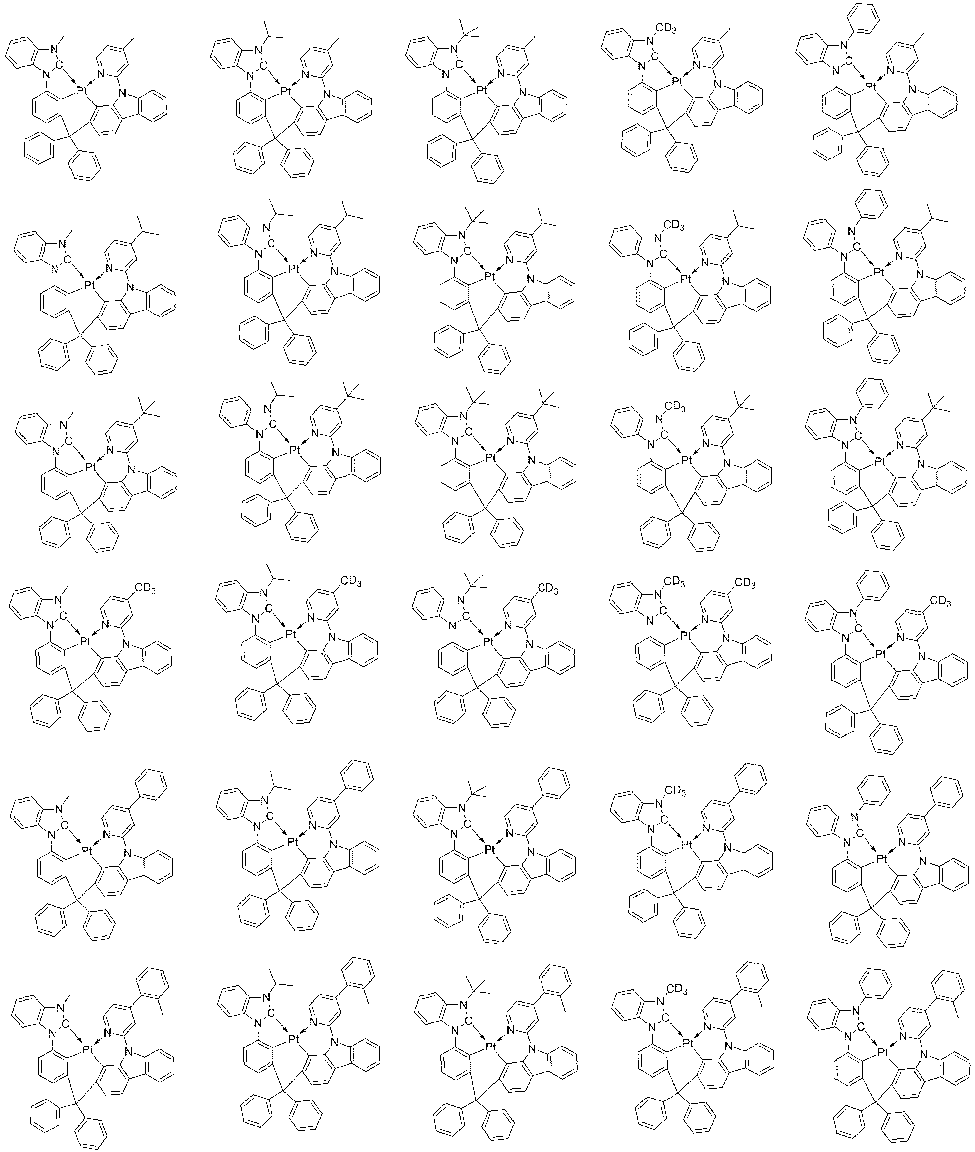 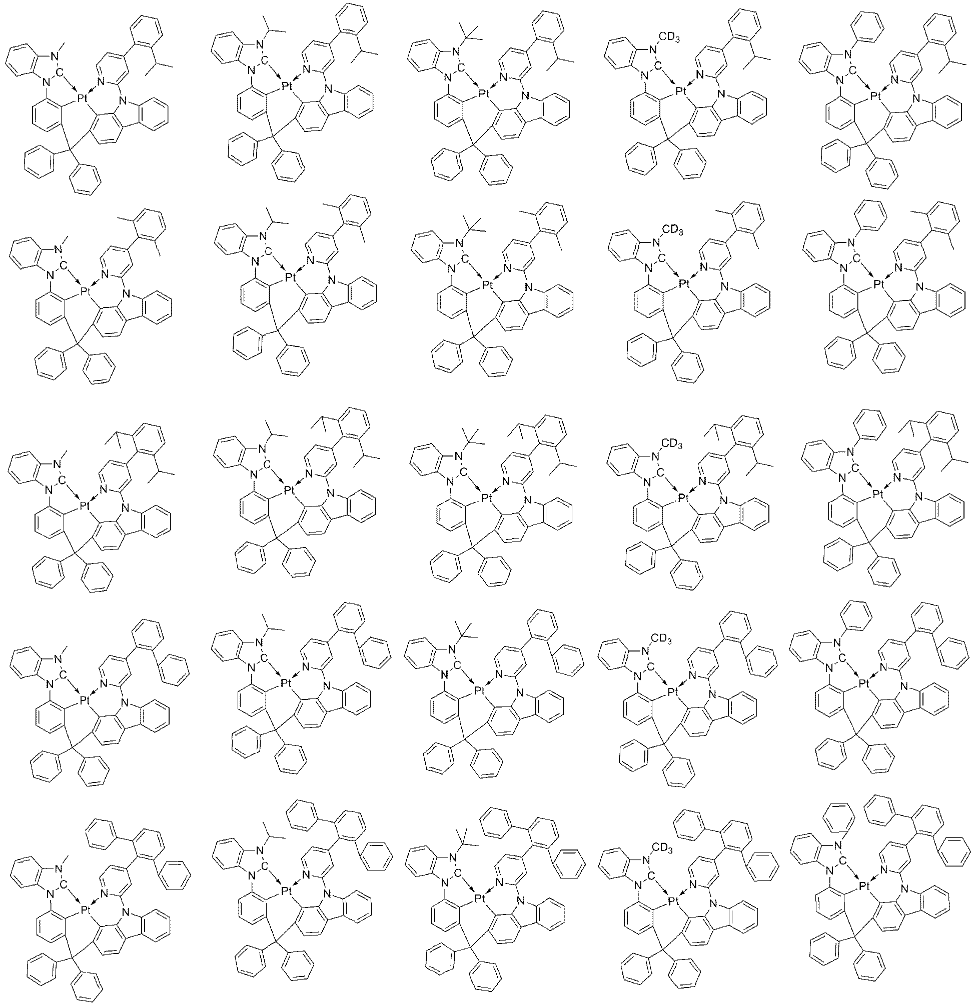 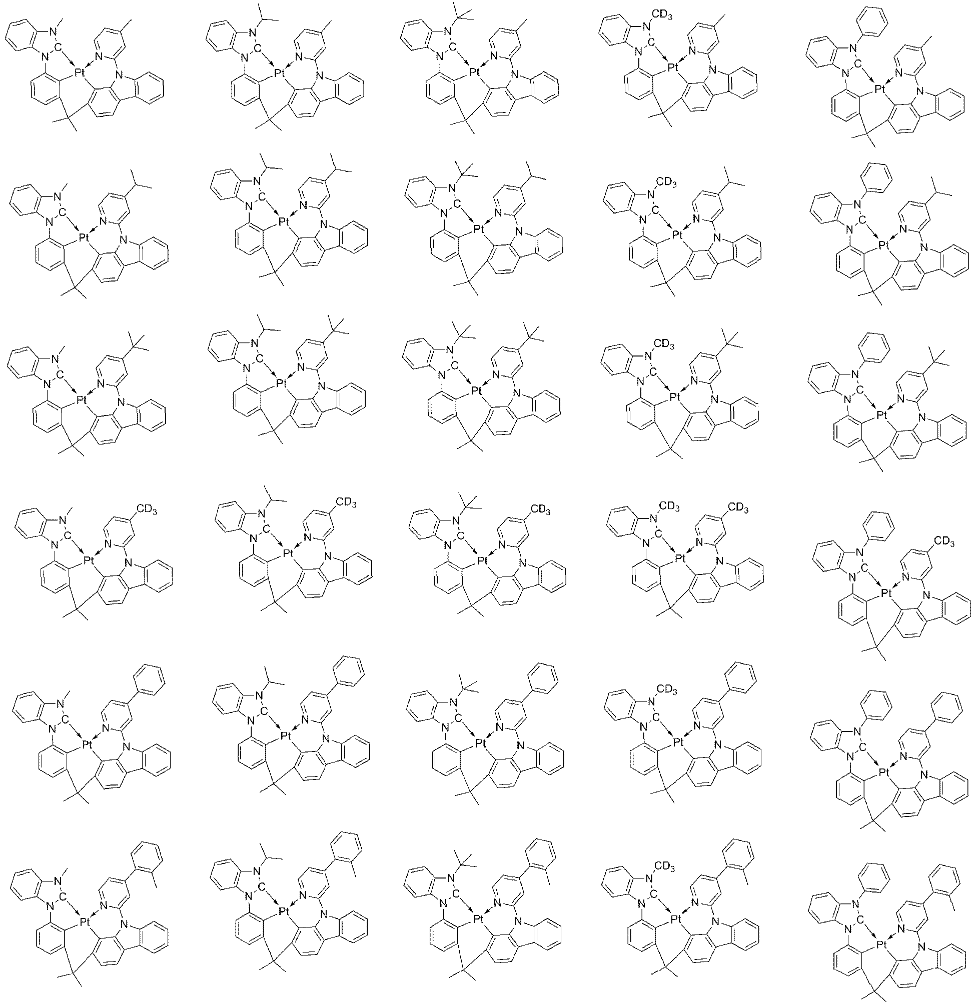 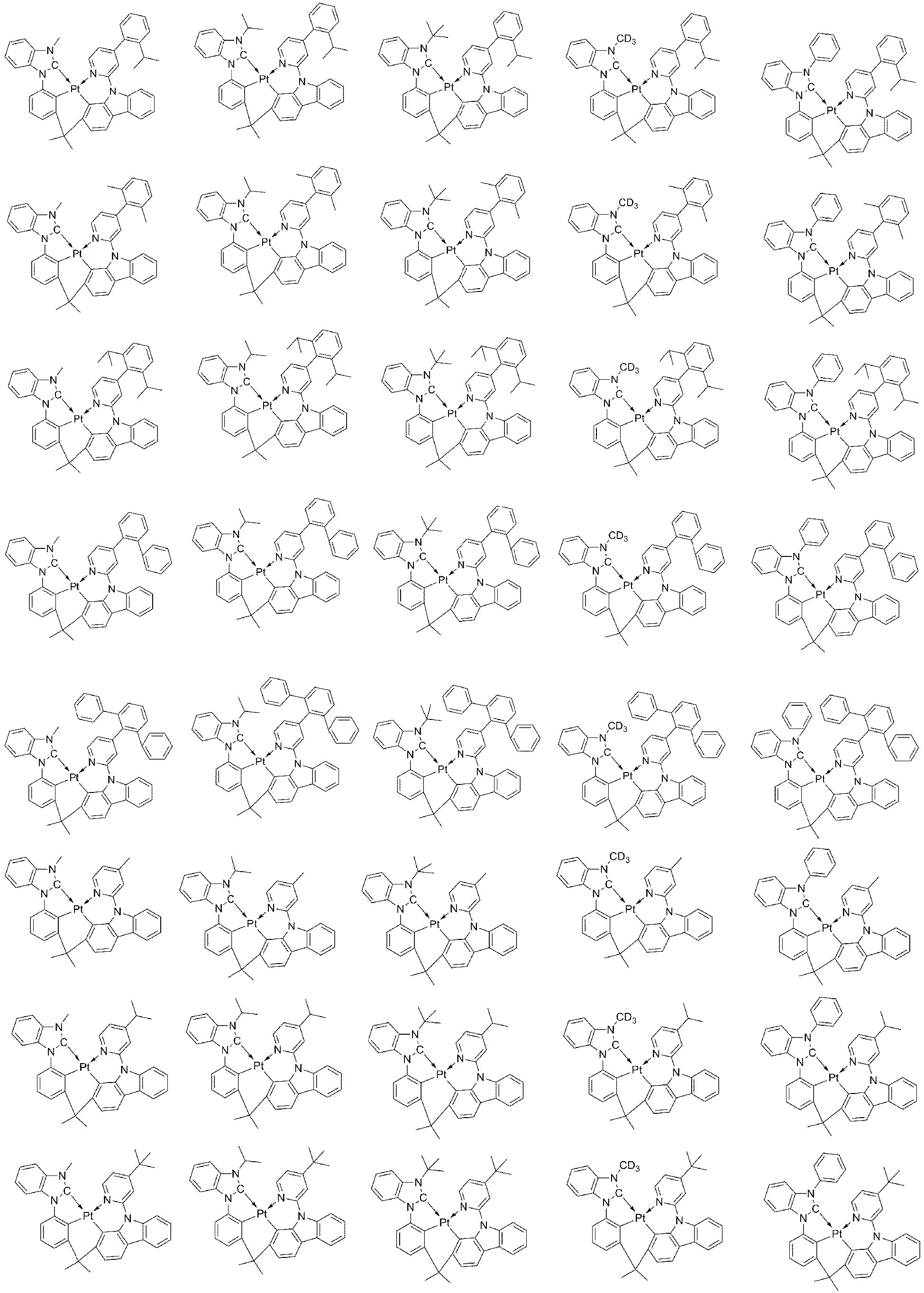 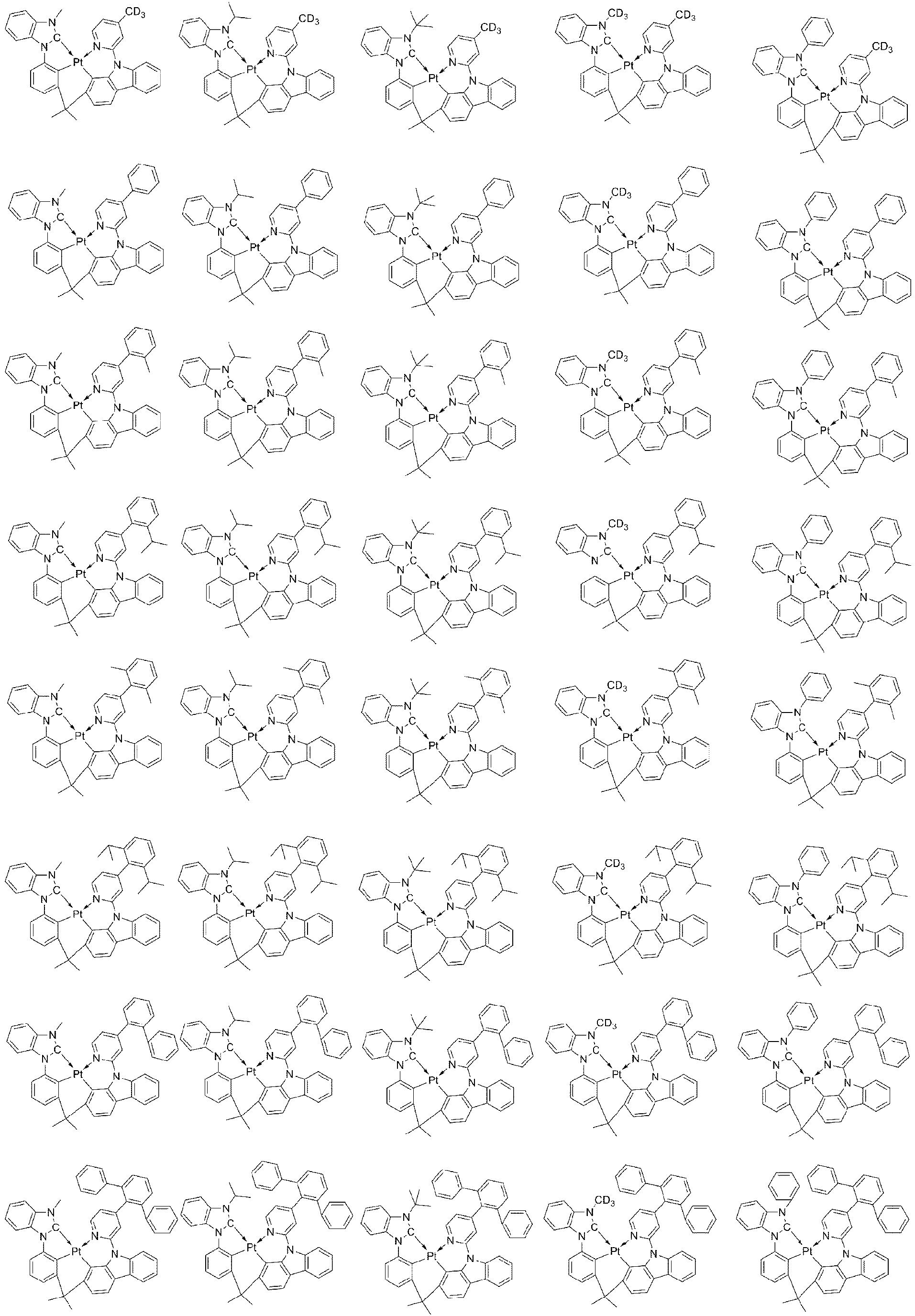 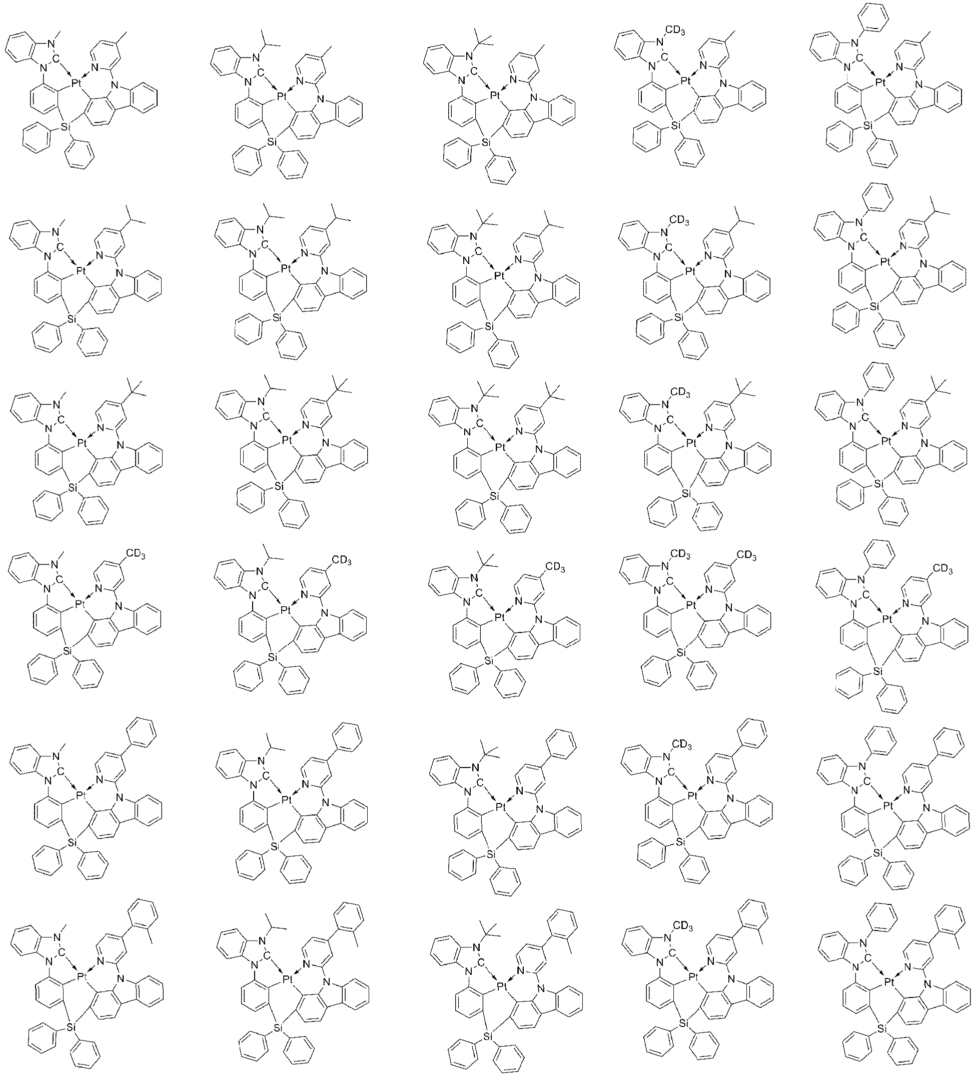 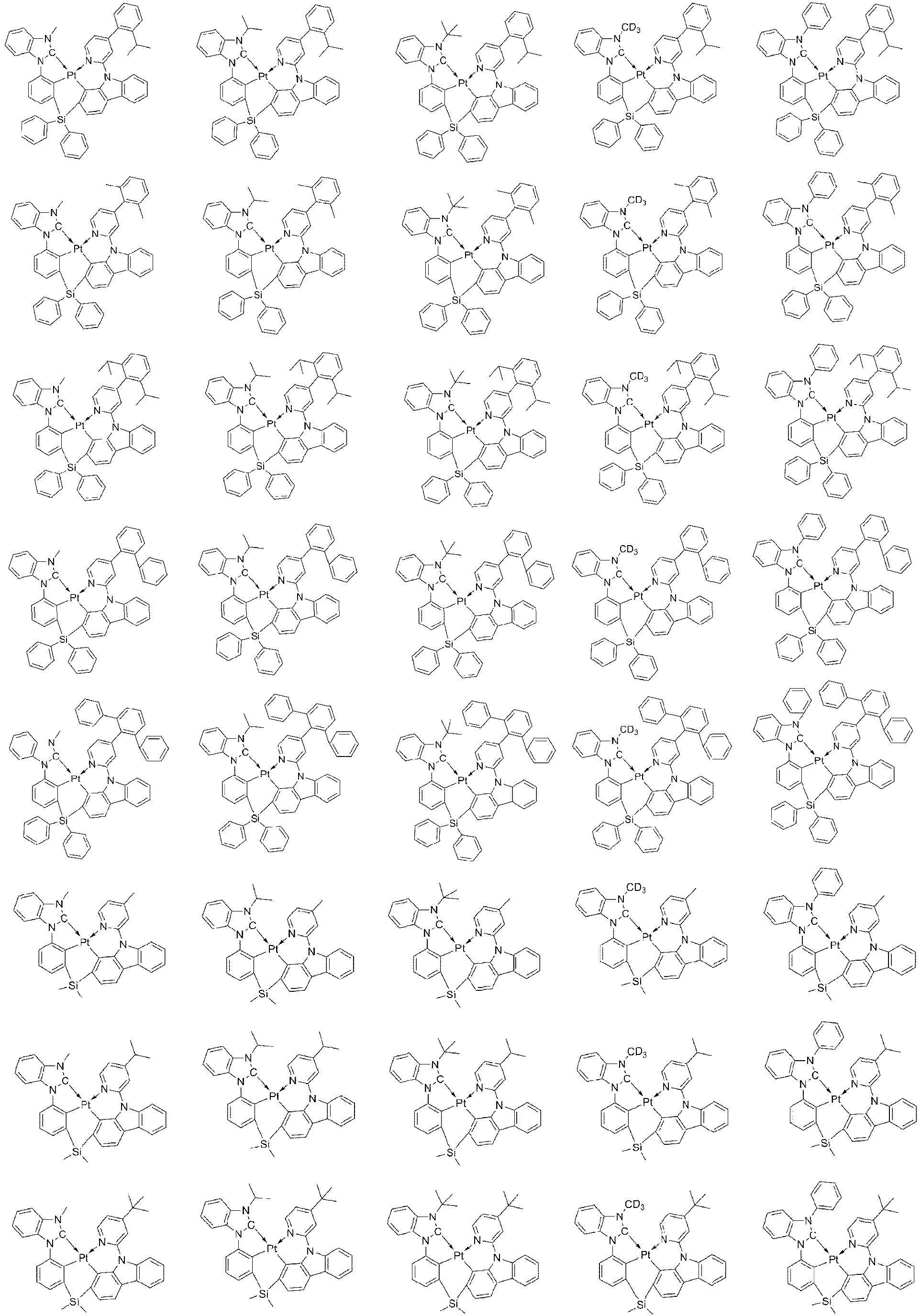 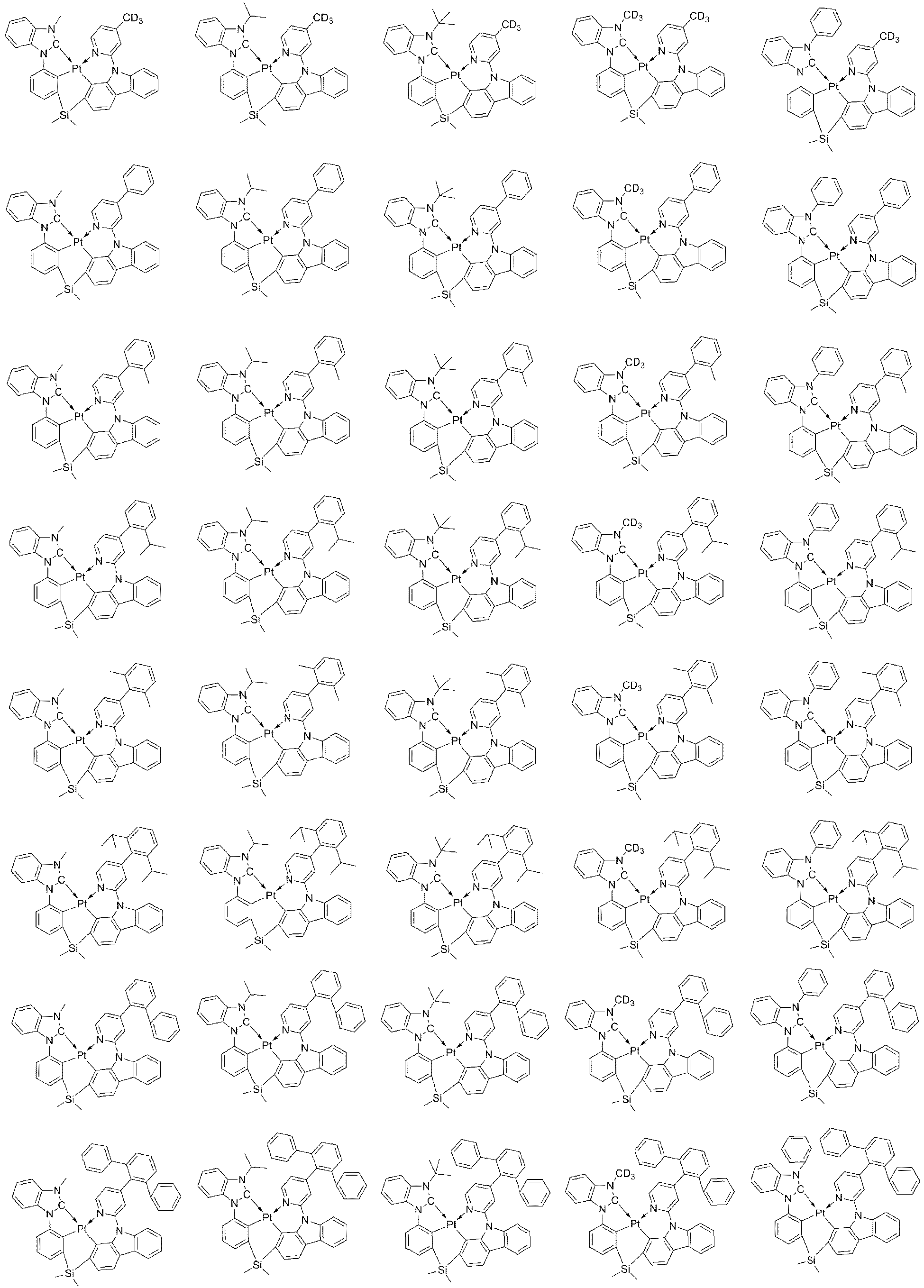 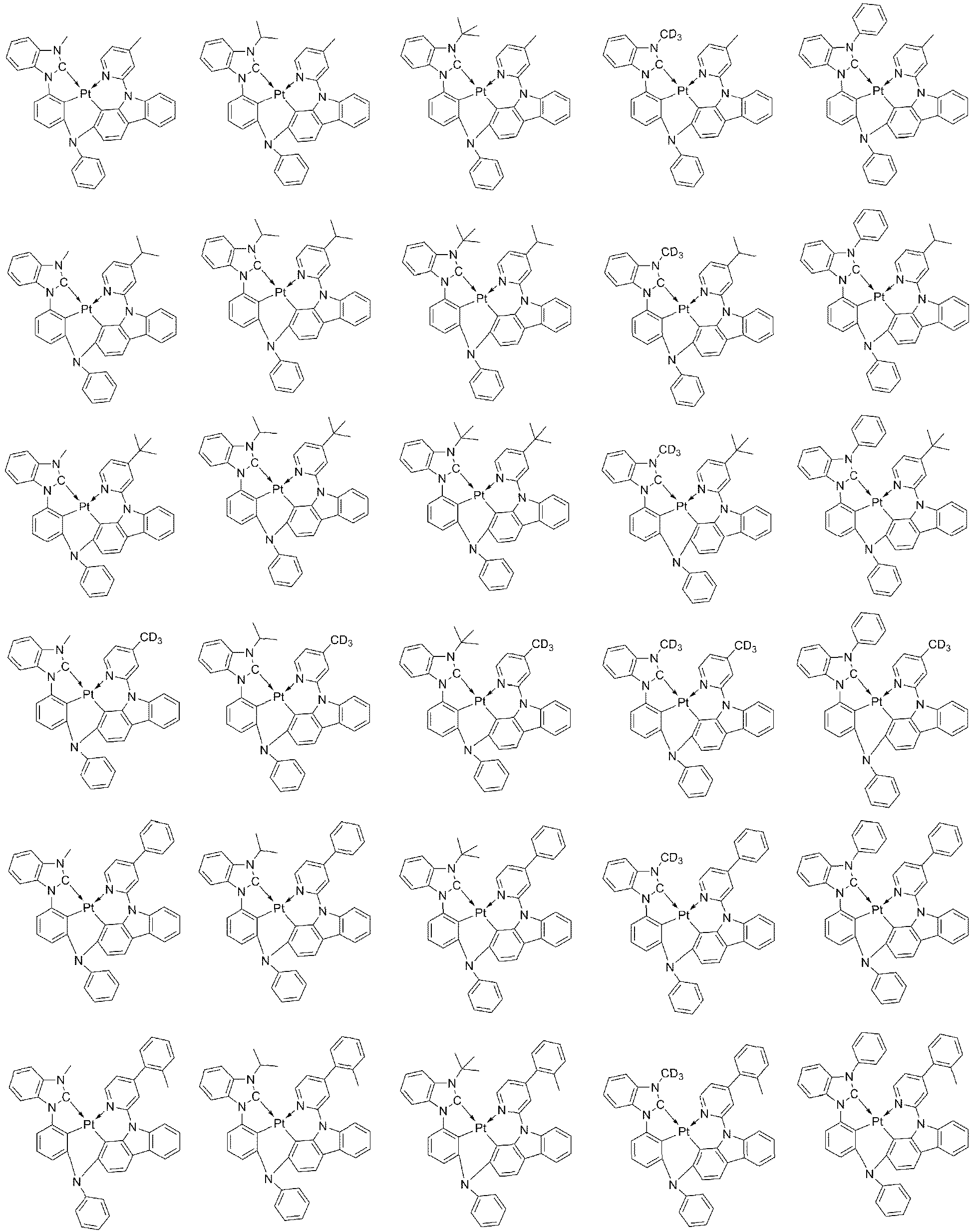 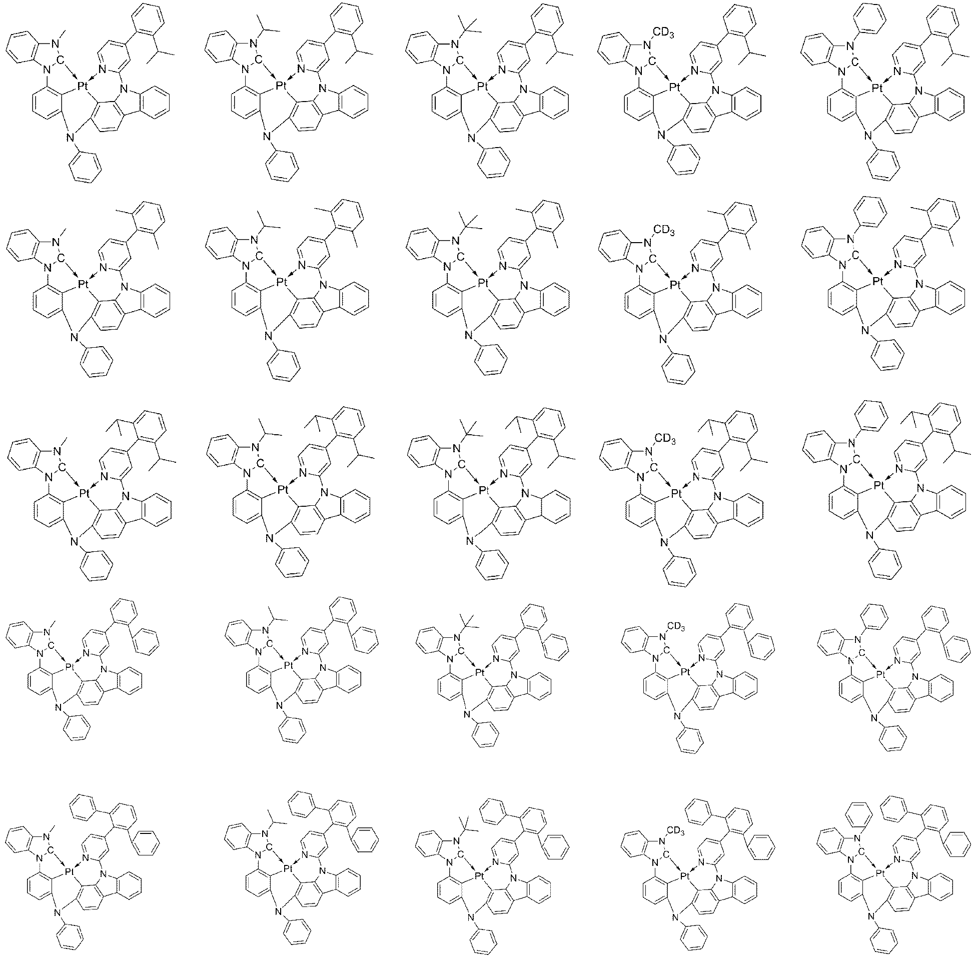 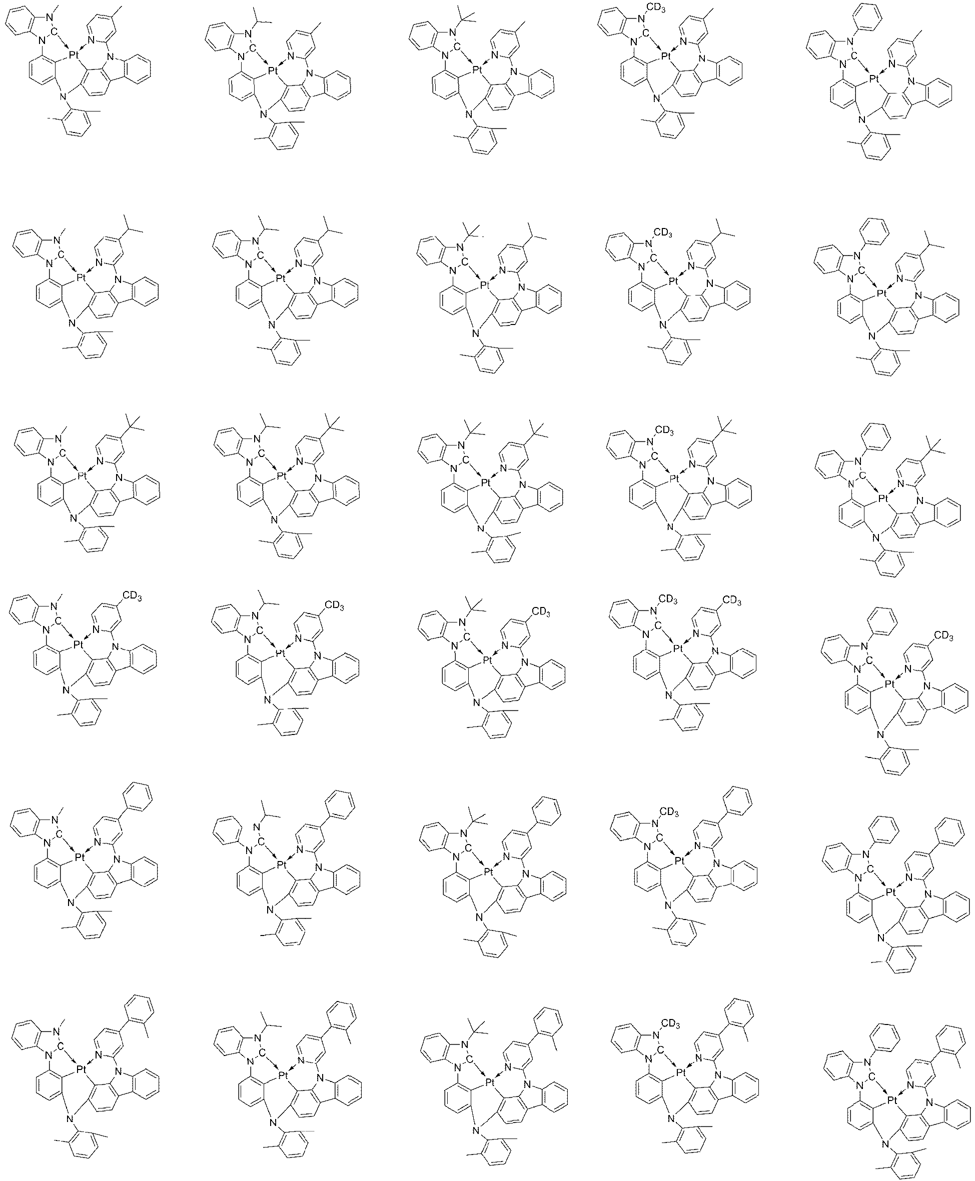 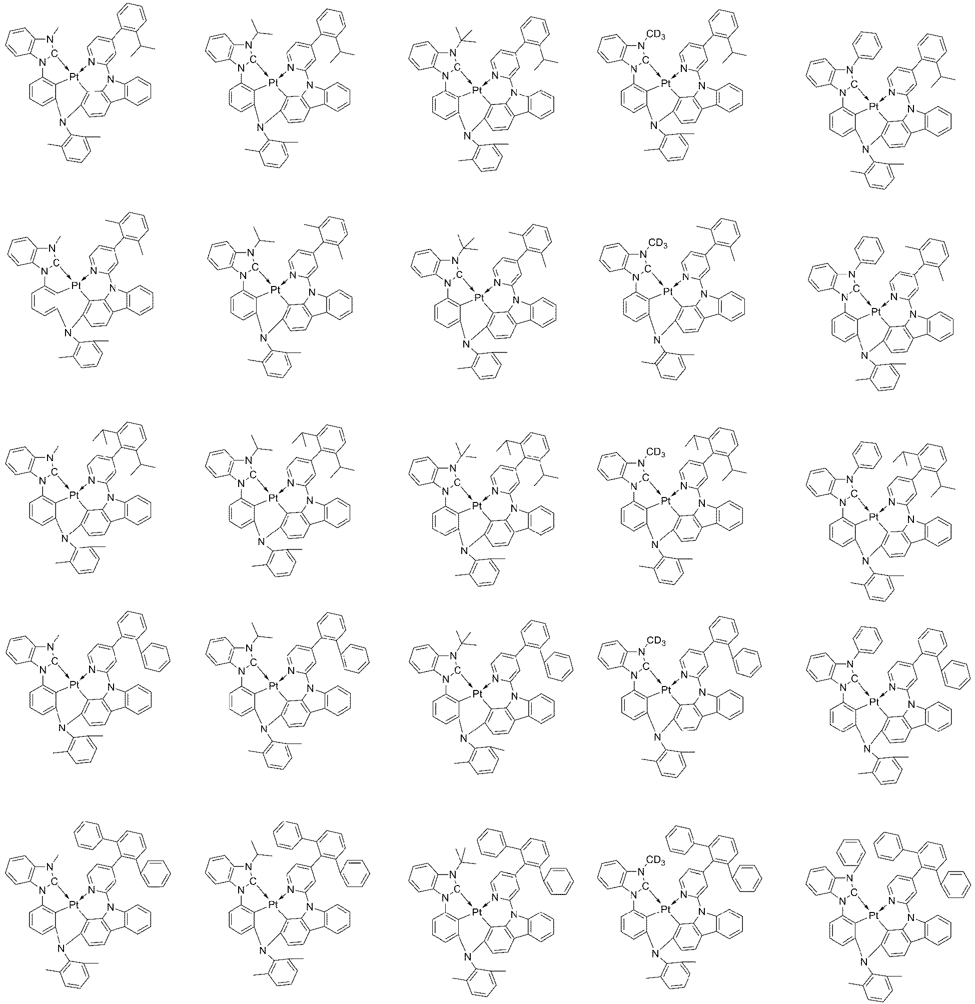 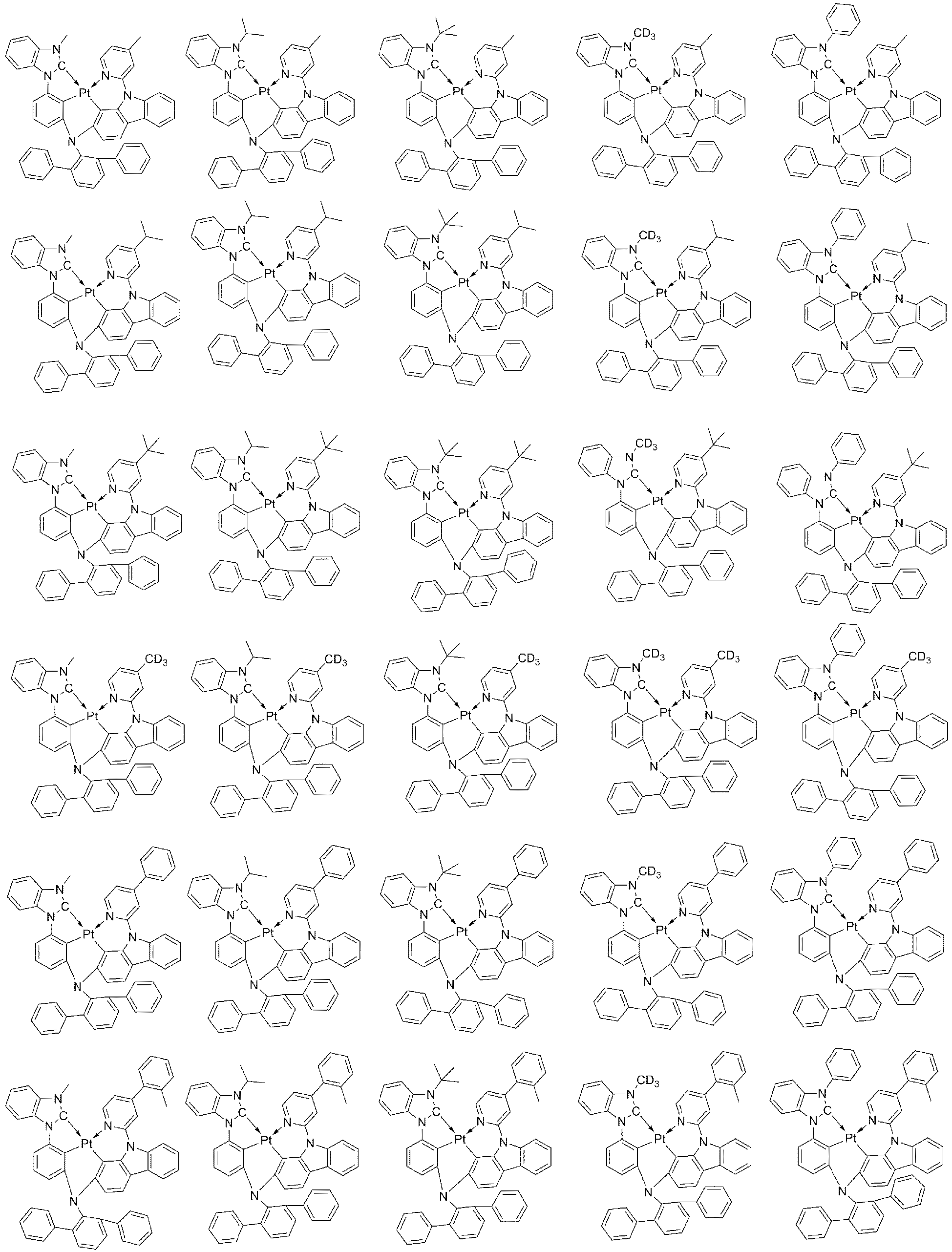 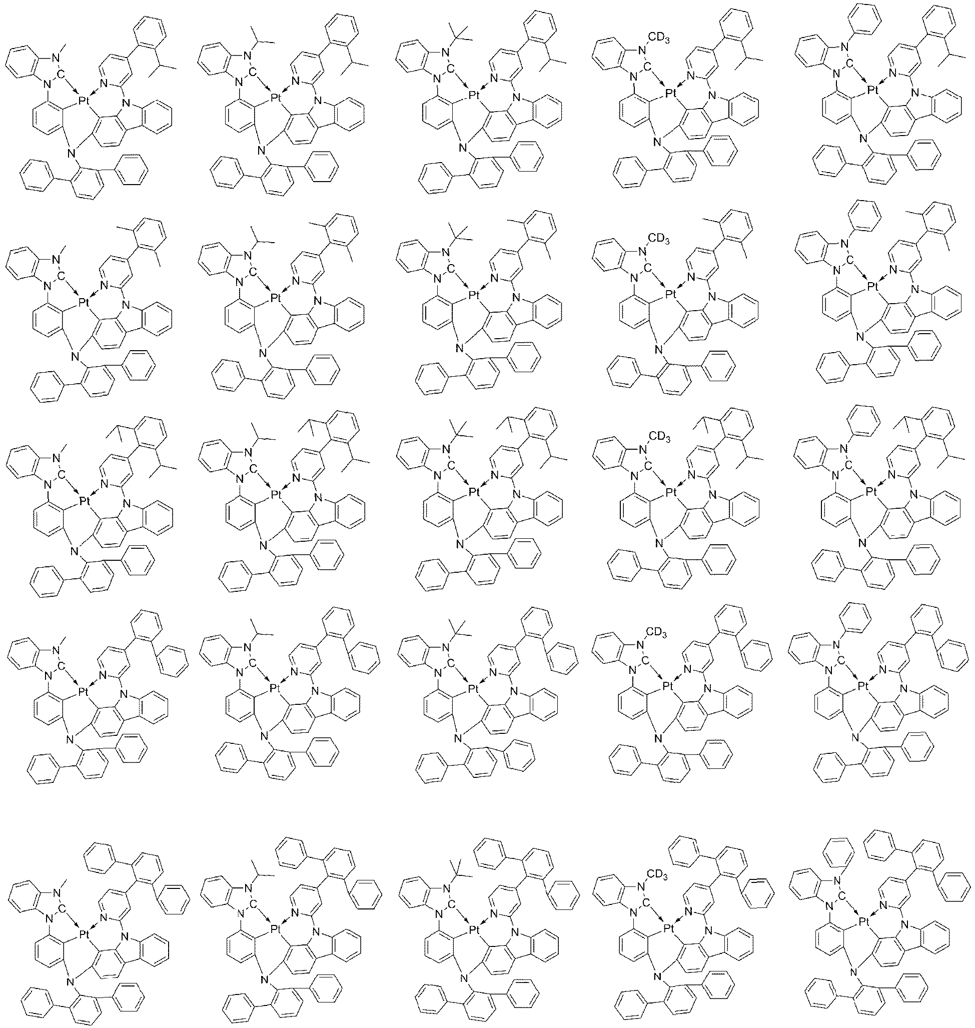 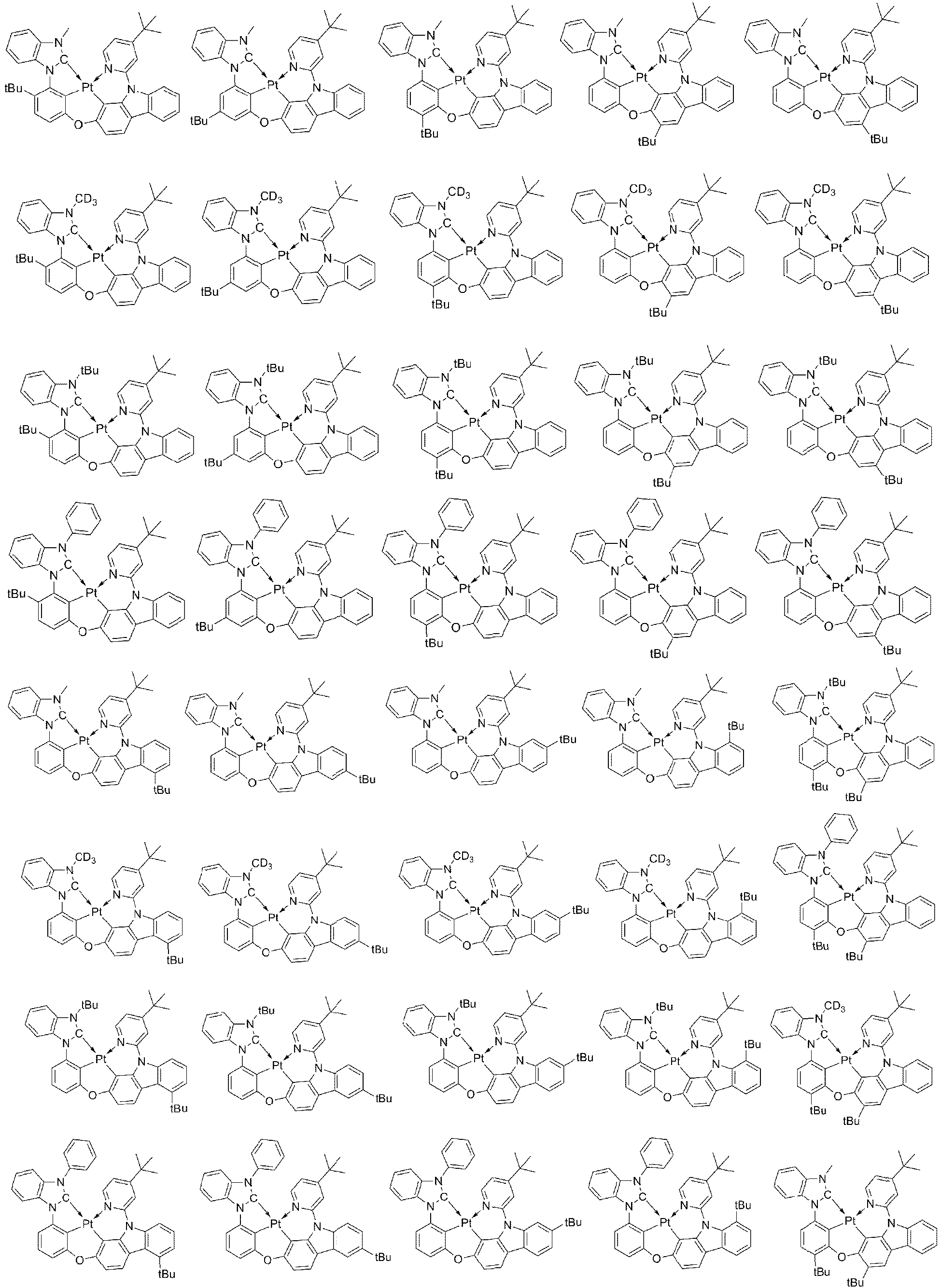 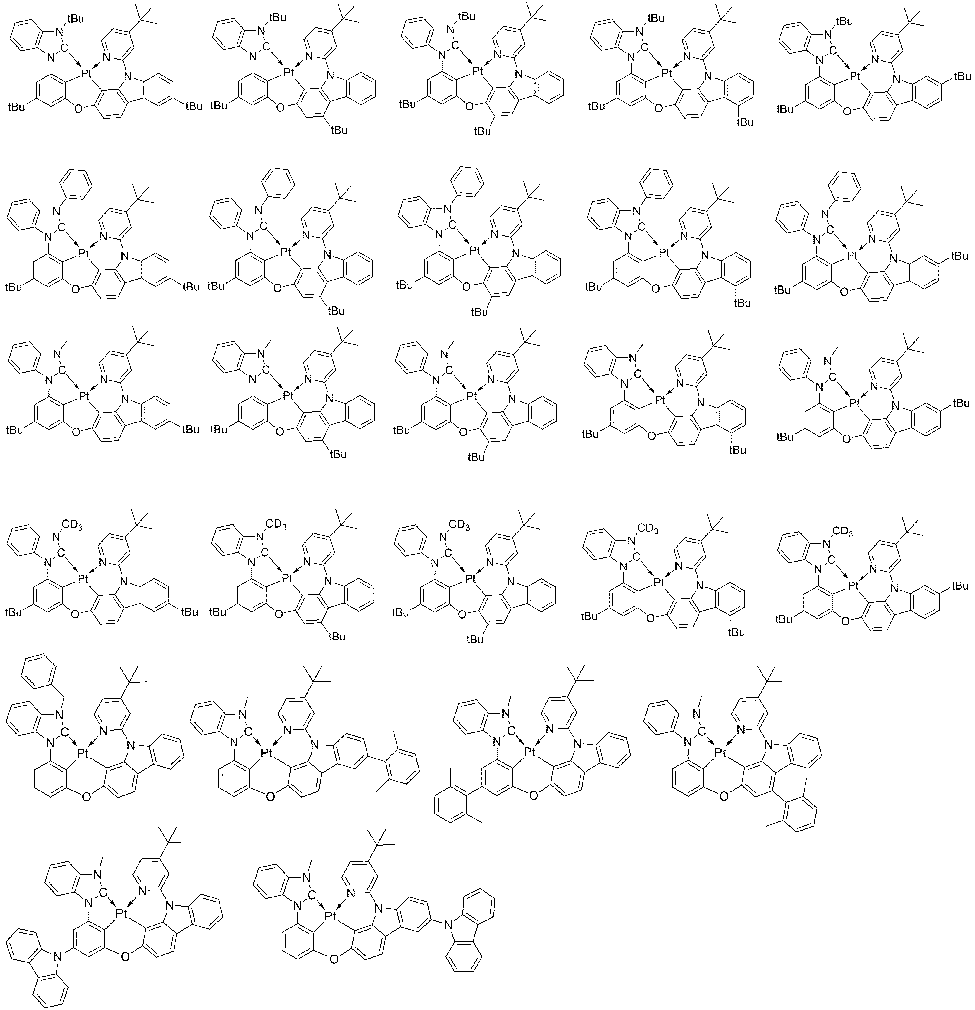 <group V>
a compound represented by Formula A below:

   <Formula A> (L₁₀₁)ₙ₁₀₁-M₁₀₁-(L₁₀₂)ₘ₁₀₁
L₁₀₁, n101, M₁₀₁, L₁₀₂, and m101 in Formula A are the same as shown in Table 1:

**Table 1**

| Compound name | L₁₀₁ | n101 | M₁₀₁ | L₁₀₂ | m101 |
|---|---|---|---|---|---|
| BD263 | LM11 | 2 | Pt | - | 0 |
| BD264 | LM13 | 2 | Pt | - | 0 |
| BD265 | LM15 | 2 | Pt | - | 0 |
| BD266 | LM45 | 2 | Pt | - | 0 |
| BD267 | LM47 | 2 | Pt | - | 0 |
| BD268 | LM49 | 2 | Pt | - | 0 |
| BD269 | LM98 | 2 | Pt | - | 0 |
| BD270 | LM100 | 2 | Pt | - | 0 |
| BD271 | LM102 | 2 | Pt | - | 0 |
| BD272 | LM132 | 2 | Pt | - | 0 |
| BD273 | LM134 | 2 | Pt | - | 0 |
| BD274 | LM136 | 2 | Pt | - | 0 |
| BD275 | LM151 | 2 | Pt | - | 0 |
| BD276 | LM153 | 2 | Pt | - | 0 |
| BD277 | LM158 | 2 | Pt | - | 0 |
| BD278 | LM180 | 2 | Pt | - | 0 |
| BD279 | LM182 | 2 | Pt | - | 0 |
| BD280 | LM187 | 2 | Pt | - | 0 |
| BD281 | LM201 | 2 | Pt | - | 0 |
| BD282 | LM206 | 2 | Pt | - | 0 |
| BD283 | LM211 | 2 | Pt | - | 0 |
| BD284 | LM233 | 2 | Pt | - | 0 |
| BD285 | LM235 | 2 | Pt | - | 0 |
| BD286 | LM240 | 2 | Pt | - | 0 |
| BD287 | LFM5 | 2 | Pt | - | 0 |
| BD288 | LFM6 | 2 | Pt | - | 0 |
| BD289 | LFM7 | 2 | Pt | - | 0 |
| BD290 | LFP5 | 2 | Pt | - | 0 |
| BD291 | LFP6 | 2 | Pt | - | 0 |
| BD292 | LFP7 | 2 | Pt | - | 0 |
| BD293 | LM47 | 1 | Pt | AN1 | 1 |
| BD294 | LM47 | 1 | Pt | AN2 | 1 |
| BD295 | LM47 | 1 | Pt | AN3 | 1 |
| BD296 | LM47 | 1 | Pt | AN4 | 1 |
| BD297 | LM47 | 1 | Pt | AN5 | 1 |

LM11, LM13, LM15, LM45, LM47, LM49, LM98, LM100, LM102, LM132, LM134, LM136, LM151, LM153, LM158, LM180, LM182, LM187, LM201, LM206, LM211, LM233, LM235, LM240, LFM5, LFM6, LFM7, LFP5, LFP6, and LFP7 in Table 1 may be understood by referring to Formulae 1-1 to 1-3 and Tables 2 to 4:

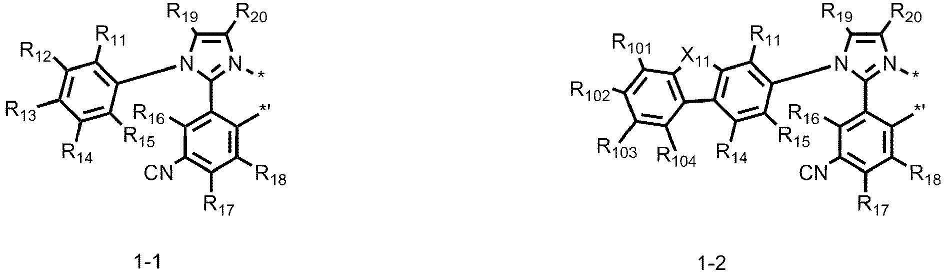

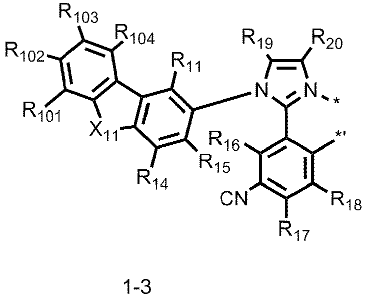

**Table 2**

| Formula 1-1 | | | | | | | | | | |
|---|---|---|---|---|---|---|---|---|---|---|
| Ligand name | R₁₁ | R₁₂ | R₁₃ | R₁₄ | R₁₅ | R₁₆ | R₁₇ | R₁₈ | R₁₉ | R₂₀ |
| LM11 | Y3 | D | Y11 | D | Y3 | D | D | D | D | D |
| LM13 | Y3 | D | Y11 | D | Y3 | D | Y3 | D | D | D |
| LM15 | Y3 | D | Y11 | D | Y3 | D | Y12 | D | D | D |
| LM45 | Y3 | D | Y12 | D | Y3 | D | D | D | D | D |
| LM47 | Y3 | D | Y12 | D | Y3 | D | Y3 | D | D | D |
| LM49 | Y3 | D | Y12 | D | Y3 | D | Y12 | D | D | D |
| LM98 | Y10 | D | Y13 | D | Y10 | D | D | D | D | D |
| LM100 | Y10 | D | Y13 | D | Y10 | D | Y3 | D | D | D |
| LM102 | Y10 | D | Y13 | D | Y10 | D | Y12 | D | D | D |
| LM132 | Y10 | D | Y14 | D | Y10 | D | D | D | D | D |
| LM134 | Y10 | D | Y14 | D | Y10 | D | Y3 | D | D | D |
| LM136 | Y10 | D | Y14 | D | Y10 | D | Y12 | D | D | D |
| LM151 | Y3 | D | Y15 | D | Y3 | D | D | D | D | D |
| LM153 | Y3 | D | Y15 | D | Y3 | D | Y3 | D | D | D |
| LM158 | Y3 | D | Y15 | D | Y3 | D | Y12 | D | D | D |
| LM180 | Y10 | D | Y15 | D | Y10 | D | D | D | D | D |
| LM182 | Y10 | D | Y15 | D | Y10 | D | Y3 | D | D | D |
| LM187 | Y10 | D | Y15 | D | Y10 | D | Y12 | D | D | D |
| LM201 | Y3 | Y15 | D | D | Y3 | D | D | D | D | D |
| LM206 | Y3 | Y15 | D | D | Y3 | D | Y3 | D | D | D |
| LM211 | Y3 | Y15 | D | D | Y3 | D | Y12 | D | D | D |
| LM233 | Y10 | Y15 | D | D | Y10 | D | D | D | D | D |
| LM235 | Y10 | Y15 | D | D | Y10 | D | Y3 | D | D | D |
| LM240 | Y10 | Y15 | D | D | Y10 | D | Y12 | D | D | D |

**[Table 3]**

| Formula 1-2 | | | | | | | | | | | | | |
|---|---|---|---|---|---|---|---|---|---|---|---|---|---|
| Ligand name | R₁₁ | X₁₁ | R₁₀₁ | R₁₀₂ | R₁₀₃ | R₁₀₄ | R₁₄ | R₁₅ | R₁₆ | R₁₇ | R₁₈ | R₁₉ | R₂₀ |
| LFM5 | Y10 | ○ | D | D | D | D | D | Y10 | D | D | D | D | D |
| LFM6 | Y10 | ○ | D | D | D | D | D | Y10 | D | Y3 | D | D | D |
| LFM7 | Y10 | ○ | D | D | D | D | D | Y10 | D | Y12 | D | D | D |

**Table 4**

| Formula 1-3 | | | | | | | | | | | | | |
|---|---|---|---|---|---|---|---|---|---|---|---|---|---|
| Ligand name | R₁₁ | X₁₁ | R₁₀₁ | R₁₀₂ | R₁₀₃ | R₁₀₄ | R₁₄ | R₁₅ | R₁₆ | R₁₇ | R₁₈ | R₁₉ | R₂₀ |
| LFP5 | Y10 | ○ | D | D | D | D | D | Y10 | D | D | D | D | D |
| LFP6 | Y10 | ○ | D | D | D | D | D | Y10 | D | Y3 | D | D | D |
| LFP7 | Y10 | ○ | D | D | D | D | D | Y10 | D | Y12 | D | D | D |

Y1 to Y18 in Tables 2 to 4 are the same as below:

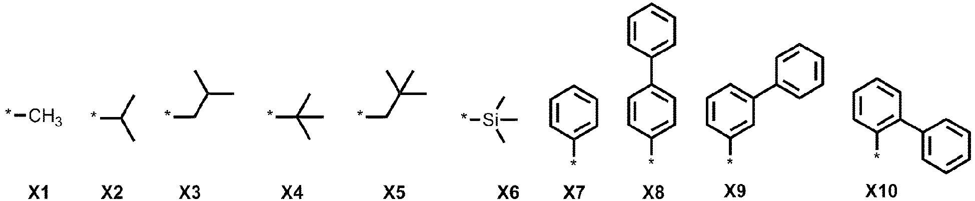

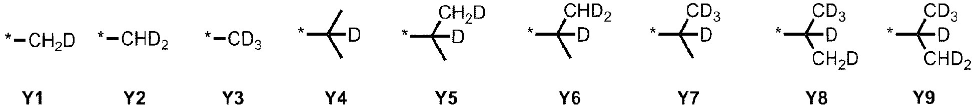

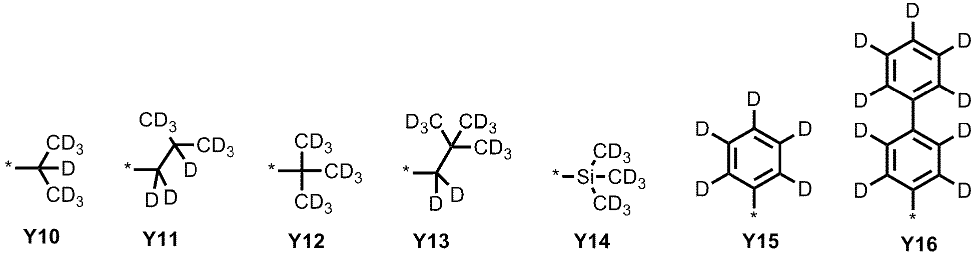

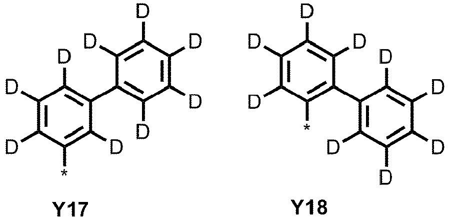

AN1 to AN5 in Table 1 are the same as below:

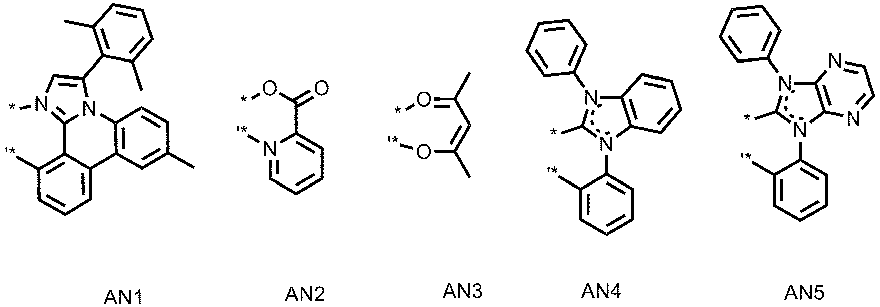

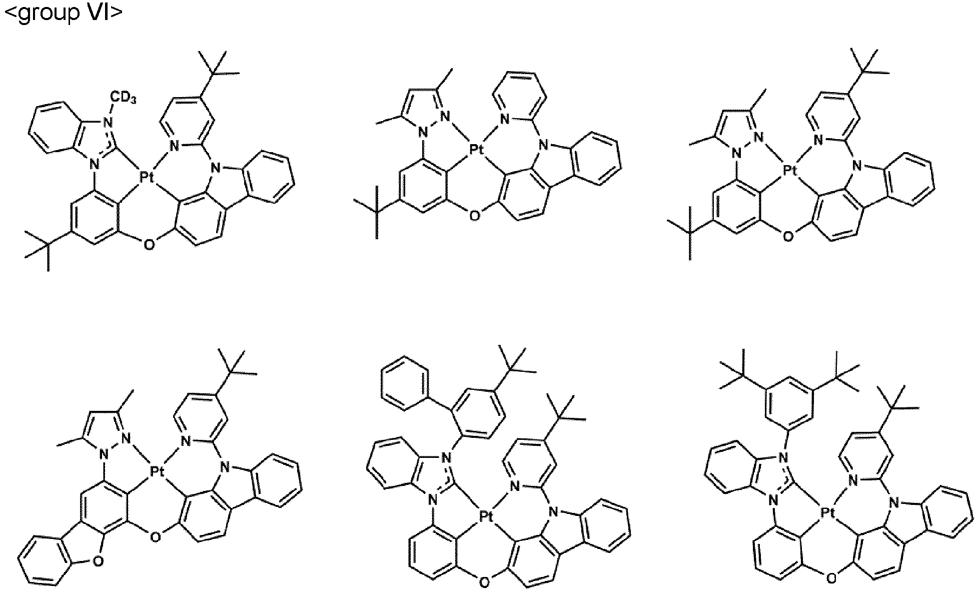

In one or more embodiments, the sensitizer may be a thermally activated delayed fluorescence emitter. Thermally activated delayed fluorescence emitter may not include metal. In one embodiment, thermally activated delayed fluorescence emitter may satisfy Condition 7:

<Condition 7> ΔE_{ST} :5 0.3 eV

wherein, in Condition 7,
ΔE_{ST} is the difference between the lowest excitation singlet energy level and the lowest excitation triplet energy level of the sensitizer.

In one embodiment, the sensitizer may include thermally activated delayed fluorescence emitter represented by Formula 201 or 202:

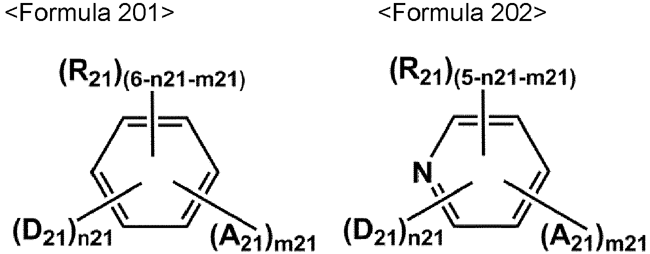

In Formulae 201 and 202,
A21 is an acceptor group,
D21 is a donor group,
m21 may be 1, 2, or 3, and n21 may be 1, 2, or 3,
the sum of n21 and m21 in Formula 201 may be 6 or less, and the sum of n21 and m21 in Formula 202 may be 5 or less,
R₂₁ may be selected from hydrogen, deuterium, -F, -CI, -Br, -I, SF₅, a hydroxyl group, a cyano group, a nitro group, an amidino group, a hydrazine group, a hydrazone group, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₇-C₆₀ alkylaryl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted C₂-C₆₀ alkylheteroaryl group, a substituted or unsubstituted C₁-C₆₀heteroaryloxy group, a substituted or unsubstituted C₁-C₆₀ heteroarylthio group, a substituted or unsubstituted monovalent non-aromatic condensed polycyclic group, a substituted or unsubstituted monovalent non-aromatic condensed heteropolycyclic group, -Si(Q₁)(Q₂)(Q₃), -B(Q₁)(Q₂), -N(Q₁)(Q₂), -P(Q₁)(Q₂), -C(=O)(Q₁), -S(=O)(Q₁), -S(=O)₂(Q₁), -P(=O)(Q₁)(Q₂), and -P(=S)(Q₁)(Q₂), a plurality of R₂₁ may optionally be linked together to form a substituted or unsubstituted C₅-C₃₀ carbocyclic group or a substituted or unsubstituted C₁-C₃₀ heterocyclic group,
Q₁ to Q₃ may each independently selected from hydrogen, deuterium, -F, -CI, -Br, -I, a hydroxyl group, a cyano group, a nitro group, an amidino group, a hydrazine group, a hydrazone group, a C₁-C₆₀ alkyl group, a C₂-C₆₀ alkenyl group, a C₂-C₆₀ alkynyl group, a C₁-C₆₀ alkoxy group, a C₃-C₁₀ cycloalkyl group, a C₁-C₁₀ heterocycloalkyl group, a C₃-C₁₀ cycloalkenyl group, a C₁-C₁₀heterocycloalkenyl group, a C₆-C₆₀ aryl group, a C₇-C₆₀ alkyl aryl group, a C₆-C₆₀ aryloxy group, a C₆-C₆₀ arylthio group, a C₁-C₆₀ heteroaryl group, a C₂-C₆₀ alkyl heteroaryl group, a C₁-C₆₀ heteroaryloxy group, a C₁-C₆₀ heteroarylthio group, a monovalent non-aromatic condensed polycyclic group, a monovalent non-aromatic condensed heteropolycyclic group, a C₁-C₆₀ alkyl group that is substituted with at least one selected from deuterium, -F, a cyano group, a C₁-C₆₀ alkyl group, and a C₆-C₆₀ aryl group, and a C₆-C₆₀ aryl group that is substituted with at least one selected from deuterium, -F, a cyano group, a C₁-C₆₀ alkyl group, and a C₆-C₆₀ aryl group.

For example, A₂₁ in Formula 201 and 202 may be a substituted or unsubstituted π electron-deficient nitrogen-free cyclic group.

In one embodiment, the π electron-deficient nitrogen-free cyclic group may be selected from a benzene group, a heptalene group, an indene group, a naphthalene group, an azulene group, an indacene group, acenaphthylene group, a fluorene group, a spiro-bifluorene group, a benzofluorene group, a dibenzofluorene group, a phenalene group, a phenanthrene group, an anthracene group, a fluoranthene group, a triphenylene group, a pyrene group, a chrysene group, a naphthacene group, a picene group, a perylene group, a pentacene group, a hexacene group, a pentaphene group, a rubicene group, a coronene group, an ovalene group, a pyrrole group, an isoindole group, an indole group, a furan group, a thiophene group, a benzofuran group, a benzothiophene group, a benzocarbazole group, a dibenzocarbazole group, a dibenzofuran group, a dibenzothiophene group, a dibenzothiophene sulfone group, a carbazole group, a dibenzosilole group, an indenocarbazole group, an indolocarbazole group, a benzofurocarbazole group, a benzothienocarbazole group, a triindolobenzene group; and a condensed cyclic group of two or more π electron-deficient nitrogen-free cyclic groups, but embodiments of the present disclosure are not limited thereto.

For example, D₂₁ in Formulae 201 and 202 may be selected from: -F, a cyano group, and an π-electron deficient nitrogen-containing cyclic group;
a C₁-C₆₀ alkyl group, a π-electron deficient nitrogen-containing cyclic group, and a π electron-deficient nitrogen-free cyclic group, each substituted with at least one selected from -F and a cyano group; and
a π-electron deficient nitrogen-containing cyclic group, each substituted with at least one selected from deuterium, a C₁-C₆₀ alkyl group, an π-electron deficient nitrogen-containing cyclic group, and an π electron-deficient nitrogen-free cyclic group.

In one embodiment, the π electron-deficient nitrogen-free cyclic group is the same as described above.

The term "π electron-deficient nitrogen-containing cyclic group" used herein refers to a cyclic group having at least one *-N=*' moiety, and, for example, may be selected from an imidazole group, a pyrazole group, a thiazole group, an isothiazole group, an oxazole group, an isoxazole group, a pyridine group, a pyrazine group, a pyridazine group, a pyrimidine group, an indazole group, a purine group, a quinoline group, an isoquinoline group, a benzoquinoline group, a phthalazine group, a naphthyridine group, a quinoxaline group, a quinazoline group, a cinnoline group, a phenanthridine group, an acridine group, a phenanthroline group, a phenazine group, a benzimidazole group, an isobenzothiazole group, a benzoxazole group, an isobenzoxazole group, a triazole group, a tetrazole group, an oxadiazole group, a triazine group, a thiadiazole group, an imidazopyridine group, an imidazopyrimidine group, an azacarbazole group, and a benzimidazolobenzimidazole group; and a condensed cyclic group in which two or more π electron-deficient nitrogen-containing cyclic groups are condensed with each other.

In one or more embodiments, the sensitizer may be selected from Groups VII to XI, but embodiments of the present disclosure are not limited thereto:

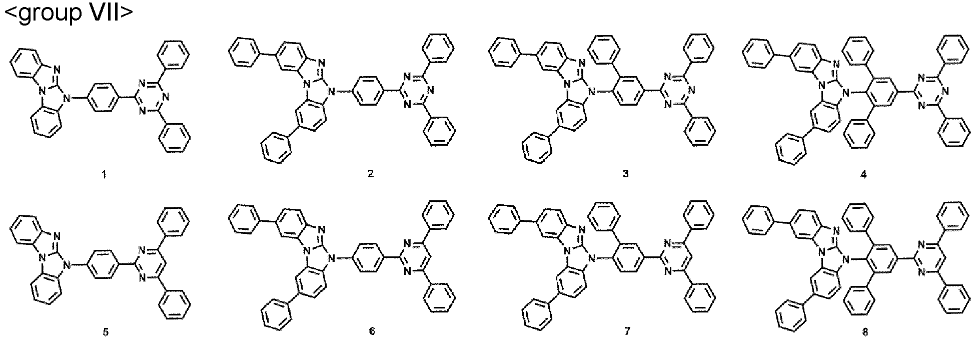

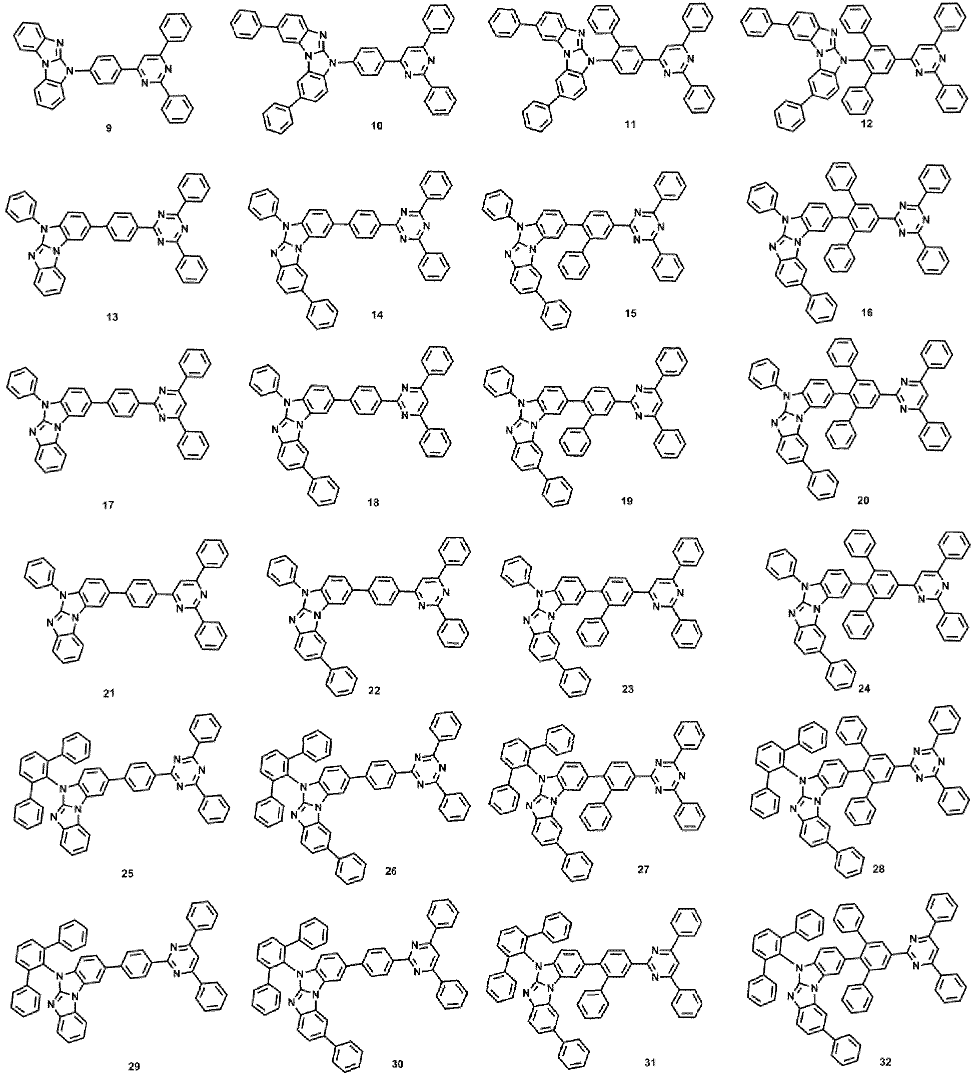

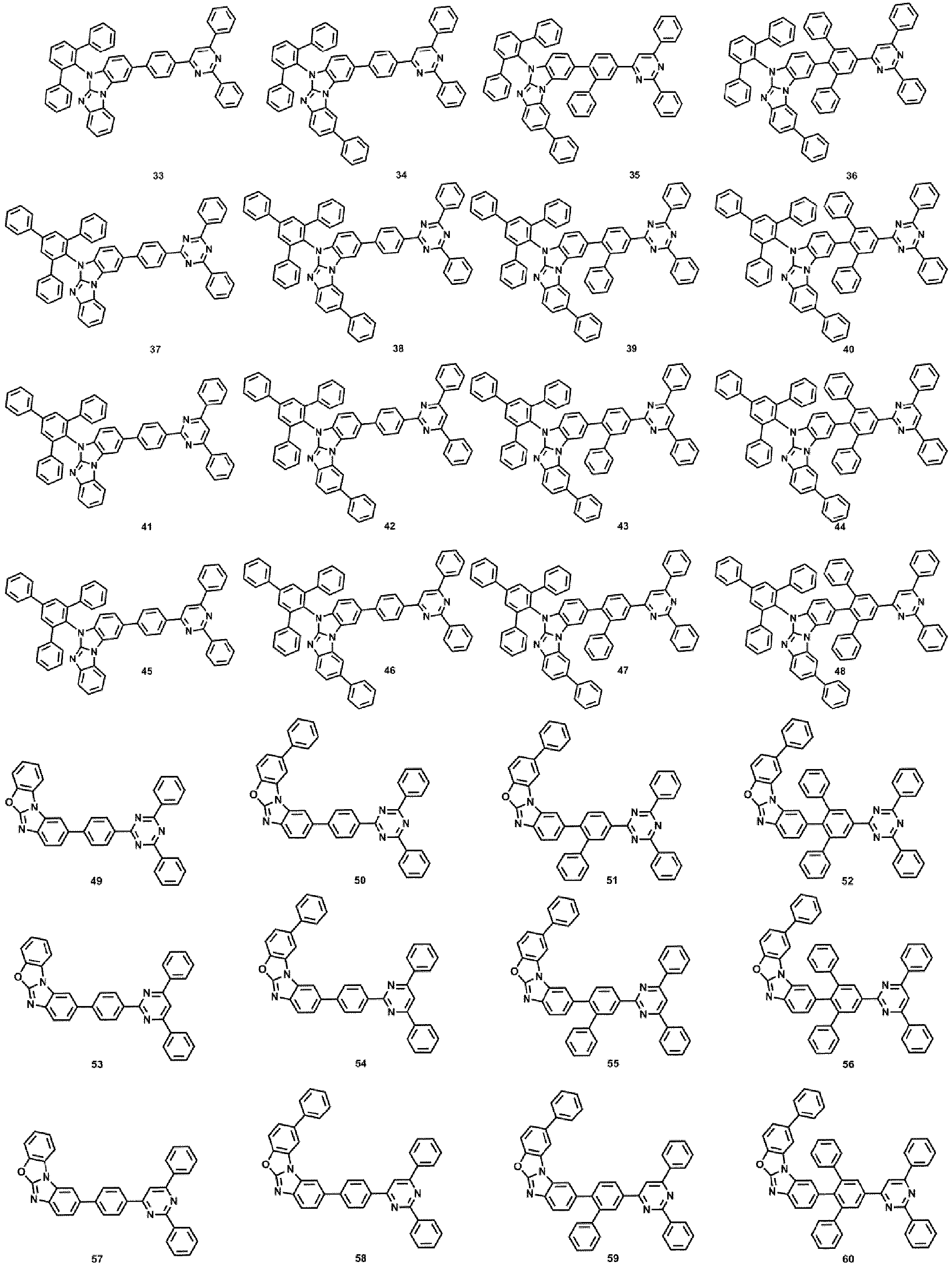

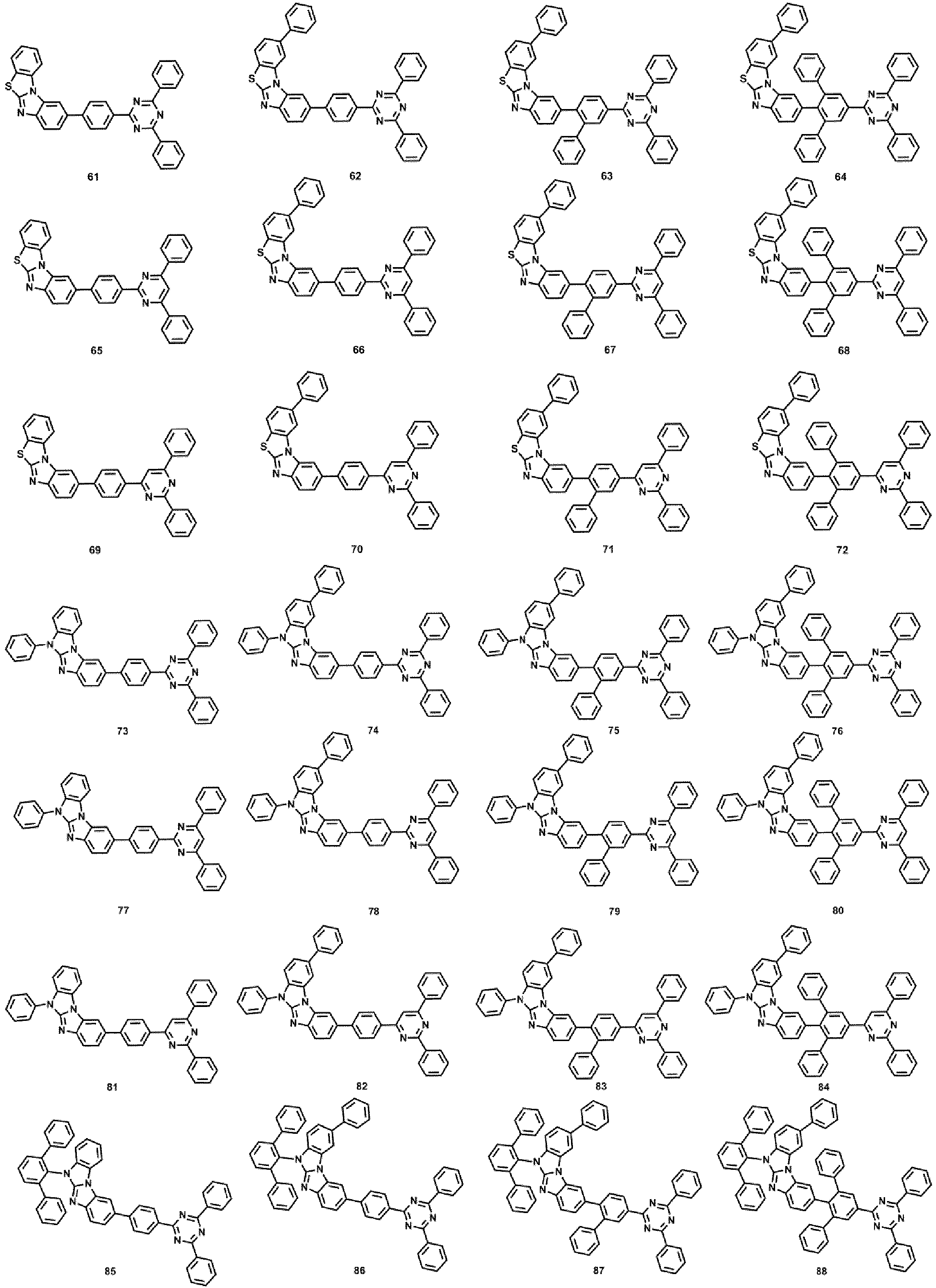

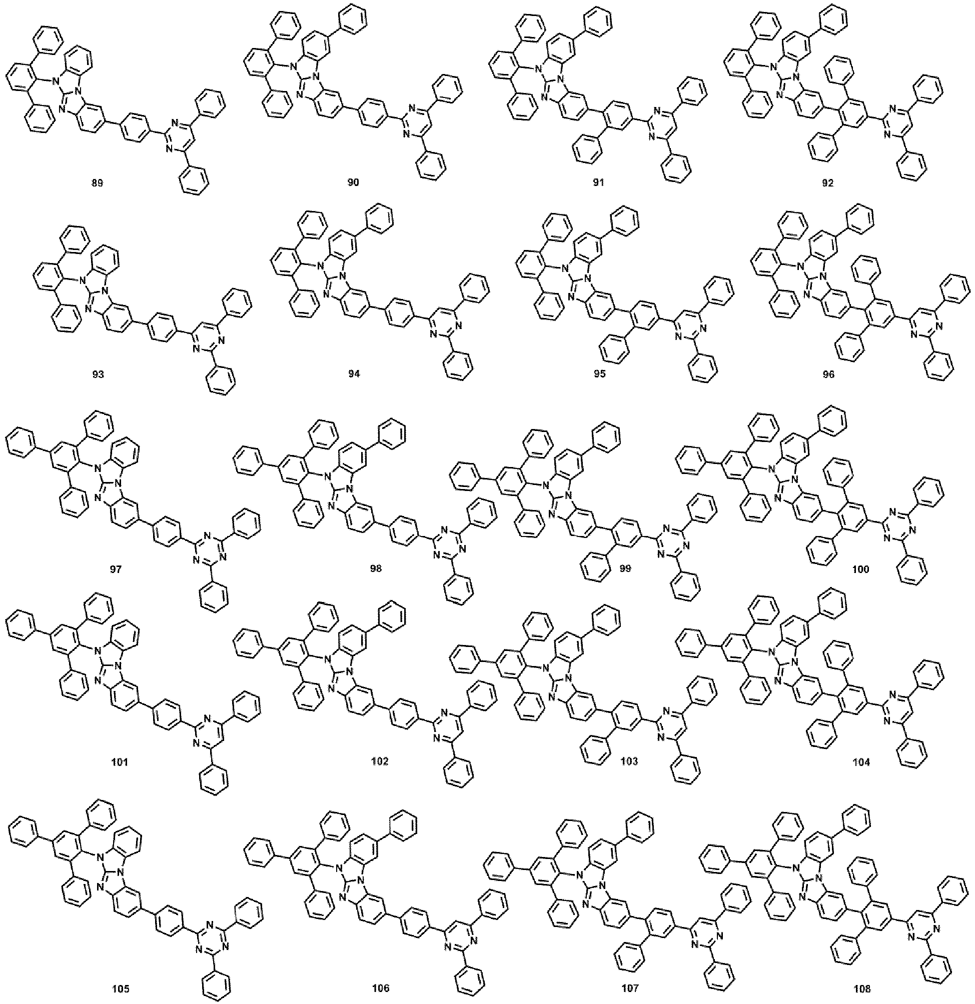

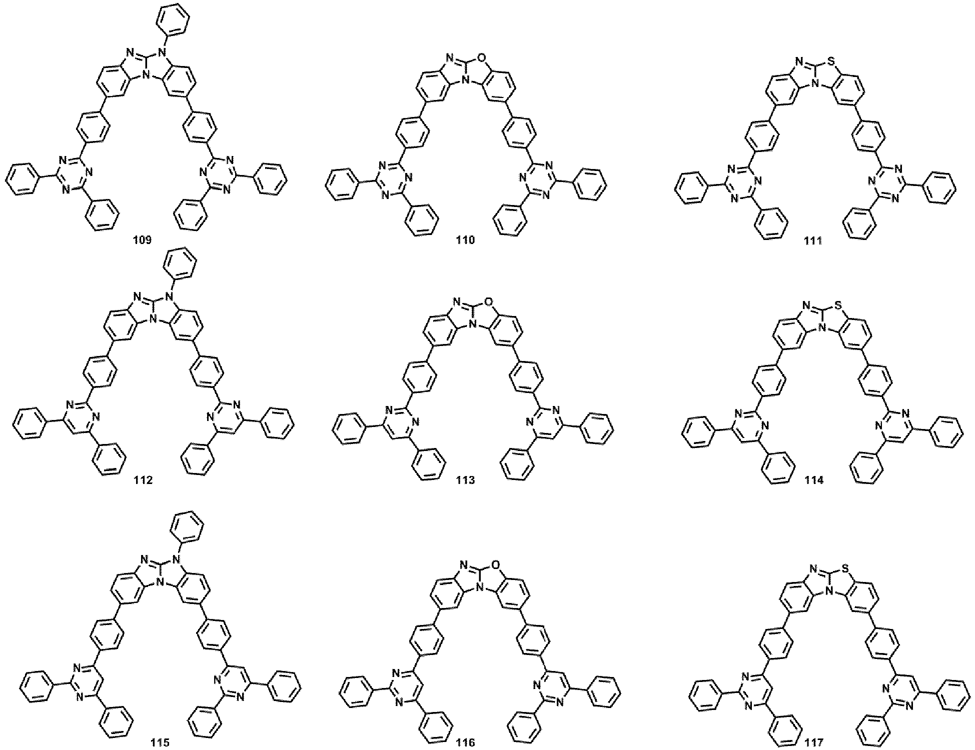

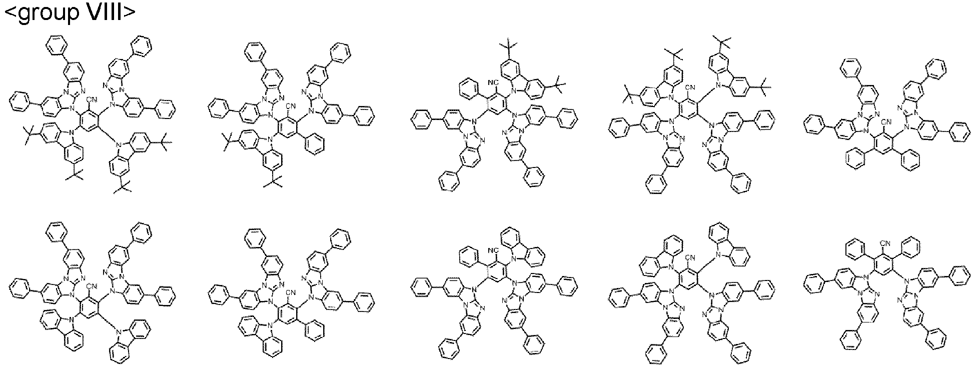

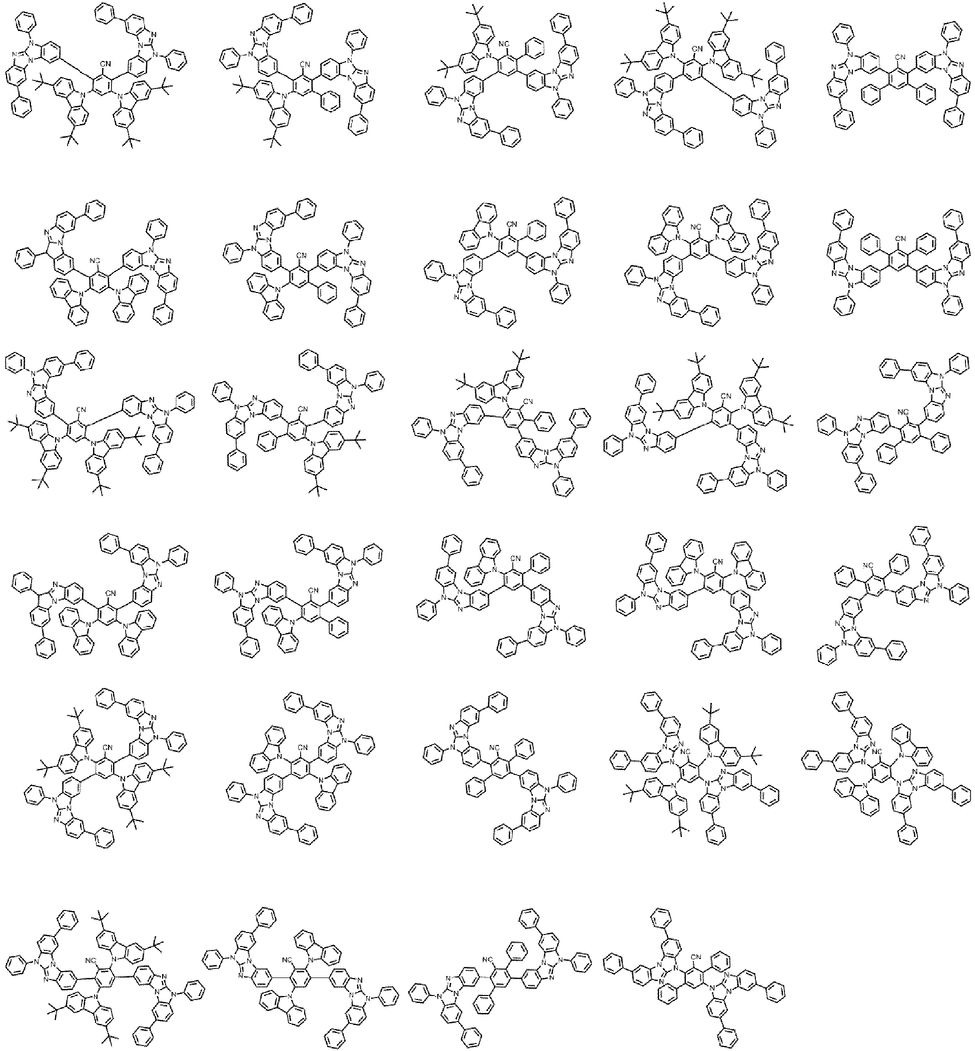

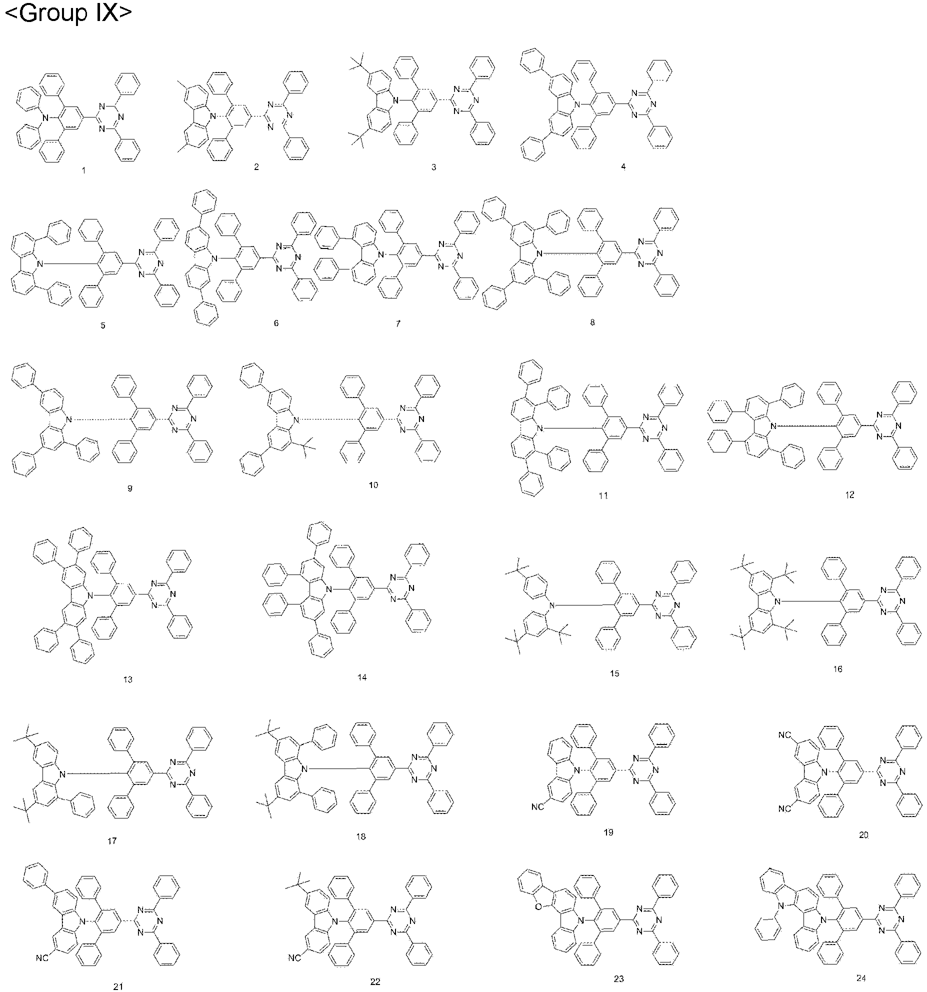

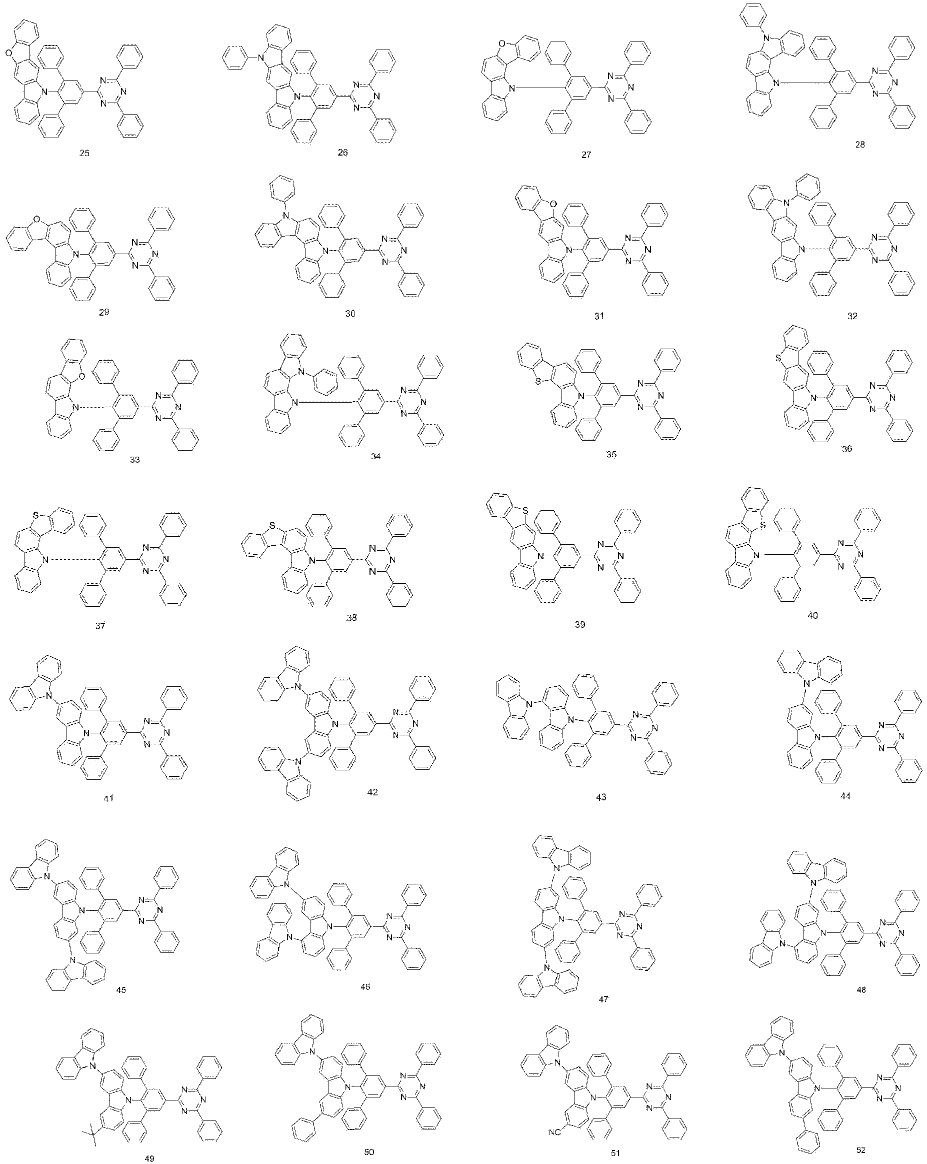

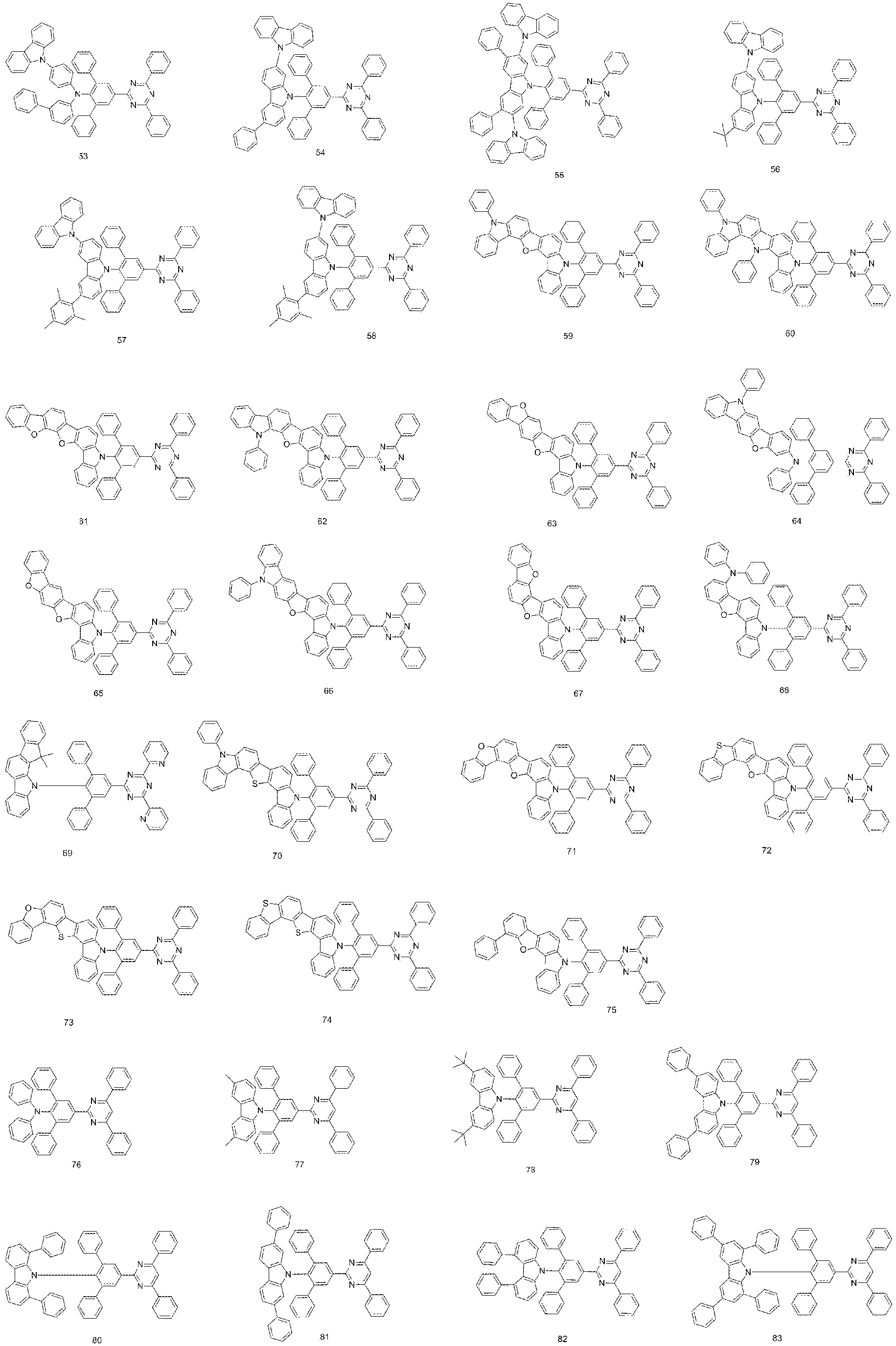

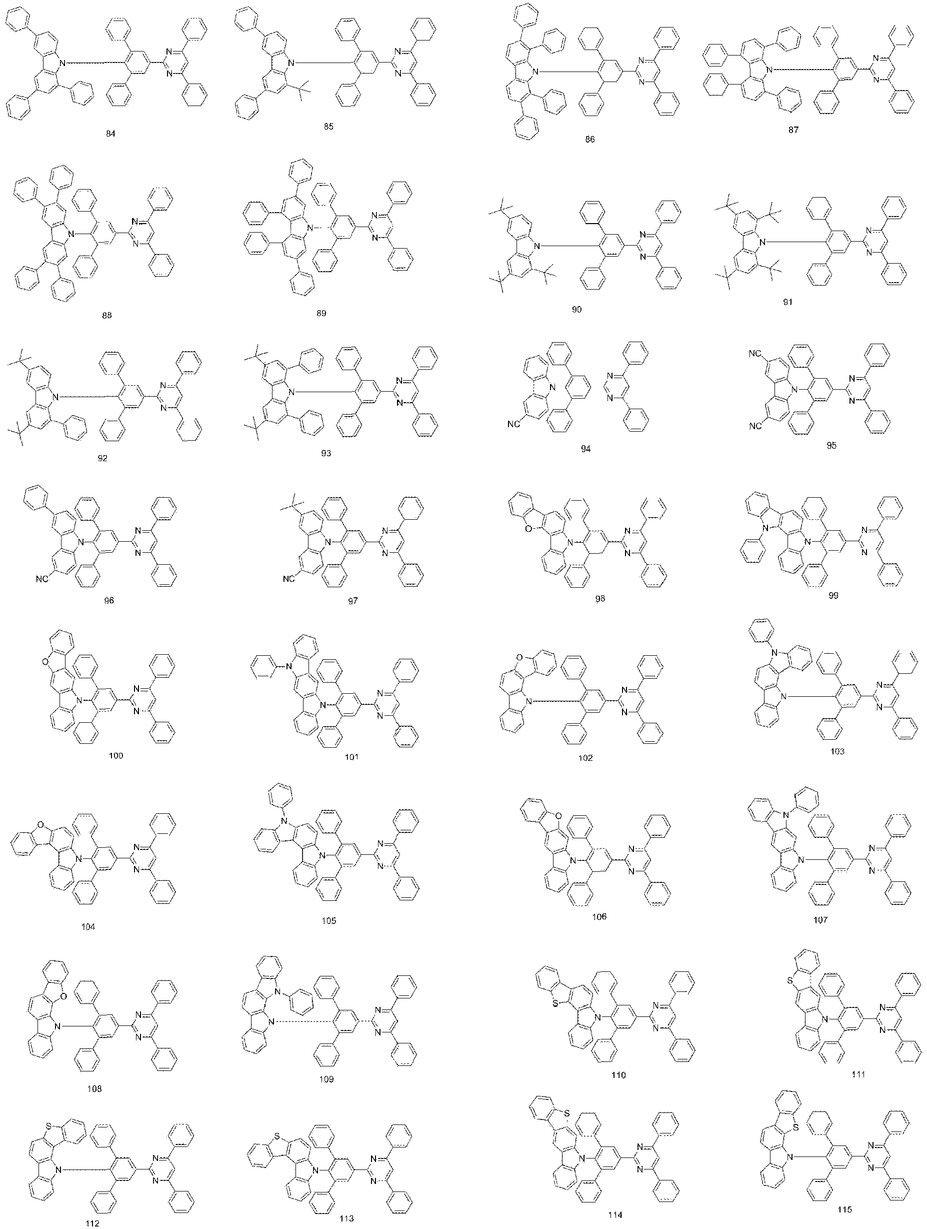

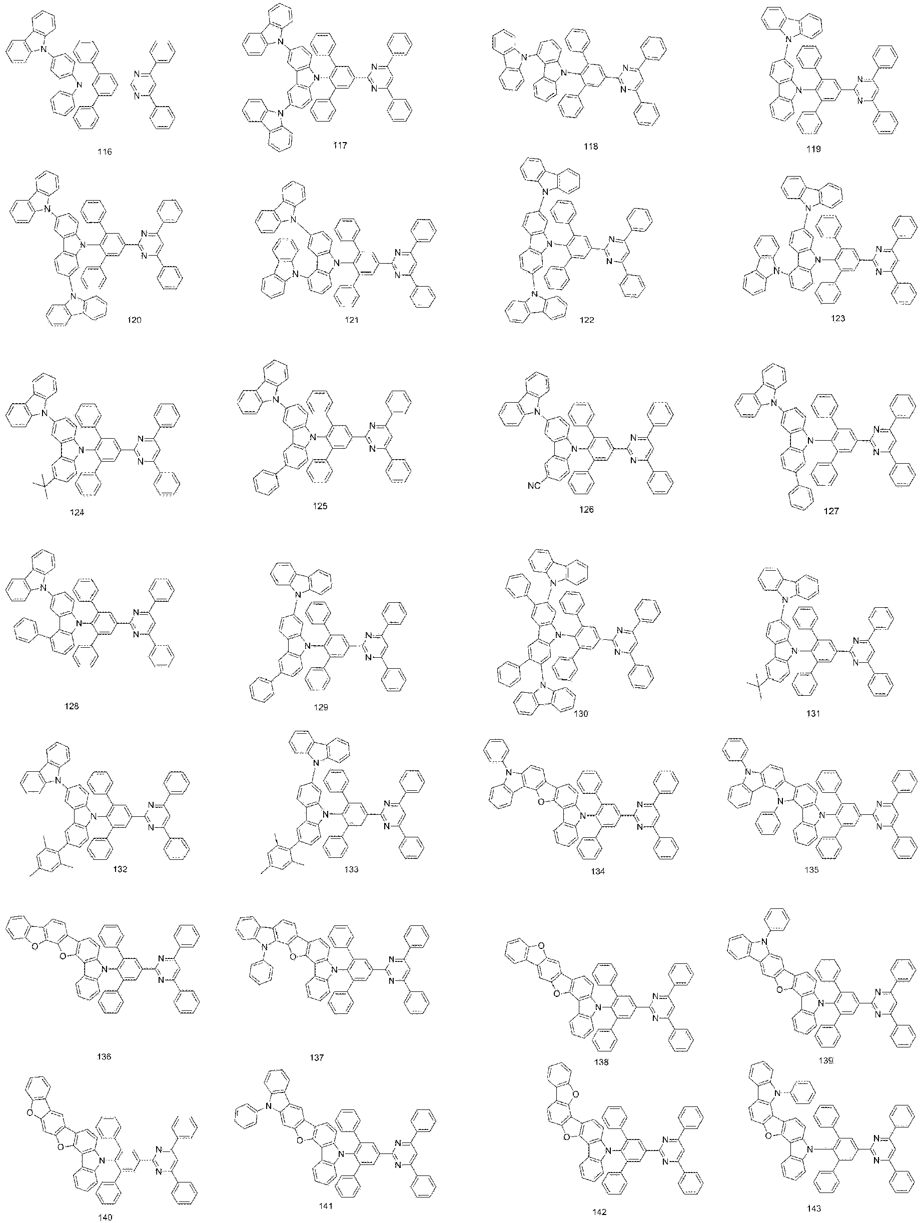

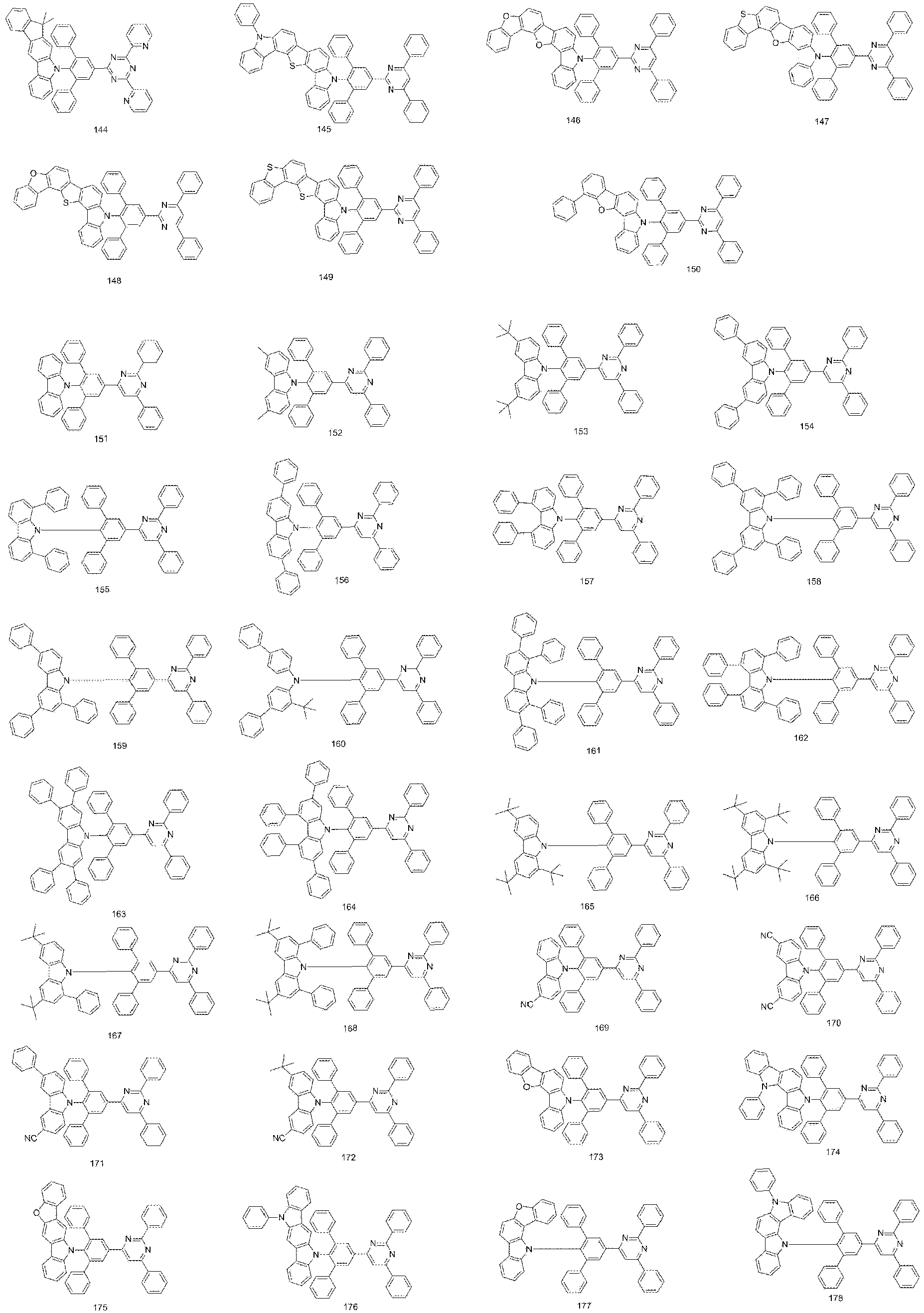

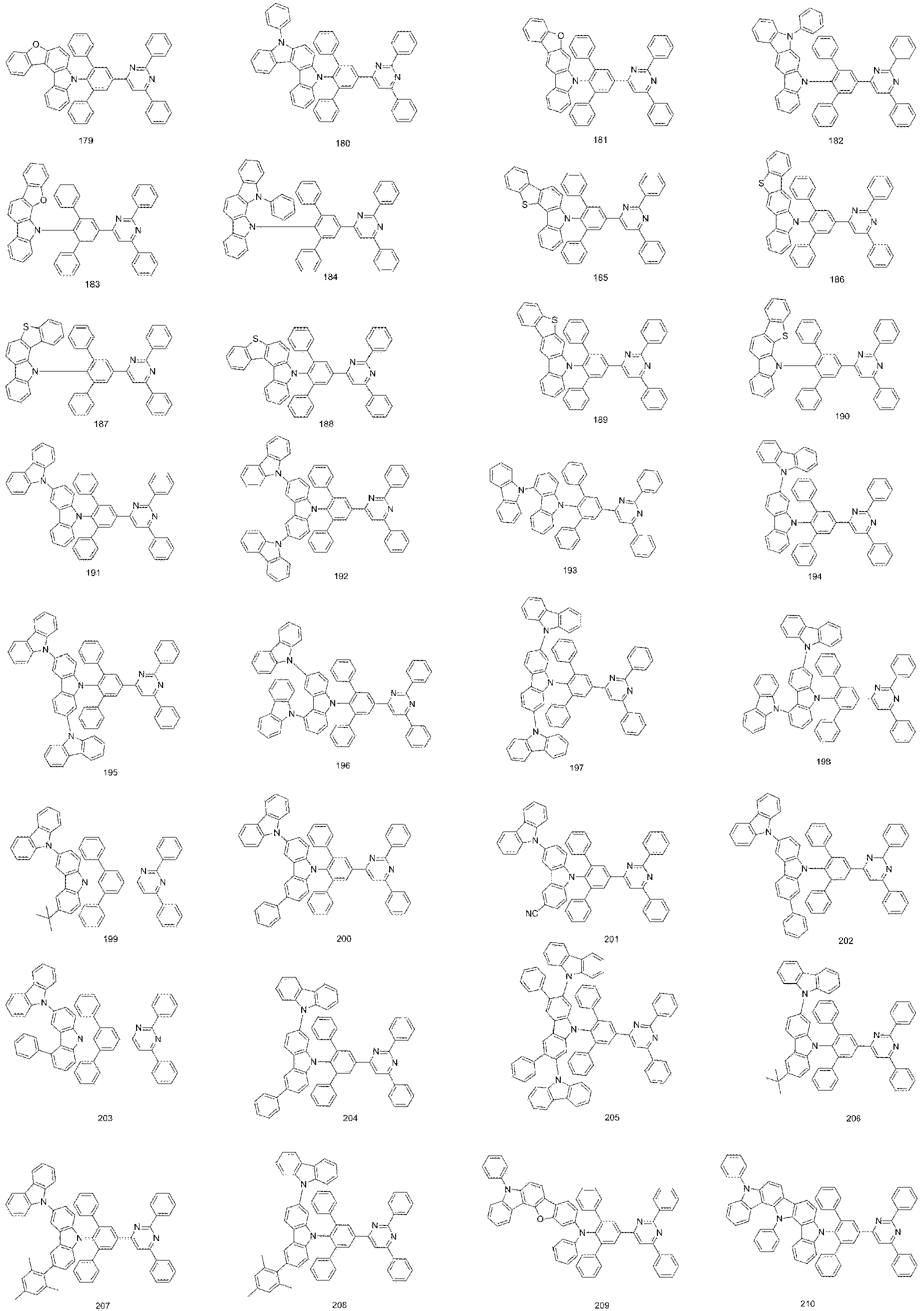

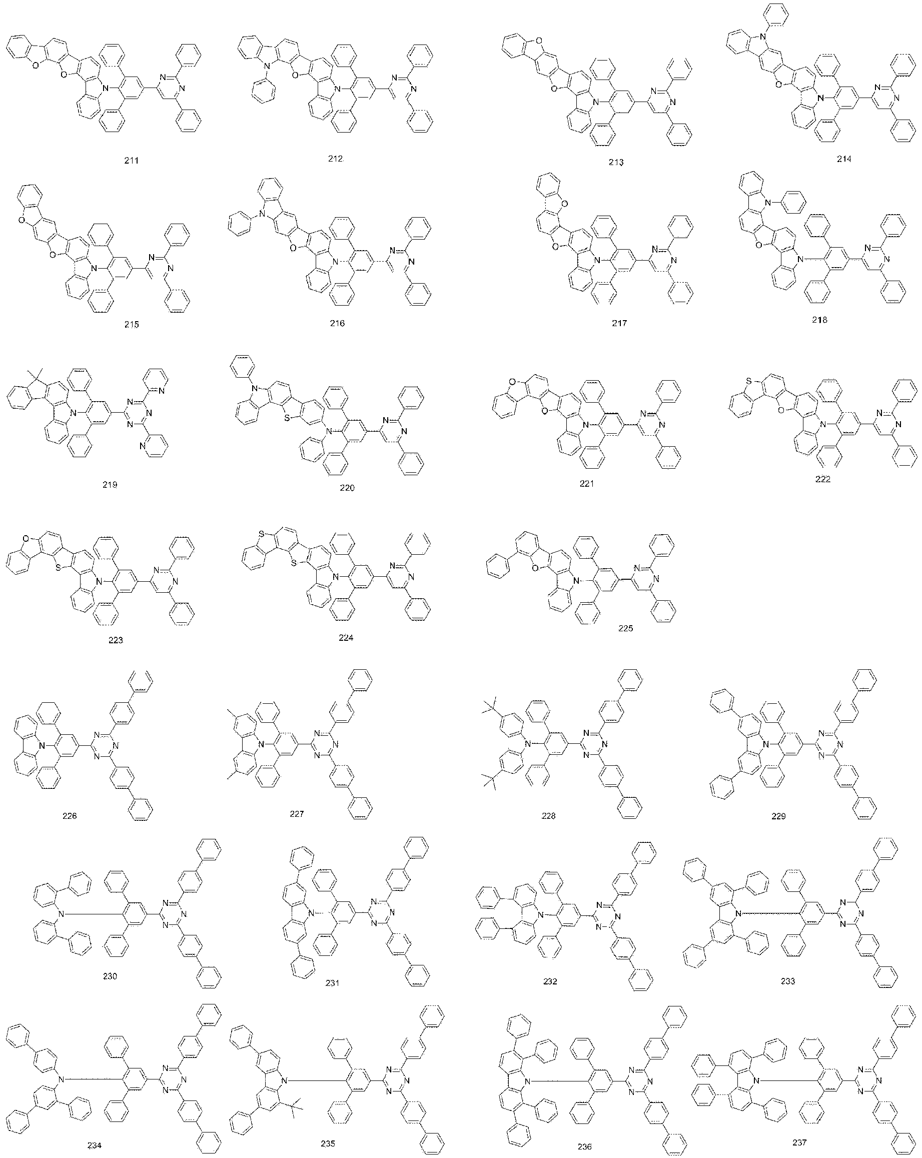

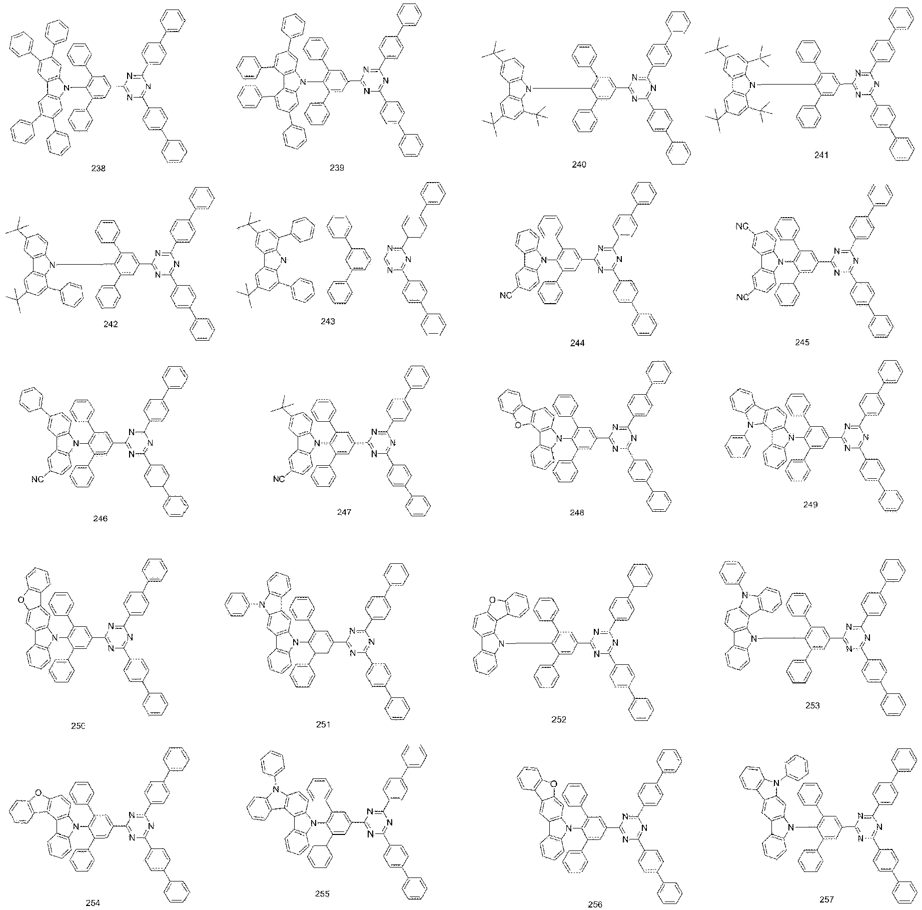

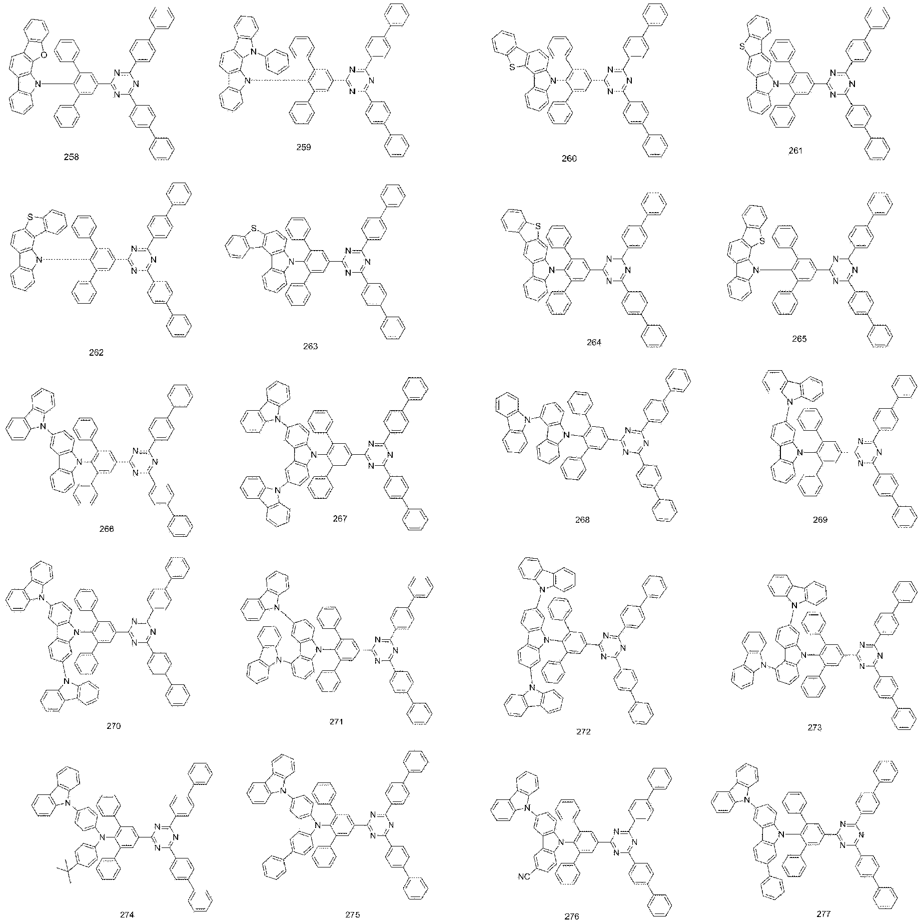

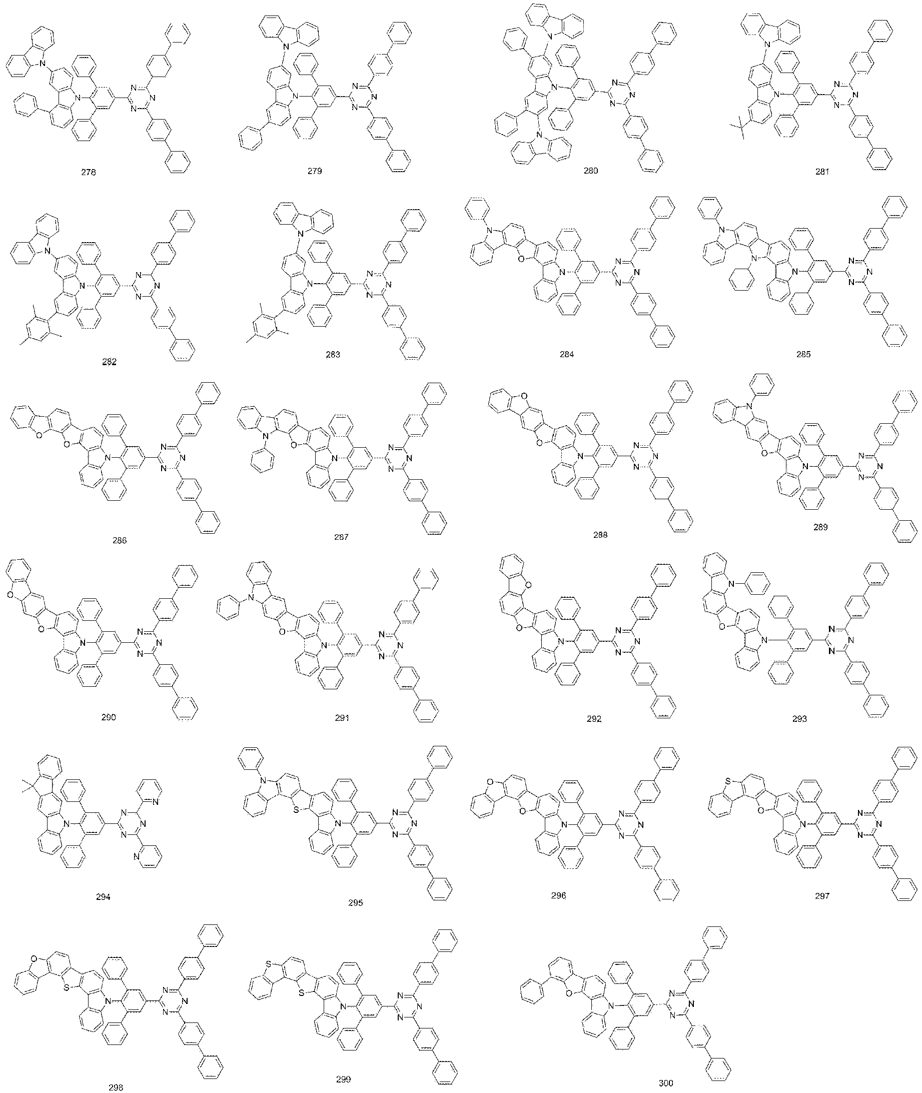

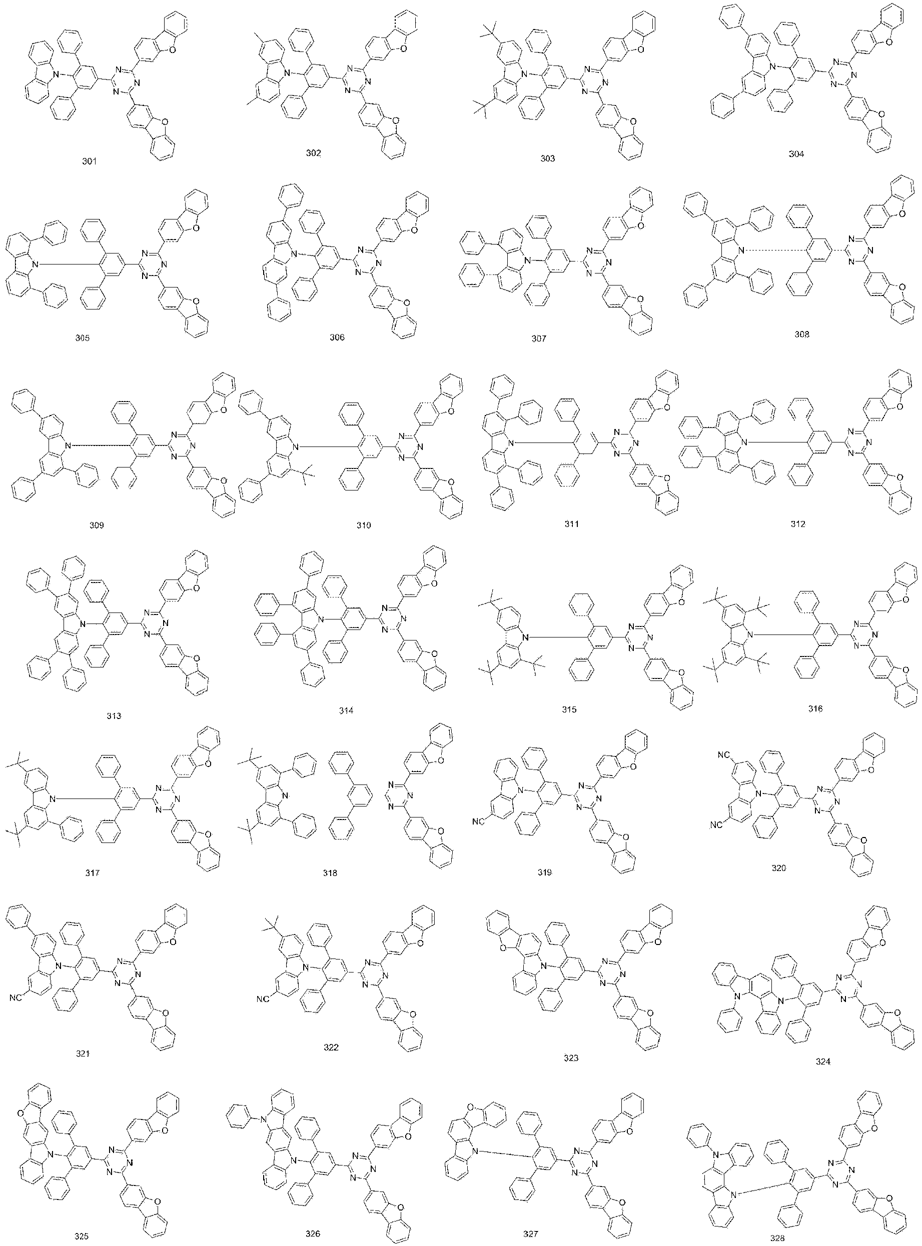

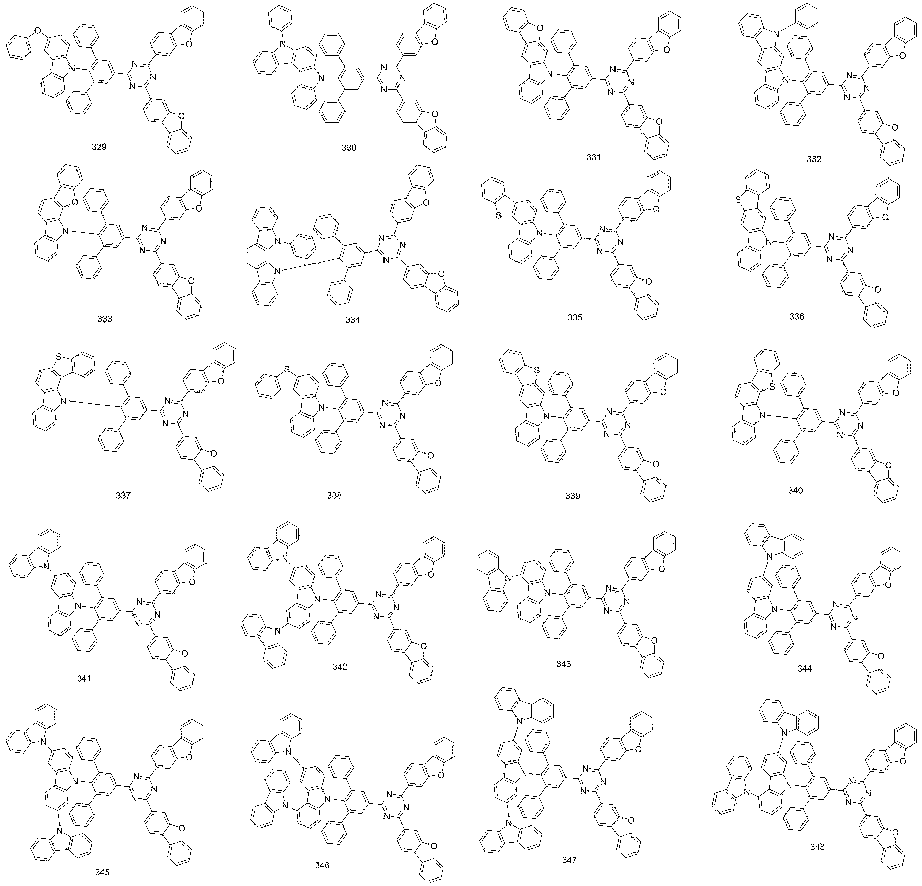

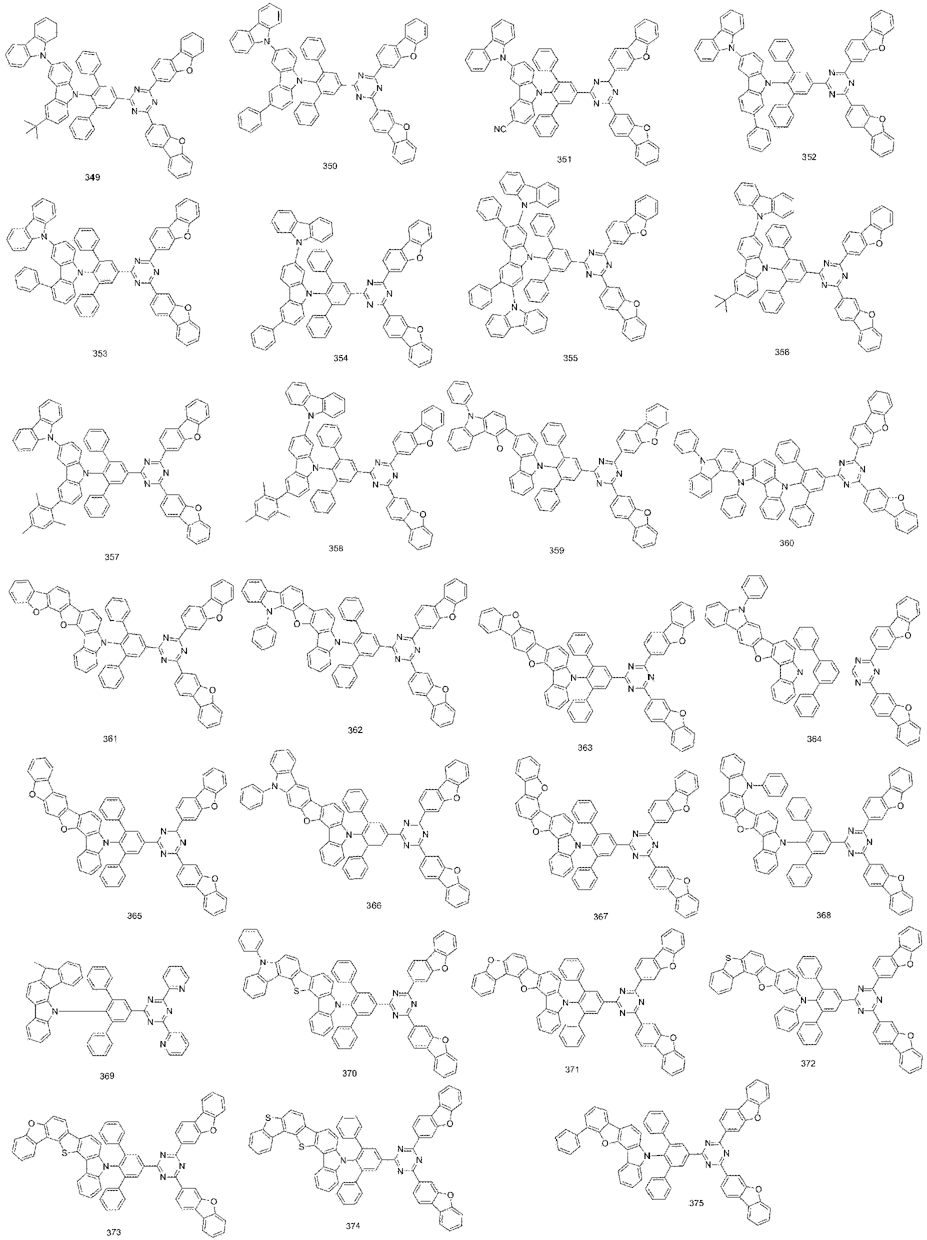

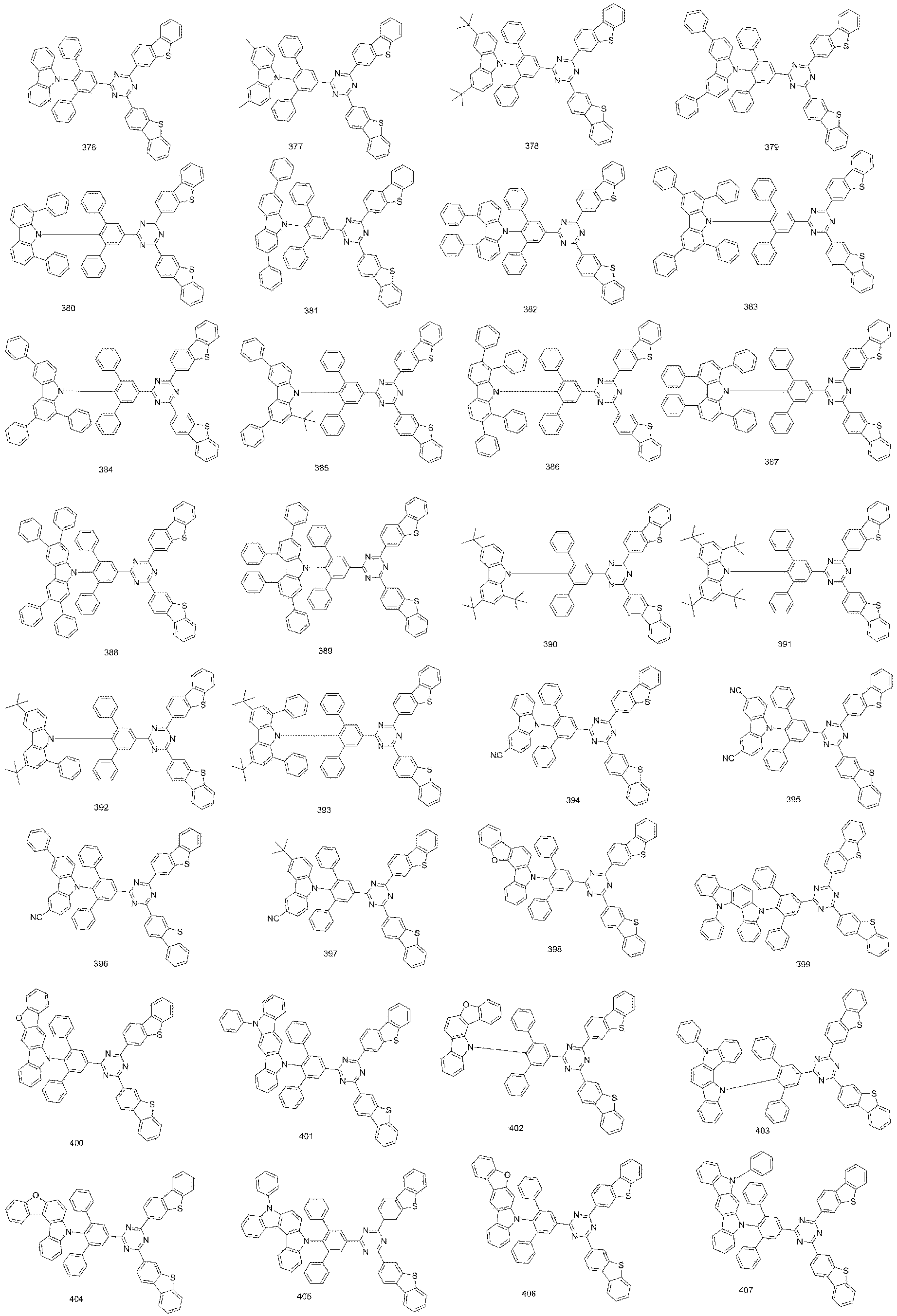

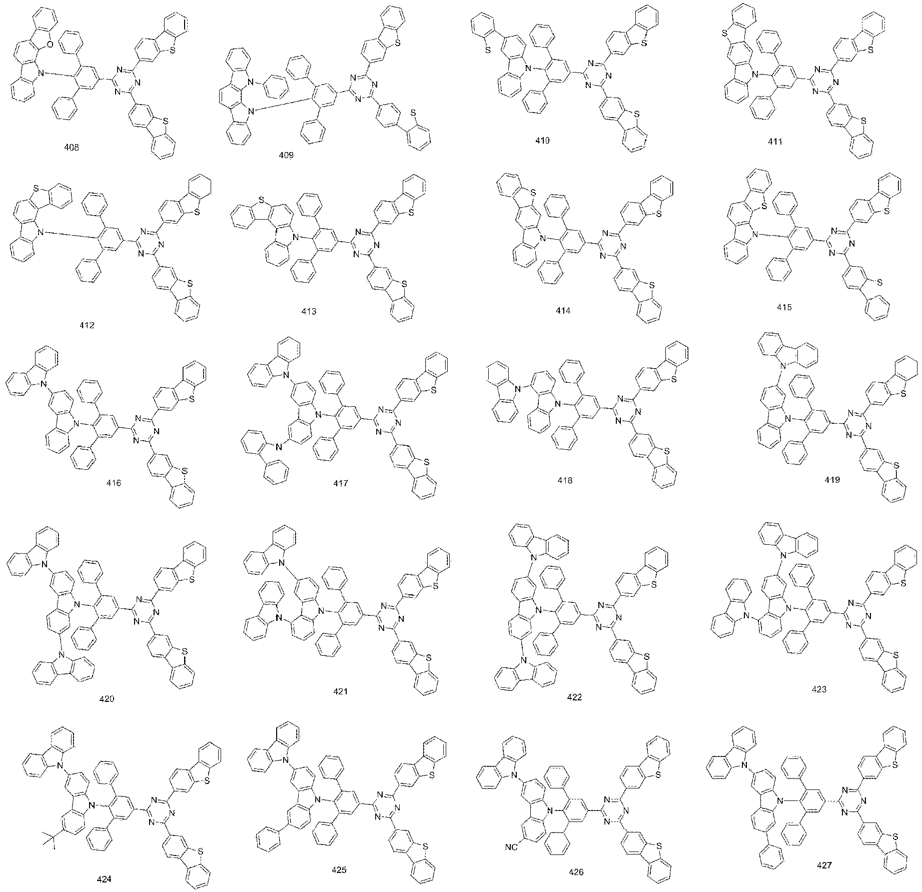

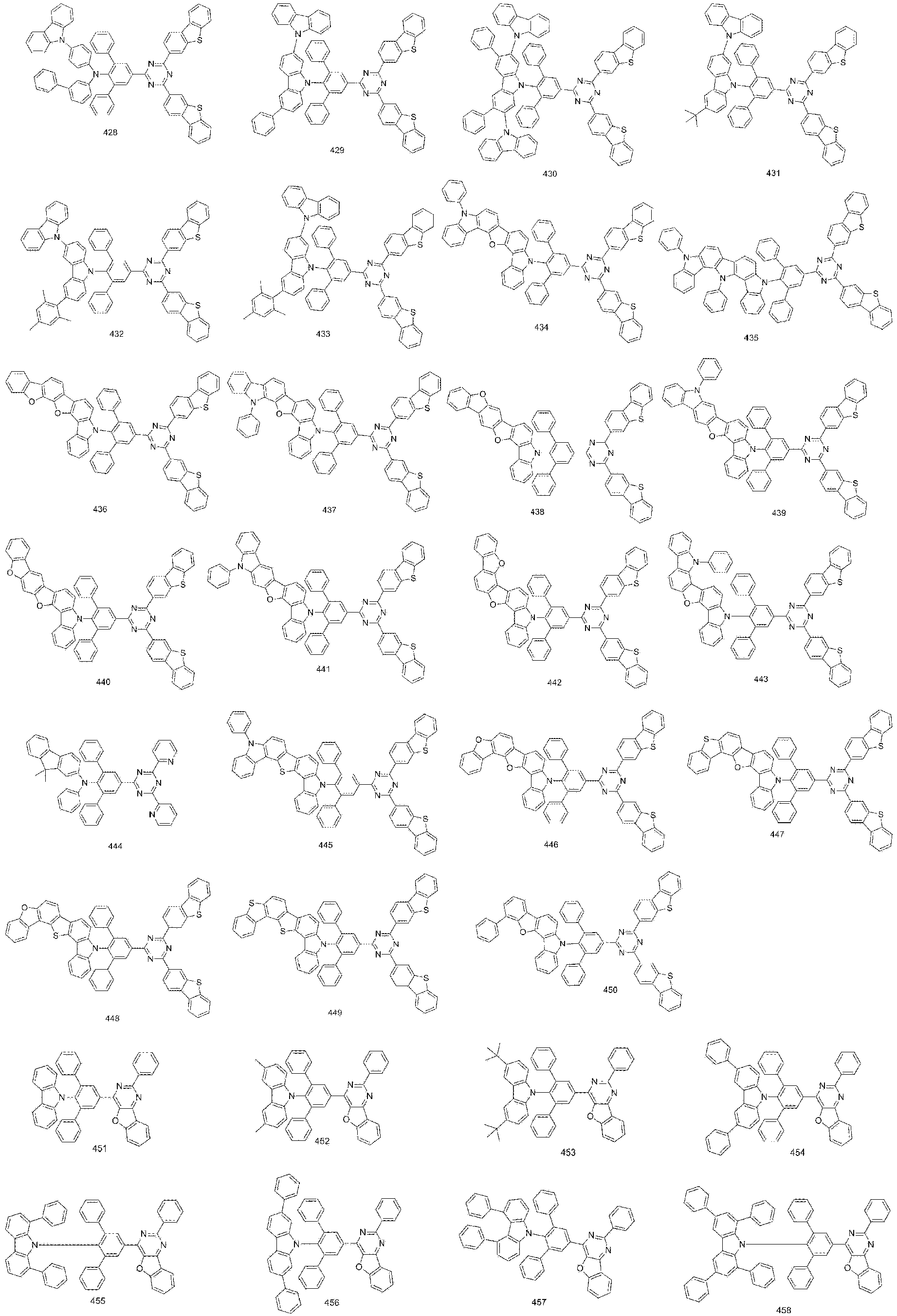

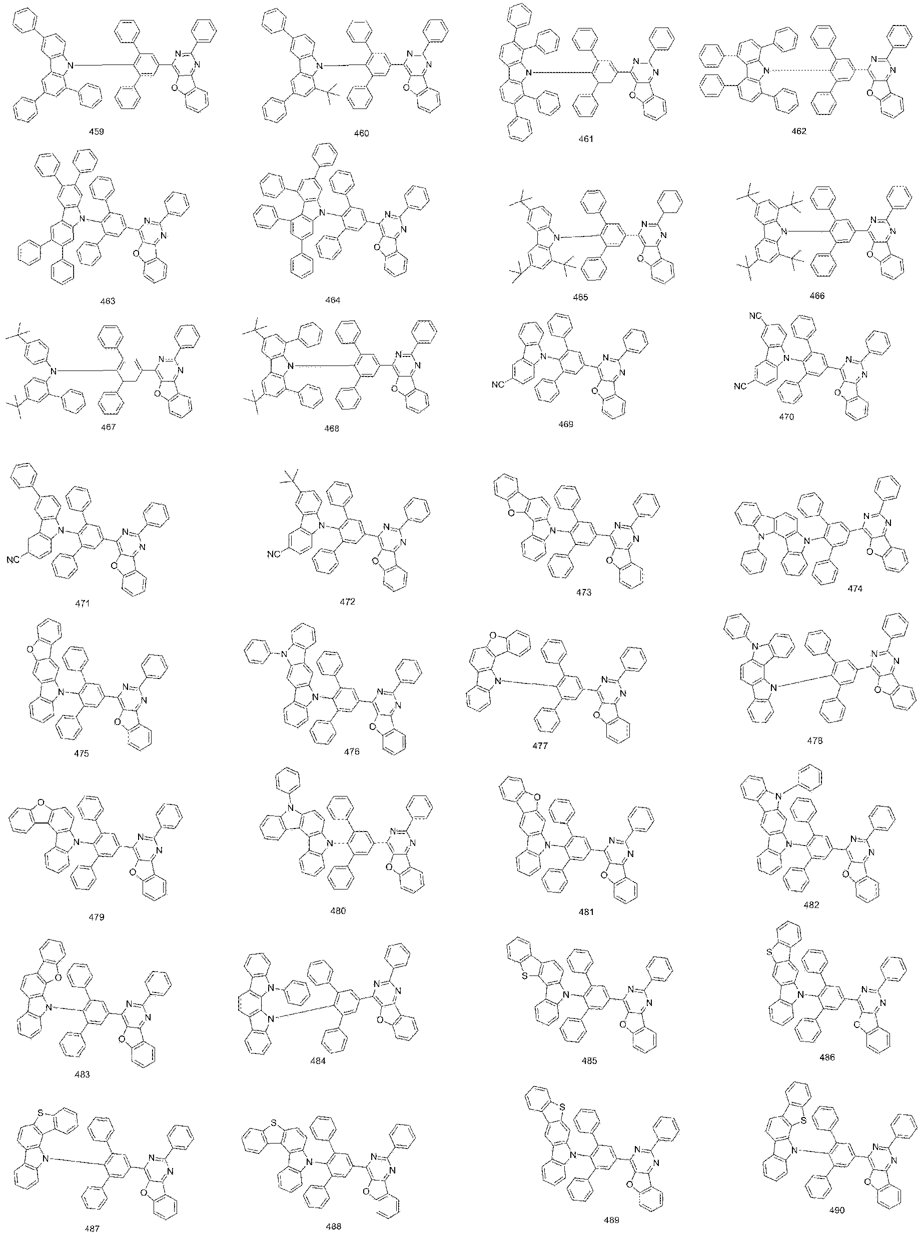

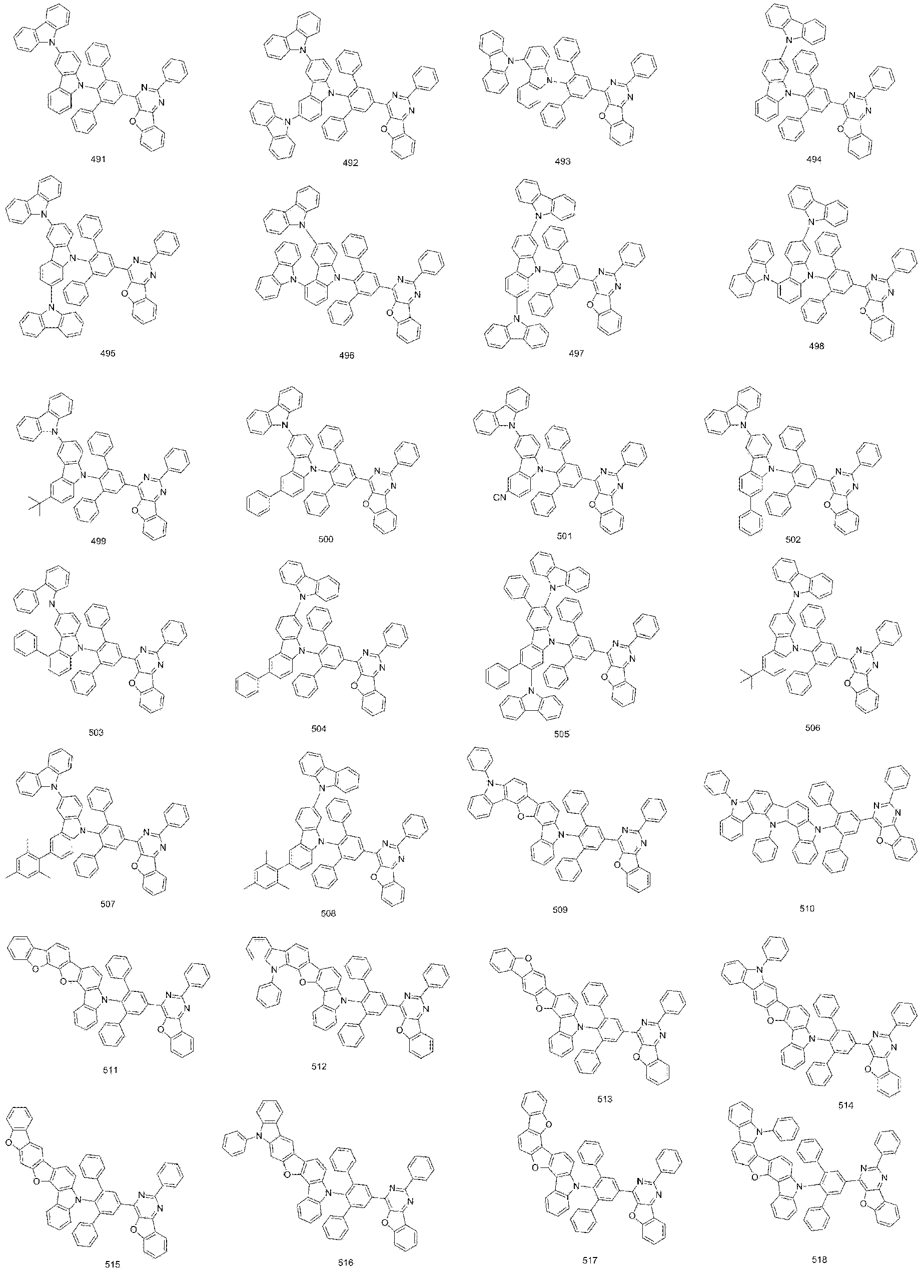

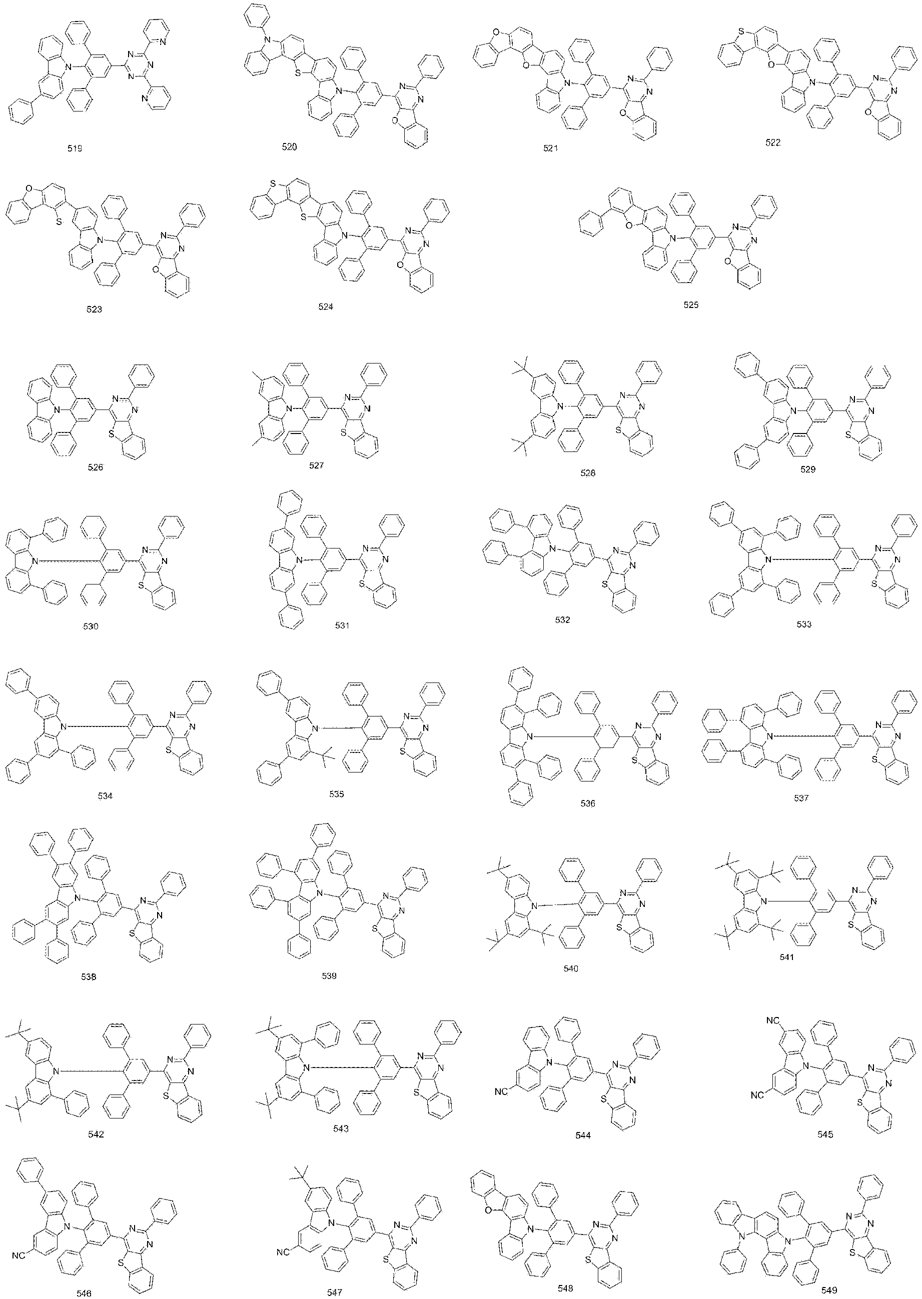

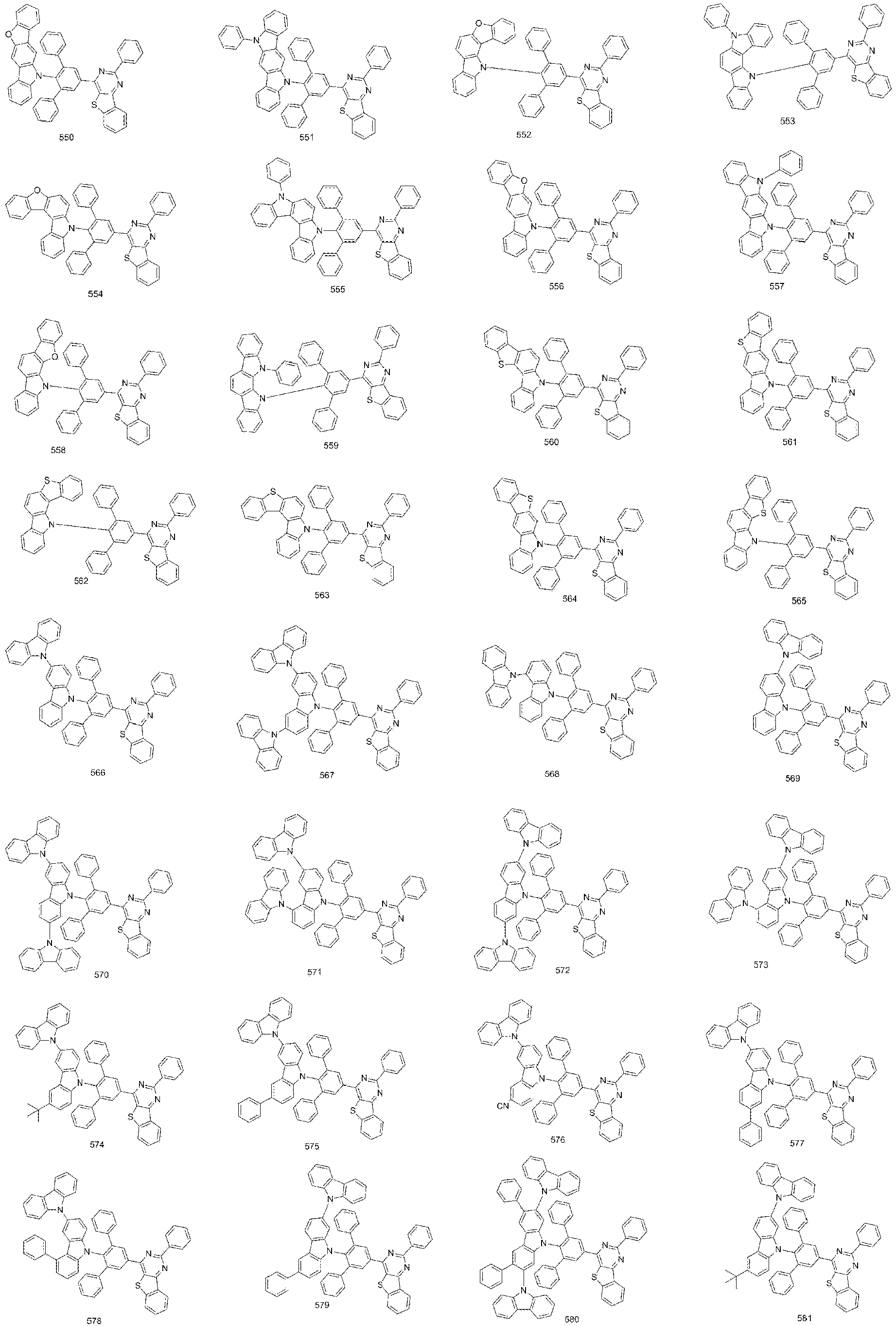

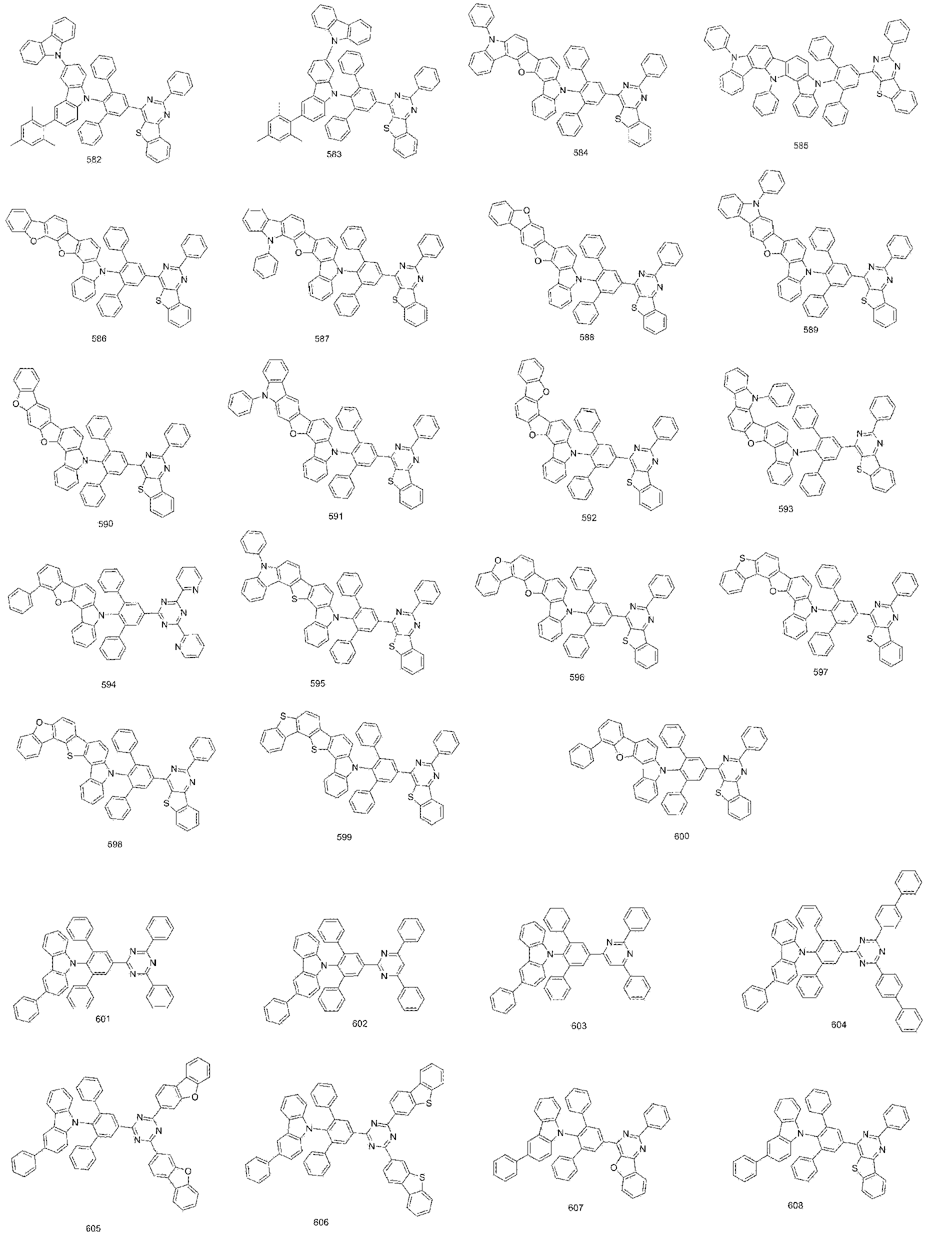

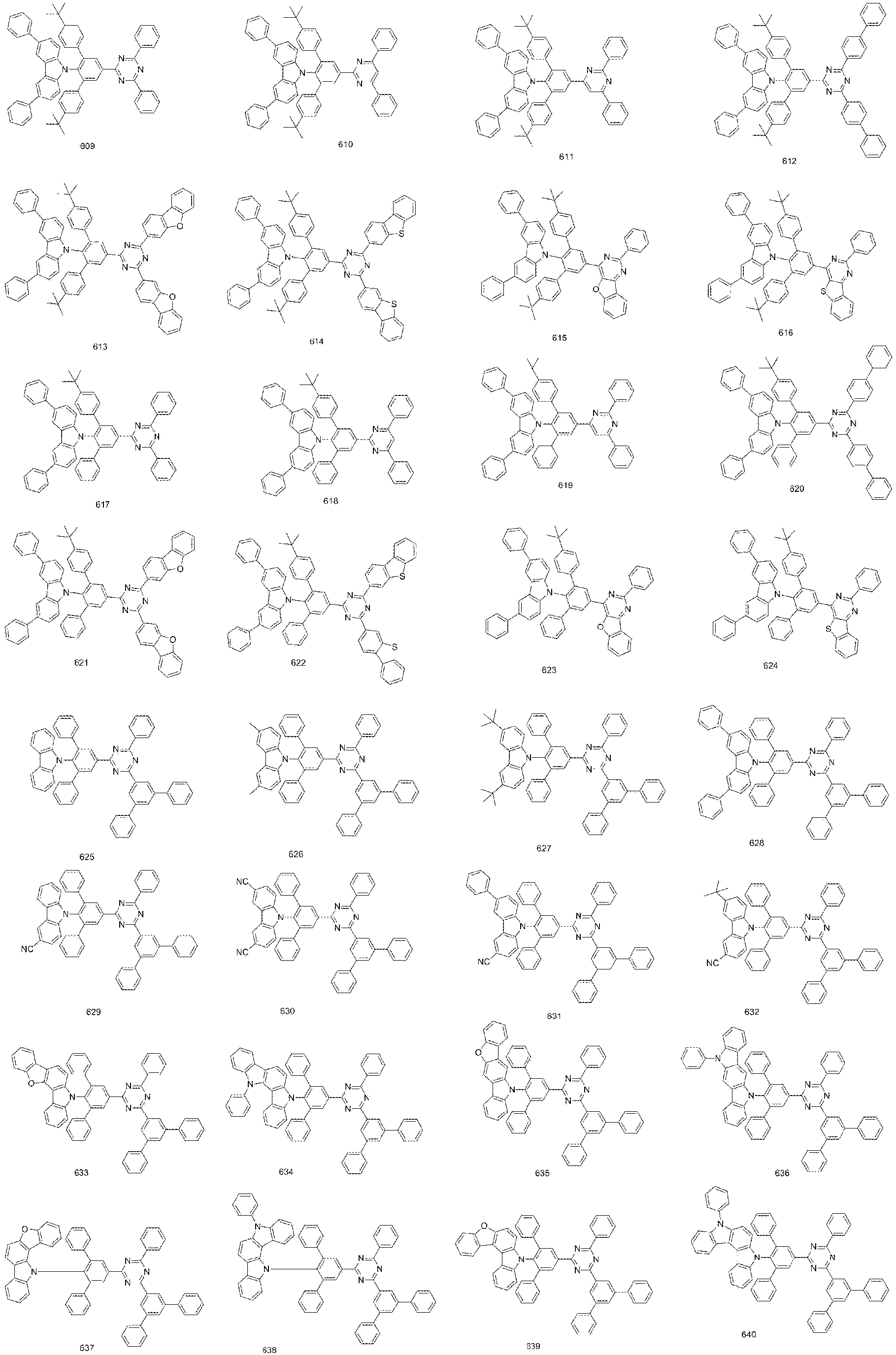

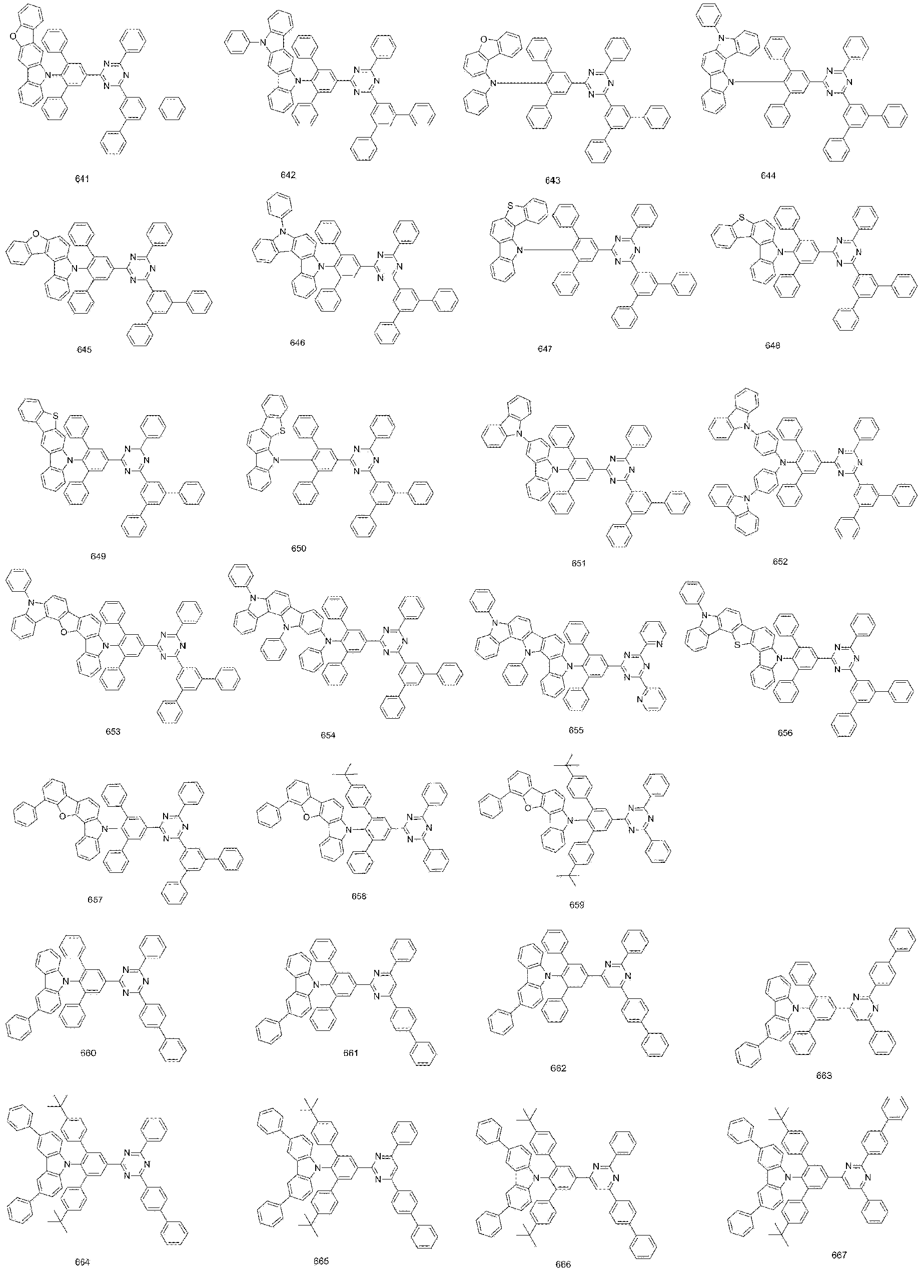

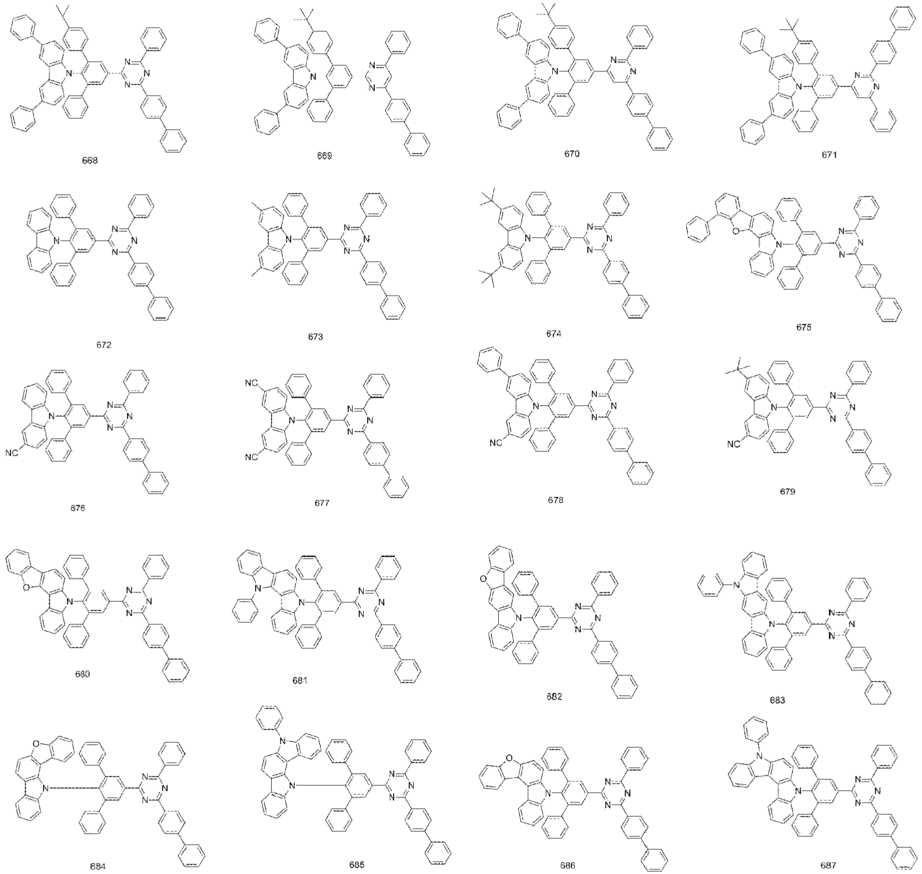

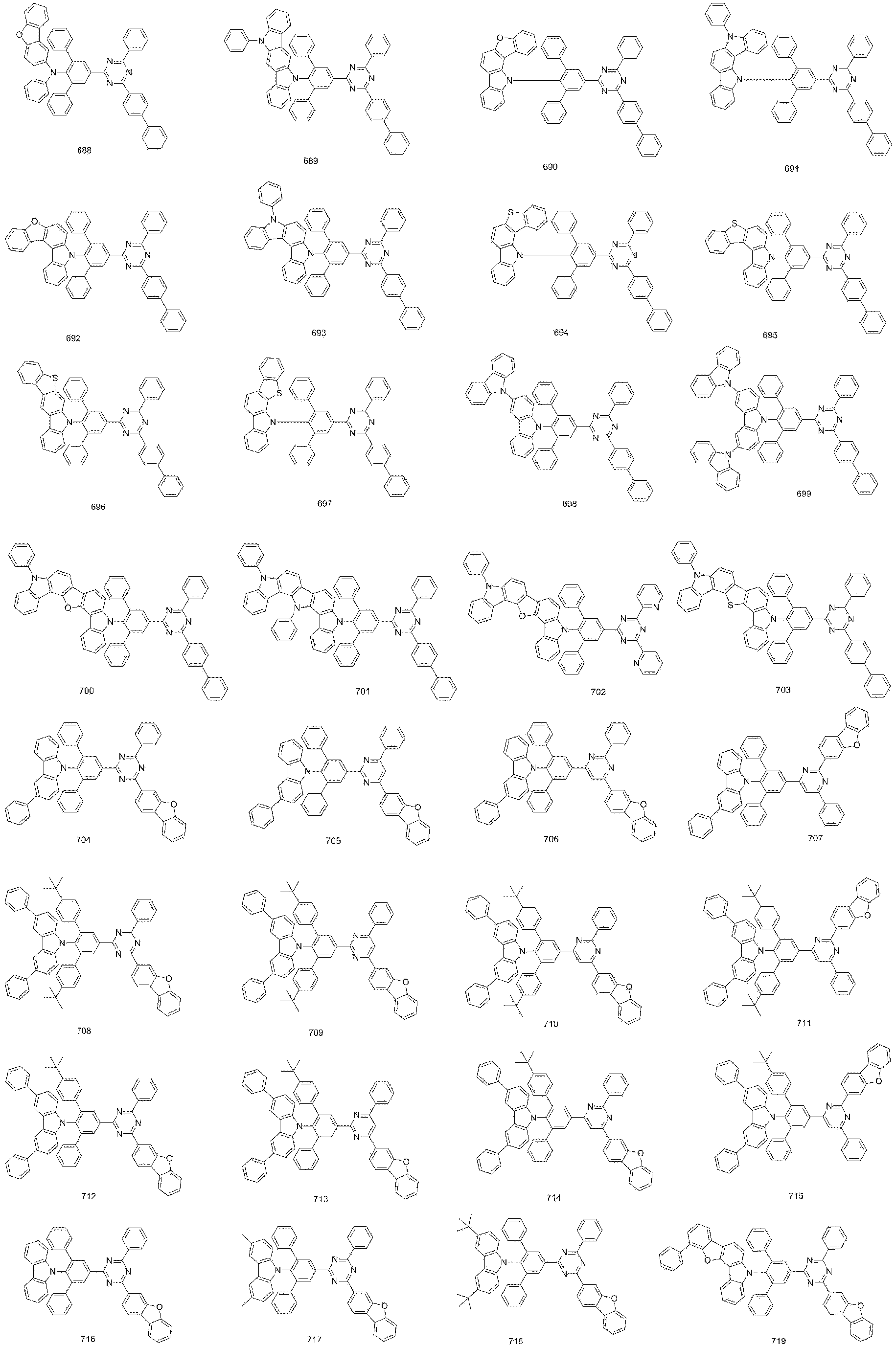

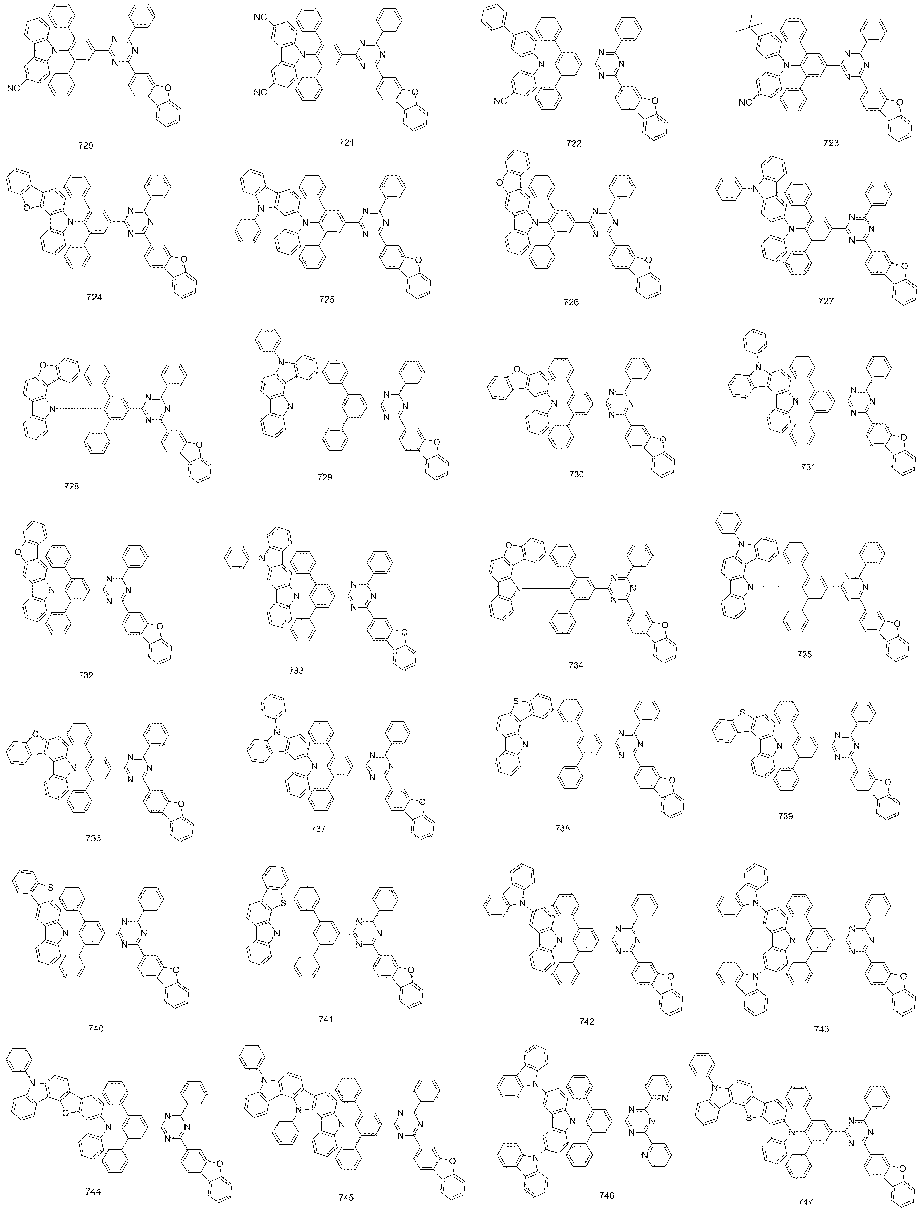

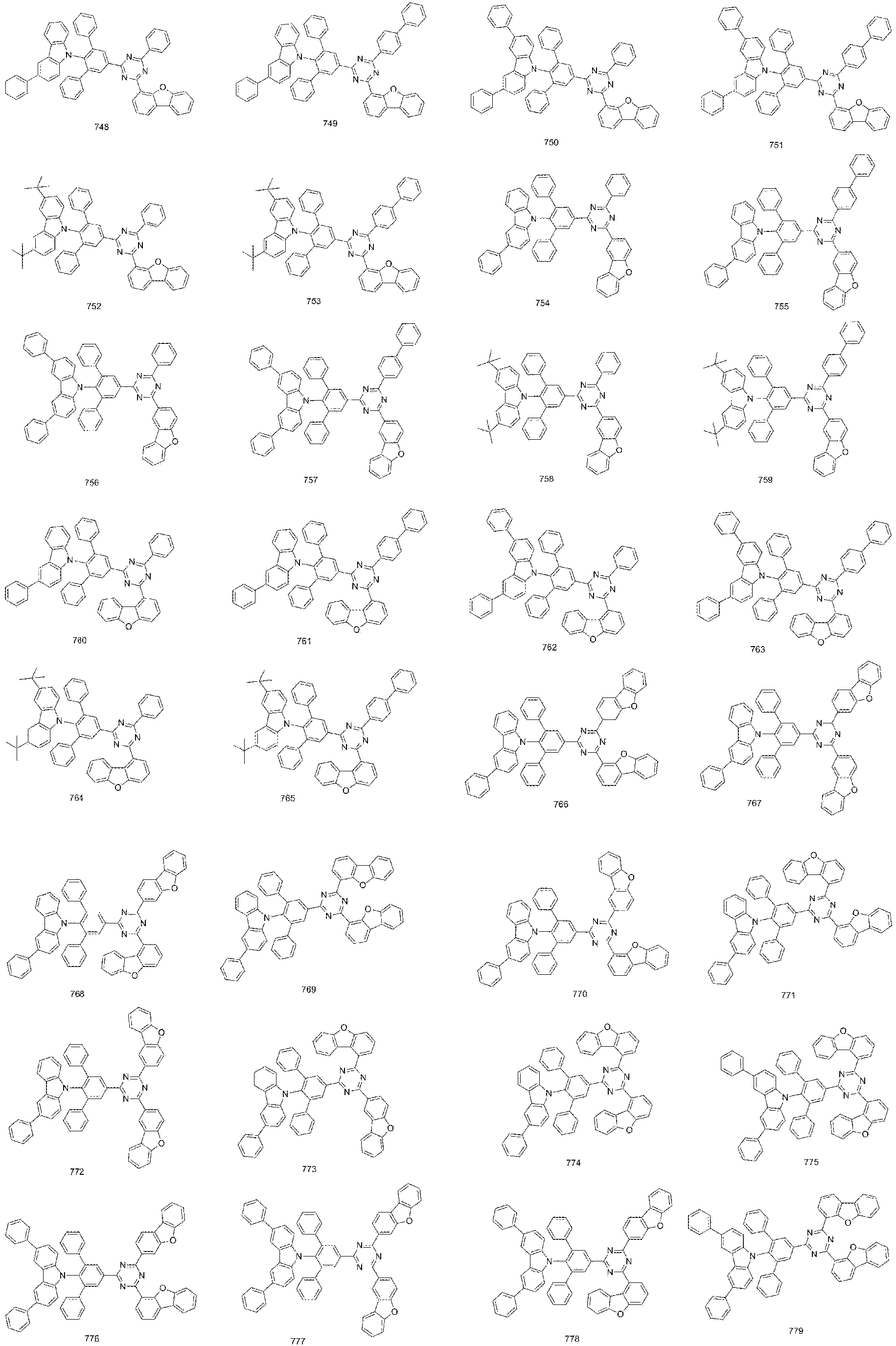

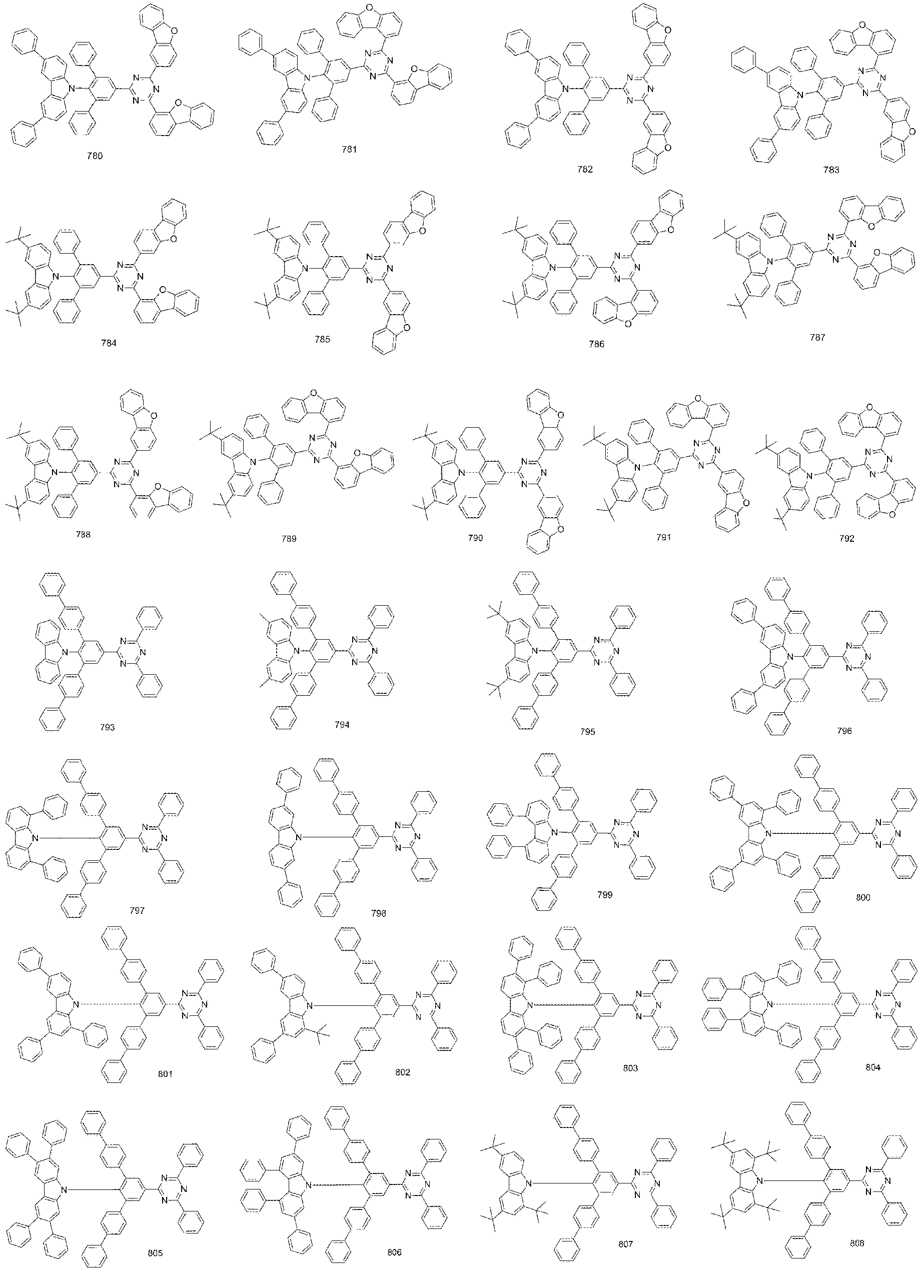

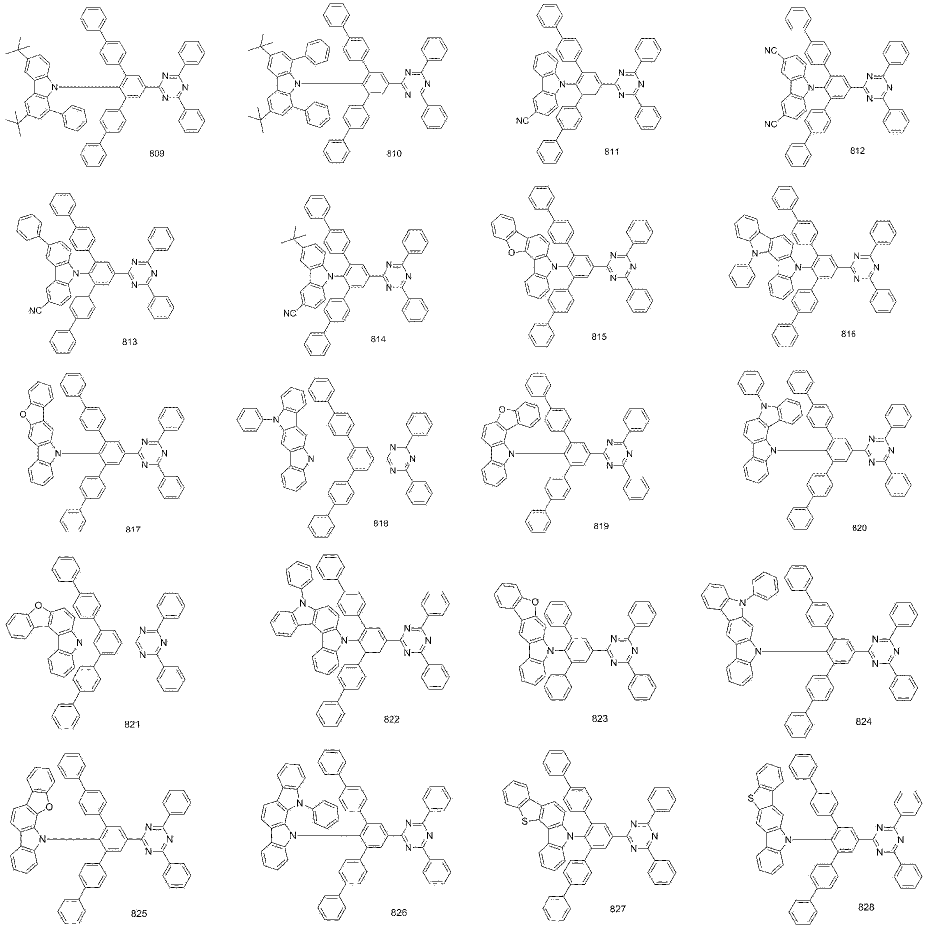

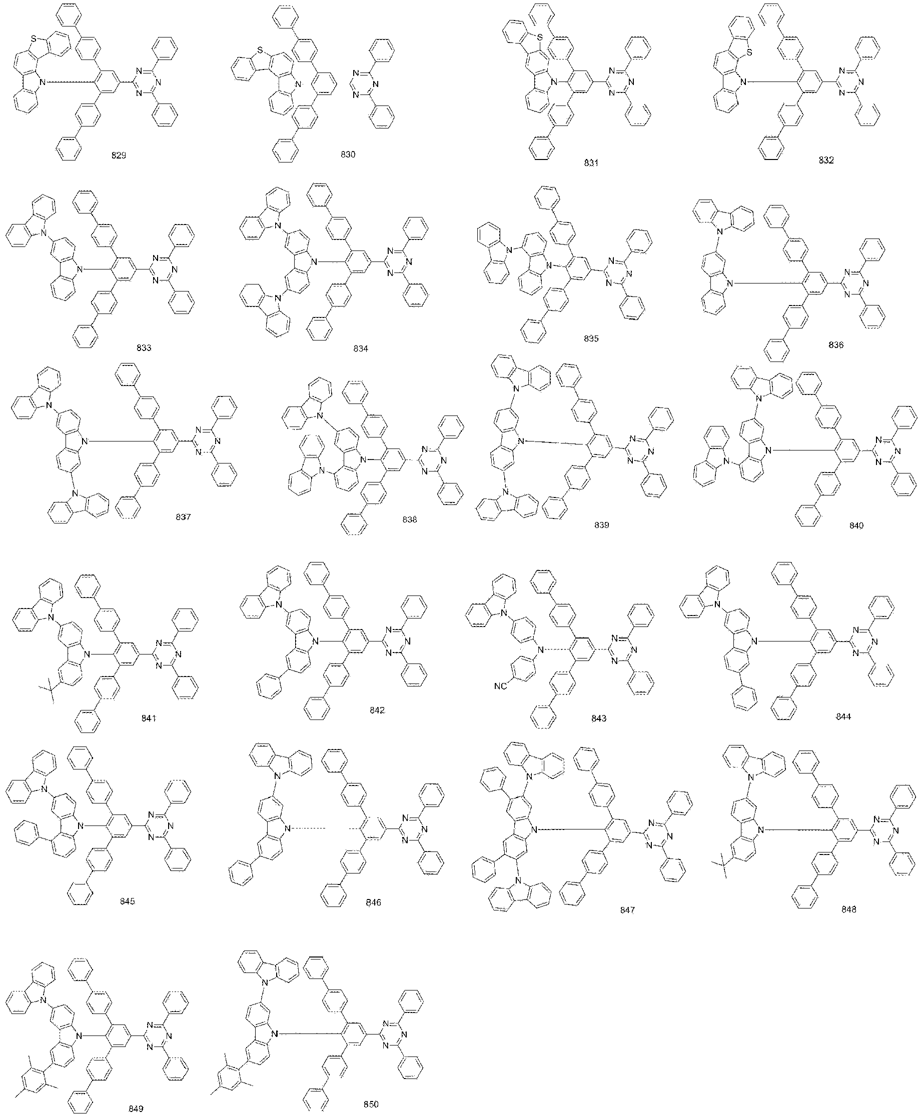

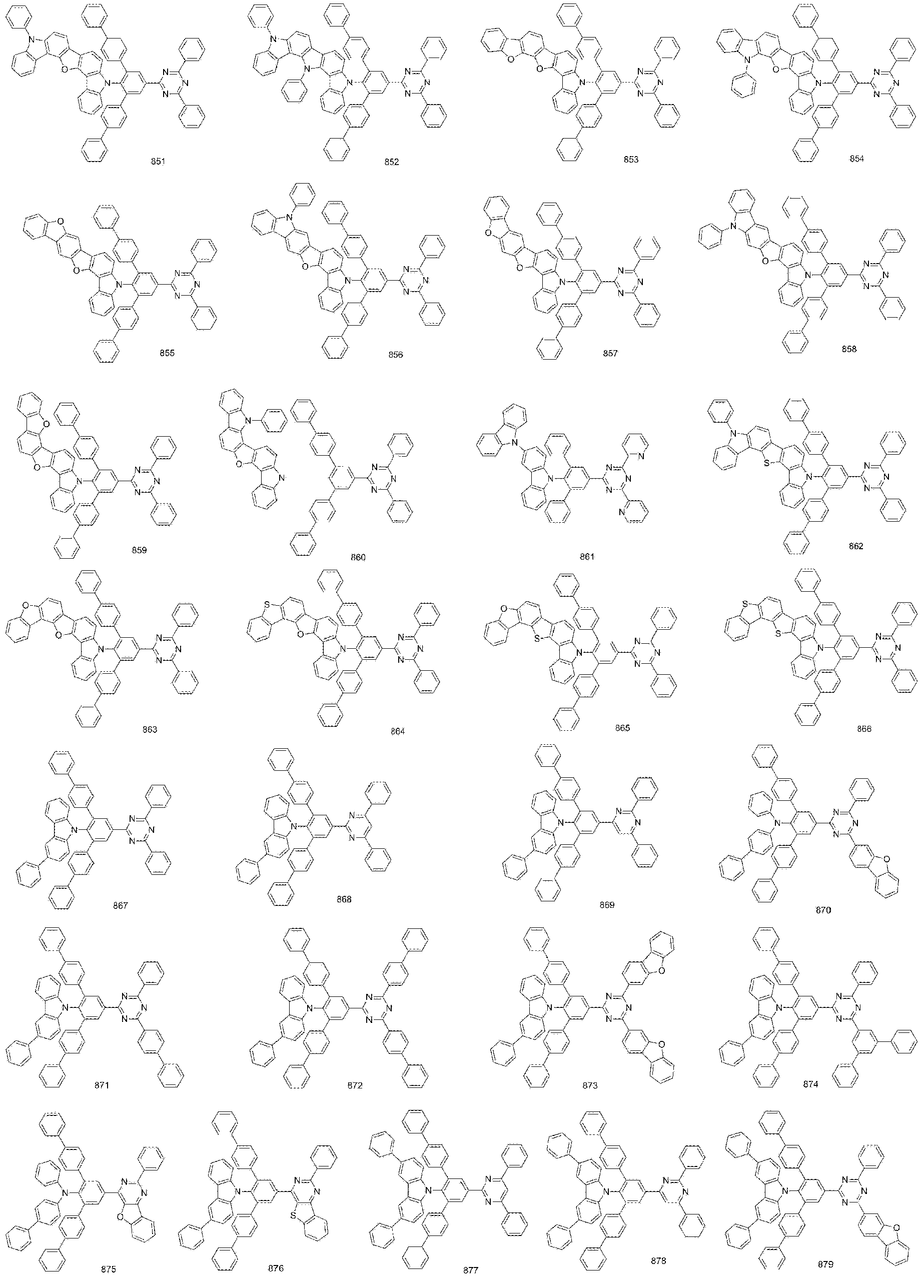

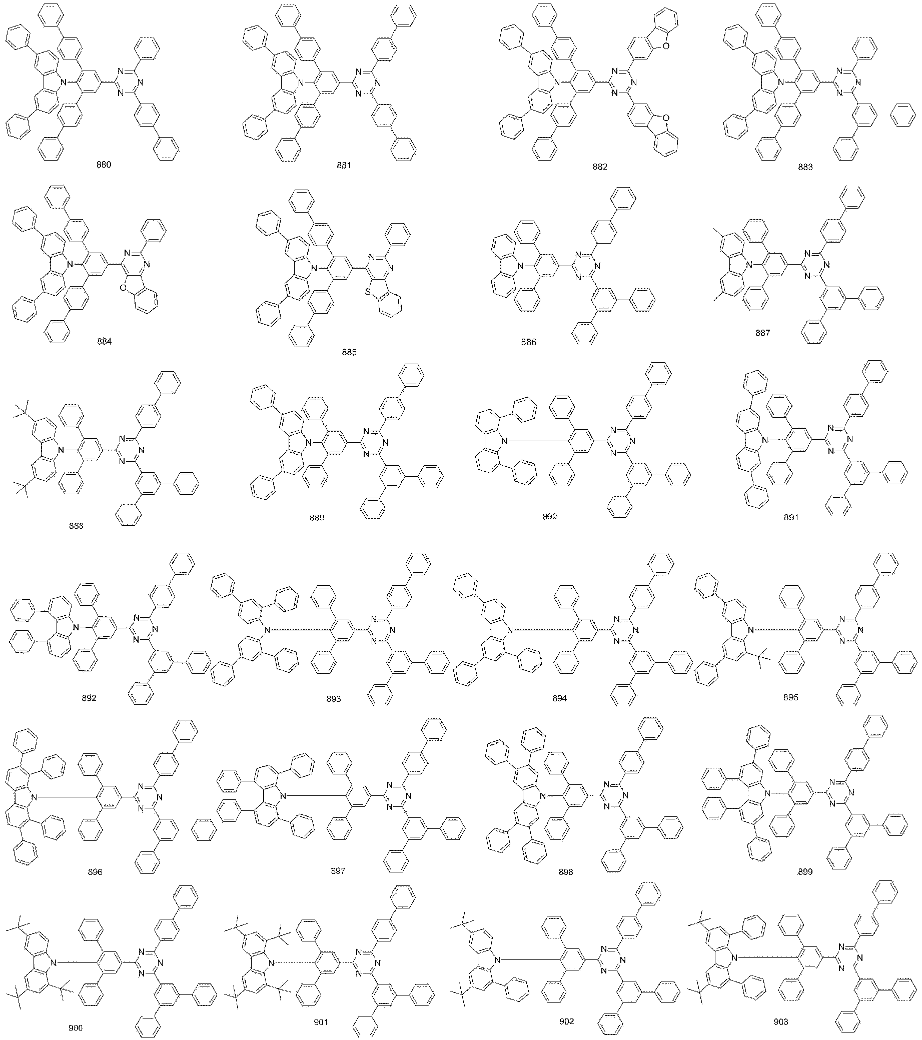

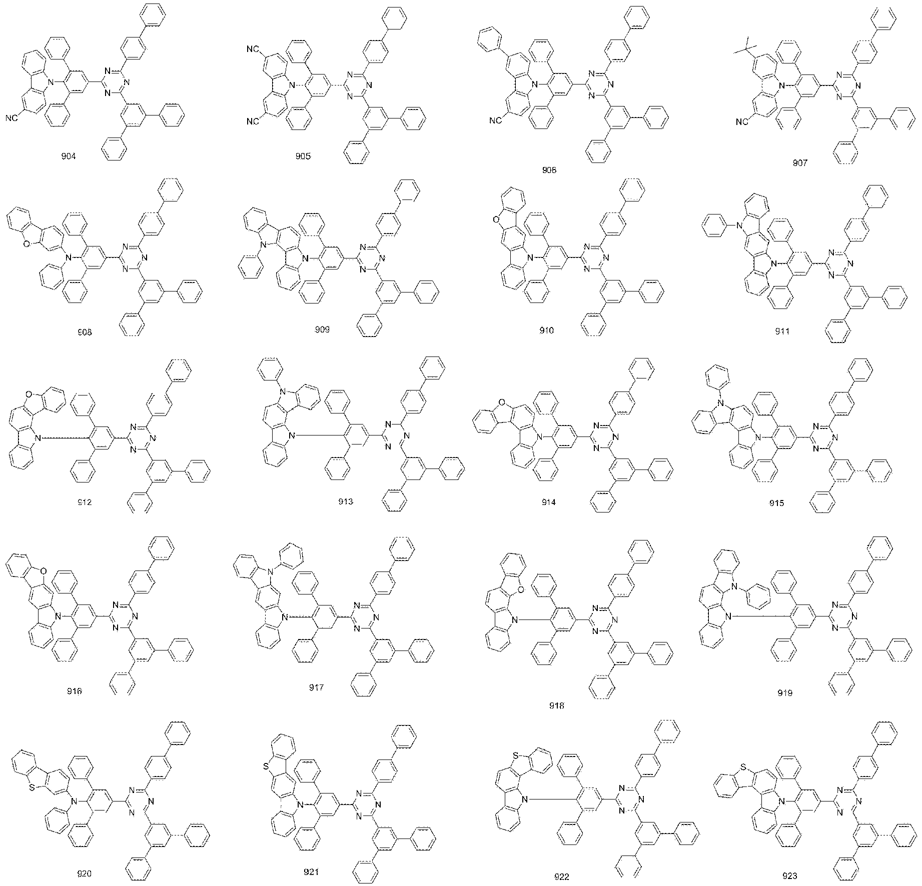

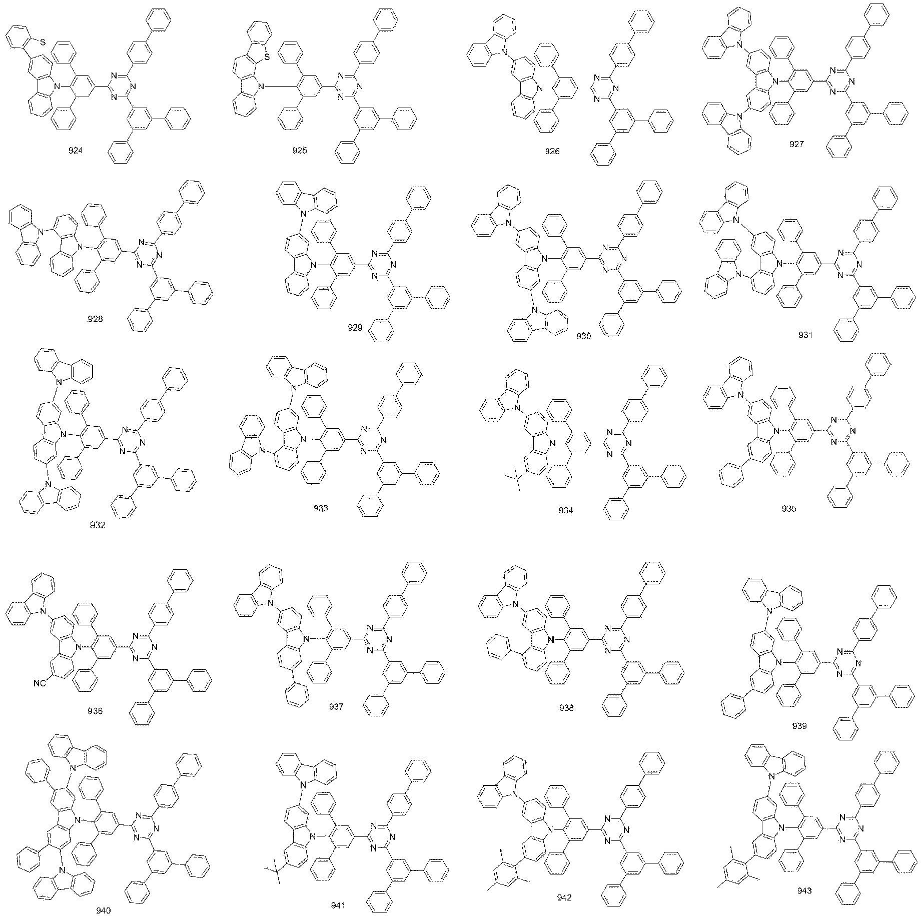

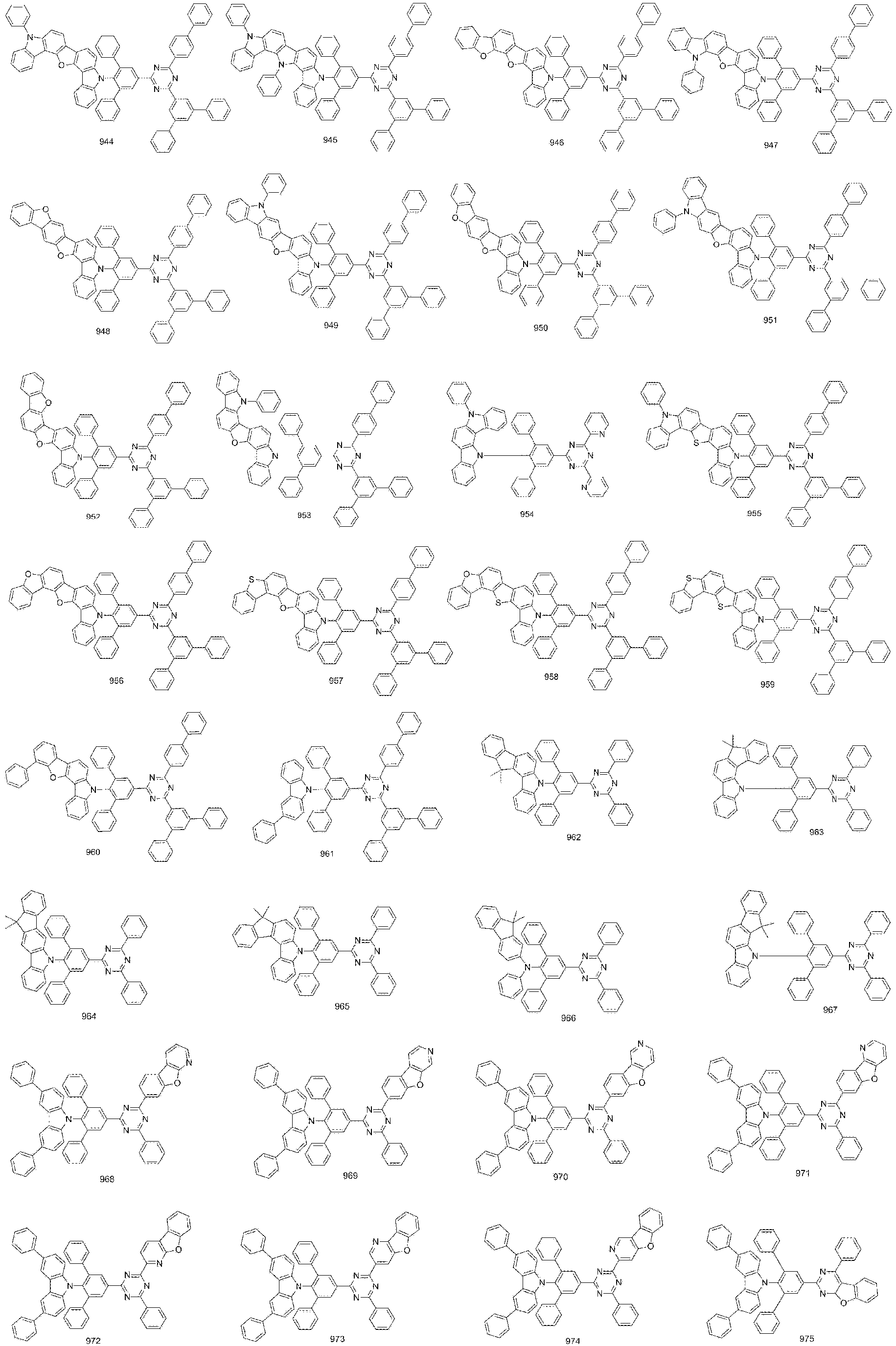

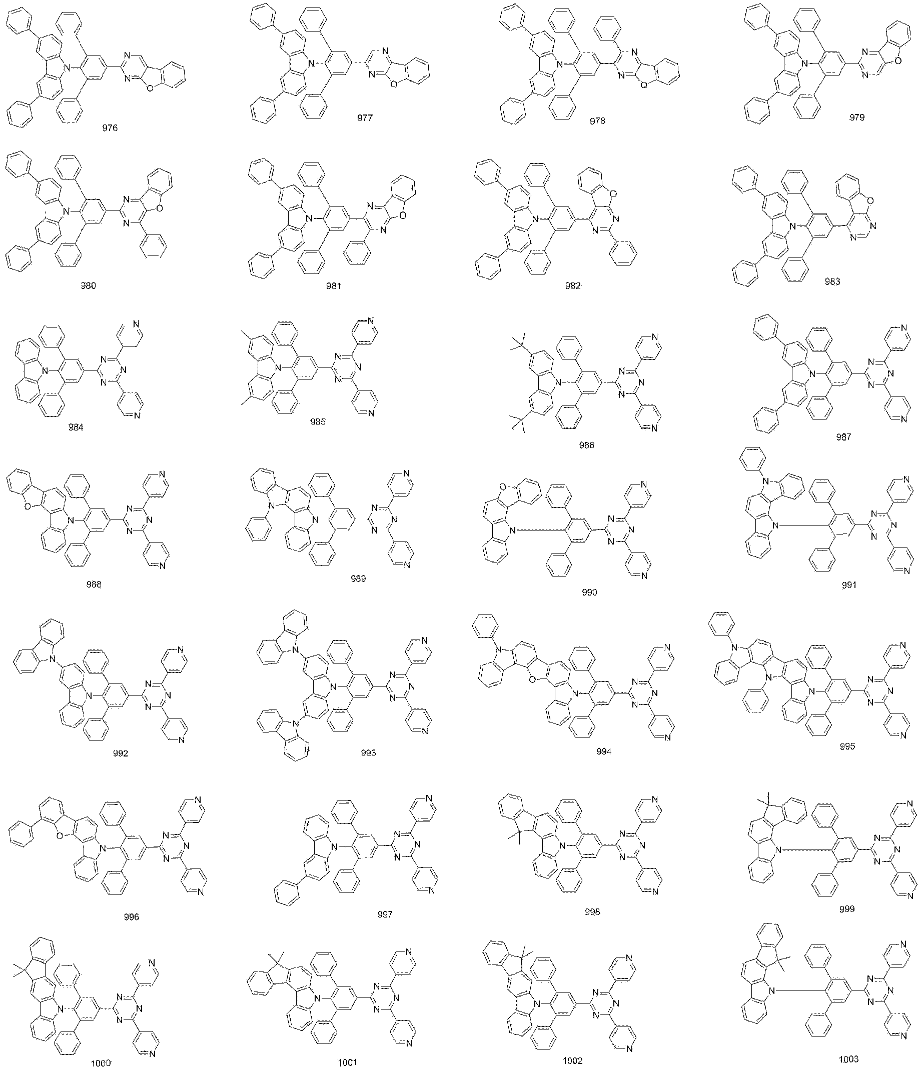

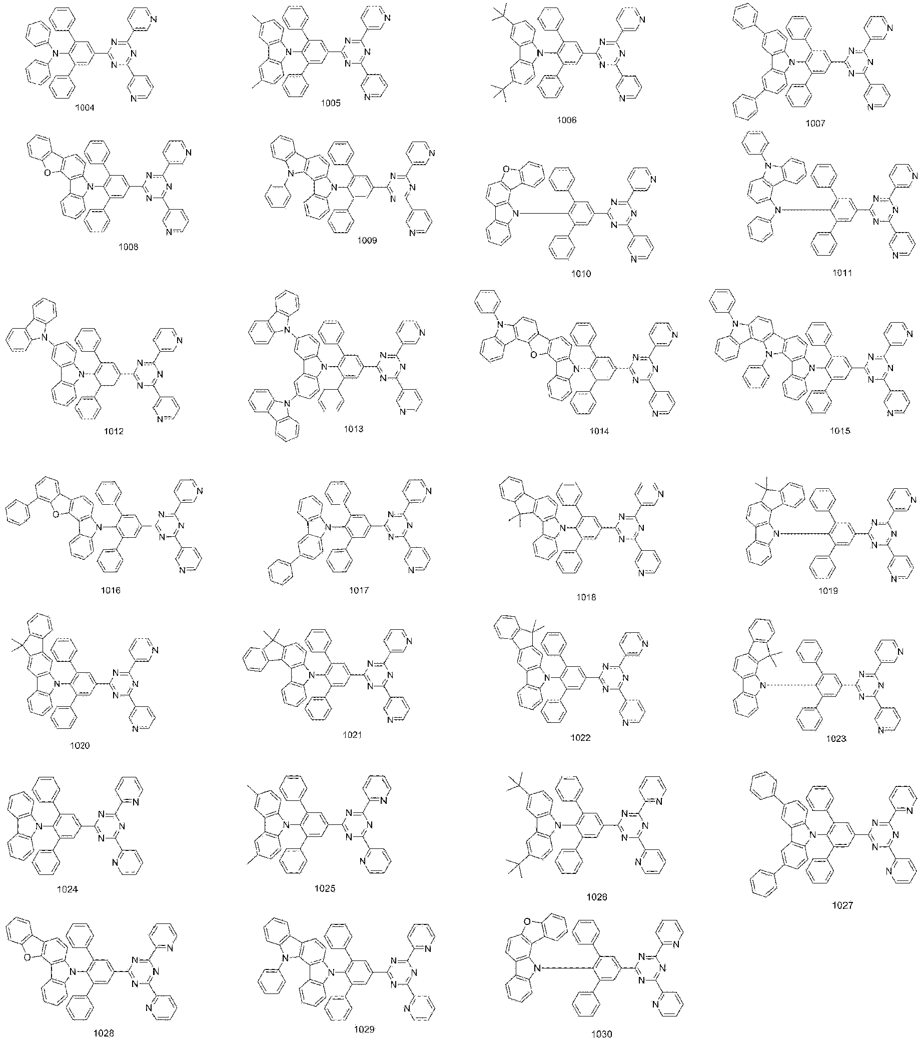

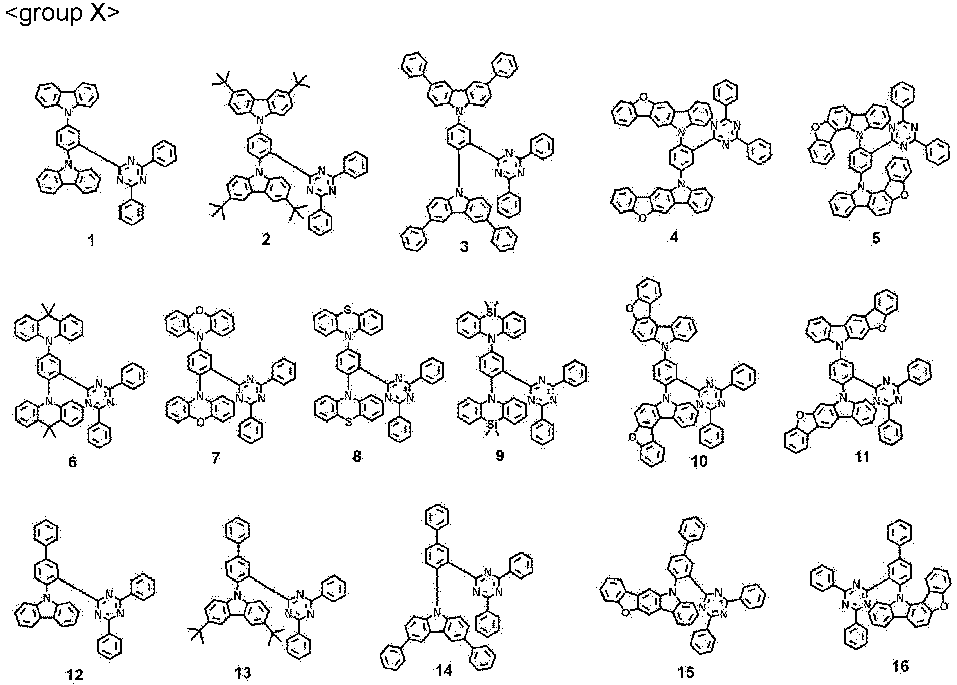

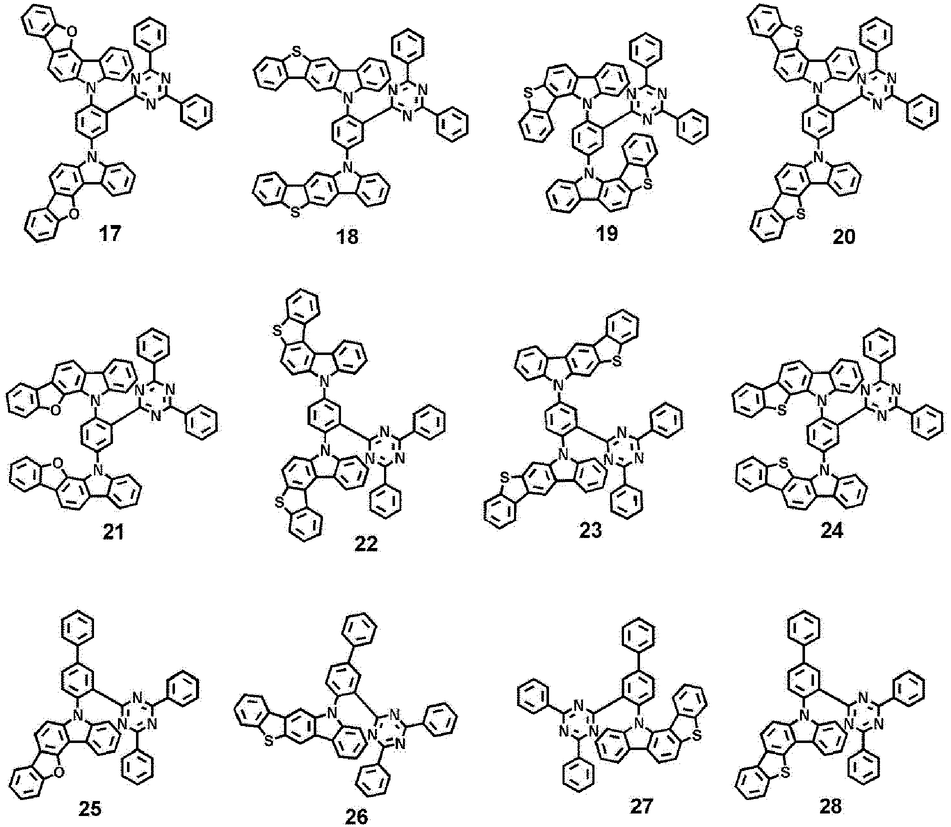

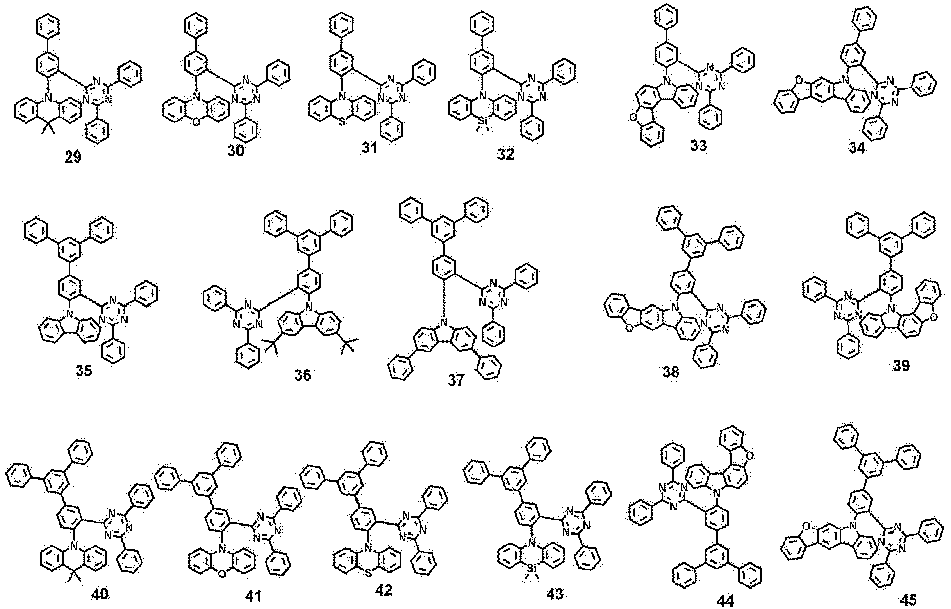

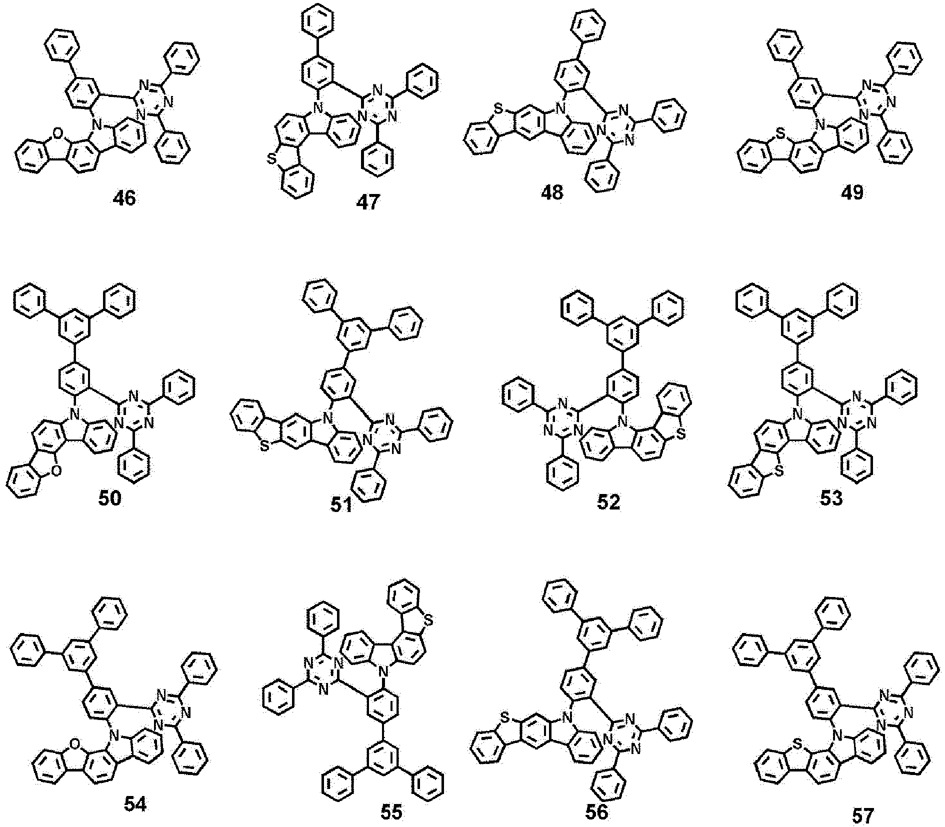

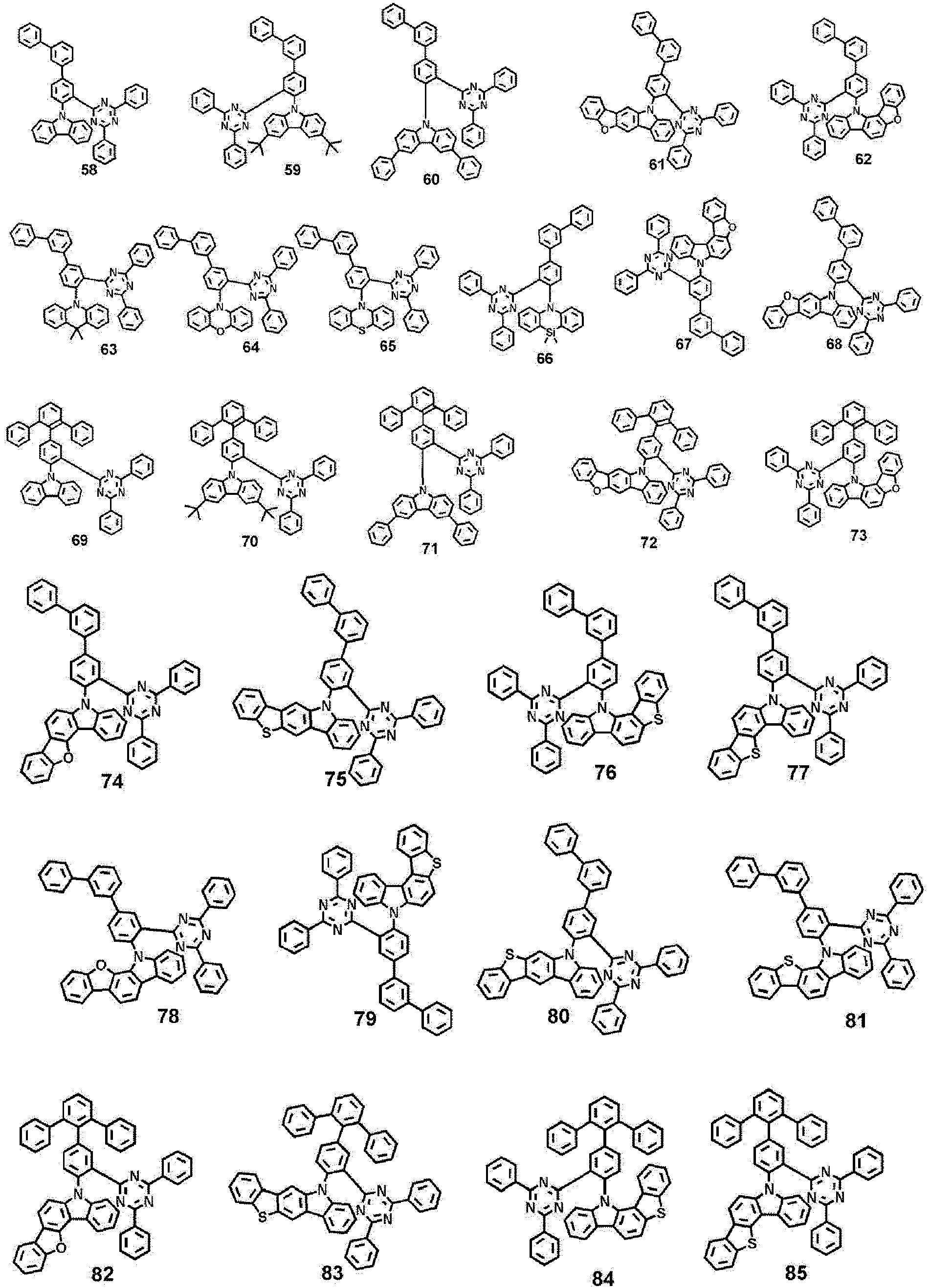

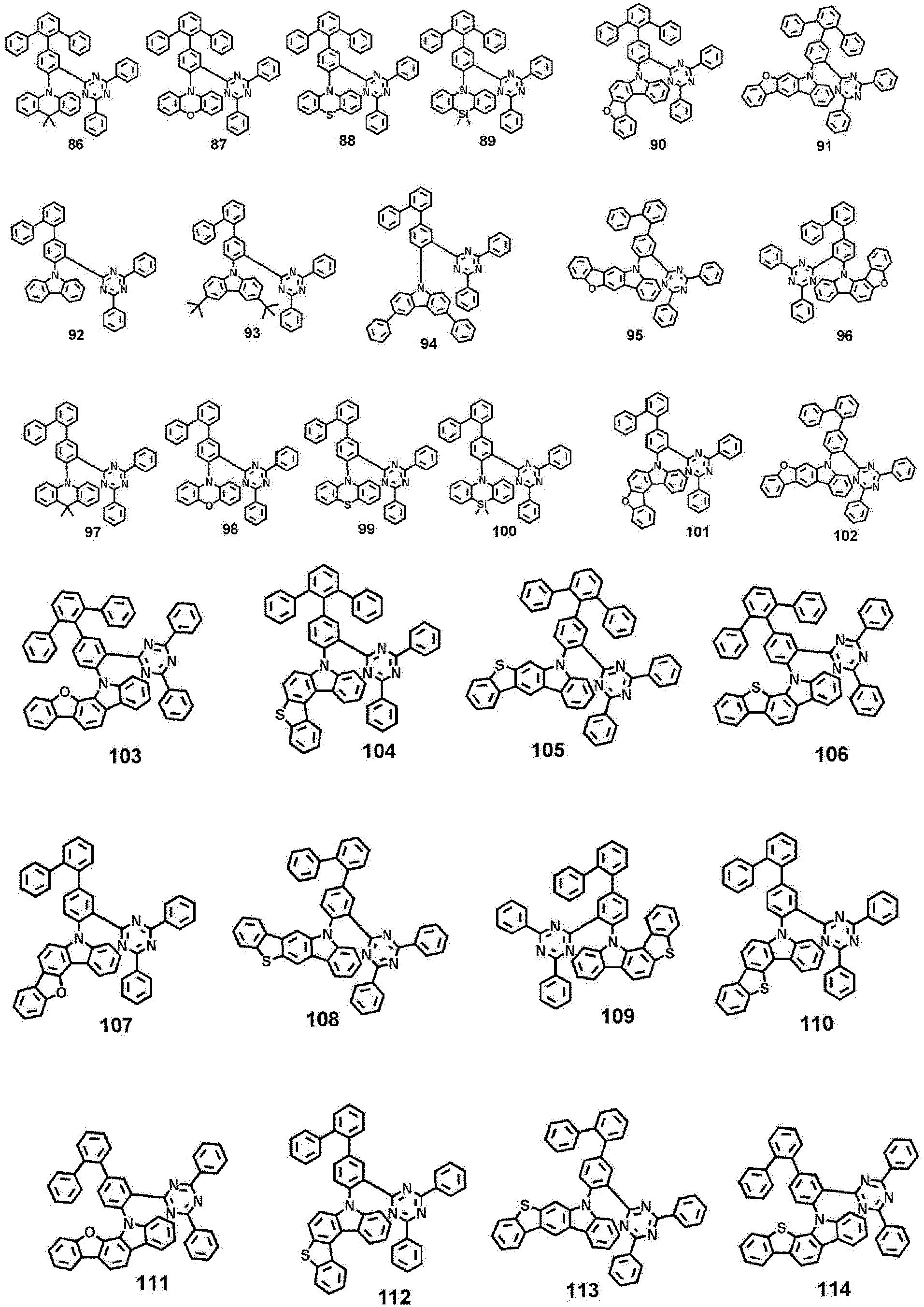

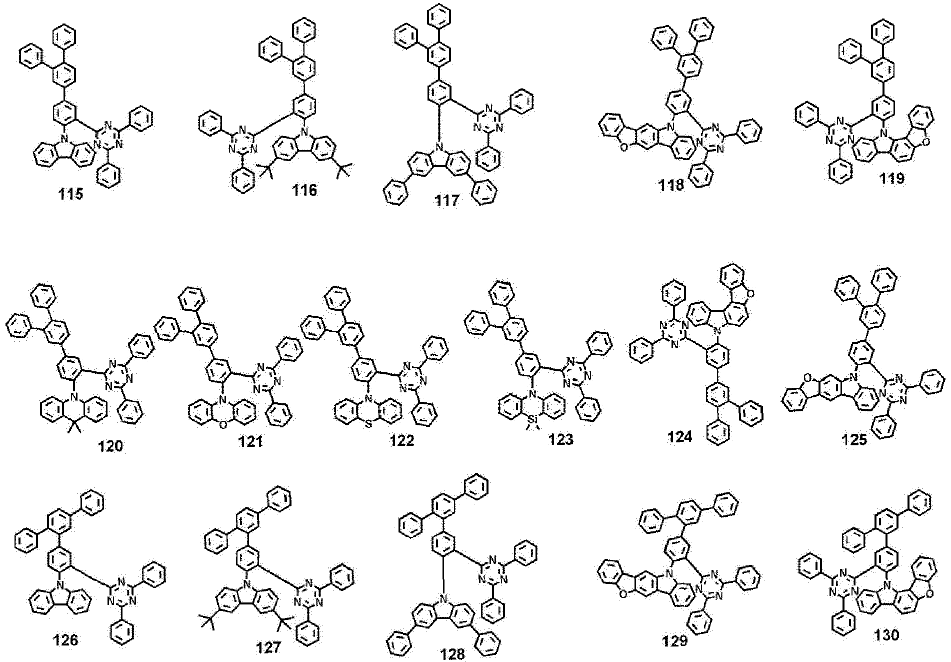

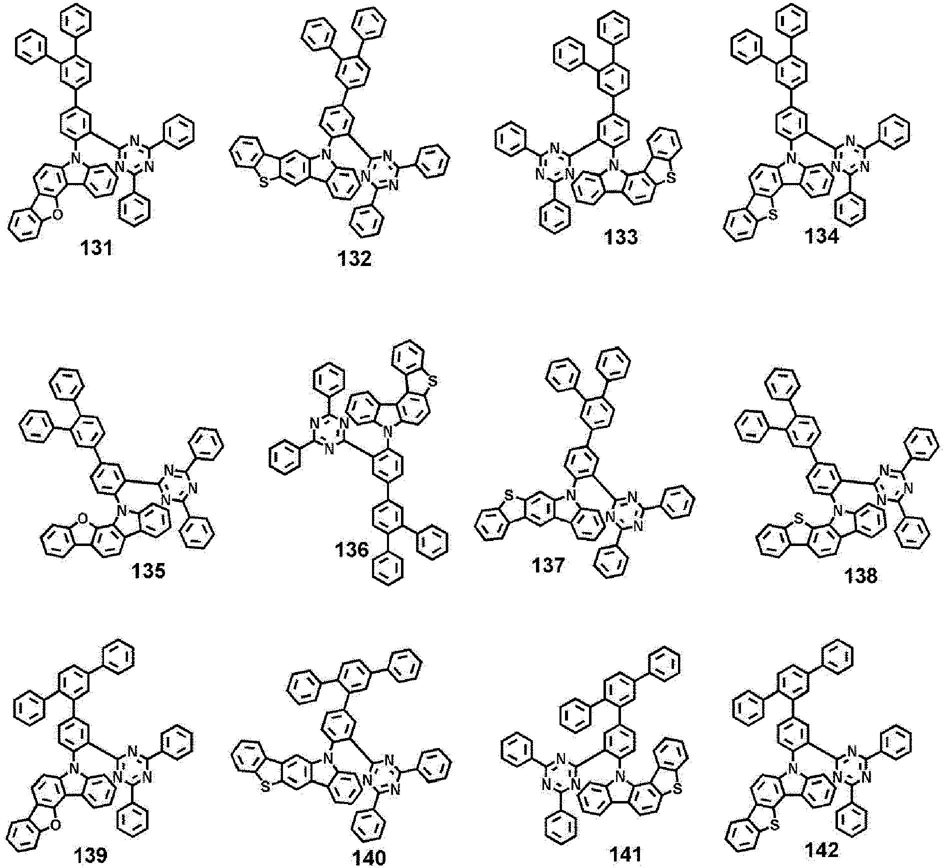

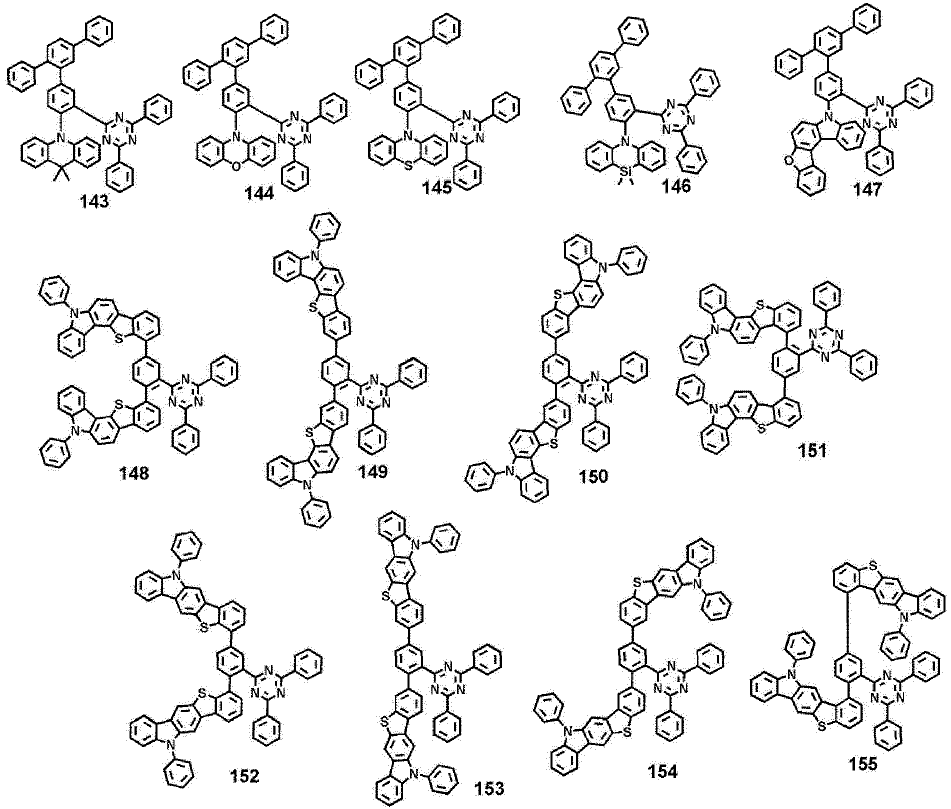

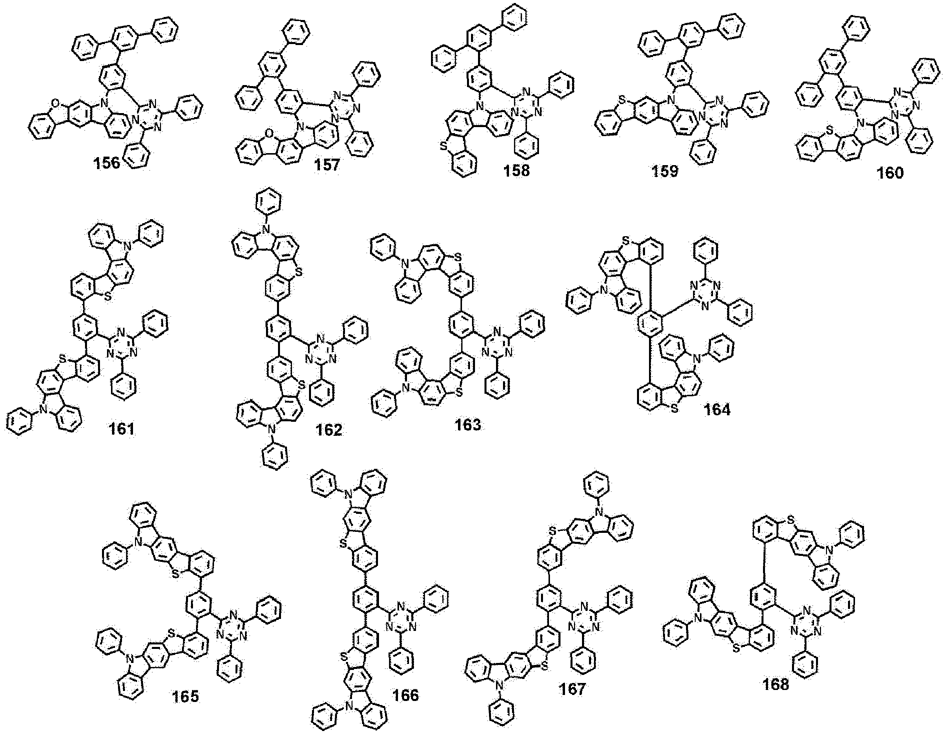

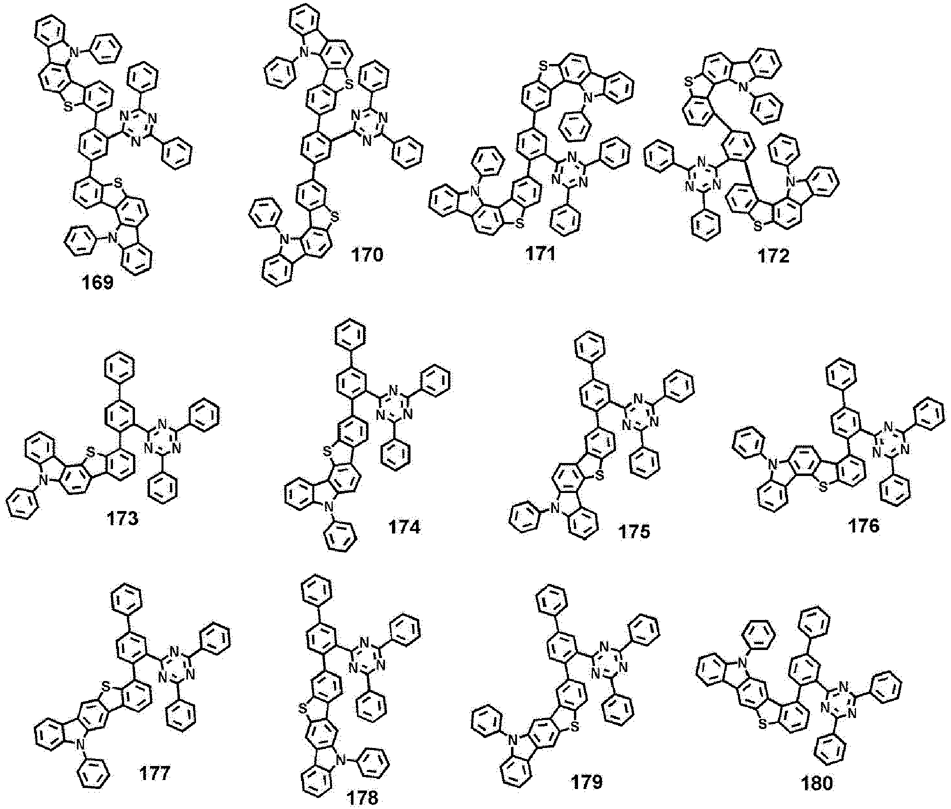

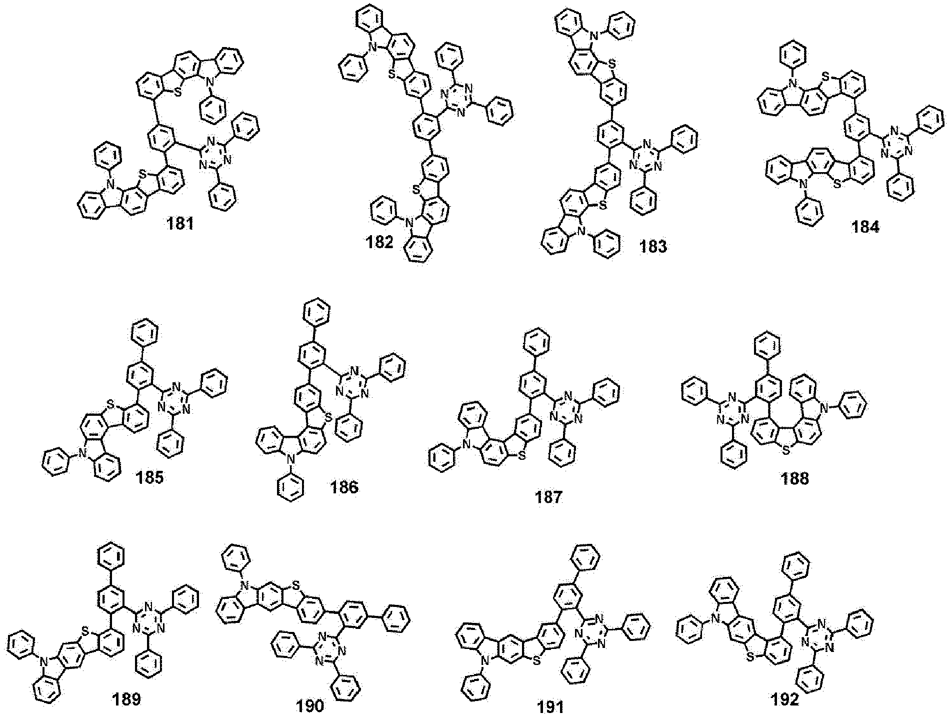

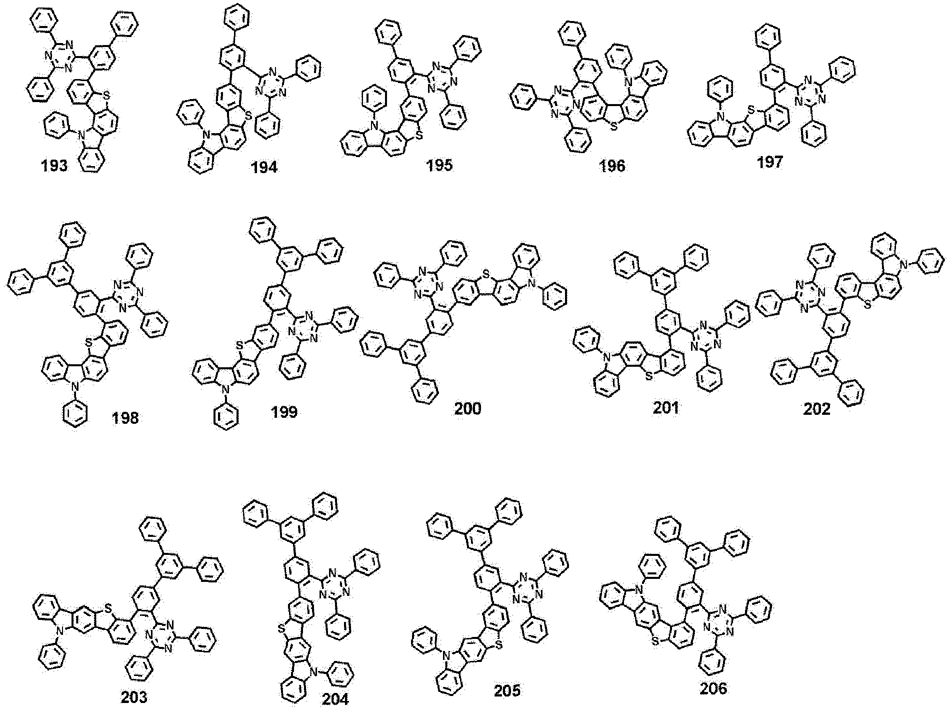

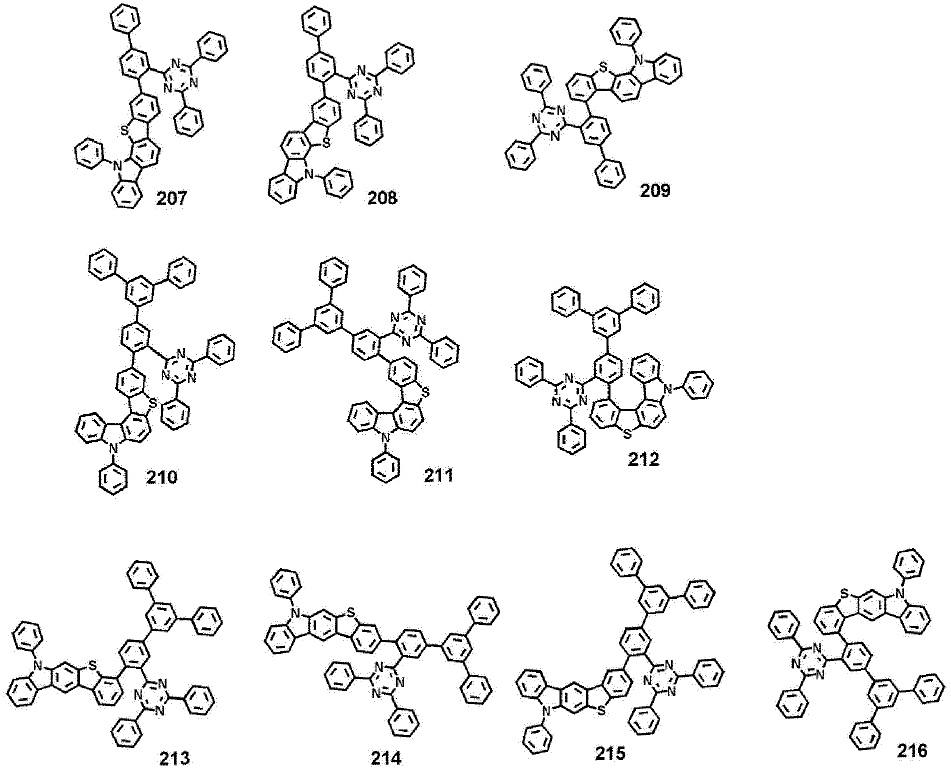

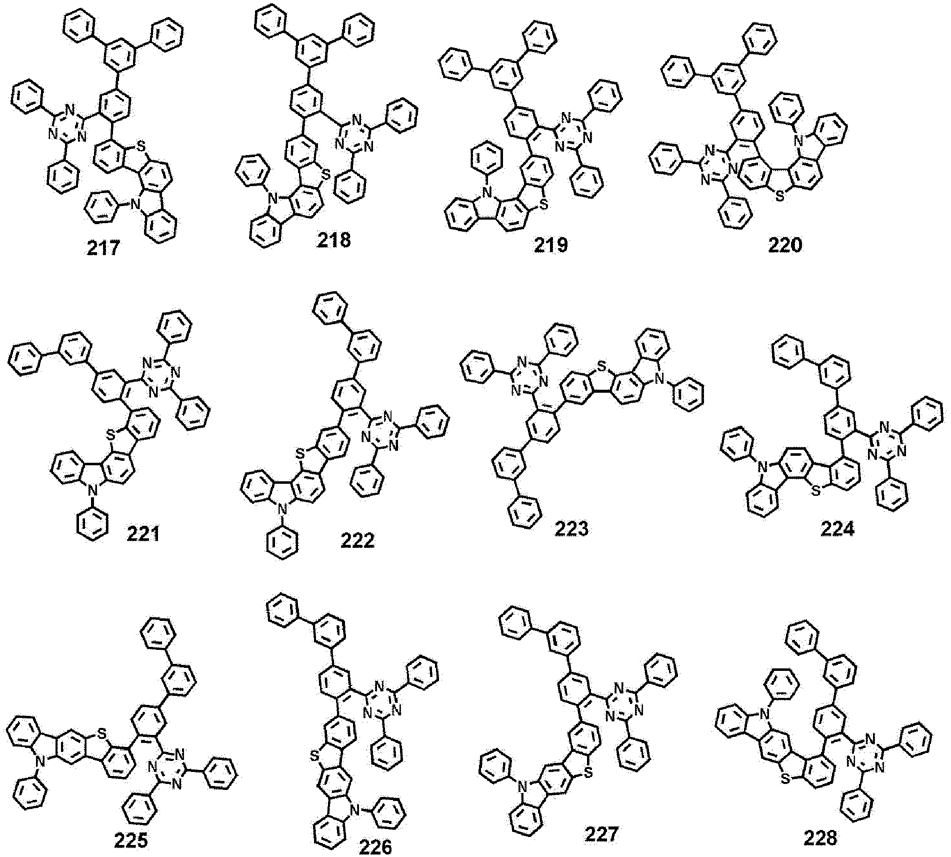

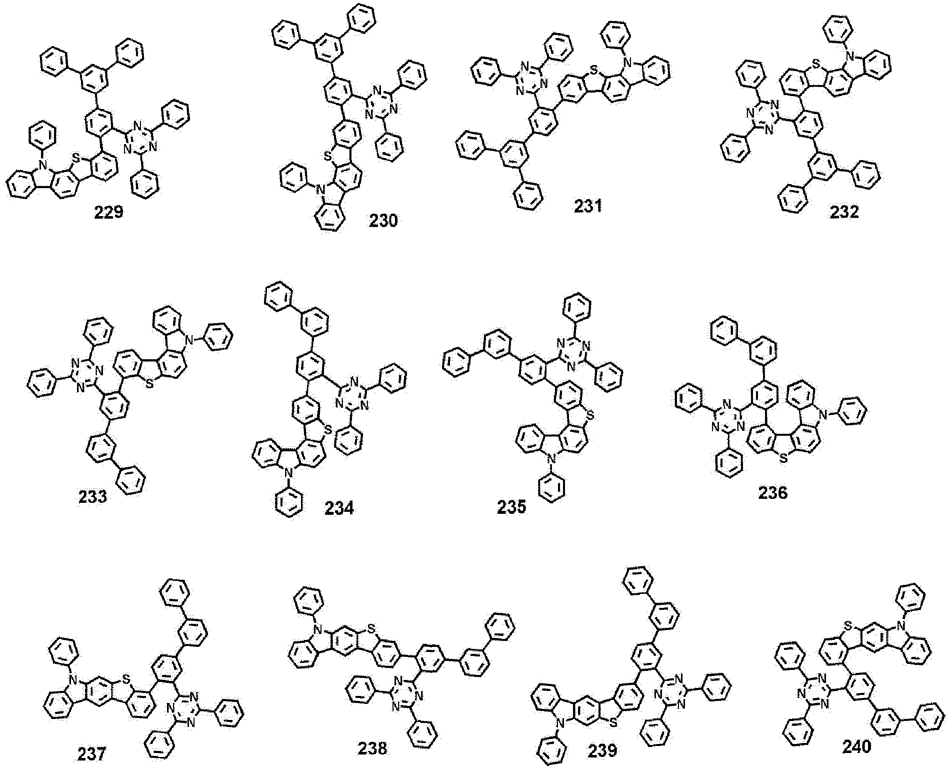

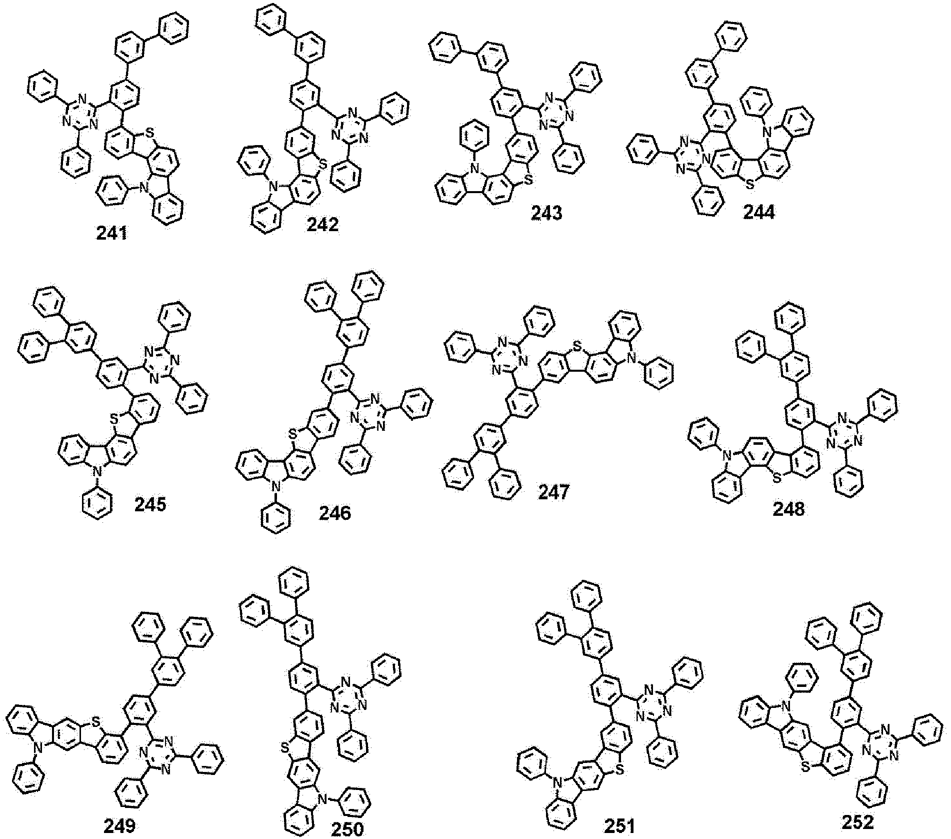

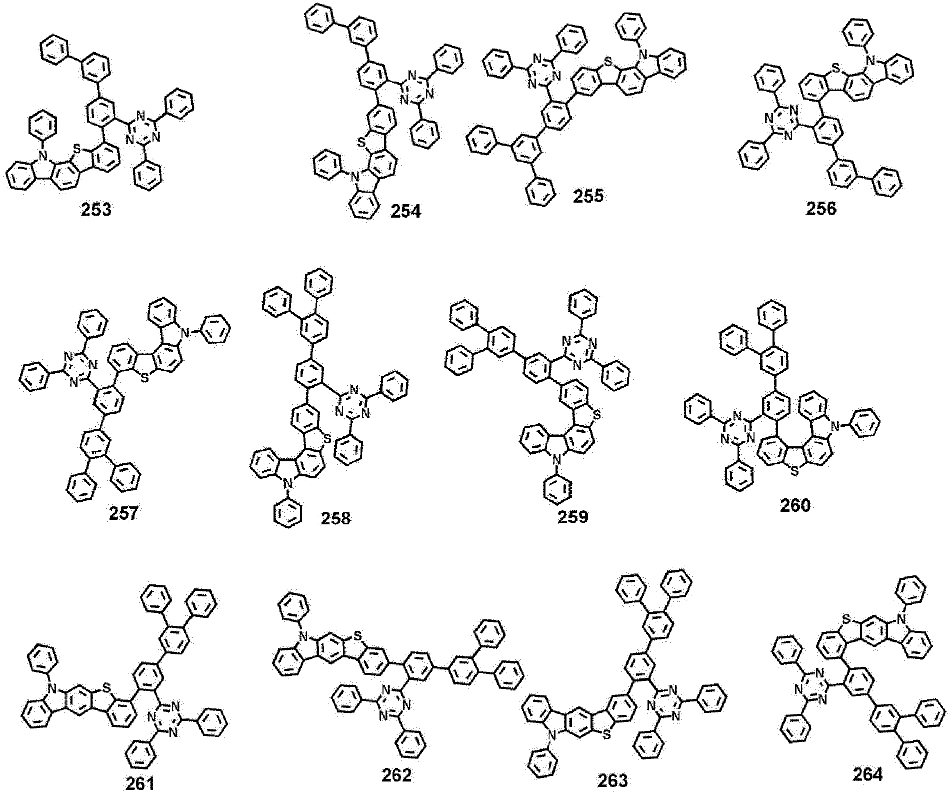

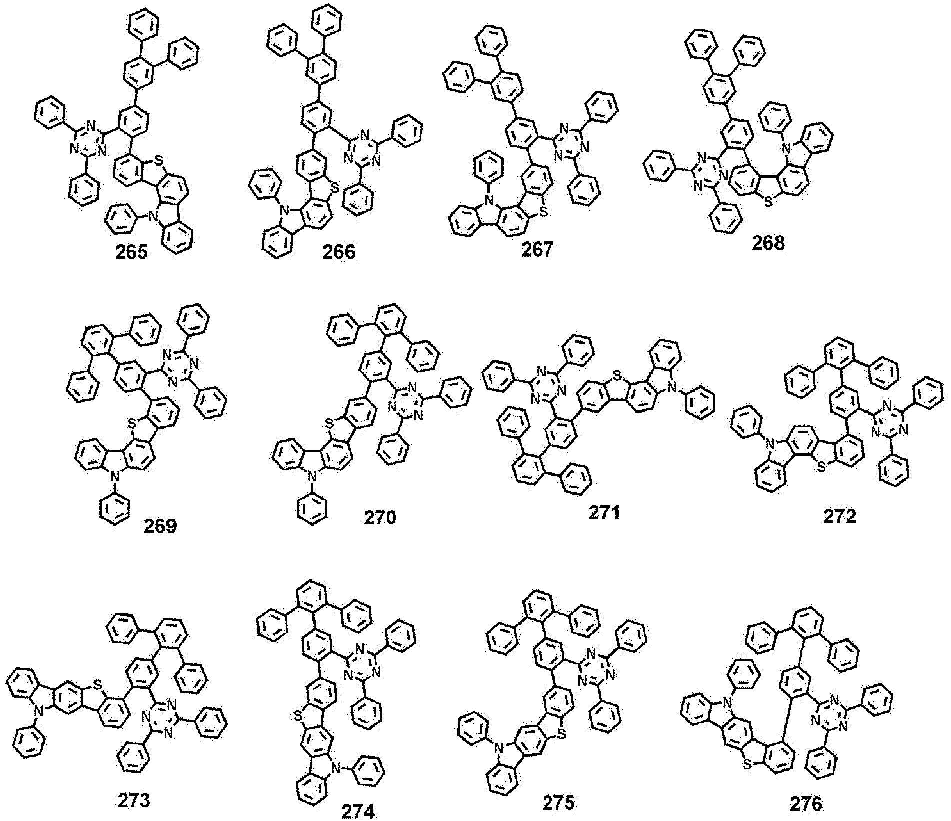

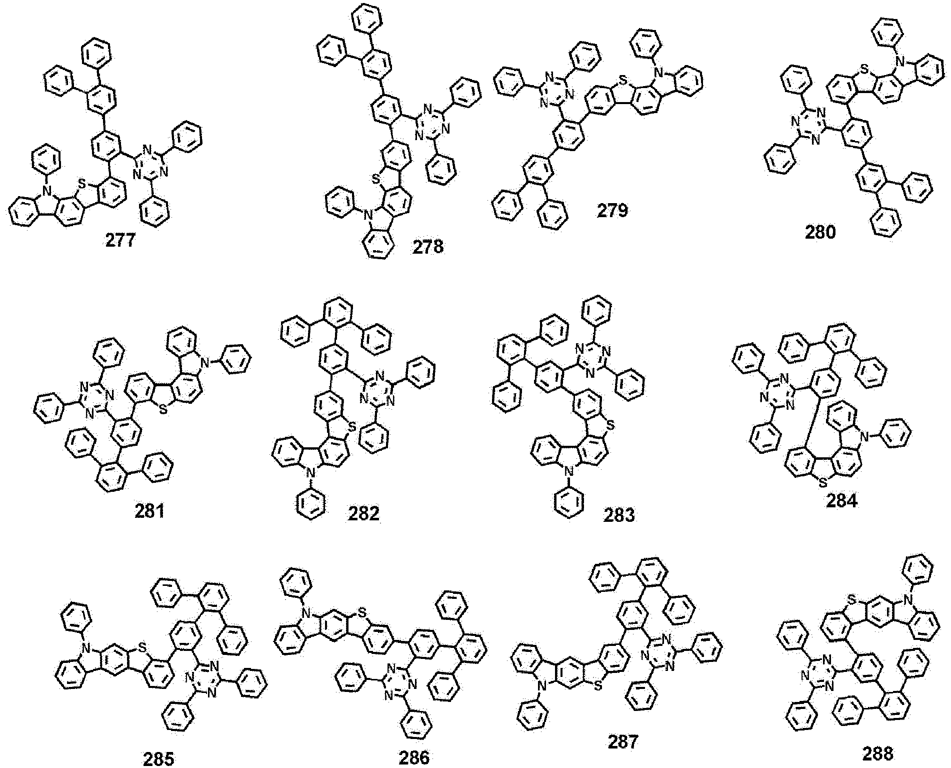

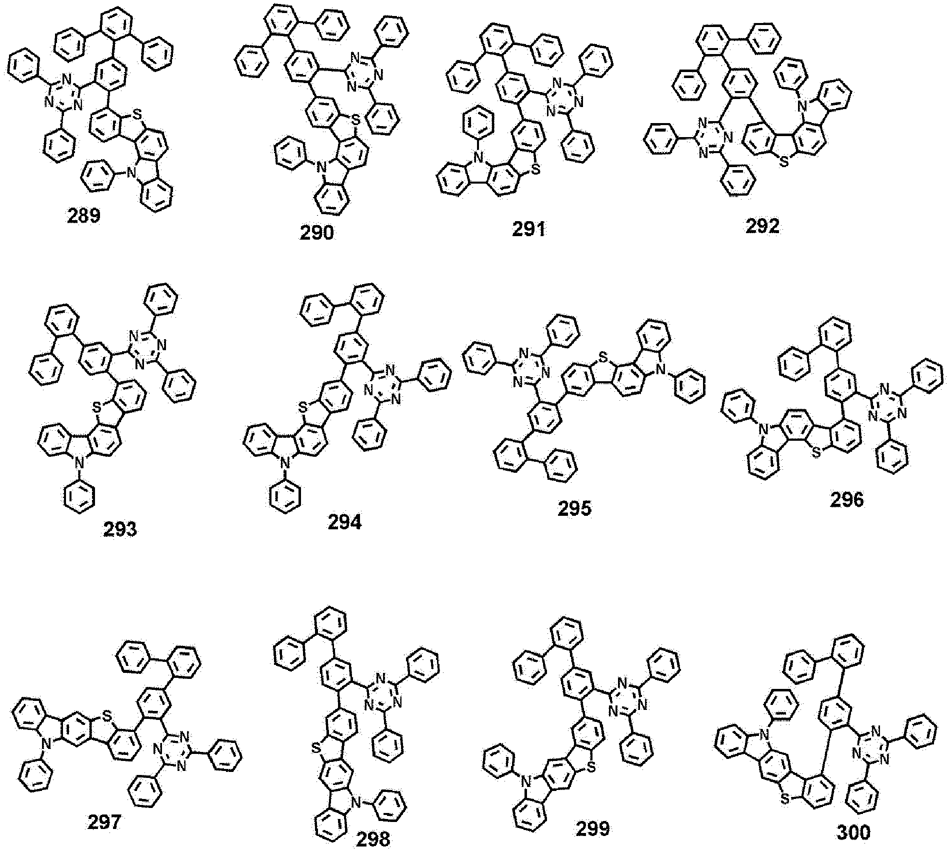

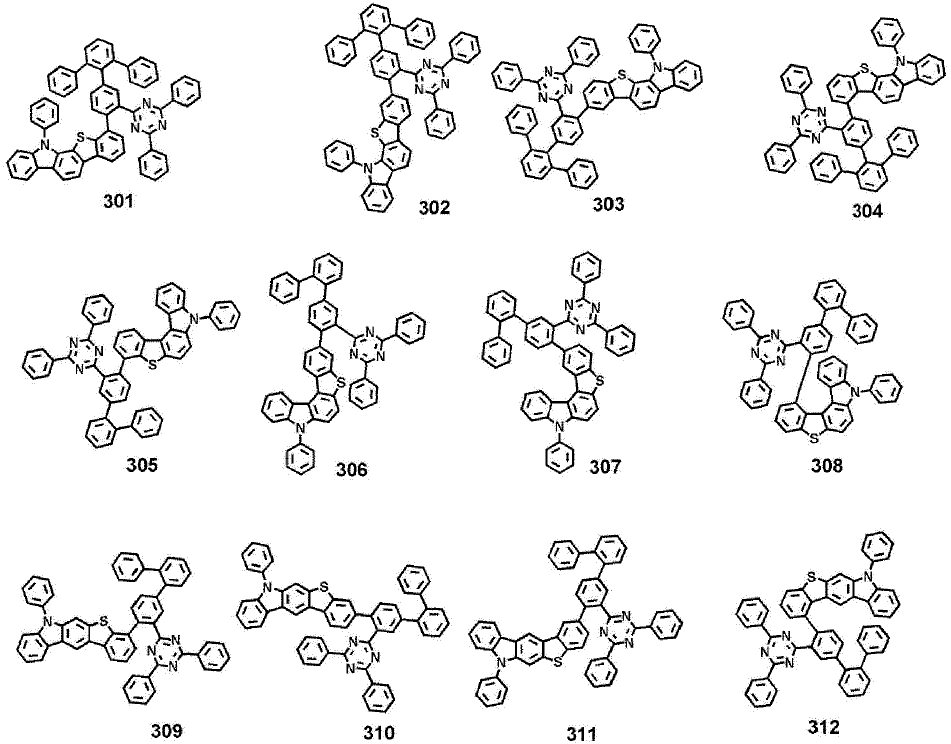

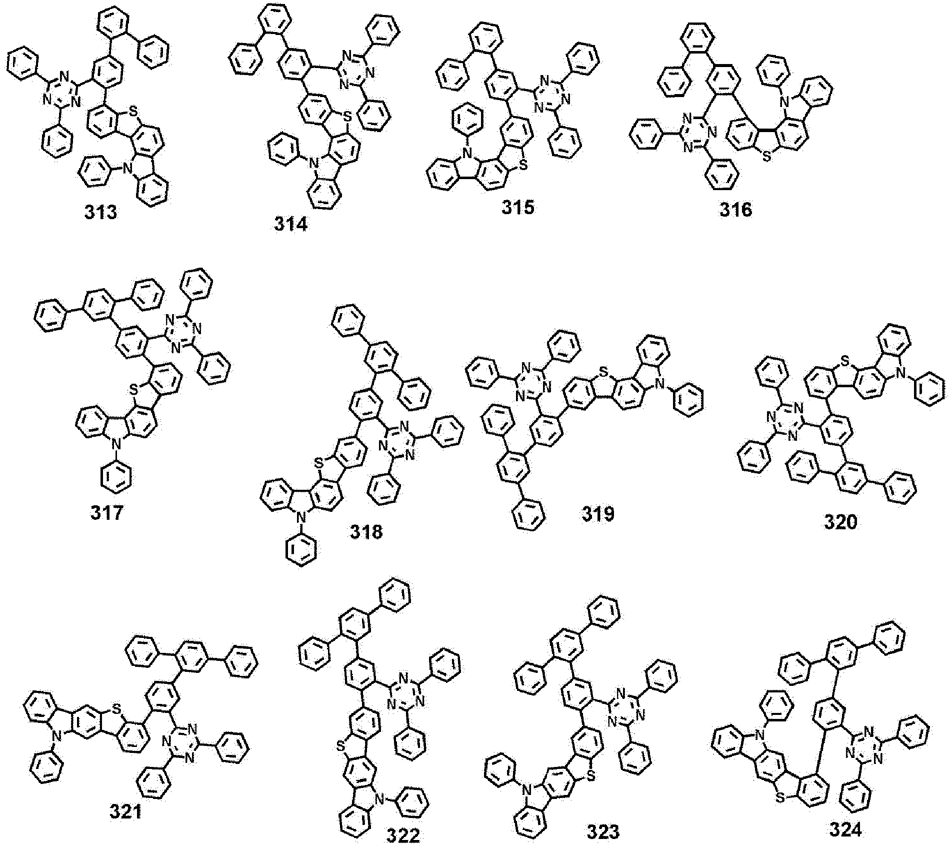

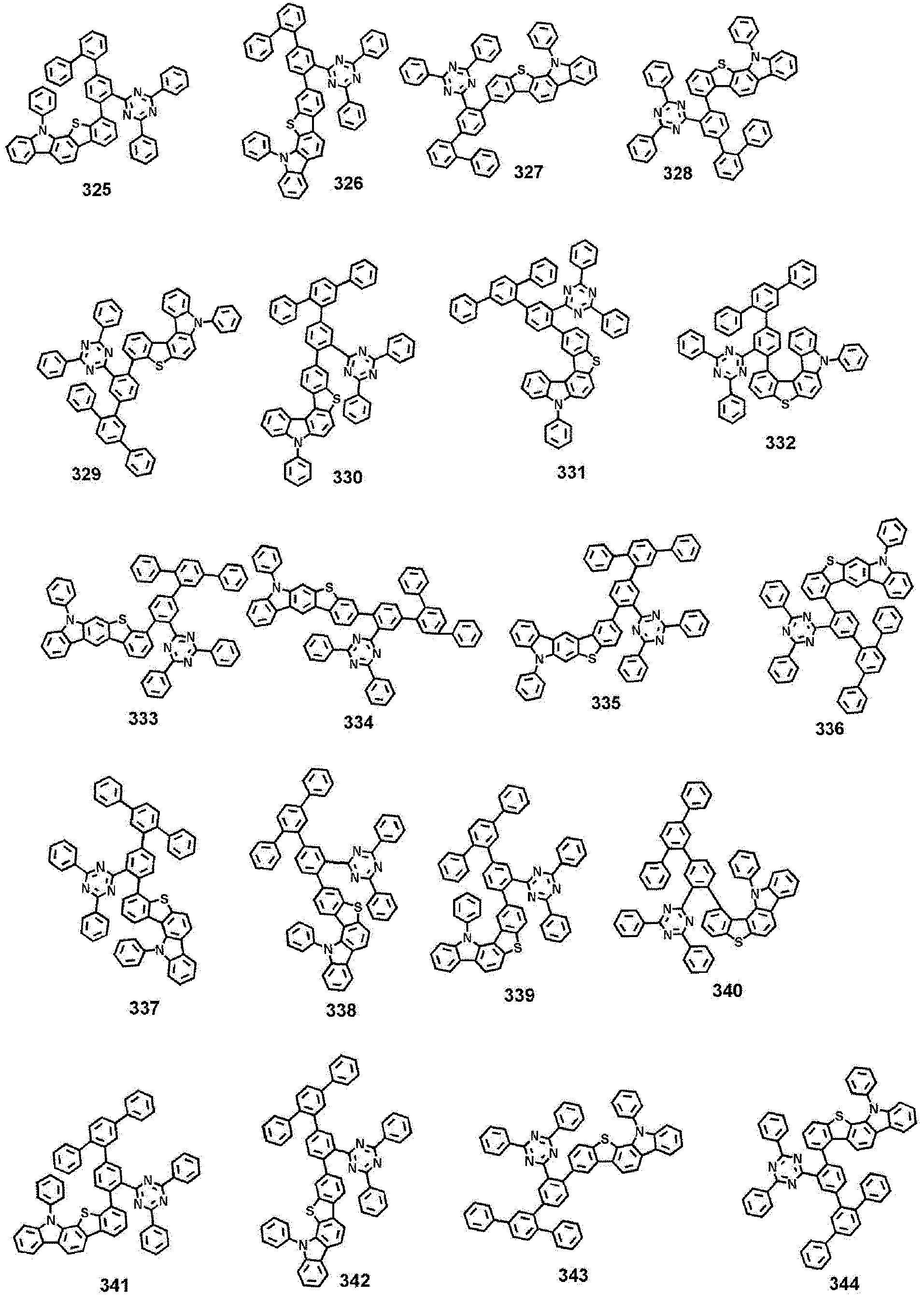

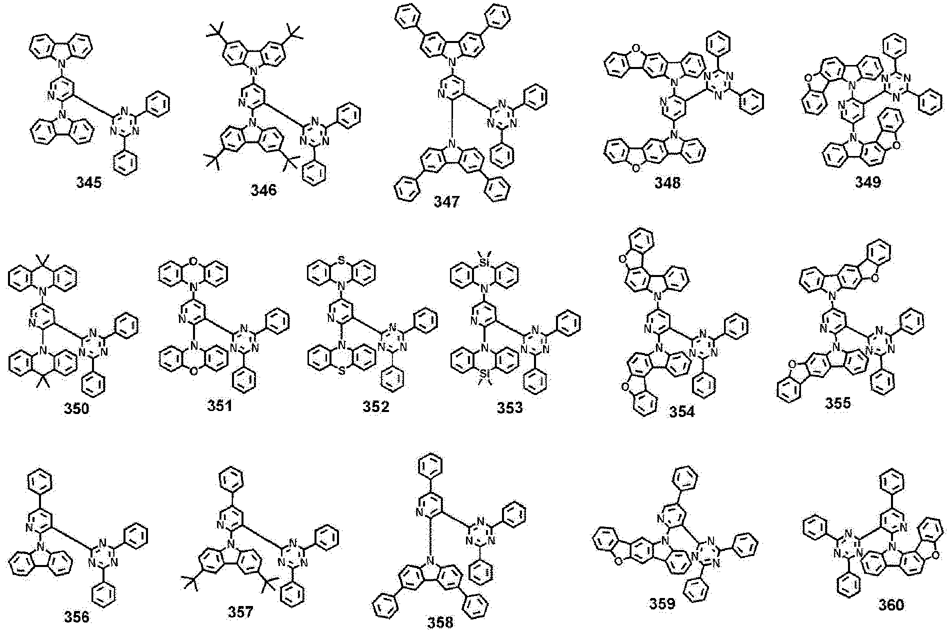

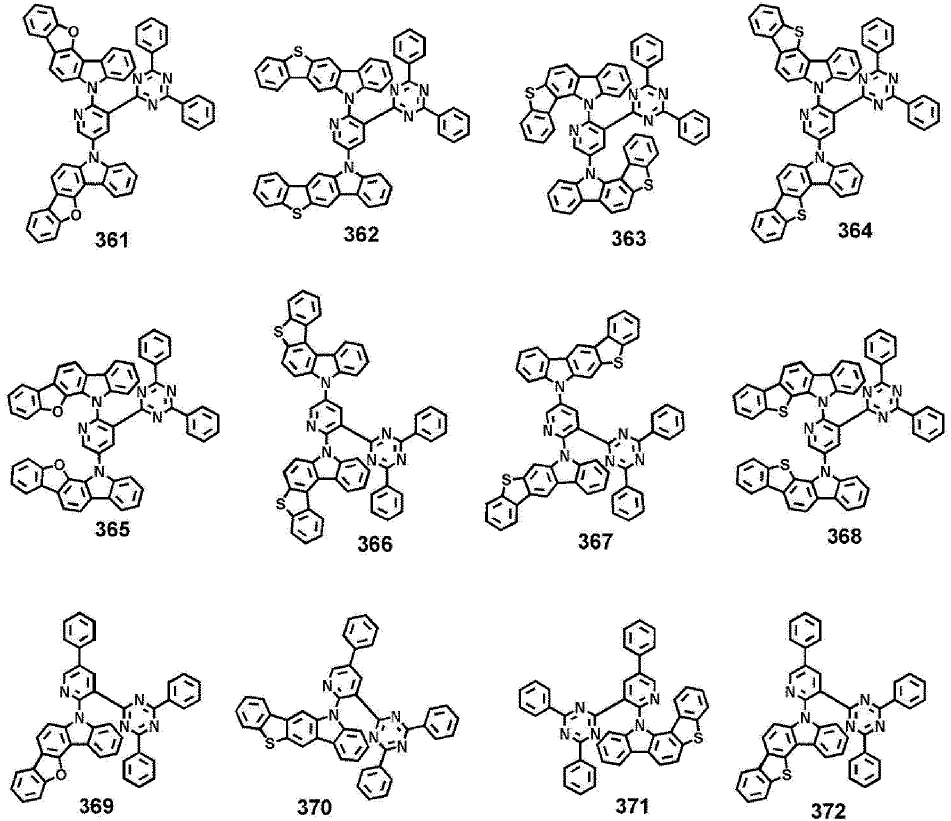

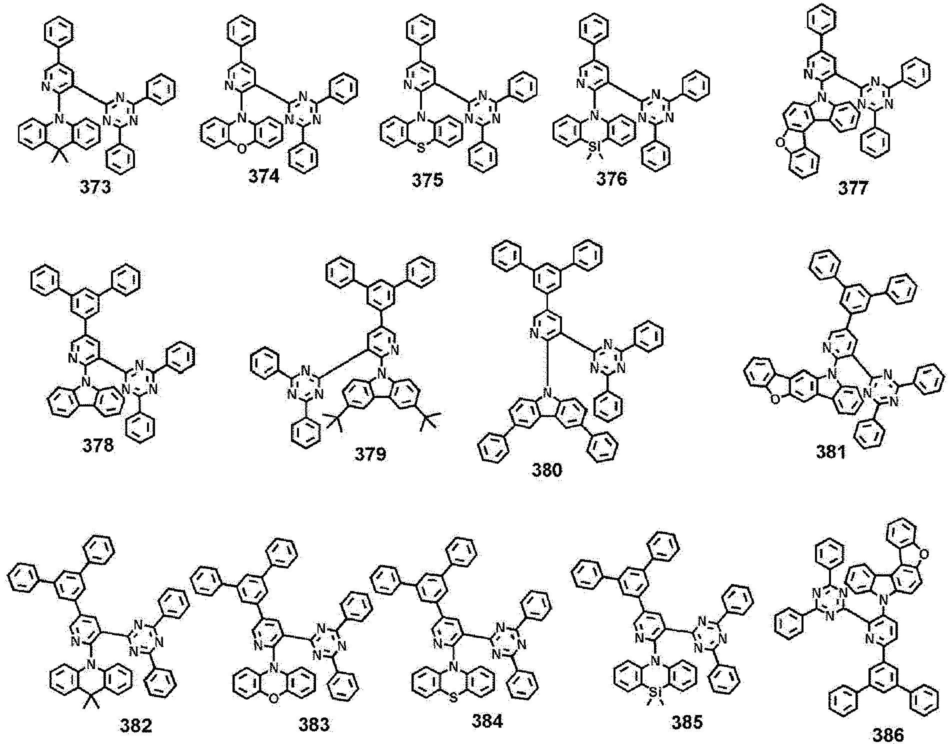

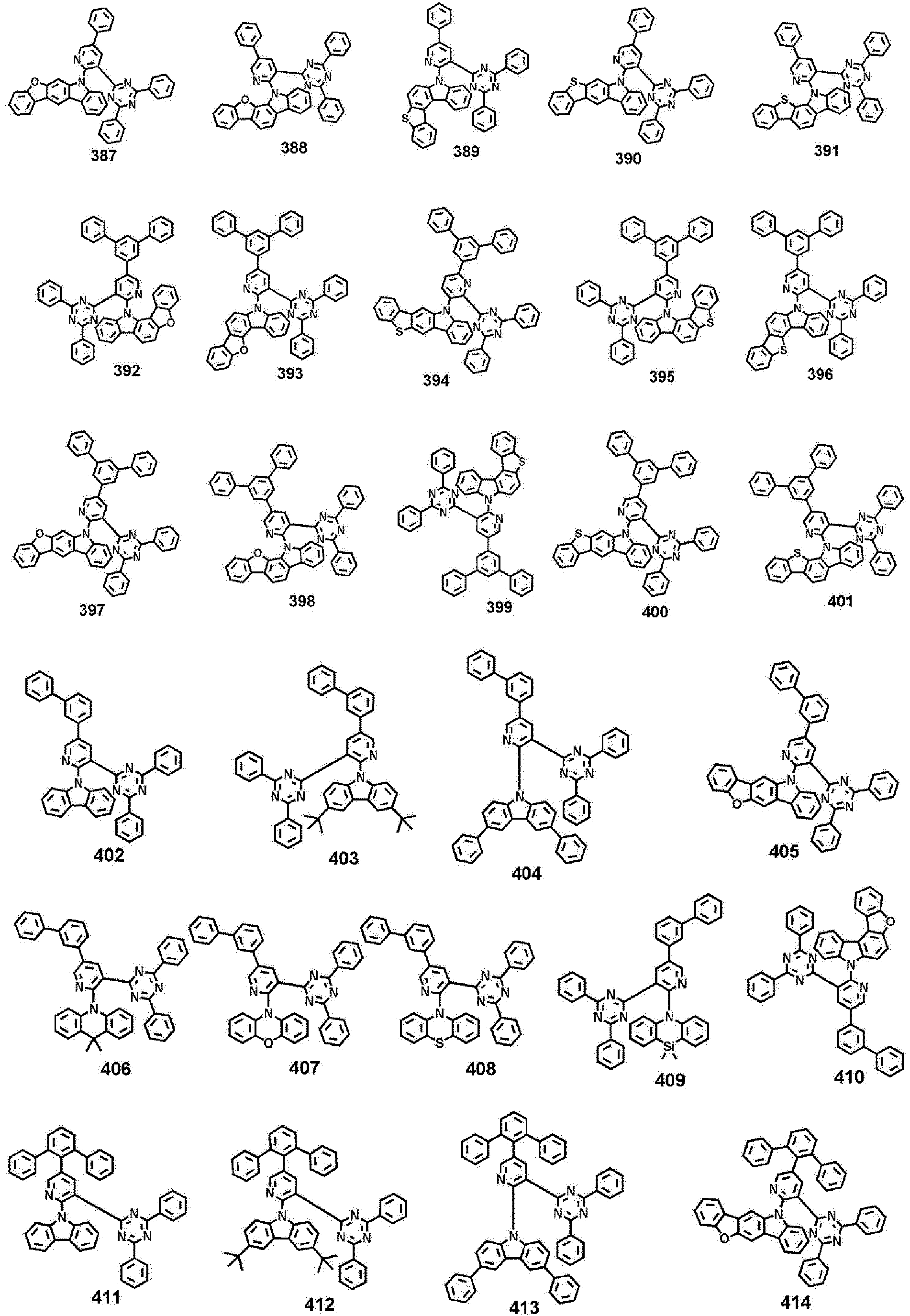

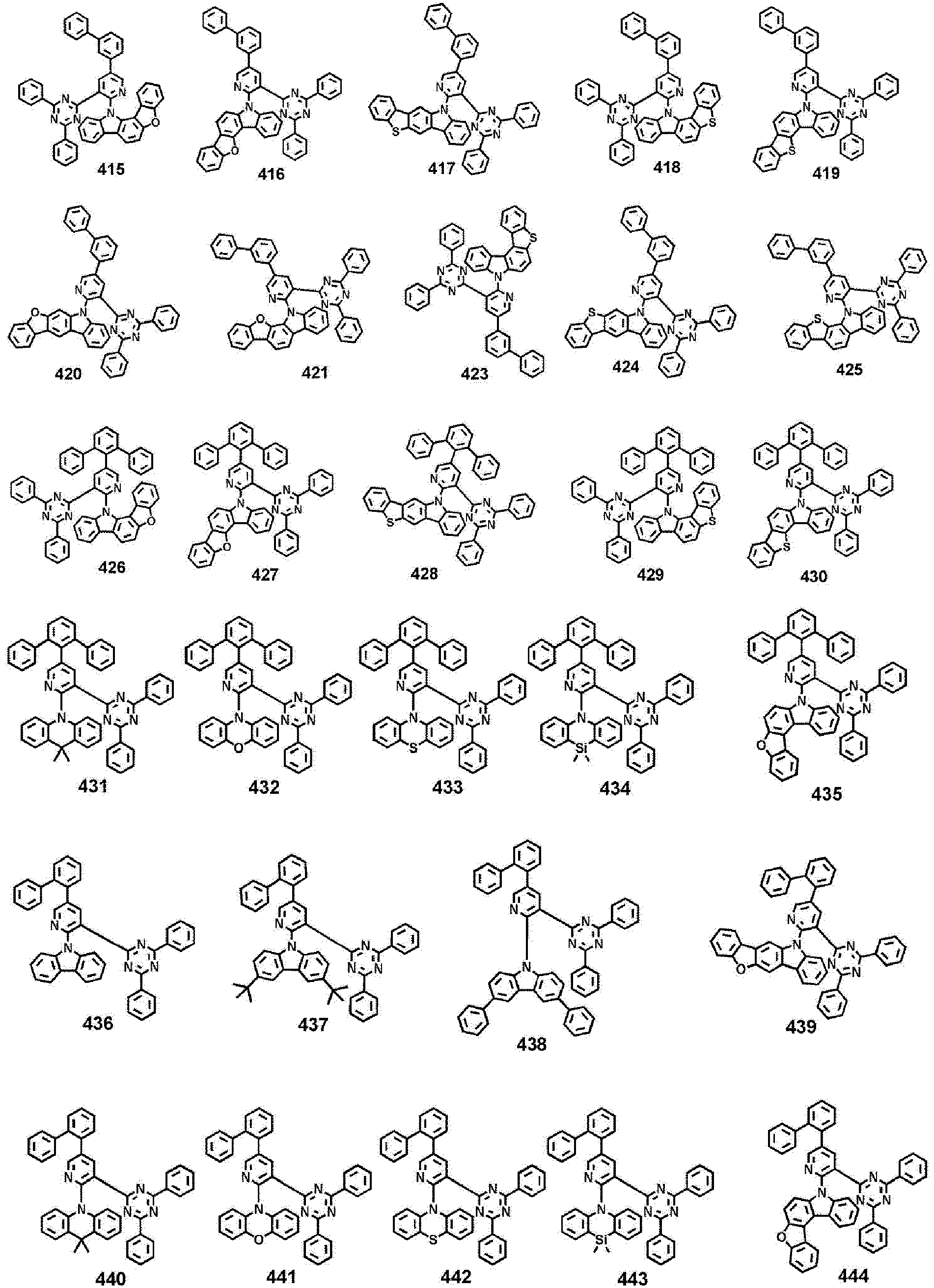

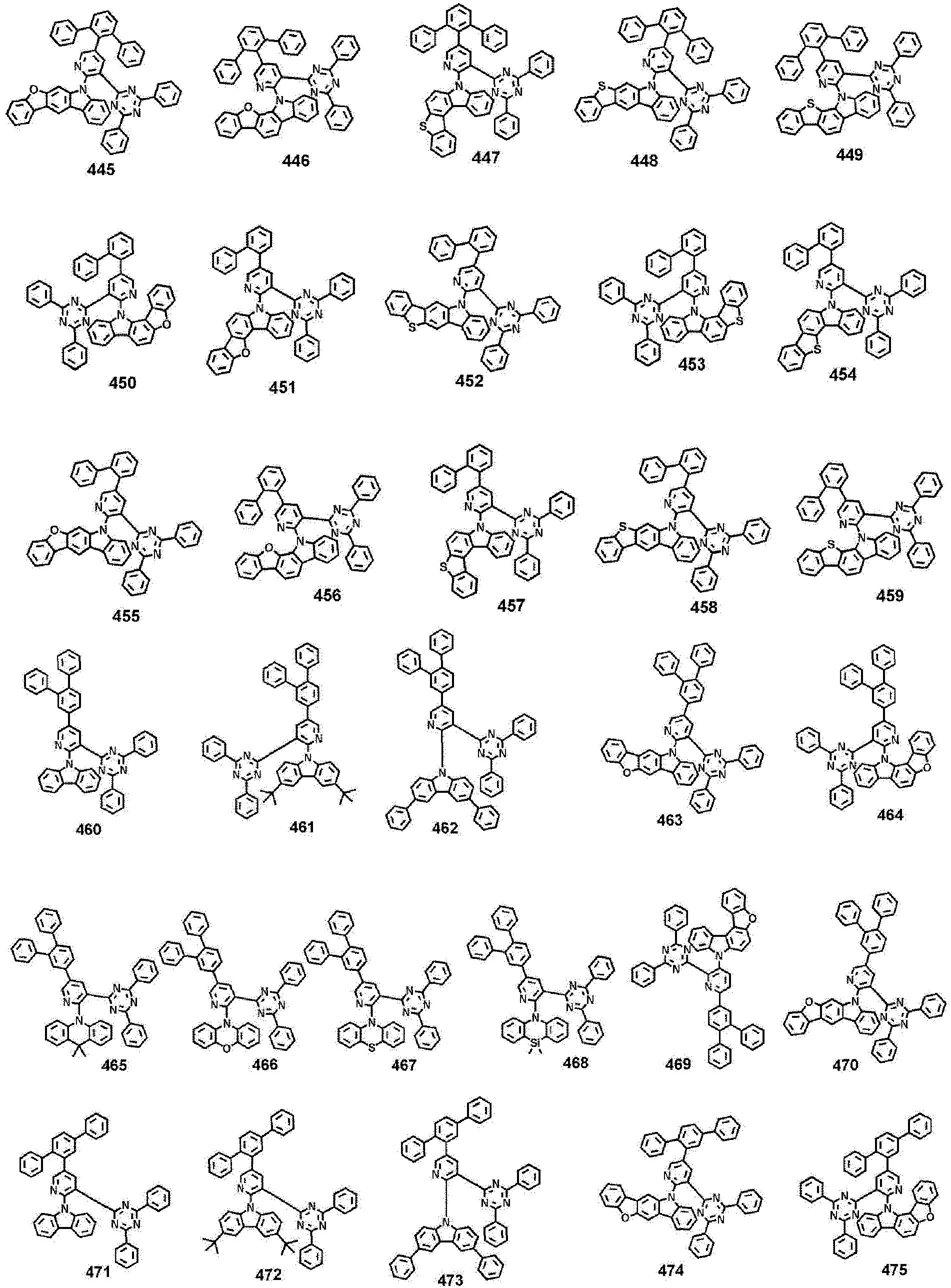

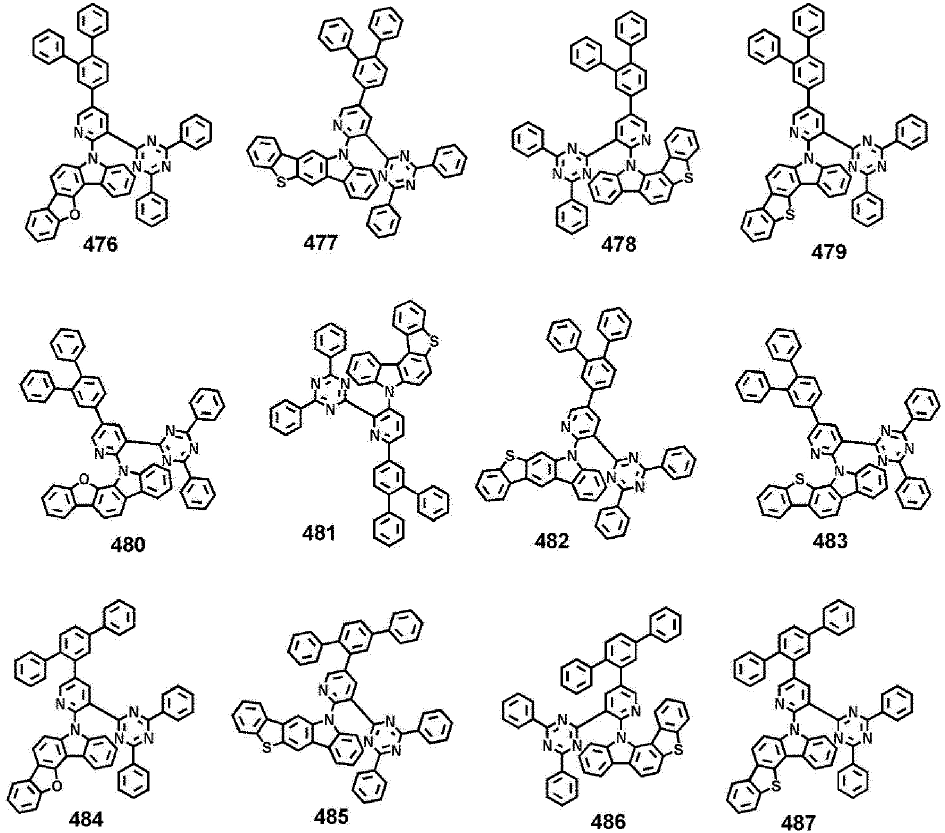

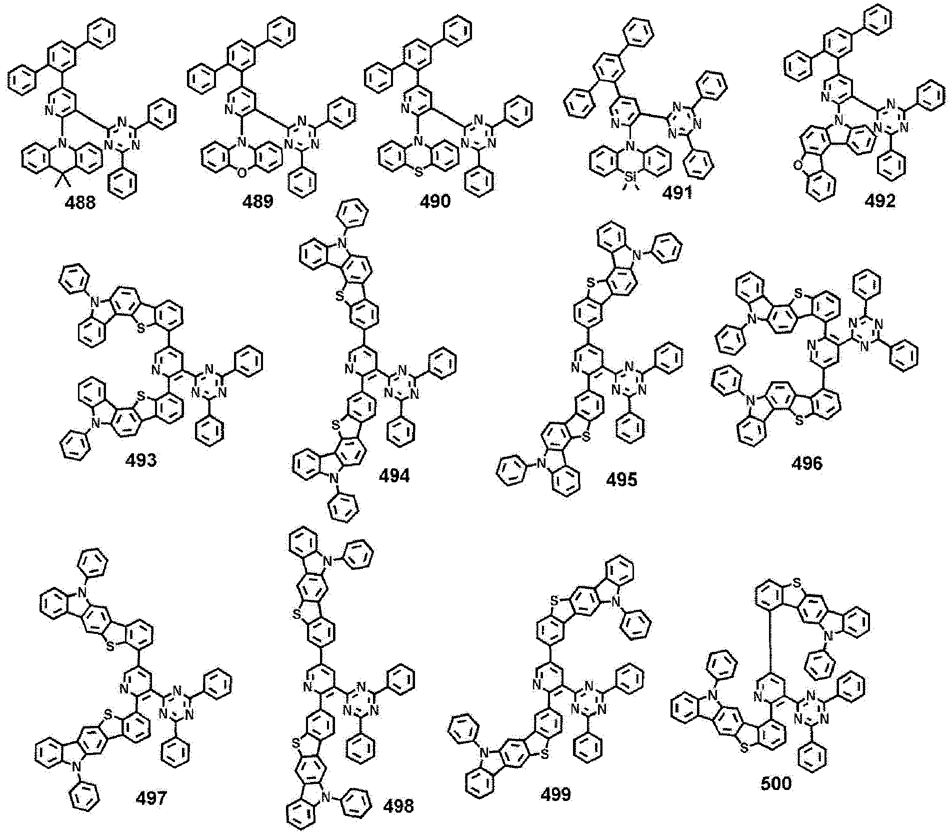

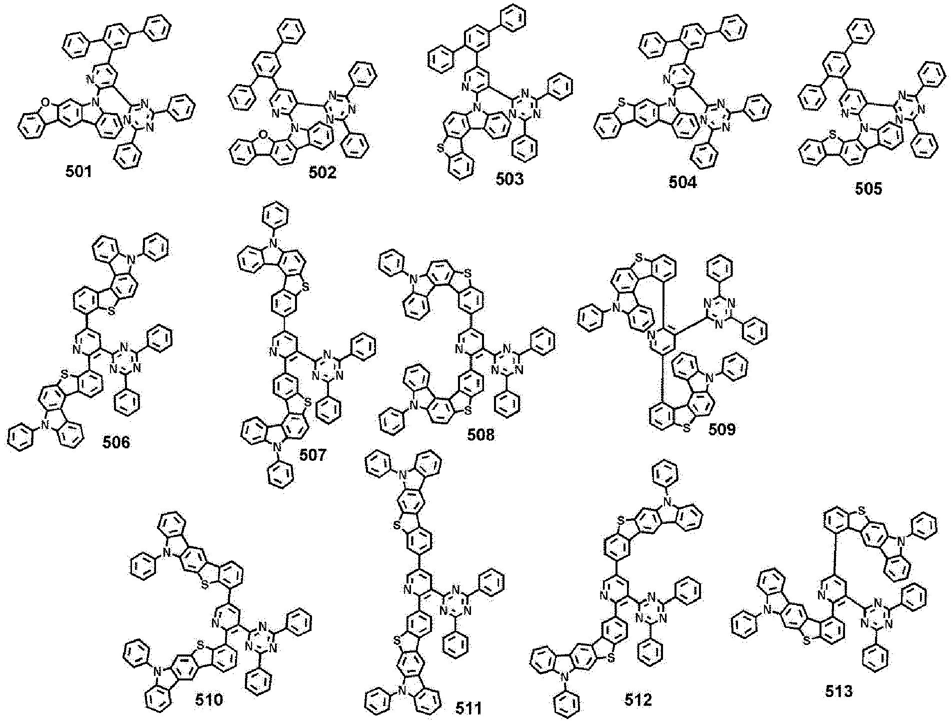

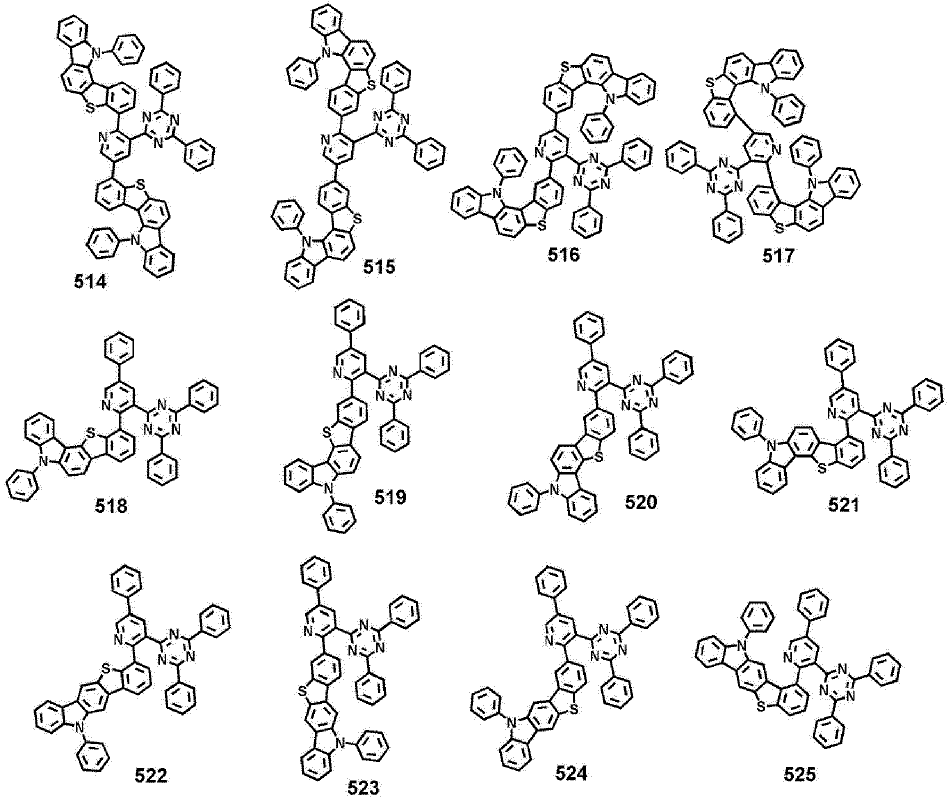

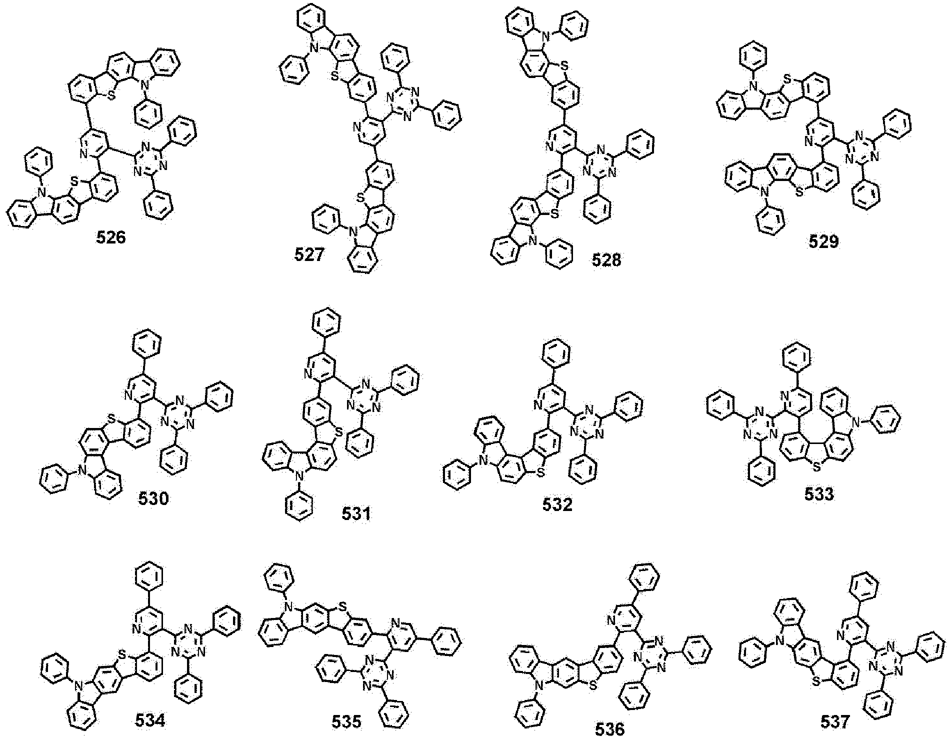

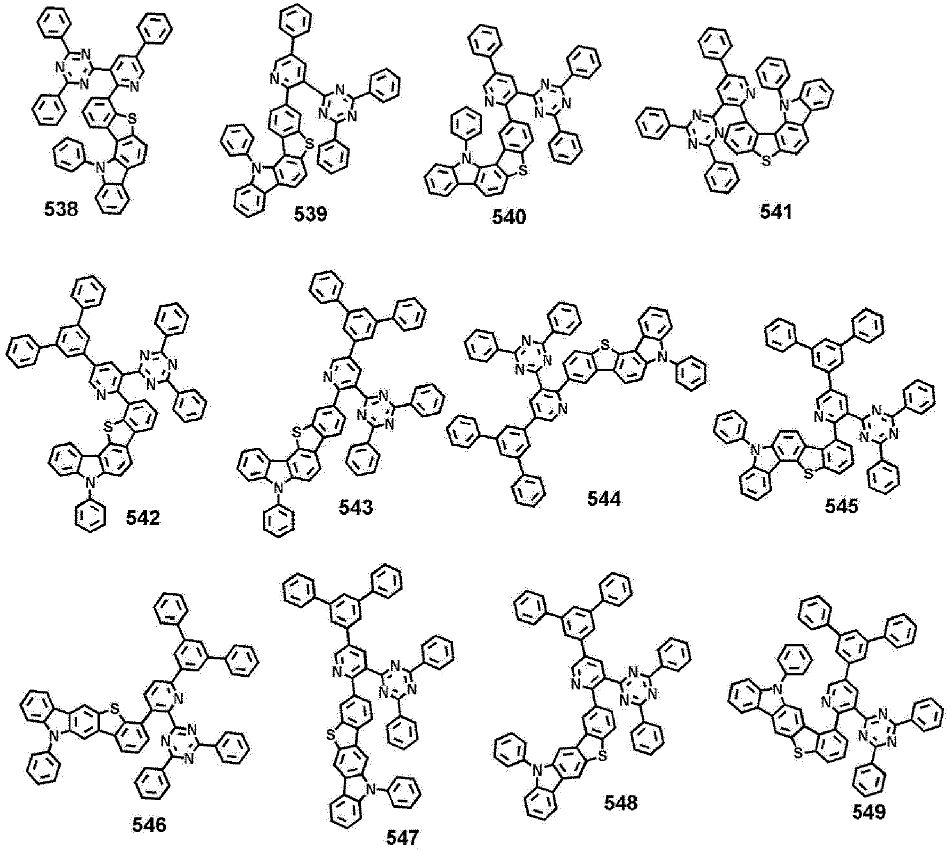

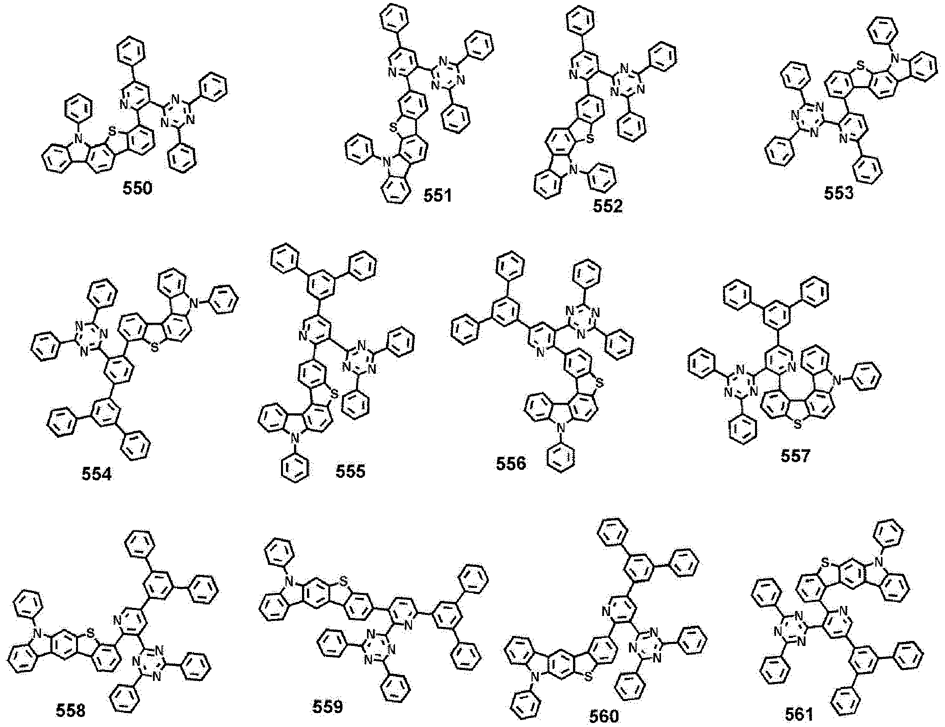

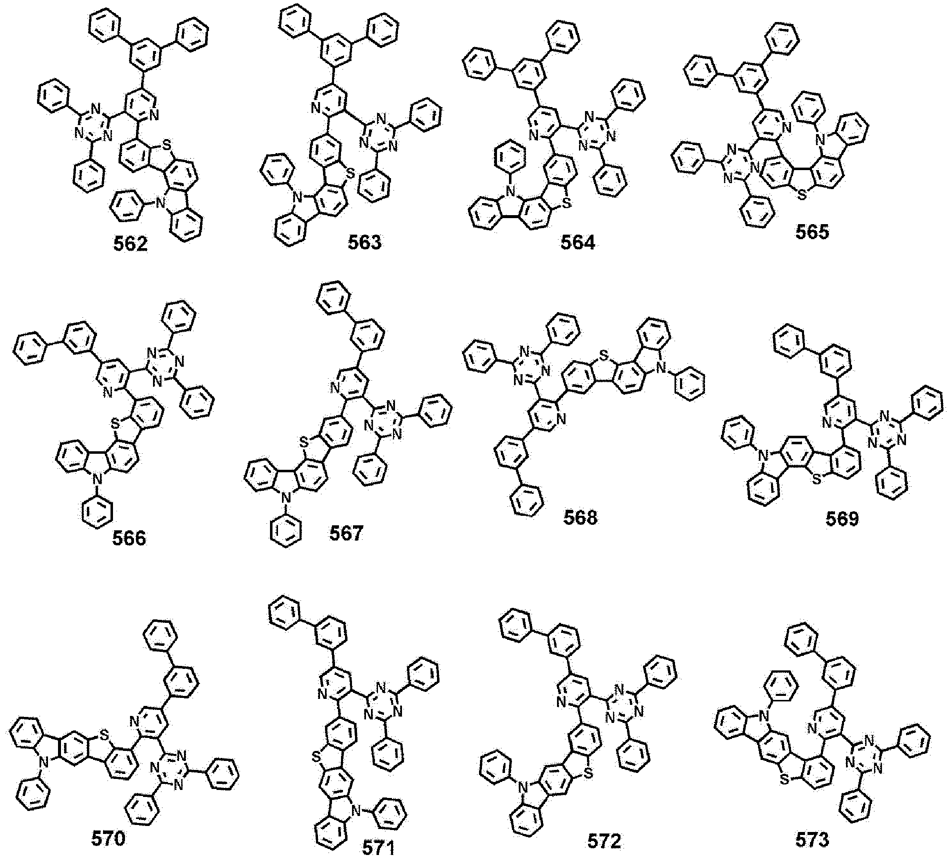

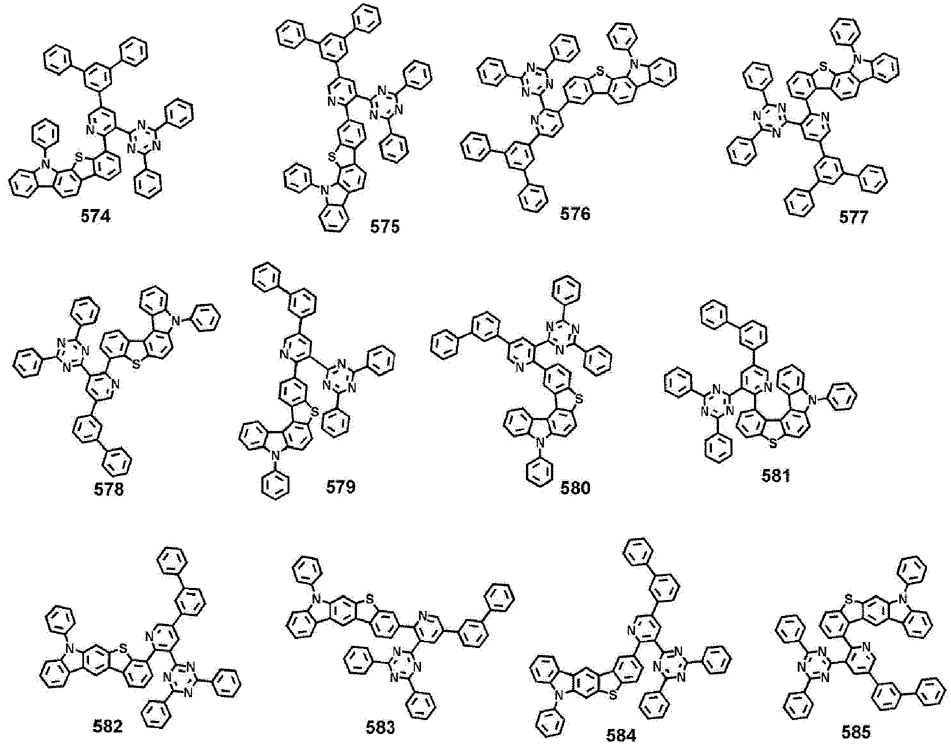

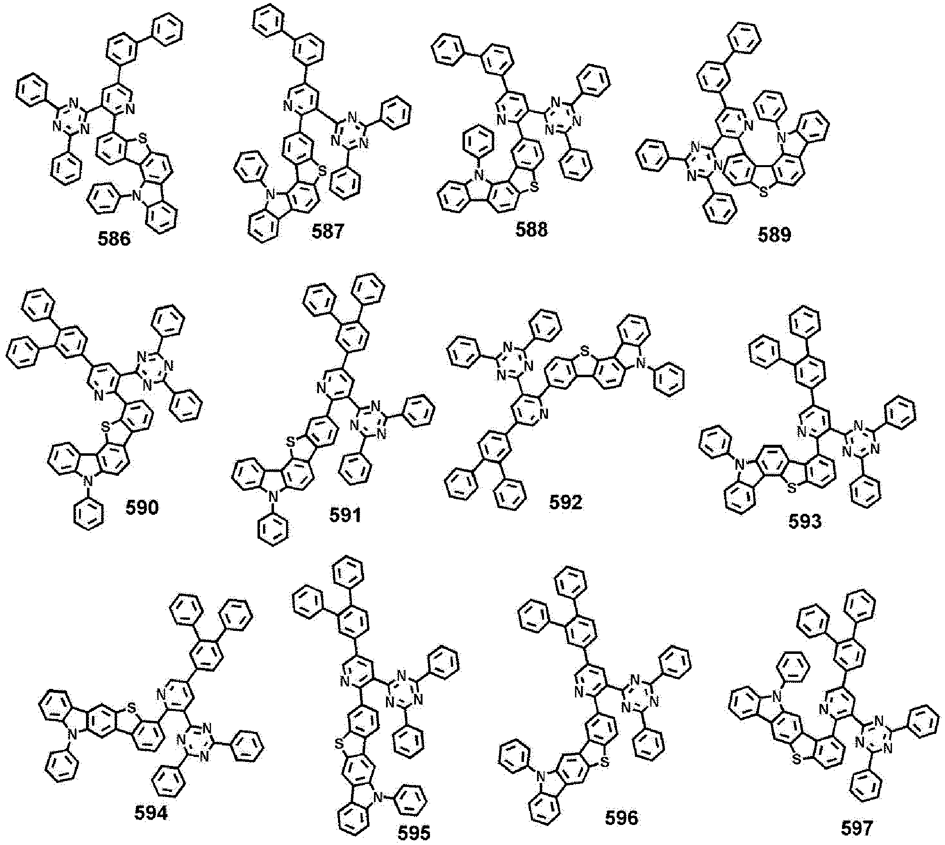

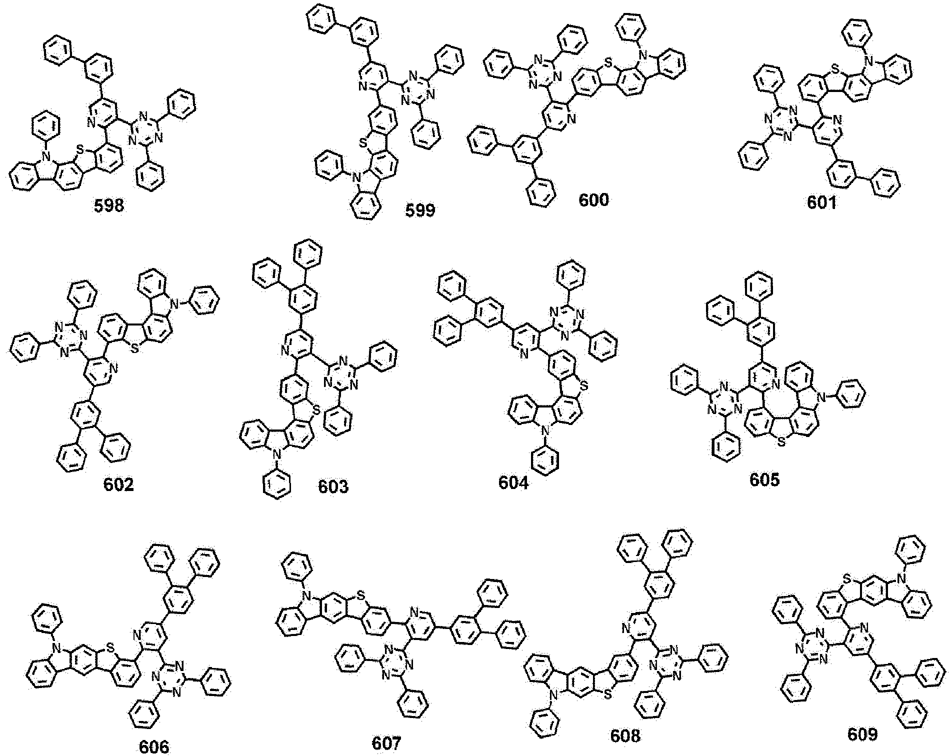

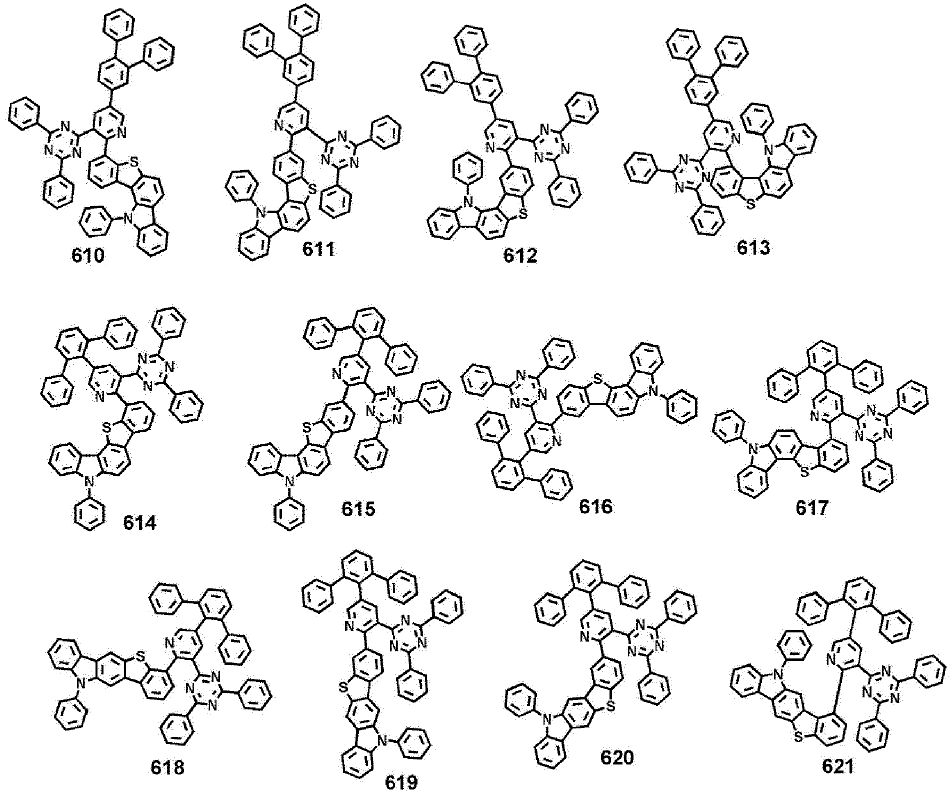

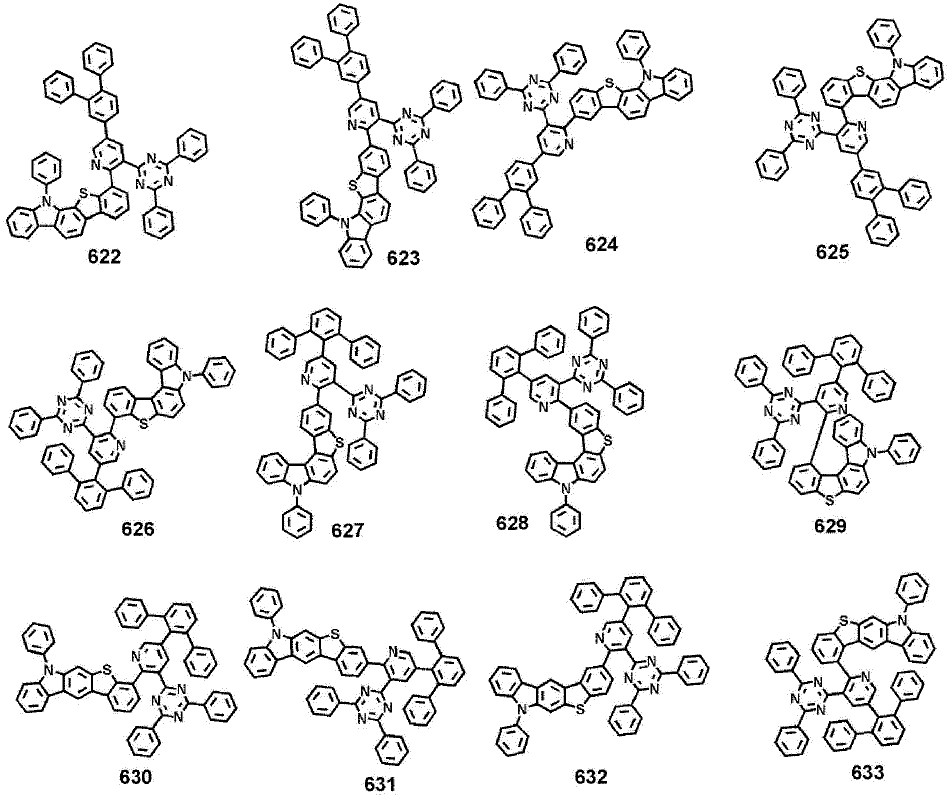

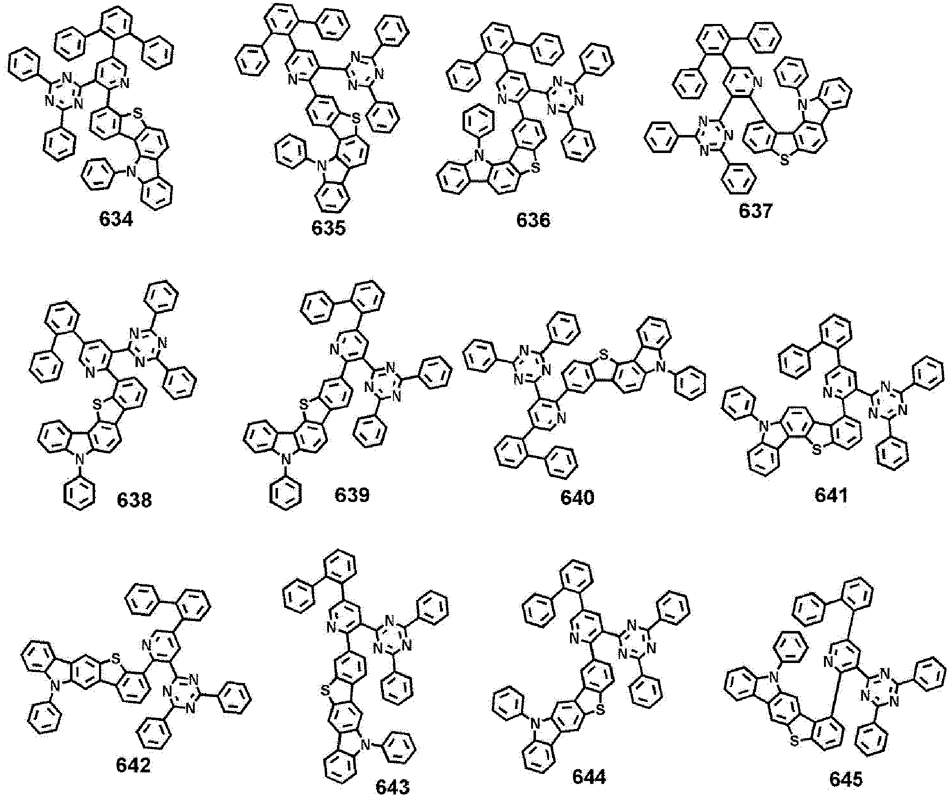

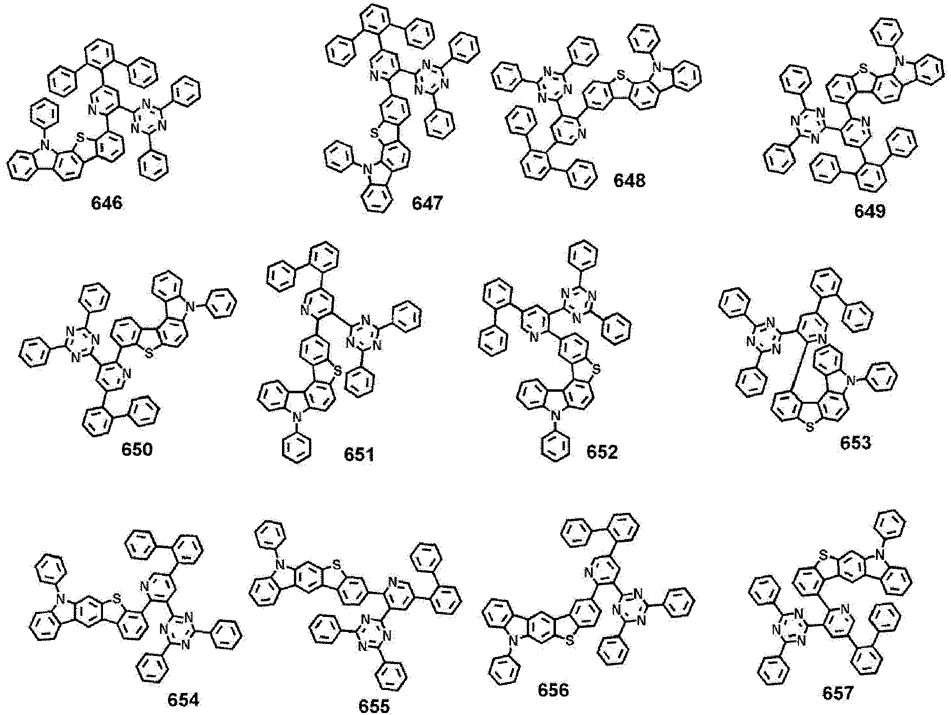

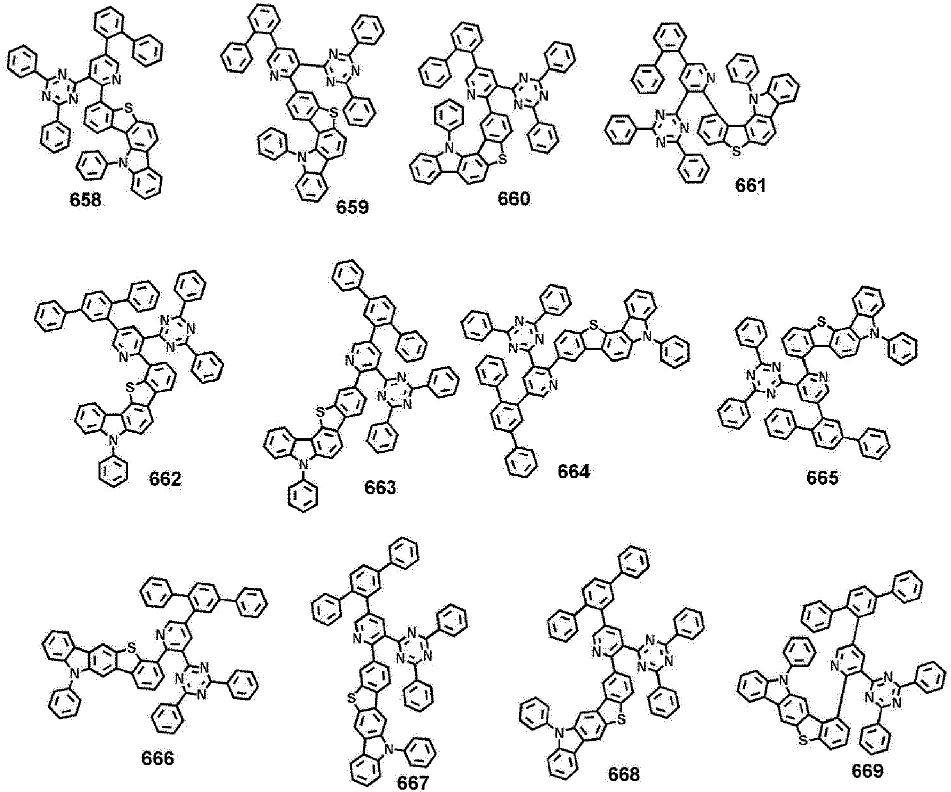

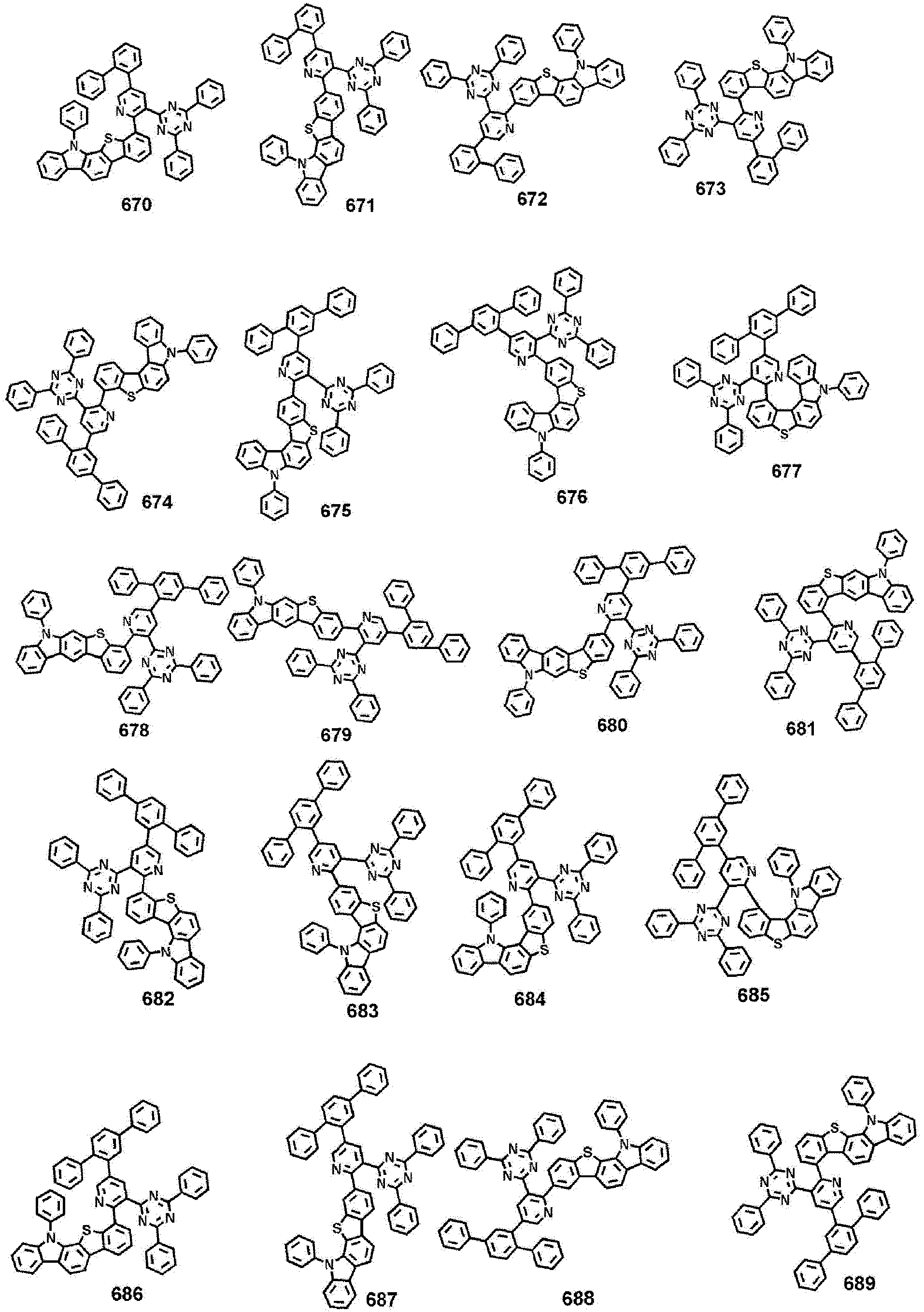

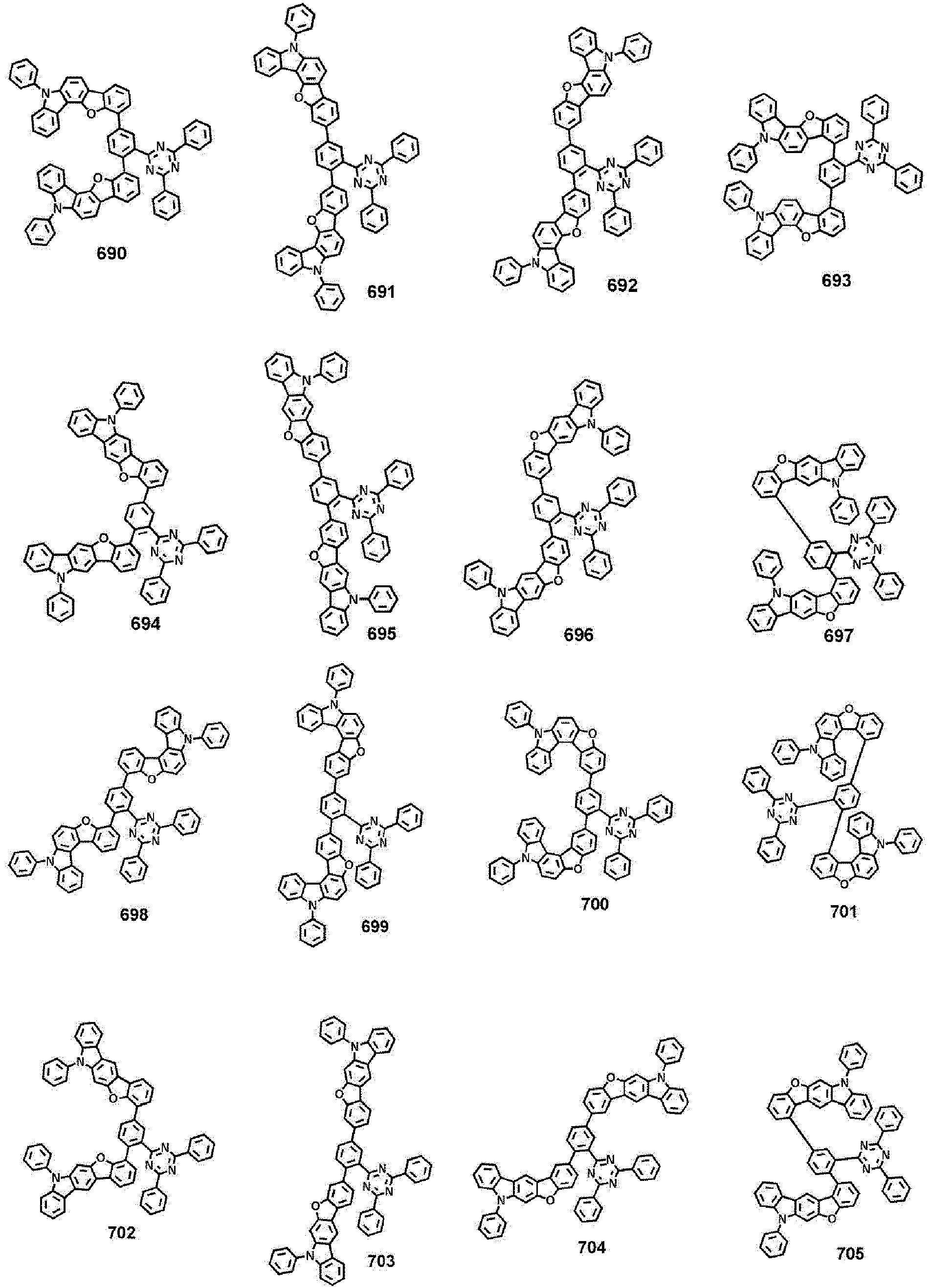

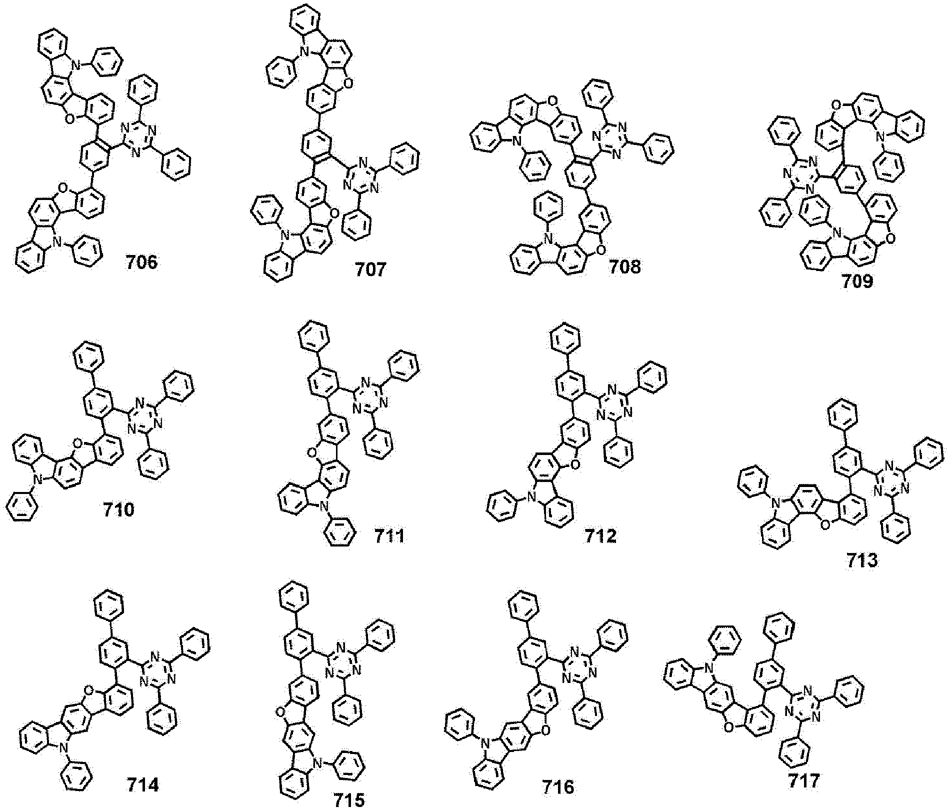

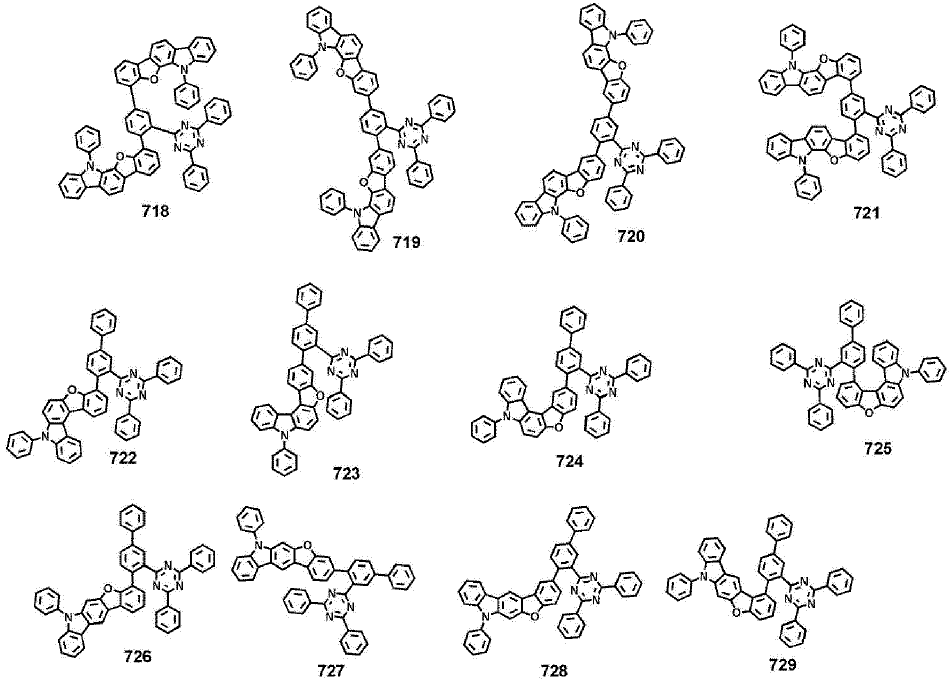

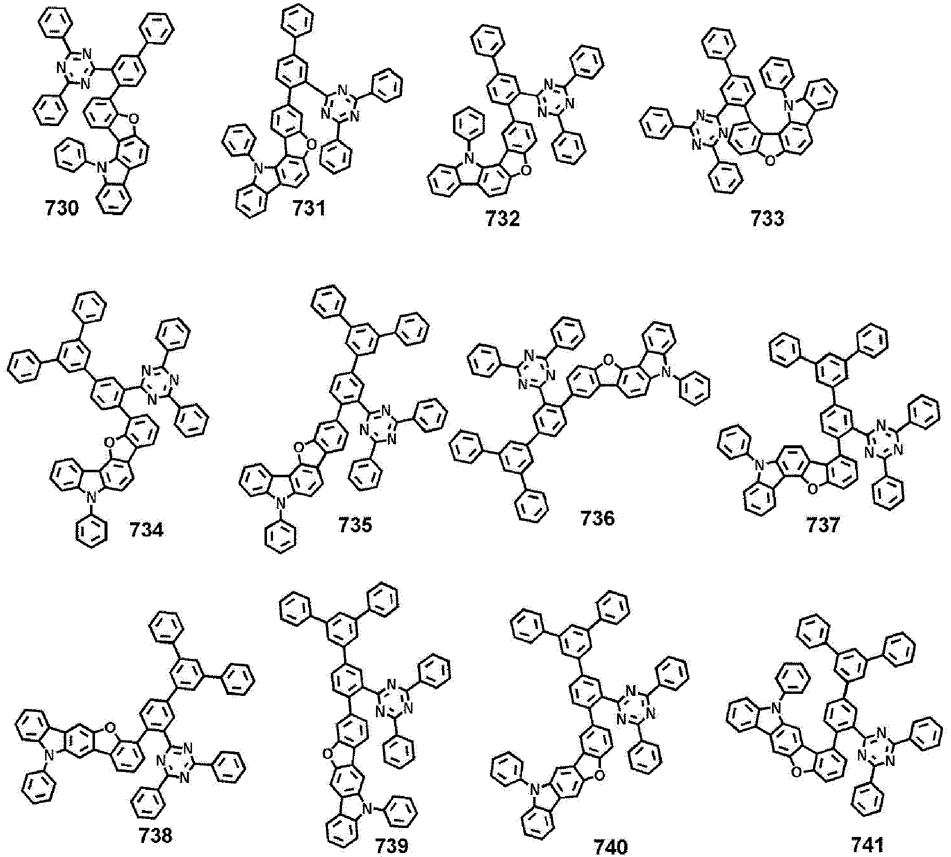

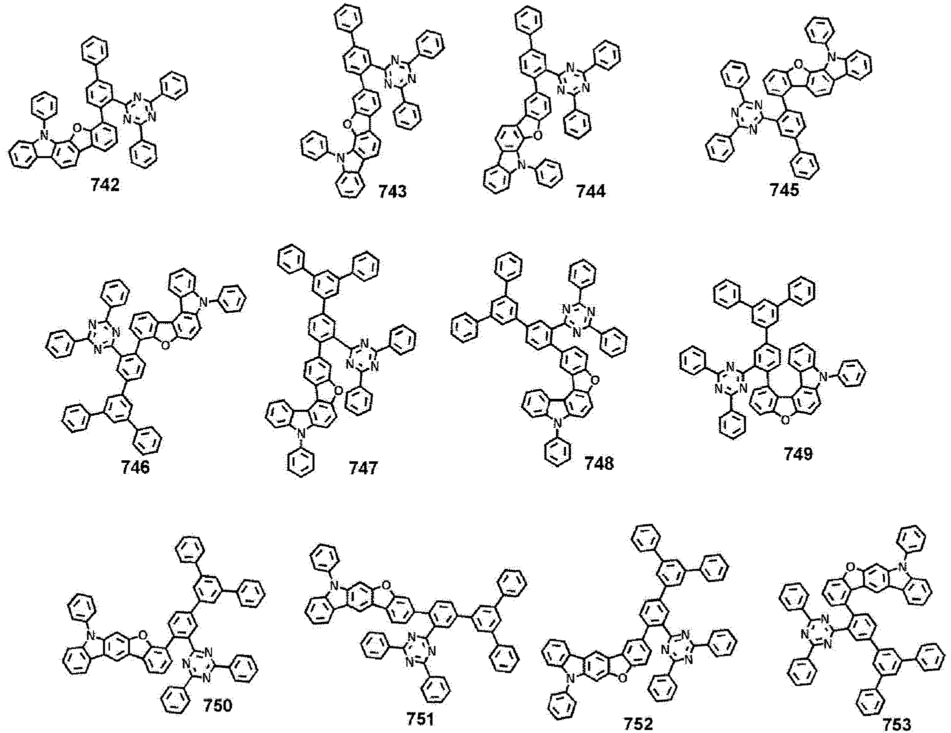

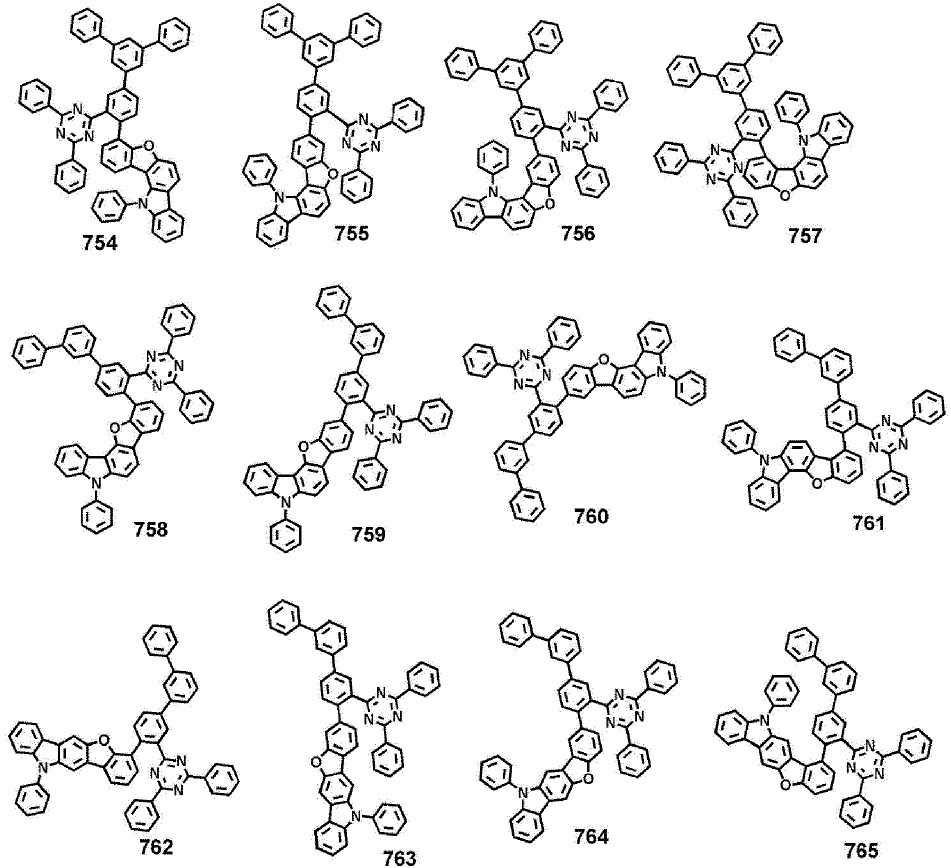

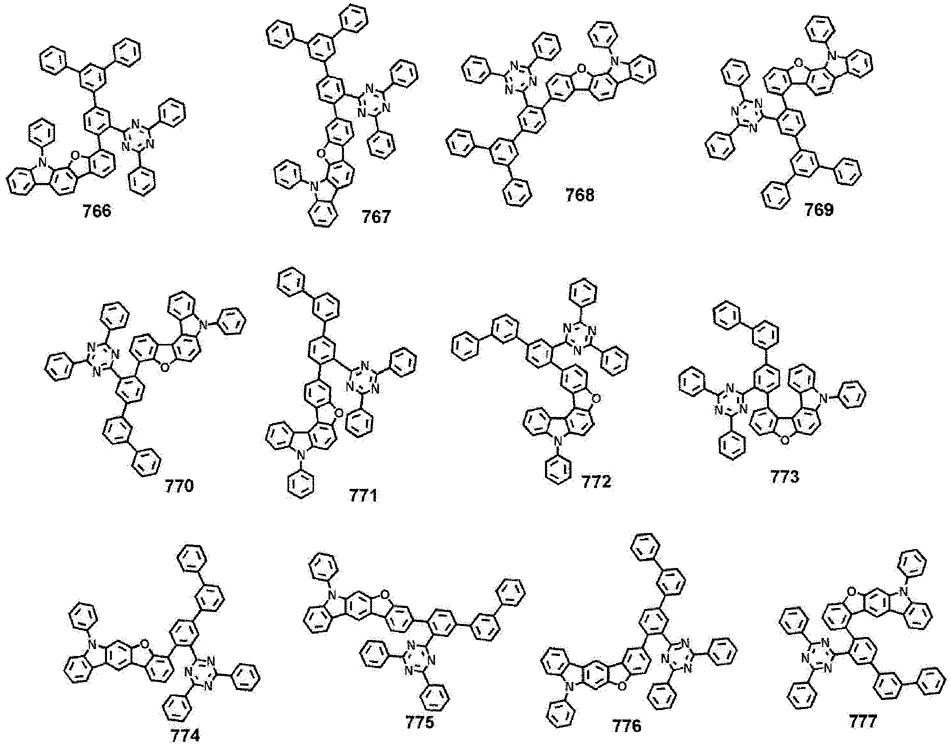

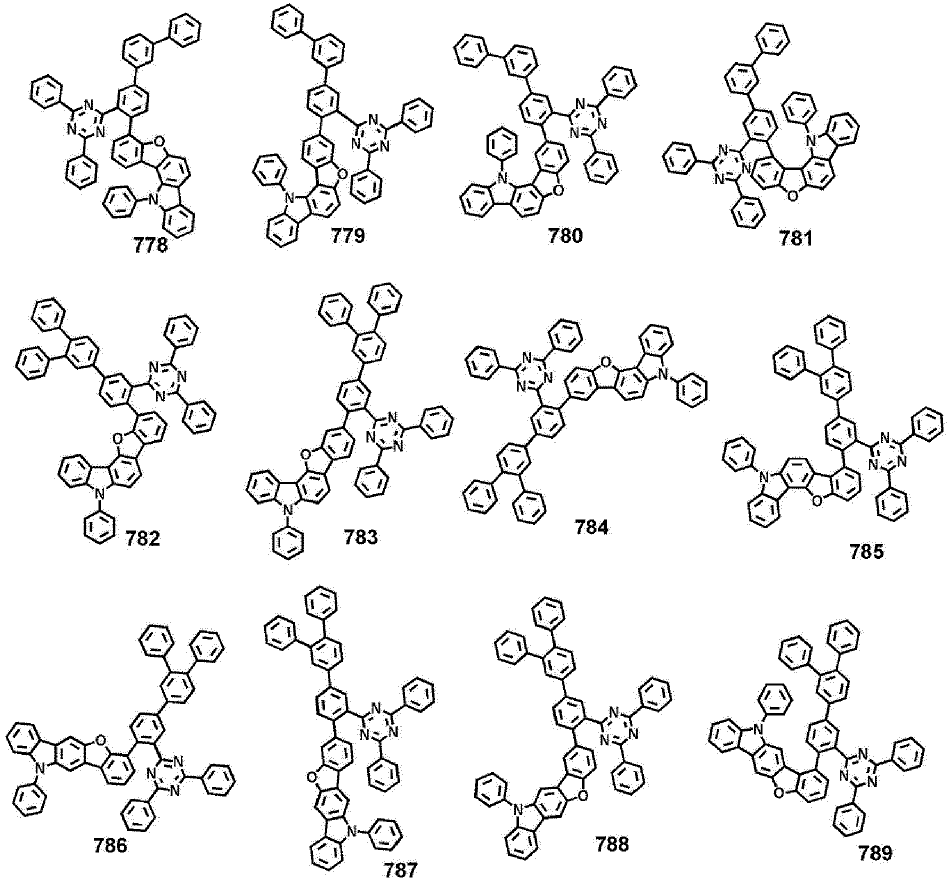

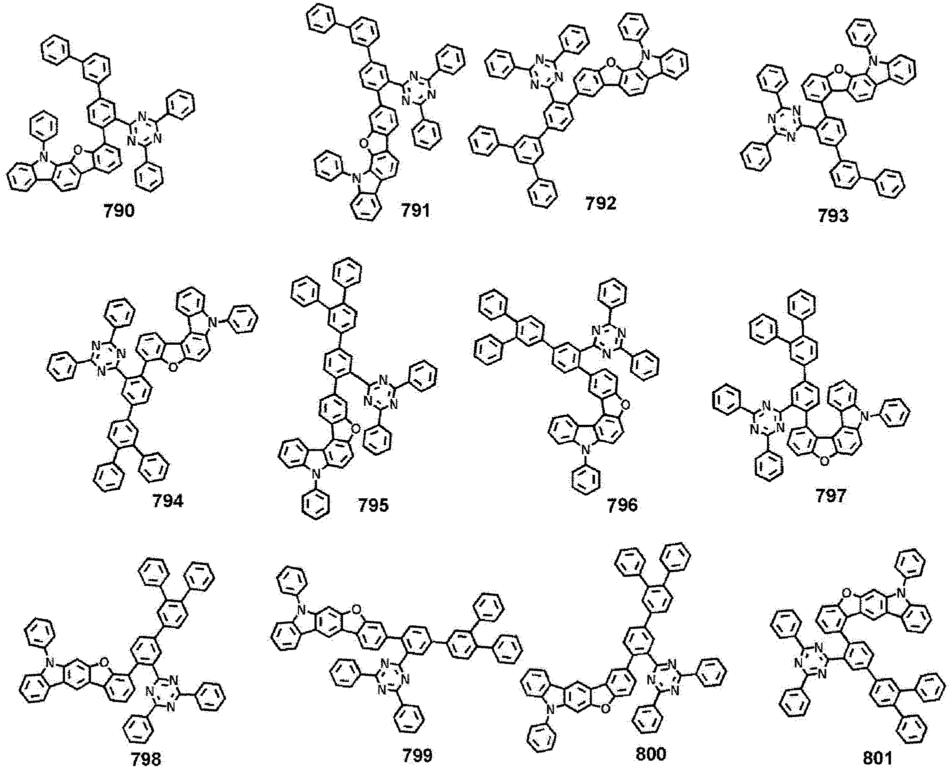

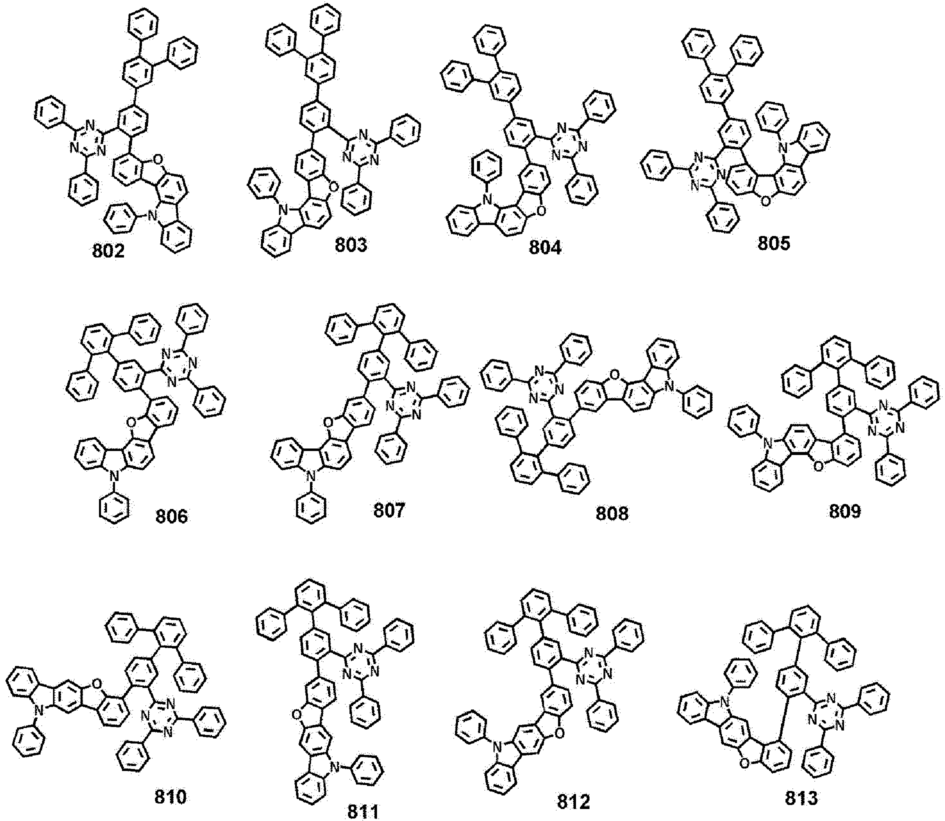

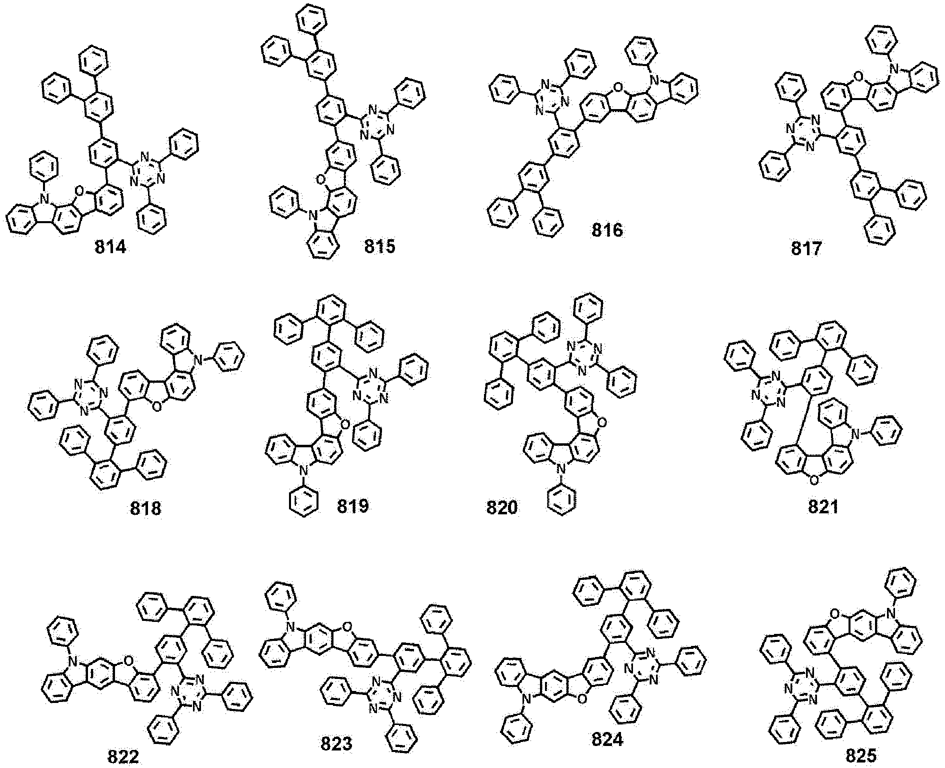

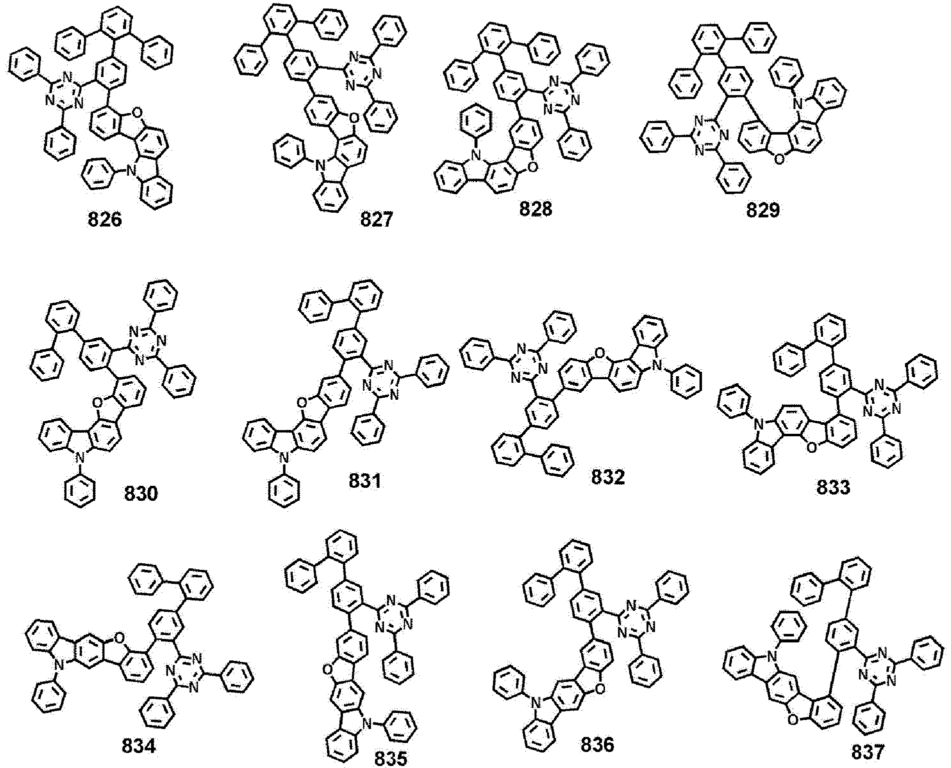

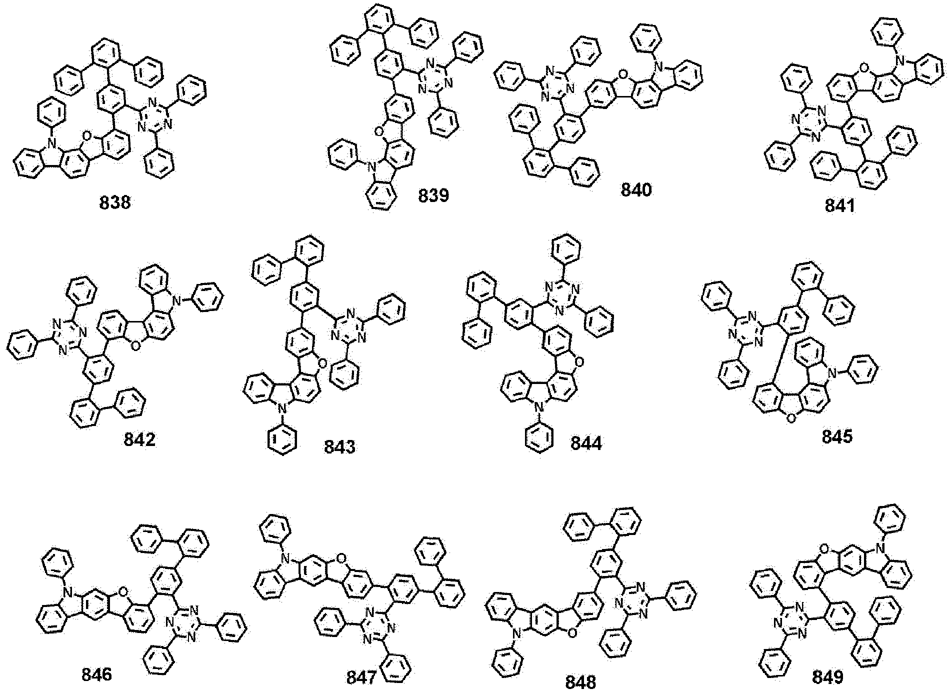

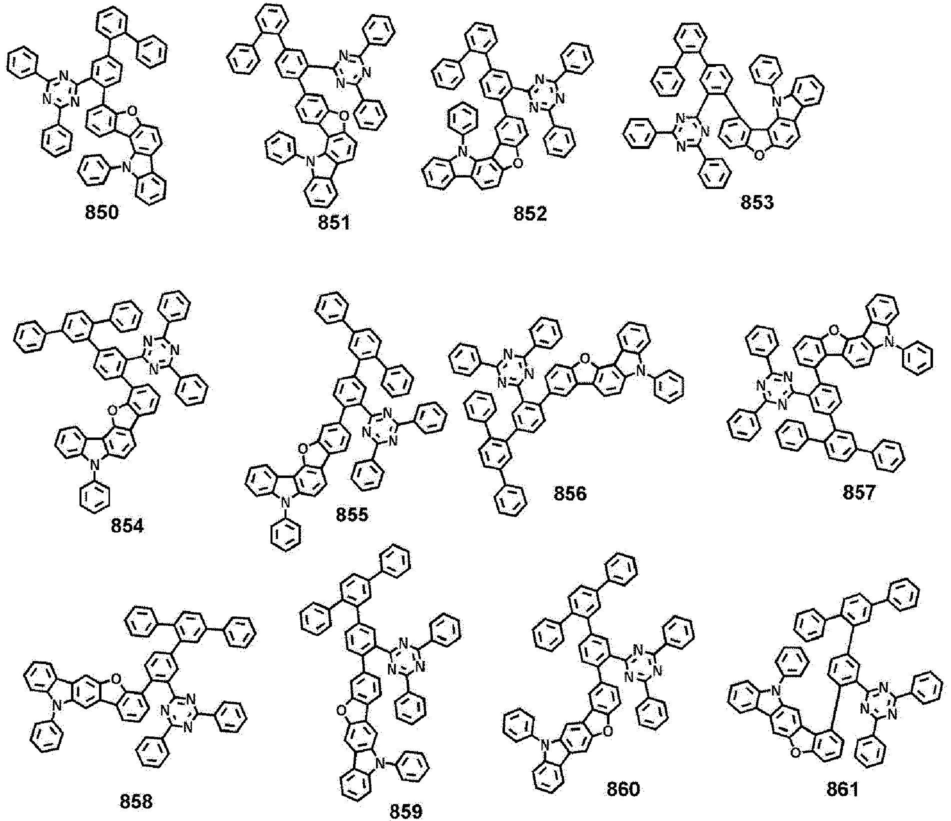

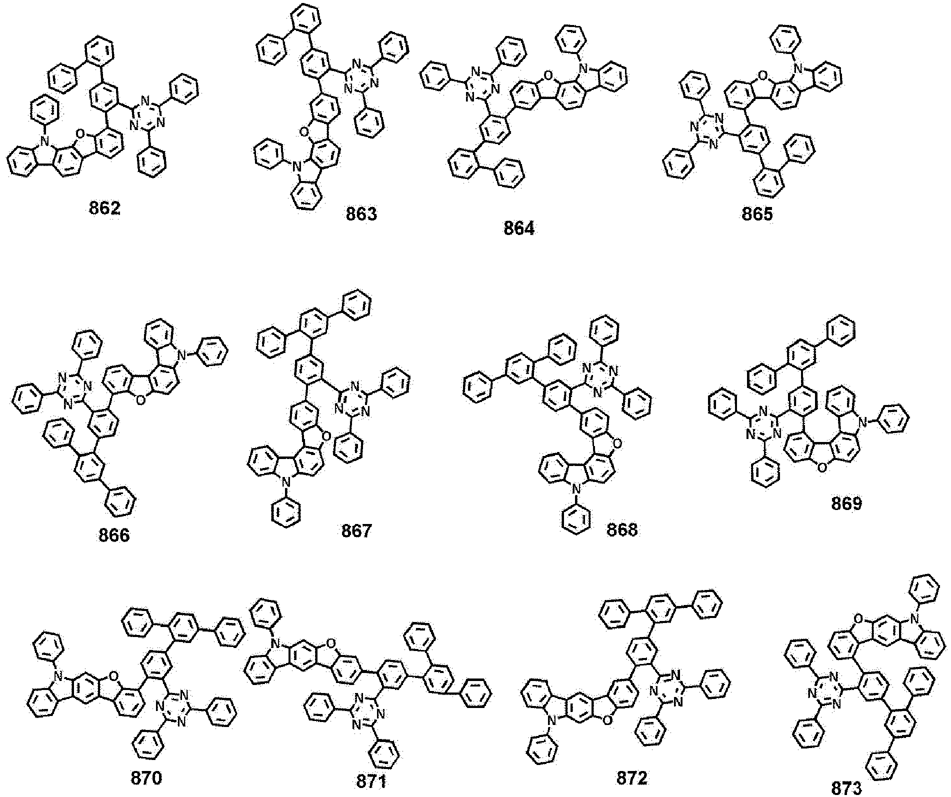

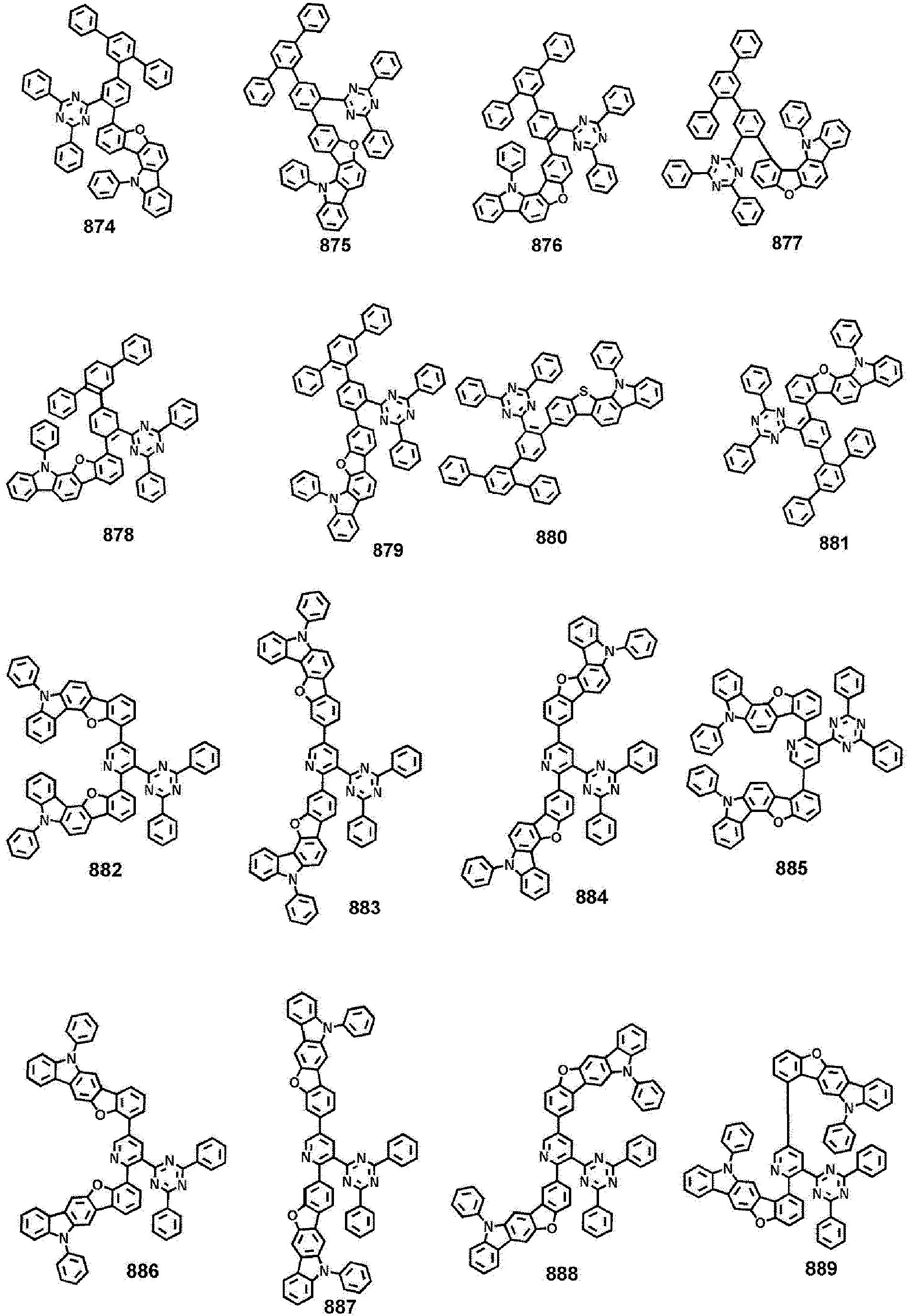

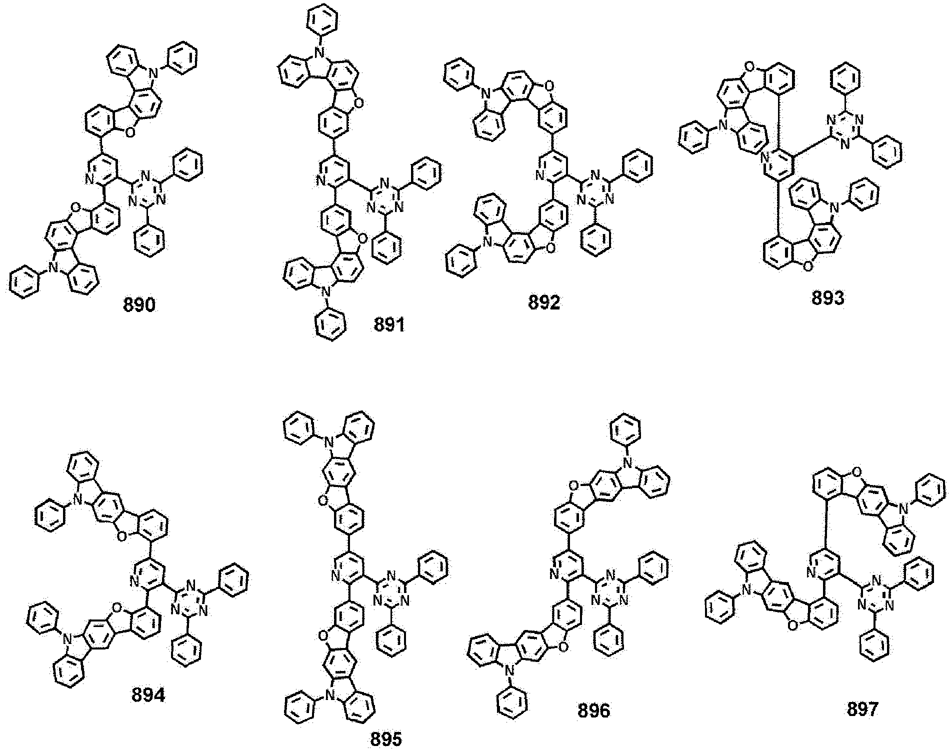

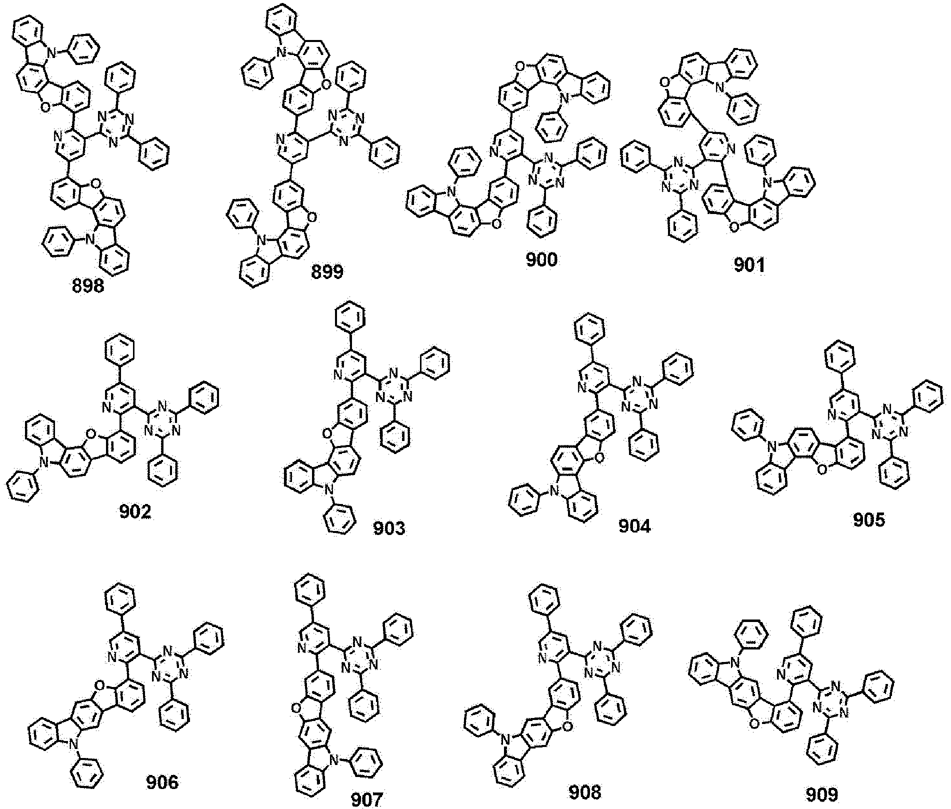

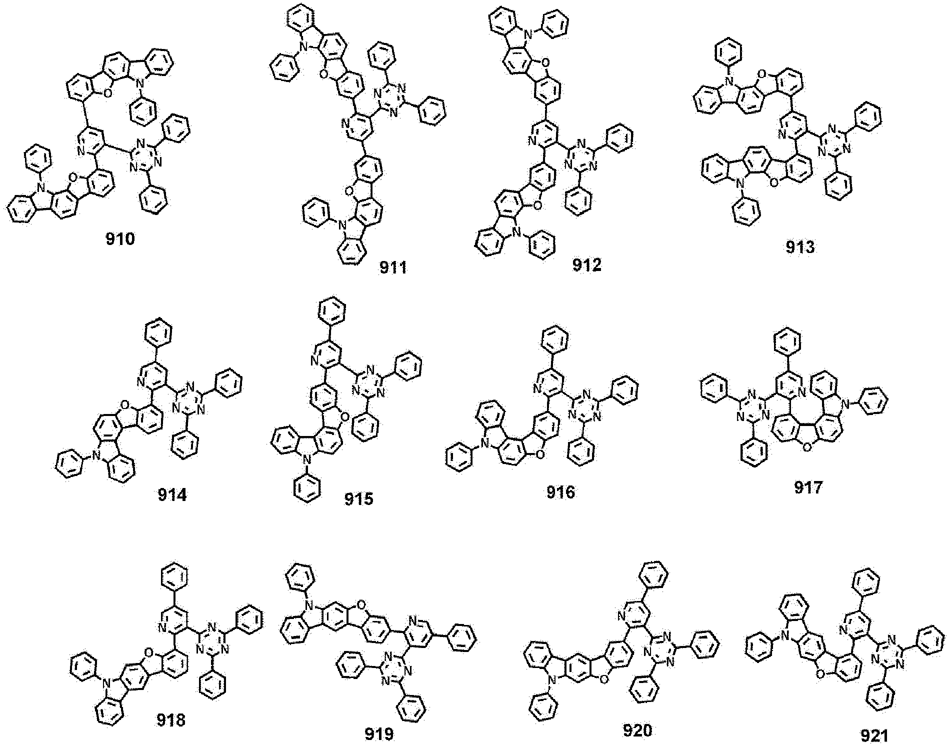

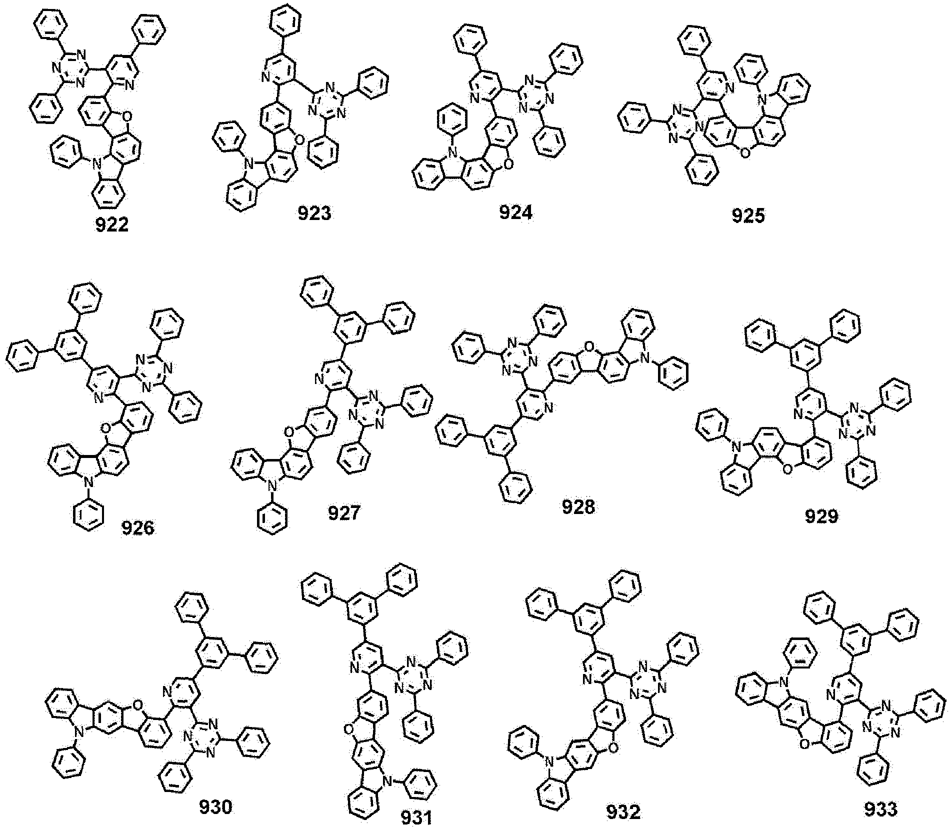

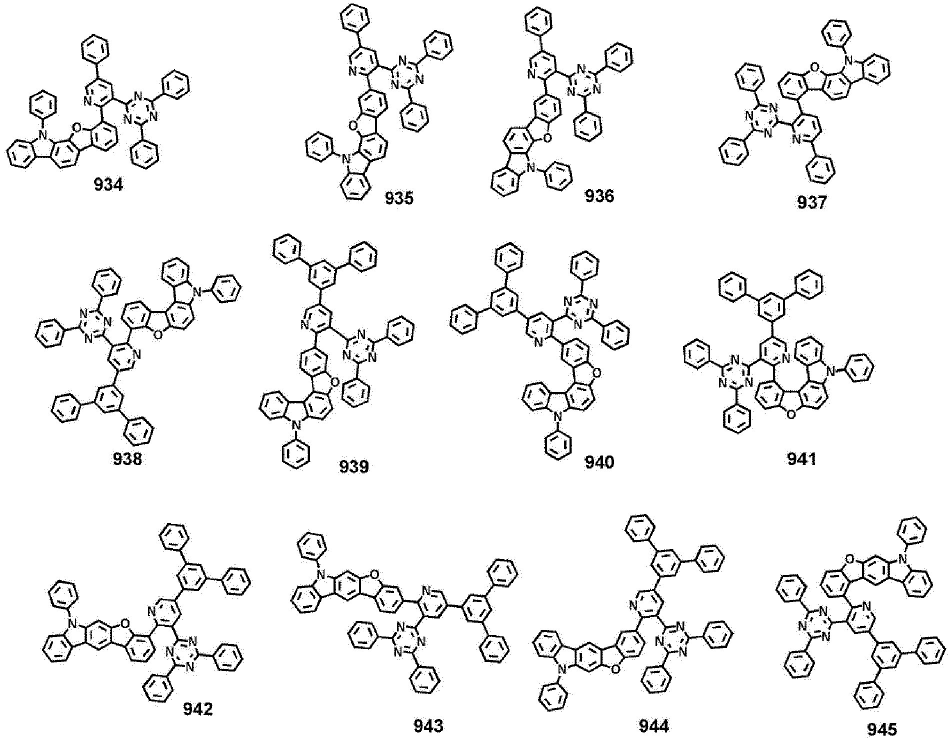

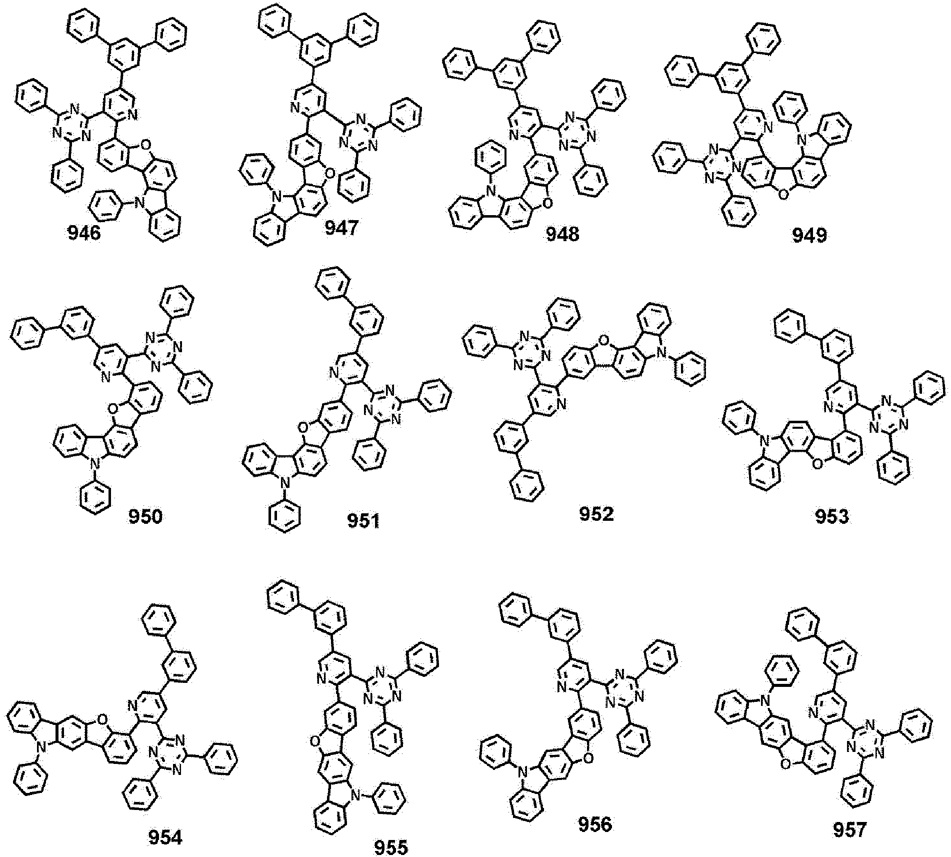

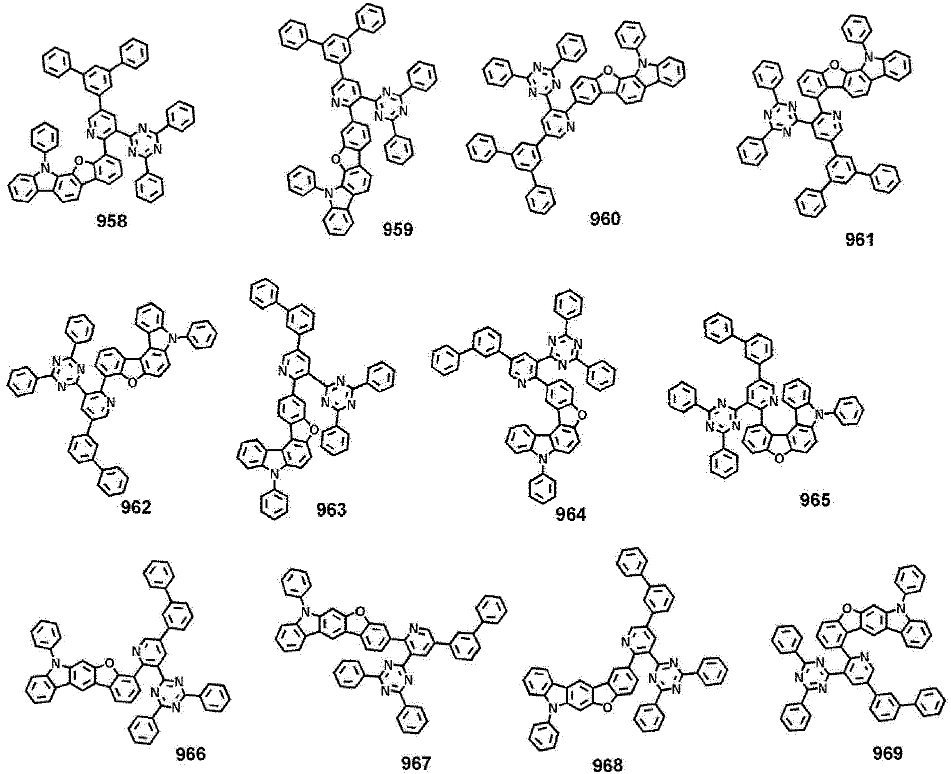

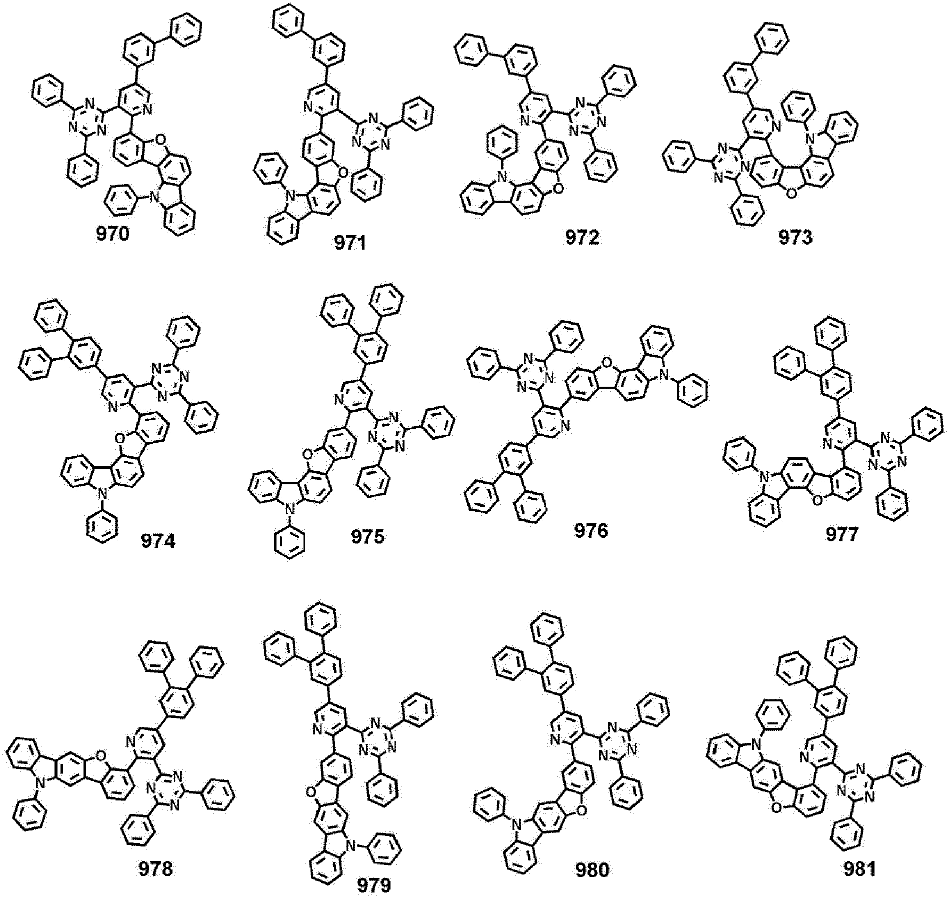

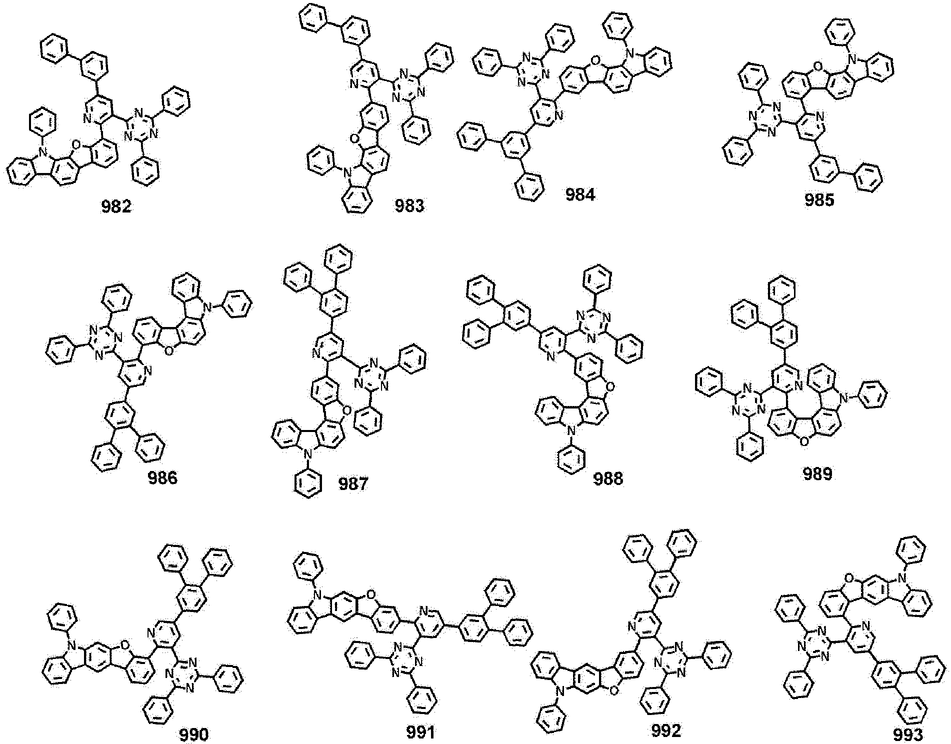

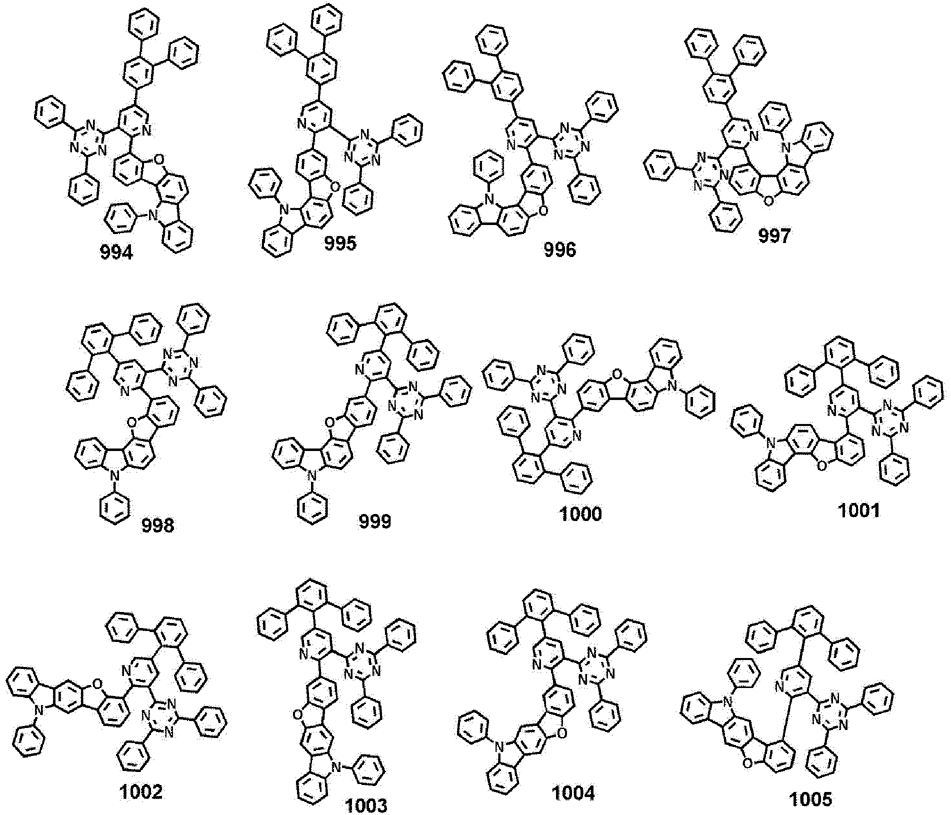

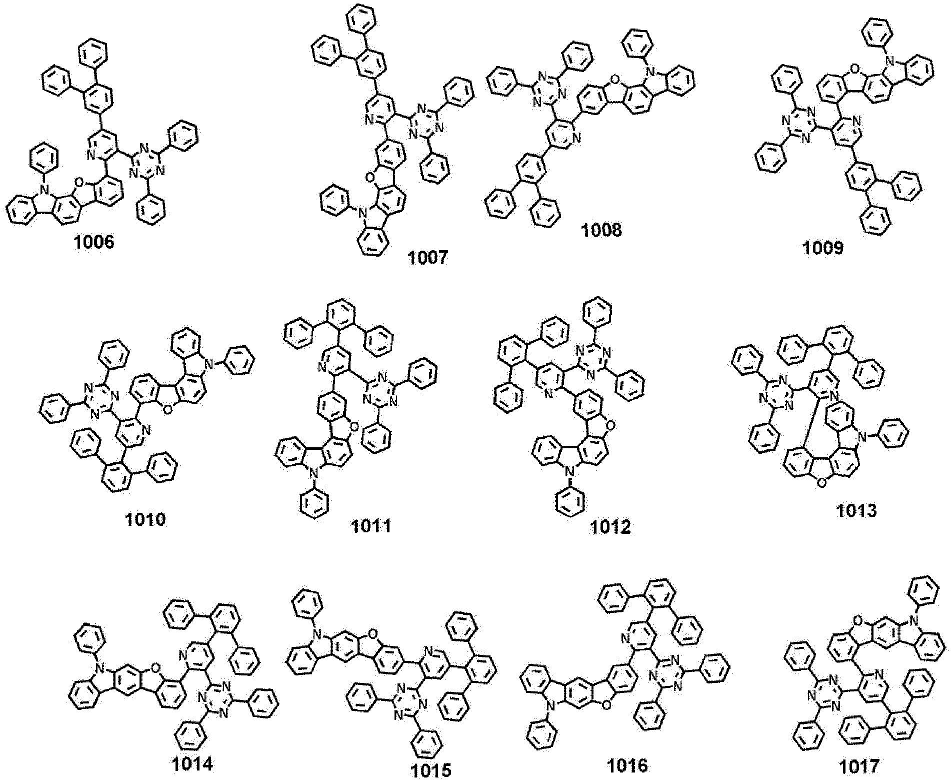

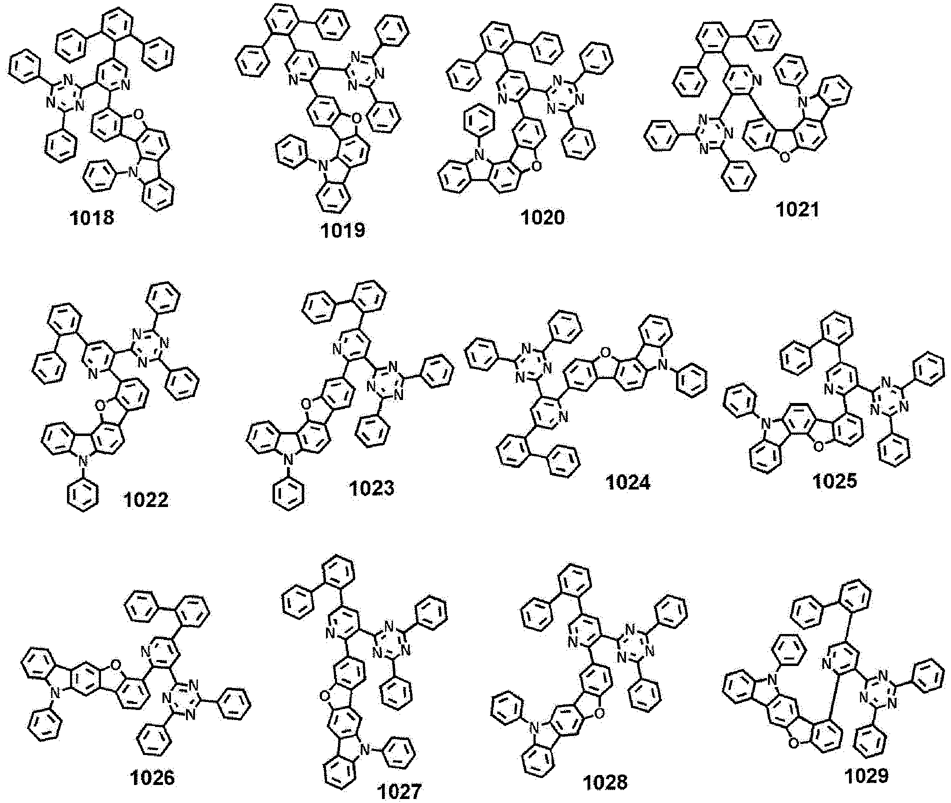

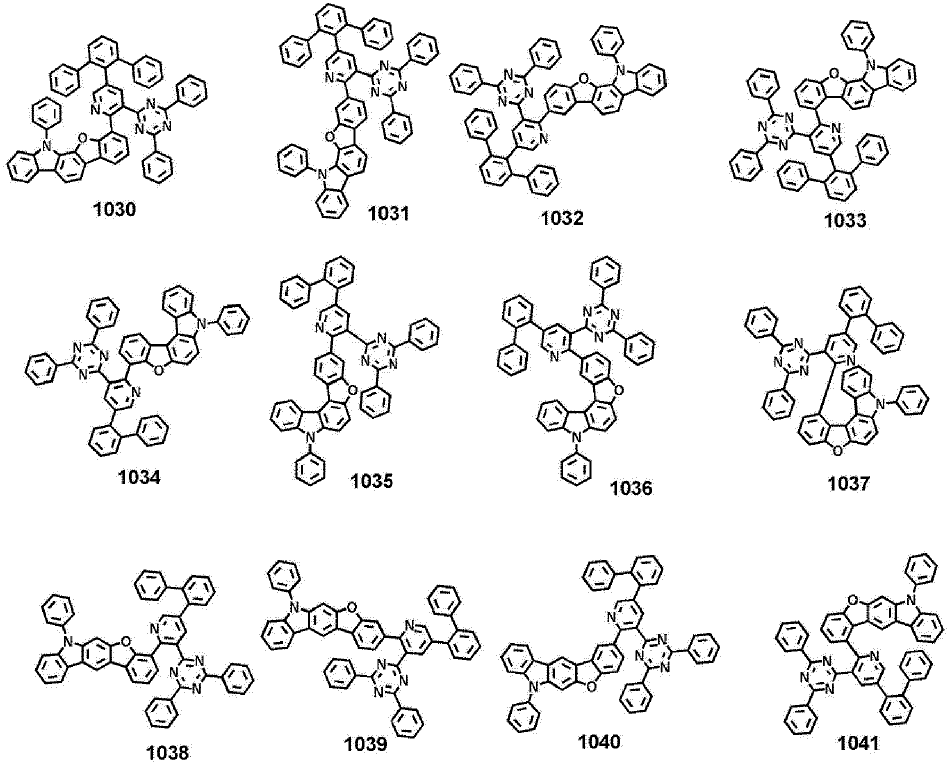

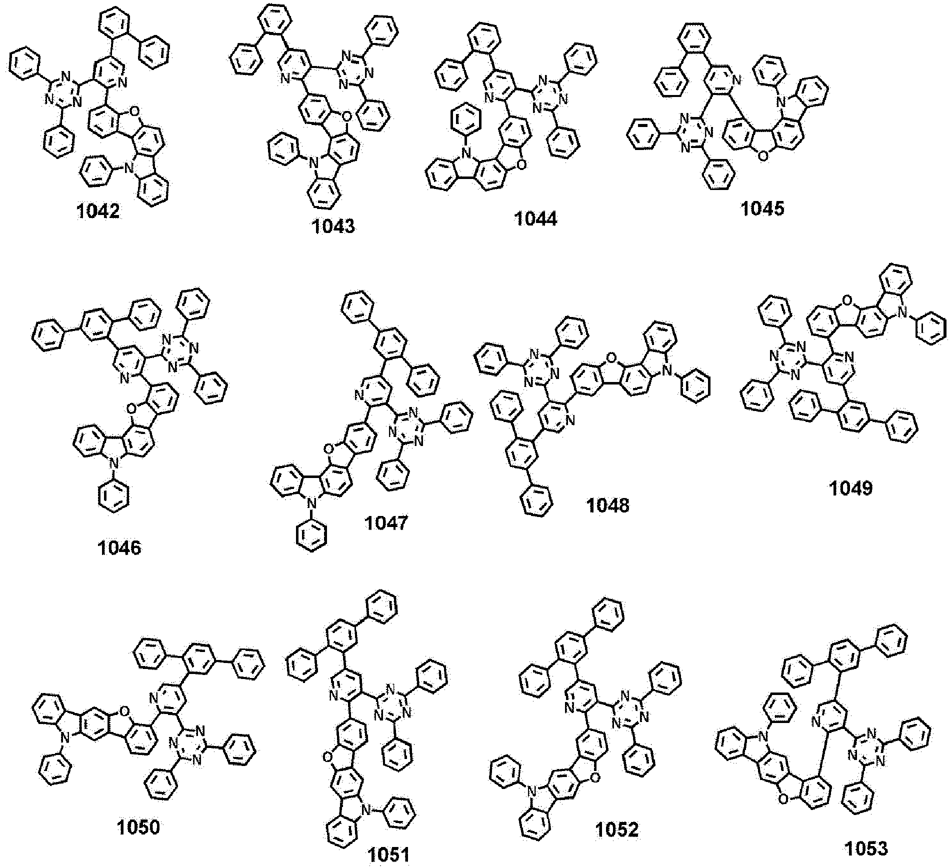

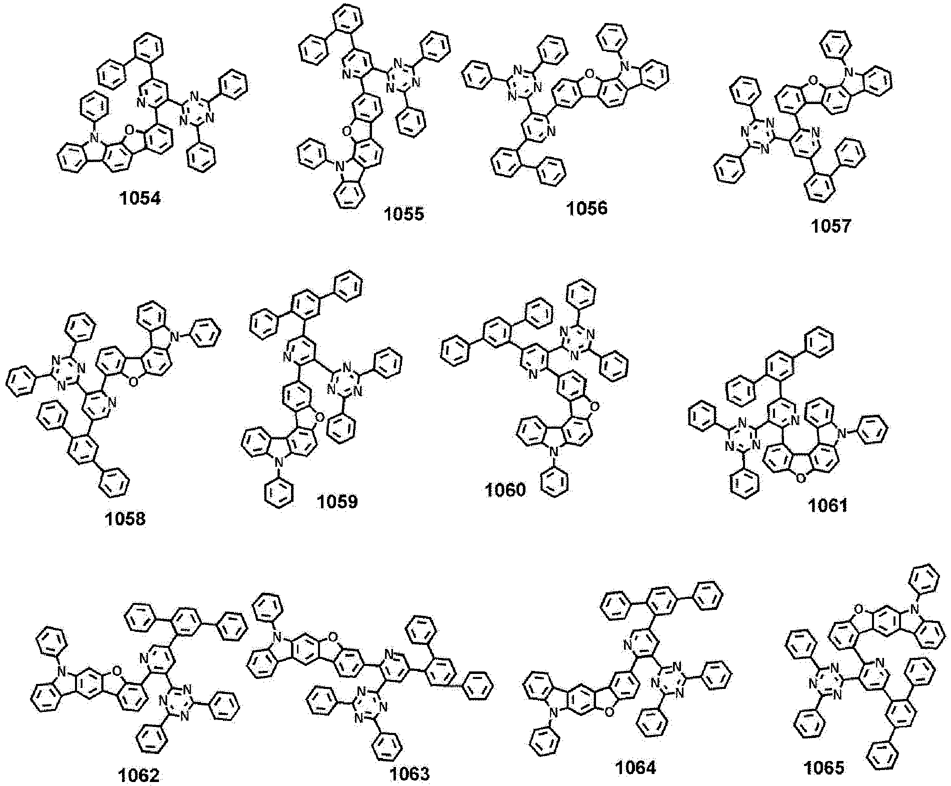

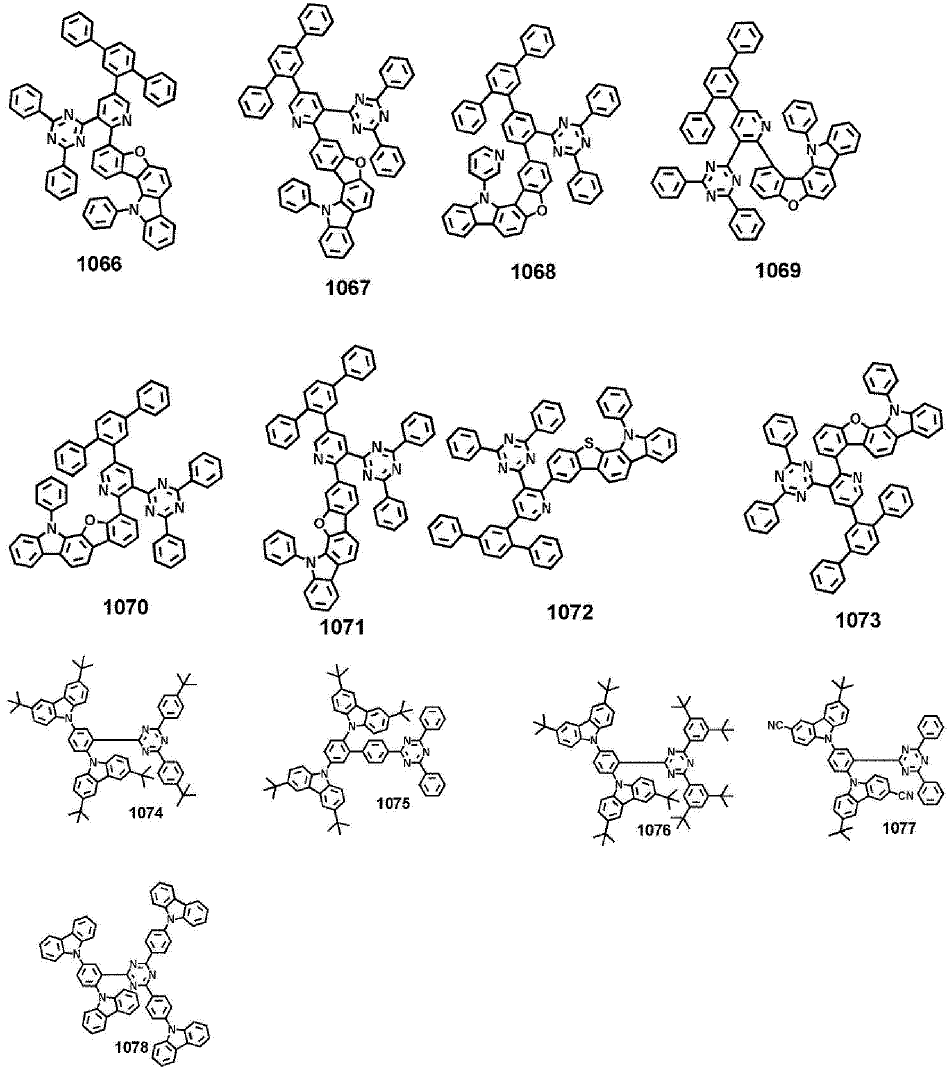

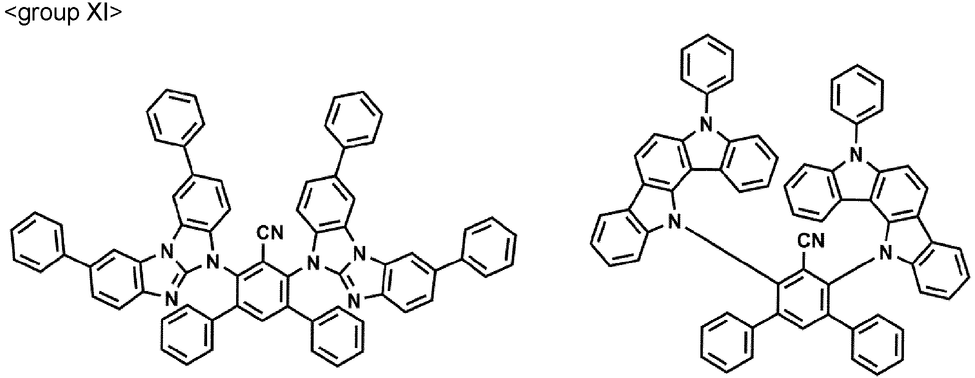

### [Hole transport region 12]

The hole transport region 12 may be located between the first electrode 11 and the emission layer 15 of the organic light-emitting device 10.

The hole transport region 12 may have a single-layered structure or a multi-layered structure.

For example, the hole transport region 12 may have a hole injection layer, a hole transport layer, a hole injection layer/hole transport layer structure, a hole injection layer/first hole transport layer/second hole transport layer structure, a hole transport layer/middle layer structure, a hole injection layer/hole transport layer/middle layer structure, a hole transport layer/electron blocking layer or hole injection layer/hole transport layer/electron blocking layer structure, but embodiments of the present disclosure are not limited thereto.

The hole transport region 12 may include any compound having hole transport properties.

For example, the hole transport region 12 may include an amine-based compound.

In one embodiment, the hole transport region 1 may include at least one selected from a compound represented by Formula 201 to a compound represented by Formula 205, but embodiments of the present disclosure are not limited thereto: 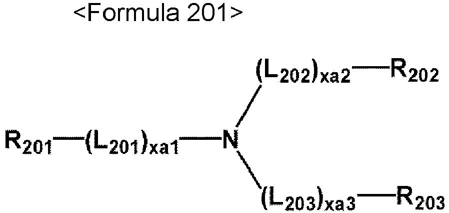 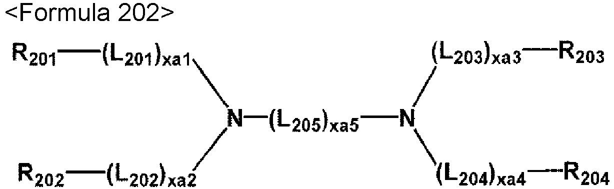 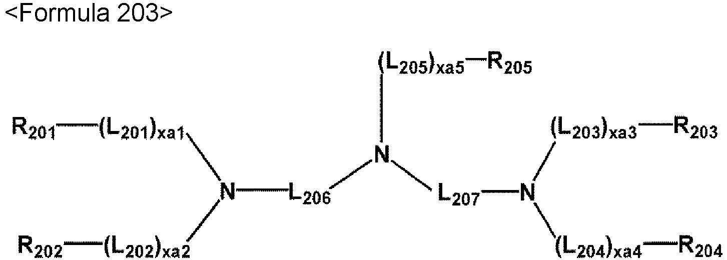 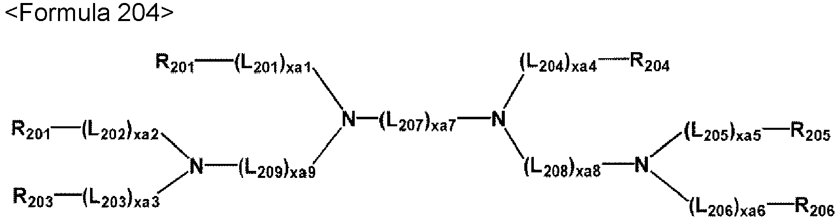 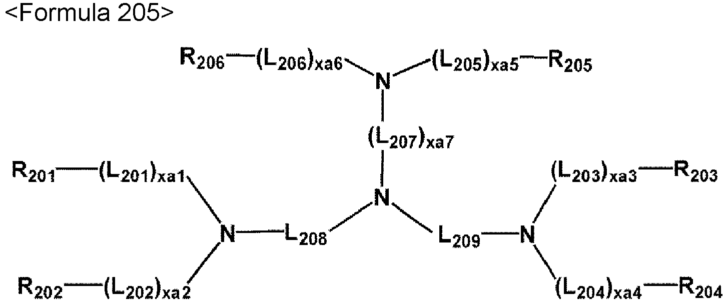 wherein, in Formulae 201 to 205,
L₂₀₁ to L₂₀₉ may each independently *-be O-*', *-S-*', a substituted or unsubstituted C₅-C₆₀ carbocyclic group, or a substituted or unsubstituted C₁-C₆₀ heterocyclic group,
xa1 to xa9 may each independently be an integer from 0 to 5, and
R₂₀₁ to R₂₀₆ may each independently be selected from a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀heterocycloalkenyl group, a substituted or unsubstituted C₆-C₆₀ aryl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted monovalent non-aromatic condensed polycyclic group, and a substituted or unsubstituted monovalent non-aromatic condensed heteropolycyclic group, wherein neighboring two groups of R₂₀₁ to R₂₀₆ may optionally be linked to each other via a single bond, a dimethyl-methylene group, or a diphenyl-methylene group.

For example,
L₂₀₁ to L₂₀₉ may be selected from a benzene group, a heptalene group, an indene group, a naphthalene group, an azulene group, a heptalene group, an indacene group, an acenaphthylene group, a fluorene group, a spiro-bifluorene group, a benzofluorene group, a dibenzofluorene group, a phenalene group, a phenanthrene group, an anthracene group, a fluoranthene group, a triphenylene group, a pyrene group, a chrysene group, a naphthacene group, a picene group, a perylene group, a pentacene group, a hexacene group, a pentaphene group, a rubicene group, a coronene group, an ovalene group, a pyrrole group, an isoindole group, an indole group, a furan group, a thiophene group, a benzofuran group, a benzothiophene group, a benzocarbazole group, a dibenzocarbazole group, a dibenzofuran group, a dibenzothiophene group, a dibenzothiophene sulfone group, a carbazole group, a dibenzosilole group, an indenocarbazole group, an indolocarbazole group, a benzofurocarbazole group, a benzothienocarbazole group, and a triindolobenzene group, each unsubstituted or substituted with at least one selected from deuterium, a C₁-C₁₀ alkyl group, a C₁-C₁₀ alkoxy group, a phenyl group, a naphthyl group, a fluorenyl group, a carbazolyl group, a dibenzofuranyl group, a dibenzothiophenyl group, a triphenylenyl group, a biphenyl group, a terphenyl group, a tetraphenyl group, and -Si(Q₁₁)(Q₁₂)(Q₁₃),
xa1 to xa9 may each independently be 0, 1, or 2, and
R₂₀₁ to R₂₀₆ may each independently be selected from a phenyl group, a biphenyl group, a terphenyl group, a pentalenyl group, an indenyl group, a naphthyl group, an azulenyl group, a heptalenyl group, an indacenyl group, an acenaphthyl group, a fluorenyl group, a spiro-bifluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a naphthacenyl group, a picenyl group, a perylenyl group, a pentaphenyl group, a hexacenyl group, a pentacenyl group, a rubicenyl group, a coronenyl group, an ovalenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, a pyridinyl group, an indeno carbazolyl group, an indolocarbazolyl group, a benzofurocarbazolyl group, and a benzothienocarbazolyl group, each unsubstituted or substituted with at least one selected from deuterium, -F, -CI, -Br, -I, a hydroxyl group, a cyano group, a nitro group, an amidino group, a hydrazine group, a hydrazone group, a C₁-C₂₀ alkyl group, a C₁-C₂₀ alkoxy group, a cyclopentyl group, a cyclohexyl group, a cycloheptyl group, a cyclopentenyl group, a cyclohexenyl group, a phenyl group, a biphenyl group, a terphenyl group, a phenyl group substituted with a C₁-C₁₀ alkyl group, a phenyl group substituted with -F, a pentalenyl group, an indenyl group, a naphthyl group, an azulenyl group, a heptalenyl group, an indacenyl group, an acenaphthyl group, a fluorenyl group, a spiro-bifluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a naphthacenyl group, a picenyl group, a perylenyl group, a pentaphenyl group, a hexacenyl group, a pentacenyl group, a rubicenyl group, a coronenyl group, an ovalenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, a pyridinyl group, -Si(Q₃₁)(Q₃₂)(Q₃₃), and -N(Q₃₁)(Q₃₂),
wherein Q₁₁ to Q₁₃ and Q₃₁ to Q₃₃ may each independently be selected from a C₁-C₁₀ alkyl group, a C₁-C₁₀ alkoxy group, a phenyl group, a biphenyl group, a terphenyl group, and a naphthyl group.

In one or more embodiments, the hole transport region 12 may include a carbazole-containing amine-based compound.

In one embodiment, the hole transport region 12 may include a carbazole-containing amine-based compound and a carbazole-free amine-based compound.

The carbazole-containing amine-based compound may be selected from, for example, compounds represented by Formula 201 including a carbazole group and further including at least one selected from a dibenzofuran group, a dibenzothiophene group, a fluorene group, a spiro-bifluorene group, an indenocarbazole group, an indolocarbazole group, a benzofurocarbazole group, and a benzothienocarbazole group.

The carbazole-free amine-based compound may be selected from, for example, compounds represented by Formula 201 which do not include a carbazole group and which include at least one selected from a dibenzofuran group, a dibenzothiophene group, a fluorene group, a spiro-bifluorene group, an indenocarbazole group, an indolocarbazole group, a benzofurocarbazole group, and a benzothienocarbazole group.

In one or more embodiments, the hole transport region 12 may include at least one selected from compounds represented by Formulae 201 or 202.

In one embodiment, the hole transport region 12 may include at least one selected from compounds represented by Formulae 201-1, 202-1 and 201-2, but embodiments of the present disclosure are not limited thereto:

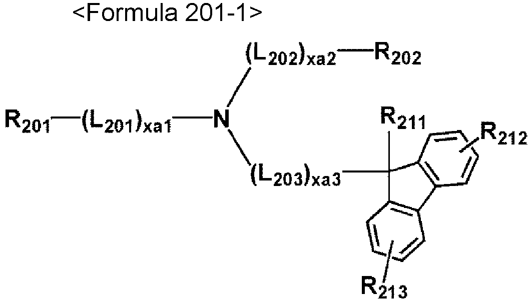

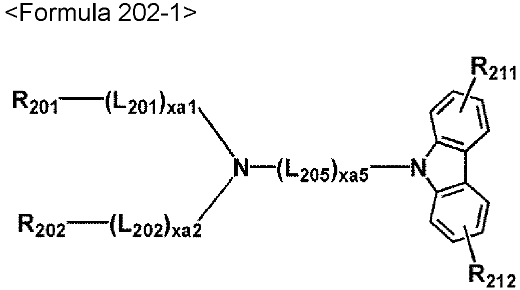

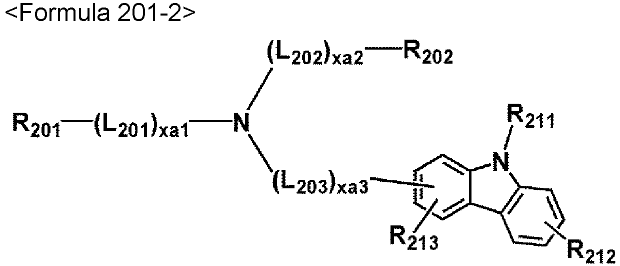

In Formulae 201-1, 202-1, and 201-2, L₂₀₁ to L₂₀₃, L₂₀₅, xa1 to xa3, xa5, R₂₀₁ and R₂₀₂ are the same as described herein, and R₂₁₁ to R₂₁₃ are each independently selected from hydrogen, deuterium, -F, -CI, -Br, -I, a hydroxyl group, a cyano group, a nitro group, an amidino group, a hydrazine group, a hydrazone group, a C₁-C₂₀ alkyl group, a C₁-C₂₀ alkoxy group, a phenyl group, a biphenyl group, a terphenyl group, a phenyl group substituted with a C₁-C₁₀ alkyl group, a phenyl group substituted with -F, a naphthyl group, a fluorenyl group, a spiro-bifluorenyl group, a dimethylfluorenyl group, a diphenyla fluorenyl group, a triphenylenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, and a pyridinyl group.

For example, the hole transport region 12 may include at least one selected from Compounds HT1 to HT39, but embodiments of the present disclosure are not limited thereto.

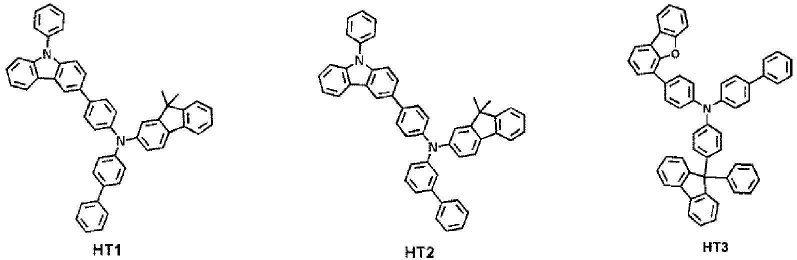

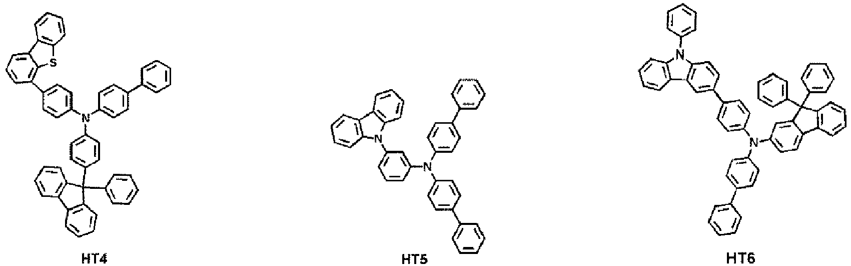

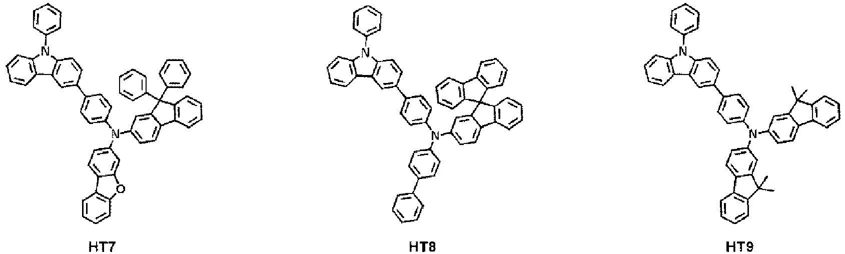

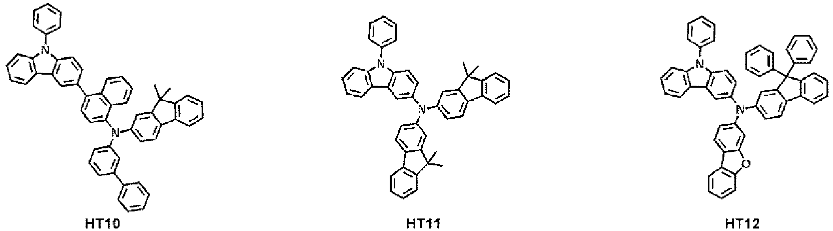

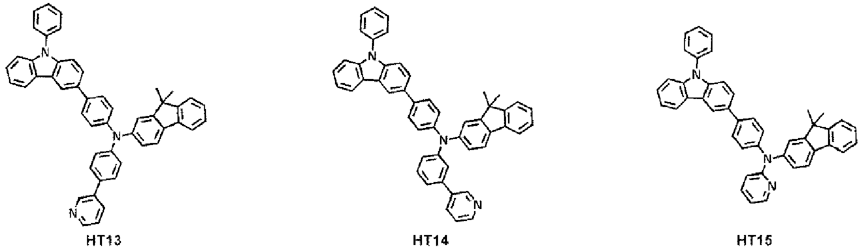

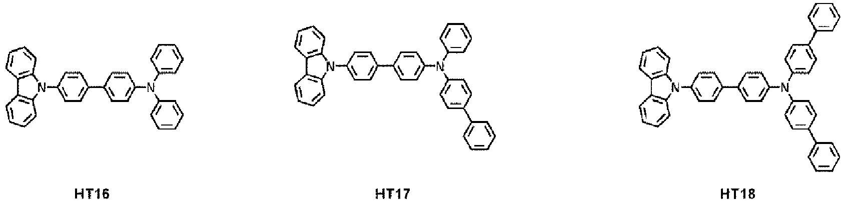

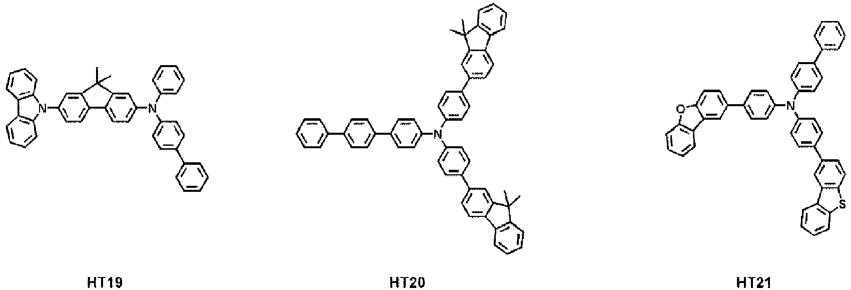

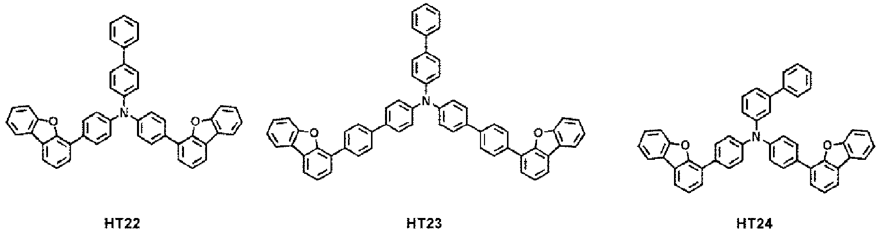

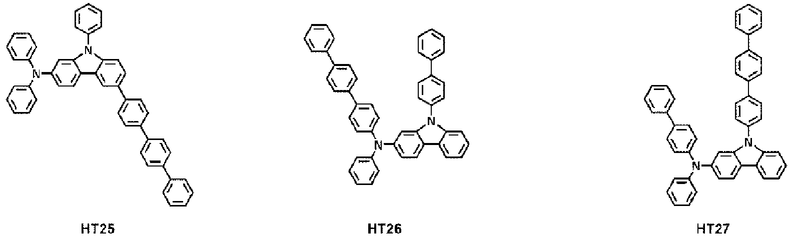

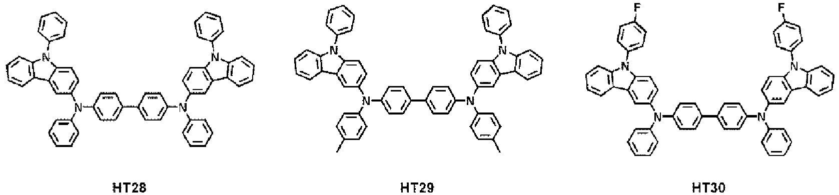

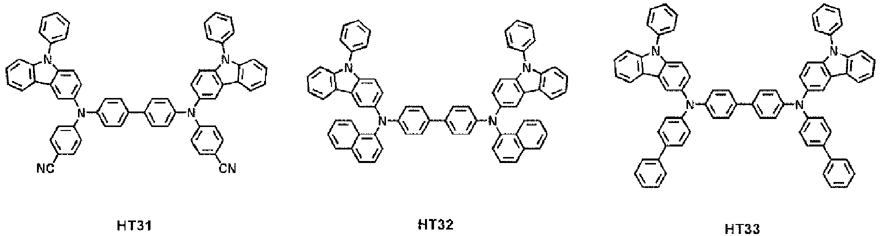

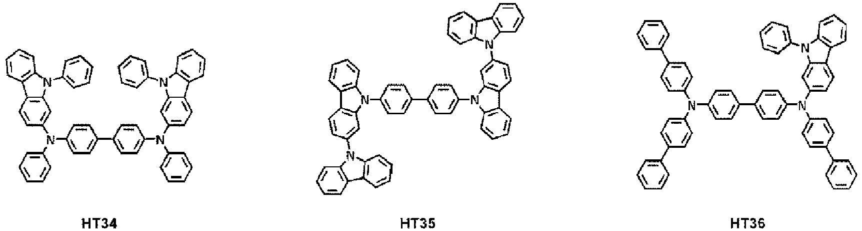

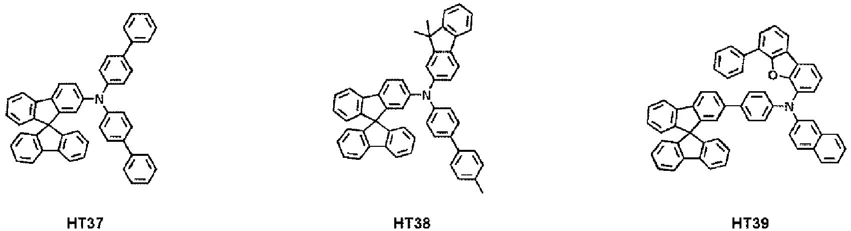

In one or more embodiments, hole transport region 12 of the organic light-emitting device 10 may further include a p-dopant. When the hole transport region 12 further includes a p-dopant, the hole transport region 12 may have a matrix (for example, at least one of compounds represented by Formulae 201 to 205) and a p-dopant included in the matrix. The p-dopant may be uniformly or non-uniformly doped in the hole transport region 12.

In one embodiment, the LUMO energy level of the p-dopant may be -3.5 eV or less.

The p-dopant may include at least one selected from a quinone derivative, a metal oxide, and a cyano-containing compound, but embodiments of the present disclosure are not limited thereto.

In one embodiment, the p-dopant may include at least one selected from:
a quinone derivative, such as tetracyanoquinodimethane (TCNQ),2,3,5,6-tetrafluoro-7,7,8,8-tetracyanoquinodimethane (F4-TCNQ), and F6-TCNNQ;
a metal oxide, such as tungsten oxide or molybdenum oxide;
1,4,5,8,9,12-hexaazatriphenylene-hexacarbonitrile (HAT-CN); and
a compound represented by Formula 221 below,
but embodiments of the present disclosure are not limited thereto:

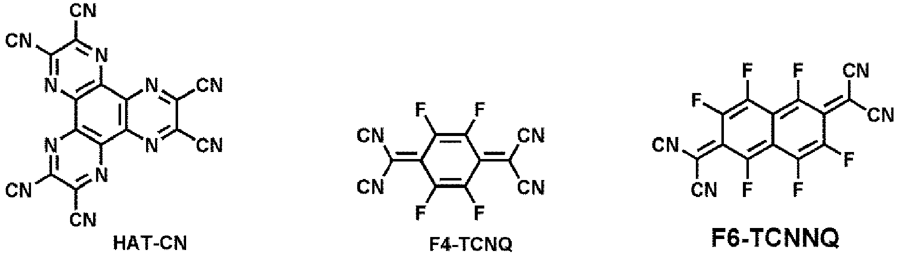

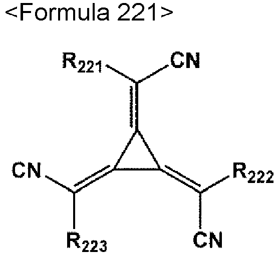

In Formula 221,
R₂₂₁ to R₂₂₃ may each independently be selected from a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₁-C₆₀ heteroaryl group, a substituted or unsubstituted monovalent non-aromatic condensed polycyclic group, and a substituted or unsubstituted monovalent non-aromatic condensed heteropolycyclic group, and at least one selected from R₂₂₁ to R₂₂₃ may have at least one substituent selected from a cyano group, -F, -CI, -Br, -I, a C₁-C₂₀ alkyl group substituted with -F, a C₁-C₂₀ alkyl group substituted with -CI, a C₁-C₂₀ alkyl group substituted with -Br, and a C₁-C₂₀ alkyl group substituted with -I.

The hole transport region 12 may have a thickness of about 100 Å to about 10000 Å, for example, about 400 Å to about 2000 Å, and the emission layer 15 may have a thickness of about 100 Å to about 3000 Å, for example, about 300 Å to about 1000 Å. When the thickness of each of the hole transport region 12 and the emission layer 15 is within these ranges described above, satisfactory hole transportation characteristics and/or luminescent characteristics may be obtained without a substantial increase in driving voltage.

### [Electron transport region 17]

The electron transport region 17 is placed between the emission layer 15 and the second electrode 19 of the organic light-emitting device 10.

The electron transport region 17 may have a single-layered structure or a multi-layered structure.

For example, the electron transport region 17 may have an electron transport layer, an electron transport layer/electron injection layer structure, a buffer layer/electron transport layer structure, hole blocking layer/electron transport layer structure, a buffer layer/electron transport layer/electron injection layer structure, or a hole blocking layer/electron transport layer/electron injection layer structure, but embodiments of the present disclosure are not limited thereto. The electron transport region 17 may further include an electron control layer.

The electron transport region 17 may include known electron transport materials.

The electron transport region (for example, a buffer layer, a hole blocking layer, an electron control layer, or an electron transport layer in the electron transport region) may include a metal-free compound containing at least one π electron-deficient nitrogen-containing cyclic group. The π electron-deficient nitrogen-containing cyclic group is the same as described above.

For example, the electron transport region may include a compound represented by Formula 601 below:

<Formula 601> [Ar₆₀₁]ₓₑ₁₁-[(L₆₀₁)ₓₑ₁-R₆₀₁]ₓₑ₂₁

In Formula 601,
Ar₆₀₁ and L₆₀₁ may each independently be a substituted or unsubstituted C₅-C₆₀ carbocyclic group or a substituted or unsubstituted C₁-C₆₀ heterocyclic group,
xe11 may be 1, 2, or 3,
xe1 may be an integer from 0 to 5,
R₆₀₁ may be selected from a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted monovalent non-aromatic condensed polycyclic group, a substituted or unsubstituted monovalent non-aromatic condensed heteropolycyclic group, -Si(Q₆₀₁)(Q₆₀₂)(Q₆₀₃), -C(=O)(Q₆₀₁), -S(=O)₂(Q₆₀₁), and -P(=O)(Q₆₀₁)(Q₆₀₂),
Q₆₀₁ to Q₆₀₃ may each independently be a C₁-C₁₀ alkyl group, a C₁-C₁₀ alkoxy group, a phenyl group, a biphenyl group, a terphenyl group, or a naphthyl group, and
xe21 may be an integer from 1 to 5.

In one embodiment, at least one of Ar₆₀₁(s) in the number of xe11 and R₆₀₁(s) in the number of xe21 may include the π electron-deficient nitrogen-containing cyclic group.

In one embodiment, ring Ar₆₀₁ and L₆₀₁ in Formula 601 may each independently be selected from a benzene group, a naphthalene group, a fluorene group, a spiro-bifluorene group, a benzofluorene group, a dibenzofluorene group, a phenalene group, a phenanthrene group, an anthracene group, a fluoranthene group, a triphenylene group, a pyrene group, a chrysene group, a naphthacene group, a picene group, a perylene group, a pentaphene group, an indenoanthracene group, a dibenzofuran group, a dibenzothiophene group, a carbazole group, an imidazole group, a pyrazole group, a thiazole group, an isothiazole group, an oxazole group, an isoxazole group, a pyridine group, a pyrazine group, a pyrimidine group, a pyridazine group, an indazole group, a purine group, a quinoline group, an isoquinoline group, a benzoquinoline group, a phthalazine group, a naphthyridine group, a quinoxaline group, a quinazoline group, a cinnoline group, a phenanthridine group, an acridine group, a phenanthroline group, a phenazine group, a benzimidazole group, an isobenzothiazole group, a benzoxazole group, an isobenzoxazole group, a triazole group, a tetrazole group, an oxadiazole group, a triazine group, a thiadiazole group, an imidazopyridine group, an imidazopyrimidine group, and an azacarbazole group, each unsubstituted or substituted with at least one selected from deuterium, -F, -CI, -Br, -I, a hydroxyl group, a cyano group, a nitro group, an amidino group, a hydrazine group, a hydrazone group, a C₁-C₂₀ alkyl group, a C₁-C₂₀ alkoxy group, a phenyl group, a biphenyl group, a terphenyl group, a naphthyl group, -Si(Q₃₁)(Q₃₂)(Q₃₃), -S(=O)₂(Q₃₁), and -P(=O)(Q₃₁)(Q₃₂),
wherein Q₃₁ to Q₃₃ may each independently be selected from a C₁-C₁₀ alkyl group, a C₁-C₁₀ alkoxy group, a phenyl group, a biphenyl group, a terphenyl group, and a naphthyl group.

When xe11 in Formula 601 is 2 or more, two or more Ar₆₀₁(s) may be linked to each other via a single bond.

In one or more embodiments, Ar₆₀₁ in Formula 601 may be an anthracene group.

In one or more embodiments, the compound represented by Formula 601 may be represented by Formula 601-1:

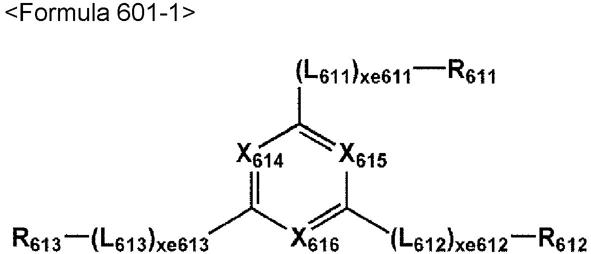

In Formula 601-1,
X₆₁₄ may be N or C(R₆₁₄), X₆₁₅ may be N or C(R₆₁₅), X₆₁₆ may be N or C(R₆₁₆), and at least one selected from X₆₁₄ to X₆₁₆ may be N,
L₆₁₁ to L₆₁₃ may each independently be the same as described in connection with L₆₀₁,
xe611 to xe613 may each independently be the same as described in connection with xe1,
R₆₁₁ to R₆₁₃ may each independently be the same as described in connection with R₆₀₁, and
R₆₁₄ to R₆₁₆ may each independently be selected from hydrogen, deuterium, -F, -CI, -Br, -I, a hydroxyl group, a cyano group, a nitro group, an amidino group, a hydrazino group, a hydrazono group, a C₁-C₂₀ alkyl group, a C₁-C₂₀ alkoxy group, a phenyl group, a biphenyl group, a terphenyl group, and a naphthyl group.

In one or more embodiments, xe1 and xe611 to xe613 in Formulae 601 and 601-1 may each independently be 0, 1, or 2.

In one or more embodiments, R₆₀₁ and R₆₁₁ to R₆₁₃ in Formulae 601 and 601-1 may each independently be selected from a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a fluoranthenyl group, a triphenylenyl group, a pyrenyl group, a chrysenyl group, a perylenyl group, a pentaphenyl group, a hexacenyl group, a pentacenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, a pyridinyl group, an imidazolyl group, a pyrazolyl group, a thiazolyl group, an isothiazolyl group, an oxazolyl group, an isoxazolyl group, a thiadiazolyl group, an oxadiazolyl group, a pyrazinyl group, a pyrimidinyl group, a pyridazinyl group, a triazinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a phenanthridinyl group, an acridinyl group, a phenanthrolinyl group, a phenazinyl group, a benzimidazolyl group, an isobenzothiazolyl group, a benzoxazolyl group, an isobenzoxazolyl group, a triazolyl group, a tetrazolyl group, an imidazopyridinyl group, an imidazopyrimidinyl group, and an azacarbazolyl group, each unsubstituted or substituted with at least one selected from deuterium, -F, -CI, -Br, -I, a hydroxyl group, a cyano group, a nitro group, an amidino group, a hydrazine group, a hydrazone group, a C₁-C₂₀ alkyl group, a C₁-C₂₀ alkoxy group, a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a fluoranthenyl group, a triphenylenyl group, a pyrenyl group, a chrysenyl group, a perylenyl group, a pentaphenyl group, a hexacenyl group, a pentacenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, a pyridinyl group, an imidazolyl group, a pyrazolyl group, a thiazolyl group, an isothiazolyl group, an oxazolyl group, an isoxazolyl group, a thiadiazolyl group, an oxadiazolyl group, a pyrazinyl group, a pyrimidinyl group, a pyridazinyl group, a triazinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a phenanthridinyl group, an acridinyl group, a phenanthrolinyl group, a phenazinyl group, a benzimidazolyl group, an isobenzothiazolyl group, a benzoxazolyl group, an isobenzoxazolyl group, a triazolyl group, a tetrazolyl group, an imidazopyridinyl group, an imidazopyrimidinyl group, and an azacarbazolyl group; and
-S(=O)₂(Q₆₀₁) and -P(=O)(Q₆₀₁)(Q₆₀₂),
wherein Q₆₀₁ and Q₆₀₂ are the same as described above.

The electron transport region may include at least one compound selected from Compounds ET1 to ET36, but embodiments of the present disclosure are not limited thereto:

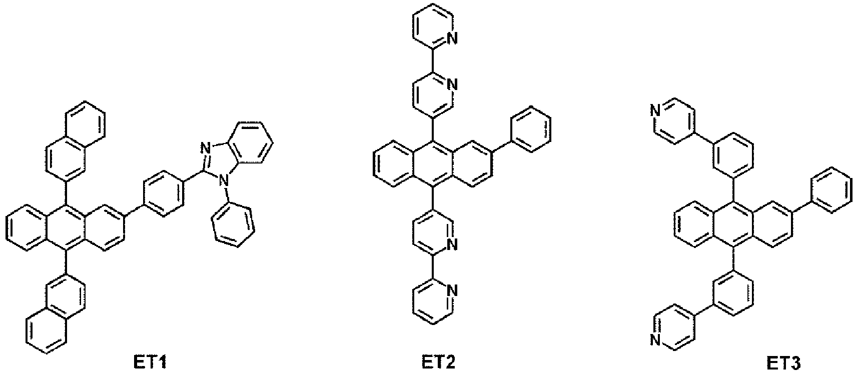

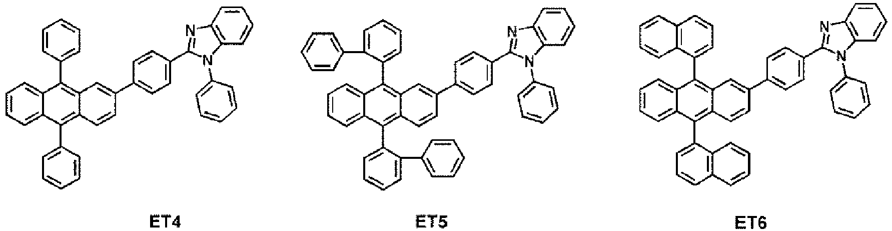

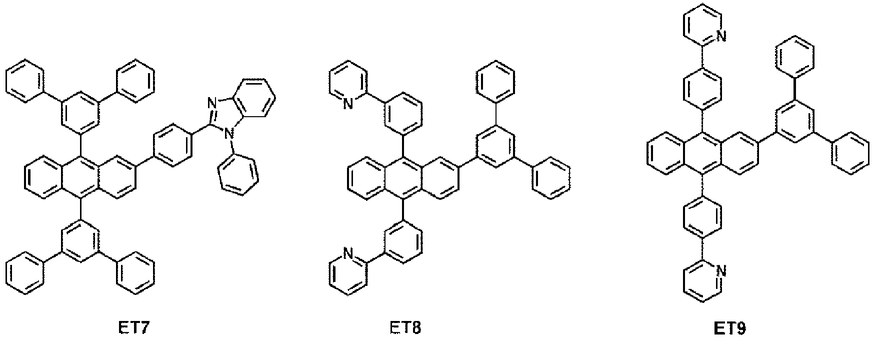

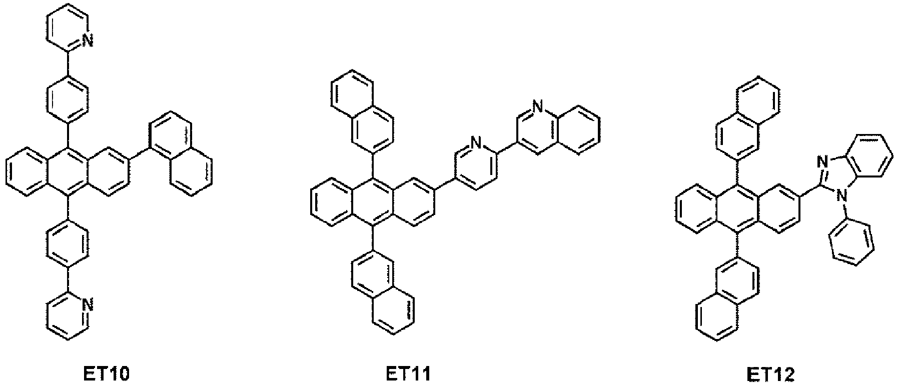

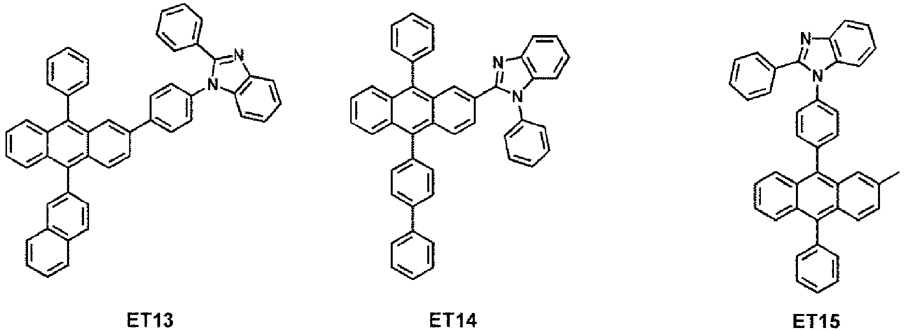

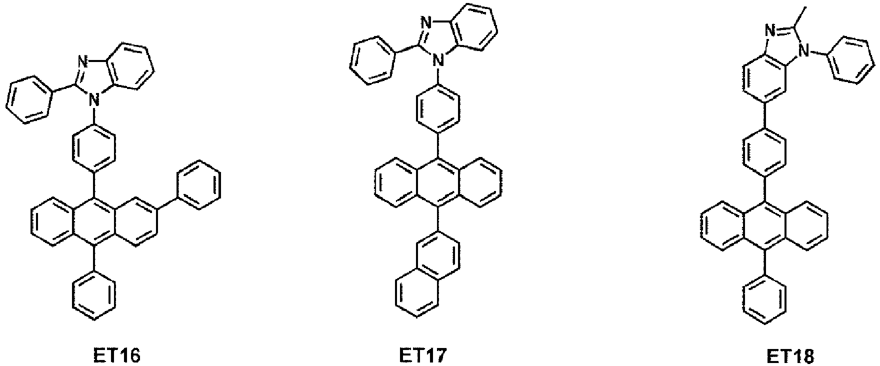

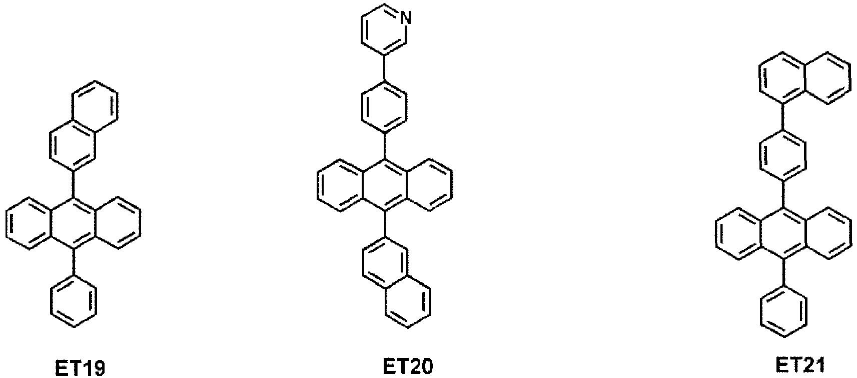

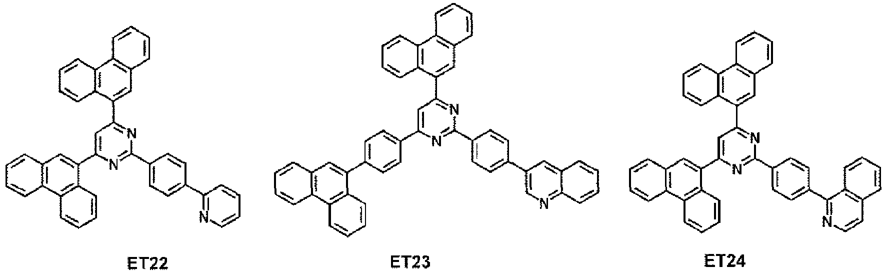

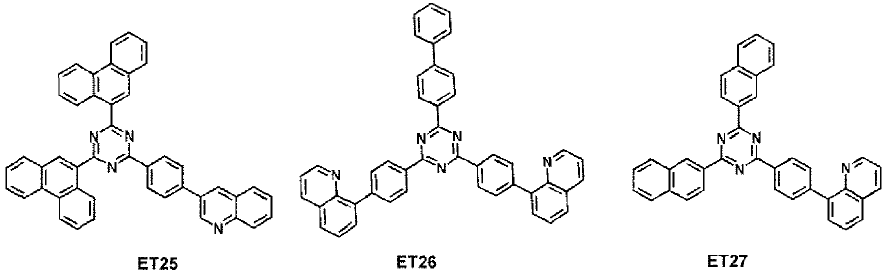

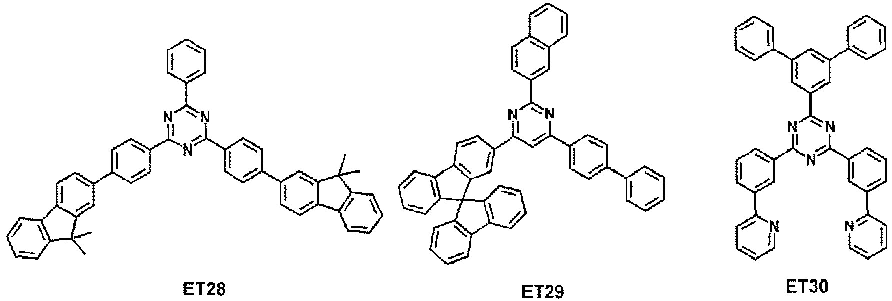

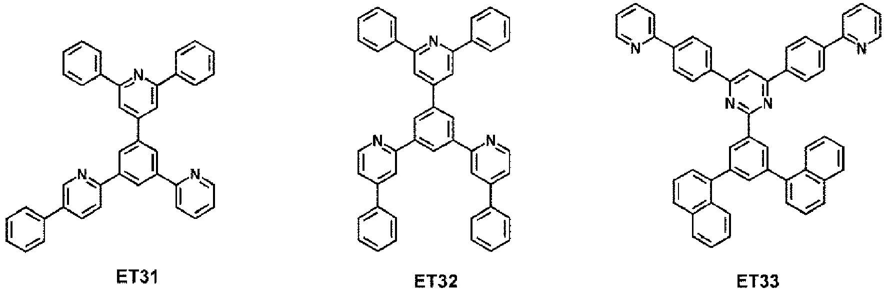

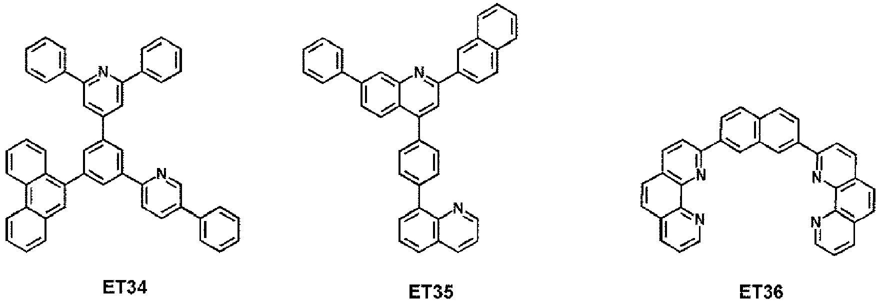

In one or more embodiments, the electron transport region may include at least one selected from 2,9-dimethyl-4,7-diphenyl-1,10-phenanthroline (BCP), 4,7-dphenyl-1,10-phenanthroline (Bphen), Alq₃, BAIq, 3-(biphenyl-4-yl)-5-(4-tert-butylphenyl)-4-phenyl-4H-1,2,4-triazole (TAZ), and NTAZ:

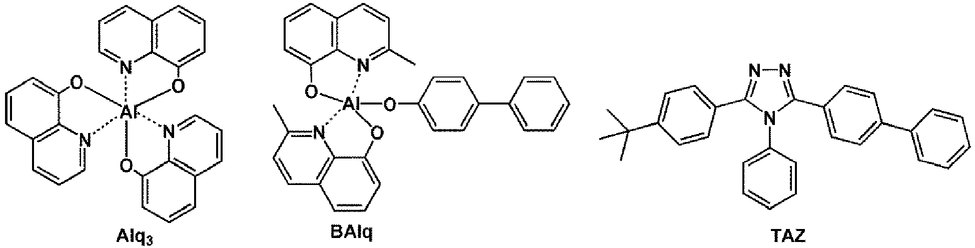

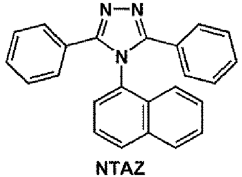

Thicknesses of the buffer layer, the hole blocking layer, and the electron control layer may each independently be in a range of about 20 Å to about 1,000 Å, for example, about 30 Å to about 300 Å. When the thicknesses of the buffer layer, the hole blocking layer, and the electron control layer are within these ranges, excellent hole blocking characteristics or excellent electron control characteristics may be obtained without a substantial increase in driving voltage.

A thickness of the electron transport layer may be in a range of about 100 Å to about 1,000 Å, for example, about 150 Å to about 500 Å. When the thickness of the electron transport layer is within the range described above, the electron transport layer may have satisfactory electron transport characteristics without a substantial increase in driving voltage.

The electron transport region 17 (for example, the electron transport layer in the electron transport region) may further include, in addition to the materials described above, a metal-containing material.

The metal-containing material may include at least one selected from alkali metal complex and alkaline earth-metal complex. The alkali metal complex may include a metal ion selected from a Li ion, a Na ion, a K ion, a Rb ion, and a Cs ion, and the alkaline earth-metal complex may include a metal ion selected from a Be ion, a Mg ion, a Ca ion, a Sr ion, and a Ba ion. A ligand coordinated with the metal ion of the alkali metal complex or the alkaline earth-metal complex may be selected from a hydroxy quinoline, a hydroxy isoquinoline, a hydroxy benzoquinoline, a hydroxy acridine, a hydroxy phenanthridine, a hydroxy phenyloxazole, a hydroxy phenylthiazole, a hydroxy diphenyloxadiazole, a hydroxy diphenylthiadiazole, a hydroxy phenylpyridine, a hydroxy phenylbenzimidazole, a hydroxy phenylbenzothiazole, a bipyridine, a phenanthroline, and a cyclopentadiene, but embodiments of the present disclosure are not limited thereto.

For example, the metal-containing material may include a Li complex. The Li complex may include, for example, Compound ET-D1 (lithium quinolate, LiQ) or ET-D2:

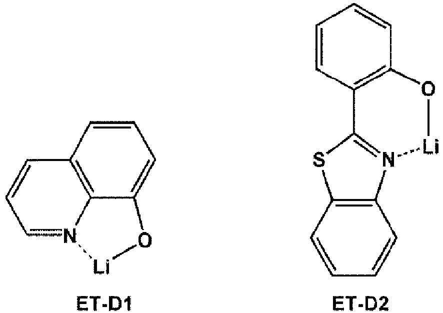

The electron transport region 17 may include an electron injection layer that facilitates injection of electrons from the second electrode 19. The electron injection layer may directly contact the second electrode 19.

The electron injection layer may have i) a single-layered structure including a single layer including a single material, ii) a single-layered structure including a single layer including a plurality of different materials, or iii) a multi-layered structure having a plurality of layers including a plurality of different materials.

The electron injection layer may include an alkali metal, an alkaline earth metal, a rare earth metal, an alkali metal compound, an alkaline earth-metal compound, a rare earth metal compound, an alkali metal complex, an alkaline earth-metal complex, a rare earth metal complex, or any combinations thereof.

The alkali metal may be selected from Li, Na, K, Rb, and Cs. In one embodiment, the alkali metal may be Li, Na, or Cs. In one or more embodiments, the alkali metal may be Li or Cs, but embodiments of the present disclosure are not limited thereto.

The alkaline earth metal may be selected from Mg, Ca, Sr, and Ba.

The rare earth metal may be selected from Sc, Y, Ce, Tb, Yb, and Gd.

The alkali metal compound, the alkaline earth-metal compound, and the rare earth metal compound may be selected from oxides and halides (for example, fluorides, chlorides, bromides, or iodides) of the alkali metal, the alkaline earth-metal, and the rare earth metal.

The alkali metal compound may be selected from alkali metal oxides, such as Li₂O, Cs₂O, or K₂O, and alkali metal halides, such as LiF, NaF, CsF, KF, Lil, Nal, Csl, or KI. In one embodiment, the alkali metal compound may be selected from LiF, Li₂O, NaF, Lil, Nal, Csl, and KI, but embodiments of the present disclosure are not limited thereto.

The alkaline earth-metal compound may be selected from alkaline earth-metal oxides, such as BaO, SrO, CaO], BaₓSr₁₋ₓO (0<x<1), or BaₓCa₁₋ₓO (0<x<1). In one embodiment, the alkaline earth-metal compound may be selected from BaO, SrO, and CaO, but embodiments of the present disclosure are not limited thereto.

The rare earth metal compound may be selected from YbF₃, ScF₃, ScO₃, Sc₂O₃, Y₂O₃, Ce₂O₃, GdF₃, and TbF₃. In one embodiment, the rare earth metal compound may be selected from YbF₃, ScF₃, TbF₃, YbI₃, ScI₃, and TbI₃, but embodiments of the present disclosure are not limited thereto.

The alkali metal complex, the alkaline earth-metal complex, and the rare earth metal complex may include an ion of alkali metal, alkaline earth-metal, and rare earth metal as described above, and a ligand coordinated with a metal ion of the alkali metal complex, the alkaline earth-metal complex, or the rare earth metal complex may be selected from hydroxy quinoline, hydroxy isoquinoline, hydroxy benzoquinoline, hydroxy acridine, hydroxy phenanthridine, hydroxy phenyloxazole, hydroxy phenylthiazole, hydroxy diphenyloxadiazole, hydroxy diphenylthiadiazole, hydroxy phenylpyridine, hydroxy phenylbenzimidazole, hydroxy phenylbenzothiazole, bipyridine, phenanthroline, and cyclopentadiene, but embodiments of the present disclosure are not limited thereto.

The electron injection layer may consist of an alkali metal, an alkaline earth metal, a rare earth metal, an alkali metal compound, an alkaline earth-metal compound, a rare earth metal compound, an alkali metal complex, an alkaline earth-metal complex, a rare earth metal complex, or any combinations thereof, as described above. In one or more embodiments, the electron injection layer may further include an organic material. When the electron injection layer further includes an organic material, an alkali metal, an alkaline earth metal, a rare earth metal, an alkali metal compound, an alkaline earth-metal compound, a rare earth metal compound, an alkali metal complex, an alkaline earth-metal complex, a rare earth metal complex, or any combinations thereof may be homogeneously or non-homogeneously dispersed in a matrix including the organic material.

A thickness of the electron injection layer may be in a range of about 1 Å to about 100 Å, for example, about 3 Å to about 90 Å. When the thickness of the electron injection layer is within the range described above, the electron injection layer may have satisfactory electron injection characteristics without a substantial increase in driving voltage.

### [Second electrode 19]

The second electrode 19 is located on the organic layer 10A having such a structure. The second electrode 19 may be a cathode which is an electron injection electrode, and in this regard, a material for forming the second electrode 19 may be selected from a metal, an alloy, an electrically conductive compound, and a combination thereof, which have a relatively low work function.

The second electrode 19 may include at least one selected from lithium (Li), silver (Ag), magnesium (Mg), aluminum (Al), aluminum-lithium (Al-Li), calcium (Ca), magnesium-indium (Mg-In), magnesium-silver (Mg-Ag), ITO, and IZO, but embodiments of the present disclosure are not limited thereto. The second electrode 19 may be a transmissive electrode, a semi-transmissive electrode, or a reflective electrode.

The second electrode 19 may have a single-layered structure having a single layer or a multi-layered structure including two or more layers.

Hereinbefore, the organic light-emitting device has been described with reference to FIGURE, but embodiments of the present disclosure are not limited thereto.

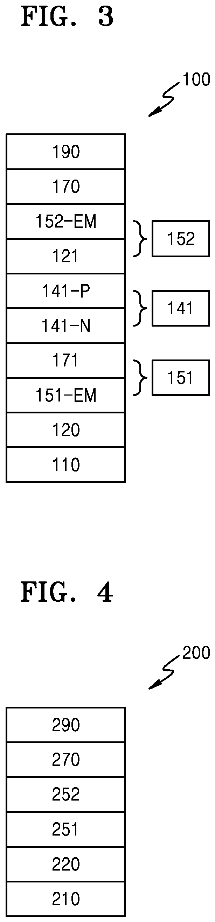

### [Description of FIG. 3]

FIG. 3 is a schematic cross-sectional view of an organic light-emitting device 100 according to another embodiment.

The organic light-emitting device 100 of FIG. 3 includes a first electrode 110, a second electrode 190 facing the first electrode 110, and a first emission unit 151 and a second emission unit 152 between the first electrode 110 and the second electrode 190. A charge generating layer 141 is located between the first emission unit 151 and the second emission unit 152, and the charge generating layer 141 may include an n-type charge generating layer 141-N and a p-type charge generating layer 141-P. The charge generating layer 141 is a layer that generates charge and supplies the charge to neighboring emission units, and any known material may be used therefor.

The first emission unit 151 may include a first emission layer 151-EM, and the second emission unit 152 may include a second emission layer 152-EM. The maximum emission wavelength of light emitted from the first emission unit 151 may be different from the maximum emission wavelength of light emitted from the second emission unit 152. For example, the mixed light of the light emitted from the first emission unit 151 and the light emitted from the second emission unit 152 may be white light, but embodiments of the present disclosure are not limited thereto.

The hole transport region 120 is located between the first emission unit 151 and the first electrode 110, and the second emission unit 152 may include the first hole transport region 121 located on the side of the first electrode 110 .

An electron transport region 170 is located between the second emission unit 152 and the second electrode 190, and the first emission unit 151 may include a first electron transport region 171 located between the charge generating layer 141 and the first emission layer 151-EM.

The first emission layer 151-EM may include a host, a cooling dopant, and a sensitizer, and the cooling dopant and the sensitizer may satisfy Conditions 1 and 2.

The second emission layer 152-EM may include a host, a cooling dopant, and a sensitizer, and the cooling dopant and the sensitizer may satisfy Conditions 1 and 2.

The first electrode 110 and the second electrode 190 illustrated in FIG. 3 may be the same as described in connection with the first electrode 11 and the second electrode 19 illustrated in FIG. 1.

The first emission layer 151-EM and the second emission layer 152-EM illustrated in FIG. 3 are each the same as described in connection with the emission layer 15 illustrated in FIG. 1.

The hole transport region 120 and the first hole transport region 121 illustrated in FIG. 3 are each the same as described in connection with the hole transport region 12 illustrated in FIG. 1.

The electron transport region 170 and the first electron transport region 171 illustrated in FIG. 3 are each the same as described in connection with the electron transport region 17 illustrated in FIG. 1.

As described above, referring to FIG. 3, an organic light-emitting device in which each of the first emission unit 151 and the second emission unit 152 includes an emission layer including a host, a cooling dopant, and a sensitizer, has been described. However, the organic light-emitting device may have various other forms. For example, one of the first emission unit 151 and the second emission unit 152 of the organic light-emitting device 100 of FIG. 3 may be replaced with any known emission unit, or may include three or more emission units.

### [Description of FIG. 4]

FIG. 4 is a schematic cross-sectional view of an organic light-emitting device 200 according to another embodiment.

The organic light-emitting device 200 includes a first electrode 210, a second electrode 290 facing the first electrode 210, and a first emission layer 251 and a second emission layer 252 which are stacked between the first electrode 210 and the second electrode 290.

The maximum emission wavelength of light emitted from the first emission layer 251 may be different from the maximum emission wavelength of light emitted from the second emission layer 252. For example, the mixed light of the light emitted from the first emission layer 251 and the light emitted from the second emission layer 252 may be white light, but embodiments of the present disclosure are not limited thereto.

In one or more embodiments, a hole transport region 220 may be located between the first emission layer 251 and the first electrode 210, and an electron transport region 270 may be located between the second emission layer 252 and the second electrode 290.

The first emission layer 251 may include a host, a cooling dopant, and a sensitizer, and the cooling dopant and the sensitizer may satisfy Conditions 1 and 2.

The second emission layer 252 may include a host, a cooling dopant, and a sensitizer, and the cooling dopant and the sensitizer may satisfy Conditions 1 and 2.

The first electrode 210, the hole transport region 220, and the second electrode 290 illustrated in FIG. 4 are respectively the same as described in connection with the first electrode 11, the hole transport region 12, and the second electrode 19 illustrated in FIG. 1.

The first emission layer 251 and the second emission layer 252 illustrated in FIG. 4 are each the same as described in connection with the emission layer 15 illustrated in FIG. 1.

The electron transport region 270 illustrated in FIG. 4 may be the same as described in connection with the electron transport region 17 in FIG. 1.

As described above, referring to FIG. 4, an organic light-emitting device, in which each of the first emission layer 251 and the second emission layer 252 includes a host, a cooling dopant, and a sensitizer, has been described. However, the organic light-emitting device may have various other forms. For example, one of the first emission layer 251 and the second emission layer 252 of the organic light-emitting device 200 of FIG. 4 may be replaced with any known emission layer, or an interlayer may be additionally located between neighboring emission layers.

### Explanation of terms

The term "C₁-C₆₀ alkyl group" as used herein refers to a linear or branched saturated aliphatic hydrocarbon monovalent group having 1 to 60 carbon atoms, and examples thereof include a methyl group, an ethyl group, a propyl group, an isobutyl group, a sec-butyl group, a tert-butyl group, a pentyl group, an isoamyl group, and a hexyl group. The term "C₁-C₆₀ alkylene group" as used herein refers to a divalent group having the same structure as the C₁-C₆₀ alkyl group.

The term "C₁-C₆₀ alkoxy group" used herein refers to a monovalent group represented by -OA₁₀₁ (wherein A₁₀₁ is the C₁-C₆₀ alkyl group), and examples thereof include a methoxy group, an ethoxy group, and an isopropyloxy group.

The term "C₂-C₆₀ alkenyl group" as used herein refers to a hydrocarbon group formed by substituting at least one carbon-carbon double bond in the middle or at the terminus of the C₂-C₆₀ alkyl group, and examples thereof include an ethenyl group, a propenyl group, and a butenyl group. The term "C₂-C₆₀ alkenylene group" as used herein refers to a divalent group having the same structure as the C₂-C₆₀ alkenyl group.

The term "C₂-C₆₀ alkynyl group" as used herein refers to a hydrocarbon group formed by substituting at least one carbon-carbon triple bond in the middle or at the terminus of the C₂-C₆₀ alkyl group, and examples thereof include an ethynyl group, and a propynyl group. The term "C₂-C₆₀ alkynylene group" as used herein refers to a divalent group having the same structure as the C₂-C₆₀ alkynyl group.

The term "C₃-C₁₀ cycloalkyl group" as used herein refers to a monovalent saturated hydrocarbon monocyclic group having 3 to 10 carbon atoms, and examples thereof include a cyclopropyl group, a cyclobutyl group, a cyclopentyl group, a cyclohexyl group, and a cycloheptyl group. The term "C₃-C₁₀ cycloalkylene group" as used herein refers to a divalent group having the same structure as the C₃-C₁₀ cycloalkyl group.

The term "C₁-C₁₀ heterocycloalkyl group" as used herein refers to a monovalent saturated monocyclic group having at least one heteroatom selected from N, O, P, Si, and S as a ring-forming atom and 1 to 10 carbon atoms, and non-limiting examples thereof include a tetrahydrofuranyl group, and a tetrahydrothiophenyl group. The term "C₁-C₁₀ heterocycloalkylene group" as used herein refers to a divalent group having the same structure as the C₁-C₁₀ heterocycloalkyl group.

The term "C₃-C₁₀ cycloalkenyl group" as used herein refers to a monovalent monocyclic group that has 3 to 10 carbon atoms and at least one carbon-carbon double bond in the ring thereof and no aromaticity, and non-limiting examples thereof include a cyclopentenyl group, a cyclohexenyl group, and a cycloheptenyl group. The term "C₃-C₁₀ cycloalkenylene group" as used herein refers to a divalent group having the same structure as the C₃-C₁₀ cycloalkenyl group.

The term "C₁-C₁₀ heterocycloalkenyl group" as used herein refers to a monovalent monocyclic group that has at least one heteroatom selected from N, O, P, Si, and S as a ring-forming atom, 1 to 10 carbon atoms, and at least one carbon-carbon double bond in its ring. Examples of the C₁-C₁₀ heterocycloalkenyl group are a 2,3-dihydrofuranyl group, and a 2,3-dihydrothiophenyl group. The term "C₁-C₁₀ heterocycloalkenylene group" as used herein refers to a divalent group having the same structure as the C₁-C₁₀ heterocycloalkenyl group.

The term "C₆-C₆₀ aryl group" as used herein refers to a monovalent group having a carbocyclic aromatic system having 6 to 60 carbon atoms, and the term "C₆-C₆₀ arylene group" as used herein refers to a divalent group having a carbocyclic aromatic system having 6 to 60 carbon atoms. Examples of the C₆-C₆₀ aryl group include a phenyl group, a naphthyl group, an anthracenyl group, a phenanthrenyl group, a pyrenyl group, and a chrysenyl group. When the C₆-C₆₀ aryl group and the C₆-C₆₀ arylene group each include two or more rings, the rings may be fused to each other.

The term "C₁-C₆₀ heteroaryl group" as used herein refers to a monovalent group having a heterocarbocyclic aromatic system that has at least one heteroatom selected from N, O, P, Si, and S as a ring-forming atom, and 1 to 60 carbon atoms. The term "C₁-C₆₀ heteroarylene group" as used herein refers to a divalent group having a carbocyclic aromatic system that has at least one heteroatom selected from N, O, P, and S as a ring-forming atom, and 1 to 60 carbon atoms. Examples of the C₁-C₆₀ heteroaryl group include a pyridinyl group, a pyrimidinyl group, a pyrazinyl group, a pyridazinyl group, a triazinyl group, a quinolinyl group, and an isoquinolinyl group. When the C₆-C₆₀ heteroaryl group and the C₆-C₆₀ heteroarylene group each include two or more rings, the rings may be fused to each other.

The term "C₆-C₆₀ aryloxy group" as used herein refers to -OA₁₀₂ (wherein A₁₀₂ is the C₆-C₆₀ aryl group), and a C₆-C₆₀ arylthio group used herein refers to -SA₁₀₃ (wherein A₁₀₃ is the C₆-C₆₀ aryl group).

The term "monovalent non-aromatic condensed polycyclic group" used herein refers to a monovalent group in which two or more rings are condensed with each other, only carbon is used as a ring-forming atom (for example, the number of carbon atoms may be 8 to 60) and the whole molecule is a non-aromaticity group. Examples of the monovalent non-aromatic condensed polycyclic group include a fluorenyl group. The term "divalent non-aromatic condensed polycyclic group" as used herein refers to a divalent group having the same structure as the monovalent non-aromatic condensed polycyclic group.

The term "monovalent non-aromatic condensed heteropolycyclic group" as used herein refers to a monovalent group having two or more rings condensed to each other, a heteroatom selected from N, O, P, Si, and S, other than carbon atoms(for example, having 1 to 60 carbon atoms), as a ring-forming atom, and no aromaticity in its entire molecular structure. Examples of the monovalent non-aromatic condensed heteropolycyclic group include a carbazolyl group. The term "divalent non-aromatic condensed heteropolycyclic group" as used herein refers to a divalent group having the same structure as the monovalent non-aromatic condensed heteropolycyclic group.

The term "C₅-C₃₀ carbocyclic group" as used herein refers to a saturated or unsaturated cyclic group having, as a ring-forming atom, 5 to 30 carbon atoms only. The C₅-C₃₀ carbocyclic group may be a monocyclic group or a polycyclic group, and may be a monovalent, divalent, trivalent, tetravalent, pentavalent, or hexavalent group, depending on the formula structure.

The term "C₁-C₃₀ heterocyclic group" as used herein refers to a saturated or unsaturated cyclic group having, as a ring-forming atom, at least one heteroatom selected from N, O, Si, P, and S other than 1 to 30 carbon atoms. The C₁-C₃₀ heterocyclic group may be a monocyclic group or a polycyclic group, and may be a monovalent, divalent, trivalent, tetravalent, pentavalent, or hexavalent group, depending on the formula structure.

At least one substituent of the substituted C₅-C₆₀ carbocyclic group, the substituted C₁-C₆₀ heterocyclic group, the substituted C₁-C₆₀ alkyl group, the substituted C₂-C₆₀ alkenyl group, the substituted C₂-C₆₀ alkynyl group, the substituted C₁-C₆₀ alkoxy group, the substituted C₃-C₁₀ cycloalkyl group, the substituted C₁-C₁₀ heterocycloalkyl group, the substituted C₃-C₁₀ cycloalkenyl group, the substituted C₁-C₁₀ heterocycloalkenyl group, the substituted C₆-C₆₀ aryl group, the substituted C₆-C₆₀ aryloxy group, the substituted C₆-C₆₀ arylthio group, the substituted C₁-C₆₀ heteroaryl group, the substituted monovalent non-aromatic condensed polycyclic group, and the substituted monovalent non-aromatic condensed heteropolycyclic group may be selected from:
deuterium, -F, -CI, -Br, -I, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid or a salt thereof, a sulfonic acid or a salt thereof, a phosphoric acid or a salt thereof, a C₁-C₆₀ alkyl group, a C₂-C₆₀ alkenyl group, a C₂-C₆₀ alkynyl group, and a C₁-C₆₀ alkoxy group;
a C₁-C₆₀ alkyl group, a C₂-C₆₀ alkenyl group, a C₂-C₆₀ alkynyl group, and a C₁-C₆₀ alkoxy group, each substituted with at least one of deuterium, -F, -Cl, -Br, -I, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid or a salt thereof, a sulfonic acid or a salt thereof, a phosphoric acid or a salt thereof, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, a monovalent non-aromatic condensed heteropolycyclic group, -N(Q₁₁)(Q₁₂), -Si(Q₁₃)(Q₁₄)(Q₁₅), -B(Q₁₆)(Q₁₇), and -P(=O)(Q₁₈)(Q₁₉);
a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, and a monovalent non-aromatic condensed heteropolycyclic group;
a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, and a monovalent non-aromatic condensed heteropolycyclic group, each substituted with at least one of deuterium, -F, -CI, -Br, -I, -CD₃, -CD₂H, -CDH₂, -CF₃, -CF₂H, -CFH₂, a hydroxyl group, a cyano group, a nitro group, an amidino group, a hydrazine group, a hydrazone group, a carboxylic acid or a salt thereof, a sulfonic acid or a salt thereof, a phosphoric acid or a salt thereof, a C₁-C₆₀ alkyl group, a C₂-C₆₀ alkenyl group, a C₂-C₆₀ alkynyl group, a C₁-C₆₀ alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, a monovalent non-aromatic condensed heteropolycyclic group, -N(Q₂₁)(Q₂₂), -Si(Q₂₃)(Q₂₄)(Q₂₅), -B(Q₂₆)(Q₂₇), and -P(=O)(Q₂₈)(Q₂₉); and
-N(Q31)(Q32), -Si(Q₃₃)(Q₃₄)(Q₃₅), -B(Q₃₆)(Q₃₇), and -P(=O)(Q₃₈)(Q₃₉),
wherein Q₁ to Q₉, Q₁₁ to Q₁₉, Q₂₁ to Q₂₉ and Q₃₁ to Q₃₉ may each independently be selected from hydrogen, deuterium, -F, -CI, -Br, -I, a hydroxyl group, a cyano group, a nitro group, an amino group, an amidino group, a hydrazine group, a hydrazone group, a carboxylic acid or a salt thereof, a sulfonic acid or a salt thereof, a phosphoric acid or a salt thereof, a C₁-C₆₀ alkyl group, a C₂-C₆₀ alkenyl group, a C₂-C₆₀ alkynyl group, a C₁-C₆₀ alkoxy group, a C₃-C₁₀ cycloalkyl group, a C₁-C₁₀ heterocycloalkyl group, a C₃-C₁₀ cycloalkenyl group, a C₁-C₁₀heterocycloalkenyl group, a C₆-C₆₀ aryl group, a C₆-C₆₀ aryl group substituted with at least one selected from a C₁-C₆₀ alkyl group, and a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, and a monovalent non-aromatic condensed heteropolycyclic group.

The term "room temperature" used herein refers to a temperature of about 25 °C.

The terms "a biphenyl group, a terphenyl group, and a tetraphenyl group" used herein respectively refer to monovalent groups in which two, three, or four phenyl groups which are linked together via a single bond.

The terms "a cyano-containing phenyl group, a cyano-containing biphenyl group, a cyano-containing terphenyl group, and a cyano-containing tetraphenyl group" used herein respectively refer to a phenyl group, a biphenyl group, a terphenyl group, and a tetraphenyl group, each of which is substituted with at least one cyano group. In "a cyano-containing phenyl group, a cyano-containing biphenyl group, a cyano-containing terphenyl group, and a cyano-containing tetraphenyl group", a cyano group may be substituted to any position of the corresponding group, and the "cyano-containing phenyl group, the cyano-containing biphenyl group, the cyano-containing terphenyl group, and the cyano-containing tetraphenyl group" may further include substituents other than a cyano group. For example, a phenyl group substituted with a cyano group, and a phenyl group substituted with a cyano group and a methyl group may all belong to "a cyano-containing phenyl group."

Hereinafter, a compound and an organic light-emitting device according to embodiments are described in detail with reference to Synthesis Examples and Examples. However, the organic light-emitting device is not limited thereto. The wording "'B' was used instead of 'A'" used in describing Synthesis Examples means that an amount of 'A' used was identical to an amount of 'B' used, in terms of a molar equivalent.

### [Examples]

### Evaluation Example 1: Decay time measurement

On the quartz substrate, compounds of Tables 5 to 7 were vacuum-codeposited at a vacuum degree of 10⁻⁷ torr at a weight ratio of Tables 5 to 7 to manufacture films, each having a thickness of 40 nm. With respect to each of the films, the PL spectrum was evaluated at room temperature by using FluoTime 300 of PicoQuant Inc. and PLS340, which is a pumping source of PicoQuant Inc., (excitation wavelength = 340 nm, and spectrum width = 20 nm). In detail, the wavelength of the main peak of the spectrum obtained for each film was identified, and the number of photons emitted from the respective sample at the wavelength of the main peak by photon pulses (pulse width = 500 ps) applied by the PLS340 to the respective film was repeatedly measured based on time-correlated single photon counting (TCSPC), to obtain a TRPL curve which can be subjected to fitting. Two or more exponential decay functions, obtained therefrom, were subjected to fitting to calculate a decay time with respect to each film. In this regard, the same measurement was performed for the same measurement time as used to obtain the TRPL curve in the dark condition (The light low pulse signal incident to the predetermined film was blocked) to obtain a background signal curve which was then subjected to fitting. The resultant was used as a baseline.

At this time, in the case of the film of Table 5, the function used for fitting is the same as Equation A below, and the largest value among the Taus obtained therefrom was taken. For the films of Tables 6 and 7 below, Tau was obtained by <Equation B> using the amplitude values (A₁, A₂, A₃, etc.) and Tau values (Tau₁, Tau₂, Tau₃, etc.) obtained by fitting: $f \left(t\right) = {\sum }_{i = 1}^{n} {A}_{i} exp \left(-t/{T}_{decay , i}\right)$ $Tau = \left({\sum }_{i = 1}^{n} {A}_{i} \times {Tau}_{i}\right) \div \left({\sum }_{i = 1}^{n} {A}_{i}\right)$

**[Table 5]**

| Film No. | Film composition (weight ratio) | Decay time(*µ*s) |
|---|---|---|
| SP002ND | H-H1 : H-E1 : SP002 (45 : 45 : 10) | 2.393 |
| SP003ND | H-H1 : H-E1 : SP003 (45 : 45 : 10) | 2.703 |
| SP004ND | H-H1 : H-E1 : SP004 (45 : 45 : 10) | 4.924 |
| SP005ND | H-H1 : H-E1 : SP005 (45 : 45 : 10) | 2.866 |
| SP006ND | H-H1 : H-E1 : SP006 (45 : 45 : 10) | 1.836 |
| SP007ND | H-H1 : H-E1 : SP007 (45 : 45 : 10) | 2.223 |
| ST001 ND | H-H1 : H-E1 : ST001 (45 : 45 : 10) | 1.13 |
| ST002ND | H-H1 : H-E1 : ST002 (45 : 45 : 10) | 2.69 |

**Table 6**

| Film No. | Film composition (weight ratio) | Decay time(*µ*s) |
|---|---|---|
| SP002D | H-H1 : H-E1 : SP002 : FD11 (42.75 : 42.75 : 9.5 : 5) | 0.363 |
| SP003D | H-H1 : H-E1 : SP003 : FD11 (42.75 : 42.75 : 9.5 : 5) | 0.378 |
| SP004D | H-H1 : H-E1 : SP004 : FD11 (42.75 : 42.75 : 9.5 : 5) | 0.269 |
| SP005D | H-H1 : H-E1 : SP005 : FD11 (42.75 : 42.75 : 9.5 : 5) | 0.398 |
| SP006D1 | H-H1 : H-E1 : SP006 : FD11 (42.75 : 42.75 : 9.5 : 5) | 0.307 |
| SP006D2 | H-H1 : H-E1 : SP006 : FD5 (42.75 : 42.75 : 9.5 : 5) | 0.634 |
| SP007D1 | H-H1 : H-E1 : SP007 : FD11 (42.75 : 42.75 : 9.5 : 5) | 0.413 |
| SP007D2 | H-H1 : H-E1 : SP007 : FD5 (42.75 : 42.75 : 9.5 : 5) | 0.749 |
| ST001D1 | H-H1 : H-E1 : ST001 : FD11 (42.75 : 42.75 : 9.5 : 5) | 0.012 |
| ST001 D2 | H-H1 : H-E1 : ST001 : FD5 (42.75 : 42.75 : 9.5 : 5) | 0.09 |
| ST002D1 | H-H1 : H-E1 : ST002 : FD11 (42.75 : 42.75 : 9.5 : 5) | 0.719 |
| ST002D2 | H-H1 : H-E1 : ST002 : FD5 (42.75 : 42.75 : 9.5 : 5) | 0.673 |

**Table 7**

| Film No. | Film composition (weight ratio) | Decay time(*µ*s) |
|---|---|---|
| FD001 | H-H1 : H-E1 : FD11 (47.5 : 47.5 : 5) | 0.027 |
| FD002 | H-H1 : H-E1 : FD5 (47.5 : 47.5 : 5) | 0.069 |

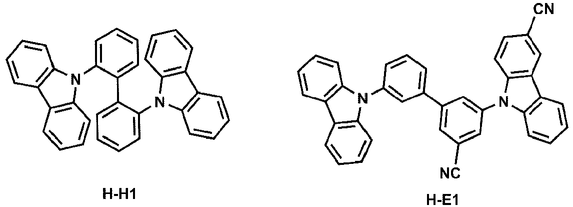

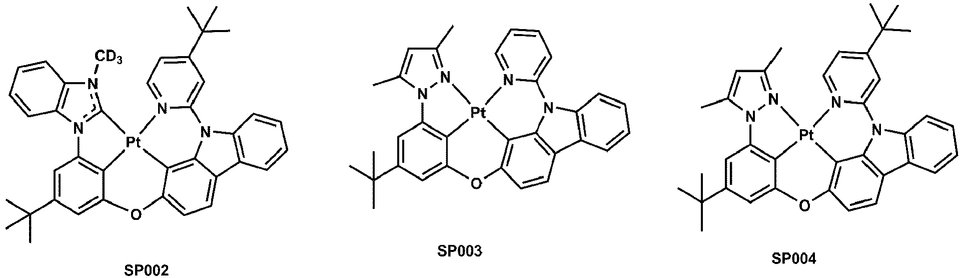

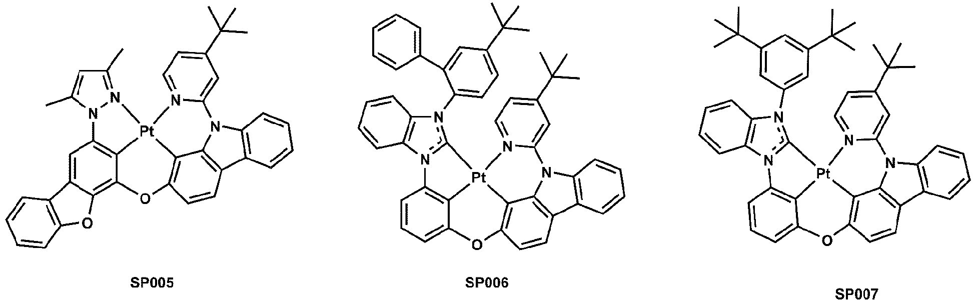

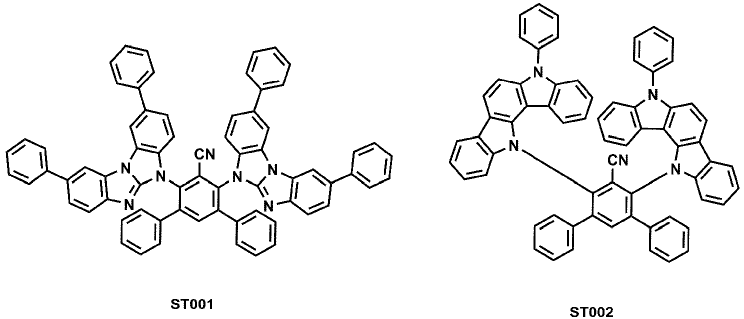

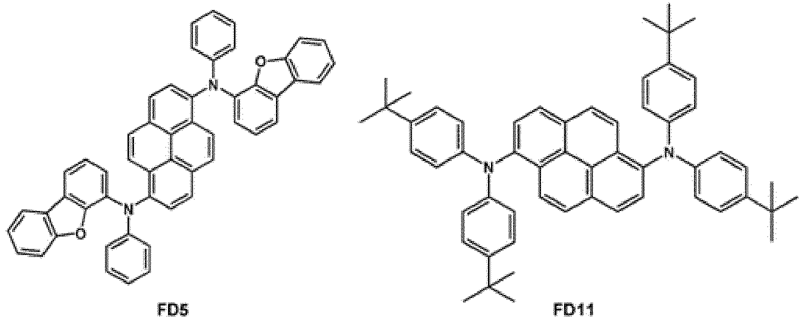

### Example 1

An ITO glass substrate was cut to a size of 50 mm x 50 mm x 0.5 mm and then, sonicated in acetone isopropyl alcohol and pure water, each for 15 minutes, and then, washed by exposure to UV ozone for 30 minutes.

Then, F6-TCNNQ was deposited on the ITO electrode (anode) of the glass substrate to form a hole injection layer having a thickness of 100Å, and HT1 was deposited on the hole injection layer to form a hole transport layer having a thickness of 1260 Å, thereby completing a hole transport region.

Compound H-H1 (first host), H-E1 (second host), Compound SP002(sensitizer)(in this case, the weight ratio of the first host, the second host and the sensitizer was 45:45:10) and FD11 (cooling dopant)(in this case, the cooling dopant was 5 wt% based on the total weight of the first host, the second host, the sensitizer, and the cooling dopant) were co-deposited on the hole transport region to form an emission layer having a thickness of 400Å thickness.

Compound ET17 and Liq were co-deposited at the weight ratio of 5:5 on the emission layer to form an electron transport layer having a thickness of 360Å thickness, and then, LiQ was deposited on the electron transport layer to form an electron injection layer having a thickness of 5Å thickness, and Al was deposited on the electron injection layer to a thickness of 800Å, thereby completing of an organic light-emitting device.

### Examples 2 to 12

Organic light-emitting devices were manufactured in the same manner as in Example 1, except that the sensitizers and the cooling dopants shown in Table 8 were used in forming an emission layer.

**Table 8**

| | First host | Second host | Sensitizer | Cooling dopant |
|---|---|---|---|---|
| Example 1 | H-H1 | H-E1 | SP002 | FD11 |
| Example 2 | H-H1 | H-E1 | SP003 | FD11 |
| Example 3 | H-H1 | H-E1 | SP004 | FD11 |
| Example 4 | H-H1 | H-E1 | SP005 | FD11 |
| Example 5 | H-H1 | H-E1 | SP006 | FD11 |
| Example 6 | H-H1 | H-E1 | SP006 | FD5 |
| Example 7 | H-H1 | H-E1 | SP007 | FD11 |
| Example 8 | H-H1 | H-E1 | SP007 | FD5 |
| Example 9 | H-H1 | H-E1 | ST001 | FD11 |
| Example 10 | H-H1 | H-E1 | ST001 | FD5 |
| Example 11 | H-H1 | H-E1 | ST002 | FD11 |
| Example 12 | H-H1 | H-E1 | ST002 | FD5 |

### Comparative Example 1F and 2F

Organic light-emitting devices were manufactured in the same manner as in Example 1, except that, in forming an emission layer, a sensitizer was not used and the first host, the second host, and the cooling dopant were used as shown in Table 9.

**Table 9**

| | First host | Second host | Cooling dopant | Weight ratio (first host: second host: cooling dopant) |
|---|---|---|---|---|
| Comparative Example 1F | H-H1 | H-E1 | FD11 | 47.5 : 47.5 : 5 |
| Comparative Example 2F | H-H1 | H-E1 | FD5 | 47.5 : 47.5 : 5 |

### Comparative Examples 1P to 6P

Organic light-emitting devices were manufactured in the same manner as in Example 1, except that, in forming an emission layer, a cooling dopant was not used and the first host, the second host, and the sensitizer were used as shown in Table 10.

**Table 10**

| | First host | Second host | Sensitizer | Weight ratio (first host: second host: sensitizer) |
|---|---|---|---|---|
| Comparative Example 1P | H-H1 | H-E1 | SP002 | 45 : 45 : 10 |
| Comparative Example 2P | H-H1 | H-E1 | SP003 | 45 : 45 : 10 |
| Comparative Example 3P | H-H1 | H-E1 | SP004 | 45 : 45 : 10 |
| Comparative Example 4P | H-H1 | H-E1 | SP005 | 45 : 45 : 10 |
| Comparative Example 5P | H-H1 | H-E1 | SP006 | 45 : 45 : 10 |
| Comparative Example 6P | H-H1 | H-E1 | SP007 | 45 : 45 : 10 |

### Comparative Examples 1T and 2T

Organic light-emitting devices were manufactured in the same manner as in Example 1, except that, in forming an emission layer, a cooling dopant was not used and the first host, the second host, and the sensitizer were used as shown in Table 11.

**Table 11**

| | First host | Second host | Sensitizer | Weight ratio (first host: second host: sensitizer) |
|---|---|---|---|---|
| Comparative Example 1T | H-H1 | H-E1 | ST001 | 45 : 45 : 10 |
| Comparative Example 2T | H-H1 | H-E1 | ST002 | 45 : 45 : 10 |

### Evaluation Example 2: OLED Lifespan and External Quantum Efficiency Measurements

The external quantum efficiency (EQE) and lifespan of each of organic light-emitting devices manufactured according to Examples 1 to 12 were evaluated, and then, the results are calculated as a relative value (%), and results thereof are shown in Table 12. As an evaluation apparatus, a luminance meter (Minolta Cs-1000A) was used. The lifespan (T₉₅) was determined by evaluating the time taken for 100% of initial luminance to be 95% thereof under the same luminance measurement conditions.

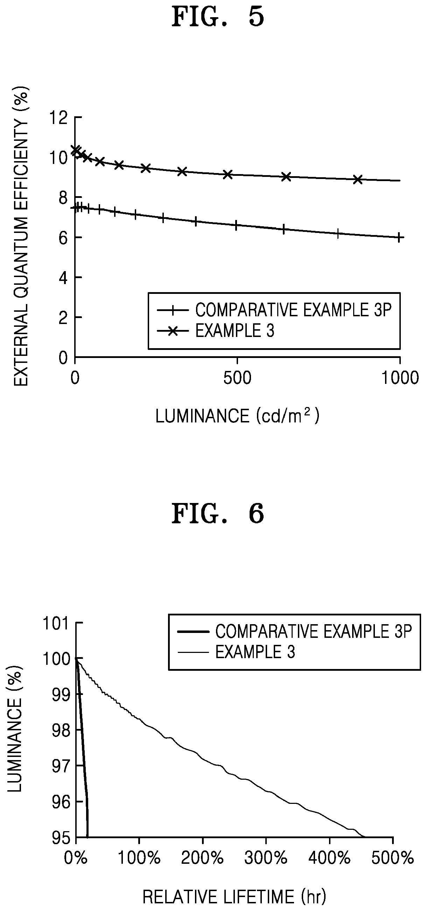

In addition, after measuring the lifespan and EQE of Example 3, Comparative Example 3P, 1F, and 2F, the relative value (%) was calculated based on the value of Comparative Example 1F and the results are shown in Table 13, and FIGS. 5 and 6.

**Table 12**

| | First host | Second host | Sensitizer | Cooling dopant | Lifespan (%) | EQE (%) |
|---|---|---|---|---|---|---|
| Example 1 | H-H1 | H-E1 | SP002 | FD11 | 688 | 181 |
| Example 2 | H-H1 | H-E1 | SP003 | FD11 | 234 | 142 |
| Example 3 | H-H1 | H-E1 | SP004 | FD11 | 296 | 121 |
| Example 4 | H-H1 | H-E1 | SP005 | FD11 | 100 | 100 |
| Example 5 | H-H1 | H-E1 | SP006 | FD11 | 1051 | 134 |
| Example 6 | H-H1 | H-E1 | SP006 | FD5 | 340 | 102 |
| Example 7 | H-H1 | H-E1 | SP007 | FD11 | 1355 | 144 |
| Example 8 | H-H1 | H-E1 | SP007 | FD5 | 487 | 124 |
| Example 9 | H-H1 | H-E1 | ST001 | FD11 | 43 | 65 |
| Example 10 | H-H1 | H-E1 | ST001 | FD5 | 24 | 86 |
| Example 11 | H-H1 | H-E1 | ST002 | FD11 | 232 | 129 |
| Example 12 | H-H1 | H-E1 | ST002 | FD5 | 140 | 162 |

Referring to Table 12, it can be seen that the organic light-emitting device of Example 1 to 12 has long life span and high efficiency.

**Table 13**

| | First host | Second host | Sensitizer | Cooling dopant | Lifespan (%) | EQE (%) |
|---|---|---|---|---|---|---|
| Example 3 | H-H1 | H-E1 | SP004 | FD11 | 296 | 121 |
| Comparative Example 3P | H-H1 | H-E1 | SP004 | - | 13 | 86 |
| Comparative Example 1F | H-H1 | H-E1 | - | FD11 | 66 | 31 |

Referring to Table 13, and FIGS. 5 and 6, it can be seen that the organic light-emitting device of Example 3 has a long lifespan and high EQE compared to a phosphorescent organic light-emitting device (Comparative Example 3P) and a fluorescent organic light-emitting device (Comparative Example 1F).

### Evaluation Example 3: Calculation of OLED Lifespan Increase

For Examples 1 to 12 and Comparative Examples 1F and 2F, the time (T₉₅) taken for 100% of the initial luminance to be decreased to 95% thereof at 6000 nits was measured. Then, the lifespan increase of Example 1 to 12 was calculated using the following equation L and the results are shown in Table 14. $Lifespan increase of device A = \left\{{T}_{95} of device A\right\} / \left\{{T}_{95} of device B\right\}$

**Table 14**

| Device A | Device B | Lifespan Increase of Device A |
|---|---|---|
| Example 1 | Comparative Example 1F | 5.8 |
| Example 2 | Comparative Example 1F | 4.6 |
| Example 3 | Comparative Example 1F | 22.3 |
| Example 4 | Comparative Example 1F | 9.74 |
| Example 5 | Comparative Example 1F | 5.70 |
| Example 6 | Comparative Example 2F | 1.84 |
| Example 7 | Comparative Example 1F | 4.17 |
| Example 8 | Comparative Example 2F | 1.5 |
| Example 9 | Comparative Example 1F | 11.3 |
| Example 10 | Comparative Example 2F | 6.14 |
| Example 11 | Comparative Example 1F | 5.74 |
| Example 12 | Comparative Example 2F | 3.46 |

Referring to the Table 14, it can be seen that the organic light-emitting devices of Examples 1 to 12 have a significant improvement in lifespan compared to the fluorescent organic light-emitting devices of Comparative Examples 1F and 2F which do not include the sensitizer.

### Evaluation Example 4: Calculation of OLED EQE Increase

For Examples 1 to 12, Comparative Examples 1P to 6P, and Comparative Examples 1T and 2T, external quantum efficiency (EQE) was measured. Then, the lifespan increase of Example 1 to 12 was calculated using the following equation E and the results are shown in Table 15. $EQE increment of device C = \left\{EQE of device C\right\} / \left\{EQE of device D\right\}$

**Table 15**

| Device C | Device D | EQE increment of device C |
|---|---|---|
| Example 1 | Comparative Example 1P | 5.78 |
| Example 2 | Comparative Example 2P | 4.52 |
| Example 3 | Comparative Example 3P | 3.85 |
| Example 4 | Comparative Example 4P | 3.19 |
| Example 5 | Comparative Example 5P | 4.26 |
| Example 6 | Comparative Example 5P | 1.66 |
| Example 7 | Comparative Example 6P | 4.60 |
| Example 8 | Comparative Example 6P | 2.02 |
| Example 9 | Comparative Example 1T | 2.07 |
| Example 10 | Comparative Example 1T | 1.40 |
| Example 11 | Comparative Example 2T | 4.11 |
| Example 12 | Comparative Example 2T | 2.62 |

Referring to the Table 15, it can be seen that the organic light-emitting devices of Examples 1 to 12 show a significant improvement in EQE compared to Comparative Examples 1P to 6P which do not include a cooling dopant, phosphorescence of 1T, and 2T, or TADF organic light-emitting devices.

The organic light-emitting device may have a long lifespan.

## Claims

1. An organic light-emitting device comprising:
a first electrode; a second electrode; and an organic layer between the first electrode and the second electrode;
the organic layer comprises an emission layer;
the emission layer comprises a host, a cooling dopant, and a sensitizer, wherein
the cooling dopant and the sensitizer satisfy Conditions 1, 2 and 3, and
the sensitizer comprises platinum (Pt): ${T}_{decay} \left(CD\right) < {T}_{decay} \left(S\right)$ ${T}_{decay} \left(CD\right) < 1.5 μs$ ${T}_{decay} \left(CD\right) / {T}_{decay} \left(S\right) < 0.5$ wherein, in Conditions 1, 2 and 3,
T_{decay}(CD) is a decay time of the cooling dopant, and
T_{decay}(S) is a decay time of the sensitizer;
wherein the decay time of the cooling dopant is calculated from a time-resolved photoluminescence spectrum at room temperature with respect to a 40 nm-thickness film obtained by vacuum-codepositing the host and the dopant comprised in the emission layer at the weight ratio of 90:10 on a quartz substrate at the vacuum degree of 10⁻⁷ torr, and the decay time of the sensitizer is calculated from time-resolved photoluminescence spectrum at room temperature with respect to a 40 nm-thickness film obtained by vacuum-codepositing the host and the sensitizer comprised in the emission layer at the weight ratio of 90:10 on a quartz substrate at the vacuum degree of 10⁻⁷ torr.

2. An organic light-emitting device comprising:
a first electrode; a second electrode; and an organic layer between the first electrode and the second electrode;
the organic layer comprises an emission layer;
the emission layer comprises a host, a cooling dopant, and a sensitizer, wherein
the cooling dopant and the sensitizer satisfy Conditions 1, 2 and 3, and
the sensitizer comprises a thermally activated delayed fluorescence emitter, and
the thermally activated delayed fluorescence emitter does not include metal: ${T}_{decay} \left(CD\right) < {T}_{decay} \left(S\right)$ ${T}_{decay} \left(CD\right) < 1.5 μs$ ${T}_{decay} \left(CD\right) / {T}_{decay} \left(S\right) < 0.5$ wherein, in Conditions 1, 2 and 3,
T_{decay}(CD) is a decay time of the cooling dopant, and
T_{decay}(S) is a decay time of the sensitizer;
wherein the decay time of the cooling dopant is calculated from a time-resolved photoluminescence spectrum at room temperature with respect to a 40 nm-thickness film obtained by vacuum-codepositing the host and the dopant comprised in the emission layer at the weight ratio of 90:10 on a quartz substrate at the vacuum degree of 10⁻⁷ torr, and the decay time of the sensitizer is calculated from time-resolved photoluminescence spectrum at room temperature with respect to a 40 nm-thickness film obtained by vacuum-codepositing the host and the sensitizer comprised in the emission layer at the weight ratio of 90:10 on a quartz substrate at the vacuum degree of 10⁻⁷ torr.

3. The organic light-emitting device of claim 1 or claim 2, wherein
the organic light-emitting device further satisfies Condition 4: $BDE \left(S\right) - {T}_{1} \left(S\right) < 3.0 eV$ wherein, in Condition 4,
BDE (S) is the bond dissociation energy level of the sensitizer, and
T1 (S) is the lowest excitation triplet energy level of the sensitizer; and/or wherein
the organic light-emitting device further satisfies Condition 5: $R \left(Hex\right) / {e}^{10} < 15$ wherein, in Condition 5,
R (Hex) is the production rate of hot excitons; and/or wherein
the host, the dopant, and the sensitizer further satisfy Condition 6: ${T}_{1} \left(H\right) \geq {T}_{1} \left(S\right) \geq {S}_{1} \left(CD\right)$ wherein, in Condition 6,
T₁(H) is the lowest excitation triplet energy level of the host,
T₁(S) is the lowest excitation triplet energy level of the sensitizer, and
S₁(CD) is the lowest excitation singlet energy level of the cooling dopant.

4. The organic light-emitting device of any of claims 1-3, wherein
the emission layer consists of the host, the cooling dopant, and the sensitizer.

5. The organic light-emitting device of any of claims 1-4, wherein
the host comprises an amphiprotic host, an electron transport host, and/or a hole transport host,
the electron transport host comprises at least one electron transport moiety,
the hole transport host does not include an electron transport moiety,
the electron transport moiety is selected from a cyano group, a π electron-deficient nitrogen-containing cyclic group, and a group represented by one of the following Formulae: 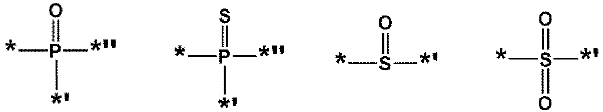 wherein *, *', and *" in the formulae above are each a binding site to a neighboring atom.

6. The organic light-emitting device of claim 5, wherein
the electron transport host comprises at least one π electron-deficient nitrogen-free cyclic group and at least one electron transport moiety,
the hole transport host comprises at least one π electron-deficient nitrogen-free cyclic group, and does not include an electron transport moiety, and
the electron transport moiety is a cyano group or an π-electron deficient nitrogen-containing cyclic group;
preferably wherein
the π electron-deficient nitrogen-containing cyclic group is selected from: an imidazole group, a pyrazole group, a thiazole group, an isothiazole group, an oxazole group, an isoxazole group, a pyridine group, a pyrazine group, a pyridazine group, a pyrimidine group, an indazole group, a purine group, a quinoline group, an isoquinoline group, a benzoquinoline group, a phthalazine group, a naphthyridine group, a quinoxaline group, a quinazoline group, a cinnoline group, a phenanthridine group, an acridine group, a phenanthroline group, a phenazine group, a benzimidazole group, an isobenzothiazole group, a benzoxazole group, an isobenzoxazole group, a triazole group, a tetrazole group, an oxadiazole group, a triazine group, a thiadiazole group, an imidazopyridine group, an imidazopyrimidine group, and an azacarbazole group; and a condensed cyclic group in which two or more π electron-deficient nitrogen-containing cyclic groups,
the π electron-deficient nitrogen-free cyclic group is selected from a benzene group, a heptalene group, an indene group, a naphthalene group, an azulene group, an indacene group, acenaphthylene group, a fluorene group, a spiro-bifluorene group, a benzofluorene group, a dibenzofluorene group, a phenalene group, a phenanthrene group, an anthracene group, a fluoranthene group, a triphenylene group, a pyrene group, a chrysene group, a naphthacene group, a picene group, a perylene group, a pentacene group, a hexacene group, a pentaphene group, a rubicene group, a coronene group, an ovalene group, a pyrrole group, an isoindole group, an indole group, a furan group, a thiophene group, a benzofuran group, a benzothiophene group, a benzocarbazole group, a dibenzocarbazole group, a dibenzofuran group, a dibenzothiophene group, a dibenzothiophene sulfone group, a carbazole group, a dibenzosilole group, an indenocarbazole group, an indolocarbazole group, a benzofurocarbazole group, a benzothienocarbazole group, a triindolobenzene group; and a condensed cyclic group of two or more π electron-deficient nitrogen-free cyclic groups.

7. The organic light-emitting device of claims 5 or 6, wherein
the electron transport host comprises i) at least one of a cyano group, a pyrimidine group, a pyrazine group, and a triazine group and ii) a triphenylene group, and
the hole transport host comprises a carbazole group.

8. The organic light-emitting device of any of claims 1-7, wherein the maximum emission wavelength of the emission spectrum of the cooling dopant is 400 nm or more and 550 nm or less; and/or
wherein the cooling dopant does not include a metal atom; and/or
wherein
the cooling dopant comprises one of a naphthalene-containing core, a fluorene-containing core, a spiro-bifluorene-containing core, a benzofluorene-containing core, a dibenzofluorene-containing core, a phenanthrene-containing core, an anthracene-containing core, a fluoranthene-containing core, a triphenylene-containing core, a pyrene-containing core, a chrysene-containing core, a naphthacene-containing core, a picene-containing core, a perylene-containing core, a pentaphene-containing core, an indenoanthracene-containing core, a bisanthracene-containing core, and cores represented by Formulae 501-1 to 501-18:

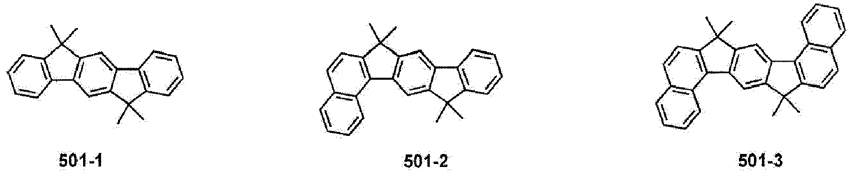

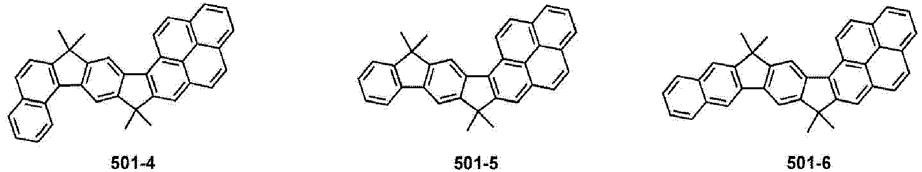

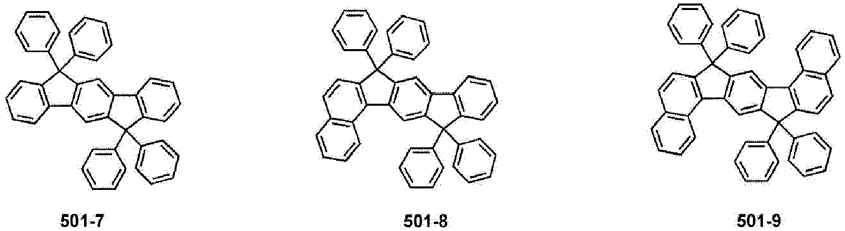

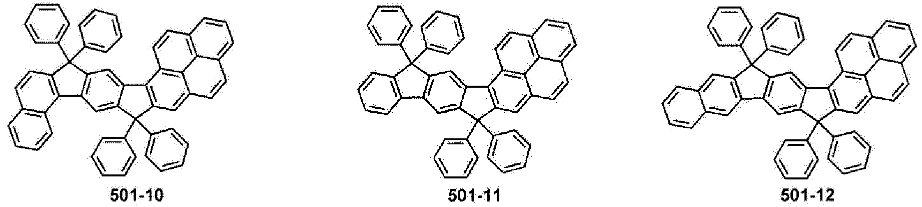

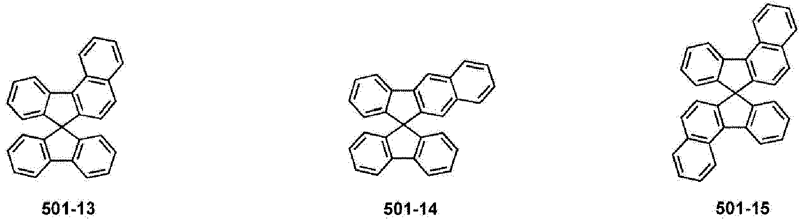

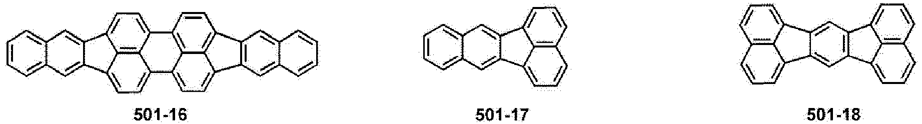

9. The organic light-emitting device of any of claims 1 or 3-8, wherein
the sentizer comprises the organometallic compound represented by Formula 101:
<Formula 101 > Pt(L₁₁)ₙ₁₁(L₁₂)ₙ₁₂
wherein, in Formula 101,
L₁₁ is a ligand represented by one of Formulae 1-1 to 1-4;
L₁₂ is selected from a monodentate ligand and a bidentate ligand;
n11 is1,
n12 is selected from 0, 1, and 2; 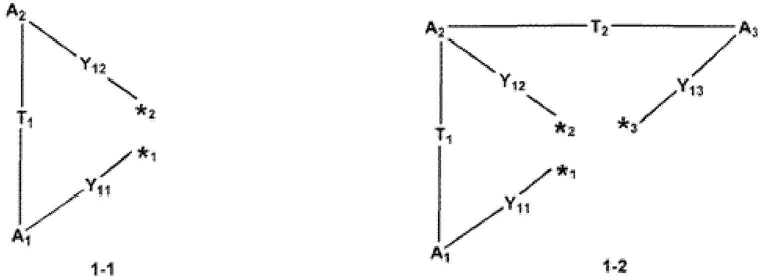 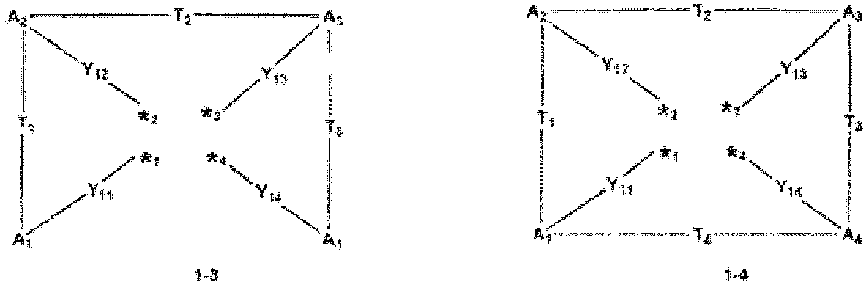
wherein, in Formulae 1-1 to 1-4,
A₁ to A₄ are each independently selected from a substituted or unsubstituted C₅-C₃₀carbocyclic group, a substituted or unsubstituted C₁-C₃₀ heterocyclic group, and a non-cyclic group,
Y₁₁ to Y₁₄ are each independently a chemical bond, O, S, N(R₉₁), B(R₉₁), P(R₉₁), or C(R₉₁)(R₉₂),
T₁ to T₄ are each independently selected from a single bond, a double bond,
*-N(R₉₃)-*', *-B(R₉₃)-*', *-P(R₉₃)-*', *-C(R₉₃)(R₉₄)-*', *-Si(R₉₃)(R₉₄)-*', *-Ge(R₉₃)(R₉₄)-*', *-S-*', *-Se-*', *-O-*', *-C(=O)-*', *-S(=O)-*', *-S(=O)₂-*', *-C(R₉₃)=*', *=C(R₉₃)-*', *-C(R₉₃)=C(R₉₄)-*', *-C(=S)-*', and *-C≡C-*',
a substituent of the substituted C₅-C₃₀ carbocyclic group, a substituent of substituted C₁-C₃₀ heterocyclic group, and R₉₁ to R₉₄ are each independently selected from hydrogen, deuterium, -F, -CI, -Br, -I, -SF₅, a hydroxyl group, a cyano group, a nitro group, an amidino group, a hydrazine group, a hydrazone group, a carboxylic acid or a salt thereof, a sulfonic acid or a salt thereof, a phosphoric acid or a salt thereof, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀heterocycloalkenyl group, a substituted or unsubstituted C₆-C₆₀ aryl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted monovalent non-aromatic condensed polycyclic group, a substituted or unsubstituted monovalent non-aromatic condensed heteropolycyclic group, -Si(Q₁)(Q₂)(Q₃), -B(Q₁)(Q₂), -N(Q₁)(Q₂), - P(Q₁)(Q₂), -C(=O)(Q₁), -S(=O)(Q₁), -S(=O)₂(Q₁), -P(=O)(Q₁)(Q₂), and -P(=S)(Q₁)(Q₂), wherein each of a substituent of the substituted C₅-C₃₀ carbocyclic group and a substituent of substituted C₁-C₃₀ heterocyclic group is not hydrogen,
*1, *2, *3, and *4 each indicate a binding site to Pt, and
Q₁ to Q₃ are each independently selected from hydrogen, deuterium, -F, -CI, - Br, -I, a hydroxyl group, a cyano group, a nitro group, an amidino group, a hydrazine group, a hydrazone group, a C₁-C₆₀ alkyl group, a C₂-C₆₀ alkenyl group, a C₂-C₆₀ alkynyl group, a C₁-C₆₀ alkoxy group, a C₃-C₁₀ cycloalkyl group, a C₁-C₁₀ heterocycloalkyl group, a C₃-C₁₀ cycloalkenyl group, a C₁-C₁₀heterocycloalkenyl group, a C₆-C₆₀ aryl group, a C₇-C₆₀ alkyl aryl group, a C₆-C₆₀ aryloxy group, a C₆-C₆₀ arylthio group, a C₁-C₆₀ heteroaryl group, a C₂-C₆₀ alkyl heteroaryl group, a C₁-C₆₀ heteroaryloxy group, a C₁-C₆₀ heteroarylthio group, a monovalent non-aromatic condensed polycyclic group, a monovalent non-aromatic condensed heteropolycyclic group, a C₁-C₆₀ alkyl group that is substituted with at least one selected from deuterium, -F, a cyano group, a C₁-C₆₀ alkyl group, and a C₆-C₆₀ aryl group, and a C₆-C₆₀ aryl group that is substituted with at least one selected from deuterium, -F, a cyano group, a C₁-C₆₀ alkyl group, and a C₆-C₆₀ aryl group.

10. The organic light-emitting device of any of claims 2-8, wherein the sensitizer satisfies Condition 7:
<Condition 7> ΔE_{ST} ≤ 0.3 eV
wherein, in Condition 7,
ΔE_{ST} is the difference between the lowest excitation singlet energy level and the lowest excitation triplet energy level of the sensitizer.

11. The organic light-emitting device of any of claims 2-8 or 10, wherein the sensitizer is represented by Formula 201 or 202: 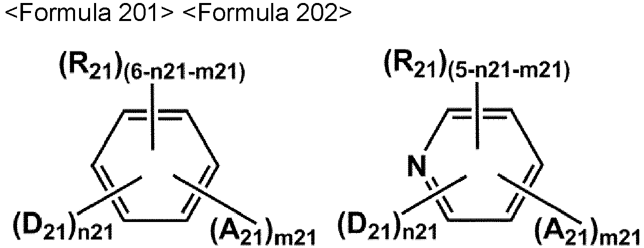 wherein, in Formulae 201 and 202,
A₂₁ is an acceptor group,
D₂₁ is a donor group,
m21 is1, 2, or 3, and n21 is1, 2, or 3,
the sum of n21 and m21 in Formula 201 is 6 or less, and the sum of n21 and m21 in Formula 202 is 5 or less,
R₂₁ is selected from hydrogen, deuterium, -F, -CI, -Br, -I, SF₅, a hydroxyl group, a cyano group, a nitro group, an amidino group, a hydrazine group, a hydrazone group, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₇-C₆₀ alkylaryl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted C₂-C₆₀ alkylheteroaryl group, a substituted or unsubstituted C₁-C₆₀heteroaryloxy group, a substituted or unsubstituted C₁-C₆₀ heteroarylthio group, a substituted or unsubstituted monovalent non-aromatic condensed polycyclic group, a substituted or unsubstituted monovalent non-aromatic condensed heteropolycyclic group, -Si(Q₁)(Q₂)(Q₃), - B(Q₁)(Q₂), -N(Q₁)(Q₂), -P(Q₁)(Q₂), -C(=O)(Q₁), -S(=O)(Q₁), -S(=O)₂(Q₁), - P(=O)(Q₁)(Q₂), and -P(=S)(Q₁)(Q₂), a plurality of R₂₁ are optionally linked together to form a substituted or unsubstituted C₅-C₃₀ carbocyclic group or a substituted or unsubstituted C₁-C₃₀ heterocyclic group,
Q₁ to Q₃ are each independently selected from hydrogen, deuterium, -F, -CI, - Br, -I, a hydroxyl group, a cyano group, a nitro group, an amidino group, a hydrazine group, a hydrazone group, a C₁-C₆₀ alkyl group, a C₂-C₆₀ alkenyl group, a C₂-C₆₀ alkynyl group, a C₁-C₆₀ alkoxy group, a C₃-C₁₀ cycloalkyl group, a C₁-C₁₀ heterocycloalkyl group, a C₃-C₁₀ cycloalkenyl group, a C₁-C₁₀heterocycloalkenyl group, a C₆-C₆₀ aryl group, a C₇-C₆₀ alkyl aryl group, a C₆-C₆₀ aryloxy group, a C₆-C₆₀ arylthio group, a C₁-C₆₀ heteroaryl group, a C₂-C₆₀ alkyl heteroaryl group, a C₁-C₆₀ heteroaryloxy group, a C₁-C₆₀ heteroarylthio group, a monovalent non-aromatic condensed polycyclic group, a monovalent non-aromatic condensed heteropolycyclic group, a C₁-C₆₀ alkyl group that is substituted with at least one selected from deuterium, -F, a cyano group, a C₁-C₆₀ alkyl group, and a C₆-C₆₀ aryl group, and a C₆-C₆₀ aryl group that is substituted with at least one selected from deuterium, -F, a cyano group, a C₁-C₆₀ alkyl group, and a C₆-C₆₀ aryl group;
preferably wherein
A₂₁ is a substituted or unsubstituted π electron-deficient nitrogen-free cyclic group;
D₂₁ is selected from:
-F, a cyano group, and a π-electron deficient nitrogen-containing cyclic group;
a C₁-C₆₀ alkyl group, a π-electron deficient nitrogen-containing cyclic group, and a π electron-deficient nitrogen-free cyclic group, each substituted with at least one selected from -F and a cyano group; and
a π-electron deficient nitrogen-containing cyclic group, each substituted with at least one selected from deuterium, a C₁-C₆₀ alkyl group, a π-electron deficient nitrogen-containing cyclic group, and a π electron-deficient nitrogen-free cyclic group;
the π electron-deficient nitrogen-free cyclic group is selected from a benzene group, a heptalene group, an indene group, a naphthalene group, an azulene group, an indacene group, acenaphthylene group, a fluorene group, a spiro-bifluorene group, a benzofluorene group, a dibenzofluorene group, a phenalene group, a phenanthrene group, an anthracene group, a fluoranthene group, a triphenylene group, a pyrene group, a chrysene group, a naphthacene group, a picene group, a perylene group, a pentacene group, a hexacene group, a pentaphene group, a rubicene group, a coronene group, an ovalene group, a pyrrole group, an isoindole group, an indole group, a furan group, a thiophene group, a benzofuran group, a benzothiophene group, a benzocarbazole group, a dibenzocarbazole group, a dibenzofuran group, a dibenzothiophene group, a dibenzothiophene sulfone group, a carbazole group, a dibenzosilole group, an indenocarbazole group, an indolocarbazole group, a benzofurocarbazole group, a benzothienocarbazole group, a triindolobenzene group; and a condensed cyclic group of two or more π electron-deficient nitrogen-free cyclic groups, and
the π electron-deficient nitrogen-containing cyclic group is a cyclic group having at least one *-N=*' moiety, and is selected from an imidazole group, a pyrazole group, a thiazole group, an isothiazole group, an oxazole group, an isoxazole group, a pyridine group, a pyrazine group, a pyridazine group, a pyrimidine group, an indazole group, a purine group, a quinoline group, an isoquinoline group, a benzoquinoline group, a phthalazine group, a naphthyridine group, a quinoxaline group, a quinazoline group, a cinnoline group, a phenanthridine group, an acridine group, a phenanthroline group, a phenazine group, a benzimidazole group, an isobenzothiazole group, a benzoxazole group, an isobenzoxazole group, a triazole group, a tetrazole group, an oxadiazole group, a triazine group, a thiadiazole group, an imidazopyridine group, an imidazopyrimidine group, an azacarbazole group, and a benzimidazolobenzimidazole group; and a condensed cyclic group of two or more π electron-eficient nitrogen-containing cyclic groups.

12. The organic light-emitting device of claim 1 or claim 2 further comprising:
m emission units located between the first electrode and the second electrode and including at least one emission layer; and
m-1 charge generating layers between neighboring two emission units of the m emission units and including an n-type charge generating layer and a p-type charge generating layer,
wherein
m is an integer of 2 or more, and
the maximum emission wavelength of light emitted from at least one emission unit of the m emission units is different from the maximum emission wavelength of light emitted from at least one emission unit of the remaining emission units.

13. The organic light-emitting device of claim 1 or claim 2 further comprising:
m emission layers between the first electrode and the second electrode, wherein
m is an integer of 2 or more,
the maximum emission wavelength of light emitted from at least one emission layer of the m emission layers is different from the maximum emission wavelength of light emitted from at least one emission layer of the remaining emission layers.

## Patentansprüche

1. Organische lichtemittierende Vorrichtung, umfassend:
eine erste Elektrode; eine zweite Elektrode; und eine organische Schicht zwischen der ersten Elektrode und der zweiten Elektrode;
die organische Schicht umfasst eine Emissionsschicht;
die Emissionsschicht umfasst einen Wirt, einen kühlenden Dotierstoff und einen Sensibilisator, wobei
der kühlende Dotierstoff und der Sensibilisator Bedingungen 1, 2 und 3 erfüllen und der Sensibilisator Platin (Pt) umfasst: ${T}_{Zerfall} \left(CD\right) < {T}_{Zerfall} \left(S\right)$ ${T}_{Zerfall} \left(CD\right) < 1,5 μs$ ${T}_{Zerfall} \left(CD\right) / {T}_{Zerfall} \left(S\right) < 0,5$ wobei, unter den Bedingungen 1, 2 und 3,
T_{Zerfall}(CD) die Zerfallszeit des kühlenden Dotierstoffs ist, und
T_{Zerfall}(S) eine Zerfallszeit des Sensibilisators ist;
wobei die Zerfallszeit des kühlenden Dotierstoffs aus einem zeitaufgelösten Photolumineszenzspektrum bei Raumtemperatur in Bezug auf einen 40 nm starken Film berechnet wird, der durch Co-Vakuumabscheidung des Wirts und des in der Emissionsschicht enthaltenen Dotierstoffs in dem Gewichtsverhältnis von 90:10 auf einem Quarzsubstrat bei einem Vakuumgrad von 10⁻⁷ Torr erlangt wird, und die Zerfallszeit des Sensibilisators aus dem zeitaufgelösten Photolumineszenzspektrum bei Raumtemperatur in Bezug auf einen 40 nm starken Film berechnet wird, der durch Co-Vakuumabscheidung des Wirts und des in der Emissionsschicht enthaltenen Sensibilisators in dem Gewichtsverhältnis von 90:10 auf einem Quarzsubstrat bei einem Vakuumgrad von 10⁻⁷ Torr erlangt wird.

2. Organische lichtemittierende Vorrichtung, umfassend:
eine erste Elektrode; eine zweite Elektrode; und eine organische Schicht zwischen der ersten Elektrode und der zweiten Elektrode;
die organische Schicht umfasst eine Emissionsschicht;
die Emissionsschicht umfasst einen Wirt, einen kühlenden Dotierstoff und einen Sensibilisator, wobei
der kühlende Dotierstoff und der Sensibilisator Bedingungen 1, 2 und 3 erfüllen und
der Sensibilisator einen thermisch aktivierten, verzögerten Fluoreszenzemitter umfasst, und
der thermisch aktivierte verzögerte Fluoreszenzemitter kein Metall beinhaltet: ${T}_{Zerfall} \left(CD\right) < {T}_{Zerfall} \left(S\right)$ ${T}_{Zerfall} \left(CD\right) < 1 ,5 μ s$ ${T}_{Zerfall} \left(CD\right) / {T}_{Zerfall} \left(S\right) < 0,5 ,$ wobei in Bedingungen 1, 2 und 3,
T_{Zerfall}(CD) die Zerfallszeit des kühlenden Dotierstoffs ist, und
T_{Zerfall}(S) eine Zerfallszeit des Sensibilisators ist;
wobei die Zerfallszeit des kühlenden Dotierstoffs aus einem zeitaufgelösten Photolumineszenzspektrum bei Raumtemperatur in Bezug auf einen 40 nm starken Film berechnet wird, der durch Co-Vakuumabscheidung des Wirts und des in der Emissionsschicht enthaltenen Dotierstoffs in dem Gewichtsverhältnis von 90:10 auf einem Quarzsubstrat bei einem Vakuumgrad von 10⁻⁷ Torr erlangt wird, und die Zerfallszeit des Sensibilisators aus dem zeitaufgelösten Photolumineszenzspektrum bei Raumtemperatur in Bezug auf einen 40 nm starken Film berechnet wird, der durch Co-Vakuumabscheidung des Wirts und des in der Emissionsschicht enthaltenen Sensibilisators in dem Gewichtsverhältnis von 90:10 auf einem Quarzsubstrat bei einem Vakuumgrad von 10⁻⁷ Torr erlangt wird.

3. Organische lichtemittierende Vorrichtung nach Anspruch 1 oder Anspruch 2, wobei die organische lichtemittierende Vorrichtung ferner Bedingung 4 erfüllt: $BDE \left(S\right) - {T}_{1} \left(S\right) < 3,0 eV$ wobei, in Bedingung 4,
BDE (S) das Bindungsdissoziation-Energieniveau des Sensibilisators ist und T1 (S) das niedrigste Triplett-Erregungsenergieniveau des Sensibilisators ist; und/oder wobei die organische lichtemittierende Vorrichtung ferner Bedingung 5 erfüllt: $R \left(Hex\right) / {e}^{10} < 15$ wobei in Bedingung 5,
R (Hex) die Produktionsrate heißer Exzitonen ist; und/oder wobei
der Wirt, der Dotierstoff und der Sensibilisator ferner Bedingung 6 erfüllen: ${T}_{1} \left(H\right) \geq {T}_{1} \left(S\right) \geq {S}_{1} \left(CD\right)$ wobei, in Bedingung 6,
T₁(H) das niedrigste Triplett-Erregungsenergieniveau des Wirts ist,
T₁(S) das niedrigste Triplett-Erregungsenergieniveau des Sensibilisators ist, und
S₁(CD) das niedrigste Singulett-Erregungsenergieniveau des kühlenden Dotierstoffs ist.

4. Organische lichtemittierende Vorrichtung nach einem der Ansprüche 1 bis 3, wobei die Emissionsschicht aus dem Wirt, dem kühlenden Dotierstoff und dem Sensibilisator besteht.

5. Organische lichtemittierende Vorrichtung nach einem der Ansprüche 1 bis 4, wobei der Wirt einen amphiprotischen Wirt, einen Elektronentransportwirt und/oder einen Lochtransportwirt umfasst, der Elektronentransportwirt mindestens eine Elektronentransportgruppierung umfasst, der Lochtransportwirt keine Elektronentransportgruppierung beinhaltet, wobei die Elektronentransportgruppierung ausgewählt ist aus einer Cyanogruppe, einer π-elektronenarmen stickstoffhaltigen cyclischen Gruppe und einer Gruppe, die durch eine der folgenden Formeln dargestellt ist: 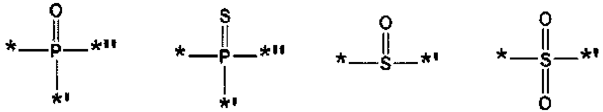 wobei ^{∗}, ^{∗}' und ^{∗}" in den obigen Formeln jeweils eine Bindungsstelle zu einem benachbarten Atom sind.

6. Organische lichtemittierende Vorrichtung nach Anspruch 5, wobei der Elektronentransportwirt mindestens eine π-elektronenarme stickstofffreie cyclische Gruppe und mindestens eine Elektronentransportgruppierung umfasst,
der Lochtransportwirt mindestens eine π-elektronenarme stickstofffreie cyclische Gruppe umfasst und keine Elektronentransportgruppierung beinhaltet, und
die Elektronentransportgruppierung eine Cyanogruppe oder eine π-elektronenarme stickstoffhaltige cyclische Gruppe ist; vorzugsweise wobei
die π-elektronenarme stickstoffhaltige cyclische Gruppe ausgewählt ist aus: einer Imidazolgruppe, einer Pyrazolgruppe, einer Thiazolgruppe, einer Isothiazolgruppe, einer Oxazolgruppe, einer Isoxazolgruppe, einer Pyridingruppe, einer Pyrazingruppe, einer Pyridazingruppe, einer Pyrimidingruppe, einer Indazolgruppe, einer Puringruppe, einer Chinolingruppe, einer Isochinolingruppe, einer Benzochinolingruppe, einer Phthalazingruppe, einer Naphthyridingruppe, einer Chinoxalingruppe, einer Chinazolingruppe, einer Cinnolingruppe, einer Phenanthridingruppe, einer Acridingruppe, einer Phenanthrolingruppe, einer Phenazingruppe, einer Benzimidazolgruppe, einer Isobenzothiazolgruppe, einer Benzoxazolgruppe, einer Isobenzoxazolgruppe, einer Triazolgruppe, einer Tetrazolgruppe, einer Oxadiazolgruppe, einer Triazingruppe, einer Thiadiazolgruppe, einer Imidazopyridingruppe, einer Imidazopyrimidingruppe und einer Azacarbazolgruppe; und einer kondensierten cyclischen Gruppe, in der zwei oder mehrere π-elektronenarme stickstoffhaltige cyclische Gruppen,
die π-elektronenarme stickstofffreie cyclische Gruppe ausgewählt ist aus einer Benzolgruppe, einer Heptalinengruppe, einer Indengruppe, einer Naphthalingruppe, einer Azulengruppe, einer Indacengruppe, einer Acenaphthylengruppe, einer Fluorengruppe, einer Spirobifluorengruppe, einer Benzofluorengruppe, einer Dibenzofluorengruppe, einer Phenalengruppe, einer Phenanthrengruppe, einer Anthracengruppe, einer Fluoranthengruppe, einer Triphenylengruppe, einer Pyrengruppe, einer Chrysengruppe, einer Naphthacengruppe, einer Picengruppe, einer Perylengruppe, einer Pentacengruppe, einer Hexacengruppe, einer Pentaphengruppe, einer Rubinengruppe, einer Coronengruppe, einer Ovalengruppe, einer Pyrrolgruppe, einer Isoindolgruppe, einer Indolgruppe, einer Furangruppe, einer Thiophengruppe, einer Benzofurangruppe, einer Benzothiophengruppe, einer Benzocarbazolgruppe, einer Dibenzocarbazolgruppe, einer Dibenzofurangruppe, einer Dibenzothiophengruppe, einer Dibenzothiophensulfongruppe, einer Carbazolgruppe, einer Dibenzosilolgruppe, einer Indenocarbazolgruppe, einer Indolocarbazolgruppe, einer Benzofurocarbazolgruppe, einer Benzothienocarbazolgruppe, einer Triindolobenzolgruppe; und einer kondensierten cyclischen Gruppe aus zwei oder mehreren π-elektronenarmen stickstofffreien cyclischen Gruppen.

7. Organische lichtemittierende Vorrichtung nach Anspruch 5 oder 6, wobei der Elektronentransportwirt i) mindestens eine von einer Cyanogruppe, einer Pyrimidingruppe, einer Pyrazingruppe und einer Triazingruppe und ii) einer Triphenylengruppe umfasst und der Lochtransportwirt eine Carbazolgruppe umfasst.

8. Organische lichtemittierende Vorrichtung nach einem der Ansprüche 1 bis 7, wobei die maximale Emissionswellenlänge des Emissionsspektrums des kühlenden Dotierstoffs 400 nm oder mehr und 550 nm oder weniger ist; und/oder
wobei der kühlende Dotierstoff kein Metallatom beinhaltet; und/oder
wobei
der kühlende Dotierstoff eines von einem naphthalinhaltigen Kern, einem fluorenhaltigen Kern, einem spiro-bifluorenhaltigen Kern, einem benzofluorenhaltigen Kern, einem dibenzofluorenhaltigen Kern, einem phenanthrenhaltigen Kern, einem anthracenhaltigen Kern, einem fluoranthenhaltigen Kern, einem triphenylenhaltigen Kern, einem pyrenhaltigen Kern, einem chrysenhaltigen Kern, einem naphthacenhaltigen Kern, einem picenhaltigen Kern, einem perylenhaltigen Kern, einem pentaphenhaltigen Kern, einem indenoanthracenhaltigen Kern, einem bisanthracenhaltigen Kern und Kerne, die durch Formel 501-1 bis 501-18 dargestellt sind, umfasst:

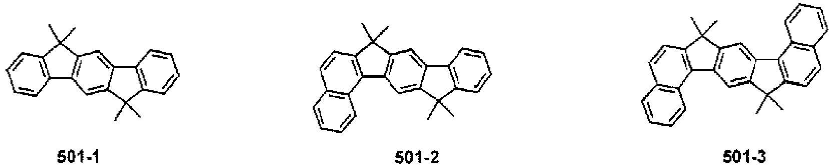

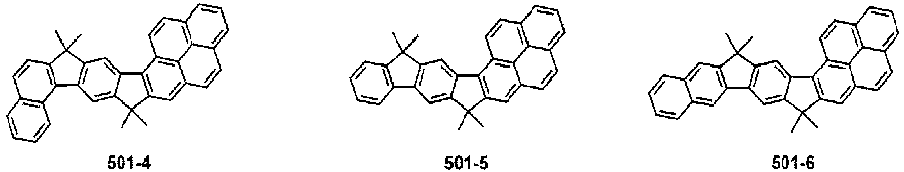

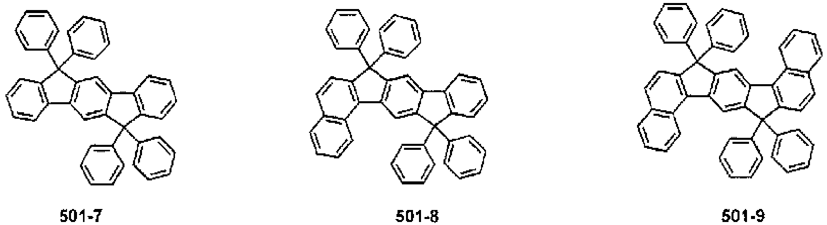

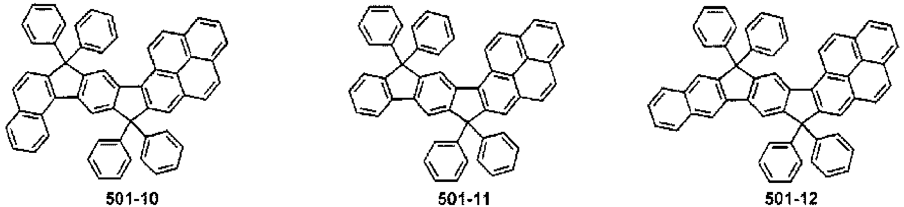

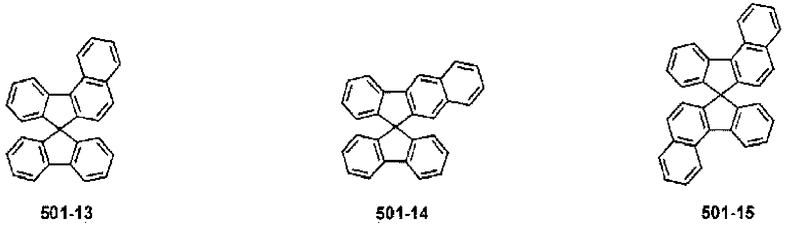

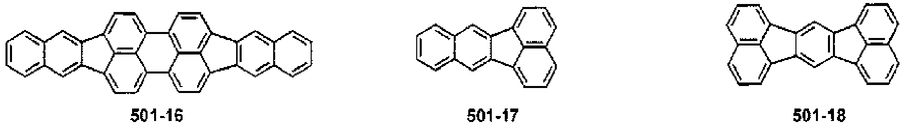

9. Organische lichtemittierende Vorrichtung nach einem der Ansprüche 1 oder 3 bis 8, wobei der Sensibilisator die durch Formel 101 dargestellte metallorganische Verbindung umfasst:
<Formel 101> Pt(L₁₁)ₙ₁₁(L₁₂)ₙ₁₂
wobei, in Formel 101,
L₁₁ ein Ligand ist, der durch eine von Formel 1-1 bis 1-4 dargestellt ist;
L₁₂ ausgewählt ist aus einem einzähnigen Liganden und einem zweizähnigen Liganden; n11 1 ist,
n12 ausgewählt ist aus 0, 1 und 2; 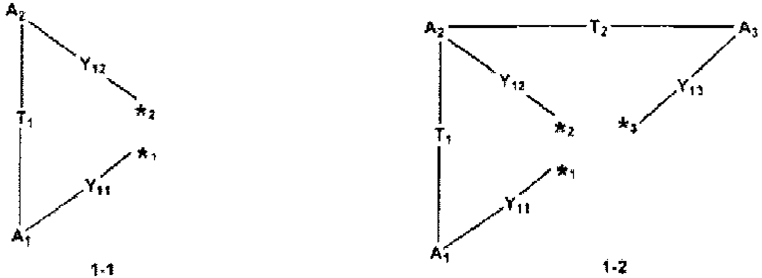 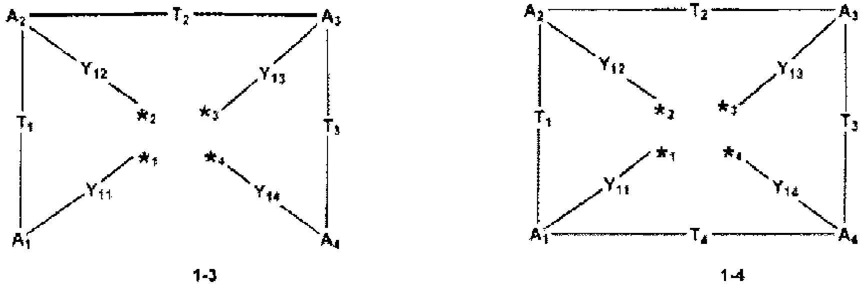 wobei, in Formel 1-1 bis 1-4,
A₁ bis A₄ jeweils unabhängig ausgewählt sind aus einer substituierten oder unsubstituierten carbocyclischen C₅-C₃₀ Gruppe, einer substituierten oder unsubstituierten heterocyclischen C₁-C₃₀ Gruppe und einer nicht-cyclischen Gruppe,
Y₁₁ bis Y₁₄ jeweils unabhängig eine chemische Bindung, O, S, N(R₉₁), B(R₉₁), P(R₉₁), oder C(R₉₁)(R₉₂) sind,
T₁ bis T₄ jeweils unabhängig ausgewählt sind aus einer Einfachbindung, einer Doppelbindung, ^{∗}-N(R₉₃)-^{∗}', ^{∗}-B(R₉₃)-^{∗}', ^{∗}-P(R₉₃)-^{∗}', ^{∗}-C(R₉₃)(R₉₄)-^{∗}', ^{∗}-Si(R₉₃)(R₉₄)-^{∗}', ^{∗}-Ge(R₉₃)(R₉₄)-^{∗}', ^{∗}-S-^{∗}', ^{∗}-Se-^{∗}', ^{∗}-O-^{∗}', ^{∗}-C(=O)-^{∗}', ^{∗}-S(=O)-^{∗}', ^{∗}-S(=O)₂-^{∗}', ^{∗}-C(R₉₃)=^{∗}', ^{∗}=C(R₉₃)-^{∗}', ^{∗}-C(R₉₃)=C(R₉₄)-^{∗}', ^{∗}-C(=S)-^{∗}' und ^{∗}-C=C-^{∗}',
ein Substituent der substituierten carbocyclischen C₅-C₃₀ Gruppe, ein Substituent der substituierten heterocyclischen C₁-C₃₀ Gruppe, und R₉₁ bis R₉₄ jeweils unabhängig ausgewählt sind aus Wasserstoff, Deuterium, -F, -Cl, -Br, -I, -SF₅, einer Hydroxylgruppe, einer Cyanogruppe, einer Nitrogruppe, einer Amidinogruppe, einer Hydrazingruppe, einer Hydrazongruppe, einer Carbonsäure oder einem Salz davon, einer Sulfonsäure oder einem Salz davon, einer Phosphorsäure oder einem Salz davon, einer substituierten oder unsubstituierten C₁-C₆₀-Alkylgruppe, einer substituierten oder unsubstituierten C₂-C₆₀-Alkenylgruppe, einer substituierten oder unsubstituierten C₂-C₆₀-Alkinylgruppe, einer substituierten oder unsubstituierten C₁-C₆₀-Alkoxygruppe, einer substituierten oder unsubstituierten C₃-C₁₀-Cycloalkylgruppe, einer substituierten oder unsubstituierten C₁-C₁₀-Heterocycloalkylgruppe, einer substituierten oder unsubstituierten C₃-C₁₀-Cycloalkenylgruppe, einer substituierten oder unsubstituierten C₁-C₁₀-Heterocycloalkenylgruppe, einer substituierten oder unsubstituierten C₆-C₆₀-Arylgruppe, einer substituierten oder unsubstituierten C₆-C₆₀-Aryloxygruppe, einer substituierten oder unsubstituierten C₆-C₆₀-Arylthiogruppe, einer substituierten oder unsubstituierten C₁-C₆₀-Heteroarylgruppe, einer substituierten oder unsubstituierten monovalenten nicht-aromatischen kondensierten polycyclischen Gruppe, einer substituierten oder unsubstituierten monovalenten nicht-aromatischen kondensierten heteropolycyclischen Gruppe, -Si(Q₁)(Q₂)(Q₃), -B(Q₁)(Q₂), - N(Q₁)(Q₂), - P(Q₁)(Q₂), -C(=O)(Q₁), -S(=O)(Q₁), -S(=O)₂(Q₁), -P(=O)(Q₁)(Q₂) und - P(=S)(Q₁)(Q₂), wobei jeder von einem Substituenten der substituierten carbocyclischen C₅-C₃₀gruppe und einem Substituenten der substituierten heterocyclischen C₁-C₃₀gruppe nicht Wasserstoff ist,
^{∗}₁, ^{∗}₂, ^{∗}₃, und ^{∗}₄ jeweils eine Bindungsstelle für Pt angeben, und
Q₁ bis Q₃ jeweils unabhängig ausgewählt sind aus Wasserstoff, Deuterium, -F, -CI, - Br, - I, einer Hydroxylgruppe, einer Cyanogruppe, einer Nitrogruppe, einer Amidinogruppe, einer Hydrazingruppe, einer Hydrazongruppe, einer C₁-C₆₀-Alkylgruppe, einer C₂-C₆₀-Alkenylgruppe, einer C₂-C₆₀-Alkinylgruppe, einer C₁-C₆₀-Alkoxygruppe, einer C₃-C₁₀-Cycloalkylgruppe, einer C₁-C₁₀-Heterocycloalkylgruppe, einer C₃-C₁₀-Cycloalkenylgruppe, einer C₁-C₁₀-Heterocycloalkenylgruppe, einer C₆-C₆₀-Arylgruppe, einer C₇-C₆₀-Alkyl-Arylgruppe, einer C₆-C₆₀-Aryloxygruppe, einer C₆-C₆₀-Arylthiogruppe, einer C₁-C₆₀-Heteroarylgruppe, einer C₂-C₆₀-Alkyl-Heteroarylgruppe, einer C₁-C₆₀-Heteroaryloxygruppe, einer C₁-C₆₀-Heteroarylthiogruppe, einer monovalenten nicht-aromatischen kondensierten polycyclischen Gruppe, einer monovalenten nicht-aromatischen kondensierten heteropolycyclischen Gruppe, einer C₁-C₆₀-Alkylgruppe, die mit mindestens einem, ausgewählt aus Deuterium, -F, einer Cyanogruppe, einer C₁-C₆₀-Alkylgruppe und einer C₆-C₆₀-Arylgruppe substituiert ist, und einer C₆- C₆₀-Arylgruppe, die mit mindestens einem, ausgewählt aus Deuterium, -F, einer Cyanogruppe, einer C₁-C₆₀-Alkylgruppe und einer C₆-C₆₀-Arylgruppe substituiert ist.

10. Organische lichtemittierende Vorrichtung nach einem der Ansprüche 2 bis 8, wobei der Sensibilisator Bedingung 7 erfüllt: $Δ {E}_{ST} \leq 0,3 eV$ wobei, in Bedingung 7,
ΔE_{ST} die Differenz zwischen dem niedrigsten Singulett-Erregungsenergieniveau und dem niedrigsten Triplett-Erregungsenergieniveau des Sensibilisators ist.

11. Organische lichtemittierende Vorrichtung nach einem der Ansprüche 2-8 oder 10, wobei der Sensibilisator durch Formel 201 oder 202 dargestellt ist: 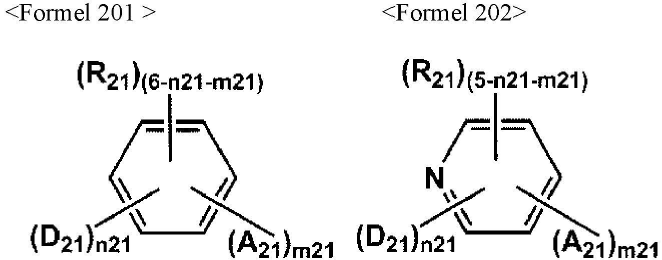 wobei, in Formeln 201 und 202,
A₂₁ eine Akzeptorgruppe ist,
D₂₁ eine Donorgruppe ist,
m21 1, 2 oder 3 ist und n21 1, 2 oder 3 ist,
die Summe von n21 und m21 in Formel 201 6 oder weniger ist und die Summe von n21 und m21 in Formel 202 5 oder weniger ist,
R₂₁ ausgewählt ist aus Wasserstoff, Deuterium, -F, -Cl, -Br, -I, SF₅, einer Hydroxylgruppe, einer Cyanogruppe, einer Nitrogruppe, einer Amidinogruppe, einer Hydrazingruppe, einer Hydrazongruppe, einer substituierten oder unsubstituierten C₁-C₆₀-Alkylgruppe, einer substituierten oder unsubstituierten C₂-C₆₀-Alkenylgruppe, einer substituierten oder unsubstituierten C₂-C₆₀-Alkinylgruppe, einer substituierten oder unsubstituierten C₁-C₆₀-Alkoxygruppe, einer substituierten oder unsubstituierten C₃-C₁₀-Cycloalkylgruppe, einer substituierten oder unsubstituierten C₁-C₁₀-Heterocycloalkylgruppe, einer substituierten oder unsubstituierten C₃-C₁₀-Cycloalkenylgruppe, einer substituierten oder unsubstituierten C₁-C₁₀-Heterocycloalkenylgruppe, einer substituierten oder unsubstituierten C₆-C₆₀-Arylgruppe, einer substituierten oder unsubstituierten C₇-C₆₀-Alkylarylgruppe, einer substituierten oder unsubstituierten C₆-C₆₀-Aryloxygruppe, einer substituierten oder unsubstituierten C₆-C₆₀-Arylthiogruppe, einer substituierten oder unsubstituierten C₁-C₆₀-Heteroarylgruppe, einer substituierten oder unsubstituierten C₂-C₆₀-Alkylheteroarylgruppe, einer substituierten oder unsubstituierten C₁-C₆₀-Heteroaryloxygruppe, einer substituierten oder unsubstituierten C₁-C₆₀-Heteroarylthiogruppe, einer substituierten oder unsubstituierten monovalenten nicht-aromatischen kondensierten polycyclischen Gruppe, einer substituierten oder unsubstituierten monovalenten nicht-aromatischen kondensierten heteropolycyclischen Gruppe, -Si(Q₁)(Q₂)(Q₃), - B(Q₁)(Q₂), - N(Q₁)(Q₂), -P(Q₁)(Q₂), -C(=O)(Q₁), -S(=O)(Q₁), -S(=O)₂(Q₁), -P(=O)(Q₁)(Q₂) und - P(=S)(Q₁)(Q₂), wobei eine Vielzahl von R₂₁ optional miteinander verbunden ist, um eine substituierte oder unsubstituierte carbocyclische C₅-C₃₀gruppe oder eine substituierte oder unsubstituierte heterocyclische C₁-C₃₀gruppe zu bilden,
Q₁ bis Q₃ jeweils unabhängig ausgewählt sind aus Wasserstoff, Deuterium, -F, -CI, - Br, - I, einer Hydroxylgruppe, einer Cyanogruppe, einer Nitrogruppe, einer Amidinogruppe, einer Hydrazingruppe, einer Hydrazongruppe, einer C₁-C₆₀-Alkylgruppe, einer C₂-C₆₀-Alkenylgruppe, einer C₂-C₆₀-Alkinylgruppe, einer C₁-C₆₀-Alkoxygruppe, einer C₃-C₁₀-Cycloalkylgruppe, einer C₁-C₁₀-Heterocycloalkylgruppe, einer C₃-C₁₀-Cycloalkenylgruppe, einer C₁-C₁₀-Heterocycloalkenylgruppe, einer C₆-C₆₀-Arylgruppe, einer C₇-C₆₀-Alkyl-Arylgruppe, einer C₆-C₆₀-Aryloxygruppe, einer C₆-C₆₀-Arylthiogruppe, einer C₁-C₆₀-Heteroarylgruppe, einer C₂-C₆₀-Alkyl-Heteroarylgruppe, einer C₁-C₆₀-Heteroaryloxygruppe, einer C₁-C₆₀-Heteroarylthiogruppe, einer monovalenten nicht-aromatischen kondensierten polycyclischen Gruppe, einer monovalenten nicht-aromatischen kondensierten heteropolycyclischen Gruppe, einer C₁-C₆₀-Alkylgruppe, die mit mindestens einem, ausgewählt aus Deuterium, -F, einer Cyanogruppe, einer C₁-C₆₀-Alkylgruppe und einer C₆-C₆₀-Arylgruppe substituiert ist, und einer C₆- C₆₀-Arylgruppe, die mit mindestens einem, ausgewählt aus Deuterium, -F, einer Cyanogruppe, einer C₁-C₆₀-Alkylgruppe und einer C₆-C₆₀-Arylgruppe substituiert ist; vorzugsweise wobei
A₂₁ eine substituierte oder unsubstituierte π-elektronenarme stickstofffreie cyclische Gruppe ist;
D₂₁ ausgewählt ist aus:
- F, einer Cyanogruppe und einer π-elektronenarmen stickstoffhaltigen cyclischen Gruppe;
einer C₁-C₆₀-Alkylgruppe, einer π-elektronenarmen stickstoffhaltigen cyclischen Gruppe und einer π-elektronenarmen stickstofffreien cyclischen Gruppe, jeweils substituiert mit mindestens einem, ausgewählt aus -F und einer Cyanogruppe; und
einer π-elektronenarmen stickstoffhaltigen cyclischen Gruppe, jeweils substituiert mit mindestens einem, ausgewählt aus Deuterium, einer C₁-C₆₀-Alkylgruppe, einer π-elektronenarmen stickstoffhaltigen cyclischen Gruppe und einer π-elektronenarmen stickstofffreien cyclischen Gruppe;
die π-elektronenarme stickstofffreie cyclische Gruppe ausgewählt ist aus einer Benzolgruppe, einer Heptalinengruppe, einer Indengruppe, einer Naphthalingruppe, einer Azulengruppe, einer Indacengruppe, einer Acenaphthylengruppe, einer Fluorengruppe, einer Spirobifluorengruppe, einer Benzofluorengruppe, einer Dibenzofluorengruppe, einer Phenalengruppe, einer Phenanthrengruppe, einer Anthracengruppe, einer Fluoranthengruppe, einer Triphenylengruppe, einer Pyrengruppe, einer Chrysengruppe, einer Naphthacengruppe, einer Picengruppe, einer Perylengruppe, einer Pentacengruppe, einer Hexacengruppe, einer Pentaphengruppe, einer Rubinengruppe, einer Coronengruppe, einer Ovalengruppe, einer Pyrrolgruppe, einer Isoindolgruppe, einer Indolgruppe, einer Furangruppe, einer Thiophengruppe, einer Benzofurangruppe, einer Benzothiophengruppe, einer Benzocarbazolgruppe, einer Dibenzocarbazolgruppe, einer Dibenzofurangruppe, einer Dibenzothiophengruppe, einer Dibenzothiophensulfongruppe, einer Carbazolgruppe, einer Dibenzosilolgruppe, einer Indenocarbazolgruppe, einer Indolocarbazolgruppe, einer Benzofurocarbazolgruppe, einer Benzothienocarbazolgruppe, einer Triindolobenzolgruppe; und einer kondensierten cyclischen Gruppe aus zwei oder mehreren π-elektronenarmen stickstofffreien cyclischen Gruppen, und
die π-elektronenarme stickstoffhaltige cyclische Gruppe eine cyclische Gruppe ist, die mindestens eine ^{∗}-N=^{∗}'-Gruppierung aufweist, und die ausgewählt ist aus einer Imidazolgruppe, einer Pyrazolgruppe, einer Thiazolgruppe, einer Isothiazolgruppe, einer Oxazolgruppe, einer Isoxazolgruppe, einer Pyridingruppe, einer Pyrazingruppe, einer Pyridazingruppe, einer Pyrimidingruppe, einer Indazolgruppe, einer Puringruppe, einer Chinolingruppe, einer Isochinolingruppe, einer Benzochinolingruppe, einer Phthalazingruppe, einer Naphthyridingruppe, einer Chinoxalingruppe, einer Chinazolingruppe, einer Cinnolingruppe, einer Phenanthridingruppe, einer Acridingruppe, einer Phenanthrolingruppe, einer Phenazingruppe, einer Benzimidazolgruppe, einer Isobenzothiazolgruppe, einer Benzoxazolgruppe, einer Isobenzoxazolgruppe, einer Triazolgruppe, einer Tetrazolgruppe, einer Oxadiazolgruppe, einer Triazingruppe, einer Thiadiazolgruppe, einer Imidazopyridingruppe, einer Imidazopyrimidingruppe, einer Azacarbazolgruppe, und einer Bezimidazolobenzimidazolgruppe; und einer kondensierten cyclischen Gruppe aus zwei oder mehreren π-elektronenefizienten stickstoffhaltigen cyclischen Gruppen.

12. Organische lichtemittierende Vorrichtung nach Anspruch 1 oder Anspruch 2, ferner umfassend:
m Emissionseinheiten, die sich zwischen der ersten Elektrode und der zweiten Elektrode befinden und mindestens eine Emissionsschicht beinhalten; und
m-1 Ladungserzeugungsschichten zwischen zwei benachbarten Emissionseinheiten der m Emissionseinheiten und einschließlich einer n-Ladungserzeugungsschicht und einer p-Ladungserzeugungsschicht, wobei
m eine ganze Zahl von 2 oder mehr ist, und
sich die maximale Emissionswellenlänge des von mindestens einer Emissionseinheit der m Emissionseinheiten emittierten Lichts von der maximalen Emissionswellenlänge des von mindestens einer Emissionseinheit der übrigen Emissionseinheiten emittierten Lichts unterscheidet.

13. Organische lichtemittierende Vorrichtung nach Anspruch 1 oder Anspruch 2, ferner umfassend:
m Emissionsschichten zwischen der ersten Elektrode und der zweiten Elektrode, wobei
m eine ganze Zahl von 2 oder mehr ist,
sich die maximale Emissionswellenlänge des von mindestens einer Emissionsschicht der m Emissionsschichten emittierten Lichts von der maximalen Emissionswellenlänge des von mindestens einer Emissionsschicht der übrigen Emissionsschichten emittierten Lichts unterscheidet.

## Revendications

1. Dispositif électroluminescent organique, comprenant :
une première électrode ; une seconde électrode et une couche organique entre la première électrode et la seconde électrode ;
la couche organique comprend une couche d'émission ;
la couche d'émission comprend un hôte, un dopant de refroidissement et un sensibilisateur, dans lequel
le dopant de refroidissement et le sensibilisateur satisfont les conditions 1, 2 et 3, et
le sensibilisateur comprend du platine (Pt) : ${T}_{décroissance} \left(CD\right) < {T}_{décroissance} \left(S\right)$ ${T}_{décroissance} \left(CD\right) < 1,5 μ S$ ${T}_{décroissance} \left(CD\right) / {T}_{décroissance} \left(S\right) < 0,5$ dans lequel, dans les conditions 1, 2 et 3,
T_{décroissance}(CD) est un temps de décroissance du dopant de refroidissement, et
T_{décroissance}(S) est un temps de décroissance du sensibilisateur ;
dans lequel le temps de décroissance du dopant de refroidissement est calculé à partir d'un spectre de photoluminescence résolu dans le temps à température ambiante par rapport à un film de 40 nm d'épaisseur obtenu par codéposition sous vide de l'hôte et du dopant compris dans la couche d'émission au rapport en poids de 90:10 sur un substrat de quartz au degré de vide de 10⁻⁷ torr, et le temps de décroissance du sensibilisateur est calculé à partir du spectre de photoluminescence résolu dans le temps à température ambiante par rapport à un film de 40 nm d'épaisseur obtenu par codéposition sous vide de l'hôte et du sensibilisateur compris dans la couche d'émission au rapport en poids de 90:10 sur un substrat de quartz au degré de vide de 10⁻⁷ torr.

2. Dispositif électroluminescent organique, comprenant :
une première électrode ; une seconde électrode et une couche organique entre la première électrode et la seconde électrode ;
la couche organique comprend une couche d'émission ;
la couche d'émission comprend un hôte, un dopant de refroidissement et un sensibilisateur, dans lequel
le dopant de refroidissement et le sensibilisateur satisfont les conditions 1, 2 et 3, et
le sensibilisateur comprend un émetteur de fluorescence retardé activé thermiquement, et
l'émetteur de fluorescence retardé activé thermiquement ne comprend pas de métal : ${T}_{décroissance} \left(CD\right) < {T}_{décroissance} \left(S\right)$ ${T}_{décroissance} \left(CD\right) < 1,5 μ S$ ${T}_{décroissance} \left(CD\right) / {T}_{décroissance} \left(S\right) < 0,5$
où, dans les conditions 1, 2 et 3,
T_{décroissance}(CD) est un temps de décroissance du dopant de refroidissement, et
T_{décroissance}(S) est un temps de décroissance du sensibilisateur ;
dans lequel le temps de décroissance du dopant de refroidissement est calculé à partir d'un spectre de photoluminescence résolu dans le temps à température ambiante par rapport à un film de 40 nm d'épaisseur obtenu par codéposition sous vide de l'hôte et du dopant compris dans la couche d'émission au rapport en poids de 90:10 sur un substrat de quartz au degré de vide de 10⁻⁷ torr, et le temps de décroissance du sensibilisateur est calculé à partir du spectre de photoluminescence résolu dans le temps à température ambiante par rapport à un film de 40 nm d'épaisseur obtenu par codéposition sous vide de l'hôte et du sensibilisateur compris dans la couche d'émission au rapport en poids de 90:10 sur un substrat de quartz au degré de vide de 10⁻⁷ torr.

3. Dispositif électroluminescent organique selon la revendication 1 ou la revendication 2, dans lequel
le dispositif électroluminescent organique satisfait en outre la condition 4 : $BDE \left(S\right) - {T}_{1} \left(S\right) < 3,0 eV$ dans lequel, dans la Condition 4,
BDE (S) est le niveau d'énergie de dissociation de liaison du sensibilisateur, et
T1 (S) est le niveau d'énergie du triplet d'excitation le plus bas du sensibilisateur ; et/ou dans lequel
le dispositif électroluminescent organique satisfait en outre la condition 5 : $R \left(Hex\right) / {e}^{10} < 15$ dans lequel, dans la Condition 5,
R (Hex) est le taux de production d'excitons chauds ; et/ou dans lequel
l'hôte, le dopant et le sensibilisateur satisfont en outre la condition 6 : ${T}_{1} \left(H\right) \geq {T}_{1} \left(S\right) \geq {S}_{1} \left(CD\right)$ dans lequel, dans la Condition 6,
T₁(H) est le niveau d'énergie du triplet d'excitation le plus bas de l'hôte,
T₁(S) est le niveau d'énergie du triplet d'excitation le plus bas du sensibilisateur, et
S₁(CD) est le niveau d'énergie du singulet d'excitation le plus bas du dopant de refroidissement.

4. Dispositif électroluminescent organique selon l'une quelconque des revendications 1 à 3, dans lequel
la couche d'émission est constituée de l'hôte, du dopant de refroidissement et du sensibilisateur.

5. Dispositif électroluminescent organique selon l'une quelconque des revendications 1 à 4, dans lequel
l'hôte comprend un hôte amphiprotique, un hôte de transport d'électrons et/ou un hôte de transport de trous,
l'hôte de transport d'électrons comprend au moins un fragment de transport d'électrons,
l'hôte de transport de trous ne comprend pas de fragment de transport d'électrons,
le fragment de transport d'électrons est choisi parmi un groupe cyano, un groupe cyclique contenant de l'azote déficient en électrons π et un groupe représenté par l'une des formules suivantes : 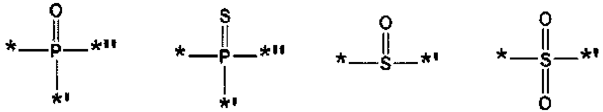 où ^{∗}, ^{∗}' et ^{∗}" dans les formules ci-dessus sont chacun un site de liaison à un atome voisin.

6. Dispositif électroluminescent organique selon la revendication 5, dans lequel
l'hôte de transport d'électrons comprend au moins un groupe cyclique exempt d'azote déficient en électrons π et au moins un fragment de transport d'électrons,
l'hôte de transport de trous comprend au moins un groupe cyclique exempt d'azote déficient en électrons π, et ne comprend pas de fragment de transport d'électrons, et
le fragment de transport d'électrons est un groupe cyano ou un groupe cyclique contenant de l'azote déficient en électrons π ;
de préférence dans lequel
le groupe cyclique contenant de l'azote déficient en électrons π est choisi parmi : un groupe imidazole, un groupe pyrazole, un groupe thiazole, un groupe isothiazole, un groupe oxazole, un groupe isoxazole, un groupe pyridine, un groupe pyrazine, un groupe pyridazine, un groupe pyrimidine, un groupe indazole, un groupe purine, un groupe quinoléine, un groupe isoquinoléine, un groupe benzoquinoléine, un groupe phtalazine, un groupe naphtyridine, un groupe quinoxaline, un groupe quinazoline, un groupe cinnoline, un groupe phénanthridine, un groupe acridine un groupe phénanthroline, un groupe phénazine, un groupe benzimidazole, un groupe isobenzothiazole, un groupe benzoxazole, un groupe isobenzoxazole, un groupe triazole, un groupe tétrazole, un groupe oxadiazole, un groupe triazine, un groupe thiadiazole, un groupe imidazopyridine, un groupe imidazopyrimidine et un groupe azacarbazole ; et un groupe cyclique condensé dans lequel deux ou plus groupes cycliques contenant de l'azote déficient en électrons π,
le groupe cyclique exempt d'azote déficient en électrons π est choisi parmi un groupe benzène, un groupe heptalène, un groupe indène, un groupe naphtalène, un groupe azulène, un groupe indacène, un groupe acénaphtylène, un groupe fluorène, un groupe spiro-bifluorène, un groupe benzofluorène, un groupe dibenzofluorène, un groupe phénalène, un groupe phénanthrène, un groupe anthracène, un groupe fluoranthène, un groupe triphénylène, un groupe pyrène, un groupe chrysène, un groupe naphtacène, un groupe picène, un groupe pérylène, un pentacène, un groupe hexacène, un groupe pentaphène, un groupe rubicène, un groupe coronène, un groupe ovalène, un groupe pyrrole, un groupe isoindole, un groupe indole, un groupe furane, un groupe thiophène, un groupe benzofurane, un groupe benzothiophène, un groupe benzocarbazole, un groupe dibenzocarbazole, un groupe dibenzofurane, un groupe dibenzothiophène, un groupe dibenzothiophène sulfone, un groupe carbazole, un groupe dibenzosilole, un groupe indénocarbazole, un groupe indolocarbazole, un groupe benzofurocarbazole, un groupe benzothiénocarbazole, un groupe triindolobenzène ; et un groupe cyclique condensé de deux ou plus groupes cycliques exempts d'azote déficients en électrons π.

7. Dispositif électroluminescent organique selon la revendication 5 ou 6, dans lequel
l'hôte de transport d'électrons comprend i) au moins l'un d'un groupe cyano, d'un groupe pyrimidine, d'un groupe pyrazine et d'un groupe triazine et ii) un groupe triphénylène, et
l'hôte de transport de trous comprend un groupe carbazole.

8. Dispositif électroluminescent organique selon l'une quelconque des revendications 1 à 7, dans lequel la longueur d'onde d'émission maximale du spectre d'émission du dopant de refroidissement est de 400 nm ou plus et de 550 nm ou moins ; et/ou
dans lequel le dopant de refroidissement ne comprend pas d'atome de métal ; et/ou
dans lequel
le dopant de refroidissement comprend l'un parmi un noyau contenant du naphtalène, un noyau contenant du fluorène, un noyau contenant du spiro-bifluorène, un noyau contenant du benzofluorène, un noyau contenant du dibenzofluorène, un noyau contenant du phénanthrène, un noyau contenant de l'anthracène, un noyau contenant du fluoranthène, un noyau contenant du triphénylène, un noyau contenant du pyrène, un noyau contenant du chrysène, un noyau contenant du naphtacène, un noyau contenant du picène, un noyau contenant du pérylène, un noyau contenant du pentaphène, un noyau contenant de l'indénoanthracène, un noyau contenant du bisanthracène et des noyaux représentés par les formules 501-1 à 501-18 :

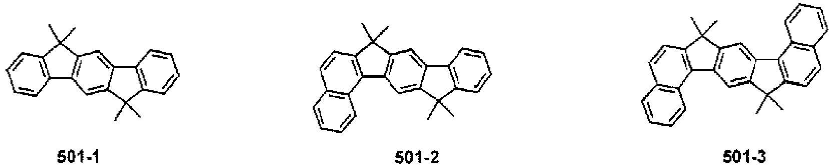

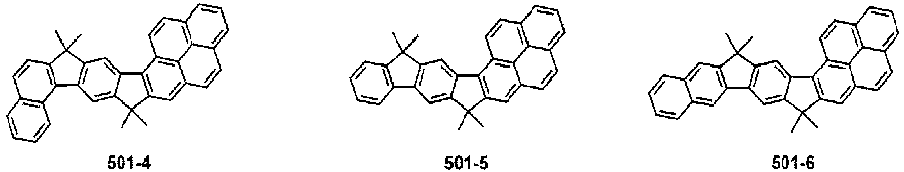

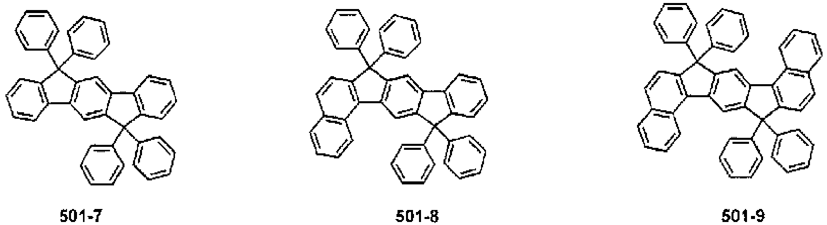

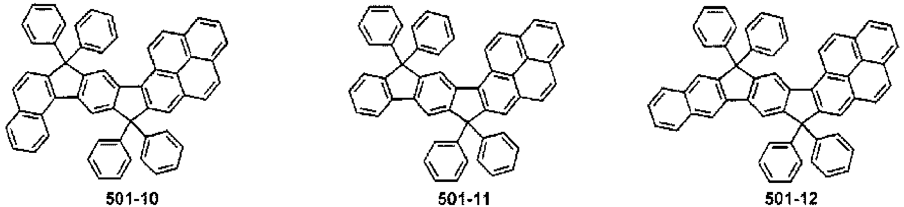

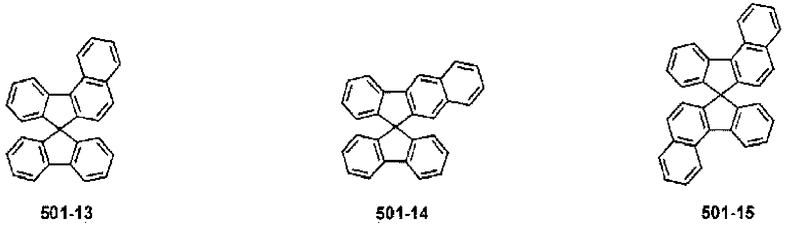

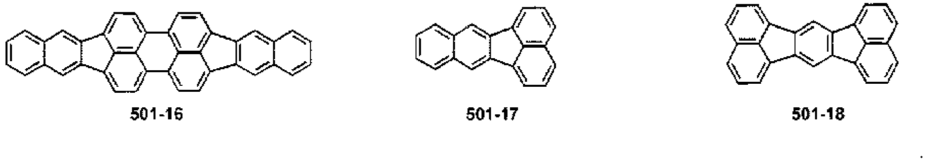

9. Dispositif électroluminescent organique selon l'une quelconque des revendications 1 ou 3 à 8, dans lequel le sensibilisateur comprend le composé organométallique représenté par la formule 101 :
<Formel 101> Pt(L₁₁)ₙ₁₁(L₁₂)ₙ₁₂
dans lequel, dans la formule 101,
L₁₁ est un ligand représenté par l'une des formules 1-1 à 1-4 ;
L₁₂ est choisi parmi un ligand monodenté et un ligand bidenté ;
n11 est 1,
n12 est choisi parmi 0, 1 et 2 ; 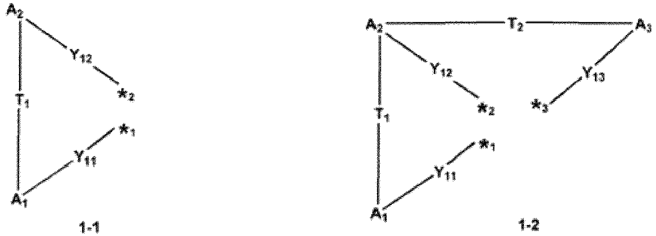 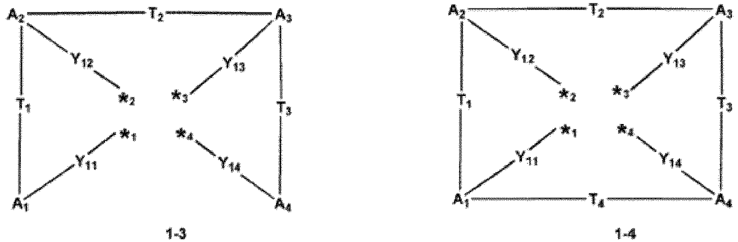 dans lequel, dans les formules 1-1 à 1-4,
A₁ à A₄ sont chacun indépendamment sélectionnés parmi un groupe carbocyclique en C₅ à C₃₀ substitué ou non substitué, un groupe hétéroyclique en C₁ à C₃₀ substitué ou non substitué, et un groupe non cyclique,
Y₁₁ à Y₁₄ sont chacun indépendamment une liaison chimique, O, S, N(R₉₁), B(R₉₁), P(R₉₁), ou C(R₉₁)(R₉₂),
T₁ à T₄ sont chacun indépendamment choisis parmi une simple liaison, une double liaison, ^{∗}-N(R₉₃)-^{∗}', ^{∗}-B(R₉₃)-^{∗}', ^{∗}-P(R₉₃)-^{∗}', ^{∗}-C(R₉₃)(R₉₄)-^{∗}', ^{∗}-Si(R₉₃)(R₉₄)-^{∗}', ^{∗}-Ge(R₉₃)(R₉₄)-^{∗}', ^{∗}-S-^{∗}', ^{∗}-Se-^{∗}', ^{∗}-O-^{∗}' ^{∗}-C(=O)-^{∗}', ^{∗}-S(=O)-^{∗}', ^{∗}-S(=O)₂-^{∗}', ^{∗}-C(R₉₃)=^{∗}', ^{∗}=C(R₉₃)-^{∗}', ^{∗}-C(R₉₃)=C(R₉₄)-^{∗}', ^{∗}-C(=S)-^{∗}', et ^{∗}-C≡C-^{∗}',
un substituant du groupe carbocyclique en C₅ à C₃₀ substitué, un substituant du groupe hétérocyclique en C₁ à C₃₀ substitué, et R₉₁ à R₉₄ sont chacun indépendamment choisis parmi l'hydrogène, le deutérium, -F, -Cl, -Br, -I, -SF₅, un groupe hydroxyle, un groupe cyano, un groupe nitro, un groupe amidino, un groupe hydrazine, un groupe hydrazone, un acide carboxylique ou un sel de celui-ci, un acide sulfonique ou un sel de celui-ci, un acide phosphorique ou un sel de celui-ci, un groupe alkyle en C₁ à C₆₀ substitué ou non substitué, un groupe alcényle en C₂ à C₆₀ substitué ou non substitué, un groupe alcynyle en C₂ à C₆₀ substitué ou non substitué, un groupe alcoxy en C₁ à C₆₀ substitué ou non substitué, un groupe cycloalkyle en C₃ à C₁₀ substitué ou non substitué, un groupe hétérocycloalkyle en C₁ à C₁₀ substitué ou non substitué, un groupe cycloalcényle en C₃ à C₁₀ substitué ou non substitué, un groupe hétérocycloalcényle en C₁ à C₁₀ substitué ou non substitué, un groupe aryle en C₆ à C₆₀ substitué ou non substitué, un groupe aryloxy en C₆ à C₆₀ substitué ou non substitué, un groupe arylthio en C₂ à C₆₀ substitué ou non substitué, un groupe hétéroaryle en C₁ à C₆₀ substitué ou non substitué, un groupe polycyclique condensé non aromatique monovalent substitué ou non substitué, un groupe hétéropolycyclique condensé non aromatique monovalent substitué ou non substitué, -Si(Q₁)(Q₂)(Q₃), -B(Q₁)(Q₂), -N(Q₁)(Q₂), - P(Q₁)(Q₂), -C(=O)(Q₁), -S(=O)(Q₁), -S(=O)₂(Q₁), -P(=O)(Q₁)(Q₂), et -P(=S)(Q₁)(Q₂), dans lequel chacun d'un substituant du groupe carbocyclique en C₅ à C₃₀ substitué et d'un substituant du groupe héterocyclique en C₁ à C₃₀ substitué n'est pas l'hydrogène,
^{∗}₁, ^{∗}₂, ^{∗}₃ et ^{∗}₄ indiquent chacun un site de liaison à Pt, et
Q₁ à Q₃, sont chacun indépendamment choisis parmi l'hydrogène, le deutérium, -F, -Cl, -Br, -I, un groupe hydroxyle, un groupe cyano, un groupe nitro, un groupe amidino, un groupe hydrazine, un groupe hydrazone, un groupe alkyle en C₁ à C₆₀, un groupe alcényle en C₂ à C₆₀, un groupe alcynyle en C₂ à C₆₀, un groupe alcoxy en C₁ à C₆₀, un groupe cycloalkyle en C₃ à C₁₀, un groupe hétérocycloalkyle en C₁ à C₁₀, un groupe cycloalcényle en C₃ à C₁₀, un groupe hétérocycloalcényle en C₁ à C₁₀, un groupe aryle en C₆ à C₆₀, un groupe alkyle aryle en C₇ à C₆₀, un groupe aryloxy en C₆ à C₆₀, un groupe arylthio en C₆ à C₆₀, un groupe hétéroaryle en C₁ à C₆₀, un groupe hétéroaryle alkyle en C₂ à C₆₀, un groupe hétéroaryloxy en C₁ à C₆₀, un groupe hétéarylthio en C₁ à C₆₀, un groupe polycyclique condensé non aromatique monovalent, un groupe hétéropolycyclique condensé non aromatique monovalent, un groupe alkyle en C₁ à C₆₀ qui est substitué avec au moins l'un choisi parmi le deuterium, -F, un groupe cyano, un groupe alkyle en C₁ à C₆₀, et un groupe aryle en C₆ à C₆₀, et un groupe aryle en C₆ à C₆₀ qui est substitué avec au moins l'un choisi parmi le deuterium, -F, un groupe cyano, un groupe alkyle en C₁ à C₆₀, et un groupe aryle en C₆ à C₆₀.

10. Dispositif électroluminescent organique selon l'une quelconque des revendications 2 à 8, dans lequel
le sensibilisateur satisfait la condition 7 : $Δ {E}_{ST} \leq 0,3 eV$ dans lequel, dans la Condition 7,
ΔE_{ST} est la différence entre le niveau d'énergie du singulet d'excitation le plus bas et le niveau d'énergie du triplet d'excitation le plus bas du sensibilisateur.

11. Dispositif électroluminescent organique selon l'une quelconque des revendications 2 à 8 ou 10, dans lequel
le sensibilisateur est représenté par la formule 201 ou 202 : 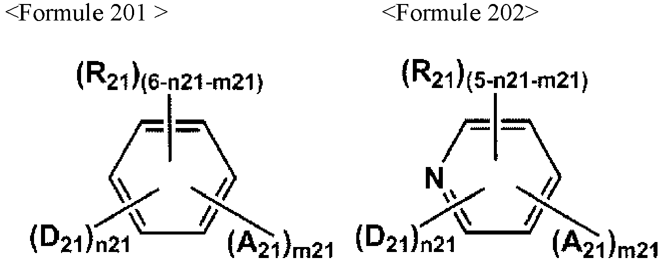 où, dans la formule 201 et 202,
A₂₁ est un groupe accepteur,
D₂₁ est un groupe donateur,
m21 est 1, 2 ou 3, et n21 est 1, 2 ou 3,
la somme de n21 et m21 dans la Formule 201 est de 6 ou moins, et la somme de n21 et m21 dans la Formule 202 est de 5 ou moins,
R₂₁ est choisi parmi l'hydrogène, le deutérium, -F, -Cl, -Br, -I, SF₅, un groupe hydroxyle, un groupe cyano, un groupe nitro, un groupe amidino, un groupe hydrazine, un groupe hydrazone, un groupe alkyle en C₁ à C₆₀ substitué ou non substitué, un groupe alcényle en C₂ à C₆₀ substitué ou non substitué, un groupe alcynyle en C₂ à C₆₀ substitué ou non substitué, un groupe alcoxy en C₁ à C₆₀ substitué ou non substitué, un groupe cycloalkyle en C₃ à C₁₀ substitué ou non substitué, un groupe hétérocycloalkyle en C₁ à C₁₀ substitué ou non substitué, un groupe cycloalcényle en C₃ à C₁₀ substitué ou non substitué, un groupe hétérocycloalcényle en C₁ à C₁₀ substitué ou non substitué, un groupe aryle en C₆ à C₆₀ substitué ou non substitué, un groupe alkylaryle en C₇ à C₆₀ substitué ou non substitué, un groupe aryloxy en C₆ à C₆₀ substitué ou non substitué, un groupe arylthio en C₆ à C₆₀ substitué ou non substitué, un groupe hétéroaryl en C₁ à C₆₀ substitué ou non substitué, un groupe alkylhétéroaryl en C₂ à C₆₀ substitué ou non substitué, un groupe hétéroaryloxy en C₁ à C₆₀ substitué ou non substitué, un groupe hétéroarylthio en C₁ à C₆₀ substitué ou non substitué, un groupe polycyclique condensé non aromatique monovalent substitué ou non substitué, un groupe hétéropolycyclique condensé non aromatique monovalent substitué ou non substitué, -Si(Q₁)(Q₂)(Q₃), -B(Q₁)(Q₂), -N(Q₁)(Q₂), -P(Q₁)(Q₂), -C(=O)(Q₁), -S(=O)(Q₁), -S(=O)₂(Q₁), -P(=O)(Q₁)(Q₂) et -P(=S)(Q₁)(Q₂), une pluralité de R₂₁ sont éventuellement liés ensemble pour former un groupe carbocyclique en C₅ à C₃₀ substitué ou non substitué ou un groupe hétérocyclique en C₁ à C₃₀ substitué ou non substitué,
Q₁ à Q₃ sont chacun indépendamment choisis parmi l'hydrogène, le deutérium, -F, -Cl, -Br, -I, un groupe hydroxyle, un groupe cyano, un groupe nitro, un groupe amidino, un groupe hydrazine, un groupe hydrazone, un groupe alkyle en C₁ à C₆₀, un groupe alcényle en C₂ à C₆₀, un groupe alcynyle en C₂ à C₆₀, un groupe alcoxy en C₁ à C₆₀, un groupe cycloalkyle en C₃ à C₁₀, un groupe hétérocycloalkyle en C₁ à C₁₀, un groupe cycloalcényle en C₃ à C₁₀, un groupe hétérocycloalcényle en C₁ à C₁₀, un groupe aryle en C₆ à C₆₀, un groupe aryle alkyle en C₇ à C₆₀, un groupe aryloxy en C₆ à C₆₀, un groupe arylthio en C₆ à C₆₀, un groupe hétéroaryle en C₁ à C₆₀, un groupe hétéroaryle alkyle en C₂ à C₆₀, un groupe hétéroaryloxy en C₁ à C₆₀, un groupe hétéarylthio en C₁ à C₆₀, un groupe polycyclique condensé non aromatique monovalent, un groupe hétéropolycyclique condensé non aromatique monovalent, un groupe alkyle en C₁ à C₆₀ qui est substitué avec au moins l'un choisi parmi le deuterium, -F, un groupe cyano, un groupe alkyle en C₁ à C₆₀, et un groupe aryle en C₆ à C₆₀, et un groupe aryle en C₆ à C₆₀ qui est substitué avec au moins l'un choisi parmi le deuterium, -F, un groupe cyano, un groupe alkyle en C₁ à C₆₀, et un groupe aryle en C₆ à C₆₀ ;
de préférence dans lequel
A₂₁ est un groupe cyclique exempt d'azote déficient en électrons π substitué ou non substitué ;
D₂₁ est choisi parmi :
- F, un groupe cyano et un groupe cyclique contenant de l'azote déficient en électrons π;
un groupe alkyle en C₁ à C₆₀, un groupe cyclique contenant de l'azote déficient en électrons π et un groupe cyclique exempt d'azote déficient en électrons π, chacun substitué par au moins un choisi parmi -F et un groupe cyano ; et
un groupe cyclique contenant de l'azote déficient en électrons π, chacun substitué par au moins un élément choisi parmi le deutérium, un groupe alkyle en C₁ à C₆₀, un groupe cyclique contenant de l'azote déficient en électrons π et un groupe cyclique exempt d'azote déficient en électrons π ;
le groupe cyclique exempt d'azote déficient en électrons π est choisi parmi un groupe benzène, un groupe heptalène, un groupe indène, un groupe naphtalène, un groupe azulène, un groupe indacène, un groupe acénaphtylène, un groupe fluorène, un groupe spiro-bifluorène, un groupe benzofluorène, un groupe dibenzofluorène, un groupe phénalène, un groupe phénanthrène, un groupe anthracène, un groupe fluoranthène, un groupe triphénylène, un groupe pyrène, un groupe chrysène, un groupe naphtacène, un groupe picène, un groupe pérylène, un pentacène un groupe hexacène, un groupe pentaphène, un groupe rubicène, un groupe coronène, un groupe ovalène, un groupe pyrrole, un groupe isoindole, un groupe indole, un groupe furane, un groupe thiophène, un groupe benzofurane, un groupe benzothiophène, un groupe benzocarbazole, un groupe dibenzocarbazole, un groupe dibenzofurane, un groupe dibenzothiophène, un groupe dibenzothiophène sulfone, un groupe carbazole, un groupe dibenzosilole, un groupe indénocarbazole, un groupe indolocarbazole, un groupe benzofurocarbazole, un groupe benzothiénocarbazole, un groupe triindolobenzène ; et un groupe cyclique condensé de deux ou plus groupes cycliques dépourvus d'azote déficient en électrons π, et
le groupe cyclique contenant de l'azote déficient en électrons π est un groupe cyclique ayant au moins un fragment ^{∗}-N=^{∗}', et est choisi parmi un groupe imidazole, un groupe pyrazole, un groupe thiazole, un groupe isothiazole, un groupe oxazole, un groupe isoxazole, un groupe pyridine, un groupe pyrazine, un groupe pyridazine, un groupe pyrimidine, un groupe indazole, un groupe purine, un groupe quinoléine, un groupe isoquinoléine, un groupe benzoquinoléine, un groupe phtalazine, un groupe naphtyridine, un goupe quinoxaline, un groupe quinazoline, un groupe cinnoline, un groupe phénanthridine, un groupe acridine, un groupe phénanthroline, un groupe phénazine, un groupe benzimidazole, un groupe isobenzothiazole, un groupe benzoxazole, un groupe isobenzoxazole, un groupe triazole, un groupe tétrazole, un groupe oxadiazole, un groupe triazine, un groupe thiadiazole, un groupe imidazopyridine, un groupe imidazopyrimidine, un groupe azacarbazole et un groupe benzimidazolobenzimidazole ; et un groupe cyclique condensé de deux groupes cycliques contenant de l'azote efficaces en électrons π ou plus.

12. Dispositif électroluminescent organique selon la revendication 1 ou la revendication 2 comprenant en outre :
m unités d'émission situées entre la première électrode et la seconde électrode et comprenant au moins une couche d'émission ; et
m-1 couches génératrices de charge entre deux unités d'émission voisines des m unités d'émission et comprenant une couche génératrice de charges de type n et une couche génératrice de charges de type p,
dans lequel
m est un nombre entier de 2 ou plus, et
la longueur d'onde d'émission maximale de la lumière émise à partir d'au moins une unité d'émission des m unités d'émission est différente de la longueur d'onde d'émission maximale de la lumière émise à partir d'au moins une unité d'émission des unités d'émission restantes.

13. Dispositif électroluminescent organique selon la revendication 1 ou la revendication 2 comprenant en outre :
m couches d'émission entre la première électrode et la seconde électrode, dans lequel
m est un nombre entier de 2 ou plus,
la longueur d'onde d'émission maximale de lumière émise depuis au moins une couche d'émission des m couches d'émission est différente de la longueur d'onde d'émission maximale de lumière émise depuis au moins une couche d'émission des couches d'émission restantes.
